(19) Europäisches Patentamt
European Patent Office
Office européen des brevets

(11) EP 3 508 491 B1

(12) **EUROPEAN PATENT SPECIFICATION**

(45) Date of publication and mention of the grant of the patent:
**09.09.2020 Bulletin 2020/37**

(51) Int Cl.:
***C07F 15/00*** $^{(2006.01)}$ ***C09K 11/06*** $^{(2006.01)}$
***H01L 51/00*** $^{(2006.01)}$ ***H05B 33/14*** $^{(2006.01)}$

(21) Application number: **19150173.3**

(22) Date of filing: **03.01.2019**

(54) **ORGANOMETALLIC COMPOUND, ORGANIC LIGHT-EMITTING DEVICE INCLUDING THE SAME, AND DIAGNOSTIC COMPOSITION INCLUDING THE SAME**

ORGANOMETALLISCHE VERBINDUNG, ORGANISCHE LICHTEMITTIERENDE VORRICHTUNG DAMIT UND DIAGNOSEZUSAMMENSETZUNG DAMIT

COMPOSÉ ORGANOMÉTALLIQUE, DISPOSITIF ÉLECTROLUMINESCENT ORGANIQUE LE COMPRENANT ET COMPOSITION DE DIAGNOSTIC LE COMPRENANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.01.2018 KR 20180001851**
**02.01.2019 KR 20190000390**

(43) Date of publication of application:
**10.07.2019 Bulletin 2019/28**

(73) Proprietor: **Samsung Electronics Co., Ltd.**
**Suwon-si, Gyeonggi-do, 16677 (KR)**

(72) Inventors:
- **LEE, Sunyoung**
**16678 Gyeonggi-do (KR)**
- **LEE, Jungin**
**16678 Gyeonggi-do (KR)**
- **JEON, Aram**
**16678 Gyeonggi-do (KR)**
- **HWANG, Kyuyoung**
**16678 Gyeonggi-do (KR)**
- **KWAK, Seungyeon**
**16678 Gyeonggi-do (KR)**
- **KWON, Ohyun**
**16678 Gyeonggi-do (KR)**
- **CHO, Yuri**
**16678 Gyeonggi-do (KR)**
- **CHOI, Byoungki**
**16678 Gyeonggi-do (KR)**
- **HONG, Seokhwan**
**16678 Gyeonggi-do (KR)**

(74) Representative: **Elkington and Fife LLP**
**Prospect House**
**8 Pembroke Road**
**Sevenoaks, Kent TN13 1XR (GB)**

(56) References cited:
**EP-A1- 3 450 441 US-A1- 2016 240 800**

- **BIN WANG ET AL.: "Strongly phosphorescent platinum(II) complexes supported by tetradentate benzazole-containing ligands", JOURNAL OF MATERIALS CHEMISTRY C, vol. 3, no. 31, 17 July 2015 (2015-07-17), pages 8212-8218, XP055540969, UK ISSN: 2050-7526, DOI: 10.1039/C5TC01449B**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 508 491 B1

## Description

### FIELD OF THE INVENTION

The present disclosure relates to an organometallic compound, an organic light-emitting device including the same, and a diagnostic composition including the organometallic compound.

### BACKGROUND OF THE INVENTION

Organic light-emitting devices (OLEDs) are self-emission devices, which have improved characteristics in terms of a viewing angle, a response time, brightness, a driving voltage, and a response speed, and which produce full-color images.

In an example, an organic light-emitting device includes an anode, a cathode, and an organic layer disposed between the anode and the cathode, wherein the organic layer includes an emission layer. A hole transport region may be disposed between the anode and the emission layer, and an electron transport region may be disposed between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transition from an excited state to a ground state, thereby generating light.

Meanwhile, luminescent compounds, for example, phosphorescent compounds, may be used for monitoring, sensing, and detecting biological materials such as various cells and proteins.

Various types of organic light emitting devices are known. However, there still remains a need in OLEDs having low driving voltage, high efficiency, high brightness, and long lifespan.

US 2016/240800 discloses compounds having a Pt tetradentate structure, as well as formulations and devices, such as OLEDs, that include the compound.

### SUMMARY OF THE INVENTION

Provided are an organometallic compound, an organic light-emitting device including the organometallic compound, and a diagnostic composition including the organometallic compound.

Additional aspects will be set forth in part in the description which follows and, in part, will be apparent from the description, or may be learned by practice of the presented embodiments.

According to an aspect of an embodiment, an organometallic compound is represented by Formula 1:

Formula 1

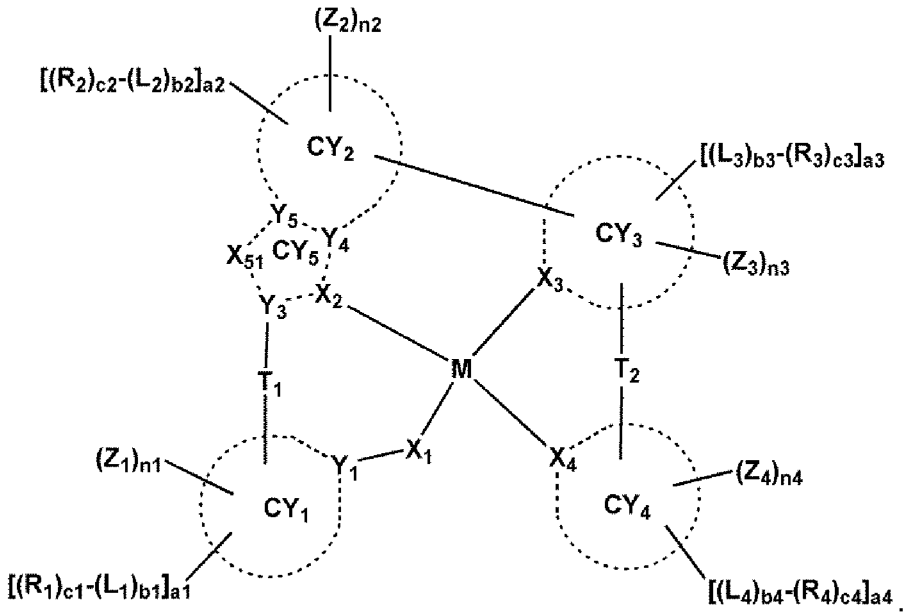

In Formula 1,

M may be beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au),

$X_1$ may be a chemical bond, O, S, N(R'), P(R'), B(R'), C(R')(R"), or Si(R')(R"), and when $X_1$ is a chemical bond, $Y_1$ may be directly bonded to M,

$X_2$ to $X_4$ may each independently be N or C, two selected from $X_2$ to $X_4$ may each be N, and the other may be C, a bond between $X_1$ or $Y_1$ and M may be a covalent bond, one bond selected from a bond between $X_2$ and M, a bond between $X_3$ and M, and a bond between $X_4$ and M may be a covalent bond, and the remaining two bonds may be coordinate bonds,

$Y_1$ and $Y_3$ to $Y_5$ may each independently be C or N,

among pairs of $X_2$ and $Y_3$, $X_2$ and $Y_4$, $Y_4$ and $Y_5$, $X_{51}$ and $Y_3$, and $X_{51}$ and $Y_5$, the components in each pair may be linked via a chemical bond,

ring $CY_1$ to ring $CY_5$ may each independently be selected from a $C_5$-$C_{30}$ carbocyclic group and a $C_1$-$C_{30}$ heterocyclic group, and each of ring $CY_1$, ring $CY_3$, and ring $CY_4$ may not be a benzimidazole group,

a cyclometalated ring formed by ring $CY_5$, ring $CY_2$, ring $CY_3$, and M may be a 6-membered ring,

$X_{51}$ may be selected from O, S, N-[$(L_7)_{b7}$-$(R_7)_{c7}$], $C(R_7)(R_8)$, $Si(R_7)(R_8)$, $Ge(R_7)(R_8)$, C(=O), N, $C(R_7)$, $Si(R_7)$, and $Ge(R_7)$,

$R_7$ and $R_8$ may optionally be linked via a single bond, a double bond, or a first linking group to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,

$T_1$ and $T_2$ may each independently be a single bond, a double bond, *-N($R_9$)-*', *-B($R_9$)-*', *-P($R_9$)-*', *-C($R_9$)($R_{10}$)-*', *-Si($R_9$)($R_{10}$)-*', *-Ge($R_9$)($R_{10}$)-*', *-S-*', *-Se-*', *-O*-C(=O)-*', *-S(=O)-*', *-S(=O)$_2$-*', *-C($R_9$)=*', *=C($R_9$)-*', *-C($R_9$)=C($R_{10}$)-*', *-C(=S)-*', or *-C≡C-*',

$L_1$ to $L_4$ and $L_7$ may each independently be selected from a single bond, a substituted or unsubstituted $C_5$-$C_{30}$ carbocyclic group, and a substituted or unsubstituted $C_1$-$C_{30}$ heterocyclic group,

b1 to b4 and b7 may each independently be an integer from 1 to 5,

$R_1$ to $R_4$, $R_7$ to $R_{10}$, R', and R" may each independently be selected from hydrogen, deuterium, a deuterium-containing group, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkylaryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted $C_2$-$C_{60}$ alkylheteroaryl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$),-B($Q_6$)($Q_7$), and -P(=O)($Q_8$)($Q_9$),

c1 to c4 and c7 may each independently be an integer from 1 to 5,

$Z_1$ to $Z_4$ may each independently be deuterium or a deuterium-containing group,

a1 to a4 and n1 to n4 may each independently be an integer from 0 to 20,

i) when $X_{51}$ is O, S, C(=O), or N, the sum of n1 to n4 may be 1 or more, ii) when $X_{51}$ is N[$(L_7)_{b7}$-$(R_7)_{c7}$], $C(R_7)$, $Si(R_7)$, or $Ge(R_7)$, a) $R_7$ may be deuterium or a deuterium-containing group; b) the sum of n1 to n4 may be 1 or more; or c) $R_7$ may be deuterium or a deuterium-containing group and the sum of n1 to n4 may be 1 or more, and iii) when $X_{51}$ is $C(R_7)(R_8)$, $Si(R_7)(R_8)$, or $Ge(R_7)(R_8)$, a) at least one selected from $R_7$ and $R_8$ may be deuterium or a deuterium-containing group; b) the sum of n1 to n4 may be 1 or more; or c) at least one selected from $R_7$ and $R_8$ may be deuterium or a deuterium-containing group and the sum of n1 to n4 may be 1 or more,

two of a plurality of neighboring groups $R_1$ may be optionally linked to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,

two of a plurality of neighboring groups $R_2$ may be optionally linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,

two of a plurality of neighboring groups $R_3$ may be optionally linked to each other to form a $C_5$-$C_{30}$ carbocyclic group unsubstituted or substituted with at least one $R_{10a}$ or a $C_1$-$C_{30}$ heterocyclic group unsubstituted or substituted with

at least one $R_{10a}$,
two of a plurality of neighboring groups $R_4$ may be optionally linked to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,
two or more neighboring groups selected from $R_1$ to $R_4$, $R_7$ to $R_{10}$, R', and R" may be optionally linked to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,
$R_{10a}$ has the same definition as $R_1$,
at least one substituent of the substituted $C_5$-$C_{30}$ carbocyclic group, substituted $C_1$-$C_{30}$ heterocyclic group, substituted $C_1$-$C_{60}$ alkyl group, substituted $C_2$-$C_{60}$ alkenyl group, substituted $C_2$-$C_{60}$ alkynyl group, substituted $C_1$-$C_{60}$ alkoxy group, substituted $C_3$-$C_{10}$ cycloalkyl group, substituted $C_1$-$C_{10}$ heterocycloalkyl group, substituted $C_3$-$C_{10}$ cycloalkenyl group, substituted $C_1$-$C_{10}$ heterocycloalkenyl group, substituted $C_6$-$C_{60}$ aryl group, substituted $C_7$-$C_{60}$ alkylaryl group, substituted $C_6$-$C_{60}$ aryloxy group, substituted $C_6$-$C_{60}$ arylthio group, substituted $C_7$-$C_{60}$ arylalkyl group, substituted $C_1$-$C_{60}$ heteroaryl group, substituted $C_1$-$C_{60}$ heteroaryloxy group, substituted $C_1$-$C_{60}$ heteroarylthio group, substituted $C_2$-$C_{60}$ heteroarylalkyl group, substituted $C_2$-$C_{60}$ alkylheteroaryl group, substituted monovalent non-aromatic condensed polycyclic group and substituted monovalent non-aromatic condensed heteropolycyclic group may be selected from:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;
a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkylaryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a $C_2$-$C_{60}$ alkylheteroaryl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-B(Q_{16})(Q_{17})$, and $-P(=O)(Q_{13})(Q_{19})$;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkylaryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a $C_2$-$C_{60}$ alkylheteroaryl group, a monovalent non-aromatic condensed polycyclic group, and a monovalent non-aromatic condensed heteropolycyclic group;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-C60 alkylaryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a $C_2$-$C_{60}$ alkylheteroaryl group, a monovalent non-aromatic condensed polycyclic group, and a monovalent non-aromatic condensed heteropolycyclic group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkylaryl group, a C6-C60 aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a $C_2$-$C_{60}$ alkylheteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-B(Q_{26})(Q_{27})$ and-$P(=O)(Q_{28})(Q_{29})$; and
$-N(Q_{31})(Q_{32})$, $-Si(Q_{33})(Q_{34})(Q_{35})$, $-B(Q_{36})(Q_{37})$, and $-P(=O)(Q_{38})(Q_{39})$;
wherein $Q_1$ to $Q_9$, $Q_{11}$ to $Q_{19}$, $Q_{21}$ to $Q_{29}$, and $Q_{31}$ to $Q_{39}$ may each independently be selected from hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_1$-$C_{60}$ alkyl group substituted with at least one selected from deuterium, a $C_1$-$C_{60}$ alkyl group, and a $C_6$-$C_{60}$ aryl group, a $C_2$-$C_{60}$ alkenyl group, a $C_2$-$C_{60}$ alkynyl group,

a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from deuterium, a $C_1$-$C_{60}$ alkyl group, and a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a $C_2$-$C_{60}$ alkylheteroaryl group, a monovalent non-aromatic condensed polycyclic group, and a monovalent non-aromatic condensed heteropolycyclic group.

According to an aspect of another embodiment, an organic light-emitting device includes:

a first electrode;
a second electrode; and
an organic layer disposed between the first electrode and the second electrode,
wherein the organic layer includes an emission layer and at least one organometallic compound represented by Formula 1.

The organometallic compound in the organic layer may function as a dopant.
According to an aspect of another embodiment, a diagnostic composition includes at least one organometallic compound represented by Formula 1.

BRIEF DESCRIPTION OF THE DRAWING

These and/or other aspects will become apparent and more readily appreciated from the following description of the embodiments, taken in conjunction with the FIGURE which is a schematic cross-sectional view of an organic light-emitting device according to an embodiment.

DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.
It will be understood that when an element is referred to as being "on" another element, it can be directly in contact with the other element or intervening elements may be present therebetween. In contrast, when an element is referred to as being "directly on" another element, there are no intervening elements present.
It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.
The terminology used herein is for the purpose of describing particular embodiments only and is not intended to be limiting. As used herein, the singular forms "a," "an," and "the" are intended to include the plural forms as well, unless the context clearly indicates otherwise.
The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.
Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.
Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be

construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

In an embodiment, an organometallic compound represented by Formula 1 below is provided:

Formula 1

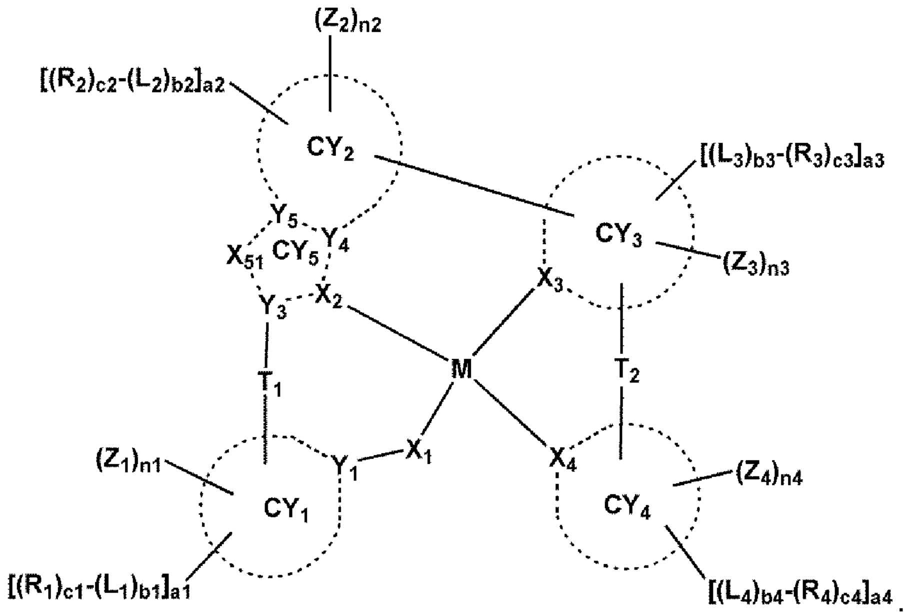

M in Formula 1 may be beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au).

In an embodiment, M may be Pt, Pd, or Au, but embodiments of the present disclosure are not limited thereto.

$X_1$ in Formula 1 may be a chemical bond (for example, a single bond or a covalent bond), O, S, N(R'), P(R'), B(R'), C(R')(R"), or Si(R')(R"). R' and R" are the same as described above. When $X_1$ is a chemical bond, $Y_1$ and M may directly be linked to each other.

For example, $X_1$ may be O or S, but embodiments of the present disclosure are not limited thereto.

$X_2$ to $X_4$ in Formula 1 may each independently be N or C, two selected from $X_2$ to $X_4$ may each be N, and the remainder may be C.

A bond between $X_1$ or $Y_1$ and M in Formula 1 may be a covalent bond, one bond selected from a bond between $X_2$ and M, a bond between $X_3$ and M, and a bond between $X_4$ and M may be a covalent bond, and the remaining two bonds may be coordinate bonds. Thus, the organometallic compound represented by Formula 1 may be electrically neutral.

In one or more embodiments, in Formula 1,

i) $X_2$ and $X_4$ may each be N, $X_3$ may be C, a bond between $X_2$ and M and a bond between $X_4$ and M may each be a coordinate bond, and a bond between $X_3$, and M may be a covalent bond, or

i) $X_2$ and $X_3$ may each be N, $X_4$ may be C, a bond between $X_2$ and M and a bond between $X_3$ and M may each be a coordinate bond, and a bond between $X_4$ and M may be a covalent bond, or

iii) $X_3$ and $X_4$ may be N, $X_2$ may be C, a bond between $X_3$ and M and a bond between $X_4$ and M may each be a coordinate bond, and a bond between $X_2$ and M may be a covalent bond, but embodiments of the present disclosure are not limited thereto.

In Formula 1, $Y_1$ and $Y_3$ to $Y_5$ may each independently be C or N, and among pairs of $X_2$ and $Y_3$, $X_2$ and $Y_4$, $Y_4$ and $Y_5$, $X_{51}$ and $Y_3$, and $X_{51}$ and $Y_5$, the components in each pair may be linked via a chemical bond. Accordingly, ring $CY_5$ in the Formula 1 may be a 5-membered ring condensed with ring $CY_2$.

Ring $CY_1$ to ring $CY_5$ in Formula 1 may each independently be selected from a $C_5$-$C_{30}$ carbocyclic group, and a $C_1$-$C_{30}$ heterocyclic group, and each of ring $CY_1$, ring $CY_3$, and ring $CY_4$ may not be a benzimidazole group.

For example, ring $CY_1$ to ring $CY_4$ may each independently selected from: i) a first ring, ii) a second ring, iii) a condensed ring in which two or more first rings are condensed with each other, iv) a condensed ring in which two or more second rings are condensed with each other, and v) a condensed ring in which one or more first rings and one or more second rings are condensed with each other, wherein

the first ring may be selected from a cyclopentane group, a cyclopentadiene group, a furan group, a thiophene group, a pyrrole group, a silole group, an indene group, a benzofuran group, a benzothiophene group, an indole group, a benzosilole group, an oxazole group, an isoxazole group, an oxadiazole group, an isozadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, and a triazasilole group,

the second ring may be selected from an adamantane group, a norbornane group, a norbornene group, a cyclohexane group, a cyclohexene group, a benzene group, a pyridine group, a pyrimidine group, a pyrazine group, a pyridazine group, and a triazine group, and

each of ring $CY_1$ to ring $CY_4$ may not be a benzimidazole group.

In an embodiment, ring $CY_1$ to ring $CY_4$ may each independently be selected from a benzene group, a naphthalene group, an anthracene group, a phenanthrene group, a triphenylene group, a pyrene group, a chrysene group, cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a 5,6,7,8-tetrahydroisoquinoline group, and a 5,6,7,8-tetrahydroquinoline group, but embodiments of the present disclosure are not limited thereto.

A cyclometalated ring formed by ring $CY_5$, ring $CY_2$, ring $CY_3$, and M in Formula 1 may be a 6-membered ring.

In an embodiment, $X_2$ of ring $CY_5$, $X_3$ of ring $CY_3$, and $X_4$ of ring $CY_4$ in Formula 1 may not constitute a carbine moiety. That is, regarding Formula 1, 1) when $X_2$ is C, a bond between $X_2$ and M may be a covalent bond, 2) when $X_3$ is C, a bond between $X_3$ and M may be a covalent bond, and 3) when $X_4$ is C, a bond between $X_4$ and M may be a covalent bond.

Regarding Formula 1, $X_{51}$ may be O, S, N-[$(L_7)_{b7}$-$(R_7)_{c7}$], $C(R_7)(R_8)$, $Si(R_7)(R_8)$, $Ge(R_7)(R_8)$, C(=O), N, $C(R_7)$, $Si(R_7)$, and $Ge(R_7)$, and $R_7$ and $R_8$ may optionally be linked via a single bond, a double bond, or a first linking group to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$. Herein, the $C_5$-$C_{30}$ carbocyclic group and the $C_1$-$C_{30}$ heterocyclic group may be understood by referring to the descriptions about i) the first ring, ii) the second ring, iii) the condensed ring in which two or more first rings are condensed with each other, iv) the condensed ring in which two or more second rings are condensed with each other, and v) the condensed ring in which one or more first rings and one or more second rings are condensed with each other, and $R_{10a}$ may be understood by referring to the description about $R_1$, and $L_7$, b7, $R_7$, $R_8$, and c7 will be described in detail later.

The first linking group may be selected from *-O-*', *-S-*', *-C($R_5$)($R_6$)-*', *-C($R_5$)=*', *=C($R_6$)-*', *-C($R_5$)=C($R_6$)-*', *-C(=O)-*', *-C(=S)-*', *-C≡C-*', *-N($R_5$)-*', *-Si($R_5$)($R_6$)-*', and *-P($R_5$)($R_6$)-*', and $R_5$ and $R_6$ are the same as described in connection with $R_1$, and each of * and *' indicates a binding site to a neighboring atom.

In one or more embodiments, in Formula 1,

i) $Y_3$ to $Y_5$ may each be C, a bond between $X_{51}$ and $Y_3$ and a bond between $X_{51}$ and $Y_5$ may each be a single bond, and $X_{51}$ may be O, S, N-[$(L_7)_{b7}$-$(R_7)_{c7}$], $C(R_7)(R_8)$, $Si(R_7)(R_8)$, $Ge(R_7)(R_8)$, or C(=O),

ii) $Y_3$ and $Y_4$ may each be C, $Y_5$ may be N, a bond between $X_{51}$ and $Y_3$ may be a double bond, a bond between $X_{51}$ and $Y_5$ may be a single bond, and $X_{51}$ may be N, $C(R_7)$, $Si(R_7)$, or $Ge(R_7)$,

iii) $Y_3$ and $Y_5$ may each be C, $Y_4$ may be N, a bond between $X_{51}$ and $Y_3$ may be a single bond, a bond between $X_{51}$ and $Y_5$ may be a double bond, and $X_{51}$ may be N, $C(R_7)$, $Si(R_7)$, or $Ge(R_7)$,

iv) $Y_3$ may be N, $Y_4$ and $Y_5$ may each be C, a bond between $X_{51}$ and $Y_3$ may be a single bond, a bond between $X_{51}$

and $Y_5$ may be a double bond, and $X_{51}$ may be N, $C(R_7)$, $Si(R_7)$, or $Ge(R_7)$, or

v) $Y_3$ to $Y_5$ may each be C, a bond between $X_{51}$ and $Y_3$ may be a double bond, a bond between $X_{51}$ and $Y_5$ may be a single bond, and $X_{51}$ may be N, $C(R_7)$, $Si(R_7)$, or $Ge(R_7)$, but embodiments are not limited thereto.

$T_1$ and $T_2$ in Formula 1 may each independently be a single bond, a double bond, *-N($R_9$)-*', *-B($R_9$)-*', *-P($R_9$)-*', *-C($R_9$)($R_{10}$)-*', *-Si($R_9$)($R_{10}$)-*', *-Ge($R_9$)($R_{10}$)-*', *-S-*', *-Se-*', *-O-*', *-C(=O)-*', *-S(=O)-*', *-S(=O)$_2$-*', *-C($R_9$)=*', *=C($R_9$)-*', *-C($R_9$)=C($R_{10}$)-*', *-C(=S)-*', or *-C≡C-*', $R_9$ and $R_{10}$ may optionally be linked via a single bond, a double bond, or a second linking group to form a $C_5$-$C_{30}$carbocyclic group unsubstituted or substituted with at least one $R_{10a}$ or a $C_1$-$C_{30}$ heterocyclic group unsubstituted or substituted with at least one $R_{10a.}$ Herein, the $C_5$-$C_{30}$ carbocyclic group and the $C_1$-$C_{30}$heterocyclic group may be understood by referring to the descriptions about i) the first ring, ii) the second ring, iii) the condensed ring in which two or more first rings are condensed with each other, iv) the condensed ring in which two or more second rings are condensed with each other, and v) the condensed ring in which one or more first rings and one or more second rings are condensed with each other, and $R_{10a}$ may be understood by referring to the description about $R_1$, and the second linking group may be understood by referring to the description about the first linking group.

In an embodiment, $T_1$ and $T_2$ in Formula 1 may be a single bond, but embodiments are not limited thereto.

$L_1$ to $L_4$ and $L_7$ in Formula 1 may each independently be selected from a single bond, a substituted or unsubstituted $C_5$-$C_{30}$ carbocyclic group, and a substituted or unsubstituted $C_1$-$C_{30}$ heterocyclic group.

For example, $L_1$ to $L_4$ and $L_7$ in Formula 1 may each independently be selected from:

a single bond, a benzene group, a naphthalene group, an anthracene group, a phenanthrene group, a triphenylene group, a pyrene group, a chrysene group, cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzooxadiazole group and a benzothiadiazole group; and

a benzene group, a naphthalene group, an anthracene group, a phenanthrene group, a triphenylene group, a pyrene group, a chrysene group, cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzooxadiazole group and a benzothiadiazole group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkyl group substituted with at least one deuterium, a $C_1$-$C_{20}$ alkoxy group, a phenyl group, a phenyl group substituted with at least one deuterium, a biphenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -N($Q_{31}$)($Q_{32}$),-Si($Q_{33}$)($Q_{34}$)($Q_{35}$), -B($Q_{36}$)($Q_{37}$), and -P(=O)($Q_{38}$)($Q_{39}$);

$Q_{31}$ to $Q_{39}$ may each independently be selected from:

$-CH_3$, $-CD_3$, $-CD_2H$, $-CDH_2$, $-CH_2CH_3$, $-CH_2CD_3$, $-CH_2CD_2H$, $-CH_2CDH_2$,$-CHDCH_3$, $-CHDCD_2H$, $-CHDCDH_2$, $-CHDCD_3$, $-CD_2CH_3$, $-CD_2CD_3$, $-CD_2CD_2H$, and $-CD_2CDH_2$;

an n-propyl group, an iso-propyl group, an n-butyl group, an iso-butyl group, a sec-butyl group, a tert-butyl group, an n-pentyl group, an isopentyl group, a sec-pentyl group, a tert-pentyl group, a phenyl group, and a naphthyl group; and

an n-propyl group, an iso-propyl group, an n-butyl group, an iso-butyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a $C_1$ to $C_{10}$ alkyl group, and a

phenyl group;
but embodiments of the present disclosure are not limited thereto.

b1 to b4 and b7 in Formula 1 indicate numbers of $L_1$ to $L_4$ and $L_7$, respectively, and may each independently be an integer from 1 to 5. When b1 is two or more, two or more groups $L_1$ may be identical to or different from each other. b2 to b4 and b7 may each be the same as described in connection with b1.
In an embodiment, b1 to b4 and b7 in Formula 1 may be 1 or 2, but embodiments of the present disclosure are not limited thereto.
In an embodiment, $L_1$ to $L_4$ and $L_7$ in Formula 1 may each independently be selected from:

a single bond; and
a benzene group unsubstituted or substituted with at least one selected from deuterium, -F, a cyano group, a $C_1$-$C_{20}$ alkyl group, a $C_1$-$C_{20}$ alkyl group substituted with at least one deuterium, a phenyl group, a phenyl group substituted with at least one deuterium, a biphenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group and a diphenyldibenzosilolyl group; and
b1 to b4 and b7 in Formula 1 may be 1 or 2, but embodiments of the present disclosure are not limited thereto.

$R_1$ to $R_4$, $R_7$ to $R_{10}$, R', and R" may each independently be selected from hydrogen, deuterium, deuterium-containing group, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkylaryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted $C_2$-$C_{60}$ alkylheteroaryl group, a substituted or unsubstituted monovalent non-aromatic condensed polycyclic group, a substituted or unsubstituted monovalent non-aromatic condensed heteropolycyclic group,$-N(Q_1)(Q_2)$, $-Si(Q_3)(Q_4)(Q_5)$, $-B(Q_6)(Q_7)$, and $-P(=O)(Q_3)(Q_9)$. The deuterium-containing group and $Q_1$ to $Q_9$ are the same as described above.
For example, $R_1$ to $R_4$, $R_7$ to $R_{10}$, R', and R" may each independently be selected from:

hydrogen, deuterium, a deuterium-containing group, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a $C_1$-$C_{20}$ alkyl group, and a $C_1$-$C_{20}$ alkoxy group;
a $C_1$-$C_{20}$ alkyl group and a $C_1$-$C_{20}$ alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a pyridinyl group, and a pyrimidinyl group;
a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group,

an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, and $-Si(Q_{33})(Q_{34})(Q_{35})$; and
$-N(Q_1)(Q_2)$, $-Si(Q_3)(Q_4)(Q_5)$, $-B(Q_6)(Q_7)$, and $-P(=O)(Q_3)(Q_9)$;

Herein, $Q_1$ to $Q_9$ and $Q_{33}$ to $Q_{35}$ may be understood by referring to the description presented above.

In some embodiments, $R_1$ to $R_4$, $R_7$ to $R_{10}$, R', and R" may each independently be selected from:

hydrogen, deuterium, deuterium-containing group, -F, a cyano group, a nitro group, $-SF_5$, a methyl group, an ethyl group, an n-propyl group, an iso-propyl group, an n-butyl group, an iso-butyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1 ]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a pyridinyl group, a pyrimidinyl group, a fluorenyl group, a carbazolyl group, a dibenzofuranyl group, a dibenzothiophenyl group, and a dibenzosilolyl group;
a methyl group, an ethyl group, an n-propyl group, an iso-propyl group, an n-butyl group, an iso-butyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a

bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a pyridinyl group, a pyrimidinyl group, a fluorenyl group, a carbazolyl group, a dibenzofuranyl group, a dibenzothiophenyl group, and a dibenzosilolyl group, each substituted with at least one selected from deuterium, -F, $-CD_3$, $-CD_2H$, $-CDH_2$, $-CF_3$, $-CF_2H$, $-CFH_2$, a cyano group, nitro group, a $C_1$-$C_{10}$ alkyl group, a $C_1$-$C_{10}$ alkoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a pyridinyl group, a pyrimidinyl group, a fluorenyl group, a carbazolyl group, a dibenzofuranyl group, a dibenzothiophenyl group, a dibenzosilolyl group, and $-Si(Q_{33})(Q_{34})(Q_{35})$; and

$-N(Q_1)(Q_2)$, $-Si(Q_3)(Q_4)(Q_5)$, $-B(Q_6)(Q_7)$, and $-P(=O)(Q_3)(Q_9)$;

wherein $Q_1$ to $Q_9$ and $Q_{33}$ to $Q_{35}$ are the same as described above, but embodiments are not limited thereto.

c1 to c4 and c7 in Formula 1 indicate numbers of $R_1$ to $R_4$ and $R_7$, respectively, and may each independently be an integer from 1 to 5 (for example, 1, 2, and 3). When c1 is two or more, two or more groups $R_1$ may be identical to or different from each other. c2 to c4 and c7 may be understood by referring to the description about c1.

$Z_1$ to $Z_4$ in Formula 1 may each independently be deuterium or a deuterium-containing group.

For example, the deuterium-containing group is a first group substituted with at least one deuterium, and the first group may be selected from a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkylaryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted $C_2$-$C_{60}$ alkylheteroaryl group, a substituted or unsubstituted monovalent non-aromatic condensed polycyclic group, and a substituted or unsubstituted monovalent non-aromatic condensed heteropolycyclic group.

The term "a deuterium-containing group" as used herein refers to any group including at least one deuterium, which may be further substituted with substituents other than deuterium. For example, the term "a deuterium-containing group" as used herein may include a phenyl group substituted with one deuterium, a phenyl group substituted with five deuterium and not containing hydrogen (see Formula 11-1), a phenyl group substituted with four deuterium and one tert-butyl group (see Formulae 11-10 to 11-12), a phenyl group substituted with four deuterium and one $-C(CD_3)_3$ and not containing hydrogen (see Formulae 11-7 to 11-9), $-CDH_2$, $-CD_3$, or the like. Herein, for example, the "phenyl group substituted with one deuterium" refers to a deuterium-containing group in which the first group is a "phenyl group," and the "phenyl group substituted with four deuterium and one tert-butyl group" refers to a deuterium-containing group in which the first group is "a phenyl group substituted with a tert-butyl group."

In an embodiment, the deuterium-containing group may be a first group substituted with at least one deuterium, the first group may be selected from:

a $C_1$-$C_{20}$ alkyl group and a $C_1$-$C_{20}$ alkoxy group;

a $C_1$-$C_{20}$ alkyl group and a $C_1$-$C_{20}$ alkoxy group, each substituted with at least one selected from -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a pyridinyl group, and a pyrimidinyl group;

a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl

group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group; a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group, each substituted with at least one selected from -F,-Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, and $-Si(Q_{33})(Q_{34})(Q_{35})$; and
$-N(Q_1)(Q_2)$, $-Si(Q_3)(Q_4)(Q_5)$, $-B(Q_6)(Q_7)$, and $-P(=O)(Q_3)(Q_9)$;

Herein, $Q_1$ to $Q_9$ and $Q_{33}$ to $Q_{35}$ may be understood by referring to the description presented above.

In an embodiment, the deuterium-containing group may be a first group substituted with at least one deuterium, and the first group may be selected from a $C_1$-$C_{20}$ alkyl group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1 ]hexyl group, a bicyclo[2.2.1]heptyl group, a bicyclo[2.2.2]octyl group, a phenyl group, a ($C_1$-$C_{20}$ alkyl)phenyl group, a biphenyl group and a terphenyl group, each unsubstituted or substituted with at least one selected from -F, $-CD_2H$, $-CDH_2$, $-CF_3$, $-CF_2H$, $-CFH_2$, a cyano group, a $C_1$-$C_{10}$ alkyl group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group and a terphenyl group.

In an embodiment, the deuterium-containing group i) may not include hydrogen or ii) may include at least one $C_1$-$C_{10}$ alkyl group.

For example, in the deuterium-containing group, "all hydrogen" of the "first group" is replaced with "deuterium" and thus, hydrogen is not present (for example, such the deuterium-containing group may be selected from $-CD_3$, $-CD_2(CD_3)$, $-CD(CD_3)_2$, $-C(CD_3)_3$, $-CD_2-C(CD_3)_3$, $-CD_2-CD(CD_3)_2$, $-CD_2-CD_2(CD_3)$, $-CD(CD_3)-C(CD_3)_3$, $-CD(CD_3)-CD(CD_3)_2$,$-CD(CD_3)-CD_2(CD_3)$, $-C(CD_3)_2-C(CD_3)_3$, $-C(CD_3)_2-CD(CD_3)_2$, $-C(CD_3)_2-CD_2(CD_3)$, and Formulae 11-1 to 11-9).

In some embodiments, the deuterium-containing group may include at least one $C_1$-$C_{10}$ alkyl group (for example, a methyl group, an ethyl group, an n-propyl group, an iso-propyl group, an n-butyl group, an iso-butyl group, a tert-butyl

group, a sec-butyl group, an n-pentyl group, an isopentyl group, a tert-pentyl group, a sec-pentyl group, etc.), and such a deuterium-containing group may be, for example, one of Formulae 11-10 to 11-12, but embodiments are not limited thereto.

In some embodiments, $R_1$ to $R_4$, $R_7$ to $R_{10}$, R' and R" may each independently selected from hydrogen, deuterium, -F, a cyano group, a nitro group, $-SF_5$, $-CH_3$, $-CD_3$,$-CD_2H$, $-CDH_2$, $-CF_3$, $-CF_2H$, $-CFH_2$, $-CD_2(CD_3)$, $-CD(CD_3)_2$, $-C(CD_3)_3$, $-CD_2-C(CD_3)_3$, $-CD_2-CD(CD_3)_2$, $-CD_2-CD_2(CD_3)$, $-CD(CD_3)-C(CD_3)_3$, $-CD(CD_3)-CD(CD_3)_2$, $-CD(CD_3)-CD_2(CD_3)$,$-C(CD_3)_2-C(CD_3)_3$, $-C(CD_3)_2-CD(CD_3)_2$, $-C(CD_3)_2-CD_2(CD_3)$, a group represented by Formula 9-1 to 9-19, a group represented by Formulae 10-1 to 10-232, a group represented by Formulae 11-1 to 11-41, and $-Si(Q_1)(Q_2)(Q_3)$ ($Q_1$ to $Q_3$ are the same as described above),

$Z_1$ to $Z_4$ may each independently be deuterium, $-CD_3$, $-CD_2H$, $-CDH_2$,$-CD_2(CD_3)$, $-CD(CD_3)_2$, $-C(CD_3)_3$, $-CD_2-C(CD_3)_3$, $-CD_2-CD(CD_3)_2$, $-CD_2-CD_2(CD_3)$,$-CD(CD_3)-C(CD_3)_3$, $-CD(CD_3)-CD(CD_3)_2$, $-CD(CD_3)-CD_2(CD_3)$, $-C(CD_3)_2-C(CD_3)_3$,$-C(CD_3)_2-CD(CD_3)_2$, $-C(CD_3)_2-CD_2(CD_3)$, and a group represented by one of Formulae 9-14 to 9-19, 10-11, 10-12, and 11-1 to 11-41, but embodiments are not limited thereto:

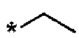
9-1
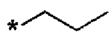
9-2
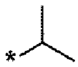
9-3
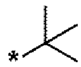
9-4
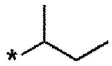
9-5
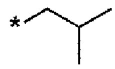
9-6
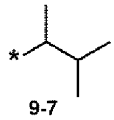
9-7
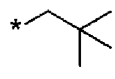
9-8
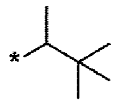
9-9
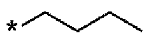
9-10
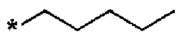
9-11
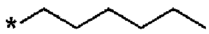
9-12
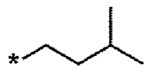
9-13
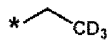
9-14
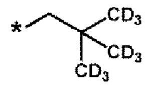
9-15
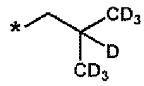
9-16
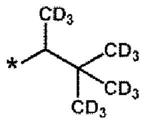
9-17
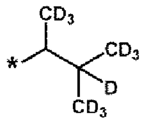
9-18
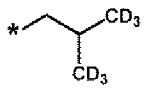
9-19
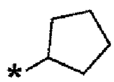
10-1
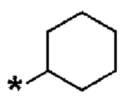
10-2
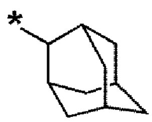
10-3
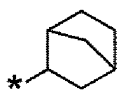
10-4
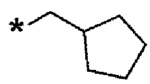
10-5
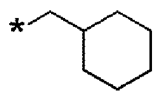
10-6
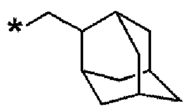
10-7
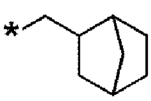
10-8
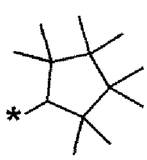
10-9
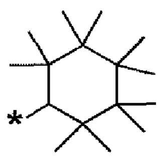
10-10
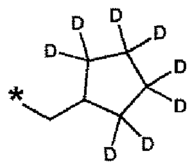
10-11
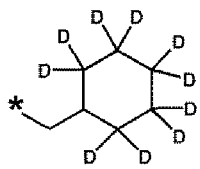
10-12
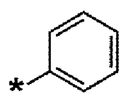
10-13
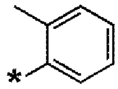
10-14
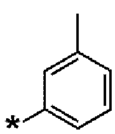
10-15
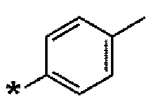
10-16
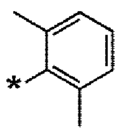
10-17
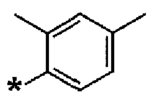
10-18
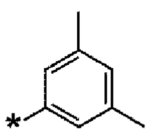
10-19
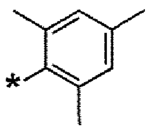
10-20

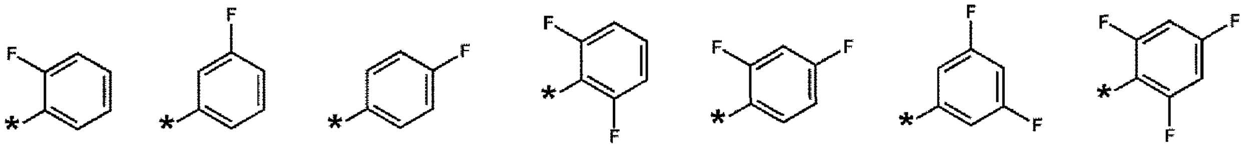
10-21 10-22 10-23 10-24 10-25 10-26 10-27

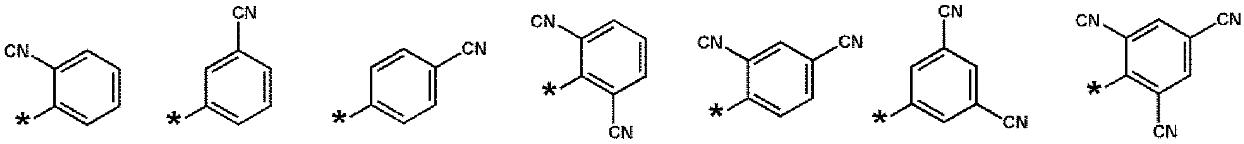
10-28 10-29 10-30 10-31 10-32 10-33 10-34

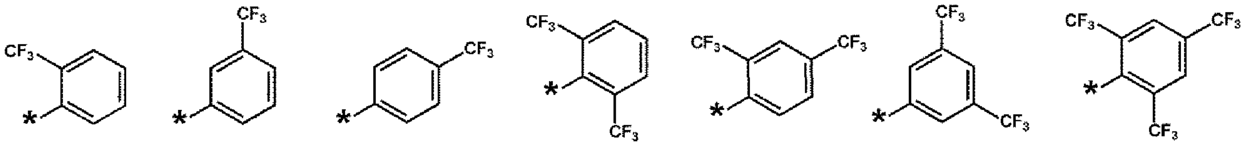
10-35 10-36 10-37 10-38 10-39 10-40 10-41

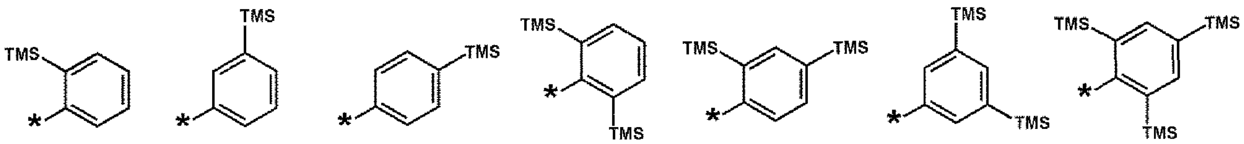
10-42 10-43 10-44 10-45 10-46 10-47 10-48

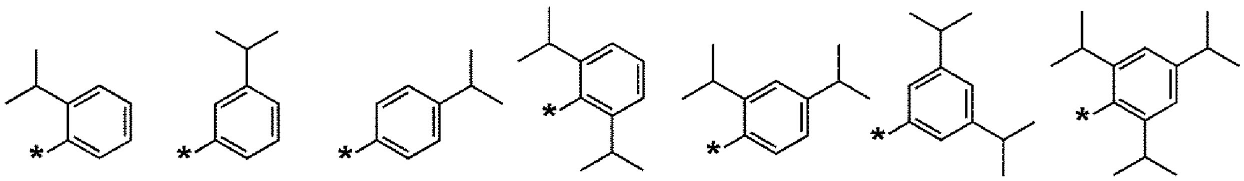
10-49 10-50 10-51 10-52 10-53 10-54 10-55

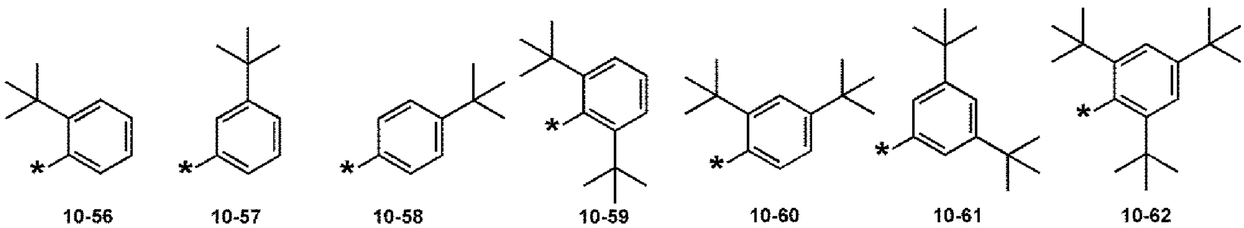
10-56 10-57 10-58 10-59 10-60 10-61 10-62

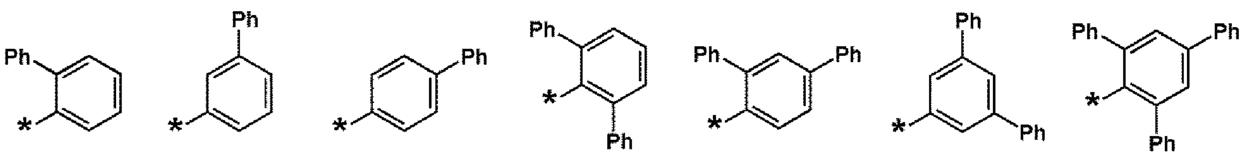
10-63 10-64 10-65 10-66 10-67 10-68 10-69

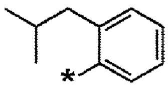
10-70
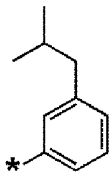
10-71
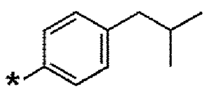
10-72
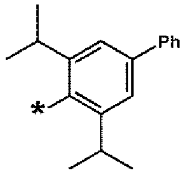
10-73
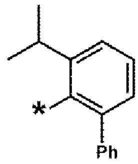
10-74
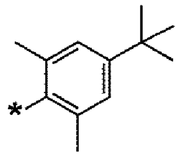
10-75

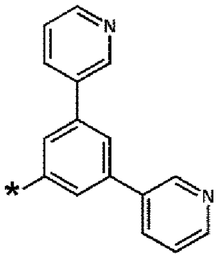
10-76
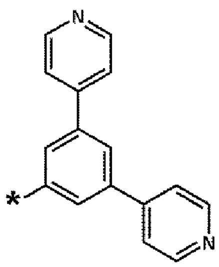
10-77
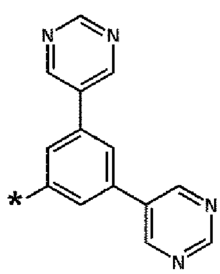
10-78
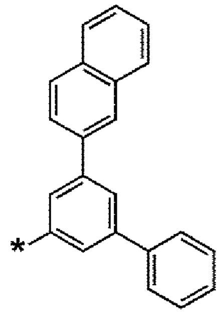
10-79
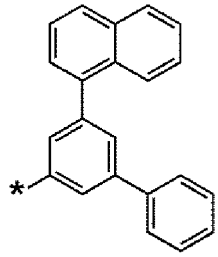
10-80

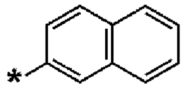
10-81
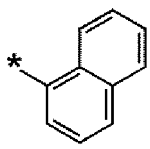
10-82
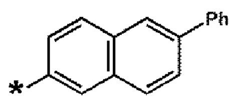
10-83
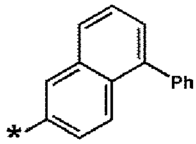
10-84
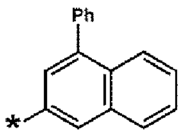
10-85

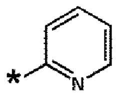
10-86
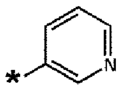
10-87
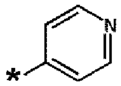
10-88
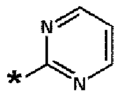
10-89
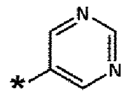
10-90
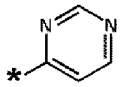
10-91
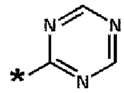
10-92

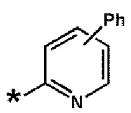
10-93
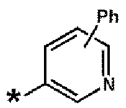
10-94
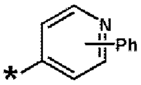
10-95
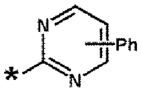
10-96
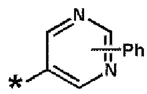
10-97
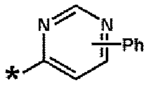
10-98
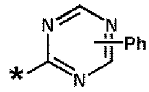
10-99

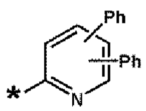
10-100
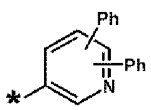
10-101
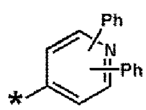
10-102
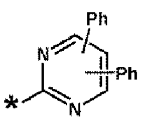
10-103
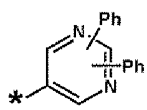
10-104
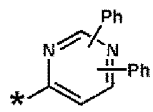
10-105
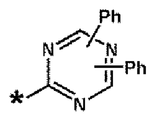
10-106

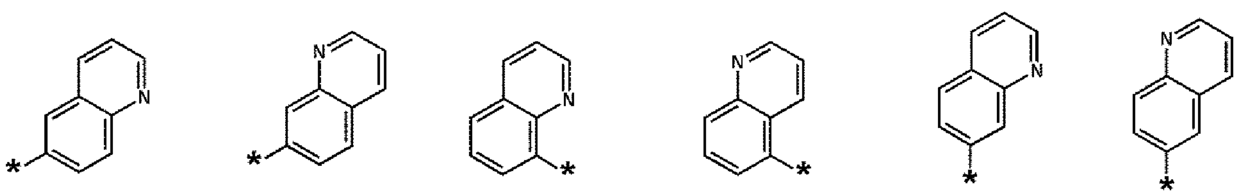
10-107
10-108
10-109
10-110
10-111
10-112

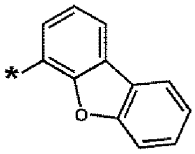
10-113

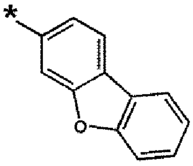
10-114

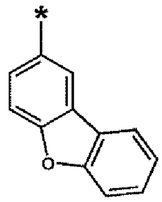
10-115

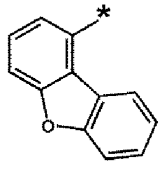
10-116

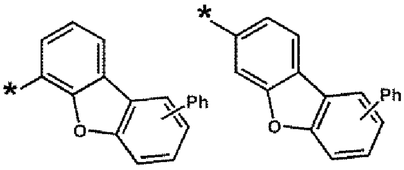
10-117

10-118

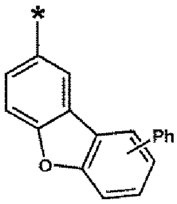
10-119

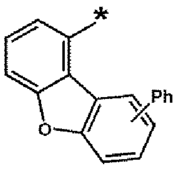
10-120

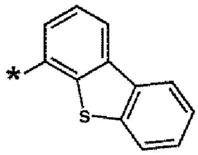
10-121

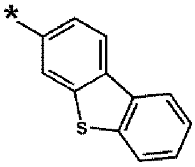
10-122

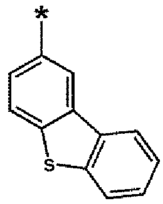
10-123

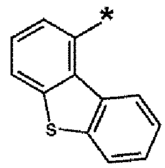
10-124

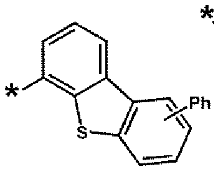
10-125

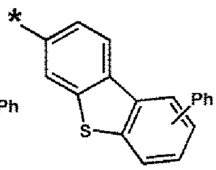
10-126

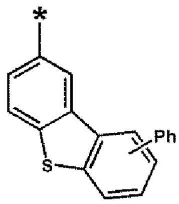
10-127

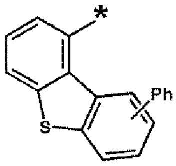
10-128

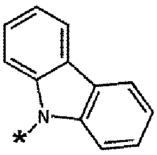
10-129

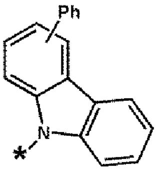
10-130

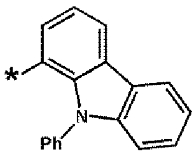
10-131

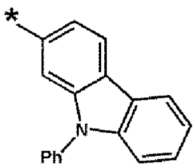
10-132

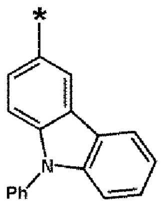
10-133

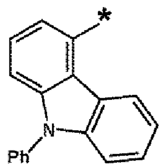
10-134

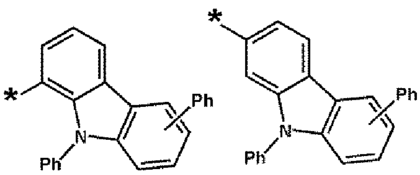
10-135

10-136

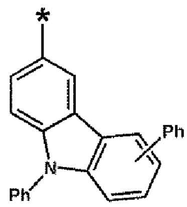
10-137

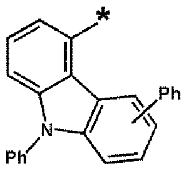
10-138

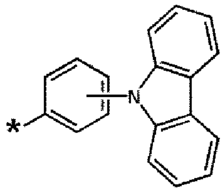
10-139

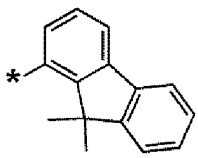
10-140

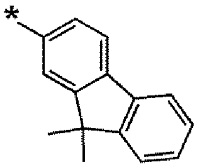
10-141

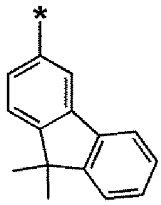
10-142

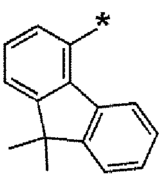
10-143

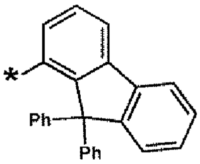
10-144

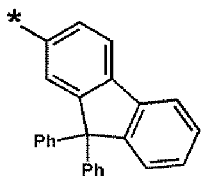
10-145

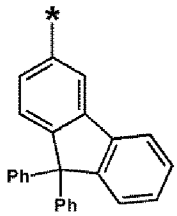
10-146

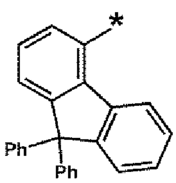
10-147

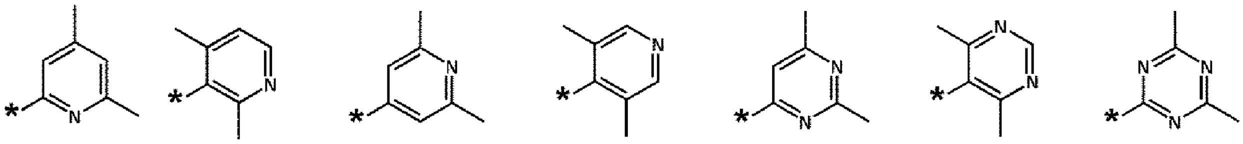
10-148 10-149 10-150 10-151 10-152 10-153 10-154

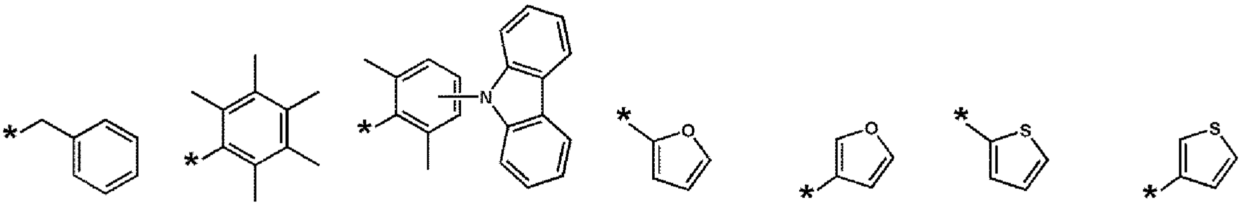
10-155 10-156 10-157 10-158 10-159 10-160 10-161

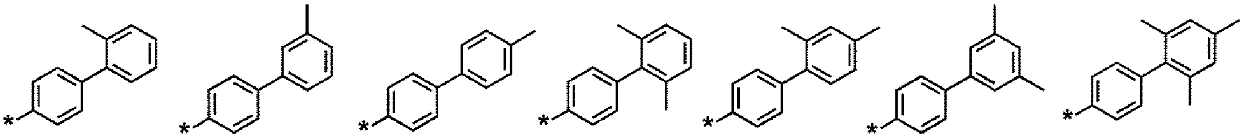
10-162 10-163 10-164 10-165 10-166 10-167 10-168

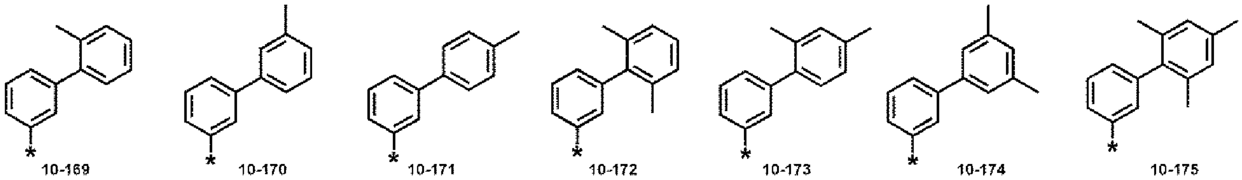
10-169 10-170 10-171 10-172 10-173 10-174 10-175

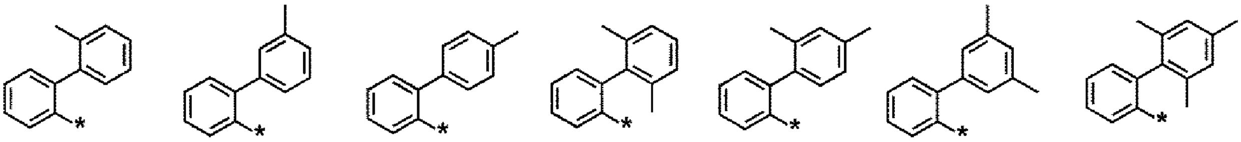
10-176 10-177 10-178 10-179 10-180 10-181 10-182

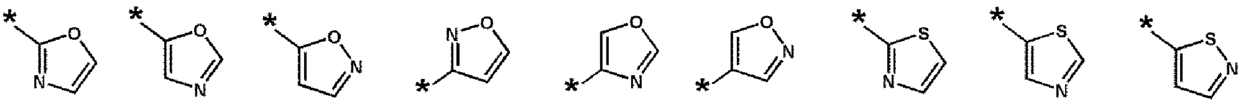
10-183 10-184 10-185 10-186 10-187 10-188 10-189 10-190 10-191

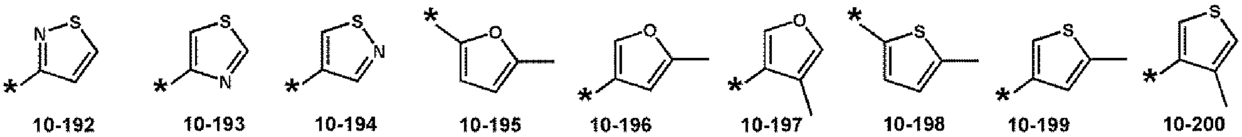
10-192 10-193 10-194 10-195 10-196 10-197 10-198 10-199 10-200

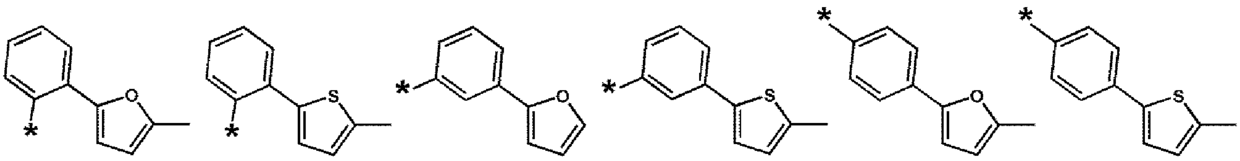
10-201 10-202 10-203 10-204 10-205 10-206

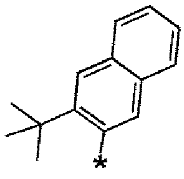
10-207

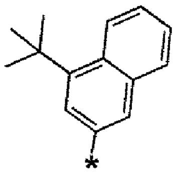
10-208

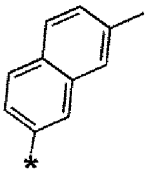
10-209

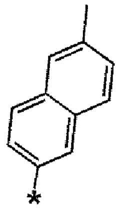
10-210

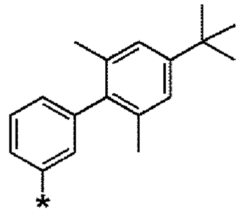
10-211

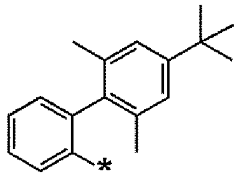
10-212

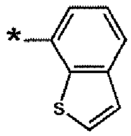
10-213

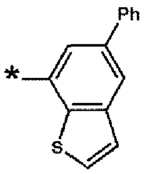
10-214

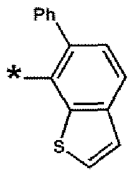
10-215

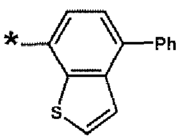
10-216

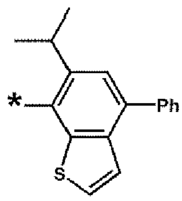
10-217

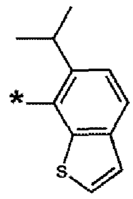
10-218

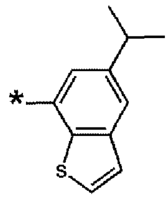
10-219

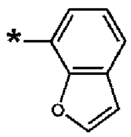
10-220

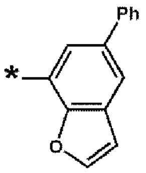
10-221

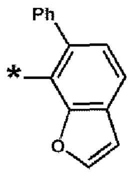
10-222

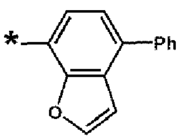
10-223

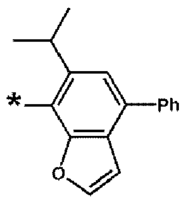
10-224

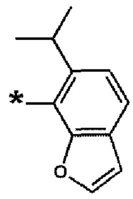
10-225

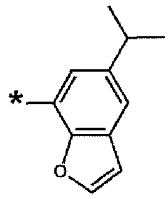
10-226

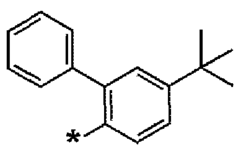
10-227

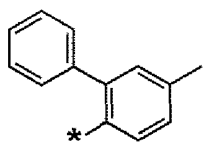
10-228

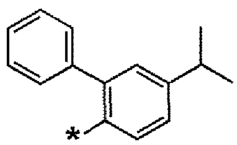
10-229

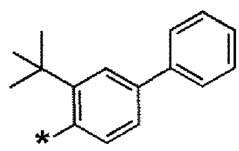
10-230

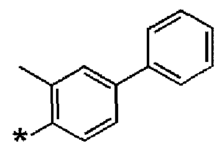
10-231

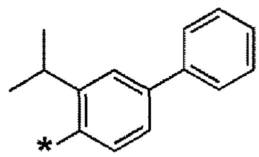
10-232

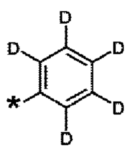
11-1

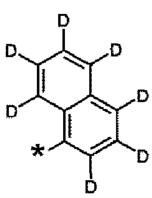
11-2

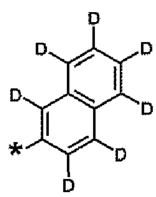
11-3

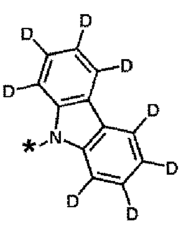
11-4

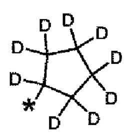
11-5

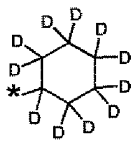
11-6

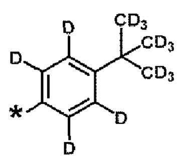
11-7

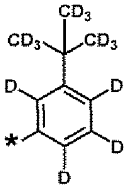 11-8
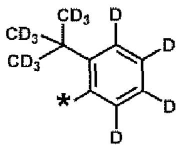 11-9
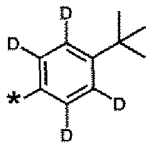 11-10
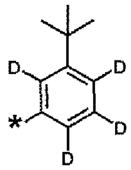 11-11
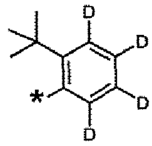 11-12
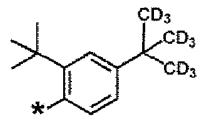 11-13
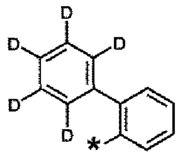 11-14

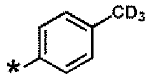 11-15
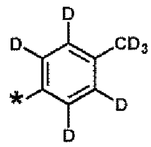 11-16
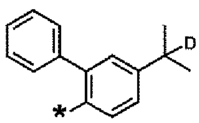 11-17
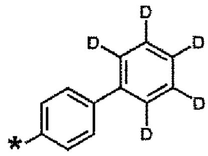 11-18
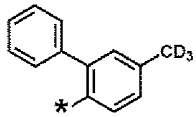 11-19
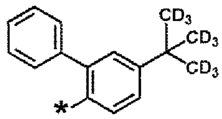 11-20

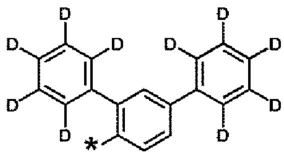 11-21
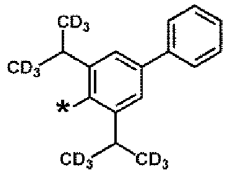 11-22
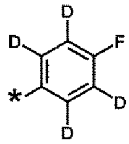 11-23
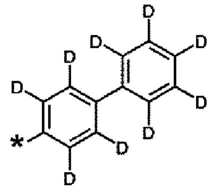 11-24
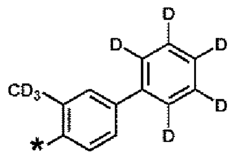 11-25

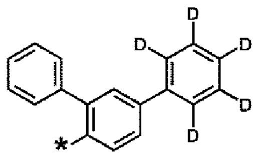 11-26
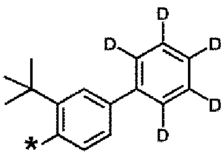 11-27
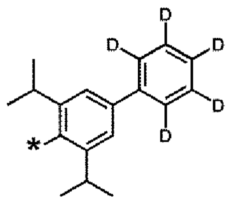 11-28
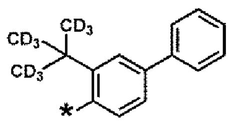 11-29
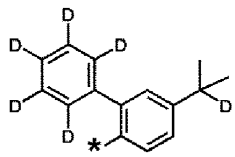 11-30

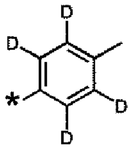 11-31
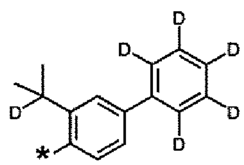 11-32
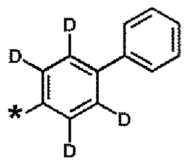 11-33
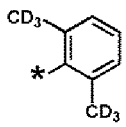 11-34
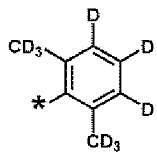 11-35
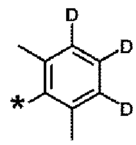 11-36

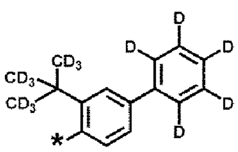 11-37
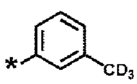 11-38
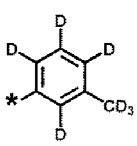 11-39
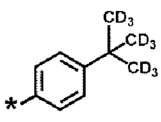 11-40
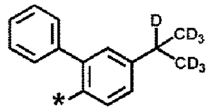 11-41

Regarding Formulae 9-1 to 9-19, 10-1 to 10-232 and 11-1 to 11-41, * indicates a binding site to neighboring atoms, Ph is a phenyl group, and TMS is a trimethylsilyl group.

In one or more embodiments, the deuterium-containing group may be selected from $-CD_3$, $-CD_2(CD_3)$, $-CD(CD_3)_2$, $-C(CD_3)_3$, $-CD_2-C(CD_3)_3$, $-CD_2-CD(CD_3)_2$, $-CD_2-CD_2(CD_3)$, $-CD(CD_3)-C(CD_3)_3$, $-CD(CD_3)-CD(CD_3)_2$, $-CD(CD_3)-CD_2(CD_3)$, $-C(CD_3)_2-C(CD_3)_3$, $-C(CD_3)_2-CD(CD_3)_2$, $-C(CD_3)_2-CD_2(CD_3)$, and a group represented by one of Formula 11-1 to 11-41, but embodiments are not limited thereto.

Regarding Formula 1, a1 to a4 respectively indicate numbers of $*-[(L_1)_{b1}-(R_1)c_1]$, $*-[(L_2)b_2-(R_2)c_2]$, $*-[(L_3)_{b3}-(R_3)_{c3}]$, and $*-[(L_4)_{b4}-(R_4)_{c4}]$, and n1 to n4 respectively indicate numbers of $Z_1$ to $Z_4$, and a1 to a4 and n1 to n4 may each independently be an integer from 0 to 20. When a1 is two or more, two or more groups $*-[(L_1)_{b1}-(R_1)c_1]$ may

be identical to or different from each other, when a2 is two or more, two or more groups *-[$(L_2)_{b2}$-$(R_2)_{c2}$] may be identical to or different from each other, when a3 is two or more, two or more groups *-[$(L_3)_{b3}$-$(R_3)_{c3}$] may be identical to or different from each other, when a4 is two or more, two or more groups *-[$(L_4)_{b4}$-$(R_4)_{c4}$] may be identical to or different from each other, when n1 is two or more, two or more groups $Z_1$ may be identical to or different from each other, when n2 is two or more, two or more groups $Z_2$ may be identical to or different from each other, when n3 is two or more, two or more groups $Z_3$ may be identical to or different from each other, and when n4 is two or more, two or more groups $Z_4$ may be identical to or different from each other.

In Formula 1,

i) when $X_{51}$ is O, S, C(=O), or N, the sum of n1 to n4 may be 1 or more,
ii) when $X_{51}$ is N[$(L_7)_{b7}$-$(R_7)_{c7}$], C($R_7$), Si($R_7$), or Ge($R_7$), a) $R_7$ is deuterium or a deuterium-containing group; b) the sum of n1 to n4 may be 1 or more; or c) $R_7$ is deuterium or a deuterium-containing group and the sum of n1 to n4 may be 1 or more,
iii) when $X_{51}$ is C($R_7$)($R_8$), Si($R_7$)($R_8$), or Ge($R_7$)($R_8$), a) at least one selected from $R_7$ and $R_8$ may be a deuterium or a deuterium-containing group; b) the sum of n1 to n4 may be 1 or more; or c) at least one selected from $R_7$ and $R_8$ may be deuterium or a deuterium-containing group and the sum of n1 to n4 may be 1 or more.

That is, Formula 1 may essentially include at least one deuterium and/or at least one deuterium-containing group.

In one or more embodiments, in Formula 1,

$Y_3$ to $Y_5$ may each be C,
a bond between $X_{51}$ and $Y_3$ and a bond between $X_{51}$ and $Y_5$ may each be a single bond, and
a) $X_{51}$ may be O or S, and the sum of n1 to n4 may be 1, 2, 3, or 4; b) $X_{51}$ may be N[$(L_7)_{b7}$-$(R_7)_{c7}$] and $R_7$ may be deuterium or a deuterium-containing group; c) $X_{51}$ may be N[$(L_7)_{b7}$-$(R_7)_{c7}$], and the sum of n1 to n4 may be 1, 2, 3, or 4; d) $X_{51}$ may be N[$(L_7)_{b7}$-$(R_7)_{c7}$], $R_7$ may be deuterium or deuterium-containing group, and the sum of n1 to n4 may be 1, 2, 3, or 4; e) $X_{51}$ may be C($R_7$)($R_8$), and at least one selected from $R_7$ and $R_8$ may be deuterium or a deuterium-containing group; or f) $X_{51}$ may be C($R_7$)($R_8$), and the sum of n1 to n4 may be 1, 2, 3, or 4, but embodiments are not limited thereto.

In one or more embodiments, Formula 1 may satisfy at least one of <Condition A> to <Condition D>:

<Condition A>
n1 may be 1, 2, 3 or 4.
<Condition B>
$X_{51}$ may be N[$(L_7)_{b7}$-$(R_7)_{c7}$] and $R_7$ may be deuterium or a deuterium-containing group.
<Condition C>
n3 may be 1, 2 or 3.
<Condition D>
n4 may be 1, 2, 3 or 4.

In one or more embodiments, in Formula 1,

i) n1 = n2 = n3 = 0, and n4 may be 1, 2, 3, or 4,
ii) n1 = n2 = n4 = 0, and n3 may be 1, 2, 3, or 4,
iii) n1 = n3 = n4 = 0, and n2 may be 1, 2, 3, or 4,
iv) n2 = n3 = n4 = 0, and n1 may be 1, 2, 3, or 4, or
v) n1 = n2 = n3 = n4 = 0, $X_{51}$ may be N-[$(L_7)_{b7}$-$(R_7)_{c7}$], C($R_7$), Si($R_7$), or Ge($R_7$), and $R_7$ may be deuterium or a deuterium-containing group; or
vi) n1 = n2 = 0, and n3 and n4 may each independently be 1, 2, 3, or 4,
vii) n1 = n2 = n3 = 0, n4 may be 1, 2, 3, or 4, $X_{51}$ may be N-[$(L_7)_{b7}$-$(R_7)_{c7}$], C($R_7$), Si($R_7$), or Ge($R_7$), and $R_7$ may be deuterium or a deuterium-containing group,
viii) n1 = n2 = n4 = 0, n3 may be 1, 2, 3, or 4, $X_{51}$ may be N-[$(L_7)_{b7}$-$(R_7)_{c7}$], C($R_7$), Si($R_7$), or Ge($R_7$), and $R_7$ may be deuterium or a deuterium-containing group, or
ix) n2 = n4 = 0, and n1 and n3 may each independently be 1, 2, 3, or 4, but embodiments are not limited thereto.

In one or more embodiments, regarding Formula 1,

i) $X_1$ may be a chemical bond, and $T_1$ may be a single bond, a moiety represented by

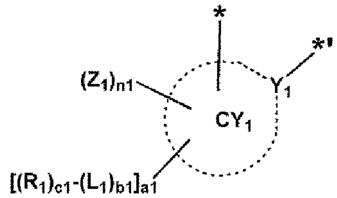

may be a group represented by Formula CY1-B,

ii) $X_1$ may be O, S, N(R'), P(R'), B(R'), C(R')(R"), Si(R')(R"), or N(R')(R"), and $T_1$ may be a single bond, a moiety represented by

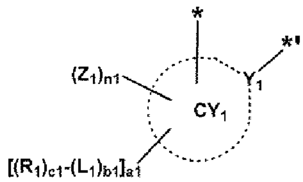

may be a group represented by Formula CY1-A, or

iii) $X_1$ may be a chemical bond, and $T_1$ may be *-N($R_9$)-*', *-B($R_9$)-*', *-P($R_9$)-*', *-C($R_9$)($R_{10}$)-*', *-Si($R_9$)($R_{10}$)-*', *-Ge($R_9$)($R_{10}$)-*', *-S-*', *-Se-*', *-O-*', *-C(=O)-*', *-S(=O)-*', *-S(=O)$_2$-*', *-C($R_9$)=*', *=C($R_9$)-*', *-C($R_9$)=C($R_{10}$)-*', *-C(=S)-*', or *-C≡C-*', and a moiety represented by

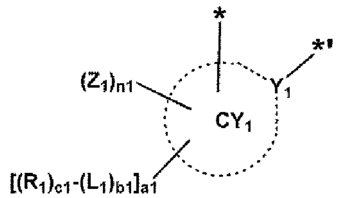

may be a group represented by Formula CY1-A:

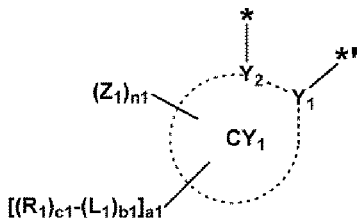

CY1-A

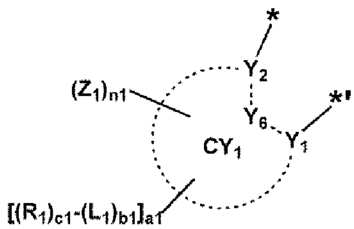

CY1-B

Regarding Formulae CY1-A and CY1-B, $Y_1$, $CY_1$, $L_1$, b1, $R_1$, c1, a1, $Z_1$, and n1 are the same as described above, $Y_2$ and $Y_6$ may each independently be N or C, and a bond between $Y_1$ and $Y_2$, a bond between $Y_1$ and $Y_6$, and a bond between $Y_6$ and $Y_2$ may each be a chemical bond.

In one or more embodiments, regarding Formula 1, a moiety represented by

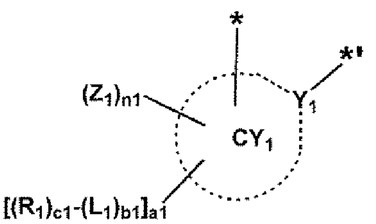

may be a group represented by one of Formulae CY1-1 to CY1-40:

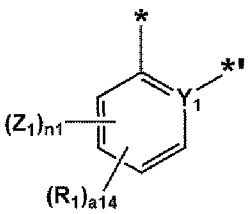

CY1-1

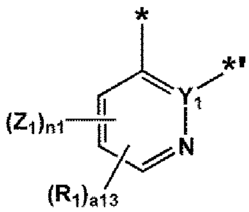

CY1-2

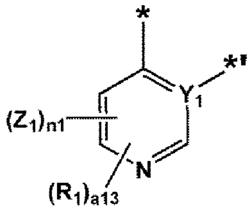

CY1-3

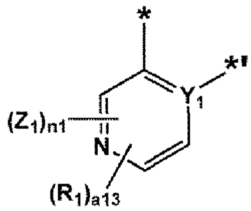

CY1-4

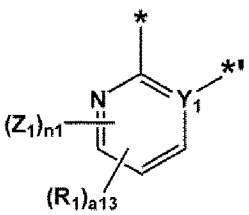

CY1-5

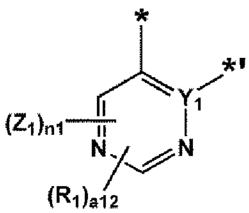

CY1-6

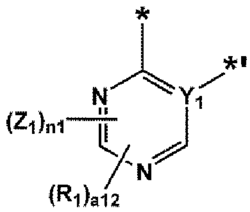

CY1-7

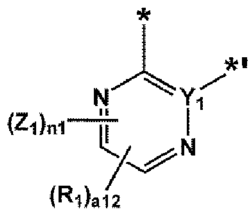

CY1-8

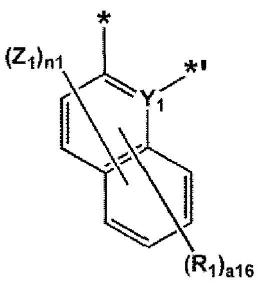

CY1-9

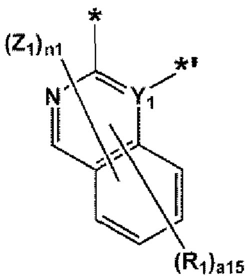

CY1-10

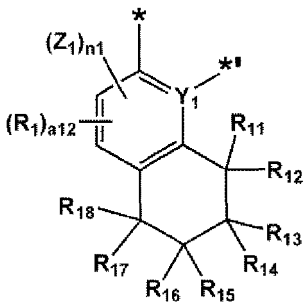

CY1-11

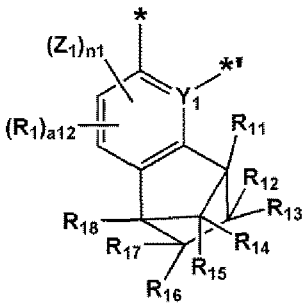

CY1-12

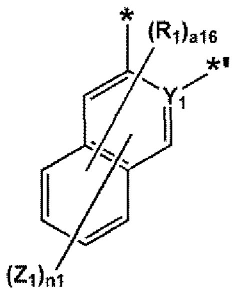

CY1-13

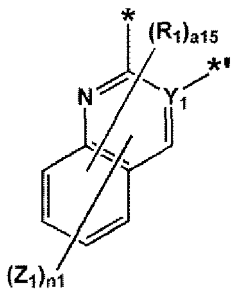

CY1-14

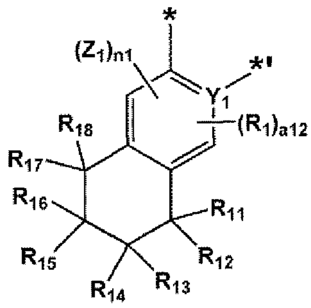

CY1-15

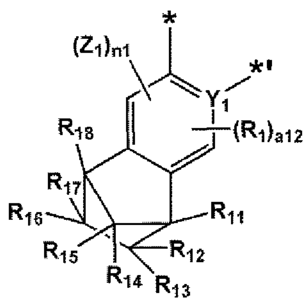

CY1-16

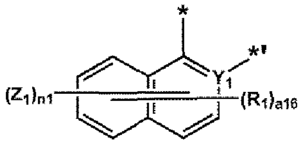

CY1-17

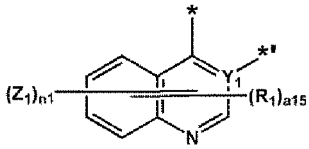

CY1-18

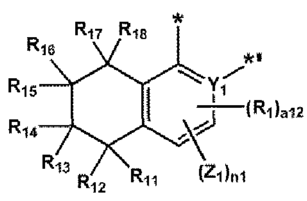

CY1-19

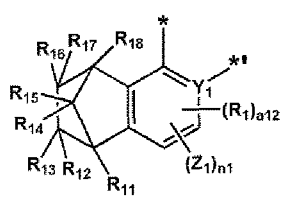

CY1-20

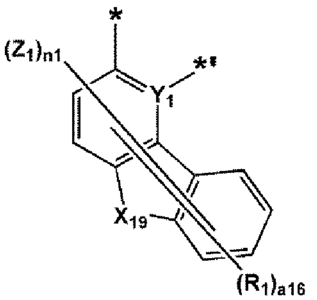
CY1-21

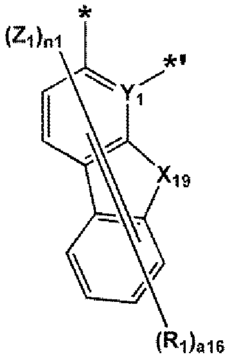
CY1-22

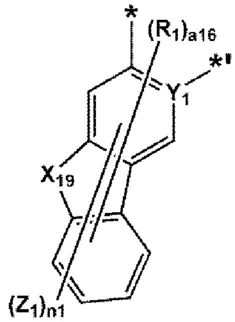
CY1-23

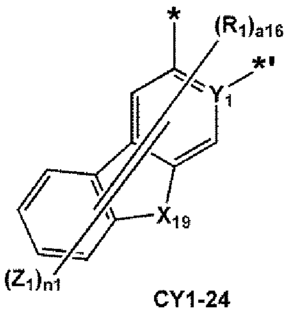
CY1-24

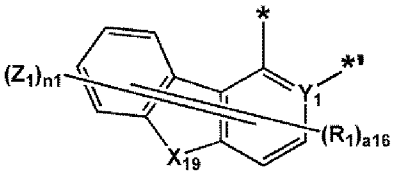
CY1-25

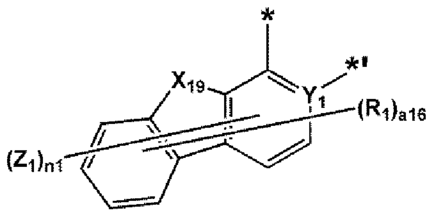
CY1-26

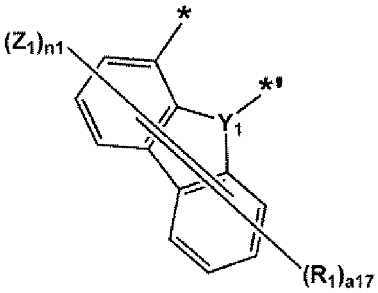
CY1-27

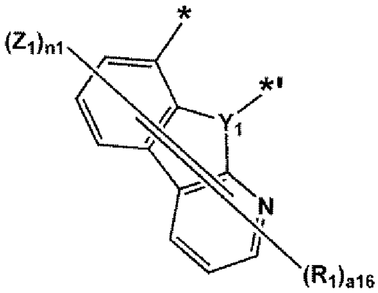
CY1-28

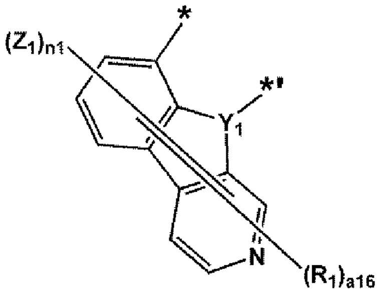
CY1-29

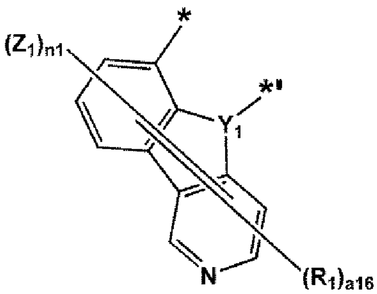
CY1-30

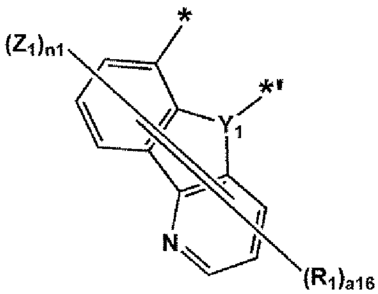
CY1-31

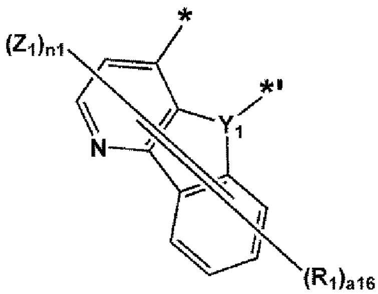
CY1-32

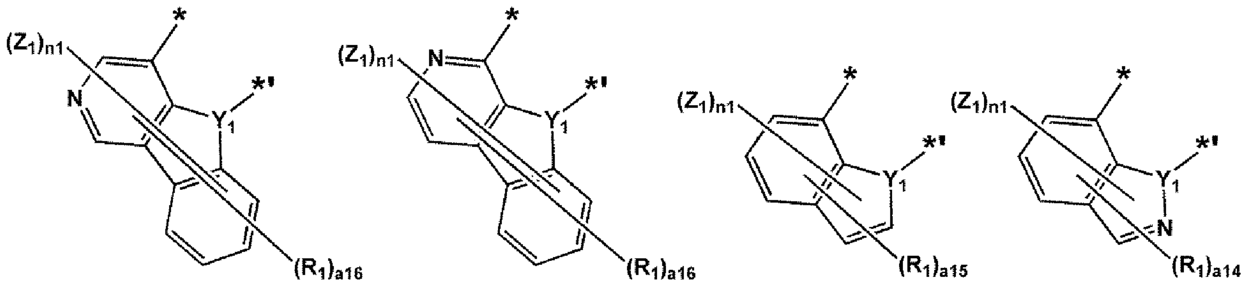

CY1-33 CY1-34 CY1-35 CY1-36

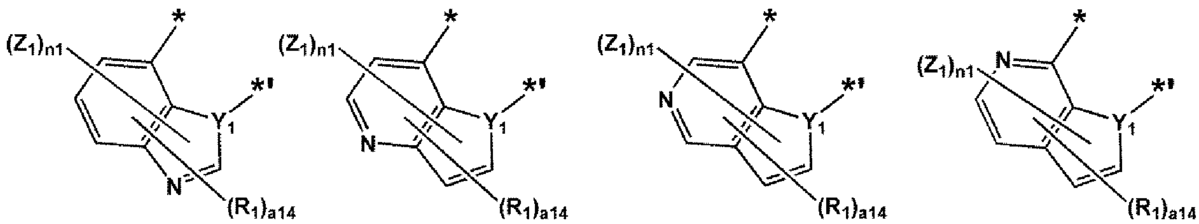

CY1-37 CY1-38 CY1-39 CY1-40 .

In Formula CY1-1 to CY1-40,

$Y_1$, $R_1$, $Z_1$, and n1 are the same as described above, and n1 may be an integer from 0 to 7,
$X_{19}$ may be $C(R_{19a})(R_{19b})$, $N[(L_{19})_{b19}-(R_{19})_{c19}]$, O, S, or $Si(R_{19a})(R_{19b})$,
$L_{19}$ may be the same as explained in connection with $L_1$;
b19 and c19 are the same as described in connection with b1 and c1,
$R_{11}$ to $R_{19}$, $R_{19a}$, and $R_{19b}$ are the same as described in connection with $R_1$,
a12 may be an integer from 0 to 2,
a13 may be an integer from 0 to 3,
a14 may be an integer from 0 to 4,
a15 may be an integer from 0 to 5,
a16 may be an integer from 0 to 6,
a17 may be an integer from 0 to 7,
*' indicates a binding site to $X_1$ or M in Formula 1, and
* indicates a binding site to $T_1$ in Formula 1.

n1 in Formula CY1-1 to CY1-40 has been described based on when n1 has its maximum value, and n1 may be an integer from 0 to 7, varying depending on a corresponding chemical formula. For example, n1 in Formula CY1-1 may be 0, 1, 2, 3, or 4, n1 in Formula CY1-2 may be 0, 1, 2, or 3, and n1 in Formula CY1-27 may be 0, 1, 2, 3, 4, 5, 6, or 7.

In one or more embodiments, regarding Formula 1, a moiety represented by

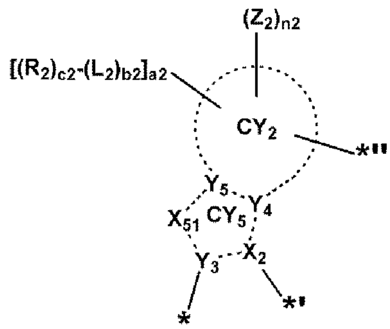

may be a group represented by one of Formulae CY2-1 to CY2-20:

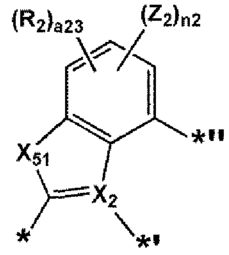
CY2-1

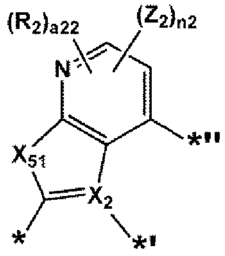
CY2-2

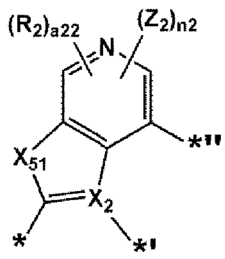
CY2-3

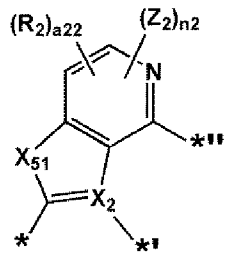
CY2-4

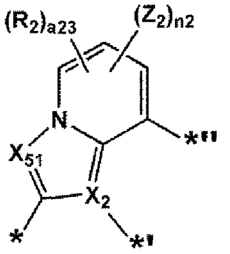
CY2-5

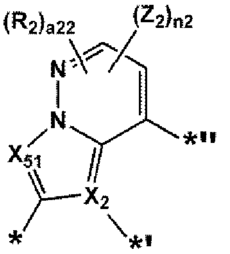
CY2-6

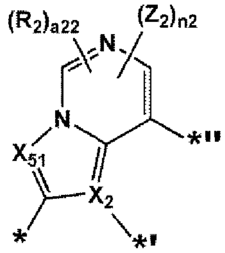
CY2-7

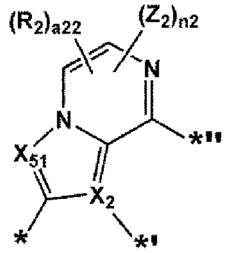
CY2-8

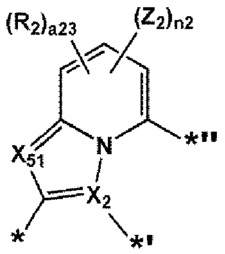
CY2-9

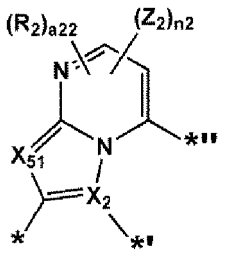
CY2-10

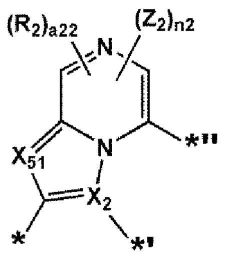
CY2-11

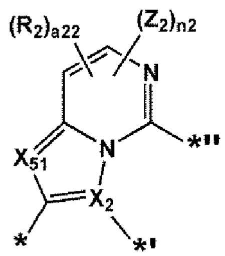
CY2-12

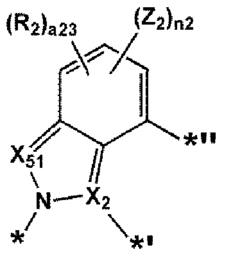
CY2-13

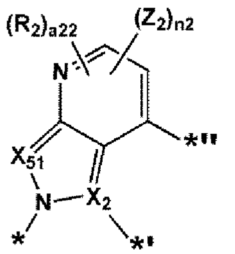
CY2-14

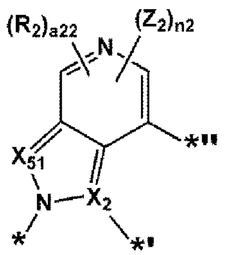
CY2-15

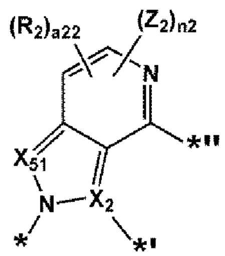
CY2-16

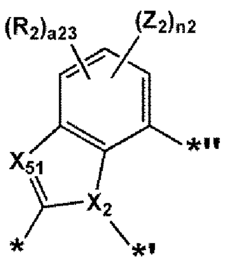
CY2-17

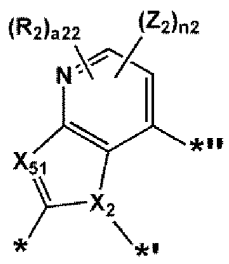
CY2-18

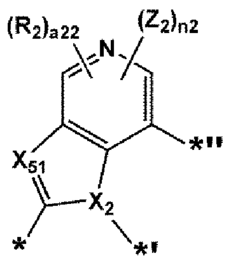
CY2-19

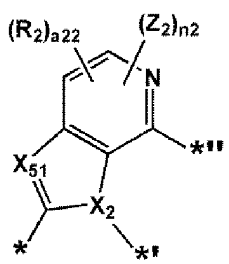
CY2-20 .

In Formulae CY2-1 to CY2-20,

$X_2$, $R_2$, $Z_2$, and n2 are the same as described above, and n2 may be an integer from 0 to 3,
$X_{51}$ in Formulae CY2-1 to CY2-4 may be O, S, N-[$(L_7)_{b7}$-$(R_7)_{c7}$], C($R_7$)($R_8$), Si($R_7$)($R_8$), Ge($R_7$)($R_8$), or C(=O),
$X_{51}$ in Formulae CY2-5 to CY2-20 may be N, C($R_7$), Si($R_7$), or Ge($R_7$),
$L_7$, b7, $R_7$, and c7 may be the same as described above,
a22 is an integer from 0 to 2,
a23 is an integer from 0 to 3,
* indicates a binding site to $T_1$ in Formula 1,
*' indicates a binding site to M in Formula 1, and
*" indicates a binding site to ring $CY_3$ in Formula 1.

n2 in Formula CY2-1 to CY2-20 has been described based on when n2 has its maximum value, and n2 may be an integer from 0 to 3, varying depending on a corresponding chemical formula. For example, n2 in Formula CY2-1 may be 0, 1, 2, or 3, and n2 in Formula CY2-2 may be 0, 1, or 2.

In one or more embodiments, regarding Formula 1, a moiety represented by

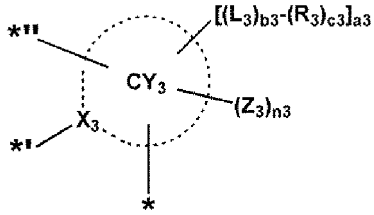

may be a group represented by one of Formulae CY3-1 to CY3-12:

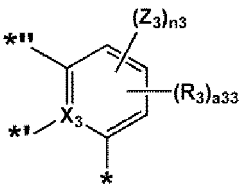

CY3-1

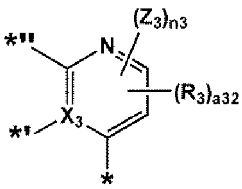

CY3-2

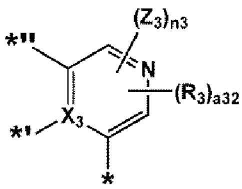

CY3-3

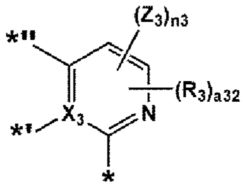

CY3-4

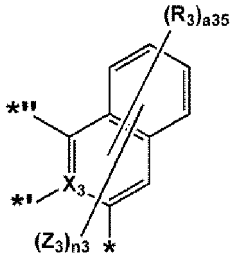

CY3-5

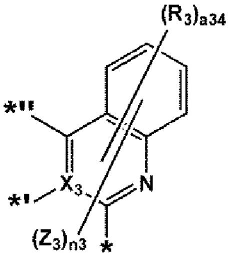

CY3-6

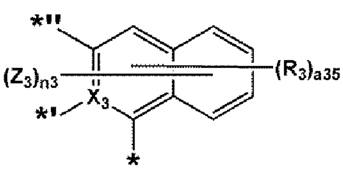

CY3-7

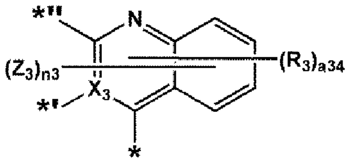

CY3-8

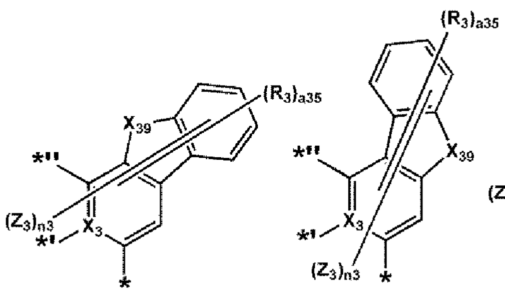

CY3-9 CY3-10

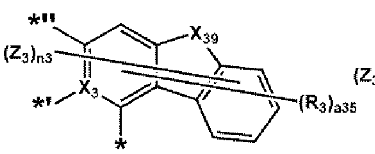

CY3-11

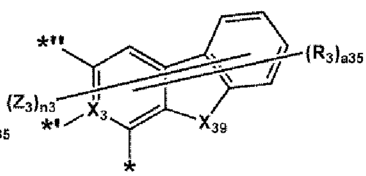

CY3-12

.

In Formulae CY3-1 to CY3-12,

$X_3$, $R_3$, $Z_3$, and n3 are the same as described above, and n3 may be an integer from 0 to 5,
$X_{39}$ may be $C(R_{39a})(R_{39b})$, $N[(L_{39})b_{39}\text{-}(R_{39})_{c39}]$, O, S, or $Si(R_{39a})(R_{39b})$,
$L_{39}$ may be the same as explained in connection with $L_3$,
b39 and c39 may be the same as described in connection with b3 and c3,
$R_{39a}$ and $R_{39b}$ may be the same as described in connection with $R_3$,
a32 may be an integer from 0 to 2,
a33 may be an integer from 0 to 3,
a34 may be an integer from 0 to 4,
a35 may be an integer from 0 to 5,
* indicates a binding site to $T_2$ in Formula 1,
*' indicates a binding site to M in Formula 1, and
*" indicates a binding site to ring $CY_2$ in Formula 1.

n3 in Formulae CY3-1 to CY3-12 has been described based on when n3 has its maximum value, and n3 may be an integer from 0 to 5, varying depending on a corresponding chemical formula. For example, n3 in Formula CY3-1 may be 0, 1, 2, or 3, and n3 in Formula CY3-9 may be 0, 1, 2, 3, 4, or 5.

In one or more embodiments, regarding Formula 1, a moiety represented by

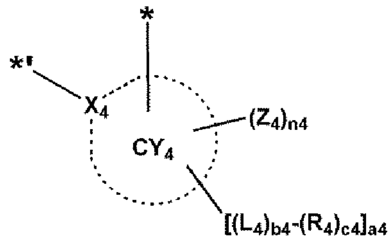

may be a group represented by one of Formulae CY4-1 to CY4-26:

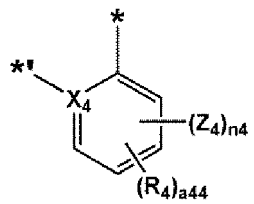

CY4-1

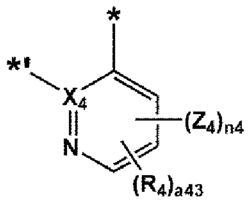

CY4-2

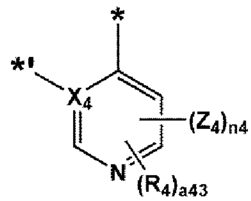

CY4-3

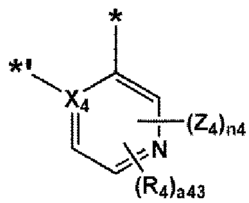

CY4-4

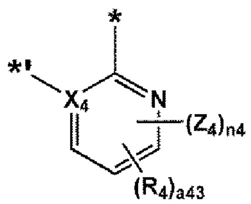

CY4-5

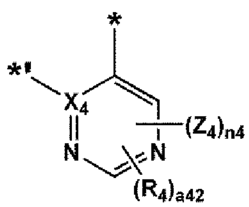

CY4-6

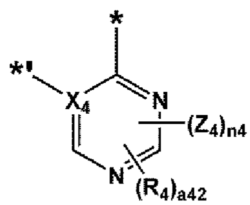

CY4-7

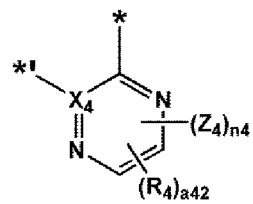

CY4-8

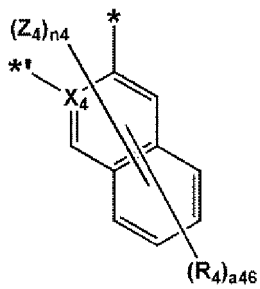

CY4-9

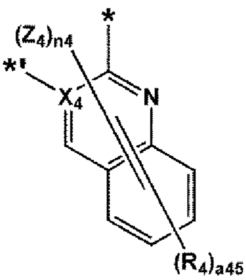

CY4-10

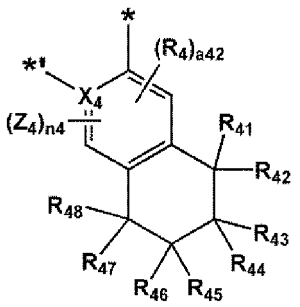

CY4-11

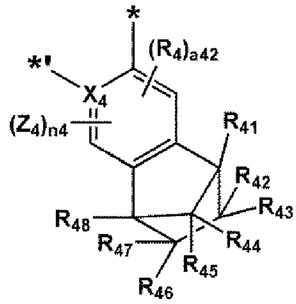

CY4-12

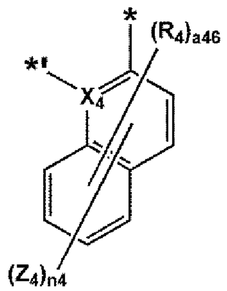

CY4-13

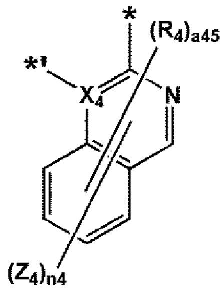

CY4-14

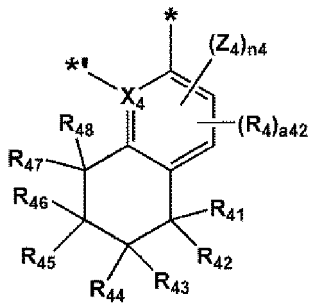

CY4-15

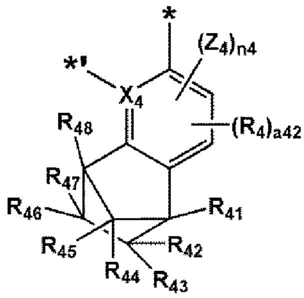

CY4-16

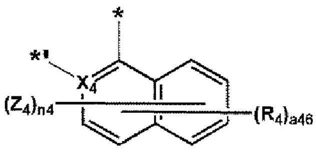

CY4-17

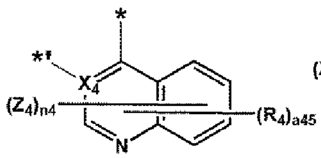

CY4-18

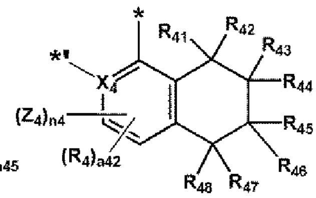

CY4-19

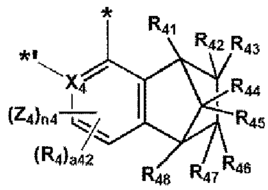

CY4-20

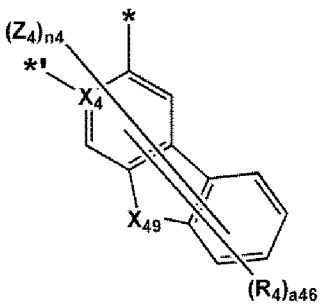

CY4-21

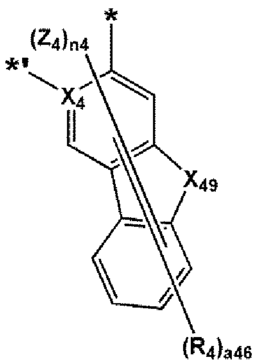

CY4-22

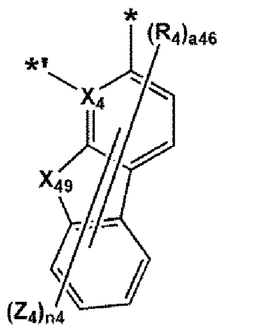

CY4-23

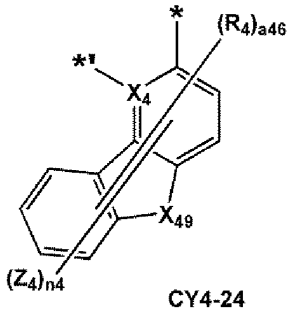

CY4-24

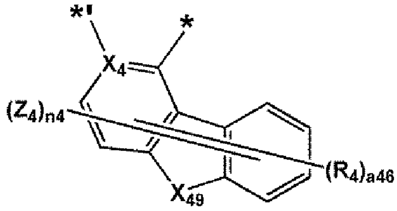

CY4-25

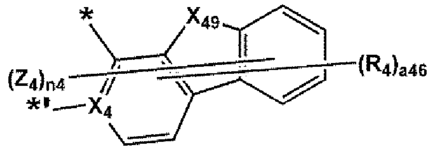

CY4-26

.

In Formulae CY4-1 to CY4-26,

$X_4$, $R_4$, $Z_4$, and n4 may be the same as described above, and n4 may be 0, 1, 2, 3, 4, 5, or 6,
$X_{49}$ may be $C(R_{49a})(R_{49b})$, $N[(L_{49})b_{49}\text{-}(R_{49})c_{49}]$, O, S, or $Si(R_{49a})(R_{49b})$,
$L_{49}$ may be the same as explained in connection with $L_4$,
b49 and c49 are the same as described in connection with b4 and c4,
$R_{41}$ to $R_{49}$, $R_{49a}$, and $R_{49b}$ are the same as described in connection with $R_4$,
a42 may be an integer from 0 to 2,
a43 may be an integer from 0 to 3,
a44 may be an integer from 0 to 4,
a45 may be an integer from 0 to 5,
a46 may be an integer from 0 to 6,
* indicates a binding site to $T_2$ in Formula 1, and
*' indicates a binding site to M in Formula 1.

n4 in Formulae CY4-1 to CY4-26 has been described based on when n4 has its maximum value, and n4 may be an integer from 0 to 6, varying depending on a corresponding chemical formula. For example, n4 in Formula CY4-1 may be 0, 1, 2, 3, or 4, n4 in Formula CY4-2 may be 0, 1, 2, or 3, and n4 in Formula CY4-17 may be 0, 1, 2, 3, 4, 5, or 6.

In one or more embodiments, regarding Formula 1, a moiety represented by

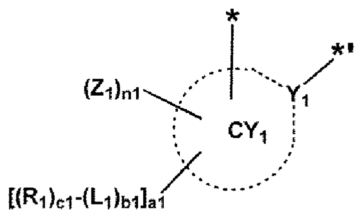

may be a group represented by one of Formulae CY1(1) to CY1(16) and CY1-d(1) to CY1-d(18), and (or), a moiety represented by

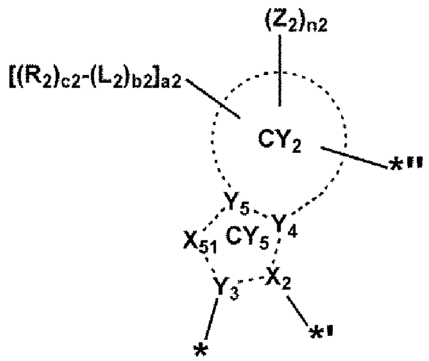

may be a group represented by one of Formulae CY2(1) to CY2(20) and CY2-d(1) to CY2-d(15), and (or), a moiety represented by

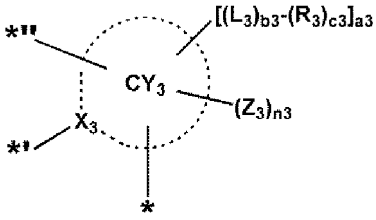

may be a group represented by one of Formulae CY3(1) to CY3(12) and CY3-d(1) to CY3-d(13), and (or), a moiety represented by

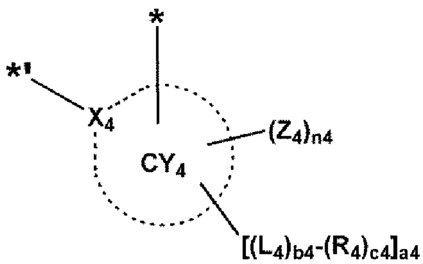

may be a group represented by one of Formulae CY4(1) to CY4(10) and CY4-d(1) to CY4-d(18), but embodiments are not limited thereto.

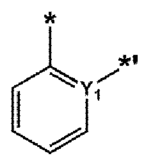
CY1(1)

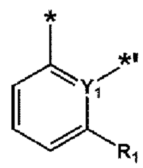
CY1(2)

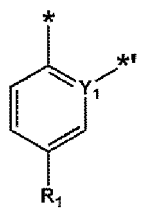
CY1(3)

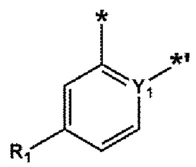
CY1(4)

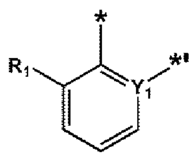
CY1(5)

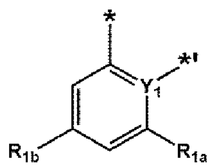
CY1(6)

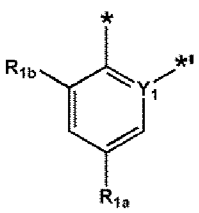
CY1(7)

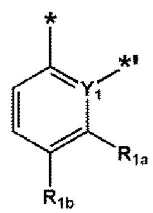
CY1(8)

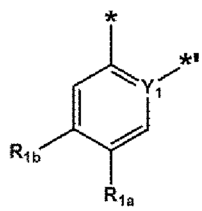
CY1(9)

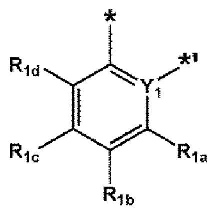
CY1(10)

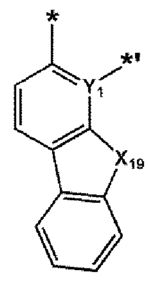
CY1(11)

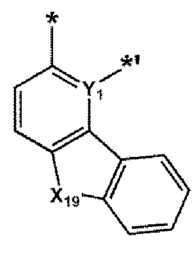
CY1(12)

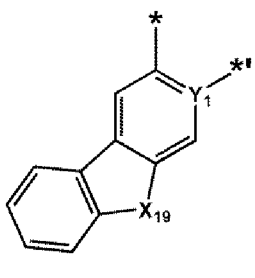
CY1(13)

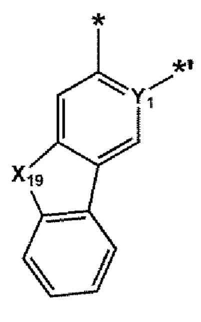
CY1(14)

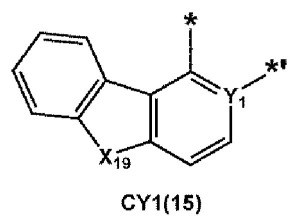
CY1(15)

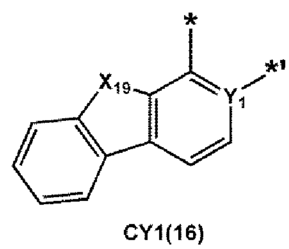
CY1(16)

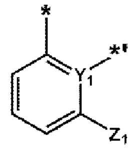
CY1-d(1)

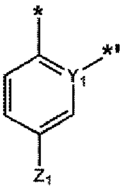
CY1-d(2)

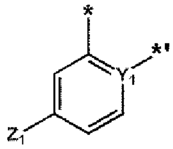
CY1-d(3)

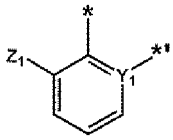
CY1-d(4)

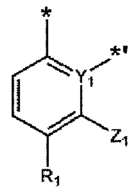
CY1-d(5)

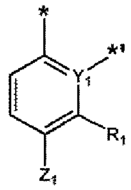
CY1-d(6)

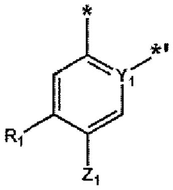
CY1-d(7)

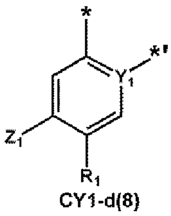
CY1-d(8)

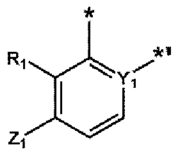
CY1-d(9)

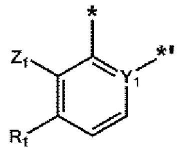
CY1-d(10)

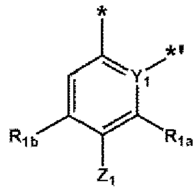
CY1-d(11)

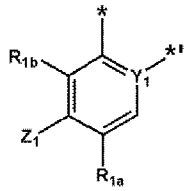
CY1-d(12)

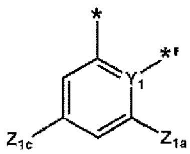
CY1-d(13)

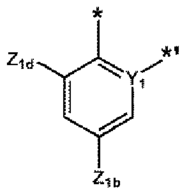
CY1-d(14)

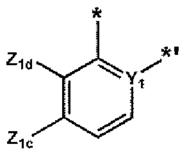
CY1-d(15)

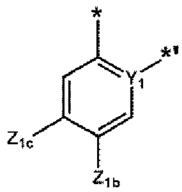
CY1-d(16)

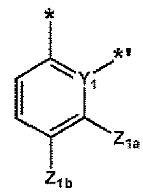
CY1-d(17)

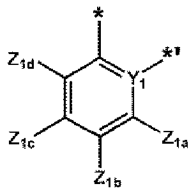
CY1-d(18)

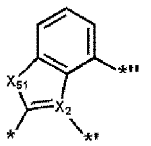
CY2(1)

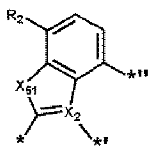
CY2(2)

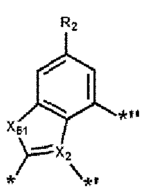
CY2(3)

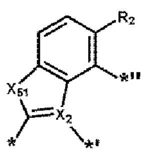
CY2(4)

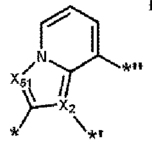
CY2(5)

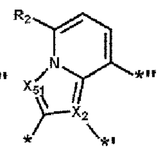
CY2(6)

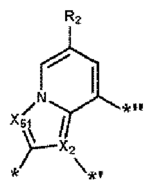
CY2(7)

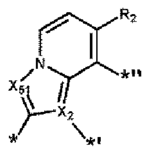
CY2(8)

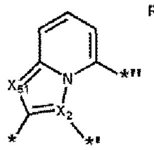
CY2(9)

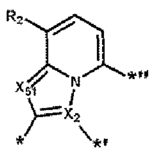
CY2(10)

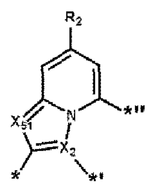
CY2(11)

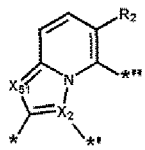
CY2(12)

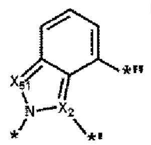
CY2(13)

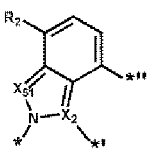
CY2(14)

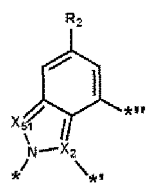
CY2(15)

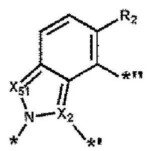
CY2(16)

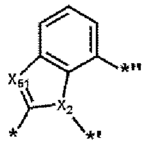
CY2(17)

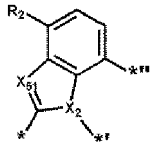
CY2(18)

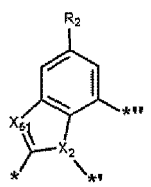
CY2(19)

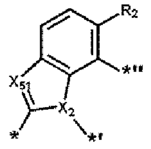
CY2(20)

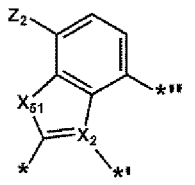
CY2-d(1)

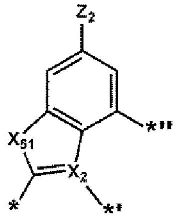
CY2-d(2)

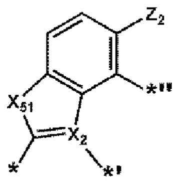
CY2-d(3)

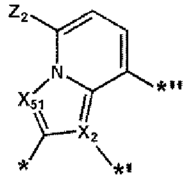
CY2-d(4)

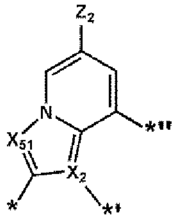
CY2-d(5)

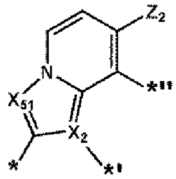
CY2-d(6)

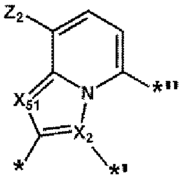
CY2-d(7)

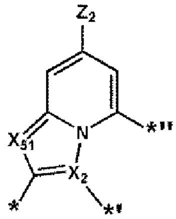
CY2-d(8)

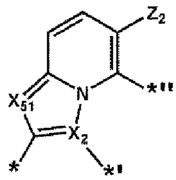
CY2-d(9)

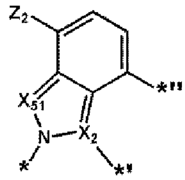
CY2-d(10)

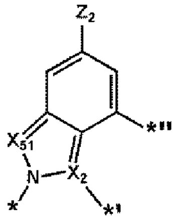
CY2-d(11)

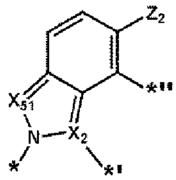
CY2-d(12)

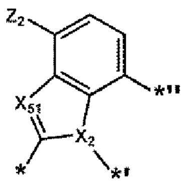
CY2-d(13)

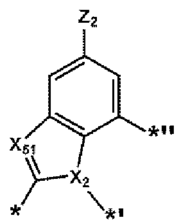
CY2-d(14)

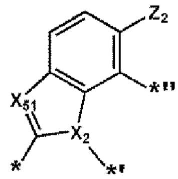
CY2-d(15)

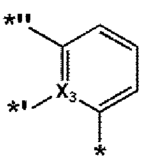
CY3(1)

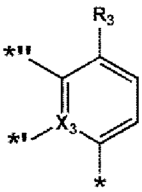
CY3(2)

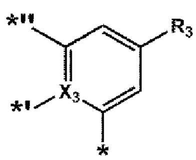
CY3(3)

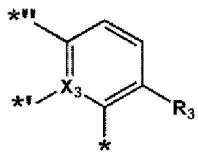
CY3(4)

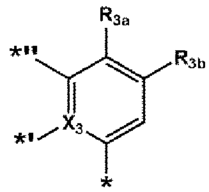
CY3(5)

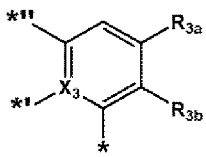
CY3(6)

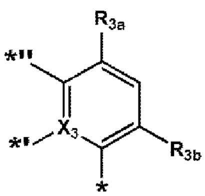
CY3(7)

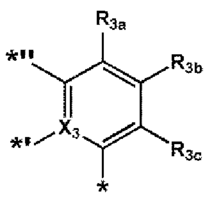
CY3(8)

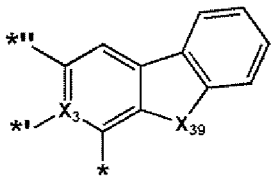
CY3(9)

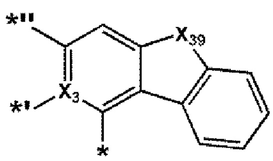
CY3(10)

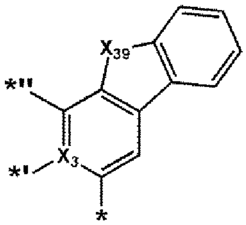
CY3(11)

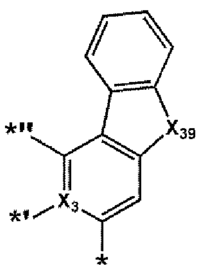
CY3(12)

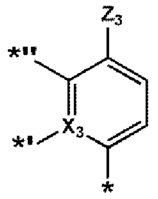
CY3-d(1)

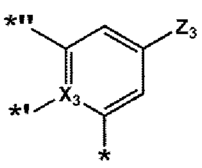
CY3-d(2)

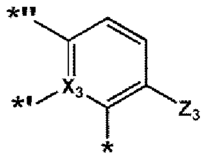
CY3-d(3)

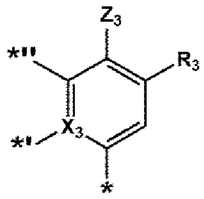
CY3-d(4)

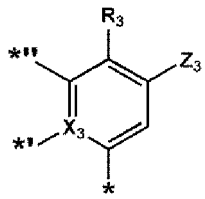
CY3-d(5)

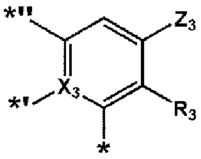
CY3-d(6)

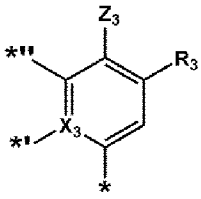
CY3-d(7)

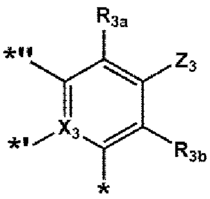
CY3-d(8)

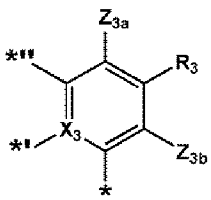
CY3-d(9)

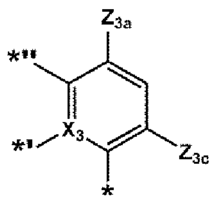
CY3-d(10)

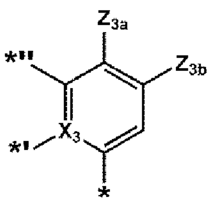
CY3-d(11)

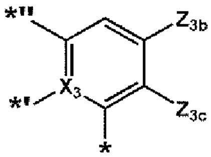
CY3-d(12)

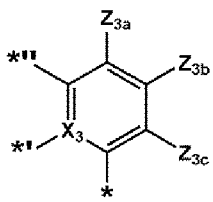
CY3-d(13)

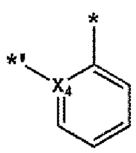
CY4(1)

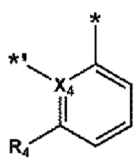
CY4(2)

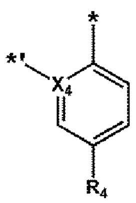
CY4(3)

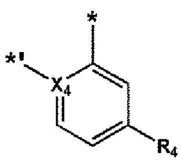
CY4(4)

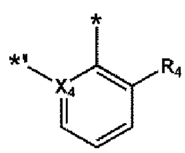
CY4(5)

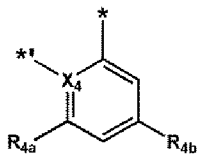
CY4(6)

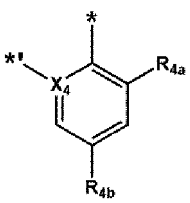
CY4(7)

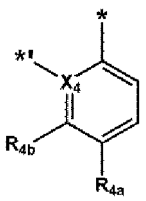
CY4(8)

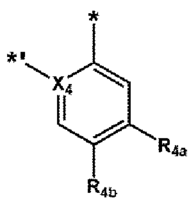
CY4(9)

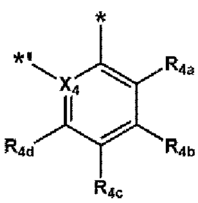
CY4(10)

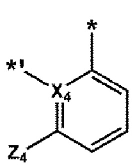
CY4-d(1)

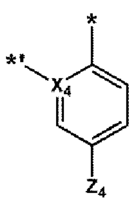
CY4-d(2)

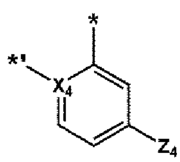
CY4-d(3)

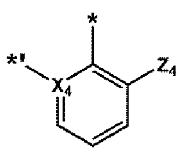
CY4-d(4)

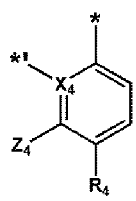
CY4-d(5)

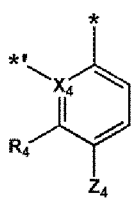
CY4-d(6)

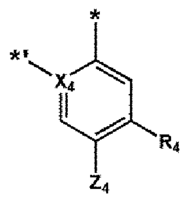
CY4-d(7)

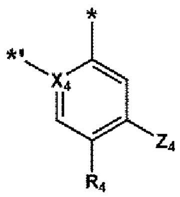
CY4-d(8)

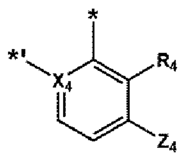
CY4-d(9)

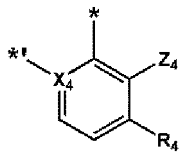
CY4-d(10)

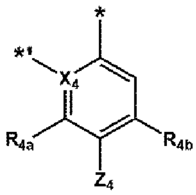
CY4-d(11)

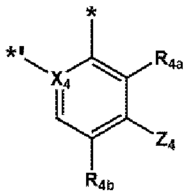
CY4-d(12)

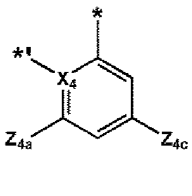
CY4-d(13)

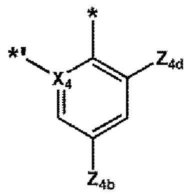
CY4-d(14)

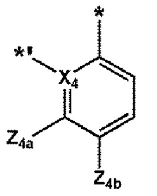
CY4-d(15)

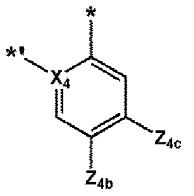
CY4-d(16)

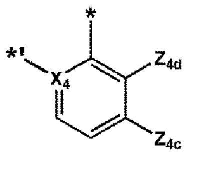
CY4-d(17)

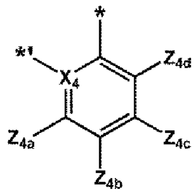
CY4-d(18) .

In Formulae CY1(1) to CY1(16), CY1-d(1) to CY1-d(18), CY2(1) to CY2(20), CY2-d(1) to CY2-d(15), CY3(1) to CY3(12), CY3-d(1) to CY3-d(13), CY4(1) to CY4(10), and CY4-d(1) to CY4-d(18),

$X_2$ to $X_4$, $Y_1$, $X_{51}$, $R_1$ to $R_4$ and $Z_1$ to $Z_4$ may be the same as described above,
$X_{19}$ may be $C(R_{19a})(R_{19b})$, $N[(L_{19})_{b19}-(R_{19})_{c19}]$, O, S, or $Si(R_{19a})(R_{19b})$,
$X_{39}$ may be $C(R_{39a})(R_{39b})$, $N[(L_{39})_{b39}-(R_{39})_{c39}]$, O, S, or $Si(R_{39a})(R_{39b})$,
$L_{19}$, b19, $R_{19}$, and c19 are the same as described in connection with $L_1$, b1, $R_1$, and c1, respectively,
$L_{39}$, b39, $R_{39}$, and c39 are the same as described in connection with $L_3$, b3, $R_3$, and c3, respectively.
$R_{1a}$ to $R_{1d}$, $R_{19a}$, and $R_{19b}$ are the same as described in connection with $R_1$,
$R_{3a}$ to $R_{3c}$, $R_{39a}$, and $R_{39b}$ are the same as described in connection with $R_3$,
$R_{4a}$ to $R_{4d}$ may be the same as described in connection with $R_4$,
each of $R_1$ to $R_4$, $R_{1a}$ to $R_{1d}$, $R_{3a}$ to $R_{3c}$ and $R_{4a}$ to $R_{4d}$ is not hydrogen,
$Z_{1a}$ to $Z_{1d}$ are the same as described in connection with $Z_1$,
$Z_{3a}$ to $Z_{3c}$ are the same as described in connection with $Z_3$,
$Z_{4a}$ to $Z_{4d}$ are the same as described in connection with $Z_4$,
regarding Formula CY1(1) to CY1(16) and CY1-d(1) to CY1-d(18), *' indicates a binding site to $X_1$ or M in Formula 1, and * indicates a binding site to $T_1$ in Formula 1,
regarding Formulae CY2(1) to CY2(20) and CY2-d(1) to CY2-d(15), *' indicates a binding site to M in Formula 1, * indicates a binding site to $T_1$ in Formula 1, and *" indicates a binding site to ring $CY_3$ in Formula 1,
regarding Formulae CY3(1) to CY3(12) and CY3-d(1) to CY3-d(13), *' indicates a binding site to M in Formula 1, *" indicates a binding site to ring $CY_2$ in Formula 1, and * indicates a binding site to $T_2$ in Formula 1, and
regarding Formulae CY4(1) to CY4(10) and CY4-d(1) to CY4-d(18), *' indicates a binding site to M in Formula 1, and * indicates a binding site to $T_2$ in Formula 1.

In an embodiment, each of $R_1$ to $R_4$, $R_{1a}$ to $R_{1d}$, $R_{3a}$ to $R_{3c}$ and $R_{4a}$ to $R_{4d}$ in Formulae CY1(1) to CY1(16), CY2(1) to CY2(20), CY3(1) to CY3(13) and CY4(1) to CY4(10) may not be deuterium and a deuterium-containing group.

In one or more embodiments, Formula 1 may satisfy at least one of Condition 1 to Condition 5:

Condition 1 In Formula 1, a moiety represented by

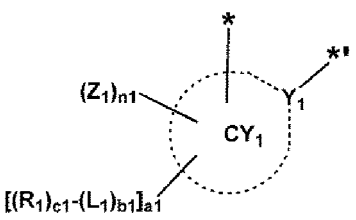

may be a group represented by one of Formulae CY1-d(1) to CY1-d(18).
Condition 2 In Formula 1, a moiety represented by

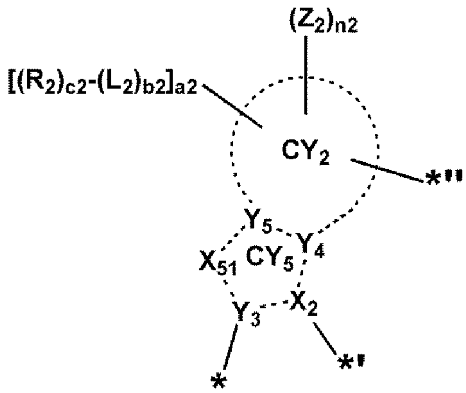

may be a group represented by one of Formulae CY2-d(1) to CY2-d(15).

Condition 3 In Formula 1, a moiety represented by

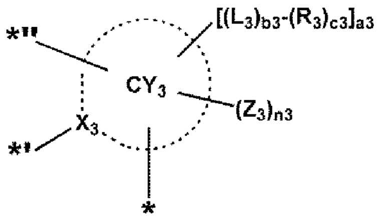

is a group represented by one of Formulae CY3-d(1) to CY3-d(13).

Condition 4 In Formula 1, a moiety represented by

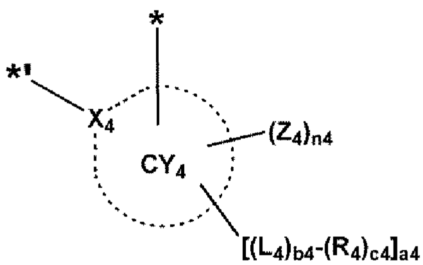

may be a group represented by one of Formulae CY4-d(1) to CY4-d(18).

Condition 5

a) in Formula 1, a moiety represented by

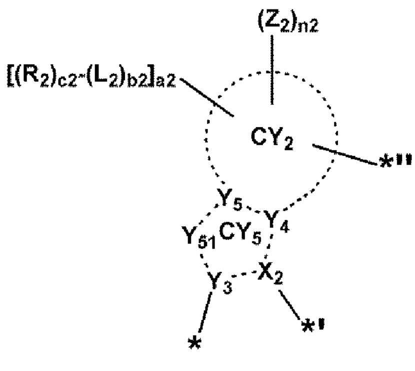

may be a group represented by one of Formulae CY2(1) to CY2(20), and b) regarding Formulae CY2(1) to CY2(20), i) $X_{51}$ is N-[$(L_7)_{b7}$-$(R_7)_{c7}$], C($R_7$), Si($R_7$), or Ge(R7), and $R_7$ is deuterium or a deuterium-containing

group, or ii) $X_{51}$ is $C(R_7)(R_8)$, $Si(R_7)(R_8)$, or $Ge(R_7)(R_8)$, and at least one of $R_7$ and $R_8$ is deuterium or a deuterium-containing group.

Regarding Formula 1, i) two of a plurality of neighboring groups $R_1$ may optionally be linked to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$, ii) two of a plurality of neighboring groups $R_2$ may optionally be linked to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$, iii) two of a plurality of neighboring groups $R_3$ may optionally be linked to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$, iv) two of a plurality of neighboring groups $R_4$ may optionally be linked to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$, and v) two or more neighboring substituents selected from $R_1$ to $R_4$, $R_7$ to $R_{10}$, R' and R" may optionally be linked to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$. Herein, the $C_5$-$C_{30}$ carbocyclic group and the $C_1$-$C_{30}$ heterocyclic group may be understood by referring to the descriptions about i) the first ring, ii) the second ring, iii) the condensed ring in which two or more first rings are condensed with each other, iv) the condensed ring in which two or more second rings are condensed with each other, and v) the condensed ring in which one or more first rings and one or more second rings are condensed with each other, and $R_{10a}$ may be understood by referring to the description about $R_1$.

"An azabenzothiophene, an azabenzofuran, an azaindene, an azaindole, an azabenzosilole, an azadibenzothiophene, an azadibenzofuran, an azafluorene, an azacarbazole, and an azadibenzosilole" may have the same backbone as those of "a benzothiophene, a benzofuran, an indene, an indole, a benzosilole, a dibenzothiophene, a dibenzofuran, a fluorene, a carbazole, and a dibenzosilole," respectively, and may each be a heteroring in which at least one of ring-forming carbon atoms is substituted with nitrogen.

In one embodiment, the organometallic compound represented by Formula 1 may be represented by Formula 1A as follows:

<Formula 1A>

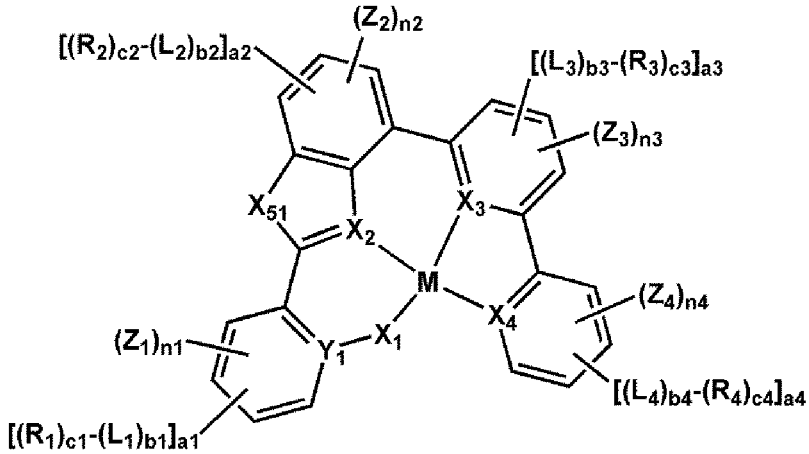

In Formula 1A, the descriptions for M, $X_1$ to $X_4$, $Y_1$, $X_{51}$, $L_1$ to $L_4$, b1 to b4, $R_1$ to $R_4$, c1 to c4, $Z_1$ to $Z_4$, a1 to a4 and n1 to n4 may be the same as described in this disclosure. For example, the organometallic compound represented by Formula 1 may be one of Compounds 1 to 666 below, but embodiments of the present disclosure are not limited thereto.

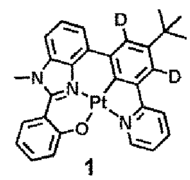
1

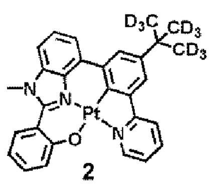
2

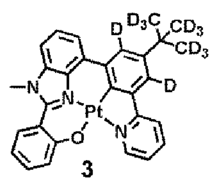
3

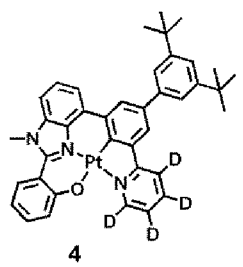
4

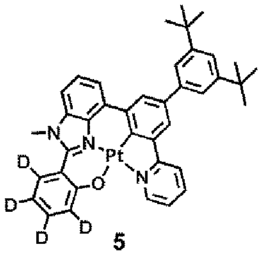
5

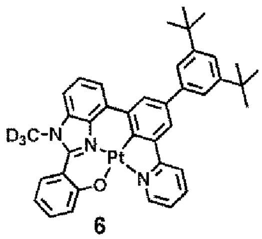
6

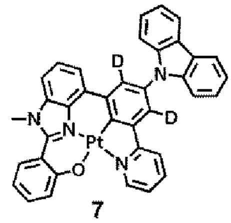
7

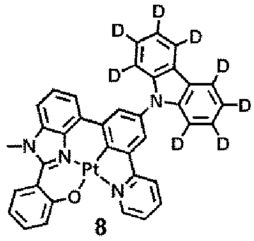
8

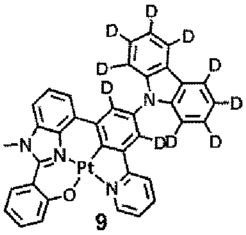
9

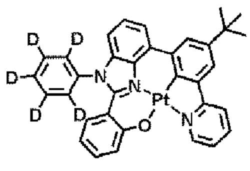
10

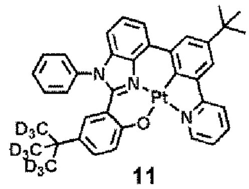
11

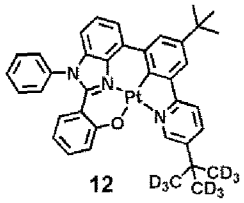
12

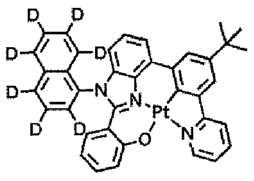
13

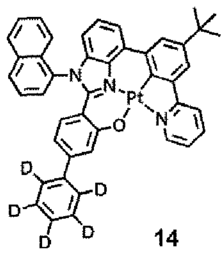
14

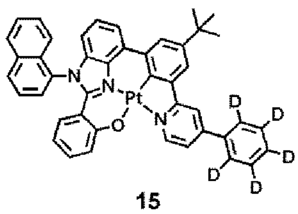
15

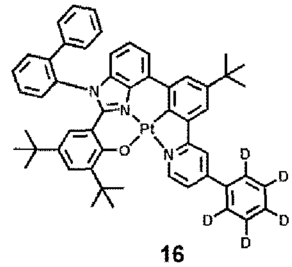
16

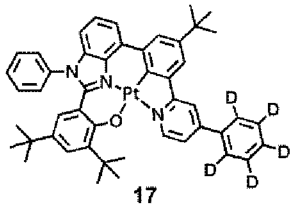
17

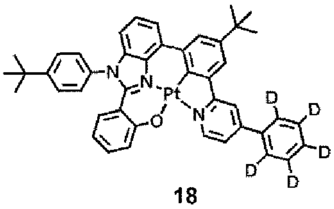
18

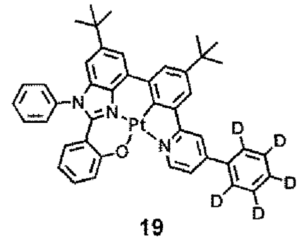
19

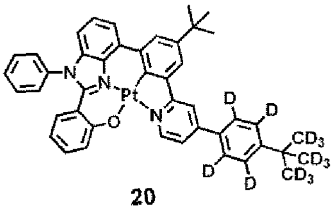
20

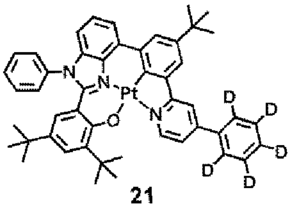
21

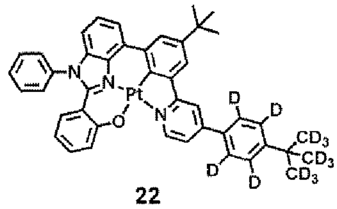
22

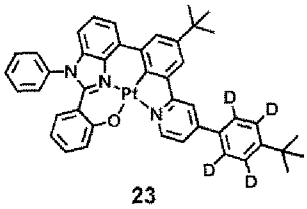
23

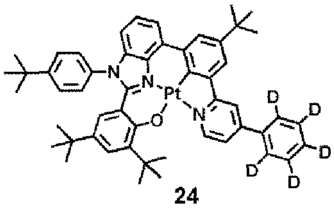
24

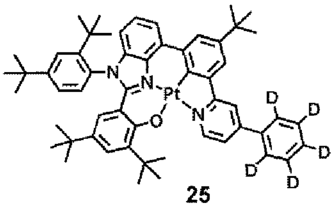
25

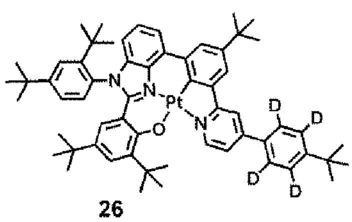

26

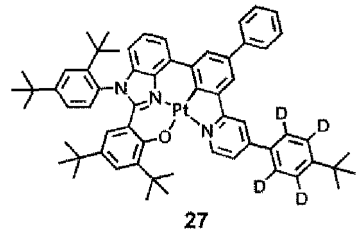

27

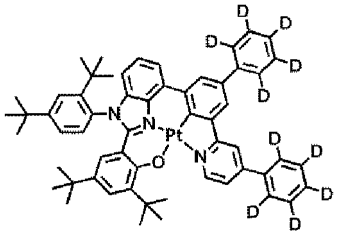

28

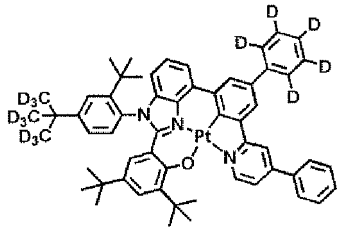

29

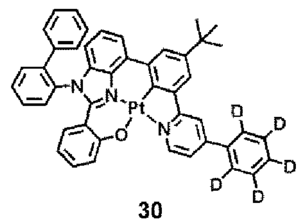

30

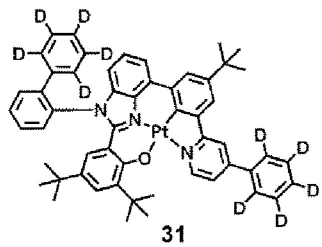

31

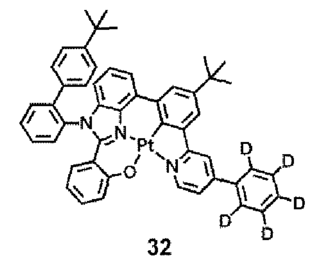

32

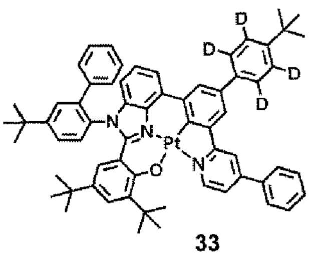

33

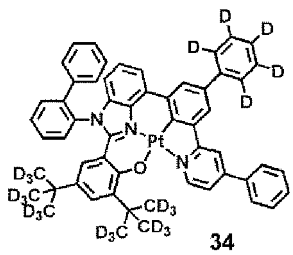

34

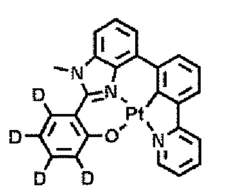

35

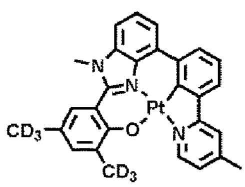

36

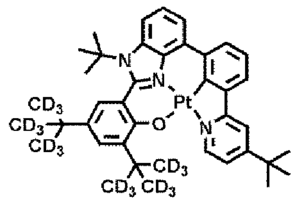

37

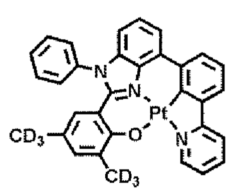

38

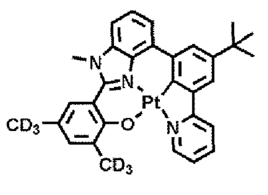

39

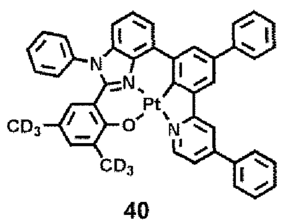

40

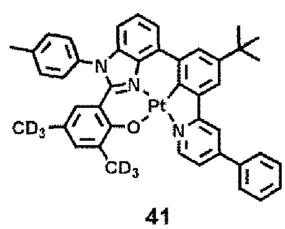

41

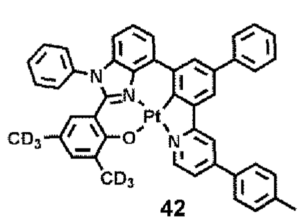

42

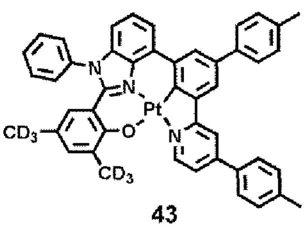

43

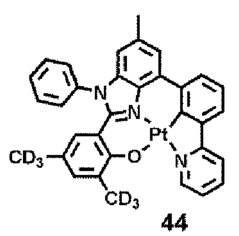

44

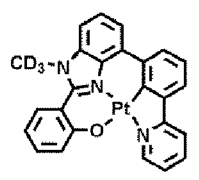

45

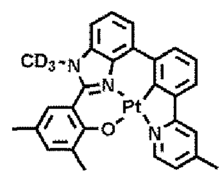

46

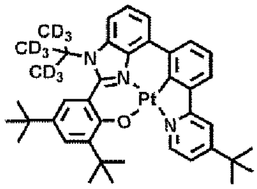
47

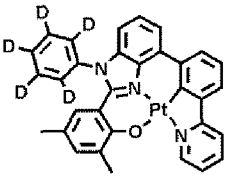
48

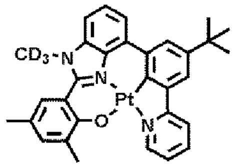
49

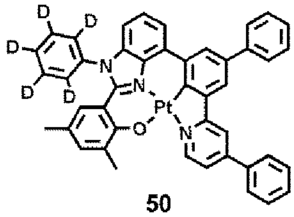
50

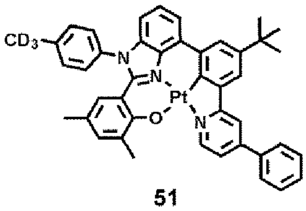
51

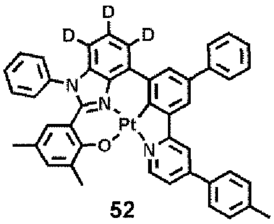
52

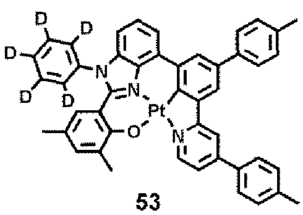
53

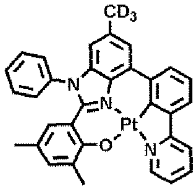
54

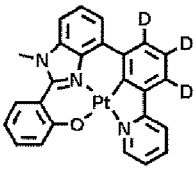
55

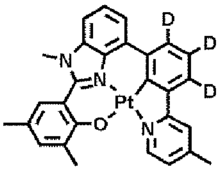
56

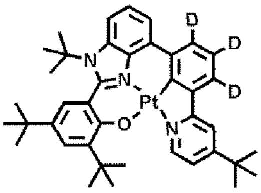
57

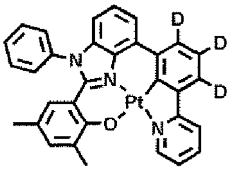
58

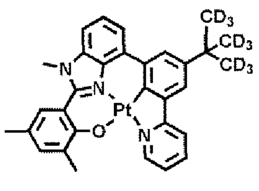
59

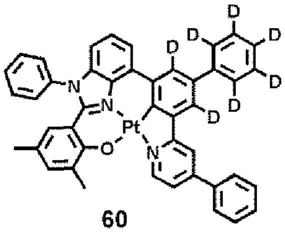
60

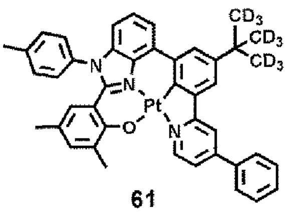
61

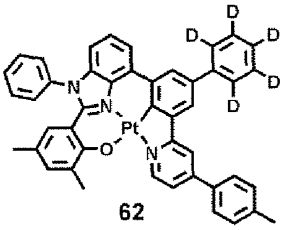
62

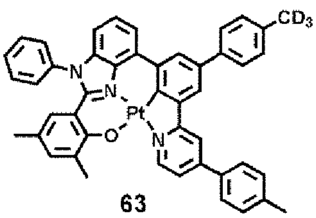
63

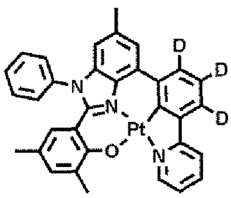
64

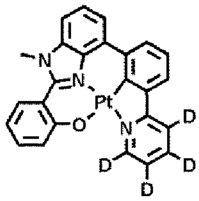
65

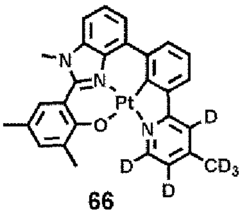
66

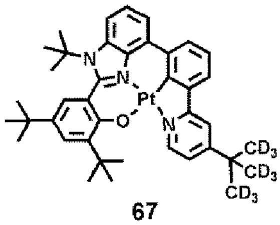
67

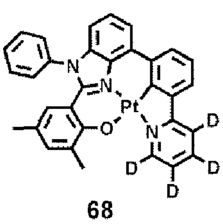
68

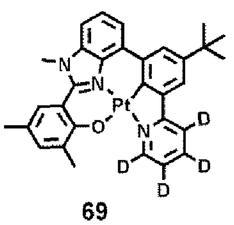
69

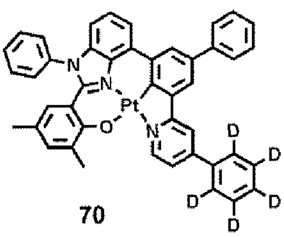
70

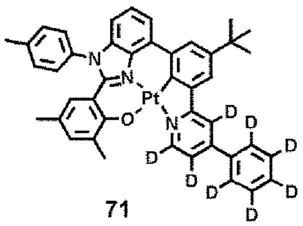
71

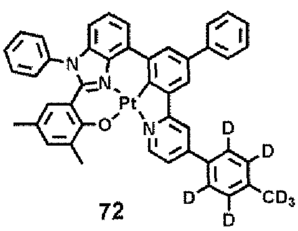
72

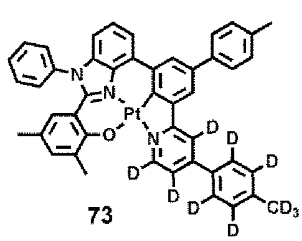
73

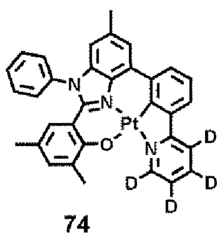
74

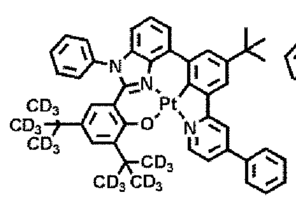
75

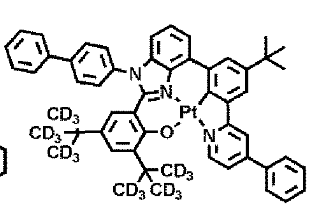
76

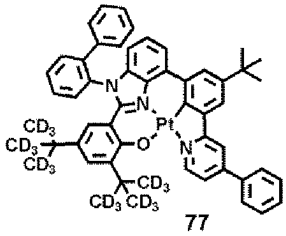
77

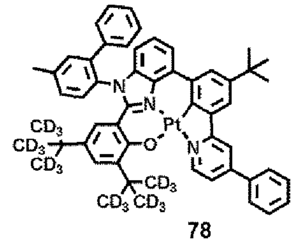
78

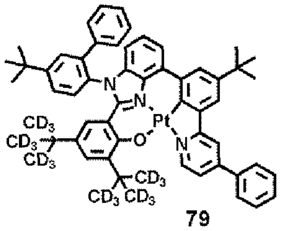
79

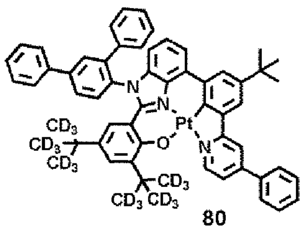
80

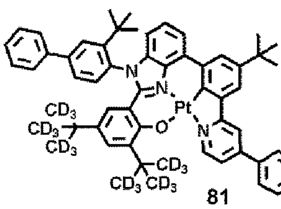
81

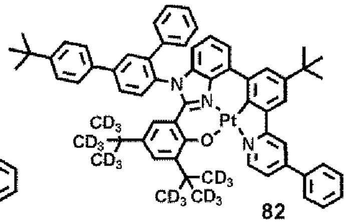
82

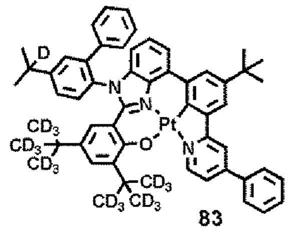
83

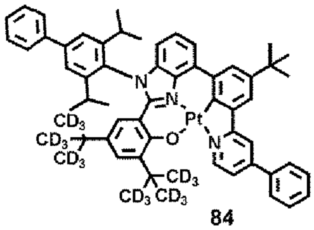
84

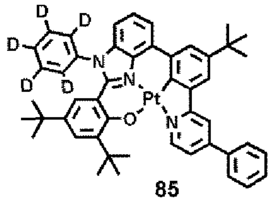
85

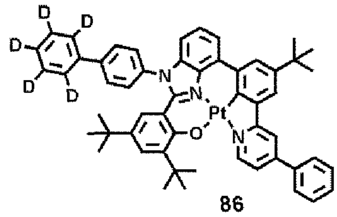
86

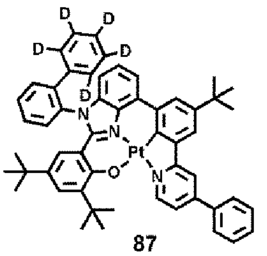
87

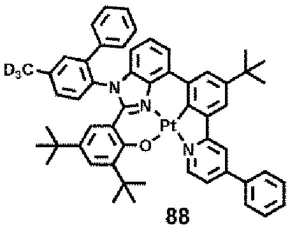
88

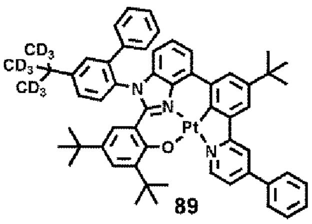
89

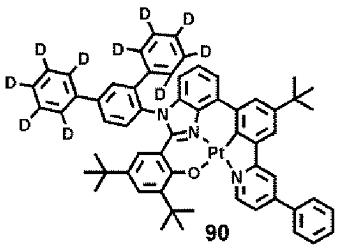
90

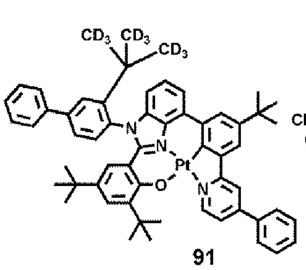
91

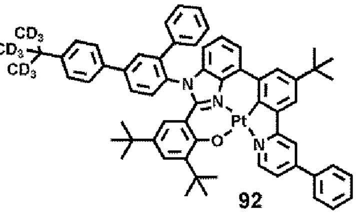
92

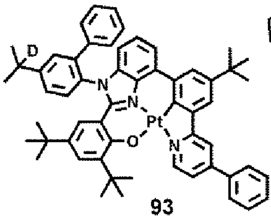
93

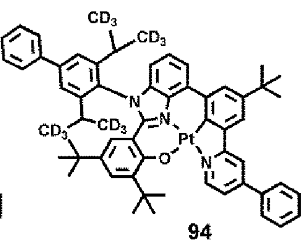
94

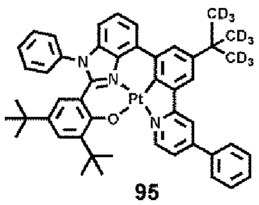

95

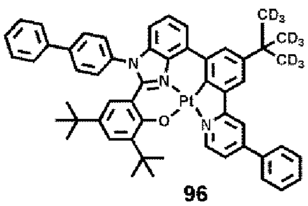

96

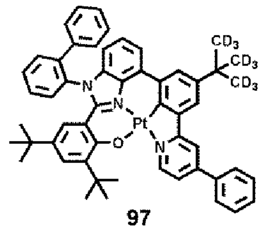

97

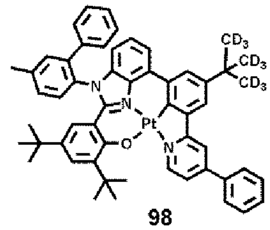

98

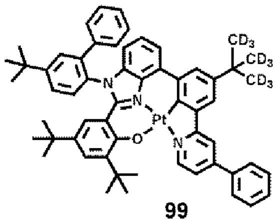

99

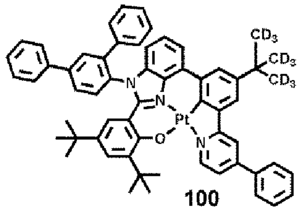

100

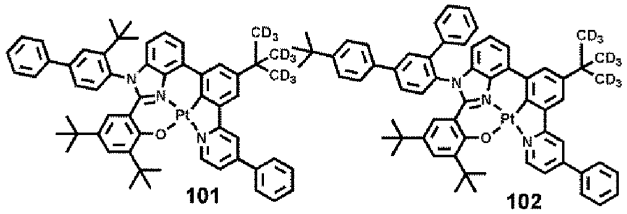

101

102

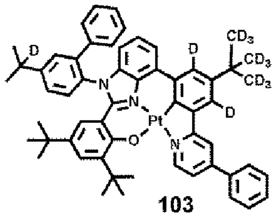

103

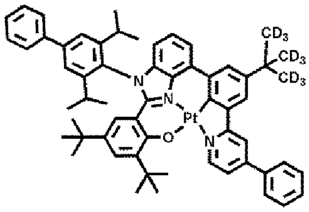

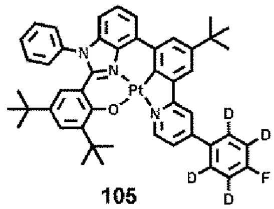

105

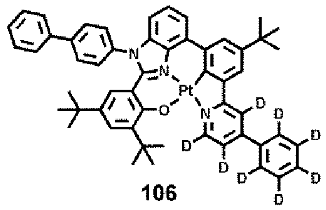

106

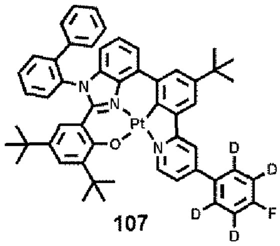

107

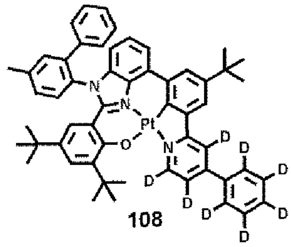

108

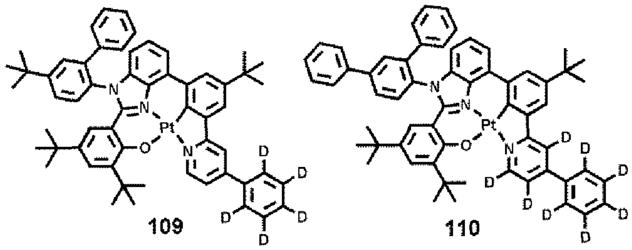

109

110

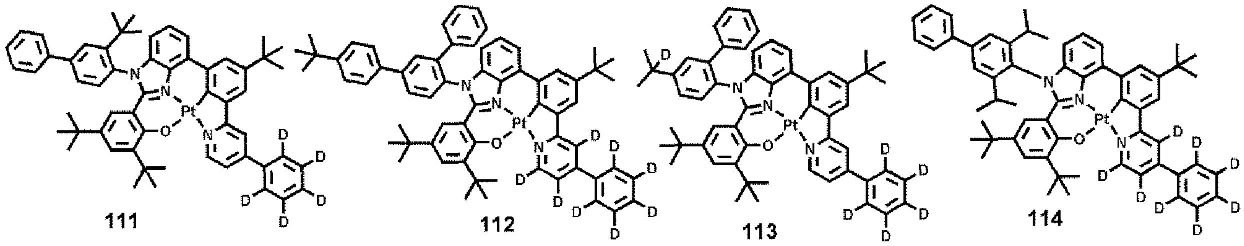

111

112

113

114

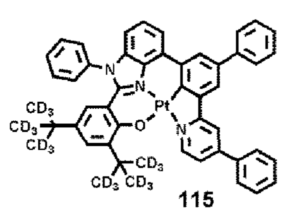

115

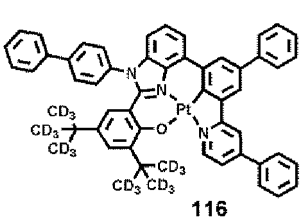

116

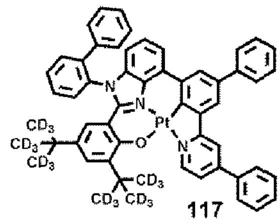

117

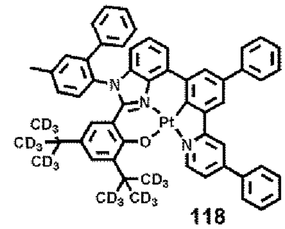

118

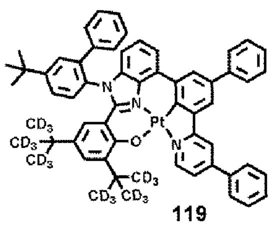
119

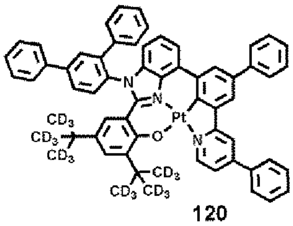
120

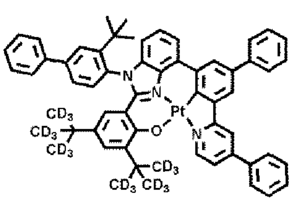
121

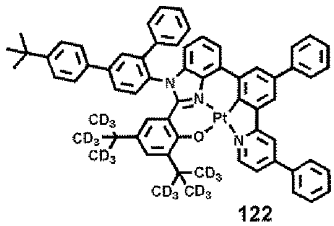
122

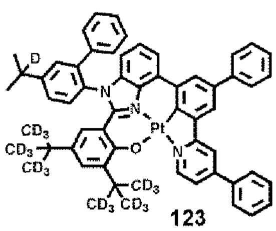
123

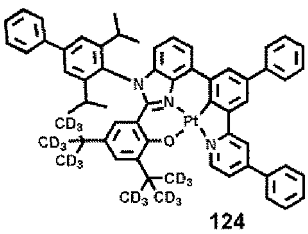
124

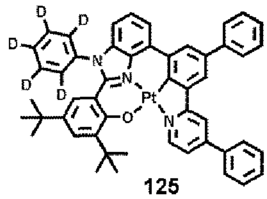
125

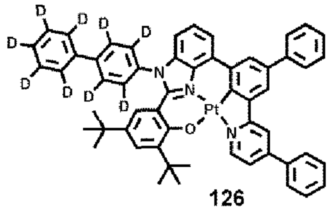
126

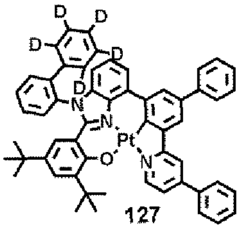
127

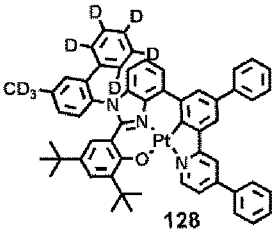
128

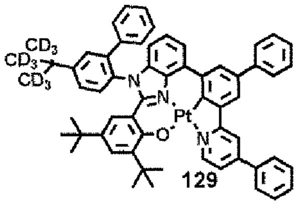
129

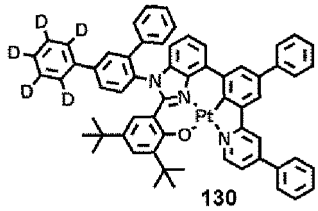
130

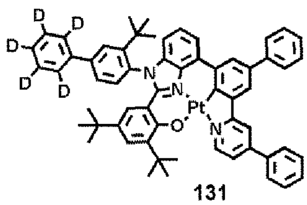
131

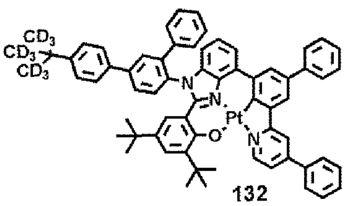
132

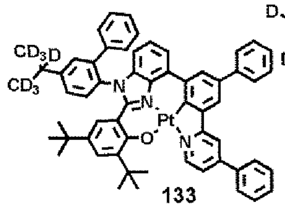
133

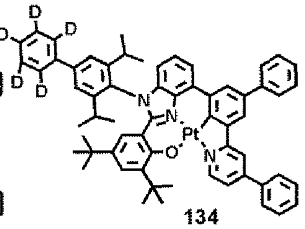
134

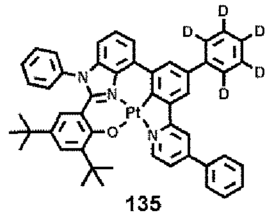
135

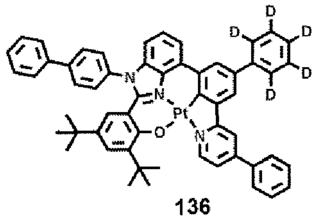
136

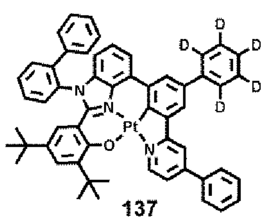
137

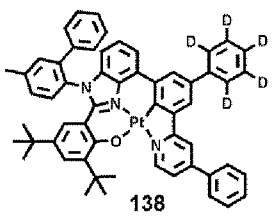
138

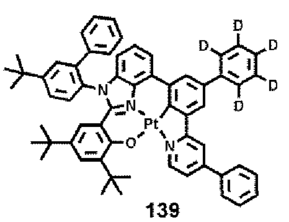
139

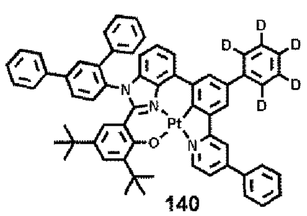
140

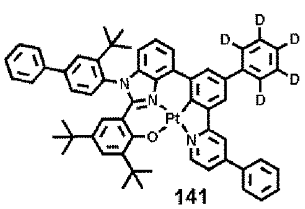
141

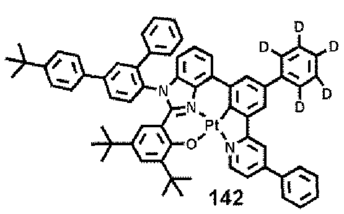
142

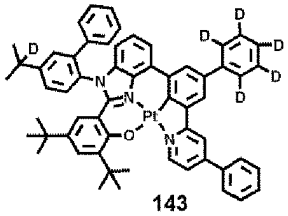
143

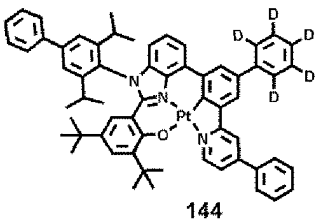
144

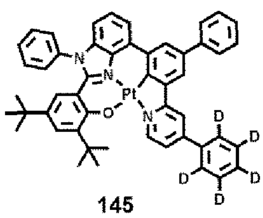
145

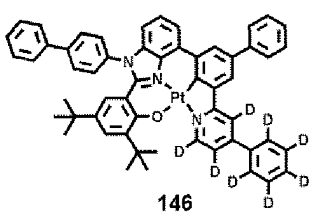
146

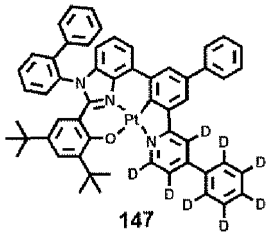
147

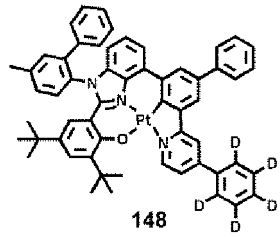
148

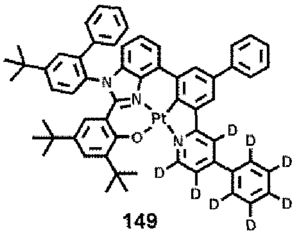
149

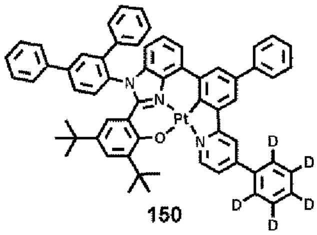
150

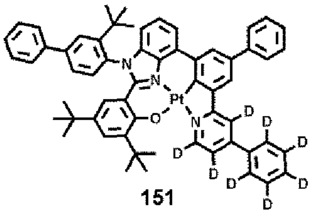
151

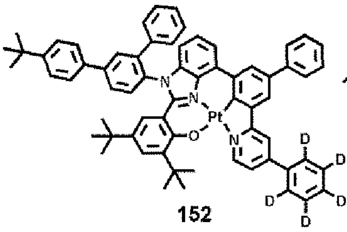
152

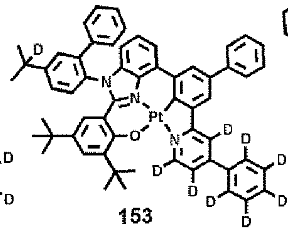
153

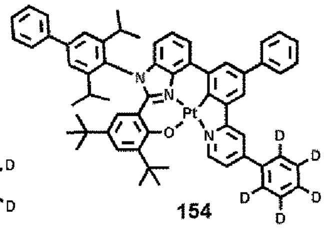
154

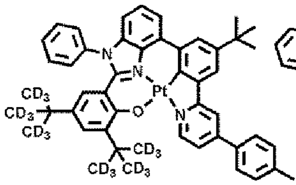
155

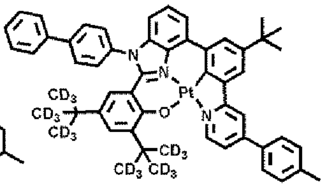
156

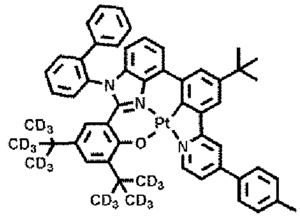
157

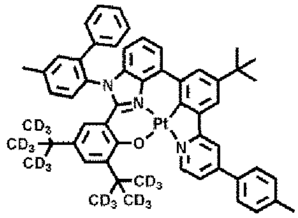
158

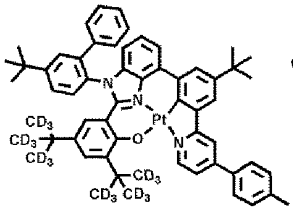
159

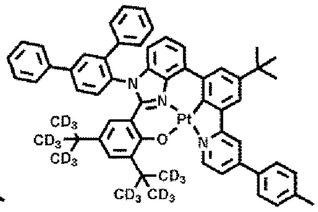
160

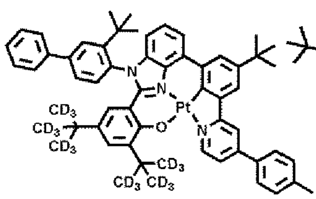
161

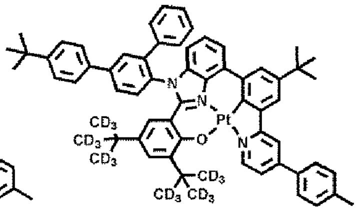
162

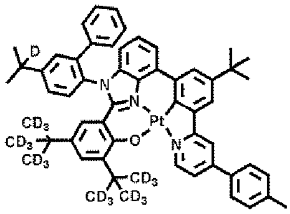
163

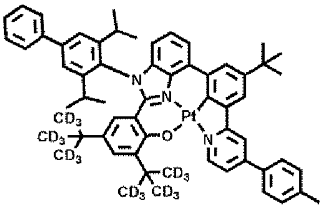
164

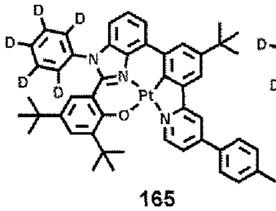
165

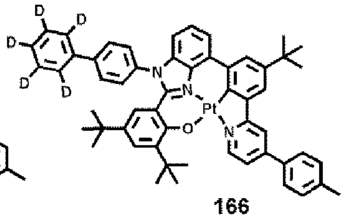
166

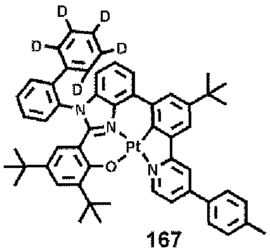
167

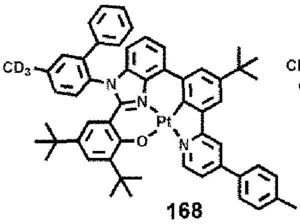
168

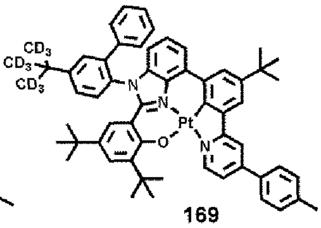
169

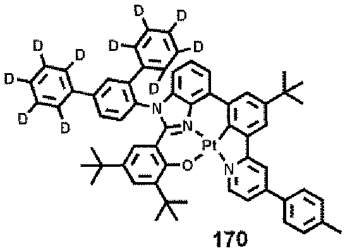
170

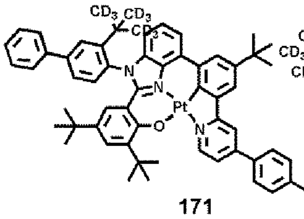
171

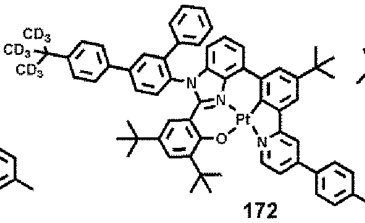
172

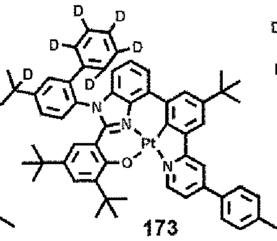
173

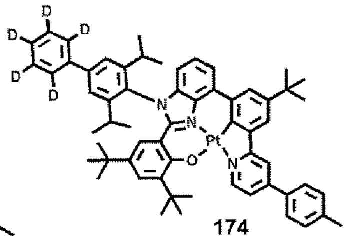
174

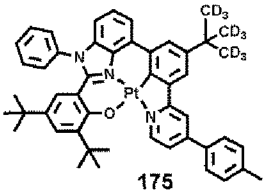
175

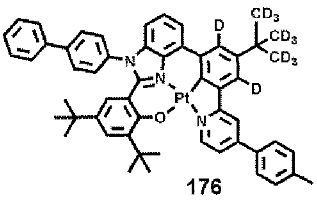
176

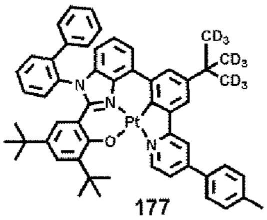
177

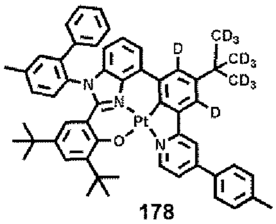
178

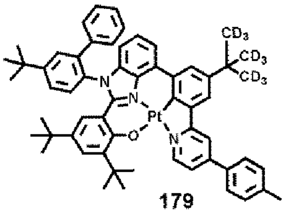
179

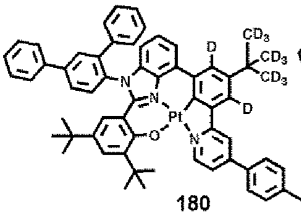
180

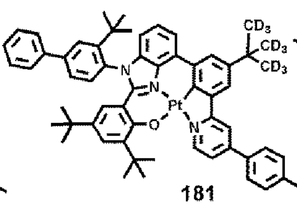
181

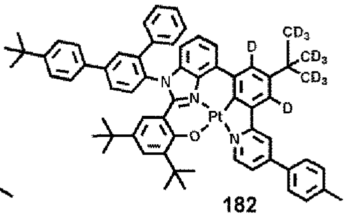
182

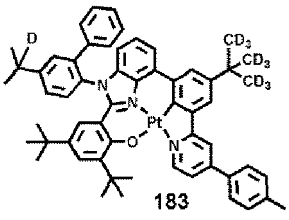
183

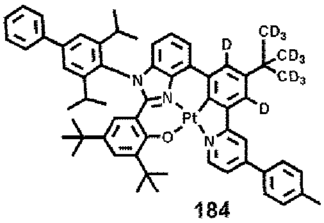
184

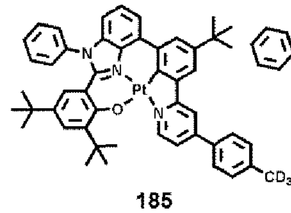
185

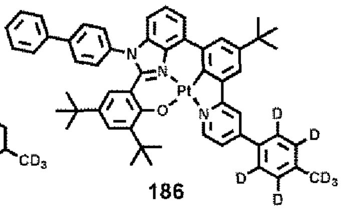
186

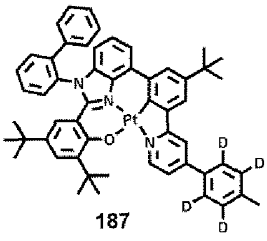
187

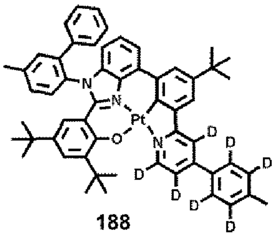
188

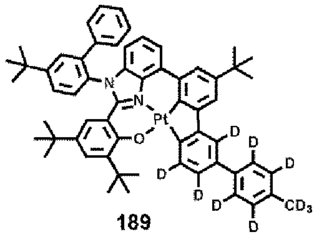
189

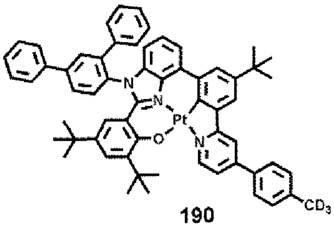
190

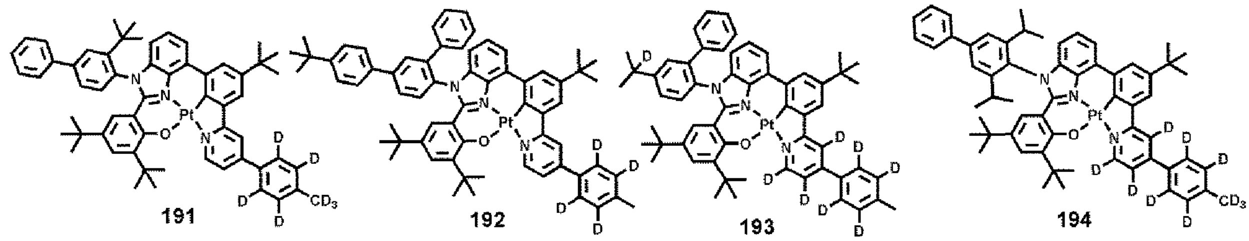

191 192 193 194

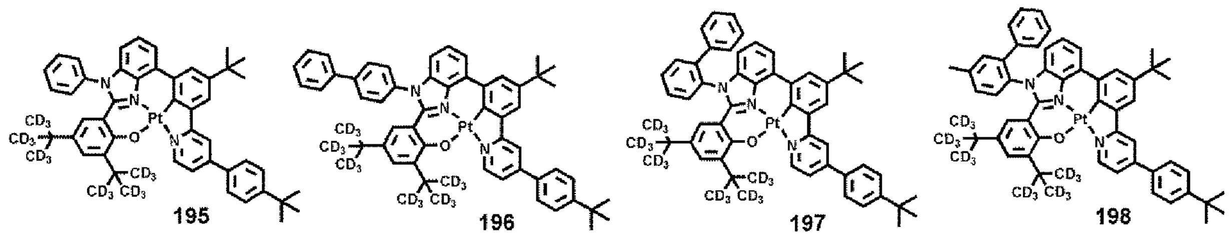

195 196 197 198

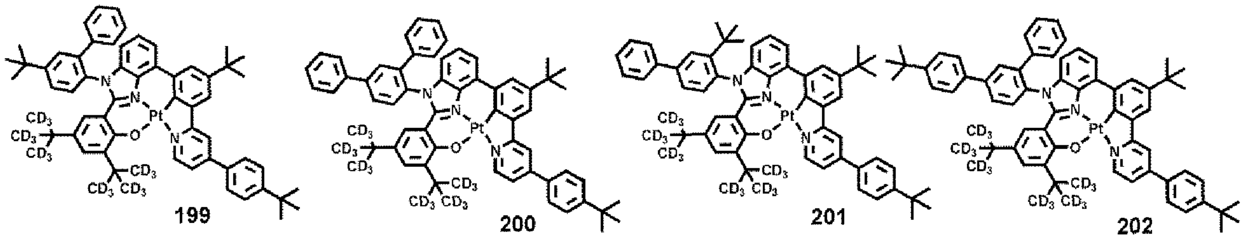

199 200 201 202

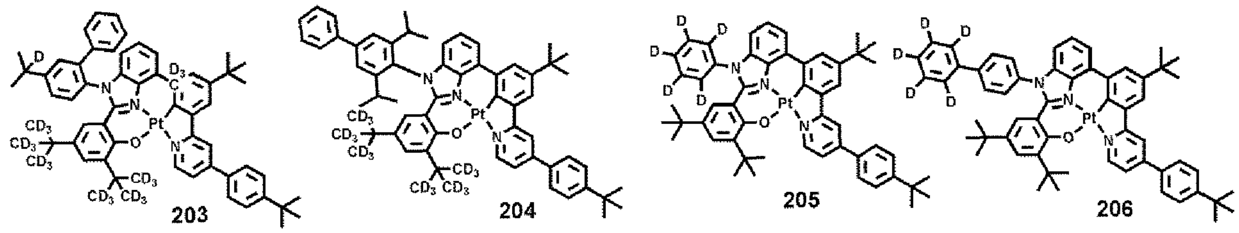

203 204 205 206

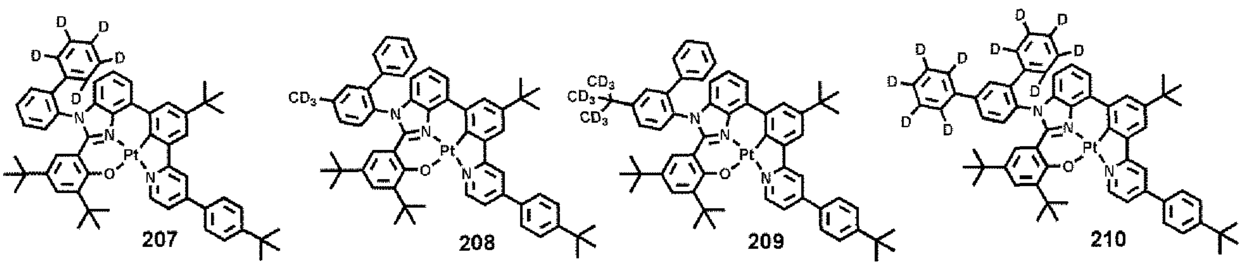

207 208 209 210

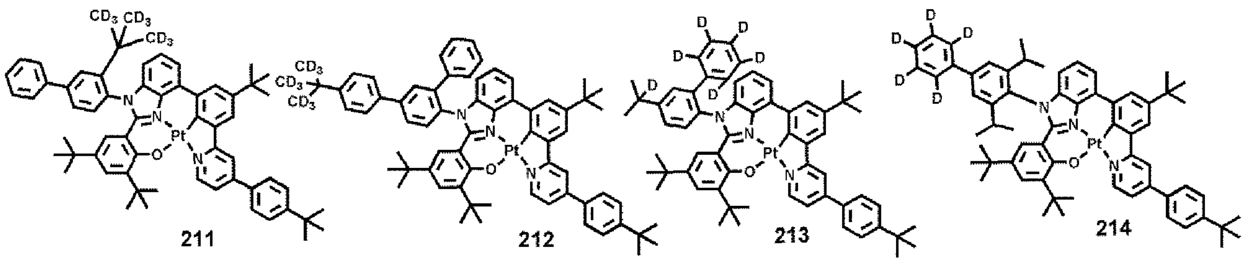

211 212 213 214

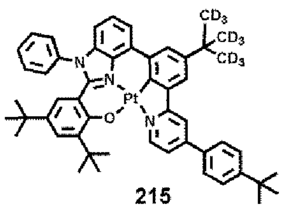
215
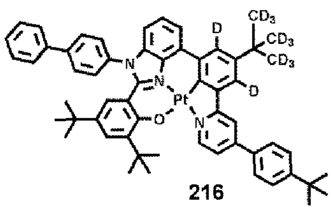
216
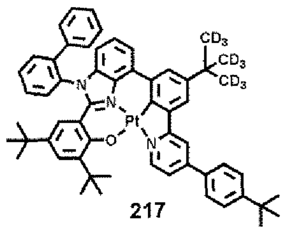
217
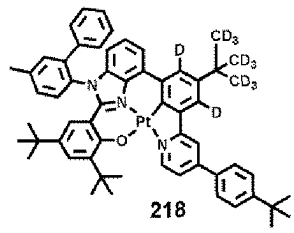
218
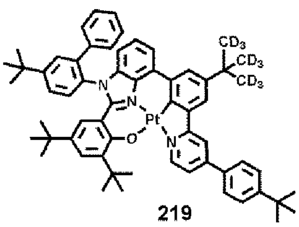
219
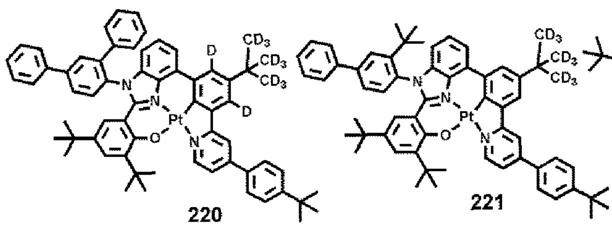
220
221
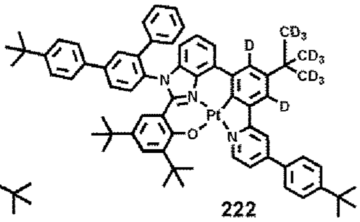
222
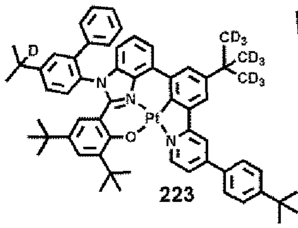
223
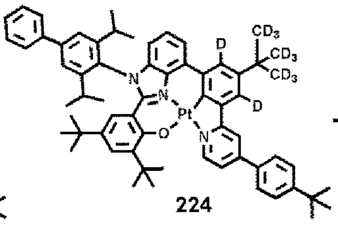
224
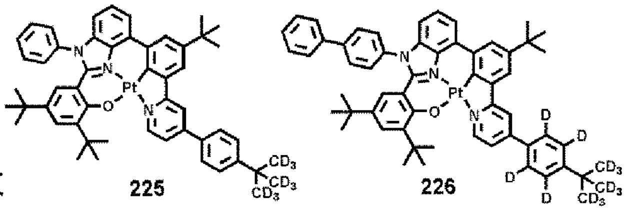
225
226
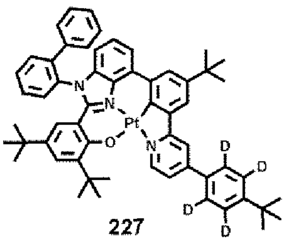
227
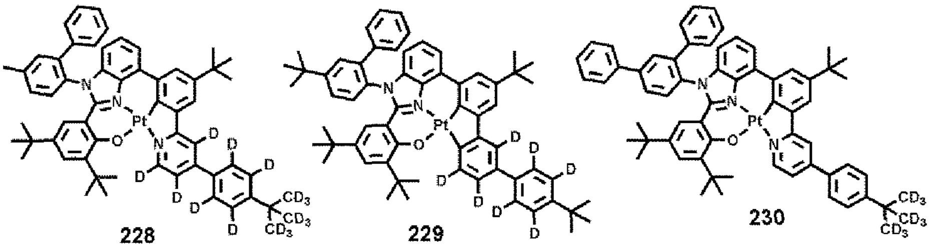
228
229
230
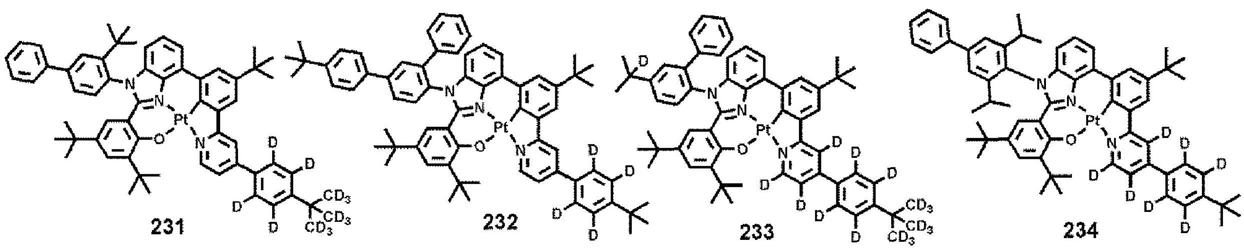
231
232
233
234
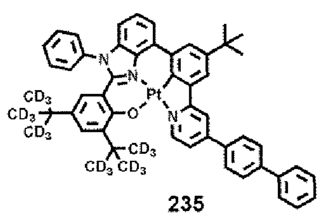
235
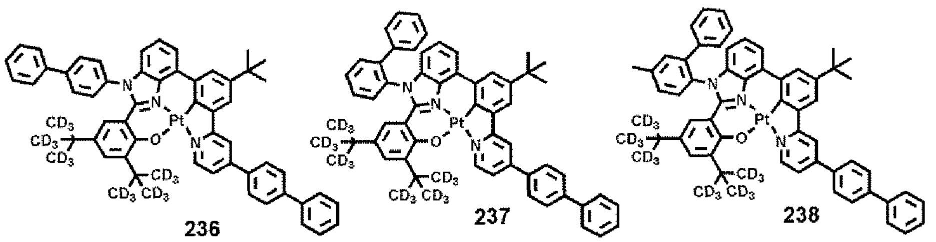
236
237
238

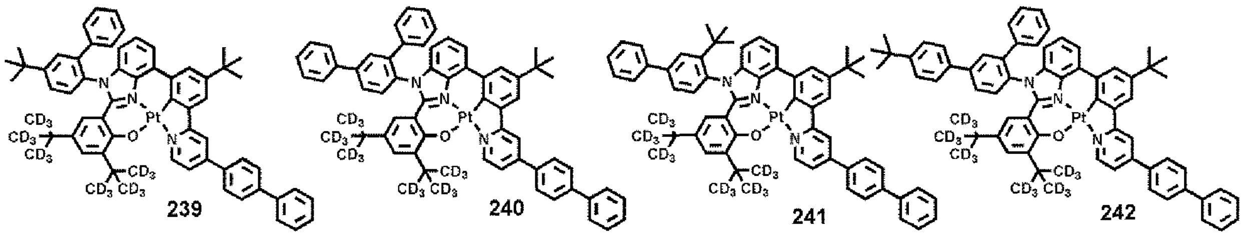

239 240 241 242

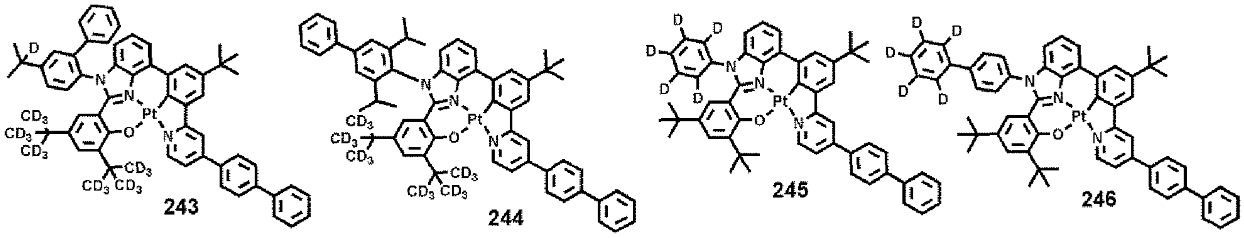

243 244 245 246

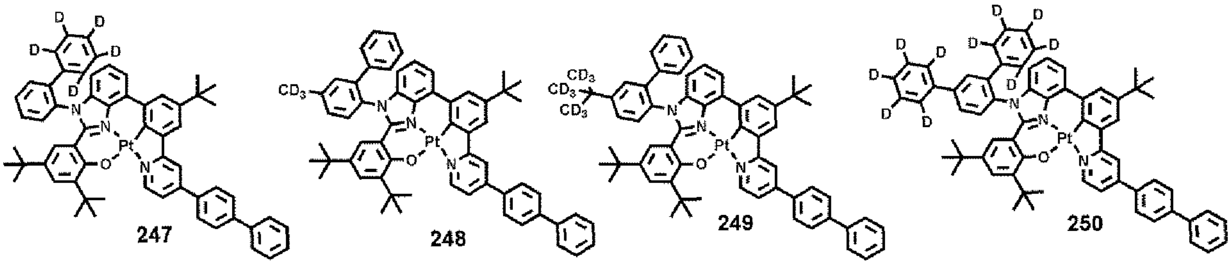

247 248 249 250

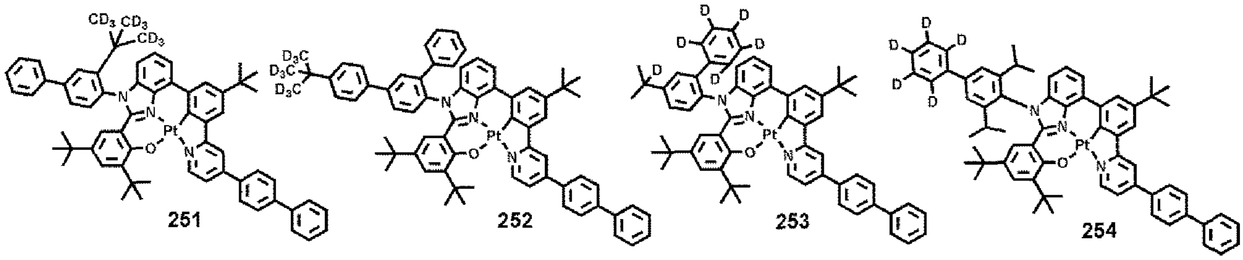

251 252 253 254

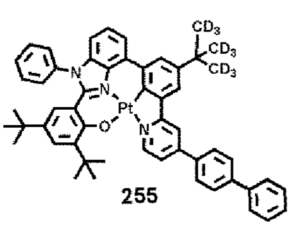

255

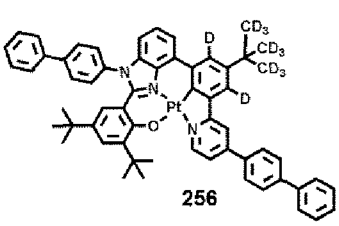

256

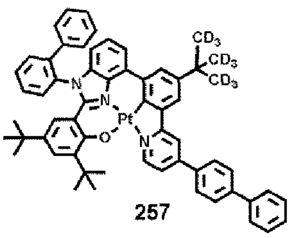

257

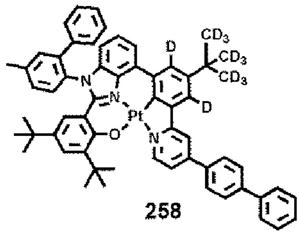

258

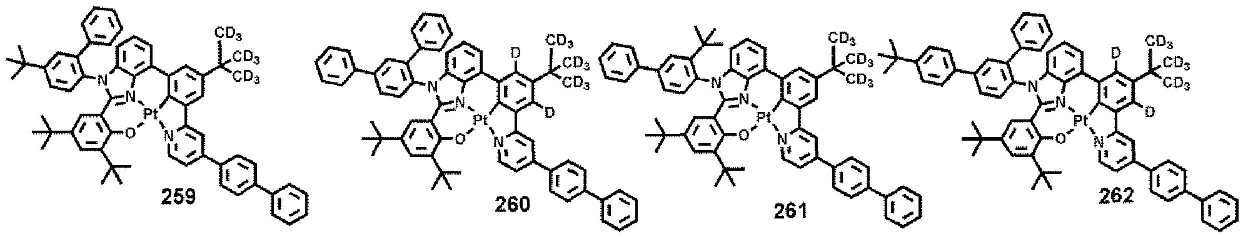

259 260 261 262

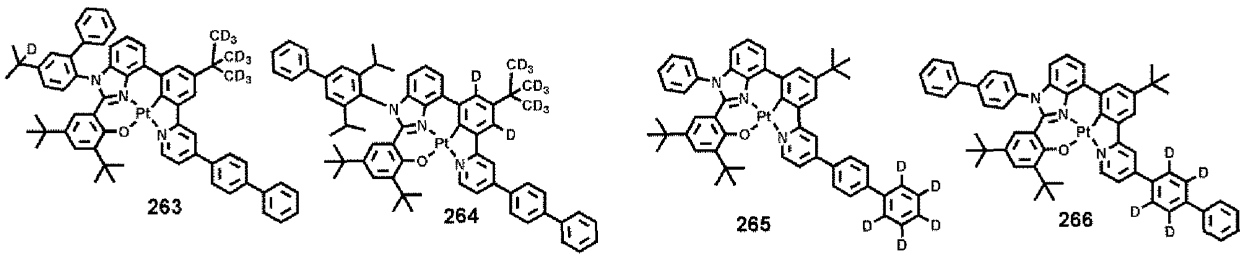

263 264 265 266

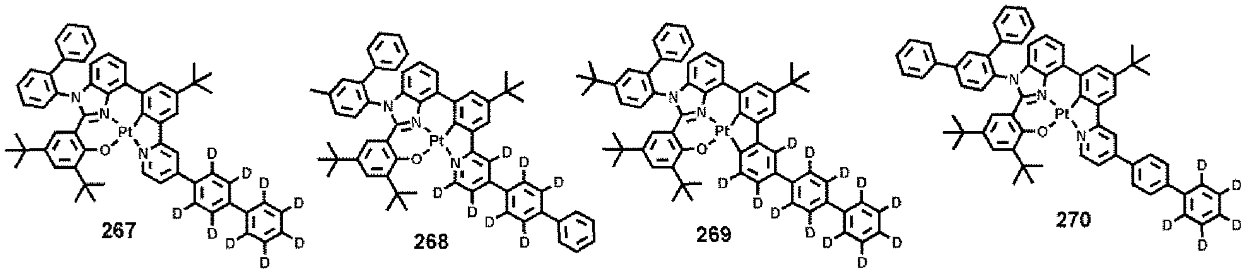

267 268 269 270

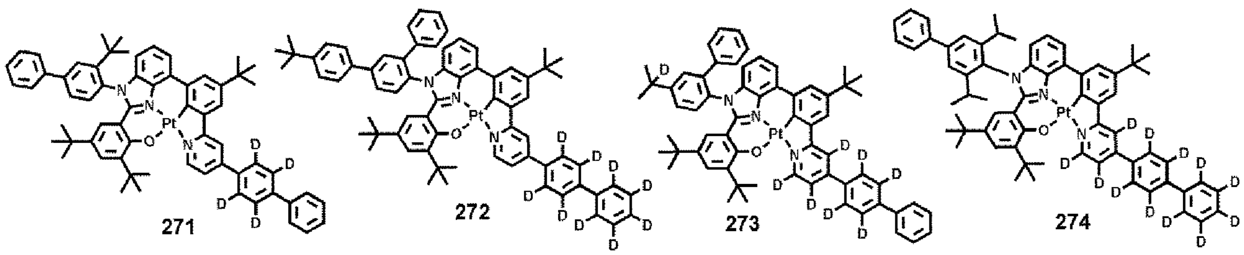

271 272 273 274

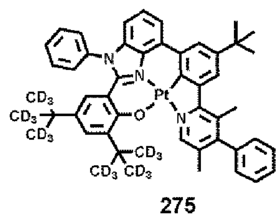

275

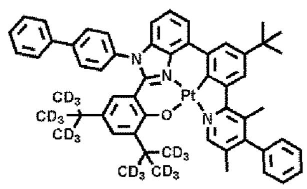

276

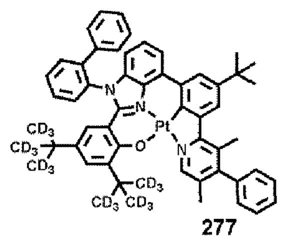

277

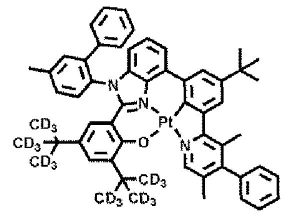

278

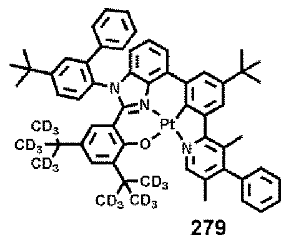

279

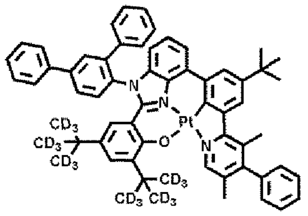

280

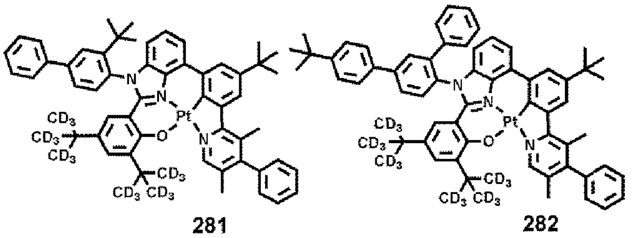

281 282

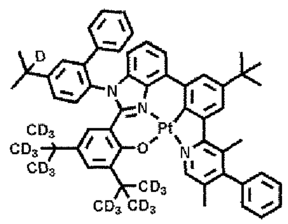

283

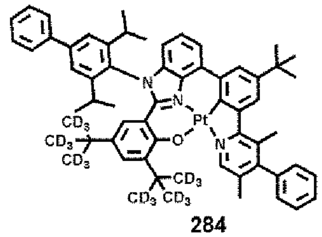

284

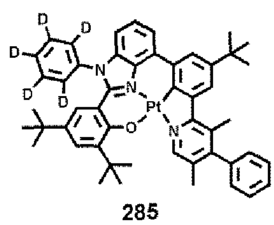

285

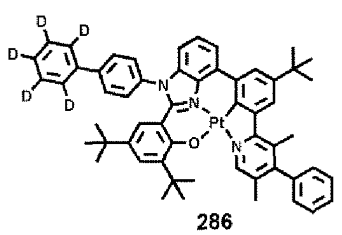

286

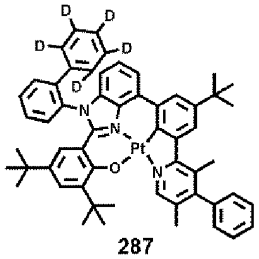
287

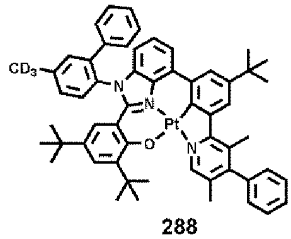
288

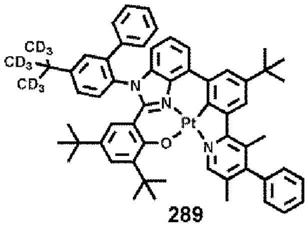
289

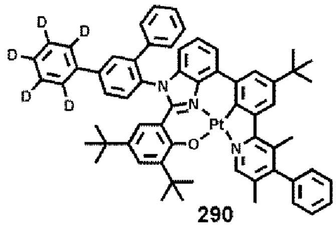
290

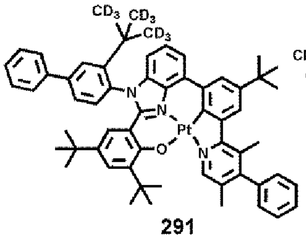
291

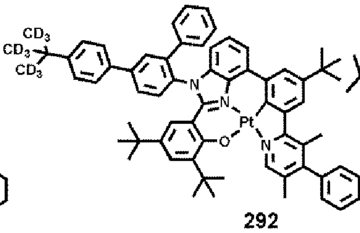
292

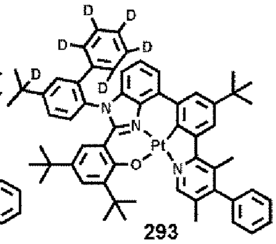
293

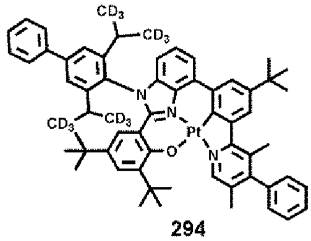
294

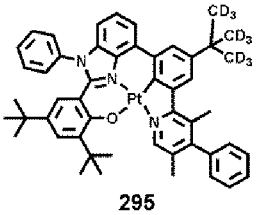
295

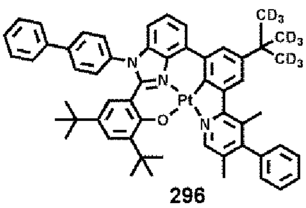
296

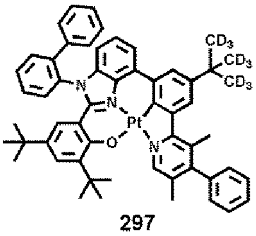
297

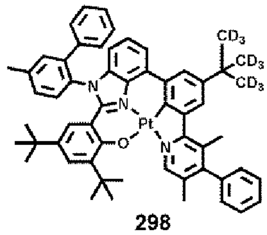
298

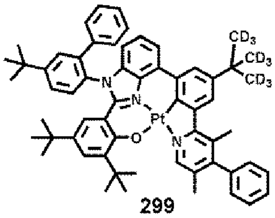
299

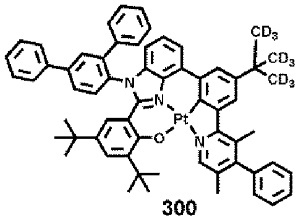
300

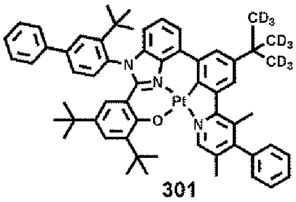
301

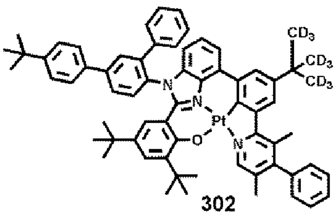
302

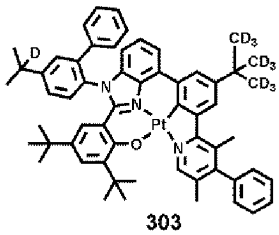
303

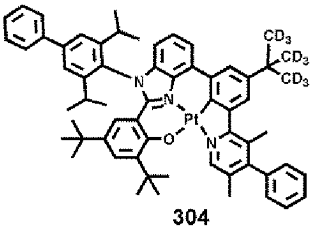
304

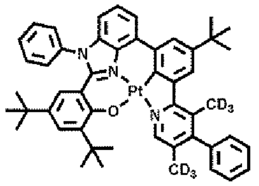
305

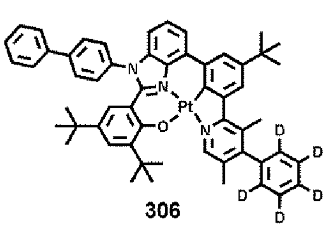
306

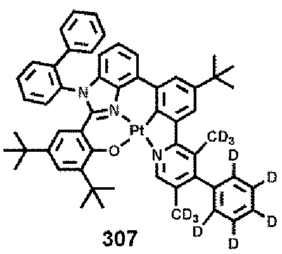
307

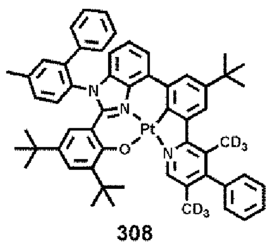
308

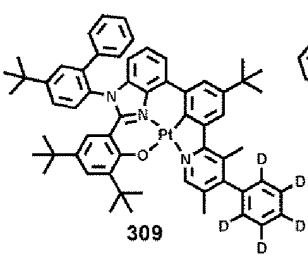
309

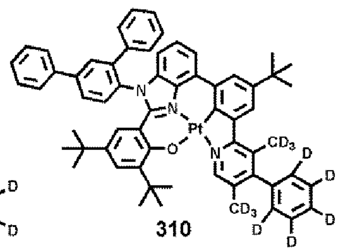
310

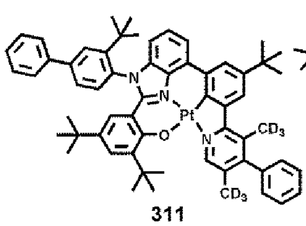
311
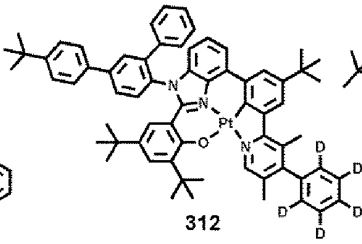
312
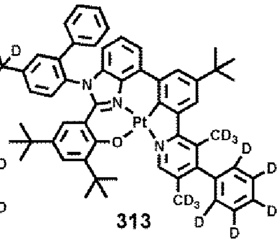
313
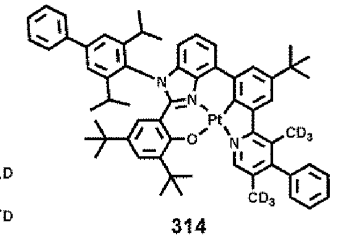
314

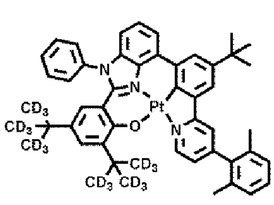
315
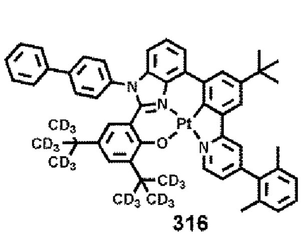
316
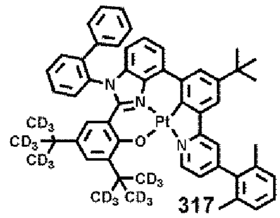
317
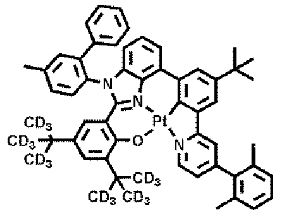
318

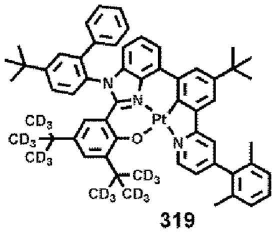
319
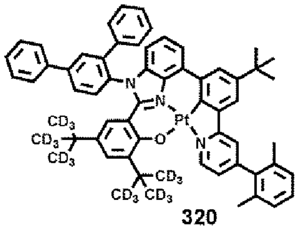
320
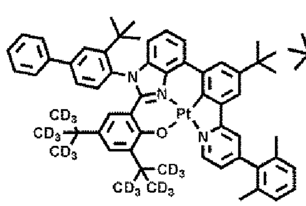
321
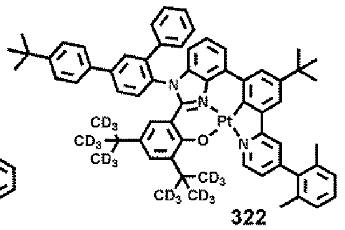
322

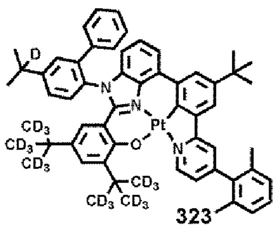
323
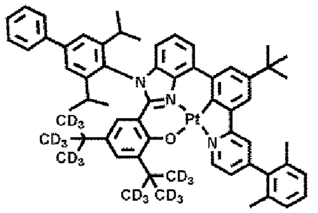
324
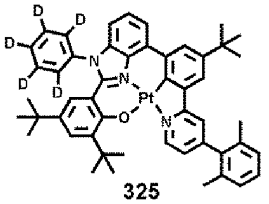
325
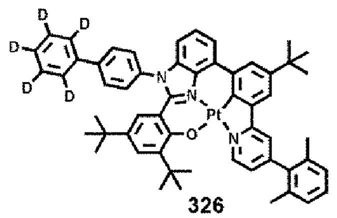
326

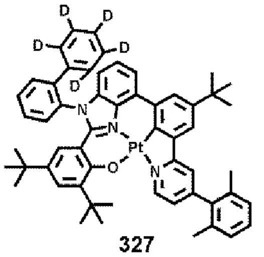
327
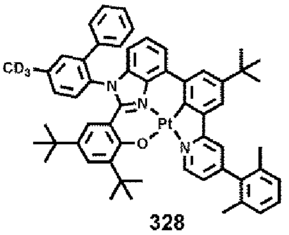
328
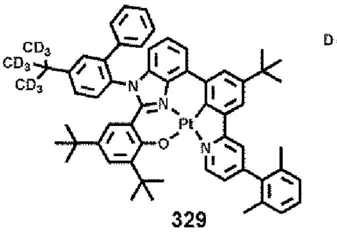
329
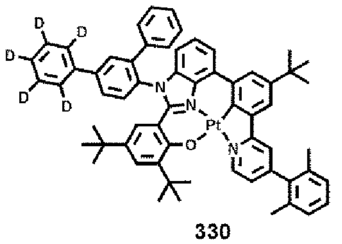
330

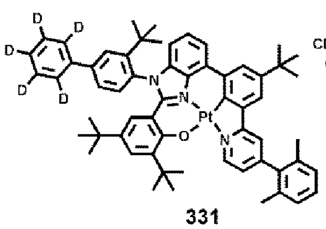
331
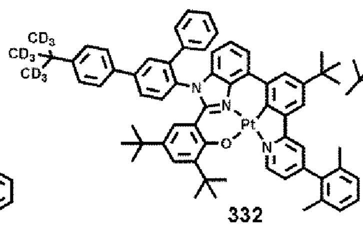
332
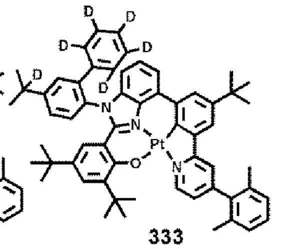
333
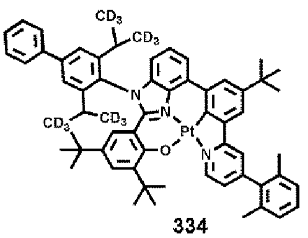
334

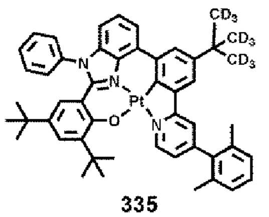
335

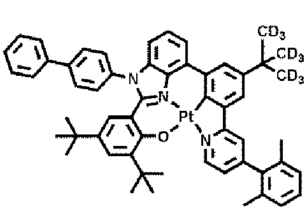
336

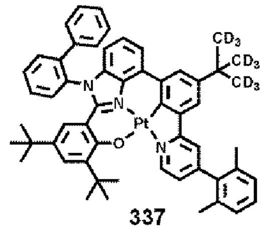
337

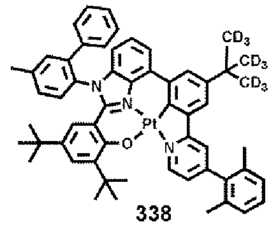
338

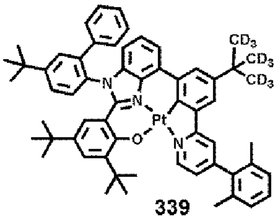
339

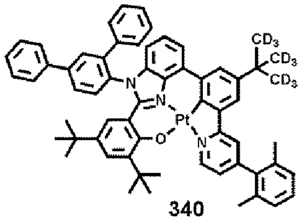
340

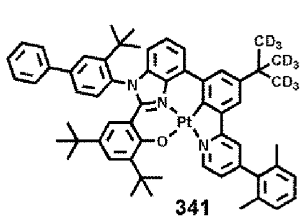
341

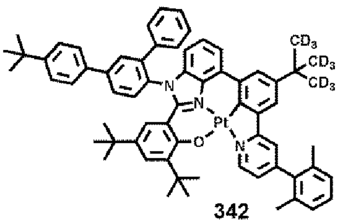
342

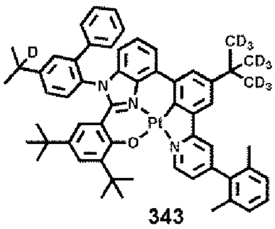
343

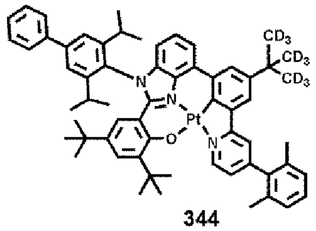
344

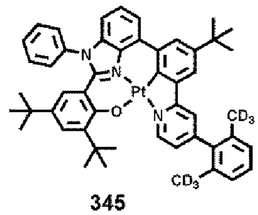
345

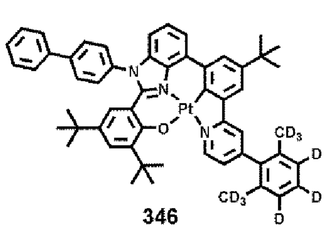
346

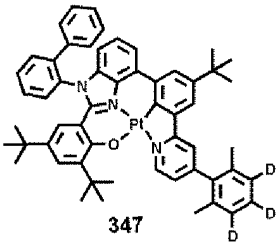
347

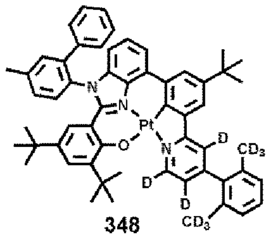
348

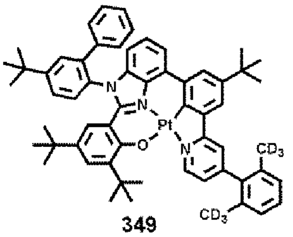
349

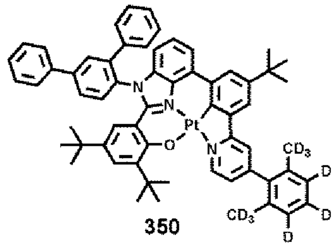
350

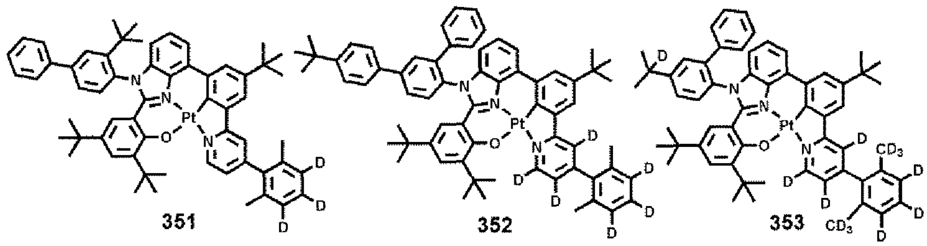
351

352

353

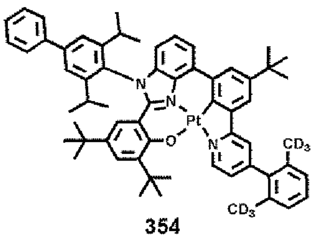
354

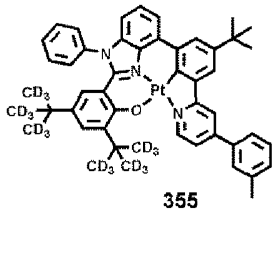
355

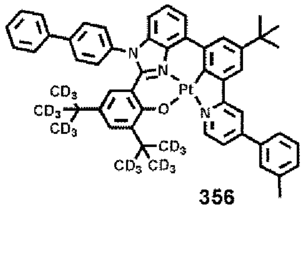
356

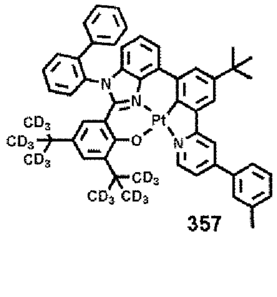
357

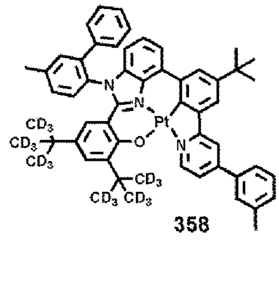
358

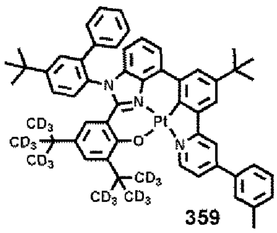
359

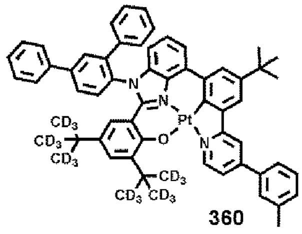
360

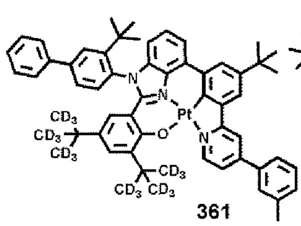
361

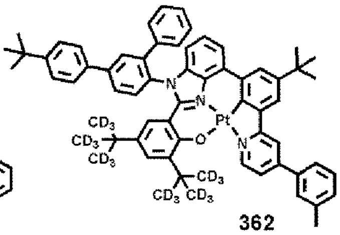
362

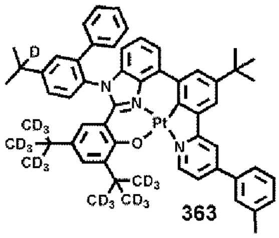
363

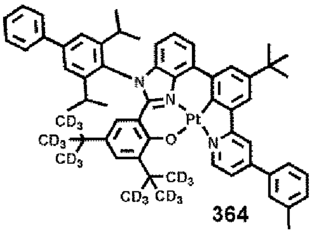
364

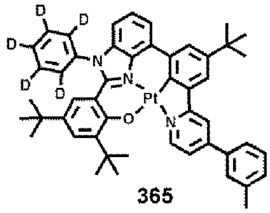
365

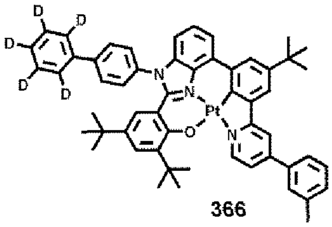
366

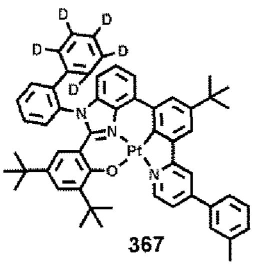
367

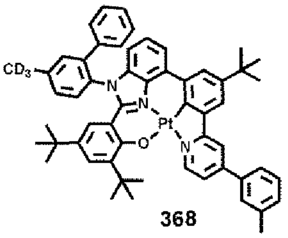
368

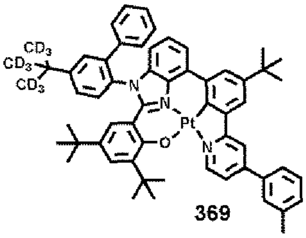
369

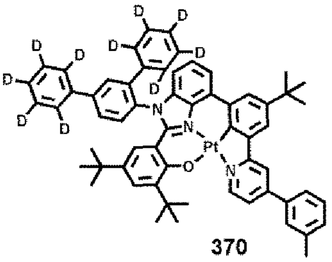
370

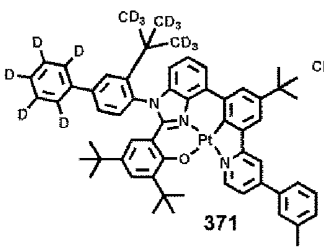
371

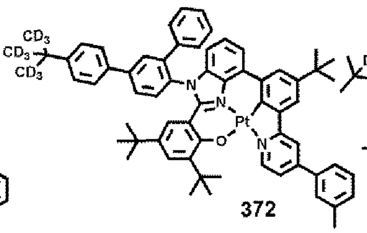
372

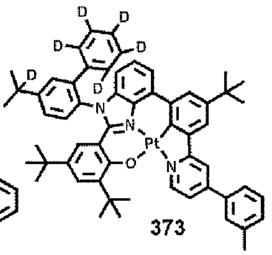
373

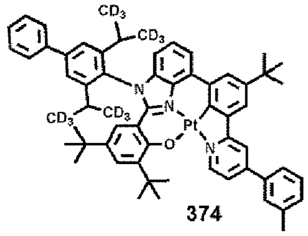
374

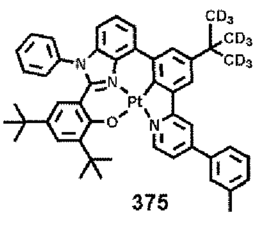
375

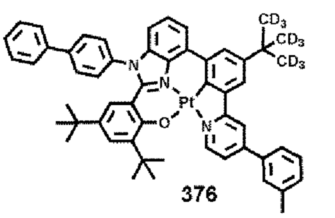
376

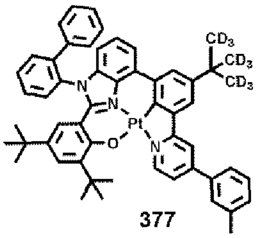
377

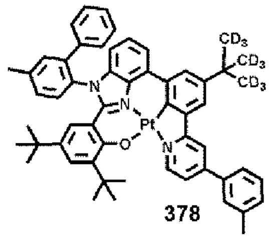
378

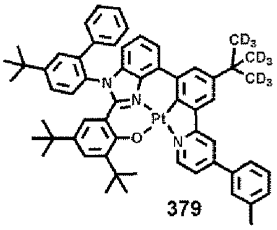
379

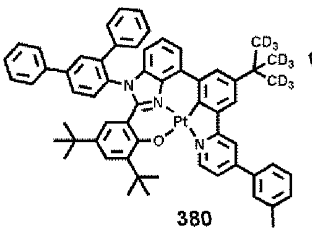
380

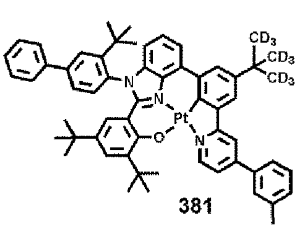
381

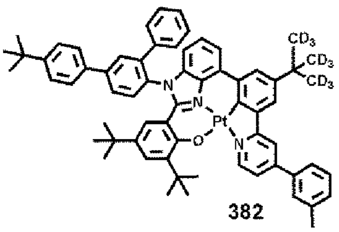
382

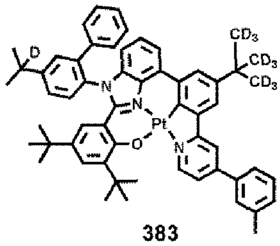
383

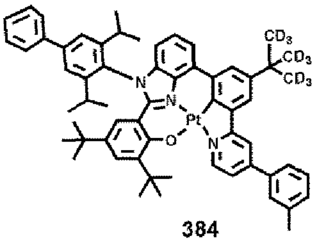
384

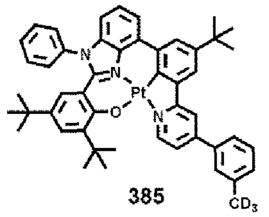
385

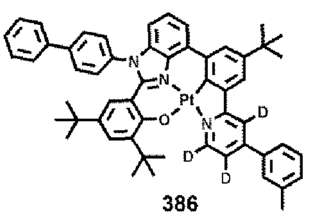
386

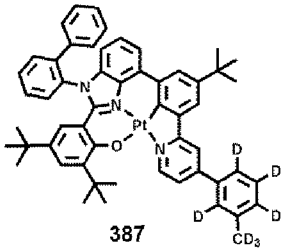
387

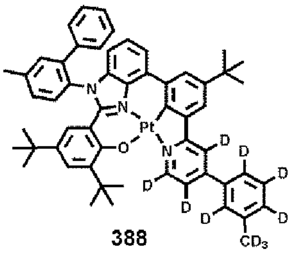
388

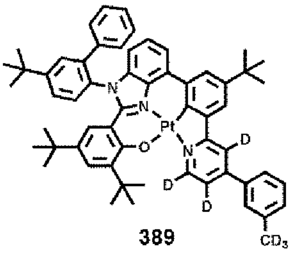
389

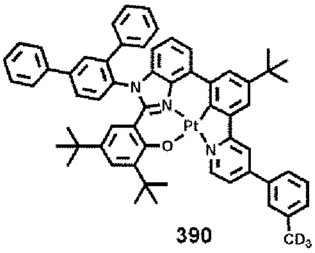
390

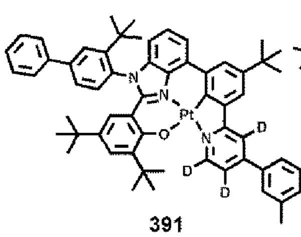
391

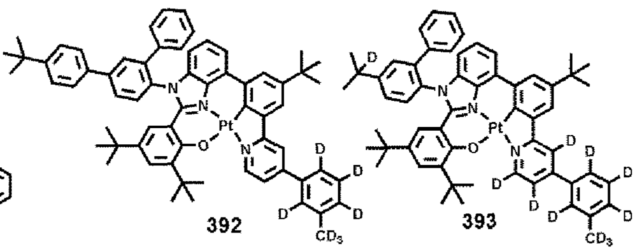
392

393

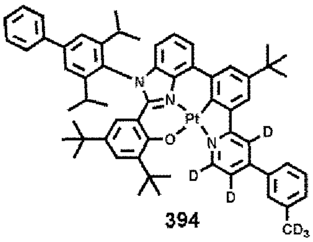
394

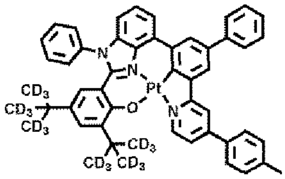
395

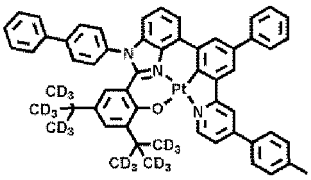
396

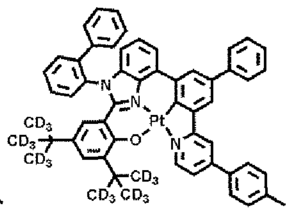
397

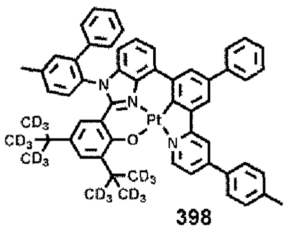
398

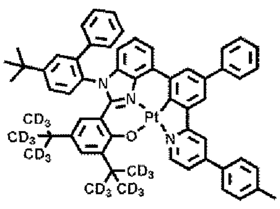

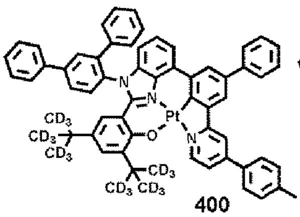
400

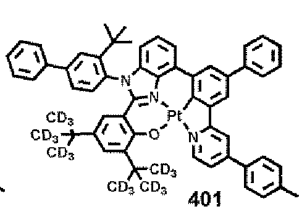
401

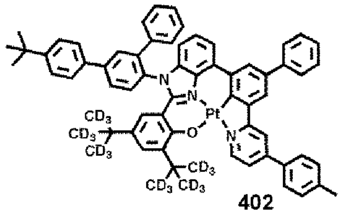
402

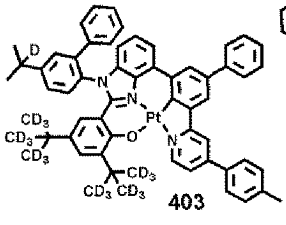
403

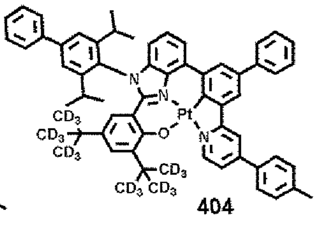
404

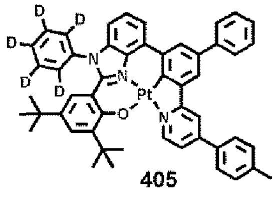
405

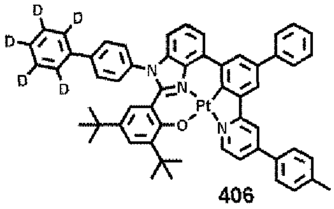
406

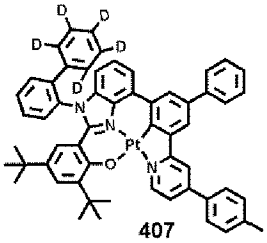
407

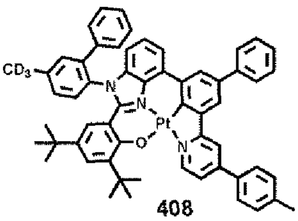
408

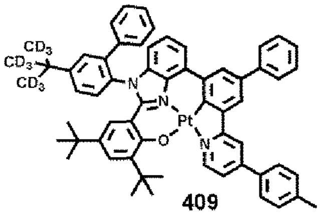
409

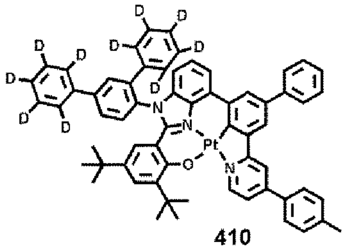
410

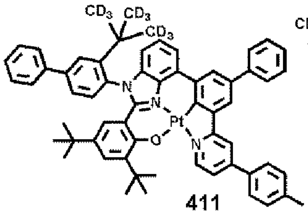
411

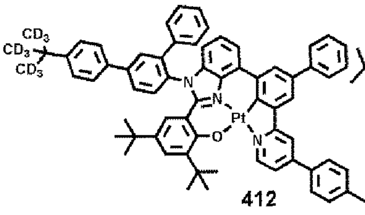
412

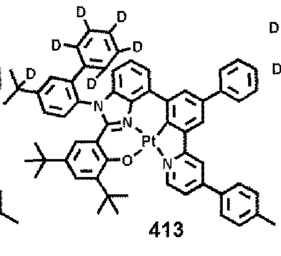
413

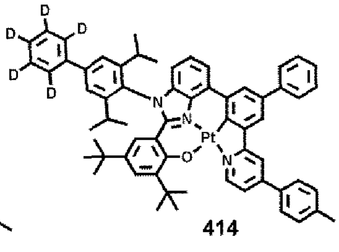
414

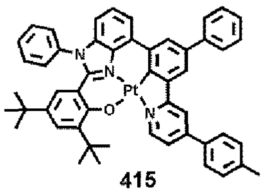
415

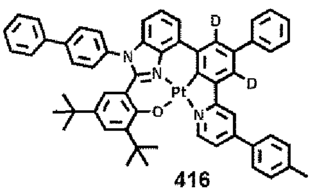
416

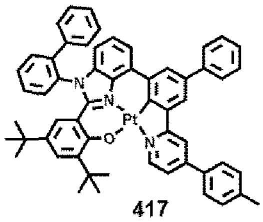
417

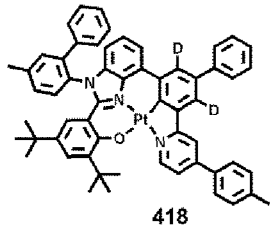
418

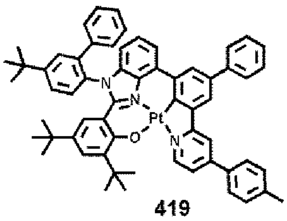
419

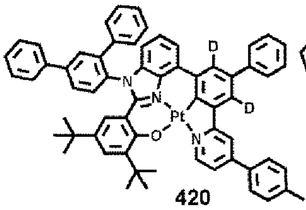
420

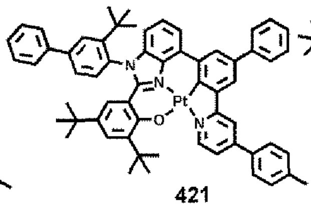
421

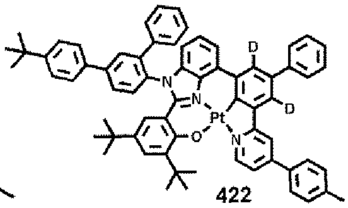
422

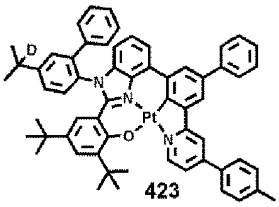
423

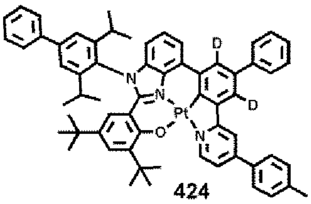
424

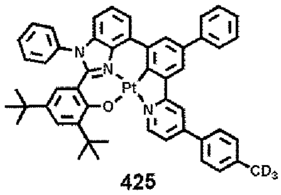
425

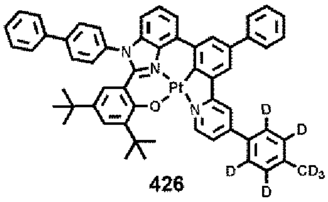
426

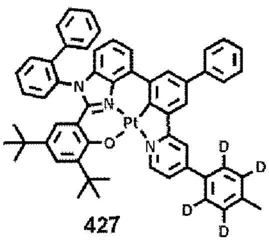
427

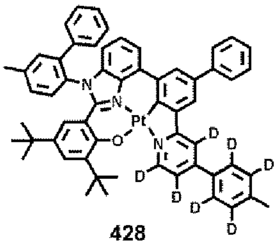
428

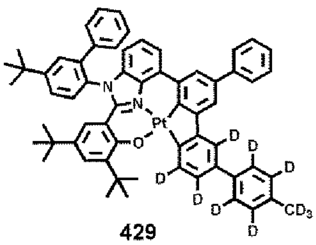
429

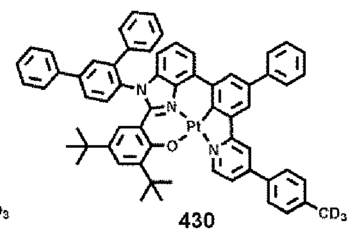
430

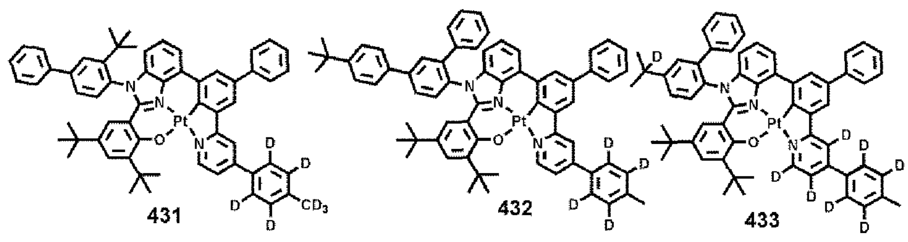

431

432

433

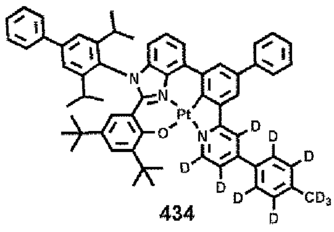

434

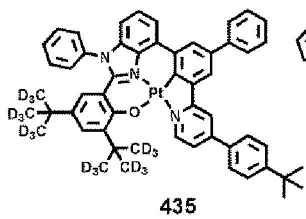

435

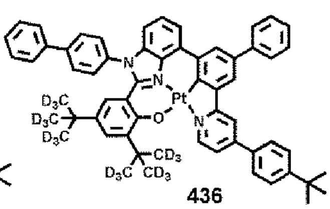

436

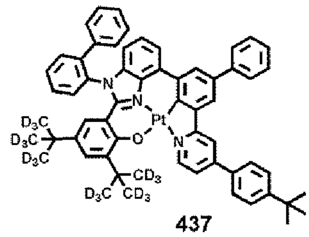

437

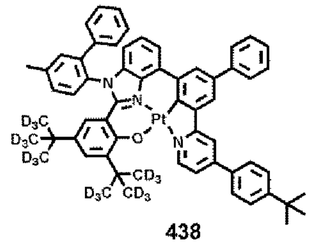

438

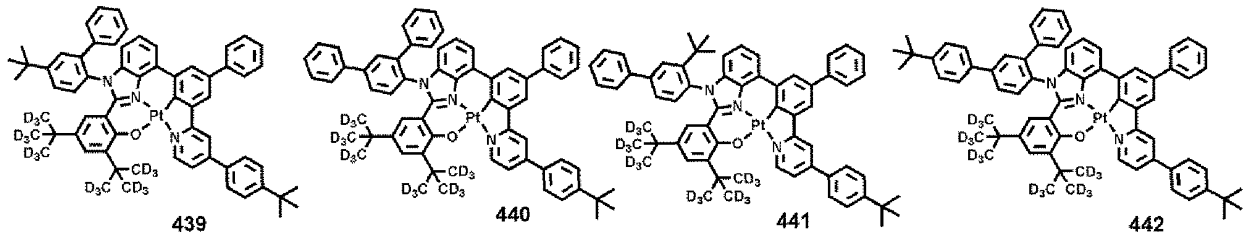

439

440

441

442

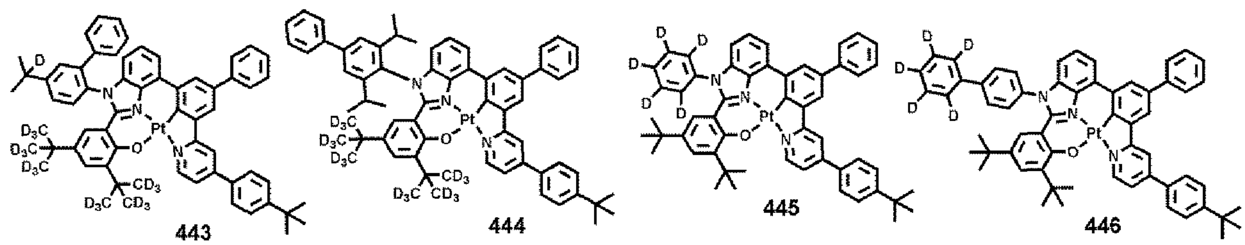

443

444

445

446

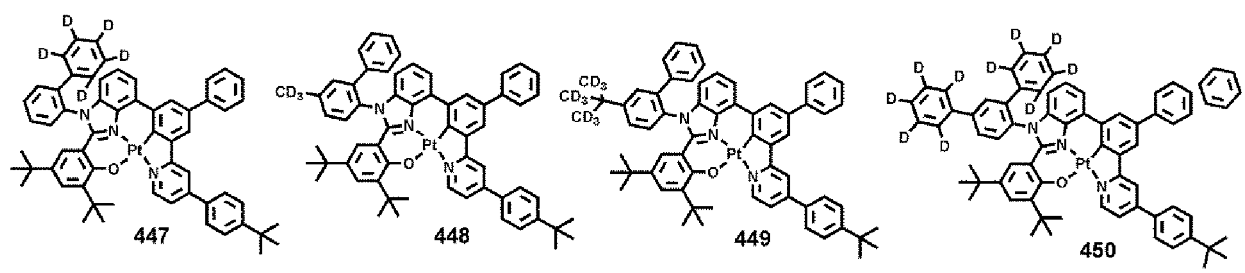

447

448

449

450

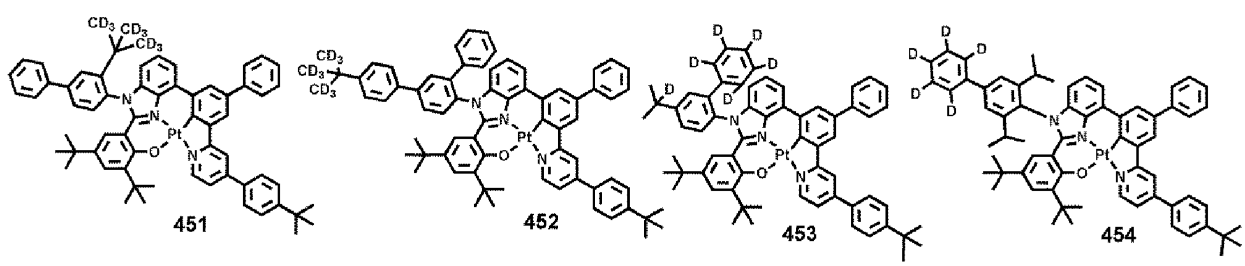

451

452

453

454

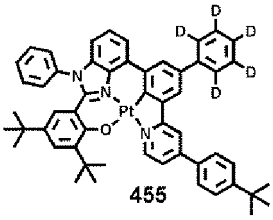
455
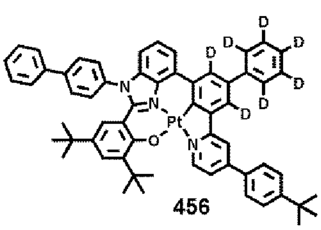
456
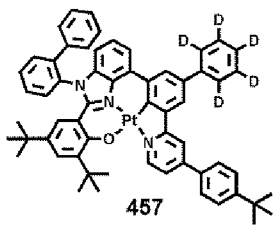
457
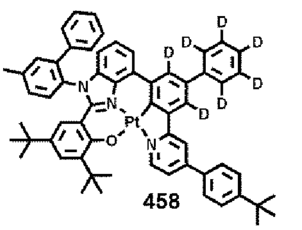
458
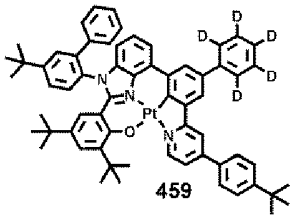
459
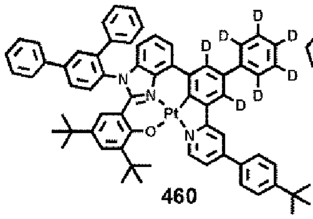
460
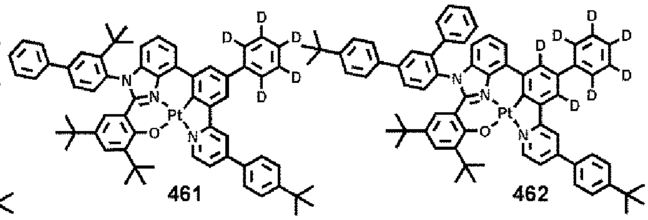
461
462
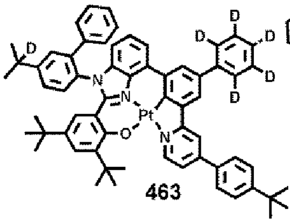
463
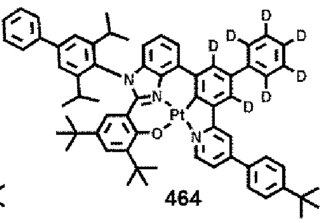
464
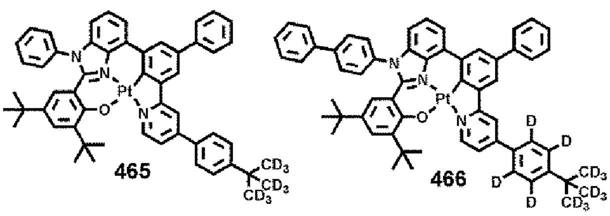
465
466
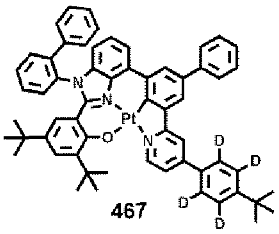
467
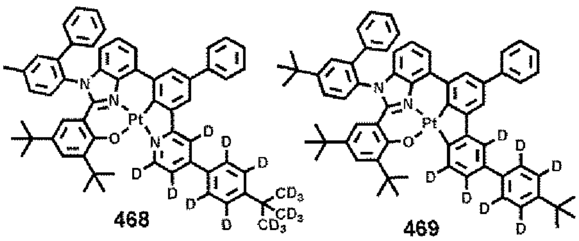
468
469
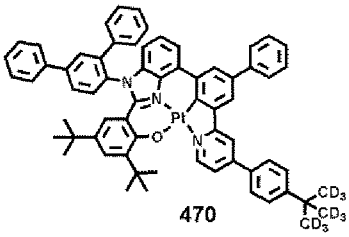
470
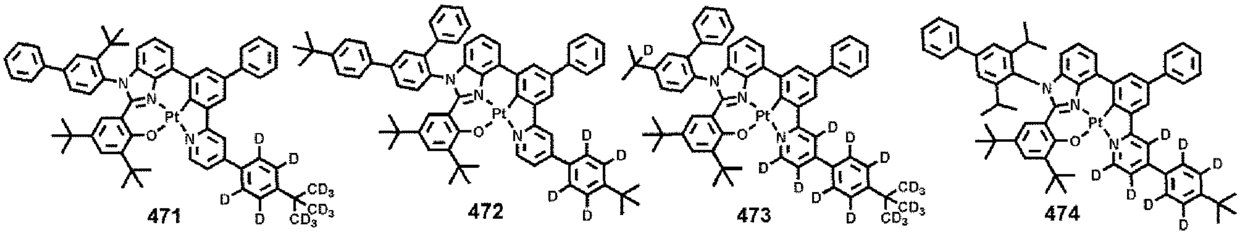
471
472
473
474
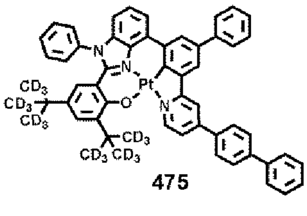
475
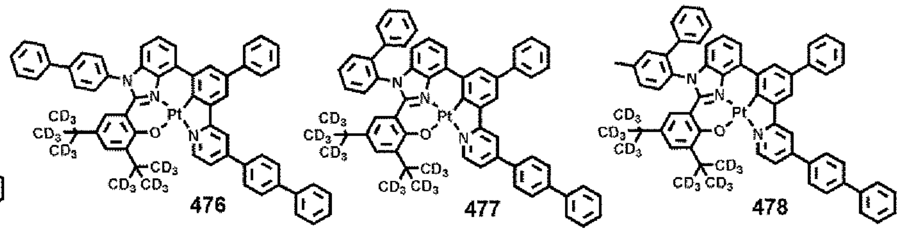
476
477
478

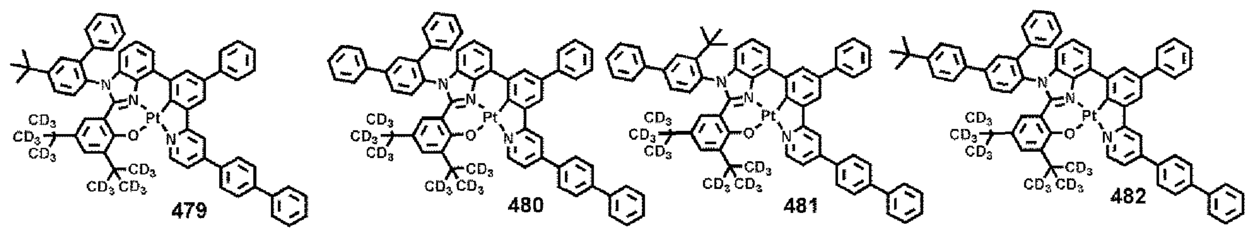

479 480 481 482

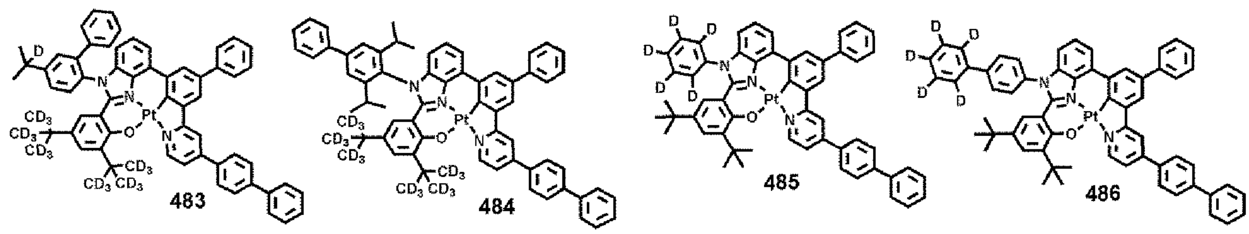

483 484 485 486

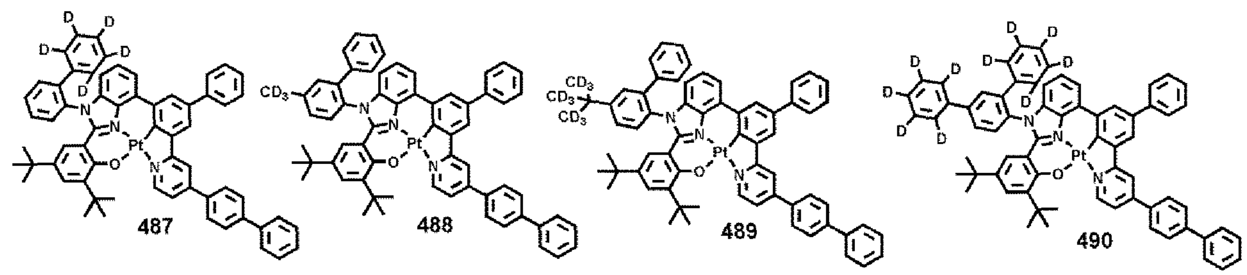

487 488 489 490

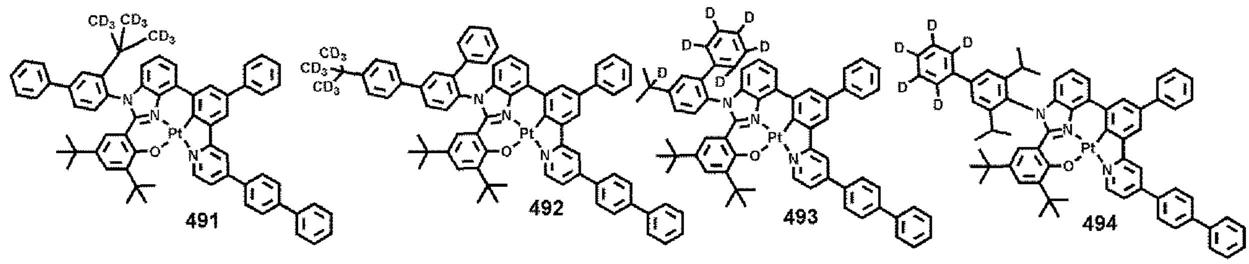

491 492 493 494

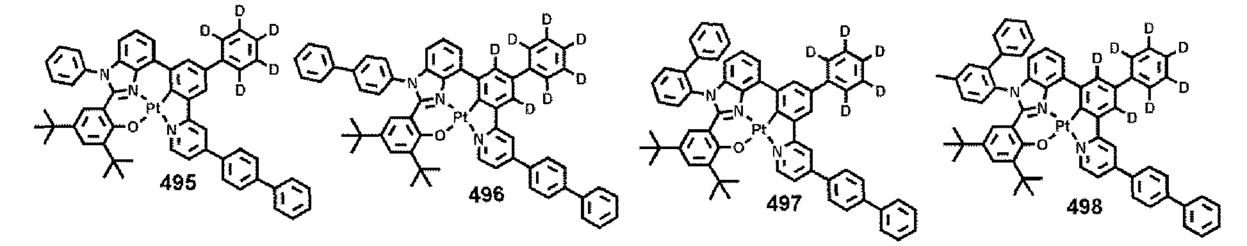

495 496 497 498

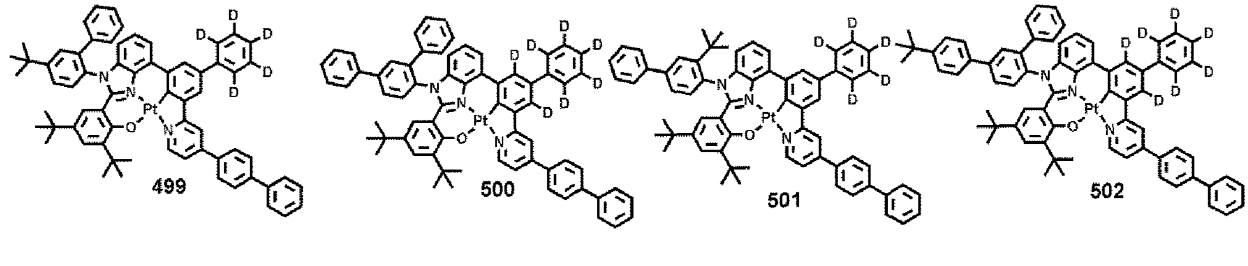

499 500 501 502

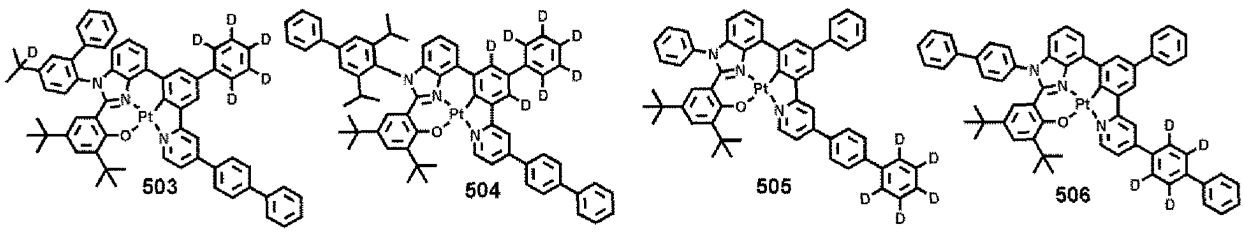

503 504 505 506

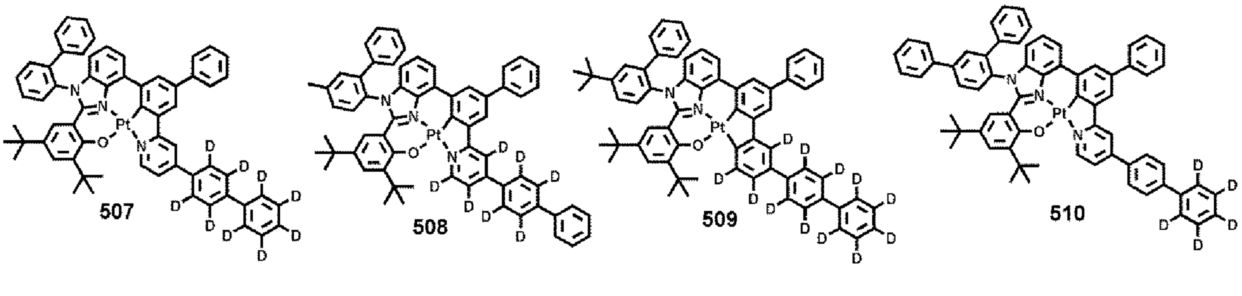

507 508 509 510

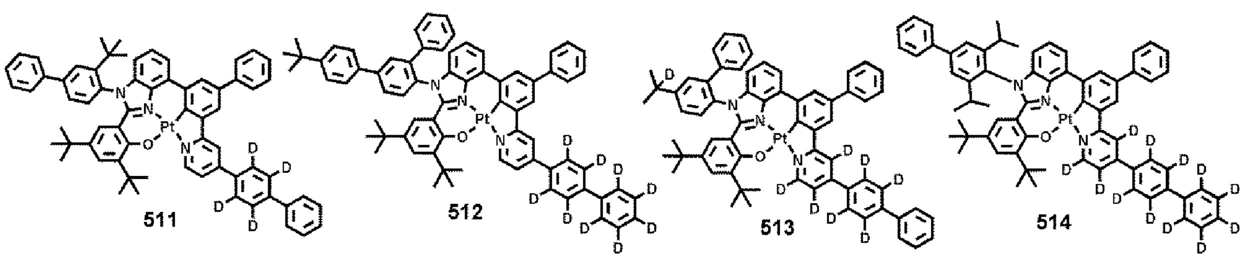

511 512 513 514

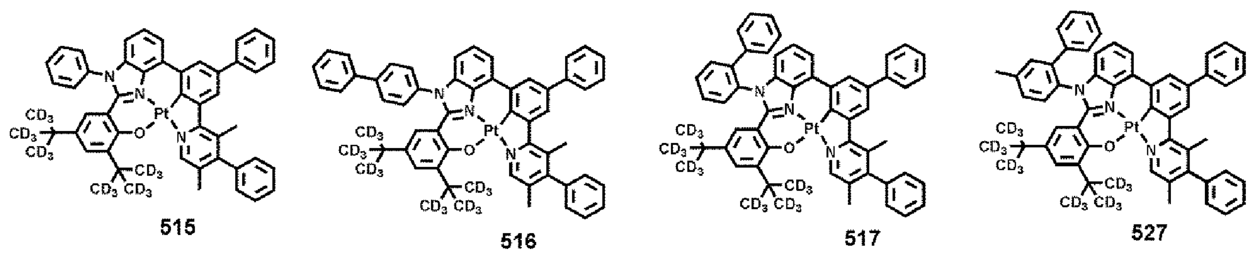

515 516 517 527

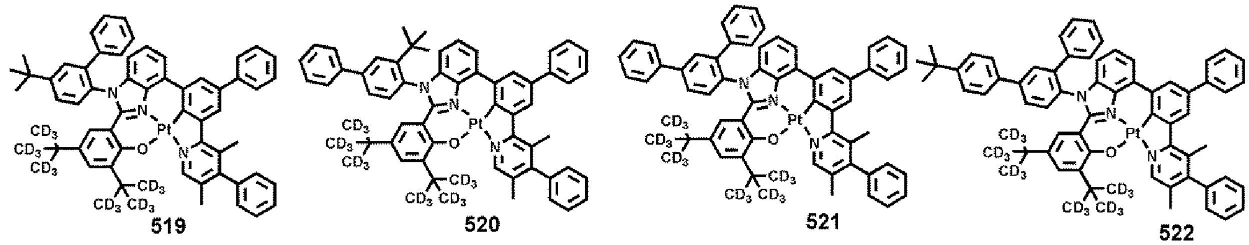

519 520 521 522

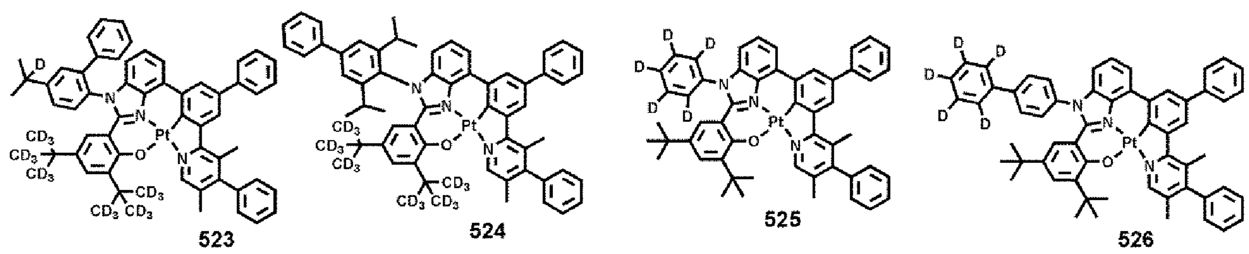

523 524 525 526

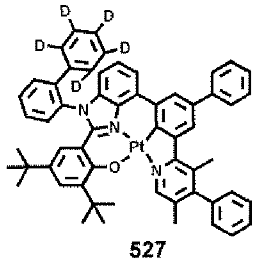
527

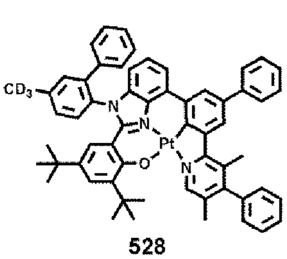
528

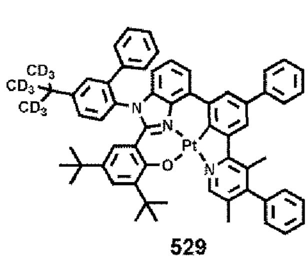
529

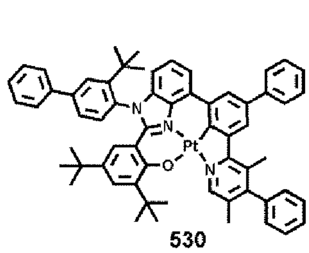
530

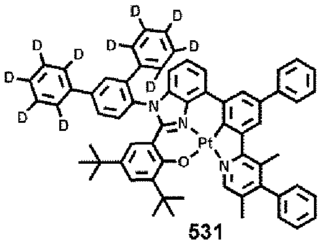
531

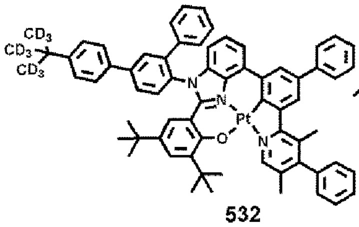
532

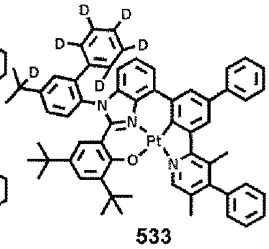
533

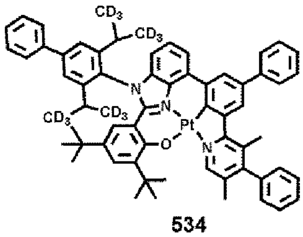
534

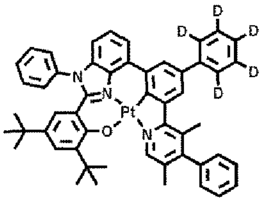
535

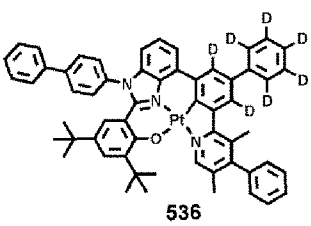
536

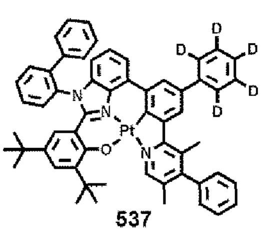
537

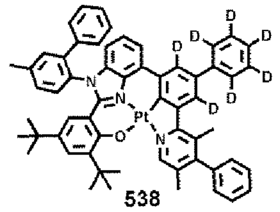
538

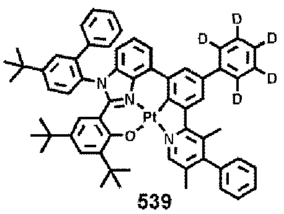
539

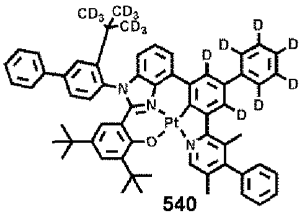
540

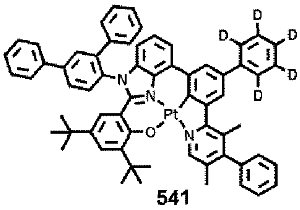
541

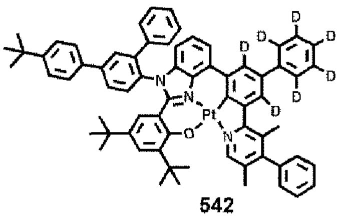
542

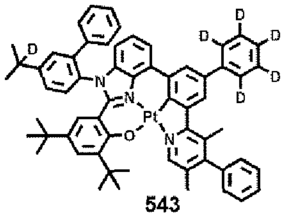
543

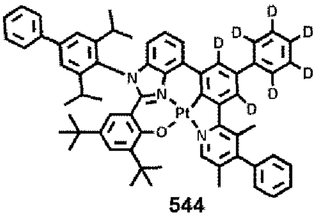
544

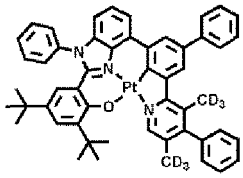
545

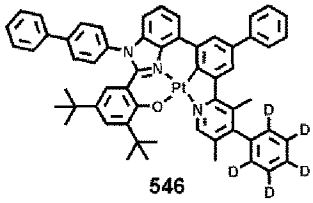
546

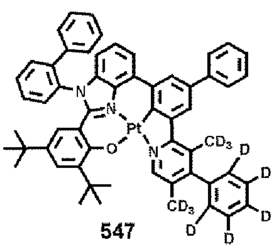
547

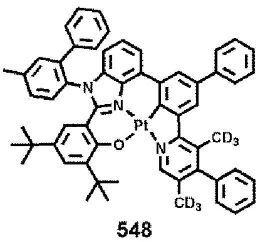
548

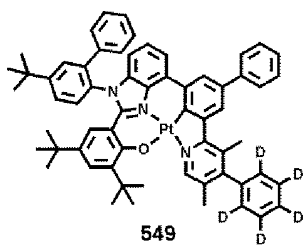
549

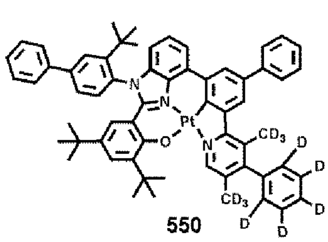
550

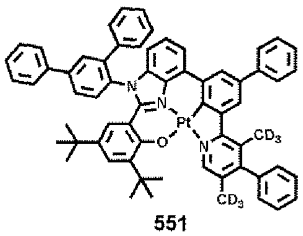
551

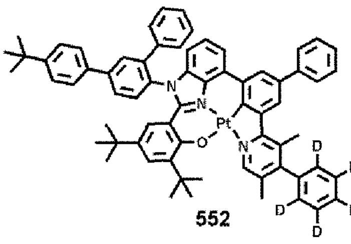
552

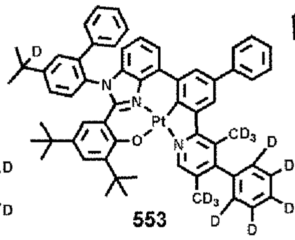
553

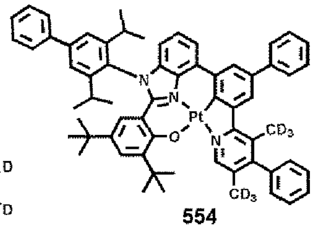
554

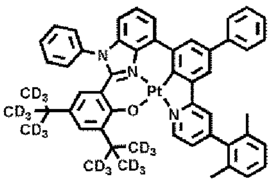
555

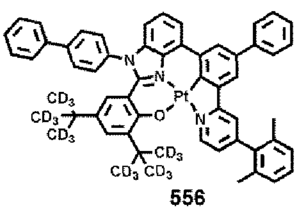
556

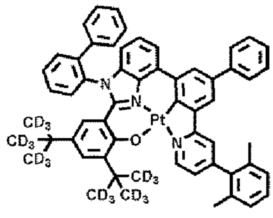
557

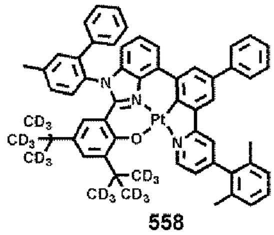
558

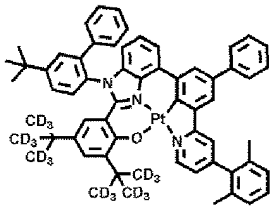
559

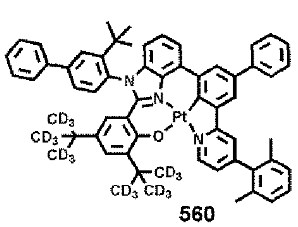
560

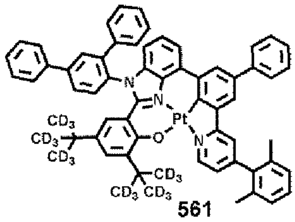
561

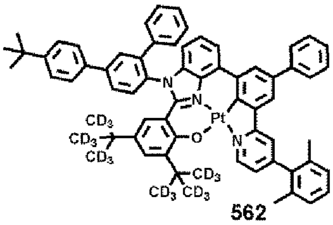
562

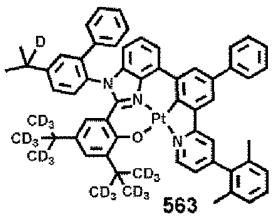
563

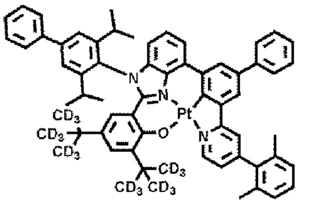
564

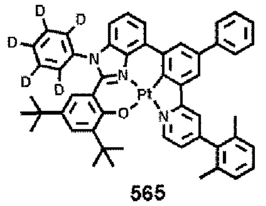
565

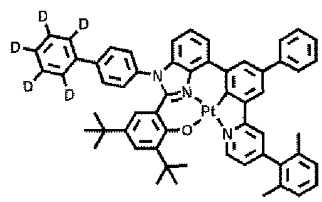
566

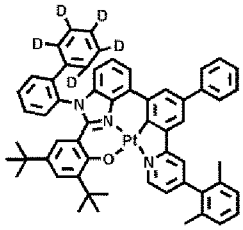
567

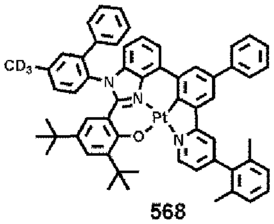
568

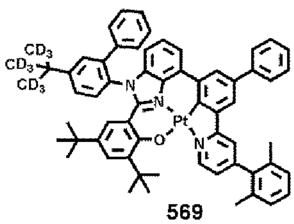
569

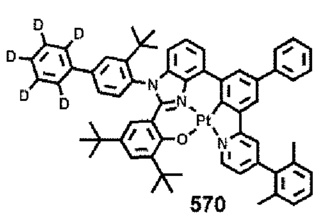
570

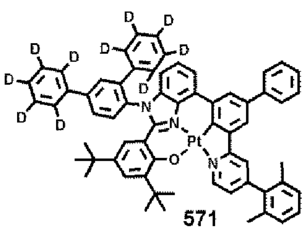
571

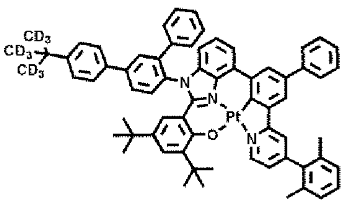
572

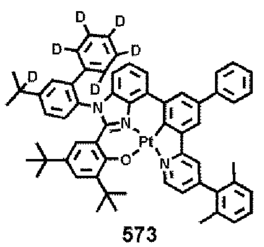
573

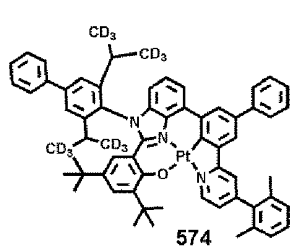
574

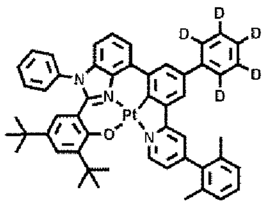
575

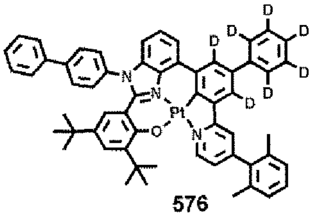
576

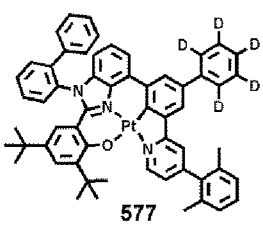
577

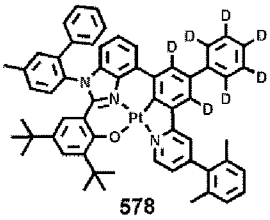
578

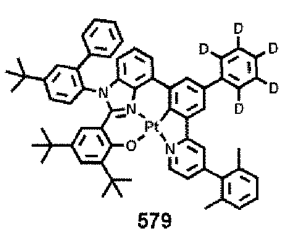
579

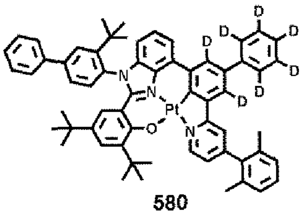
580

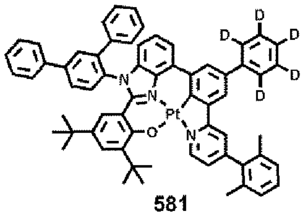
581

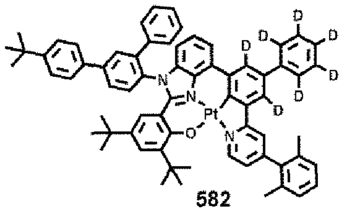
582

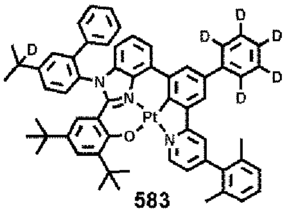
583

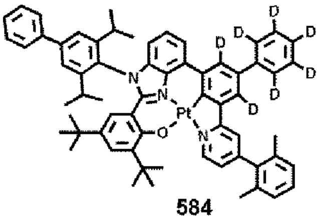
584

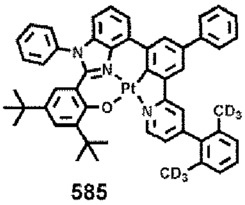
585

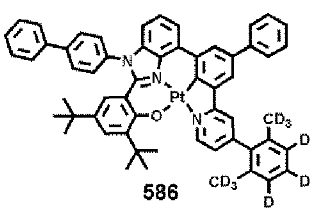
586

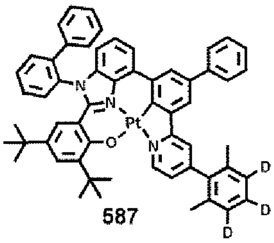
587

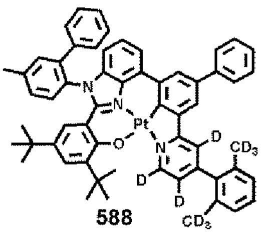
588

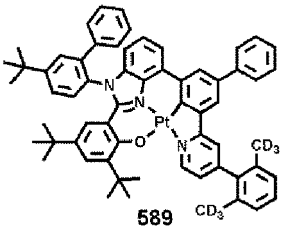
589

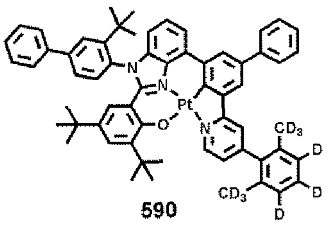
590

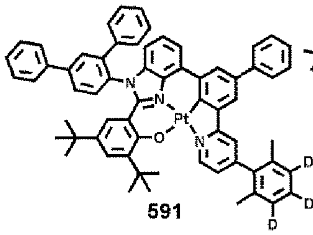
591

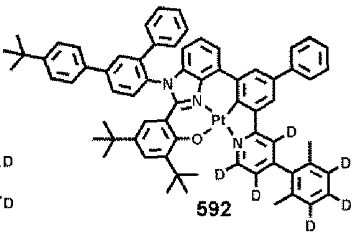
592

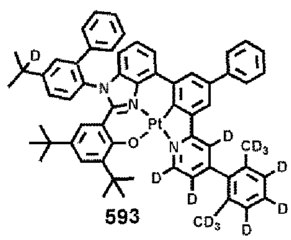
593

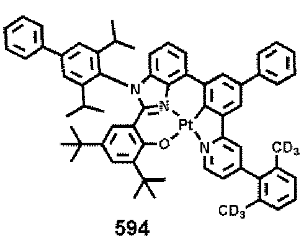
594

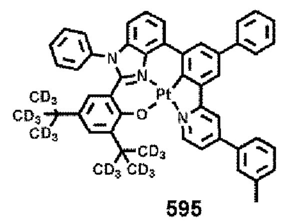
595

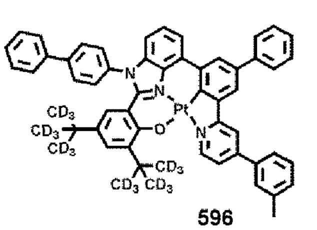
596

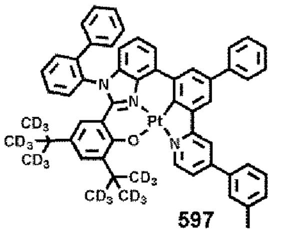
597

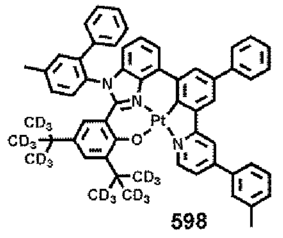
598

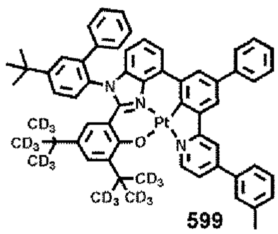
599

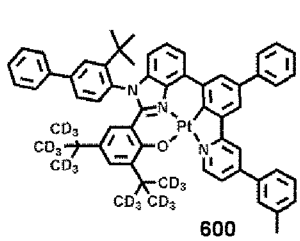
600

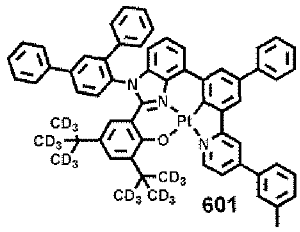
601

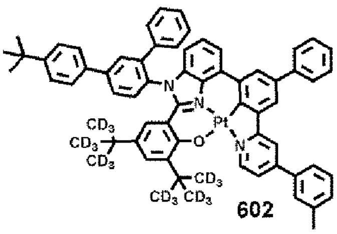
602

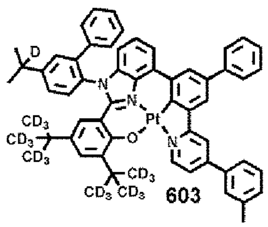
603

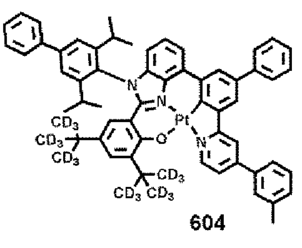
604

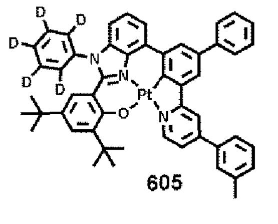
605

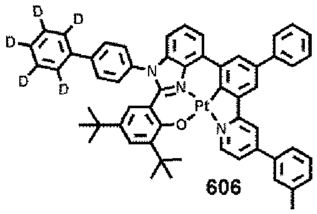
606

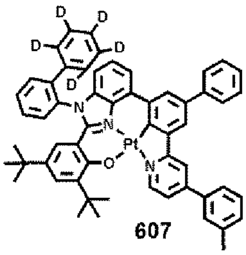
607

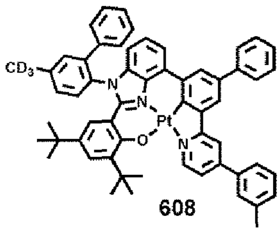
608

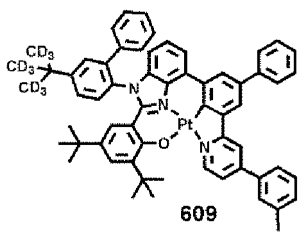
609

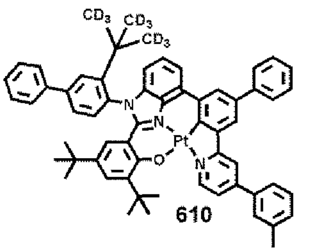
610

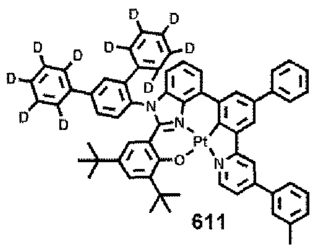
611

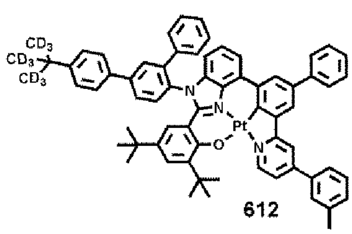
612

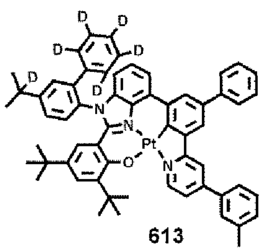
613

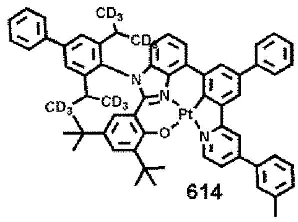
614

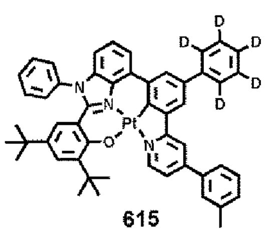
615

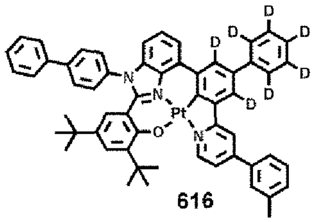
616

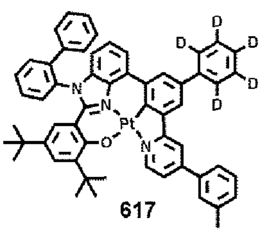
617

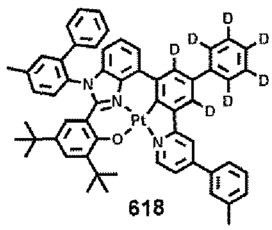
618

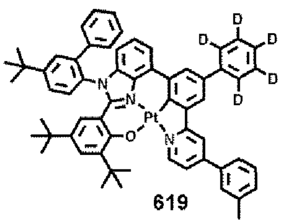
619

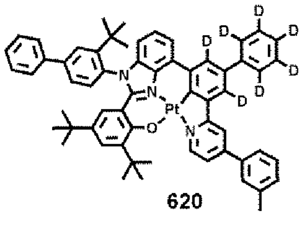
620

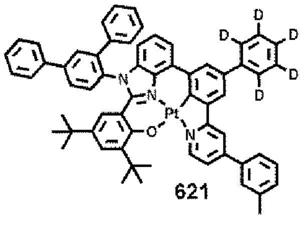
621

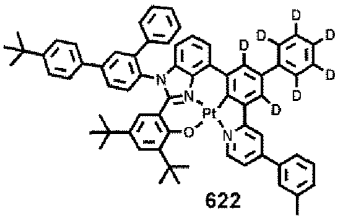
622

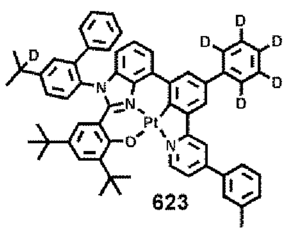
623

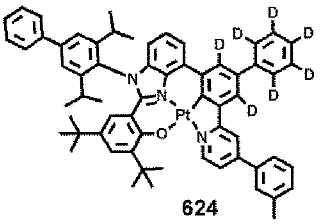
624

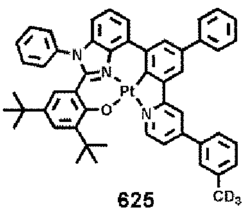
625

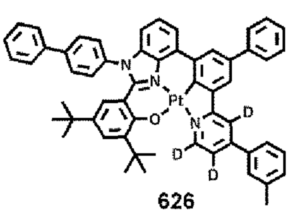
626

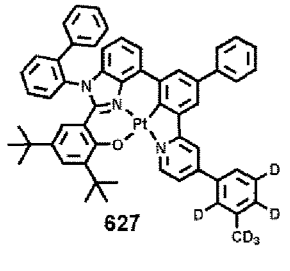
627

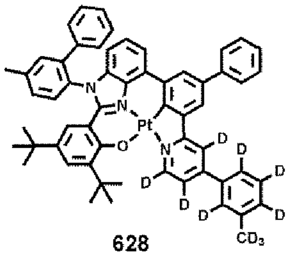
628

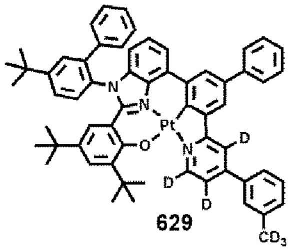
629

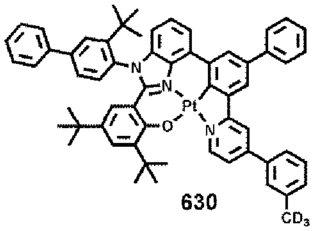
630

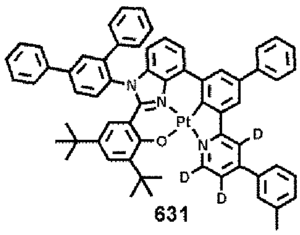
631

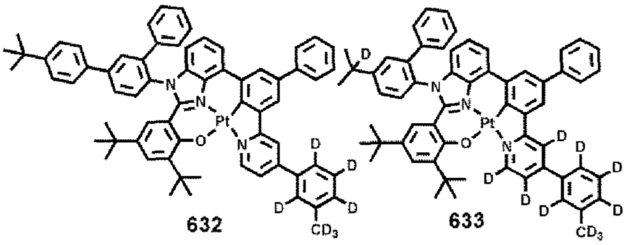
632

633

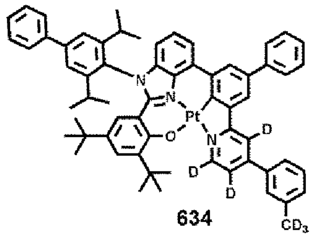
634

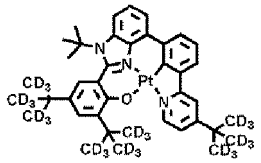
635

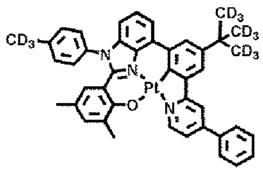
636

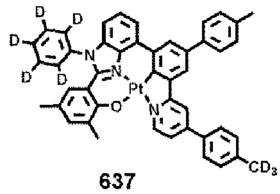
637

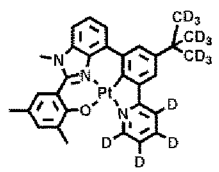
638

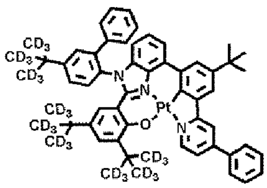
639

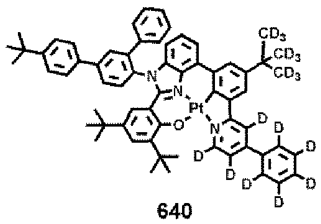
640

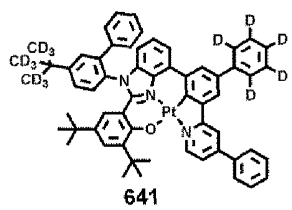
641

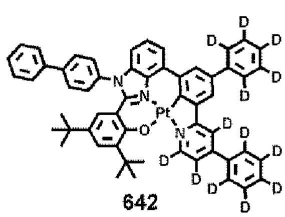
642

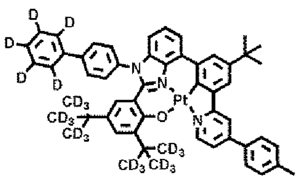
643

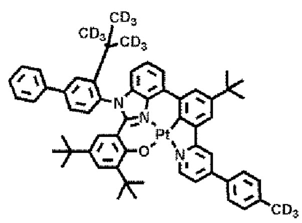
644

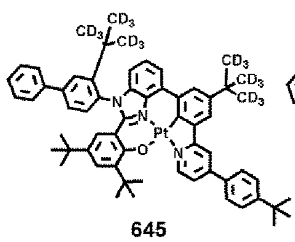
645

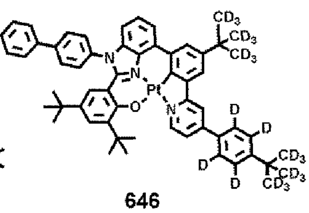
646

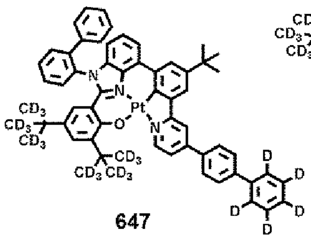
647
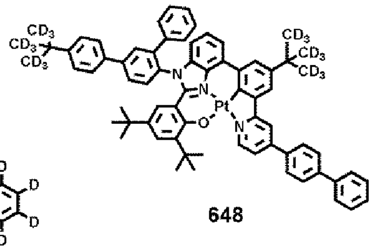
648
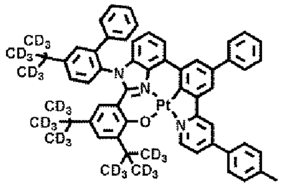
649
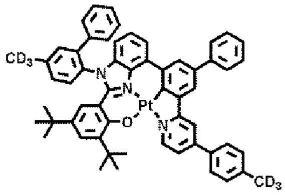
650

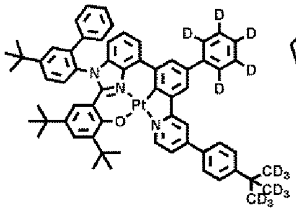
651
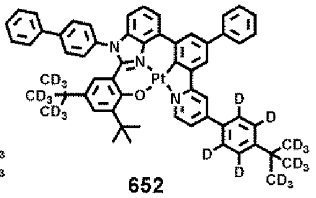
652
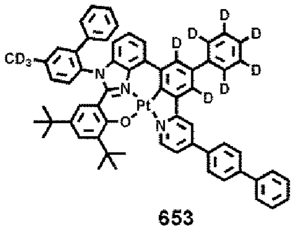
653
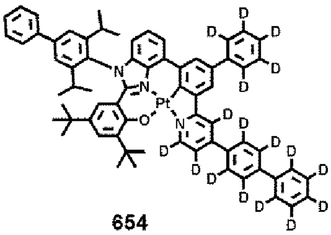
654

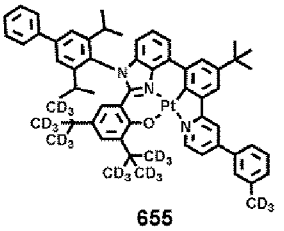
655
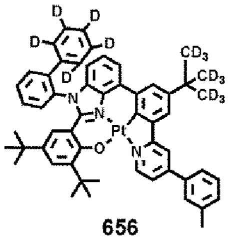
656
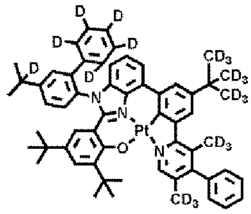
657
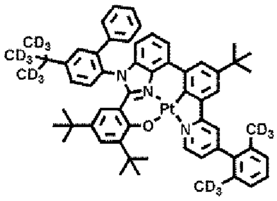
658

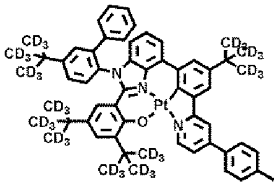
659
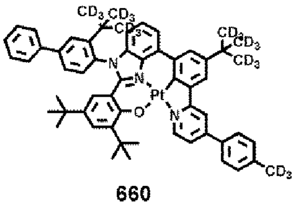
660
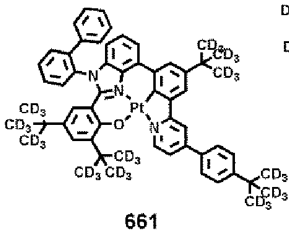
661
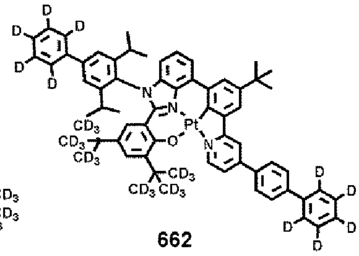
662

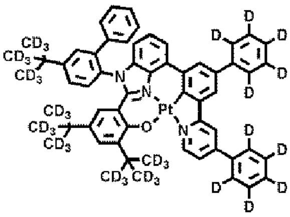
663
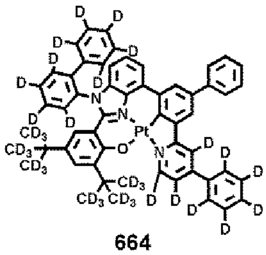
664
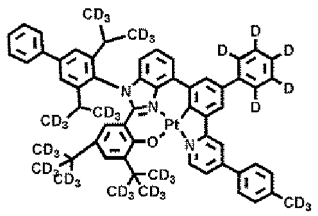
665
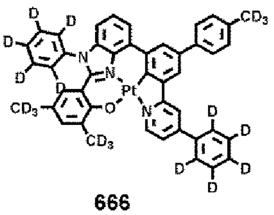
666

$Z_1$ to $Z_4$ in Formula 1 may each independently be deuterium or a deuterium-containing group, and i) when $X_{51}$ is O, S, C(=O), or N, the sum of n1 to n4 may be 1 or more, ii) when $X_{51}$ is $N[(L_7)_{b7}-(R_7)_{c7}]$, $C(R_7)$, $Si(R_7)$, or $Ge(R_7)$, a) $R_7$ is deuterium or a deuterium-containing group; b) the sum of n1 to n4 may be 1 or more; or c) $R_7$ is deuterium or a deuterium-containing group and the sum of n1 to n4 is 1 or more, and iii) when $X_{51}$ is $C(R_7)(R_8)$, $Si(R_7)(R_8)$, or $Ge(R_7)(R_8)$, a) at least one of $R_7$ and $R_8$ may be deuterium or a deuterium-containing group; b) the sum of n1 to n4 is 1 or more; or c) at least one of $R_7$ and $R_8$ is deuterium or a deuterium-containing group and the sum of n1 to n4 is 1 or more. That is, the organometallic compound represented by Formula 1 may essentially include at least one deuterium. Accordingly, the reduced mass of the organometallic compound represented by Formula 1 is changed, and thus, a molecular structure change caused by energy quenching caused due to vibration of the organometallic compound being in an excited state is decreased. Due to the decrease in the molecular structure change, an electronic device including the organometallic compound represented by Formula 1, for example, an organic light-emitting device including the organometallic compound represented by Formula 1 may have improved lifespan characteristics.

In one or more embodiments, $X_2$ to $X_4$ in Formula 1 may each independently be N or C, two selected from $X_2$ to $X_4$ may each be N, and the remaining one may be C, and a bond between $X_1$ or $Y_1$ and M may be a covalent bond, and one bond selected from a bond between $X_2$ and M, a bond between $X_3$ and M, and a bond between $X_4$ and M may be a covalent bond, and the remaining two bonds may each be a coordinate bond. In an embodiment, $X_2$ of ring $CY_5$, $X_3$ of ring $CY_3$, and $X_4$ of ring $CY_4$ in Formula 1 may not constitute a carbine moiety. That is, regarding Formula 1, 1) when $X_2$ is C, a bond between $X_2$ and M may be a covalent bond, 2) when $X_3$ is C, a bond between $X_3$ and M may be a covalent bond, and 3) when $X_4$ is C, a bond between $X_4$ and M may be a covalent bond. Therefore, the structural change of the main emission moiety of the organometallic compound represented by Formula 1 in an exited state is decreased, and thus, color purity of an electronic device including the organometallic compound, for example, an organic light-emitting device including the organometallic compound may be improved.

Furthermore, each of ring $CY_1$, ring $CY_3$, and ring $CY_4$ in Formula 1 may not be a benzimidazole group. Accordingly, since the steric hindrance of a ligand surrounding the center metal M is improved, an electronic device including the organometallic compound, for example, an organic light-emitting device including the organometallic compound may have an improved lifespan characteristic and a sharp electroluminescence peak.

For example, HOMO, LUMO, singlet ($S_1$) and triplet ($T_1$) energy levels of Compounds 1 to 10 and 13 were evaluated by using a DFT method of Gaussian program (structurally optimized at a level of B3LYP, 6-31G(d,p)). Evaluation results are shown in Table 1 below.

Table 1

| Compound No. | HOMO (eV) | LUMO (eV) | Energy gap (eV) | $S_1$ energy level (eV) | $T_1$ energy level (eV) |
|---|---|---|---|---|---|
| 1 | -4.85 | -1.546 | 3.304 | 2.751 | 2.517 |
| 2 | -4.85 | -1.546 | 3.304 | 2.751 | 2.517 |
| 3 | -4.85 | -1.546 | 3.304 | 2.751 | 2.517 |
| 4 | -4.869 | -1.589 | 3.280 | 2.728 | 2.472 |
| 5 | -4.869 | -1.589 | 3.280 | 2.728 | 2.472 |
| 6 | -4.869 | -1.589 | 3.280 | 2.728 | 2.472 |
| 7 | -4.994 | -1.793 | 3.201 | 2.661 | 2.439 |
| 8 | -4.994 | -1.793 | 3.201 | 2.661 | 2.439 |
| 9 | -4.994 | -1.793 | 3.201 | 2.661 | 2.439 |
| 10 | -4.794 | -1.528 | 3.266 | 2.721 | 2.47 |
| 13 | -4.782 | -1.528 | 3.254 | 2.719 | 2.466 |

From Table 1, it is confirmed that the organometallic compound represented by Formula 1 has such electric characteristics that are suitable for use as a dopant for an electronic device, for example, an organic light-emitting device.

Synthesis methods of the organometallic compound represented by Formula 1 may be recognizable by one of ordinary skill in the art by referring to Synthesis Examples provided below.

The organometallic compound represented by Formula 1 is suitable for use in an organic layer of an organic light-emitting device, for example, for use as a dopant in an emission layer of the organic layer. Thus, another aspect provides an organic light-emitting device that includes: a first electrode; a second electrode; and an organic layer that is located between the first electrode and the second electrode, wherein the organic layer includes an emission layer and at least one organometallic compound represented by Formula 1.

The organic light-emitting device may have, due to the inclusion of an organic layer including the organometallic compound represented by Formula 1, a low driving voltage, high efficiency, high power efficiency, high quantum efficiency, a long lifespan, a low roll-off ratio, and excellent color purity.

The organometallic compound of Formula 1 may be used between a pair of electrodes of an organic light-emitting device. For example, the organometallic compound represented by Formula 1 may be included in the emission layer. In this regard, the organometallic compound may act as a dopant, and the emission layer may further include a host (that is, an amount of the organometallic compound represented by Formula 1 is smaller than an amount of the host).

The expression "(an organic layer) includes at least one organometallic compounds" as used herein may include an embodiment in which "(an organic layer) includes identical organometallic compounds represented by Formula 1" and an embodiment in which "(an organic layer) includes two or more different organometallic compounds represented

by Formula 1."

For example, the organic layer may include, as the organometallic compound, only Compound 1. In this regard, Compound 1 may be included in an emission layer of the organic light-emitting device. In one or more embodiments, the organic layer may include, as the organometallic compound, Compound 1 and Compound 2. In this regard, Compound 1 and Compound 2 may be included in an identical layer (for example, Compound 1 and Compound 2 may all be included in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In an embodiment, in the organic light-emitting device, the first electrode is an anode, and the second electrode is a cathode, and the organic layer further includes a hole transport region disposed between the first electrode and the emission layer and an electron transport region disposed between the emission layer and the second electrode, wherein the hole transport region includes a hole injection layer, a hole transport layer, an electron blocking layer, a buffer layer, or any combination thereof, and the electron transport region includes a hole blocking layer, an electron transport layer, an electron injection layer, or any combination thereof.

The term "organic layer" as used herein refers to a single layer and/or a plurality of layers disposed between the first electrode and the second electrode of the organic light-emitting device. The "organic layer" may include, in addition to an organic compound, an organometallic complex including metal.

The FIGURE is a schematic view of an organic light-emitting device 10 according to an embodiment. Hereinafter, the structure of an organic light-emitting device according to an embodiment and a method of manufacturing an organic light-emitting device according to an embodiment will be described in connection with the FIGURE. The organic light-emitting device 10 includes a first electrode 11, an organic layer 15, and a second electrode 19, which are sequentially stacked.

A substrate may be additionally located under the first electrode 11 or above the second electrode 19. For use as the substrate, any substrate that is used in general organic light-emitting devices may be used, and the substrate may be a glass substrate or a transparent plastic substrate, each having excellent mechanical strength, thermal stability, transparency, surface smoothness, ease of handling, and water resistance.

In one or more embodiments, the first electrode 11 may be formed by depositing or sputtering a material for forming the first electrode 11 on the substrate. The first electrode 11 may be an anode. The material for forming the first electrode 11 may be selected from materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide ($SnO_2$), or zinc oxide (ZnO). In one or more embodiments, the material for forming the first electrode 11 may be metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO, but the structure of the first electrode 11 is not limited thereto.

The organic layer 15 is located on the first electrode 11.

The organic layer 15 may include a hole transport region, an emission layer, and an electron transport region.

The hole transport region may be between the first electrode 11 and the emission layer.

The hole transport region may include a hole injection layer, a hole transport layer, an electron blocking layer, a buffer layer, or any combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, which are sequentially stacked in this stated order from the first electrode 11.

When the hole transport region includes a hole injection layer (HIL), the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary according to a material that is used to form the hole injection layer, and the structure and thermal characteristics of the hole injection layer. For example, the deposition conditions may include a deposition temperature of about 100 to about 500 °C, a vacuum pressure of about $10^{-8}$ torr to about $10^{-3}$ torr (wherein 1 torr = 133.322 Pa), and a deposition rate of about 0.01 Angstroms per second (Å/sec) to about 100 Å/sec. However, the deposition conditions are not limited thereto.

When the hole injection layer is formed using spin coating, coating conditions may vary according to the material used to form the hole injection layer, and the structure and thermal properties of the hole injection layer. For example, a coating speed may be from about 2,000 revolutions per minute (rpm) to about 5,000 rpm (wherein 1 rpm = 1/60 Hz), and a temperature at which a heat treatment is performed to remove a solvent after coating may be from about 80°C to

about 200°C. However, the coating conditions are not limited thereto.

Conditions for forming a hole transport layer and an electron blocking layer may be understood by referring to conditions for forming the hole injection layer.

The hole transport region may include at least one selected from m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzene sulfonic acid (PANI/DBSA), poly(3,4-ethylenedioxythiophene)/poly(4-styrene sulfonate) (PEDOT/PSS), polyaniline/camphor sulfonic acid (PANI/CSA), polyaniline/poly(4-styrene sulfonate) (PANI/PSS), a compound represented by Formula 201 below, and a compound represented by Formula 202 below:

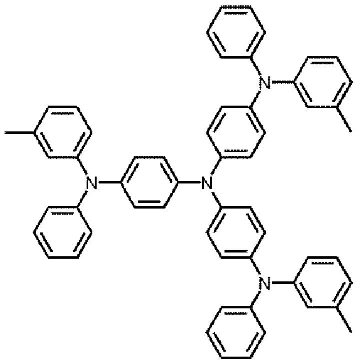
m-MTDATA

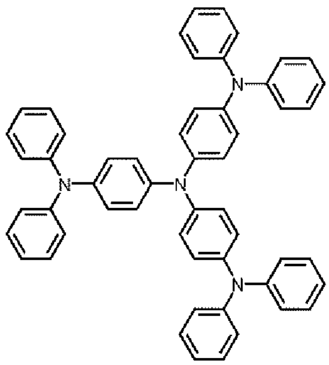
TDATA

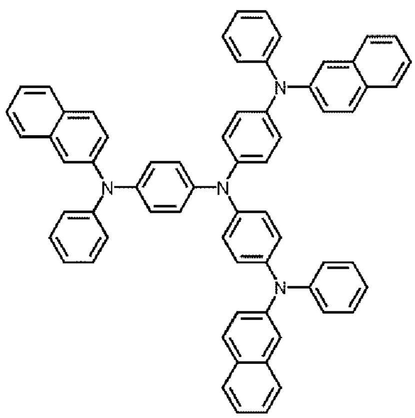
2-TNATA

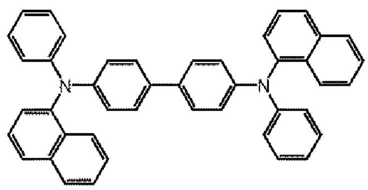
NPB

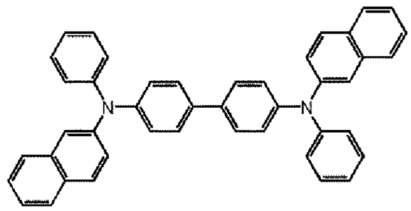
β-NPB

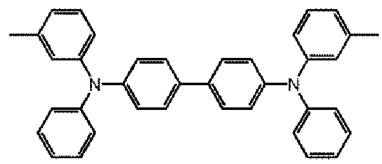
TPD

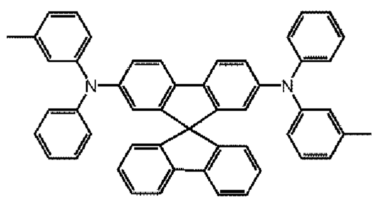
Spiro-TPD

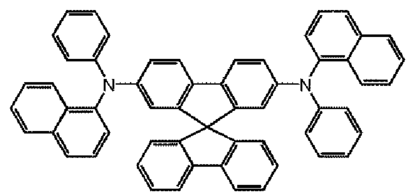
Spiro-NPB

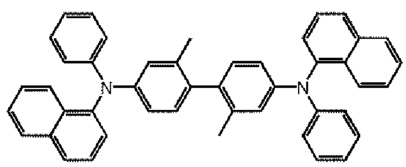
methylated NPB

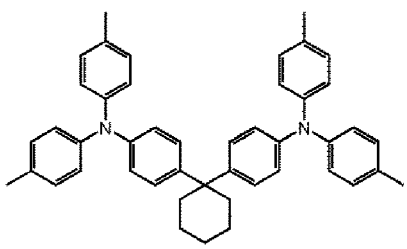
TAPC

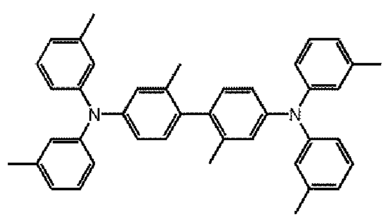
HMTPD

Formula 201

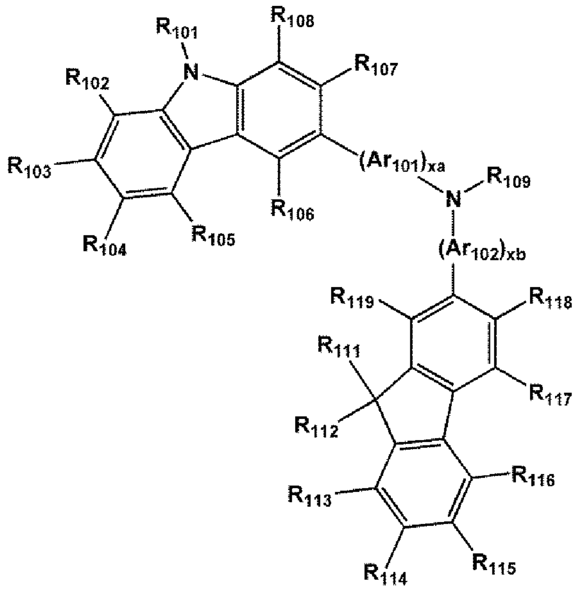

Formula 202

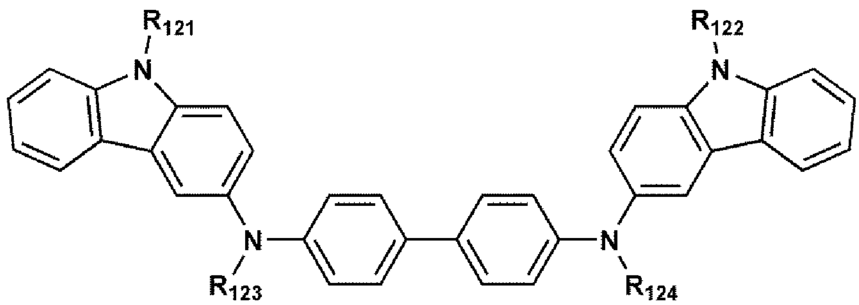

$Ar_{101}$ to $Ar_{102}$ in Formula 201 may each independently be selected from

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group; and

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group, each substituted with at least one selected from deuterium, - F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group.

xa and xb in Formula 201 may each independently be an integer from 0 to 5, or 0, 1 or 2. For example, xa may be 1 and xb may be 0, but xa and xb are not limited thereto. $R_{101}$ to $R_{108}$, $R_{111}$ to $R_{119}$ and $R_{121}$ to $R_{124}$ in Formulae 201 and 202 may each independently be selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (for example, a methyl group, an ethyl group, a propyl group, a butyl group, a pentyl group, a hexyl group, and so on), or a $C_1$-$C_{10}$ alkoxy group (for example, a methoxy group, an ethoxy group, a propoxy group, a butoxy group, a pentoxy group, and so on);

a $C_1$-$C_{10}$ alkyl group or a $C_1$-$C_{10}$ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;

a phenyl group, a naphthyl group, an anthracenyl group, a fluorenyl group, or a pyrenyl group; and

a phenyl group, a naphthyl group, an anthracenyl group, a fluorenyl group, and a pyrenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, and a $C_1$-$C_{10}$ alkoxy group, but embodiments of the present disclosure are not limited thereto.

$R_{109}$ in Formula 201 may be selected from:

a phenyl group, a naphthyl group, an anthracenyl group, and a pyridinyl group; and

a phenyl group, a naphthyl group, an anthracenyl group, and a pyridinyl group, each substituted with at least one selected from a deuterium, -F, -Cl, -Br, -I, a hydroxyl group, a cyano group, a nitro group, an amino group, an amidino group, a hydrazine group, a hydrazone group, a carboxylic acid or a salt thereof, a sulfonic acid or a salt thereof, a phosphoric acid or a salt thereof, a $C_1$-$C_{20}$ alkyl group, a $C_1$-$C_{20}$ alkoxy group, a phenyl group, a naphthyl group, an anthracenyl group, and a pyridinyl group.

According to an embodiment, the compound represented by Formula 201 may be represented by Formula 201A below, but embodiments of the present disclosure are not limited thereto:

Formula 201A

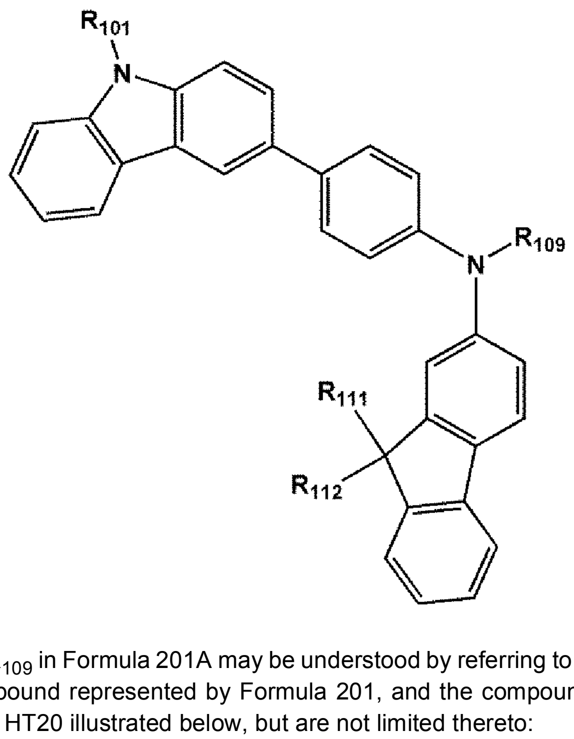

$R_{101}$, $R_{111}$, $R_{112}$, and $R_{109}$ in Formula 201A may be understood by referring to the description provided herein.

For example, the compound represented by Formula 201, and the compound represented by Formula 202 may include compounds HT1 to HT20 illustrated below, but are not limited thereto:

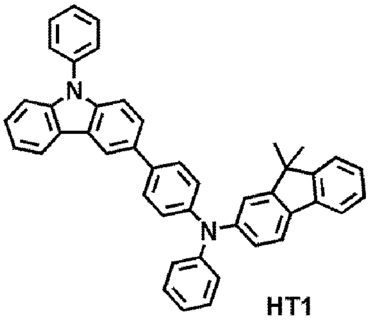
HT1

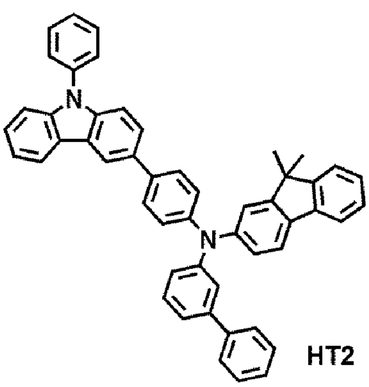
HT2

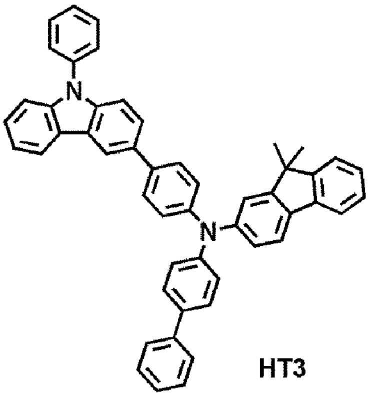
HT3

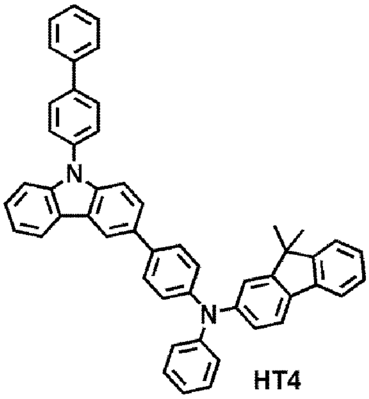
HT4

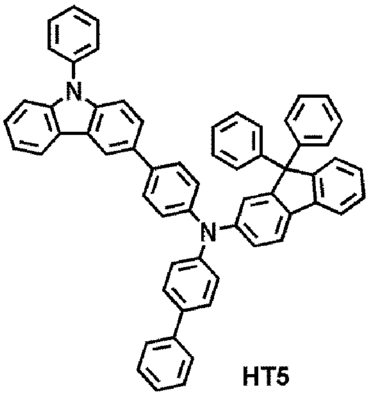
HT5

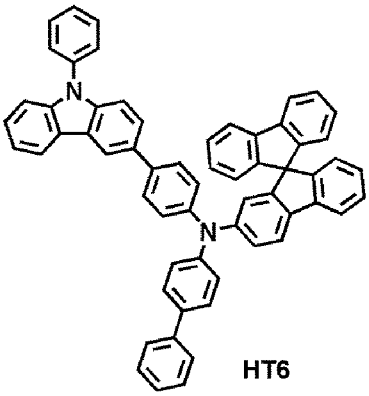
HT6

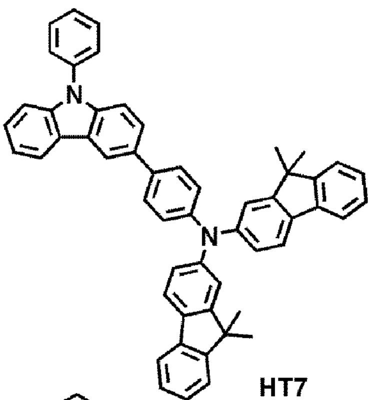
HT7

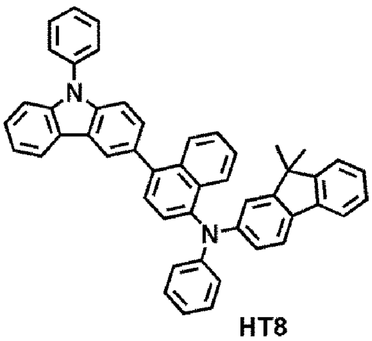
HT8

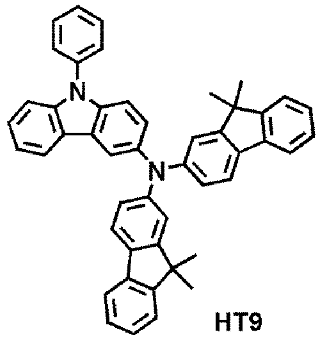
HT9

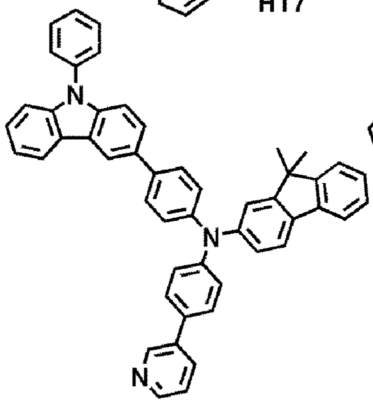
HT10

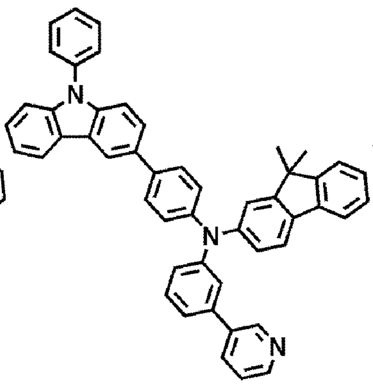
HT11

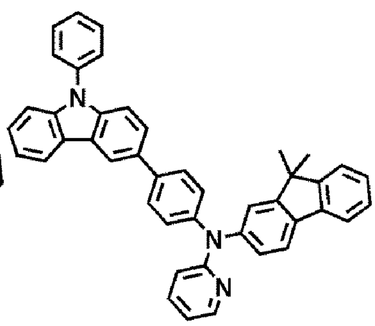
HT12

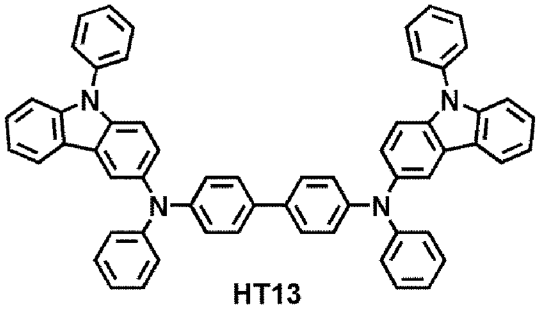
HT13

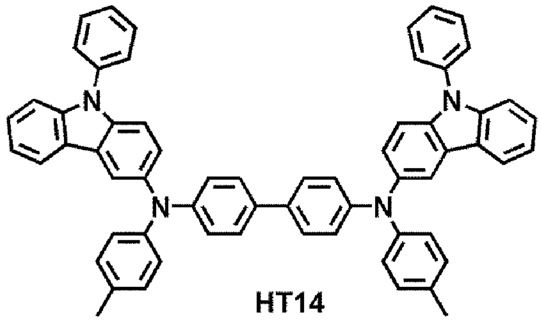
HT14

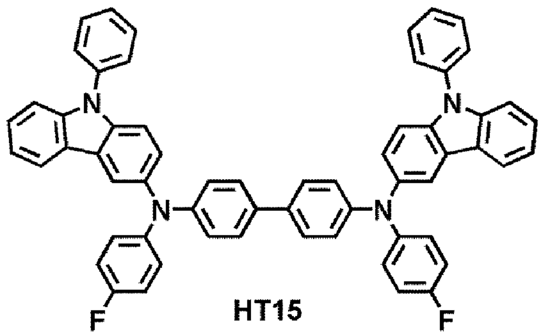
HT15

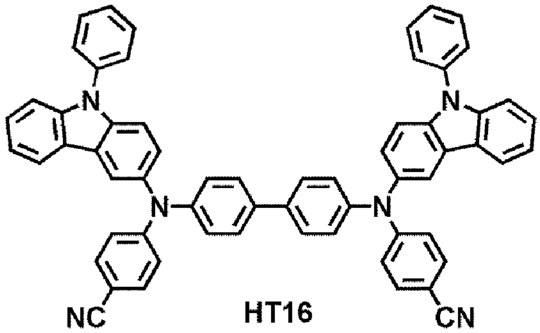
HT16

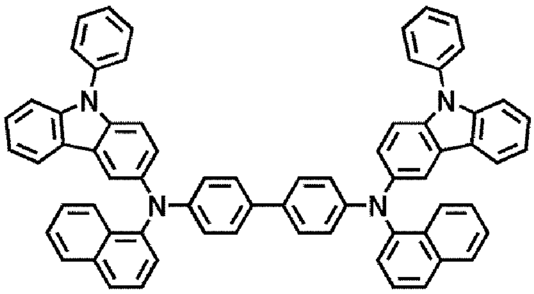
HT17

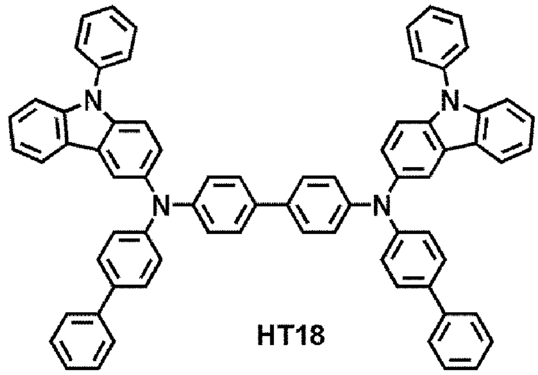
HT18

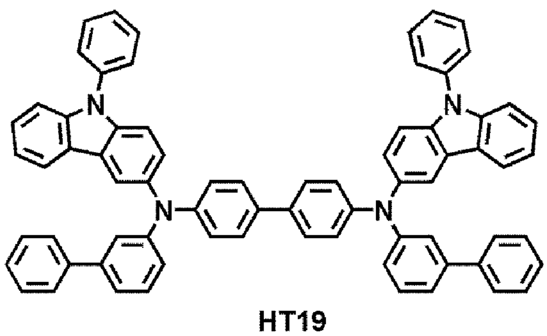
HT19

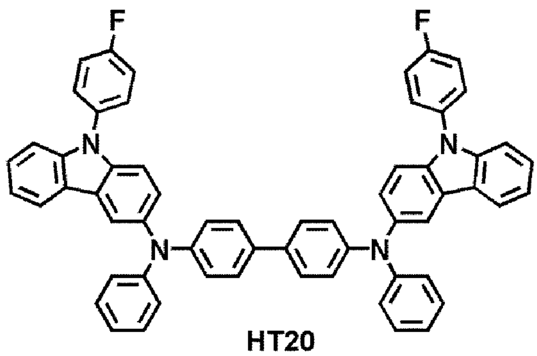
HT20

.

A thickness of the hole transport region may be in a range of about 100 Å to about 10,000 Å, for example, about 100 Å to about 1,000 Å. When the hole transport region includes at least one of a hole injection layer and a hole transport layer, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example about 100 Å to about 1,500 Å. While not wishing to be bound by theory, it is understood that when the thicknesses of the hole transport region, the hole injection layer and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one selected from a quinone derivative, a metal oxide, and a cyano group-containing compound, but embodiments of the present disclosure are not limited thereto. Non-limiting examples of the p-dopant are a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenium oxide; and a cyano group-containing compound, such as Compound HT-D1 below, but are not limited thereto.

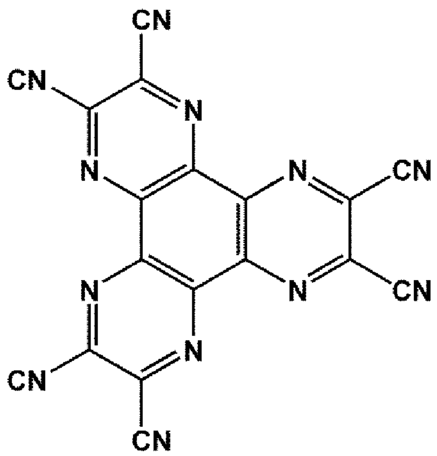

HT-D1

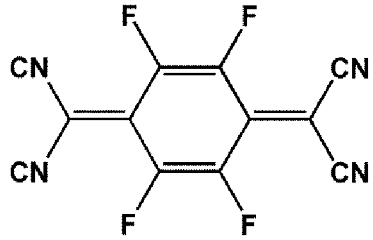

F4-TCNQ .

The hole transport region may include a buffer layer.

Also, the buffer layer may compensate for an optical resonance distance according to a wavelength of light emitted from the emission layer, and thus, efficiency of a formed organic light-emitting device may be improved.

Then, an emission layer (EML) may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a material that is used to form the hole transport layer.

Meanwhile, when the hole transport region includes an electron blocking layer, a material for the electron blocking layer may be selected from materials for the hole transport region described above and materials for a host to be explained later. However, the material for the electron blocking layer is not limited thereto. For example, when the hole transport region includes an electron blocking layer, a material for the electron blocking layer may be mCP, which will be explained later.

The emission layer may include a host and a dopant, and the dopant may include the organometallic compound represented by Formula 1.

The host may include at least one selected from TPBi, TBADN, ADN (also referred to as "DNA"), CBP, CDBP, TCP, mCP, Compound H50, and Compound H51:

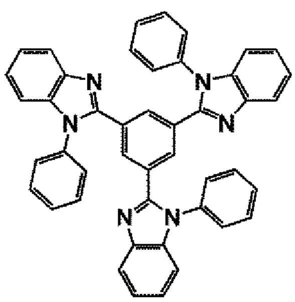

TPBi

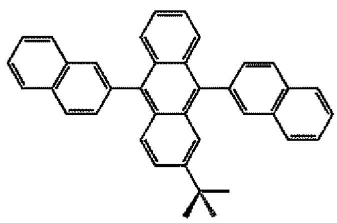

TBADN

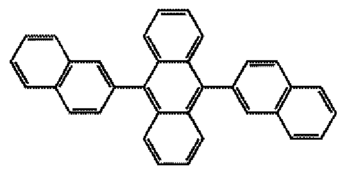

ADN

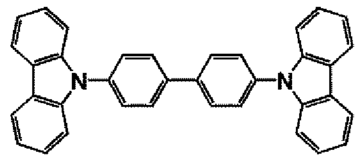

CBP

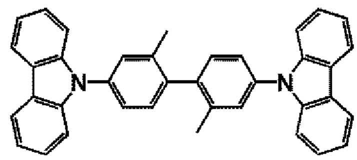

CDBP

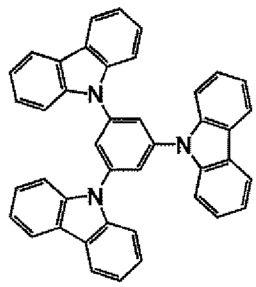

TCP

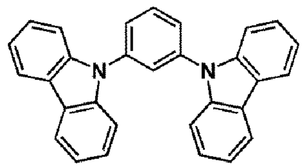

mCP

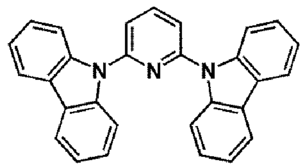

H50

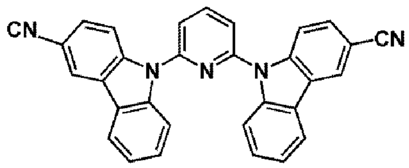

H51

In one or more embodiments, the host may further include a compound represented by Formula 301 below.

Formula 301

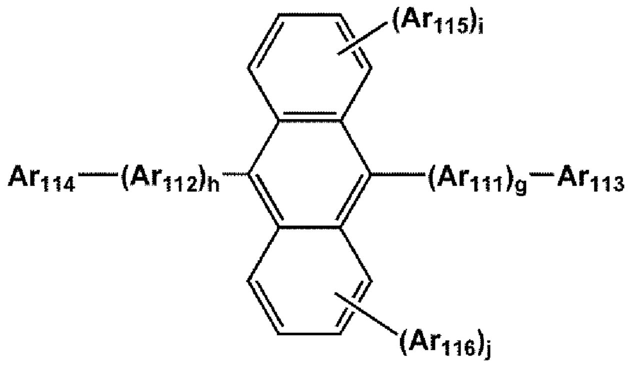

$Ar_{111}$ and $Ar_{112}$ in Formula 301 may each independently be selected from:

a phenylene group, a naphthylene group, a phenanthrenylene group, and a pyrenylene group; and
a phenylene group, a naphthylene group, a phenanthrenylene group, and a pyrenylene group, each substituted with at least one selected from a phenyl group, a naphthyl group, and an anthracenyl group.

$Ar_{113}$ to $Ar_{116}$ in Formula 301 may each independently be selected from:

a $C_1$-$C_{10}$ alkyl group, a phenyl group, a naphthyl group, a phenanthrenyl group, and a pyrenyl group; and
a phenyl group, a naphthyl group, a phenanthrenyl group, and a pyrenyl group, each substituted with at least one selected from a phenyl group, a naphthyl group, and an anthracenyl group.

g, h, i, and j in Formula 301 may each independently be an integer from 0 to 4, and may be, for example, 0, 1, or 2.
$Ar_{113}$ and $Ar_{116}$ in Formula 301 may each independently be selected from

a $C_1$-$C_{10}$ alkyl group, substituted with at least one selected from a phenyl group, a naphthyl group, and an anthracenyl group;
a phenyl group, a naphthyl group, an anthracenyl group, a pyrenyl, a phenanthrenyl group, and a fluorenyl group;
a phenyl group, a naphthyl group, an anthracenyl group, a pyrenyl group, a phenanthrenyl group, and a fluorenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group

or a salt thereof, a sulfonic acid group or a salt thereof, a phosphoric acid group or a salt thereof, a $C_1$-$C_{60}$ alkyl group, a $C_2$-$C_{60}$ alkenyl group, a C2-C60 alkynyl group, a C1-C60 alkoxy group, a phenyl group, a naphthyl group, an anthracenyl group, a pyrenyl group, a phenanthrenyl group, and a fluorenyl group; and

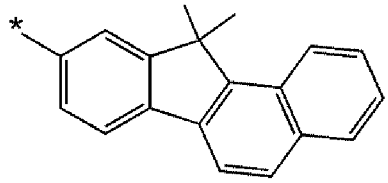

;

but embodiments of the present disclosure are not limited thereto.

In one or more embodiments, the host may include a compound represented by Formula 302 below:

Formula 302

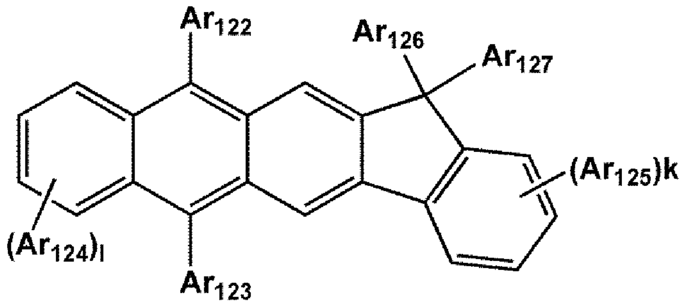

.

$Ar_{122}$ to $Ar_{125}$ in Formula 302 are the same as described in detail in connection with $Ar_{113}$ in Formula 301.

$Ar_{126}$ and $Ar_{127}$ in Formula 302 may each independently be a $C_1$-$C_{10}$ alkyl group (for example, a methyl group, an ethyl group, or a propyl group).

k and l in Formula 302 may each independently be an integer from 0 to 4. For example, k and l may be 0, 1, or 2.

When the organic light-emitting device is a full-color organic light-emitting device, the emission layer may be patterned into a red emission layer, a green emission layer, and a blue emission layer. In one or more embodiments, due to a stacked structure including a red emission layer, a green emission layer, and/or a blue emission layer, the emission layer may emit white light.

When the emission layer includes a host and a dopant, an amount of the dopant may be in a range of about 0.01 parts by weight to about 15 parts by weight based on 100 parts by weight of the host, but embodiments of the present disclosure are not limited thereto.

A thickness of the emission layer may be in a range of about 100 Å to about 1,000 Å, for example, about 200 Å to about 600 Å. While not wishing to be bound by theory, it is understood that when the thickness of the emission layer is within this range, excellent light-emission characteristics may be obtained without a substantial increase in driving voltage.

Then, an electron transport region may be located on the emission layer.

The electron transport region may include a hole blocking layer, an electron transport layer, an electron injection layer, or any combination thereof.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of BCP, Bphen, and BAlq but embodiments of the present disclosure are not limited thereto.

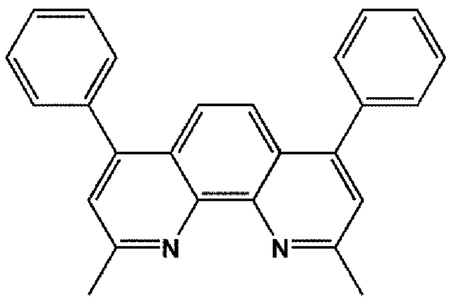

BCP

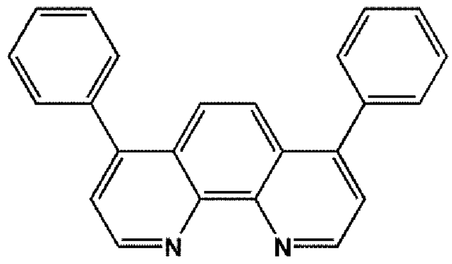

Bphen

A thickness of the hole blocking layer may be in a range of about 20 Å to about 1,000 Å, for example, about 30 Å to about 300 Å. While not wishing to be bound by theory, it is understood that when the thickness of the hole blocking layer is within these ranges, the hole blocking layer may have excellent hole blocking characteristics without a substantial increase in driving voltage.

The electron transport layer may further include at least one selected from BCP, Bphen, $Alq_3$, BAlq, TAZ, and NTAZ.

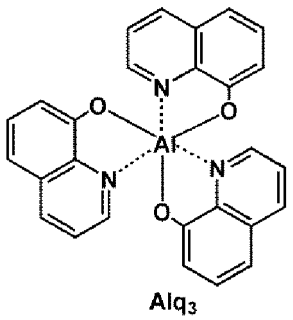

$Alq_3$

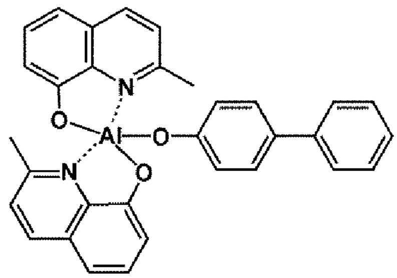

BAlq

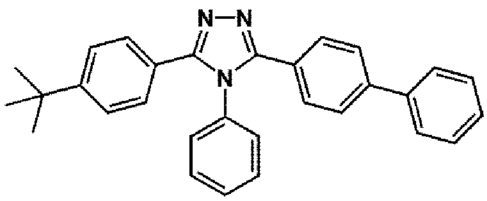

TAZ

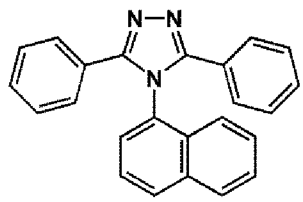

NTAZ

In one or more embodiments, the electron transport layer may include at least one of ET1 to ET25, but are not limited thereto:

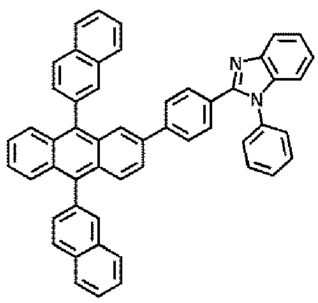

ET1

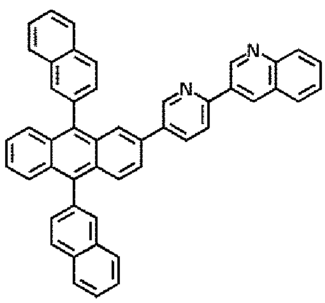

ET2

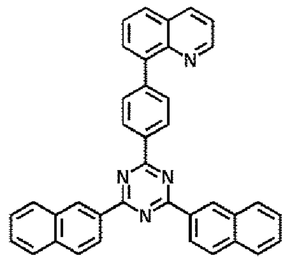

ET3

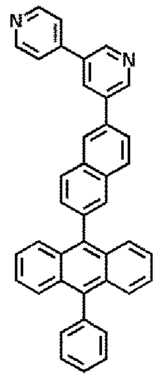

ET4

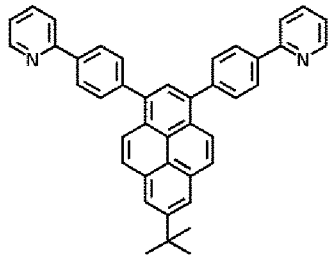

ET5

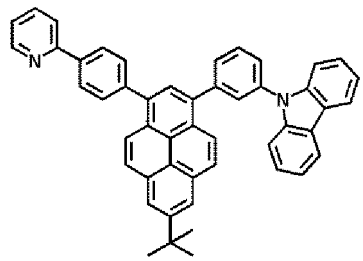

ET6

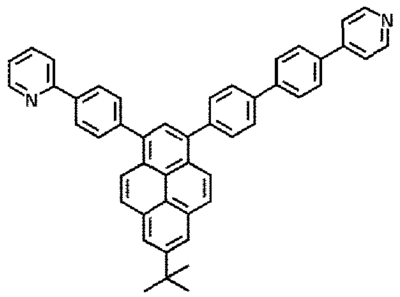

ET7

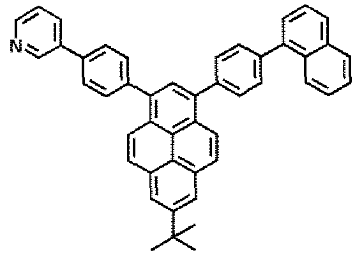

ET8

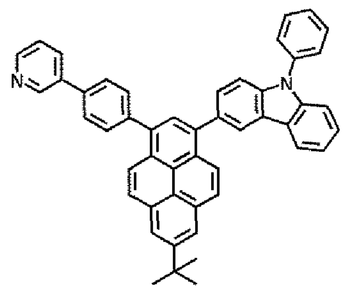

ET9

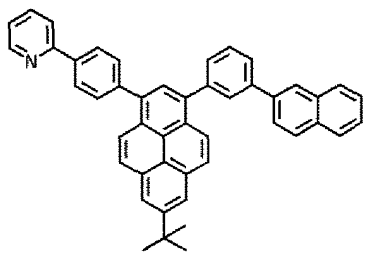

ET10

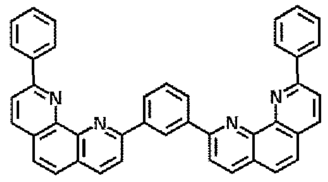

ET11

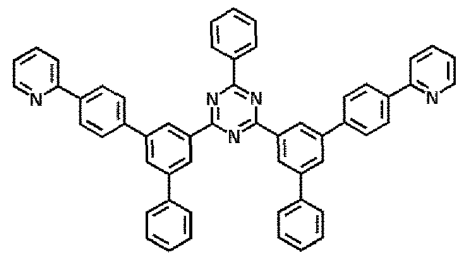

ET12

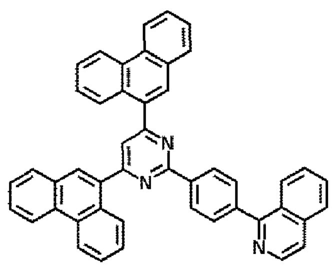

ET13

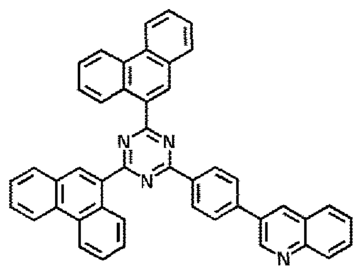

ET14

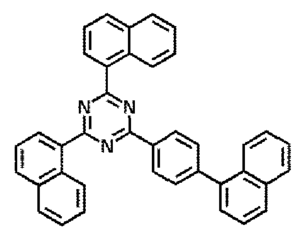

ET15

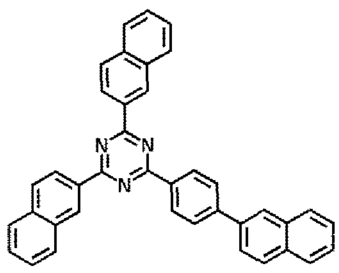

ET16

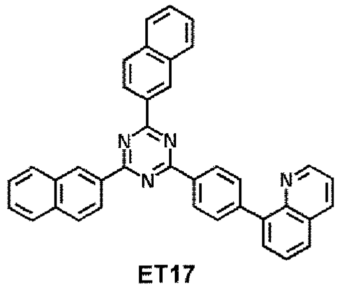

ET17

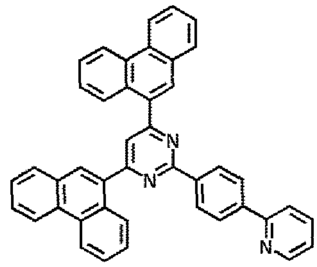

ET18

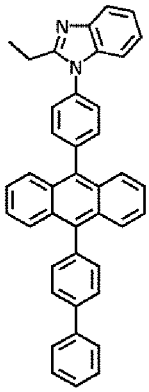

ET19

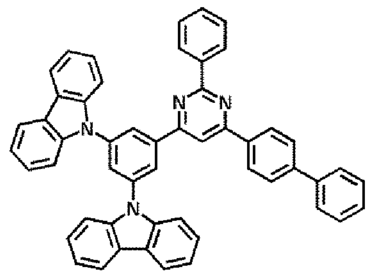

ET20

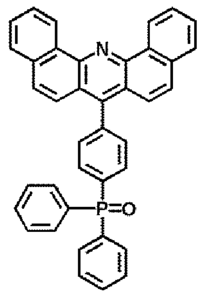

ET21

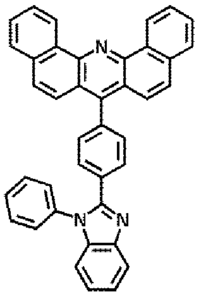

ET22

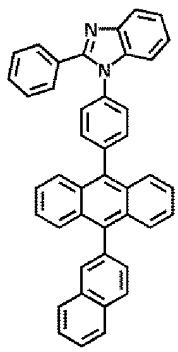

ET23

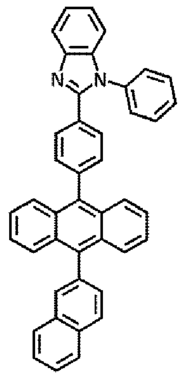

ET24

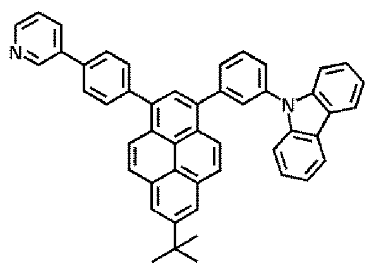

ET25

A thickness of the electron transport layer may be in a range of about 100 Å to about 1,000 Å, for example, about 150 Å to about 500 Å. While not wishing to be bound by theory, it is understood that when the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 (lithium 8-hydroxyquinolate, LiQ) or ET-D2.

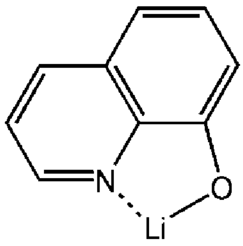

ET-D1

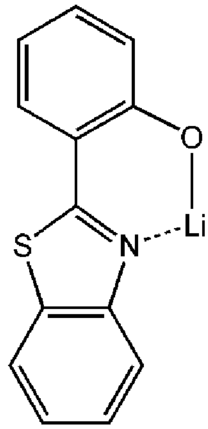

ET-D2

The electron transport region may include an electron injection layer (EIL) that promotes flow of electrons from the second electrode 19 thereinto.

The electron injection layer may include at least one selected from LiF, NaCl, CsF, $Li_2O$, and BaO.

A thickness of the electron injection layer may be in a range of about 1 Å to about 100 Å, and, for example, about 3 Å to about 90 Å. While not wishing to be bound by theory, it is understood that when the thickness of the electron injection layer is within the range described above, the electron injection layer may have satisfactory electron injection characteristics without a substantial increase in driving voltage.

The second electrode 19 is located on the organic layer 15. The second electrode 19 may be a cathode. A material for forming the second electrode 19 may be metal, an alloy, an electrically conductive compound, or a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be formed as the material for forming the second electrode 19. To manufacture a top-emission type light-emitting device, a transmissive electrode formed using ITO or IZO may be used as the second electrode 19.

Hereinbefore, the organic light-emitting device has been described with reference to the FIGURE, but embodiments of the present disclosure are not limited thereto.

Another aspect provides a diagnostic composition including at least one organometallic compound represented by Formula 1.

The organometallic compound represented by Formula 1 provides high luminescent efficiency. Accordingly, a diagnostic composition including the organometallic compound may have high diagnostic efficiency.

The diagnostic composition may be used in various applications including a diagnosis kit, a diagnosis reagent, a biosensor, and a biomarker.

The term "$C_1$-$C_{60}$ alkyl group" as used herein refers to a linear or branched saturated aliphatic hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an iso-amyl group, and a hexyl group. The term "$C_1$-$C_{60}$ alkylene group" as used herein refers to a divalent group having the same structure as that of the $C_1$-$C_{60}$ alkyl group.

The term "$C_1$-$C_{60}$ alkoxy group" as used herein refers to a monovalent group represented by $-OA_{101}$ (wherein $A_{101}$ is the $C_1$-$C_{60}$ alkyl group), and examples thereof include a methoxy group, an ethoxy group, and an iso-propyloxy group.

The term "$C_2$-$C_{60}$ alkenyl group" as used herein refers to a hydrocarbon group formed by including at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as that of the $C_2$-$C_{60}$ alkenyl group.

The term "$C_2$-$C_{60}$ alkynyl group" as used herein refers to a hydrocarbon group formed by including at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as that of the $C_2$-$C_{60}$ alkynyl group.

The term "$C_3$-$C_{10}$ cycloalkyl group" as used herein refers to a monovalent saturated hydrocarbon monocyclic group having 3 to 10 carbon atoms, and examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having the same structure as that of the $C_3$-$C_{10}$ cycloalkyl group.

The term "$C_1$-$C_{10}$ heterocycloalkyl group" as used herein refers to a monovalent saturated monocyclic group having at least one heteroatom selected from N, O, P, Si and S as a ring-forming atom and 1 to 10 carbon atoms, and non-limiting examples thereof include a tetrahydrofuranyl group, and a tetrahydrothiophenyl group. The term "$C_1$-$C_{10}$ heterocycloalkylene group" as used herein refers to a divalent group having the same structure as the $C_1$-$C_{10}$ heterocycloalkyl group.

The term "$C_3$-$C_{10}$ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, P, Si, and S as a ring-forming atom, 1 to 10 carbon atoms, and at least one double bond in its ring. Examples of the $C_1$-$C_{10}$ heterocycloalkenyl group are a 2,3-dihydrofuranyl group, and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Non-limiting examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other. The $C_7$-$C_{60}$ alkylaryl group refers to a $C_6$-$C_{60}$ aryl group substituted with at least one $C_1$-$C_{60}$ alkyl group.

The term "$C_1$-$C_{60}$ heteroaryl group" as used herein refers to a monovalent group having a heterocyclic aromatic system that has at least one heteroatom selected from N, O, P, Si, and S as a ring-forming atom, and 1 to 60 carbon atoms. The term "$C_1$-$C_{60}$ heteroarylene group" as used herein refers to a divalent group having a heterocyclic aromatic system that has at least one heteroatom selected from N, O, P, and S as a ring-forming atom, and 1 to 60 carbon atoms. Examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_6$-$C_{60}$ heteroaryl group and the $C_6$-$C_{60}$ heteroarylene group each include two or more rings, the rings may be fused to each other. The $C_2$-$C_{60}$ alkylheteroaryl group refers to a $C_1$-$C_{60}$ heteroaryl group substituted with at least one $C_1$-$C_{60}$ alkyl group.

The term "$C_6$-$C_{60}$ aryloxy group" as used herein indicates $-OA_{102}$ (wherein $A_{102}$ is the C6-C60 aryl group), the term "$C_6$-$C_{60}$ arylthio group" as used herein indicates $-SA_{103}$ (wherein $A_{103}$ is the $C_6$-$C_{60}$ aryl group), and the term "$C_7$-$C_{60}$ aryl alkyl group" as used herein indicates $-A_{104}A_{105}$ (wherein $A_{105}$ is the $C_6$-$C_{59}$ aryl group and $A_{104}$ is the $C_1$-$_{C53}$ alkylene group).

The term "$C_1$-$C_{60}$ heteroaryloxy group" as used herein refers to $-OA_{106}$ (wherein $A_{106}$ is the C2-C60 heteroaryl group), the term "$C_1$-$C_{60}$ heteroarylthio group" as used herein indicates $-SA_{107}$ (wherein $A_{107}$ is the $C_1$-$C^{60}$ heteroaryl group), and the term "C2-C60 heteroarylalkyl group" as used herein refers to $-A_{108}A_{109}$ ($A_{109}$ is a $C_1$-$C_{59}$ heteroaryl group, and $A_{108}$ is a $C_1$-$C_{59}$ alkylene group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, a heteroatom selected from N, O, P, Si, and S, other than carbon atoms, as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "$C_5$-$C_{30}$ carbocyclic group" as used herein refers to a saturated or unsaturated cyclic group having, as a ring-forming atom, 5 to 30 carbon atoms only. The $C_5$-$C_{30}$ carbocyclic group may be a monocyclic group or a polycyclic group.

The term "$C_1$-$C_{30}$ heterocyclic group" as used herein refers to a saturated or unsaturated cyclic group having, as a ring-forming atom, at least one heteroatom selected from N, O, Si, P, and S other than 1 to 30 carbon atoms. The $C_1$-$C_{30}$ heterocyclic group may be a monocyclic group or a polycyclic group.

at least one of substituents of the substituted $C_5$-$C_{30}$ carbocyclic group, substituted $C_1$-$C_{30}$ heterocyclic group, substituted $C_1$-$C_{60}$ alkyl group, substituted C2-C60 alkenyl group, substituted $C_2$-$C_{60}$ alkynyl group, substituted

$C_1$-$C_{60}$ alkoxy group, substituted $C_3$-$C_{10}$ cycloalkyl group, substituted $C_1$-$C_{10}$ heterocycloalkyl group, substituted $C_3$-$C_{10}$ cycloalkenyl group, substituted $C_1$-$C_{10}$ heterocycloalkenyl group, substituted $C_6$-$C_{60}$ aryl group, substituted $C_7$-$C_{60}$ alkylaryl group, substituted C6-C60 aryloxy group, substituted $C_6$-$C_{60}$ arylthio group, substituted $C_7$-$C_{60}$ arylalkyl group, substituted $C_1$-$C_{60}$ heteroaryl group, substituted $C_1$-$C_{60}$ heteroaryloxy group, substituted $C_1$-$C_{60}$ heteroarylthio group, substituted $C_2$-$C_{60}$ heteroarylalkyl group, substituted $C_2$-$C_{60}$ alkylheteroaryl group, substituted monovalent non-aromatic condensed polycyclic group, and substituted monovalent non-aromatic condensed heteropolycyclic group is selected from:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkylaryl group, a $C_6$-$C_{60}$ aryloxy group, a $C_6$-C60 arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a $C_2$-$C_{60}$ alkylheteroaryl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-B(Q_{16})(Q_{17})$, and $-P(=O)(Q_{18})(Q_{19})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkylaryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a $C_2$-$C_{60}$ alkylheteroaryl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkylaryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a $C_2$-$C_{60}$ alkylheteroaryl group, a monovalent non-aromatic condensed polycyclic group, and a monovalent non-aromatic condensed heteropolycyclic group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkylaryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a $C_2$-$C_{60}$ alkylheteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-B(Q_{26})(Q_{27})$, and$-P(=O)(Q_{28})(Q_{29})$; and

$-N(Q_{31})(Q_{32})$, $-Si(Q_{33})(Q_{34})(Q_{35})$, $-B(Q_{36})(Q_{37})$, and $-P(=O)(Q_{38})(Q_{39})$;

wherein $Q_1$ to $Q_9$, $Q_{11}$ to $Q_{19}$, $Q_{21}$ to $Q_{29}$, and $Q_{31}$ to $Q_{39}$ may each independently be selected from hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_1$-$C_{60}$ alkyl group substituted with at least one selected from deuterium, a $C_1$-$C_{60}$ alkyl group, and a $C_6$-$C_{60}$ aryl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from deuterium, a $C_1$-$C_{60}$ alkyl group, and a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a $C_2$-$C_{60}$ alkylheteroaryl group, a monovalent non-aromatic condensed polycyclic group, and a monovalent non-aromatic condensed heteropolycyclic group.

Hereinafter, a compound and an organic light-emitting device according to embodiments are described in detail with reference to Synthesis Example and Examples. However, the organic light-emitting device is not limited thereto. The wording "B was used instead of A" used in describing Synthesis Examples means that an amount of A used was identical to an amount of B used, in terms of a molar equivalent.

EXAMPLES

Synthesis Example 1: Synthesis of Compound 3

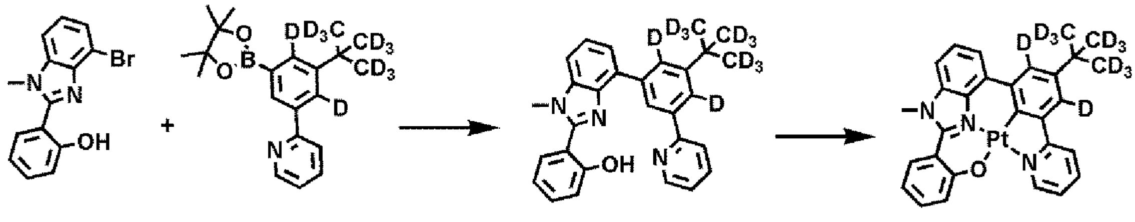

3-A 3-B 3-C 3

Synthesis of Intermediate 3-C

2 grams (g) (6.60 millimoles, mmol) of starting material 3-A, 2.53 g (7.26 mmol, 1.1 equivalents, equiv.) of starting material 3-B, 0.53 g (0.46 mmol, 0.07 equiv.) of tetrakis(triphenylphosphine)palladium (0)), and 2.74 g (19.79 mmol, 3 equiv.) of potassium carbonate were mixed with 48 mL of a mixture including tetrahydrofuran (THF) and $H_2O$ at a ratio of 3:1, and the resulting mixture was refluxed overnight. The obtained resultant was cooled to room temperature, and the precipitate was removed therefrom to obtain a filtrate. The filtrate was washed with ethylene acetate (EA)/$H_2O$, and purified by column chromatography to produce 1.7 g (yield of 78%) of Intermediate 3-C. The obtained compound was identified by LC-MS.
LC-MS m/z = 444.28 $(M+H)^+$

Synthesis of Compound 3

1.5 g (3.37 mmol) of Intermediate 3-C and 1.68 g (4.05 mmol, 1.2 equiv.) of $K_2PtCl_4$ were mixed with a mixture including 80 mL of AcOH (acetic acid) and 4 mL of $H_2O$, and then the resulting mixture was refluxed overnight. The obtained resultant was cooled to room temperature and filtered to obtain the precipitate, which was then mixed with methylene chloride (MC) and washed with $H_2O$, and purified by column chromatography to produce 1.1 g (yield 51%) of Compound 3. The obtained compound was identified by LC-MS.
LC-MS m/z = 637.23 $(M+H)^+$

Synthesis Example 2: Synthesis of Compound 17

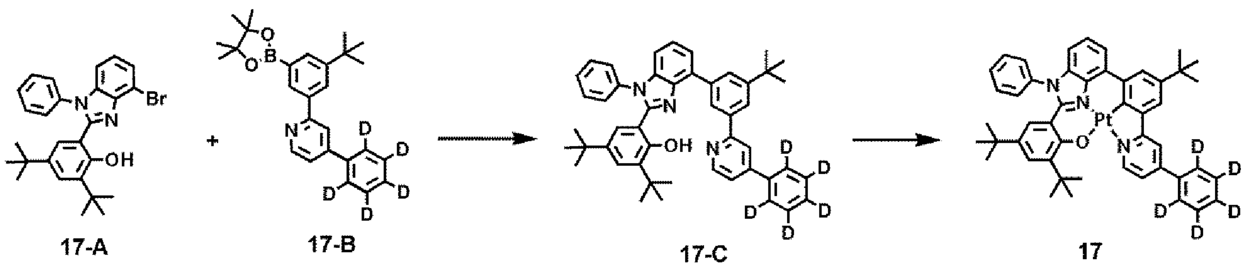

17-A 17-B 17-C 17

Synthesis of Intermediate 17-C

2 g (4.19 mmol) of starting material 17-A, 1.93 g (4.61 mmol, 1.1 equiv.) of starting material 17-B, 0.34 g (0.29 mmol, 0.07 equiv.) of tetrakis(triphenylphosphine)palladium (0), and 1.74 g (12.57 mmol, 3 equiv.) of potassium carbonate were mixed with 30 mL of a mixture including THF and $H_2O$ at a ratio of 3:1, and the resulting mixture was refluxed overnight. The obtained resultant was cooled to room temperature, and the precipitate was removed therefrom to obtain a filtrate. The filtrate was washed with EA/$H_2O$, and purified by column chromatography to produce 1.9 g (yield 66%) of Intermediate 17-C. The obtained compound was identified by LC-MS.

LC-MS m/z = 688.42 $(M+H)^+$

Synthesis of Compound 17

1.8 g (2.61 mmol) of Intermediate 17-C and 1.3 g (3.14 mmol, 1.2 equiv.) of $K_2PtCl_4$ were mixed with a mixture including 65 mL of AcOH and 3 mL of $H_2O$, and the resulting mixture was refluxed overnight. The obtained resultant was cooled to room temperature and filtered to obtain the precipitate, which was then mixed with MC and washed with $H_2O$, and purified by column chromatography to produce 1.41g (yield of 61%) of Compound 17. The obtained compound was identified by LC-MS.
LC-MS m/z = 881.37 $(M+H)^+$

Synthesis Example 3: Synthesis of Compound 24

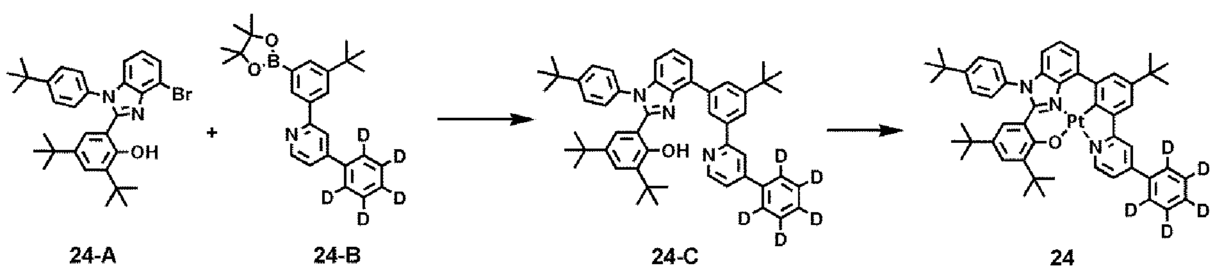

24-A 24-B 24-C 24

Synthesis of Intermediate 24-C

2 g (3.75 mmol) of starting material 24-A, 1.73 g (4.12 mmol, 1.1 equiv.) of starting material 24-B, 0.30 g (0.26 mmol, 0.07equiv.) of tetrakis(triphenylphosphine)palladium (0), and 1.82 g (11.25 mmol, 3 equiv.) of potassium carbonate were mixed with 27 mL of a mixture including THF and $H_2O$ at a ratio of 3:1, and the resulting mixture was refluxed overnight. The obtained resultant was cooled to room temperature, and the precipitate was removed therefrom to obtain a filtrate. The filtrate was washed with EA/$H_2O$, and purified by column chromatography to produce 1.9 g (yield 68%) of Intermediate 24-C. The obtained compound was identified by LC-MS.
LC-MS m/z = 744.48 $(M+H)^+$

Synthesis of Compound 24

1.7 g (2.28 mmol) of Intermediate 24-C and 1.3 g (3.14 mmol, 1.2 equiv.) of $K_2PtCl_4$ were mixed with a mixture including 57 mL of AcOH and 3 mL of $H_2O$, and the resulting mixture was refluxed overnight. The obtained resultant was cooled to room temperature and filtered to obtain the precipitate, which was then mixed with MC and washed with $H_2O$, and purified by column chromatography to produce 1.41g (yield of 65%) of Compound 24. The obtained compound was identified by LC-MS.
LC-MS m/z = 937.43 $(M+H)^+$

Synthesis Example 4: Synthesis of Compound 27

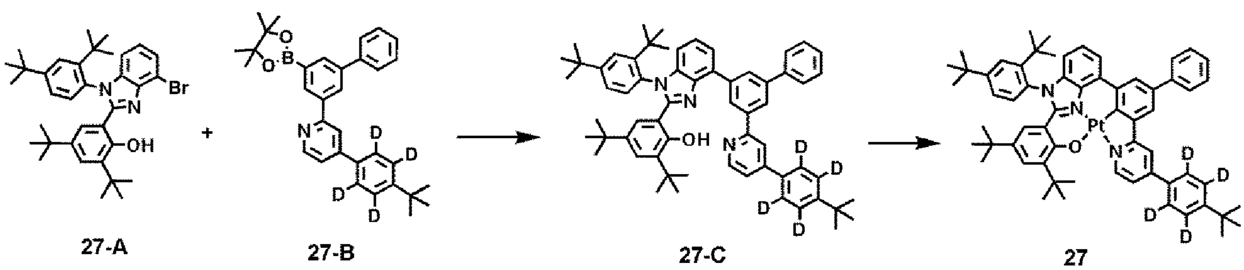

27-A 27-B 27-C 27

Synthesis of Intermediate 27-C

2 g (3.39 mmol) of starting material 27-A, 1.84 g (3.73 mmol, 1.1 equiv.) of starting material 27-B, 0.27 g (0.24 mmol, 0.07 equiv.) of tetrakis(triphenylphosphine)palladium (0), and 1.41 g (10.18 mmol, 3 equiv.) of potassium carbonate were mixed with 27 mL of a mixture including THF and $H_2O$ at a ratio of 3:1, and the resulting mixture was refluxed overnight. The obtained resultant was cooled to room temperature, and the precipitate was removed therefrom to obtain a filtrate. The filtrate was washed with EA/$H_2O$, and purified by column chromatography to produce 2.2 g (yield of 74%) of Intermediate 27-C. The obtained compound was identified by LC-MS.
LC-MS m/z = 875.57 $(M+H)^+$

Synthesis of Compound 27

1.5 g (1.71 mmol) of Intermediate 27-C and 0.85 g (3.14 mmol, 1.2 equiv.) of $K_2PtCl_4$ were mixed with a mixture including 43 mL of AcOH and 2 mL of $H_2O$, and the resulting mixture was refluxed overnight. The obtained resultant was cooled to room temperature and filtered to obtain the precipitate, which was then mixed with MC and washed with $H_2O$, and purified by column chromatography to produce 1.1 g (yield of 60%) of Compound 27. The obtained compound was identified by LC-MS.
LC-MS m/z = 1068.52 $(M+H)^+$

Synthesis Example 5: Synthesis of Compound 31

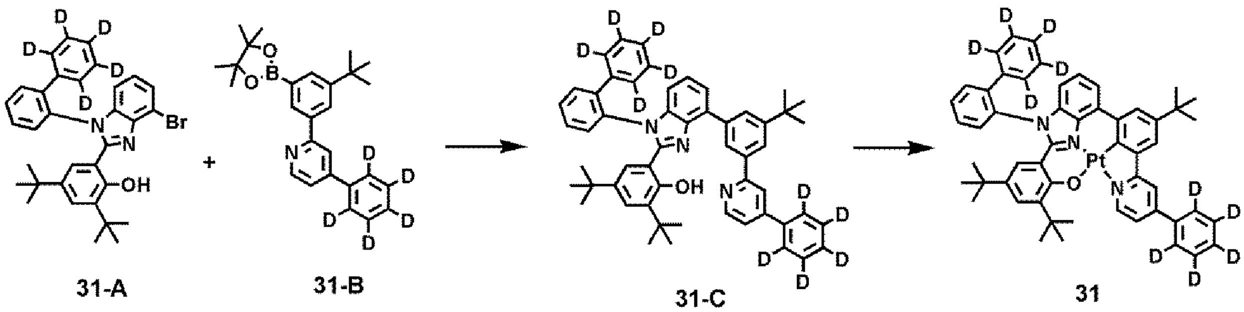

31-A 31-B 31-C 31

Synthesis of Intermediate 31-C

2 g (3.58 mmol) of starting material 31-A, 1.65 g (3.73 mmol, 1.1 equiv.) of starting material 31-B, 0.29 g (0.25 mmol, 0.07 equiv.) of tetrakis(triphenylphosphine)palladium (0), and 1.48 g (10.74 mmol, 3 equiv.) of potassium carbonate were mixed with 26 mL of a mixture including THF and $H_2O$ at a ratio of 3:1, and the resulting mixture was refluxed overnight. The obtained resultant was cooled to room temperature, and the precipitate was removed therefrom to obtain a filtrate. The filtrate was washed with EA/$H_2O$, and purified by column chromatography to produce 1.8 g (yield of 65%) of Intermediate 31-C. The obtained compound was identified by LC-MS.
LC-MS m/z = 769.48 $(M+H)^+$

Synthesis of Compound 31

1.7 g (2.21 mmol) of Intermediate 31-C and 1.1 g (2.65 mmol, 1.2 equiv.) of $K_2PtCl_4$ were mixed with a mixture including 55 mL of AcOH and 3 mL of $H_2O$, and the resulting mixture was refluxed overnight. The obtained resultant was cooled to room temperature and filtered to obtain the precipitate, which was then mixed with MC and washed with $H_2O$, and purified by column chromatography to produce 1.2 g (yield of 56%) of Compound 31. The obtained compound was identified by LC-MS.
LC-MS m/z = 962.43 $(M+H)^+$

**Synthesis Example 6: Synthesis of Compound 99**

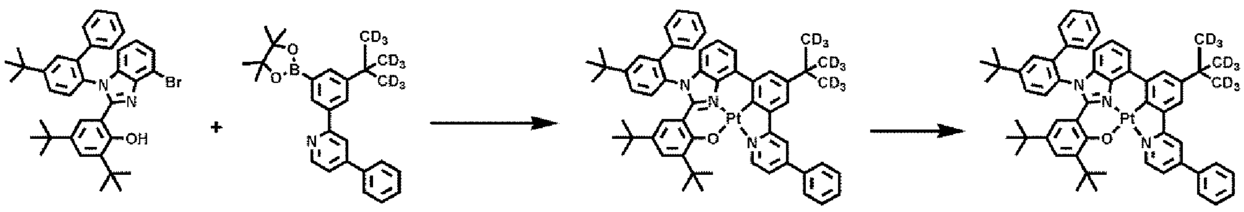

99-A 99-B 99-C 99

Synthesis of Intermediate 99-C

2 g (3.28 mmol) of starting material 99-A, 1.52 g (3.61 mmol, 1.1equiv.) of starting material 99-B, 0.27 g(0.23 mmol, 0.07 equiv.) of tetrakis(triphenylphosphine)palladium(0), and 1.36 g (9.84 mmol, 3 equiv.) of potassium carbonate were mixed with 36 mL of a mixture including THF and $H_2O$ at a ratio of 3:1, and the resultant mixture was refluxed over night. The obtained result was cooled to room temperature, and then, the precipitate was removed therefrom to obtain a filtrate. The filtrate was washed with EA/$H_2O$, and column chromatography was performed thereon to complete the production of 2.1 g (yield of 78%) of Intermediate 99-C. The obtained compound was identified by LC-MS.
LC-MS m/z = 824.54 $(M+H)^+$

Synthesis of Compound 99

2 g (2.42 mmol) of Intermediate 99-C and 1.21 g (2.91 mmol, 1.2 equiv.) of $K_2PtCl_4$ were mixed with a mixture including61 mL of AcOH and 3 mL of $H_2O$, and the resultant mixture was refluxed overnight. The obtained result was cooled to room temperature and filtered to obtain the precipitate, which was then mixed with MC and washed with $H_2O$, and column chromatography was performed thereon to complete the production of 1.3 g (yield of 53%) of Compound 99. The obtained compound was identified by LC-MS.
LC-MS m/z = 1017.49 $(M+H)^+$

Synthesis Example 7: Synthesis of Compound 157

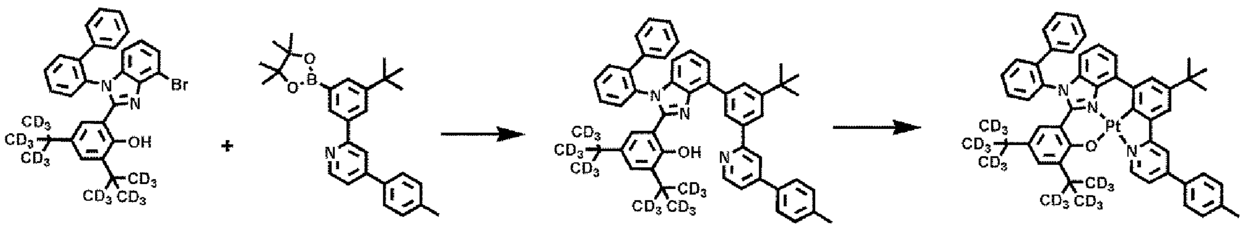

157-A 157-B 157-C 157

Synthesis of Intermediate 157-C

2 g (3.5 mmol) of starting material 157-A, 1.64 g (3.85 mmol, 1.1 equiv.) of starting material 157-B, 0.28 g (0.24 mmol, 0.07 equiv.) of tetrakis(triphenylphosphine)palladium(0), and 1.45 g (10.50 mmol, 3 equiv.) of potassium carbonate were mixed with 38 mL of a mixture including THF and $H_2O$ at a ratio of 3:1, and the resultant mixture was refluxed overnight. The obtained result was cooled to room temperature, and then, the precipitate was removed therefrom to obtain a filtrate. The filtrate was washed with EA/$H_2O$, and column chromatography was performed thereon to complete the production of 2.1 g (yield of 76%) of Intermediate 157-C. The obtained compound was identified by LC-MS.
LC-MS m/z = 791.55 $(M+H)^+$

Synthesis of Compound 157

2 g (2.52 mmol) of Intermediate 157-C 1.26 g (3.03 mmol, 1.2 equiv.) of $K_2PtCl_4$ were mixed with a mixture including 63 mL of AcOH and 3 mL of $H_2O$, and the resultant mixture was refluxed overnight. The obtained result was cooled to room temperature and filtered to obtain the precipitate, which was then mixed with MC and washed with $H_2O$,

and column chromatography was performed thereon to complete the production of 1.2 g (yield of 48%) of Compound 157. The obtained compound was identified by LC-MS.
LC-MS m/z = 984.50 $(M+H)^+$

Synthesis Example 8: Synthesis of Compound 186

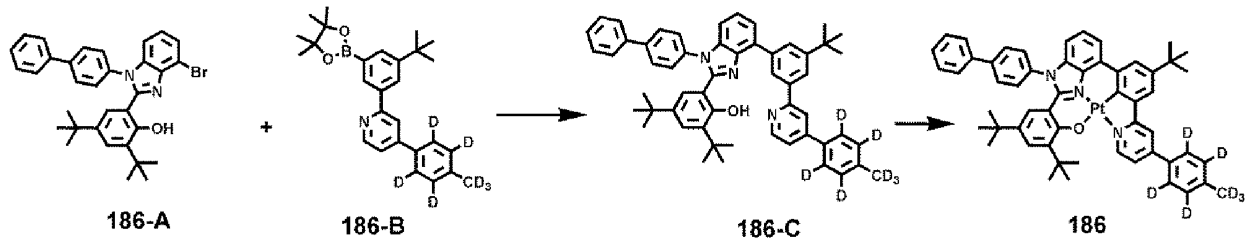

186-A 186-B 186-C 186

Synthesis of Intermediate 186-C

2 g (3.61 mmol) of starting material 186-A, 1.73 g (3.97 mmol, 1.1equiv.) of starting material 186-B, 0.29 g (0.25 mmol, 0.07 equiv.) of tetrakis(triphenylphosphine)palladium(0), and 1.50 g (10.84 mmol, 3 equiv.) of potassium carbonate were mixed with a mixture including THF and $H_2O$ at a ratio of 3:1, and the resultant mixture was refluxed overnight. The obtained result was cooled to room temperature, and then, the precipitate was removed therefrom to obtain a filtrate. The filtrate was washed with EA/$H_2O$, and column chromatography was performed thereon to complete the production of 1.8 g (yield of 64%) of Intermediate 186-C. The obtained compound was identified by LC-MS.
LC-MS m/z = 780.48 $(M+H)^+$

Synthesis of Compound 186

1.5 g (1.92 mmol) of Intermediate 186-C and 0.96 g (2.3 mmol, 1.2 equiv.) of $K_2PtCl_4$ were mixed with a mixture including 48 mL of AcOH and 3 mL of $H_2O$, and the resultant mixture was refluxed overnight. The obtained result was cooled to room temperature and filtered to obtain the precipitate, which was then mixed with MC and washed with $H_2O$, and column chromatography was performed thereon to complete the production of 0.8 g (yield of 43%) of Compound 186. The obtained compound was identified by LC-MS.
LC-MS m/z = 973.43 $(M+H)^+$

Synthesis Example 9: Synthesis of Compound 448

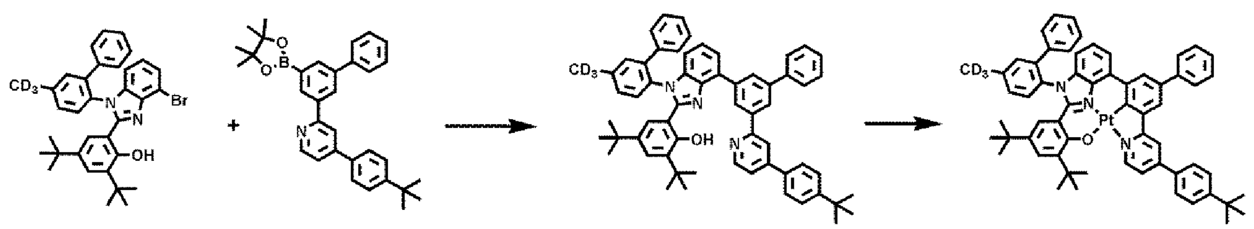

448-A 448-B 448-C 448

Synthesis of Intermediate 448-C

2 g (3.51 mmol) of starting material 448-A, 1.89 g (3.86 mmol, 1.1equiv.) of starting material 448-B, 0.28 g (0.25 mmol, 0.07equiv.) of tetrakis(triphenylphosphine)palladium(0), and 1.45 g (10.52 mmol, 3 equiv.) of potassium carbonate were mixed with 38 mL of a mixture including THF and $H_2O$ at a ratio of 3:1, and the resultant was refluxed overnight. The obtained result was cooled to room temperature, and then, the precipitate was removed therefrom to obtain a filtrate. The filtrate was washed with EA/$H_2O$, and column chromatography was performed thereon to complete the production of 2.0 g (yield of 73%) of Intermediate 448-C. The obtained compound was identified by LC-MS.

LC-MS m/z = 852.48 (M+H)+

Synthesis of Compound 448

1.8 g (2.11 mmol) of Intermediate 448-C and 1.05 g (2.53 mmol, 1.2 equiv.) of $K_2PtCl_4$ were mixed with a mixture including 53 mL of AcOH and 3 mL of $H_2O$, and the resultant mixture was refluxed overnight. The obtained result was cooled to room temperature and filtered to obtain the precipitate, which was then mixed with MC and washed with $H_2O$, and column chromatography was performed thereon to complete the production of 1.1 g (yield of 50%) of Compound 448. The obtained compound was identified by LC-MS.
LC-MS m/z = 1045.43 (M+H)+

Evaluation Example 1: Evaluation of photoluminescence quantum yields (PLQY)

PMMA in $CH_2Cl_2$ solution, 5 percent by weight (wt%) of CBP, and Compound 3 were mixed, and the resultant was coated on a quartz substrate by using a spin coater, and then, heat-treated in an oven at a temperature of 80°C, and cooled to room temperature to obtain a film.
The PLQY of Compound 3 in film was evaluated by using a Hamamatsu Photonics absolute PL quantum yield measurement system equipped with a xenon light source, a monochromator, a photonic multichannel analyzer, and an integrating sphere, and using PLQY measurement software (Hamamatsu Photonics, Ltd., Shizuoka, Japan), and the same experiment was performed on each of Compounds 17, 24, 27 and 31. Results thereof are shown in Table 2.

Table 2

| Compound No. | PLQY |
|---|---|
| 3 | 0.978 |
| 17 | 0.999 |
| 24 | 0.998 |
| 27 | 0.999 |
| 31 | 0.999 |
| 99 | 0.993 |
| 157 | 0.986 |
| 186 | 0.999 |
| 448 | 0.985 |

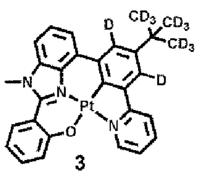
3

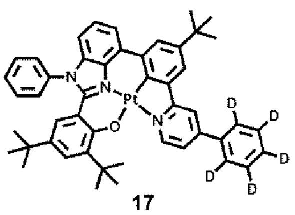
17

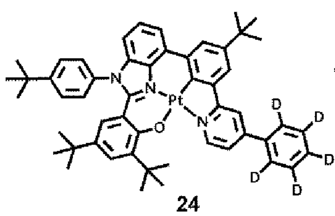
24

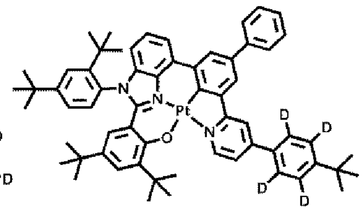
27

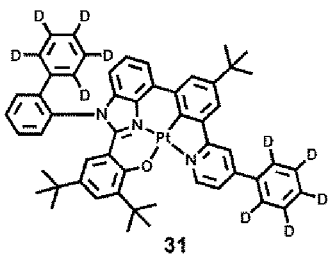
31

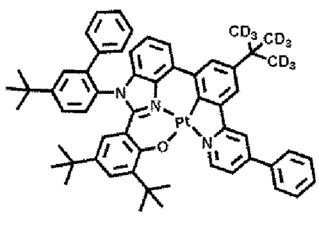
99

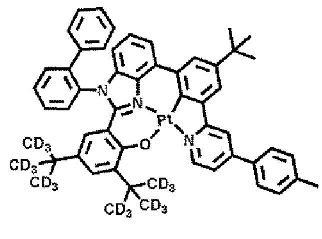
157

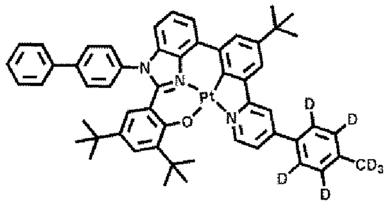

186

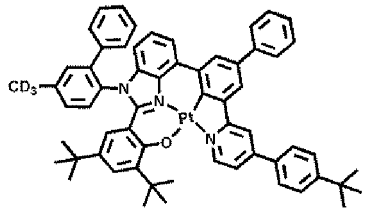

448

From Table 2, it was confirmed that Compounds 3, 17, 24, 27, 31, 99, 157, 186 and 448 had high PLQY (in film).

Evaluation Example 2: Decay time measurement

A quartz substrate washed with chloroform and pure water was prepared, and then, a predetermined material shown in Table 3 was vacuum-(co)deposited at a degree of vacuum of $10^{-7}$ torr (wherein 1 torr = 133.322 Pa) to prepare Films 1 to 5 having a thickness of 50 nanometers (nm).

Table 3

| Film name | Compound used in film production |
|---|---|
| Film 1 | CBP : Compound 3 (weight ratio of 9 : 1) |
| Film 2 | CBP : Compound 17 (weight ratio of 9 : 1) |
| Film 3 | CBP : Compound 24 (weight ratio of 9 : 1) |
| Film 4 | CBP : Compound 27 (weight ratio of 9 : 1) |
| Film 5 | CBP : Compound 31 (weight ratio of 9 : 1) |
| Film 6 | CBP : Compound 99 (weight ratio of 9 : 1) |
| Film 7 | CBP : Compound 157 (weight ratio of 9 : 1) |
| Film 8 | CBP : Compound 186 (weight ratio of 9 : 1) |
| Film 9 | CBP : Compound 448 (weight ratio of 9 : 1) |

Photoluminescence (PL) spectrum of each of Films 1 to 9 was measured by using FluoTime 300, which is a TRPL measurement system manufactured by PicoQuant Inc. and PLS340 (excitation wavelength = 340 nanometers, spectral width = 20 nanometers), which is a pumping source of PicoQuant Inc. at room temperature. Then, the main peak of each spectrum was identified, and the number of photons emitted at the wavelength of photon pulse (pulse width = 500 picoseconds) applied by PLS340 to each of Films 1 to 5 was repeatedly measured based on time-correlated single photon counting (TCSPC) according to time, thereby obtaining a TRPL curve sufficient for fitting. The obtained result was fitted with two or more exponential decay functions to obtain $T_{decay}$ ($E_x$), that is, decay time of each of Films 1 to 9 (decay time). Results obtained therefrom were shown in Table 4. A function for fitting is as shown in Equation 1, and from among $T_{decay}$ values obtained from each exponential decay function used for fitting, the largest $T_{decay}$ was obtained as $T_{decay}$ ($E_x$). In this regard, the same measurement was performed during the same measurement time as that for obtaining TRPL curve in the dark state (in which pumping signals entering a film are blocked) to obtain a baseline or a background signal curve for use as a baseline for fitting.

$$\text{Equation 1} \; f(t) = \sum_{i=1}^{n} A_i \, exp\left(-t/T_{decay,i}\right)$$

Table 4

| Film name | Decay time ($\mu$s) |
|---|---|
| Film 1 (Compound 3) | 2.340 |
| Film 2 (Compound 17) | 2.081 |

(continued)

| Film name | Decay time ($\mu$s) |
| --- | --- |
| Film 3 (Compound 24) | 2.010 |
| Film 4 (Compound 27) | 2.174 |
| Film 5 (Compound 31) | 2.002 |
| Film 6 (Compound 99) | 2.228 |
| Film 7 (Compound 157) | 2.470 |
| Film 8 (Compound 186) | 2.323 |
| Film 9 (Compound 448) | 2.371 |

From Table 4, it was confirmed that Compounds 3, 17, 24, 27, 31, 99, 157, 186 and 448 had excellent decay time characteristics.

Example 1

An ITO glass substrate was cut to a size of 50 mm x 50 mm x 0.5 mm (mm = millimeter) and then, sonicated in acetone iso-propyl alcohol and pure water, each for 15 minutes, and then, washed by exposure to UV ozone for 30 minutes.

Then, m-MTDATA was deposited on an ITO electrode (anode) of the glass substrate at a deposition speed of 1 Angstroms per second (A/sec) to form a hole injection layer having a thickness of 600 Angstroms (Å), and then, $\alpha$-NPD (NPB) was deposited on the hole injection layer at a deposition speed of 1 A/sec to form a hole transport layer having a thickness of 250 Å.

Compound 3 (dopant) and CBP (host) were co-deposited on the hole transport layer at a deposition speed of 0.1 A/sec and a deposition speed of 1 A/sec, respectively, to form an emission layer having a thickness of 400 Å.

BAlq was deposited on the emission layer at a deposition speed of 1 A/sec to form a hole blocking layer having a thickness of 50 Å, and $Alq_3$ was deposited on the hole blocking layer to form an electron transport layer having a thickness of 300 Å, and then, LiF was deposited on the electron transport layer to form an electron injection layer having a thickness of 10 Å, and then, Al was vacuum deposited on the electron injection layer to form a second electrode (cathode) having a thickness of 1,200 Å, thereby completing manufacturing of an organic light-emitting device having a structure of ITO / m-MTDATA (600 Å)/$\alpha$-NPD (250 Å)/CBP + Compound 3 (10%) (400 Å)/BAlq (50 Å)/$Alq_3$(300 Å)/LiF (10 Å)/Al(1,200 Å).

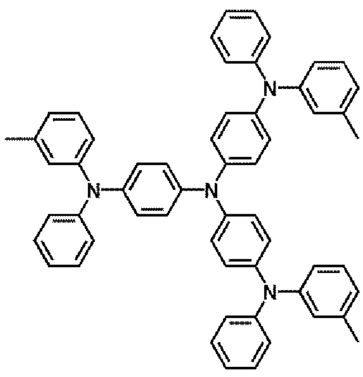

m-MTDATA

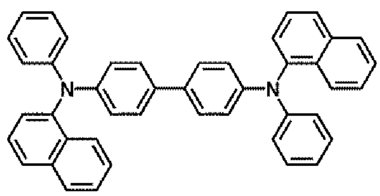

NPB

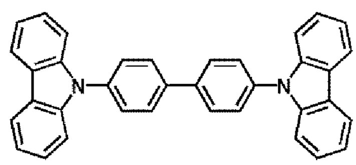

CBP

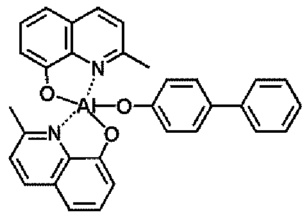

BAlq

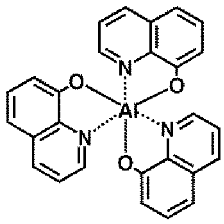

Alq3

Examples 2 to 9 and Comparative Examples A to C

Organic light-emitting devices were manufactured in the same manner as in Example 1, except that in forming an emission layer, for use as a dopant, corresponding compounds shown in Table 5 were used instead of Compound 3.

Evaluation Example 3: Evaluation on characteristics of organic light-emitting devices.

The driving voltage, the luminescence quantum efficiency, the roll-off ratio, and the lifespan ($T_{95}$) of each of the organic light-emitting devices manufactured according to Examples 1 to 9 and Comparative Examples A to C were evaluated. Results thereof are shown in Table 5. This evaluation was performed using a current-voltage meter (Keithley 2400) and a luminescence meter (Minolta Cs-1,000A), and the lifespan ($T_{95}$)(at 6000 nit) was evaluated by measuring the amount of time that elapsed until luminance was reduced to 95% of the initial brightness of 100%. The lifespan ($T_{95}$)(at 6000 nit) was represented as a relative value (%) in Table 5. The roll-off ratio was calculated by the following equation:

Equation 20

Roll off ratio = {1- (efficiency (at 9,000 nit) / maximum luminescent efficiency)} X 100%

Table 5

| No. | Dopant Compound No. | Driving Voltage (V) | Luminescent quantum Efficiency (%) | Roll-off ratio (%) | Lifespan (Relative value, %) ($T_{95}$) |
|---|---|---|---|---|---|
| Example 1 | 3 | 4.12 | 19.9 | 10 | 15.8 % |
| Example 2 | 17 | 4.08 | 23.2 | 9 | 20.1 % |
| Example 3 | 24 | 4.11 | 24.7 | 8 | 21.5 % |
| Example 4 | 27 | 3.85 | 23.3 | 9 | 32.4 % |
| Example 5 | 31 | 3.97 | 22.8 | 8 | 23.0 % |
| Example 6 | 99 | 4.19 | 25.0 | 4 | 35.3% |
| Example 7 | 157 | 3.97 | 26.5 | 7 | 38.3% |
| Example 8 | 186 | 4.08 | 26.2 | 8 | 20.7% |
| Example 9 | 448 | 3.86 | 26.5 | 7 | 34.9% |
| Comparative Example A | A | 4.54 | 17.8 | 11 | 4.2 % |
| Comparative Example B | B | 5.8 | 14.3 | 14 | 7.7 % |
| Comparative Example C | C | 5.7 | 10.2 | 12 | 3.0 % |

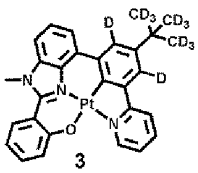
3

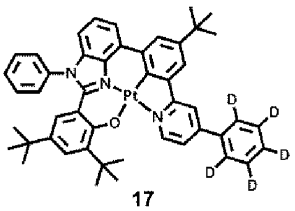
17

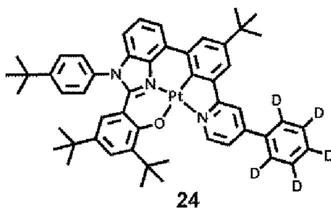
24

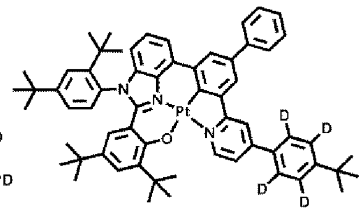
27

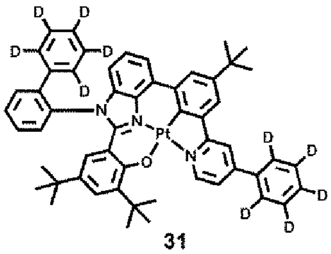
31

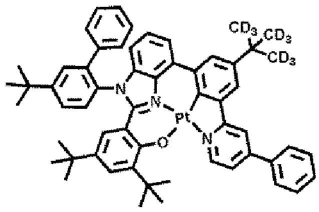
99

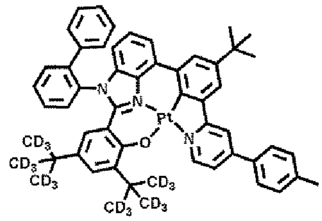
157

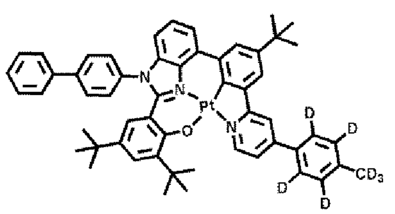
186

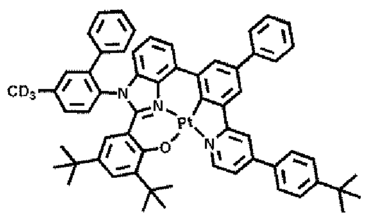
448

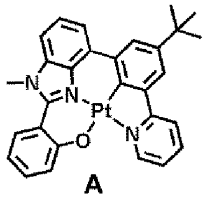
A

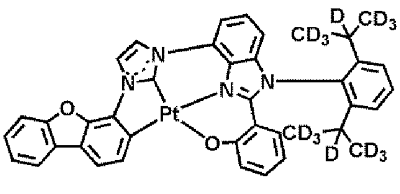
B

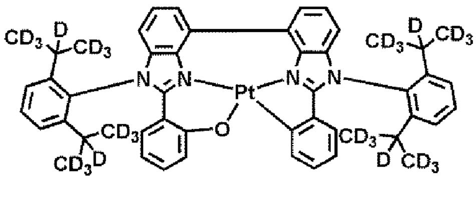
C

From Table 5, it was confirmed that the organic light-emitting devices of Example 1 to 9 have excellent driving voltage characteristics, high luminescence quantum efficiency, low roll-off ratio, and excellent lifespan characteristics compared to the organic light-emitting devices of Comparative Examples A to C.

The organometallic compound according to embodiments has excellent electric characteristics and thermal stability. Accordingly, an organic light-emitting device including the organometallic compound may have excellent driving voltage, quantum efficiency, power efficiency, color purity, and lifespan characteristics. Such organometallic compounds have excellent phosphorescent luminescent characteristics, and thus, when used, a diagnostic composition having a high diagnostic efficiency may be provided.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope of the present description as defined by the following claims.

## Claims

1. An organometallic compound represented by Formula 1:

Formula 1

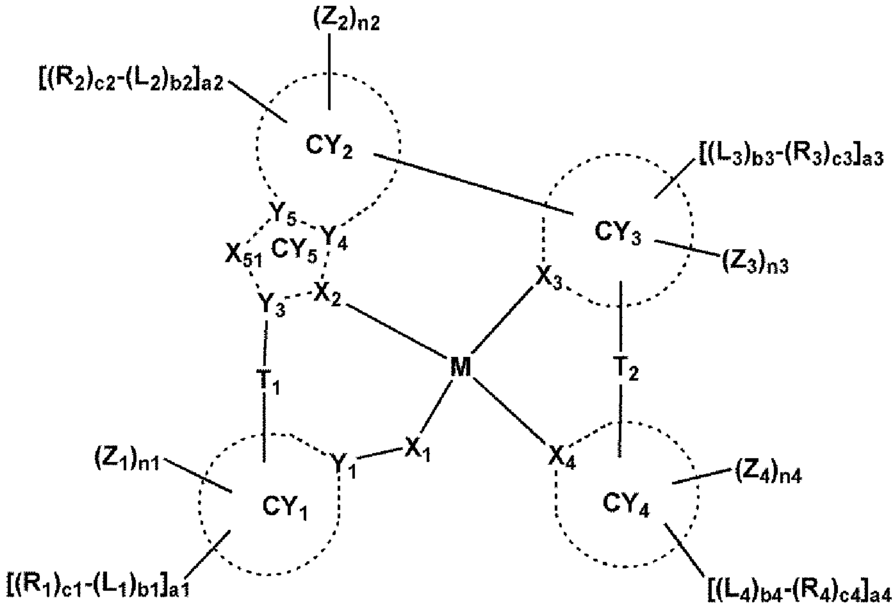

wherein, in Formula 1,

M is beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au),

$X_1$ is a chemical bond, O, S, N(R'), P(R'), B(R'), C(R')(R"), or Si(R')(R"), and when $X_1$ is a chemical bond, $Y_1$ is directly bonded to M,

$X_2$ to $X_4$ are each independently N or C, wherein two selected from $X_2$ to $X_4$ are each N and the other is C,

a bond between $X_1$ or $Y_1$ and M is a covalent bond, one bond selected from a bond between $X_2$ and M, a bond between $X_3$ and M, and a bond between $X_4$ and M is a covalent bond, and the remaining two bonds are coordinate bonds,

$Y_1$ and $Y_3$ to $Y_5$ are each independently C or N,

among pairs of $X_2$ and $Y_3$, $X_2$ and $Y_4$, $Y_4$ and $Y_5$, $X_{51}$ and $Y_3$, and $X_{51}$ and $Y_5$, the components in each pair are linked via a chemical bond,

ring $CY_1$ to ring $CY_5$ are each independently selected from a $C_5$-$C_{30}$ carbocyclic group and a $C_1$-$C_{30}$ heterocyclic group, and each of ring $CY_1$, ring $CY_3$, and ring $CY_4$ is not a benzimidazole group,

a cyclometalated ring formed by ring $CY_5$, ring $CY_2$, ring $CY_3$, and M is a 6-membered ring,

$X_{51}$ is selected from O, S, N-[$(L_7)_{b7}$-$(R_7)_{c7}$], $C(R_7)(R_8)$, $Si(R_7)(R_8)$, $Ge(R_7)(R_8)$, C(=O), N, $C(R_7)$, $Si(R_7)$, and $Ge(R_7)$,

$R_7$ and $R_8$ are optionally linked via a single bond, a double bond, or a first linking group to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,

$T_1$ and $T_2$ are each independently selected from a single bond, a double bond, *-N($R_9$)-*', *-B($R_9$)-*', *-P($R_9$)-*', *-C($R_9$)($R_{10}$)-*', *-Si($R_9$)($R_{10}$)-*', *-Ge($R_9$)($R_{10}$)-*', *-S-*', *-Se-*', *-O-*', *-C(=O)-*', *-S(=O)-*', *-S(=O)$_2$-*', *-C($R_9$)=*', *=C($R_9$)-*', *-C($R_9$)=C($R_{10}$)-*', *-C(=S)-*', or *-C≡C-*',

$L_1$ to $L_4$ and $L_7$ are each independently selected from a single bond, a substituted or unsubstituted $C_5$-$C_{30}$ carbocyclic group, and a substituted or unsubstituted $C_1$-$C_{30}$ heterocyclic group,

b1 to b4 and b7 are each independently an integer from 1 to 5,

$R_1$ to $R_4$, $R_7$ to $R_{10}$, R' and R" are each independently selected from hydrogen, deuterium, a deuterium-containing group, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted

$C_1$-$C_{10}$ heterocycloalkenyl group, a substituted or unsubstituted $C_6$-$C_{60}$ aryl group, a substituted or unsubstituted $C_7$-$C_{60}$ alkylaryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted $C_2$-$C_{60}$ alkylheteroaryl group, a substituted or unsubstituted monovalent non-aromatic condensed polycyclic group, a substituted or unsubstituted monovalent non-aromatic condensed heteropolycyclic group, - $N(Q_1)(Q_2)$, $-Si(Q_3)(Q_4)(Q_5)$, $-B(Q_6)(Q_7)$, and $-P(=O)(Q_8)(Q_9)$,

c1 to c4 and c7 are each independently an integer from 1 to 5,

$Z_1$ to $Z_4$ are each independently deuterium or a deuterium-containing group,

a1 to a4 and n1 to n4 are each independently an integer from 0 to 20,

i) when $X_{51}$ is O, S, C(=O), or N, the sum of n1 to n4 is 1 or more, ii) when $X_{51}$ is $N[(L_7)_{b7}-(R_7)_{c7}]$, $C(R_7)$, $Si(R_7)$, or $Ge(R_7)$, a) $R_7$ is deuterium or a deuterium-containing group; b) the sum of n1 to n4 is 1 or more; or c) $R_7$ is deuterium or a deuterium-containing group and the sum of n1 to n4 is 1 or more, and iii) when $X_{51}$ is $C(R_7)(R_8)$, $Si(R_7)(R_8)$, or $Ge(R_7)(R_8)$, a) at least one selected from $R_7$ and $R_8$ is deuterium or a deuterium-containing group; b) the sum of n1 to n4 is 1 or more; or c) at least one selected from $R_7$ and $R_8$ is deuterium or a deuterium-containing group and the sum of n1 to n4 is 1 or more,

two of a plurality of neighboring groups $R_1$ are optionally linked to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,

two of a plurality of neighboring groups $R_2$ are optionally linked to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10}$,

two of a plurality of neighboring groups $R_3$ are optionally linked to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,

two of a plurality of neighboring groups $R_4$ are optionally linked to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,

two or more neighboring groups selected from $R_1$ to $R_4$, $R_7$ to $R_{10}$, R', and R" are optionally linked to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,

$R_{10a}$ has the same definition as $R_1$,

at least one substituent of the substituted $C_5$-$C_{30}$ carbocyclic group, the substituted C1-C30 heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkylaryl group, the substituted $C_6$-$C_{60}$ aryloxy group, the substituted $C_6$-$C_{60}$ arylthio group, the substituted $C_7$-$C_{60}$ arylalkyl group, the substituted $C_1$-$C_{60}$ heteroaryl group, the substituted $C_1$-$C_{60}$ heteroaryloxy group, the substituted $C_1$-$C_{60}$ heteroarylthio group, the substituted $C_2$-$C_{60}$ heteroarylalkyl group, the substituted $C_2$-$C_{60}$ alkylheteroaryl group, the substituted monovalent non-aromatic condensed polycyclic group, and the substituted monovalent non-aromatic condensed heteropolycyclic group is selected from:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br, -I,$-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkylaryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a $C_2$-$C_{60}$ alkylheteroaryl group, a monovalent non-aromatic condensed polycyclic group, a monovalent non-aromatic condensed heteropolycyclic group, $-N(Q_{11})(Q_{12})$,$-Si(Q_{13})(Q_{14})(Q_{15})$, $-B(Q_{16})(Q_{17})$, and $-P(=O)(Q_{18})(Q_{19})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocy-

cloalkenyl group, a $C_6$-$C_{60}$ aryl group, a $C_7$-$C_{60}$ alkylaryl group, a C6-C60 aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a $C_2$-$C_{60}$ alkylheteroaryl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkylaryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a $C_2$-$C_{60}$ alkylheteroaryl group, a monovalent non-aromatic condensed polycyclic group, and a monovalent non-aromatic condensed heteropolycyclic group, each substituted with at least one selected from deuterium, -F, -Cl, -Br, -I, $-CD_3$, - $CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkylaryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a $C_2$-$C_{60}$ alkylheteroaryl group, a monovalent non-aromatic condensed polycyclic group, a monovalent non-aromatic condensed heteropolycyclic group, $-N(Q_{21})(Q_{22})$,$-Si(Q_{23})(Q_{24})(Q_{25})$, $-B(Q_{26})(Q_{27})$, and $-P(=O)(Q_{28})(Q_{29})$; and

$-N(Q_{31})(Q_{32})$, $-Si(Q_{33})(Q_{34})(Q_{35})$, $-B(Q_{36})(Q_{37})$, and $-P(=O)(Q_{38})(Q_{39})$;

wherein $Q_1$ to $Q_9$, $Q_{11}$ to $Q_{19}$, $Q_{21}$ to $Q_{29}$, and $Q_{31}$ to $Q_{39}$ are each independently selected from hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_1$-$C_{60}$ alkyl group substituted with at least one selected from deuterium, a $C_1$-$C_{60}$ alkyl group, and a $C_6$-$C_{60}$ aryl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from deuterium, a $C_1$-$C_{60}$ alkyl group, and a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a $C_2$-$C_{60}$ alkylheteroaryl group, a monovalent non-aromatic condensed polycyclic group, and a monovalent non-aromatic condensed heteropolycyclic group.

**2.** The organometallic compound of claim 1, wherein

i) $X_2$ and $X_4$ are each N, $X_3$ is C, a bond between $X_2$ and M and a bond between $X_4$ and M are each a coordinate bond, and a bond between $X_3$ and M is a covalent bond,

i) $X_2$ and $X_3$ are each N, $X_4$ is C, a bond between $X_2$ and M and a bond between $X_3$ and M are each a coordinate bond, and a bond between $X_4$ and M is a covalent bond, or

iii) $X_3$ and $X_4$ are each N, $X_2$ is C, a bond between $X_3$ and M and a bond between $X_4$ and M are each a coordinate bond, and a bond between $X_2$ and M is a covalent bond.

**3.** The organometallic compound of claims 1 or 2, wherein

ring $CY_1$ to ring $CY_4$ are each independently selected from i) a first ring, ii) a second ring, iii) a condensed ring in which two or more first rings are condensed with each other, iv) a condensed ring in which two or more second rings are condensed with each other, and v) a condensed ring in which one or more first rings and one or more second rings are condensed with each other,

the first ring is selected from a cyclopentane group, a cyclopentadiene group, a furan group, a thiophene group, a pyrrole group, a silole group, an indene group, a benzofuran group, a benzothiophene group, an indole group, a benzosilole group, an oxazole group, an isoxazole group, an oxadiazole group, an isozadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, and a triazasilole group,

the second ring is selected from an adamantane group, a norbornane group, a norbornene group, a cyclohexane group, a cyclohexene group, a benzene group, a pyridine group, a pyrimidine group, a pyrazine group, a pyridazine group, and a triazine group, and

each of ring $CY_1$ to ring $CY_4$ is not a benzimidazole group.

**4.** The organometallic compound of claims 1 or 2, wherein

ring $CY_1$ to ring $CY_4$ are each independently selected from a benzene group, a naphthalene group, an anthracene group, a phenanthrene group, a triphenylene group, a pyrene group, a chrysene group, cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a 5,6,7,8-tetrahydroisoquinoline group, and a 5,6,7,8-tetrahydroquinoline group.

**5.** The organometallic compound of any of claims 1-4, wherein

i) $Y_3$ to $Y_5$ are each C, a bond between $X_{51}$ and $Y_3$ and a bond between $X_{51}$ and $Y_5$ are each a single bond, and $X_{51}$ is O, S, N-[$(L_7)_{b7}$-$(R_7)_{c7}$], C($R_7$)($R_8$), Si($R_7$)($R_8$), Ge($R_7$)($R_8$), or C(=O),
ii) $Y_3$ and $Y_4$ are each C, $Y_5$ is N, a bond between $X_{51}$ and $Y_3$ is a double bond, a bond between $X_{51}$ and $Y_5$ is a single bond, and $X_{51}$ is N, C($R_7$), Si($R_7$), or Ge($R_7$),
iii) $Y_3$ and $Y_5$ are each C, $Y_4$ is N, a bond between $X_{51}$ and $Y_3$ is a single bond, a bond between $X_{51}$ and $Y_5$ is a double bond, and $X_{51}$ is N, C($R_7$), Si($R_7$), or Ge($R_7$),
iv) $Y_3$ is N, $Y_4$ and $Y_5$ are each C, a bond between $X_{51}$ and $Y_3$ is a single bond, a bond between $X_{51}$ and $Y_5$ is a double bond, and $X_{51}$ is N, C($R_7$), Si($R_7$), or Ge($R_7$), or
v) $Y_3$ to $Y_5$ are each C, a bond between $X_{51}$ and $Y_3$ is a double bond, a bond between $X_{51}$ and $Y_5$ is a single bond, and $X_{51}$ is N, C($R_7$), Si($R_7$), or Ge($R_7$).

**6.** The organometallic compound of any of claims 1-5, wherein
the deuterium-containing group is a first group substituted with at least one deuterium atom, and
the first group is selected from:

a $C_1$-$C_{20}$ alkyl group, and a $C_1$-$C_{20}$ alkoxy group;
a $C_1$-$C_{20}$ alkyl group and a $C_1$-$C_{20}$ alkoxy group, each substituted with at least one selected from -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a pyridinyl group, and a pyrimidinyl group;
a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl

group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group, each substituted with at least one selected from -F, -Cl, -Br, -I,$-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, and$-Si(Q_{33})(Q_{34})(Q_{35})$; and
$-N(Q_1)(Q_2)$, $-Si(Q_3)(Q_4)(Q_5)$, $-B(Q_6)(Q_7)$, and $-P(=O)(Q_8)(Q_9)$;
wherein $Q_1$ to $Q_9$ and $Q_{33}$ to $Q_{35}$ are each independently selected from:
$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CH_3$, $-CD_2CD_3$, $-CD_2CD_2H$, and $-CD_2CDH_2$;
an n-propyl group, an iso-propyl group, an n-butyl group, an iso-butyl group, a sec-butyl group, a tert-butyl group, an n-pentyl group, an isopentyl group, a sec-pentyl group, a tert-pentyl group, a phenyl group, and a naphthyl group; and
an n-propyl group, an iso-propyl group, an n-butyl group, an iso-butyl group, a sec-butyl group, a tert-butyl group, an n-pentyl group, an isopentyl group, a sec-pentyl group, a tert-pentyl group, a phenyl group, and a naphthyl group, each substituted with at least one selected from a $C_1$ to $C_{10}$ alkyl group, and a phenyl group.

**7.** The organometallic compound of any of claims 1-6, wherein
the deuterium-containing group is a first group substituted with at least one deuterium atom, and the first group is selected from a $C_1$-$C_{20}$ alkyl group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, and a terphenyl group, each unsubstituted or substituted with at least one selected from -F, $-CD_3$, $-CD_2H$, $-CDH_2$, $-CF_3$, $-CF_2H$, $-CFH_2$, a cyano group, a $C_1$-$C_{10}$ alkyl group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, and a terphenyl group.

**8.** The organometallic compound of any of claims 1-7, wherein
$R_1$ to $R_4$, $R_7$ to $R_{10}$, R', and R" are each independently selected from hydrogen, deuterium, -F, a cyano group, a nitro group, $-SF_5$, $-CH_3$, $-CD_3$, $-CD_2H$, $-CDH_2$, $-CF_3$, $-CF_2H$, $-CFH_2$, $-CD_2(CD_3)$, $-CD(CD_3)_2$, $-C(CD_3)_3$, $-CD_2-C(CD_3)_3$, $-CD_2-CD(CD_3)_2$, $-CD_2-CD_2(CD_3)$,$-CD(CD_3)-C(CD_3)_3$, $-CD(CD_3)-CD(CD_3)_2$, $-CD(CD_3)-CD_2(CD_3)$, $-C(CD_3)_2-C(CD_3)_3$, $-C(CD_3)_2-CD(CD_3)_2$, $-C(CD_3)_2-CD_2(CD_3)$, a group represented by Formula 9-1 to 9-19, a group represented by Formulae 10-1 to 10-232, a group represented by Formulae 11-1 to 11-41, and $-Si(Q_1)(Q_2)(Q_3)$,
$Z_1$ to $Z_4$ are each independently selected from deuterium, $-CD_3$, $-CD_2H$, $-CDH_2$,$-CD_2(CD_3)$, $-CD(CD_3)_2$, $-C(CD_3)_3$, $-CD_2-C(CD_3)_3$, $-CD_2-CD(CD_3)_2$, $-CD_2-CD_2(CD_3)$,$-CD(CD_3)-C(CD_3)_3$, $-CD(CD_3)-CD(CD_3)_2$, $-CD(CD_3)-CD_2(CD_3)$, $-C(CD_3)_2-C(CD_3)_3$, $-C(CD_3)_2-CD(CD_3)_2$, $-C(CD_3)_2-CD_2(CD_3)$, and a group represented by one of Formulae 9-14 to 9-19, 10-11, 10-12, and 11-1 to 11-41:

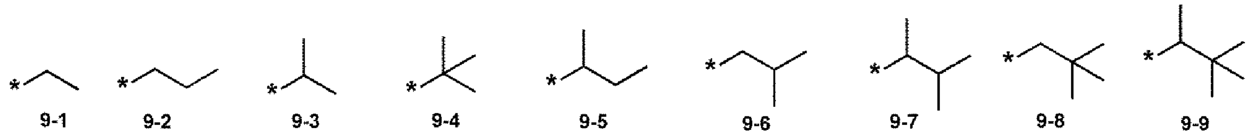

9-1 9-2 9-3 9-4 9-5 9-6 9-7 9-8 9-9

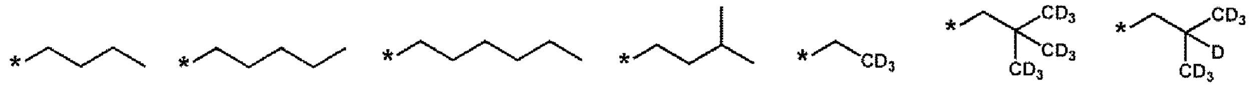

9-10 9-11 9-12 9-13 9-14 9-15 9-16

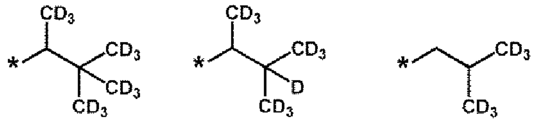

9-17 9-18 9-19

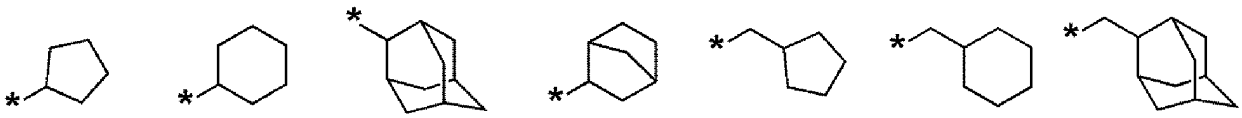

10-1 10-2 10-3 10-4 10-5 10-6 10-7

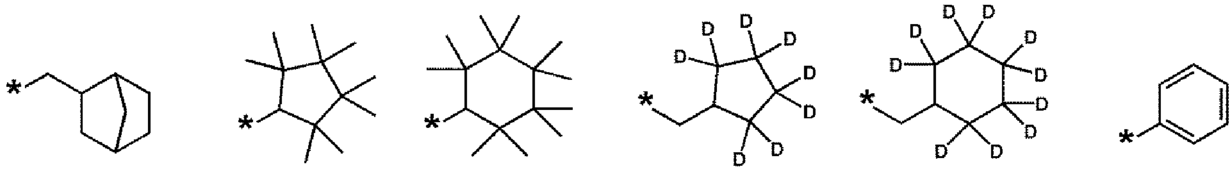

10-8 10-9 10-10 10-11 10-12 10-13

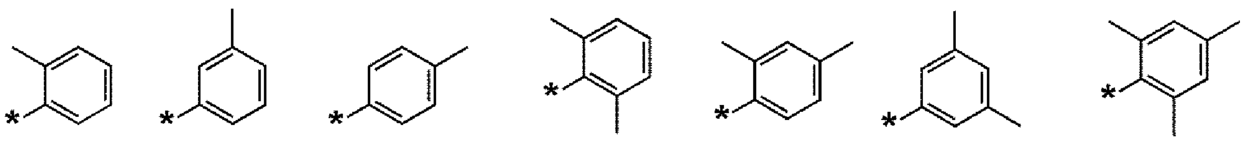

10-14 10-15 10-16 10-17 10-18 10-19 10-20

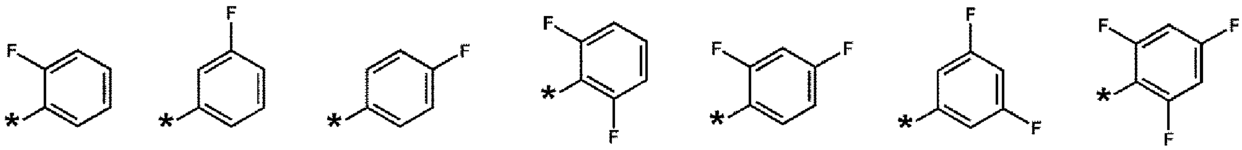

10-21 10-22 10-23 10-24 10-25 10-26 10-27

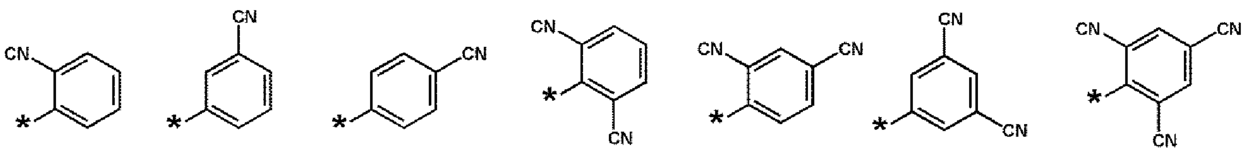

10-28 10-29 10-30 10-31 10-32 10-33 10-34

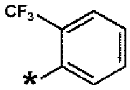 10-35 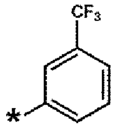 10-36 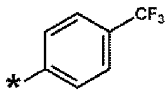 10-37 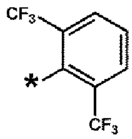 10-38 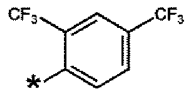 10-39 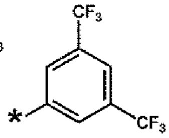 10-40 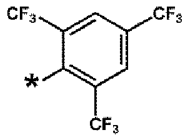 10-41

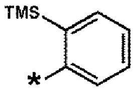 10-42 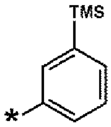 10-43 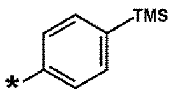 10-44 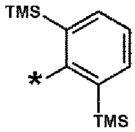 10-45 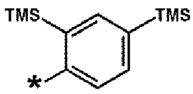 10-46 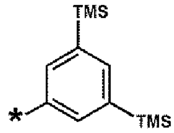 10-47 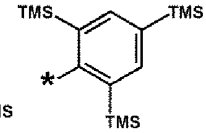 10-48

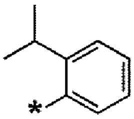 10-49 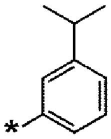 10-50 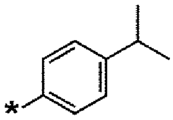 10-51 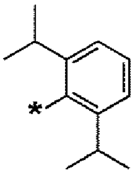 10-52 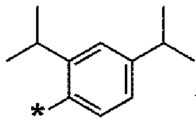 10-53 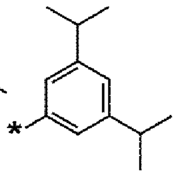 10-54 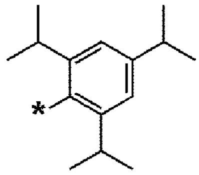 10-55

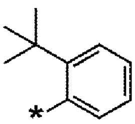 10-56 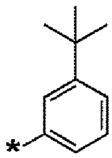 10-57 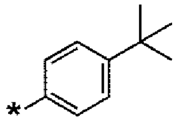 10-58 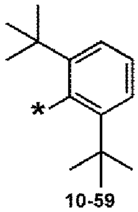 10-59 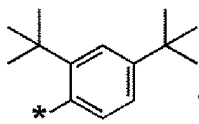 10-60 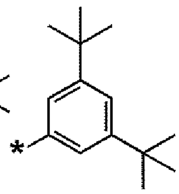 10-61 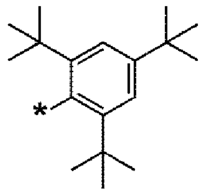 10-62

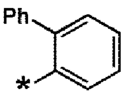 10-63 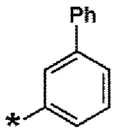 10-64 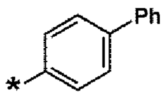 10-65 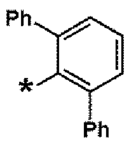 10-66 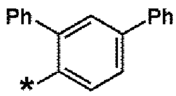 10-67 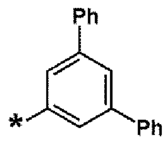 10-68 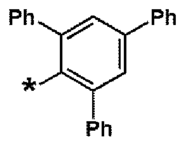 10-69

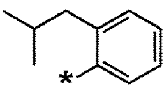 10-70 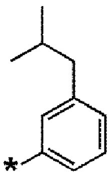 10-71 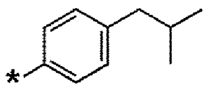 10-72 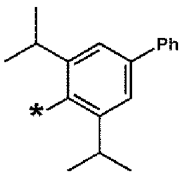 10-73 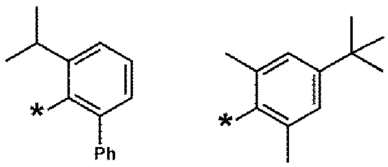 10-74 10-75

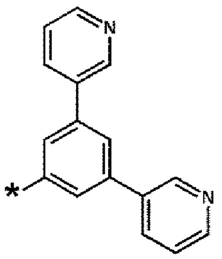 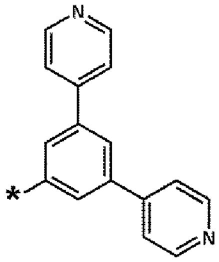 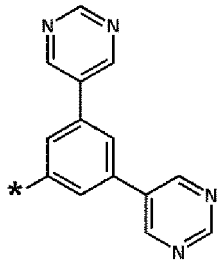 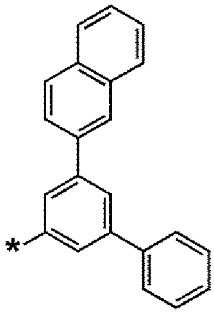 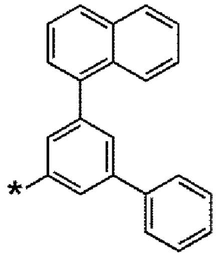

10-76 10-77 10-78 10-79 10-80

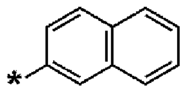 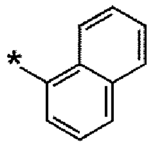 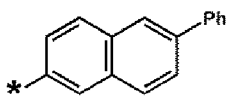 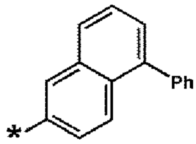 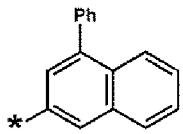

10-81 10-82 10-83 10-84 10-85

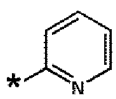 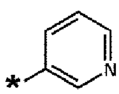 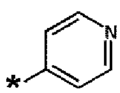 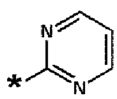 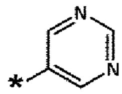 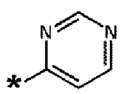 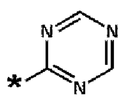

10-86 10-87 10-88 10-89 10-90 10-91 10-92

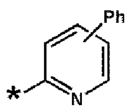 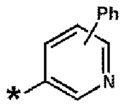 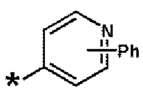 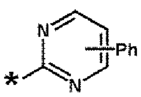 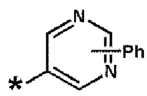 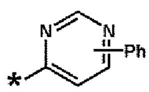 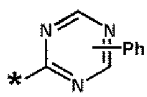

10-93 10-94 10-95 10-96 10-97 10-98 10-99

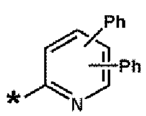 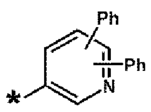 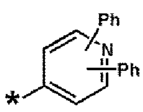 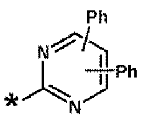 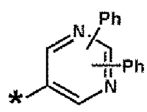 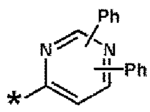 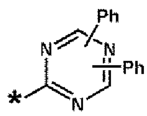

10-100 10-101 10-102 10-103 10-104 10-105 10-106

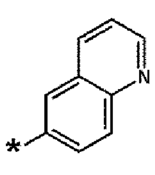 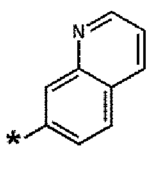 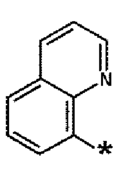 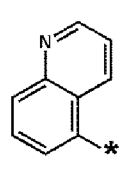 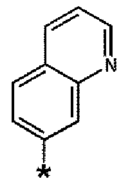 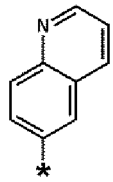

10-107 10-108 10-109 10-110 10-111 10-112

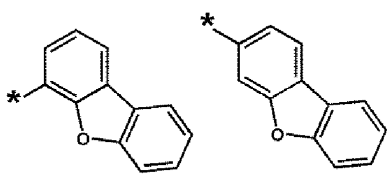 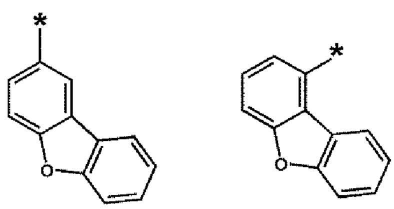 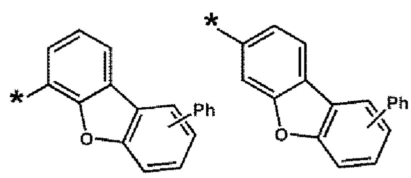

10-113 10-114 10-115 10-116 10-117 10-118

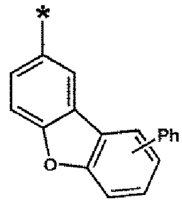
10-119

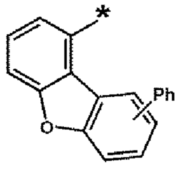
10-120

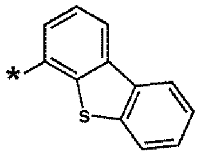
10-121

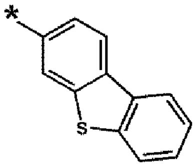
10-122

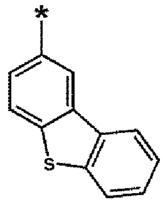
10-123

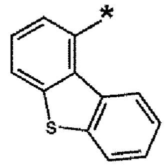
10-124

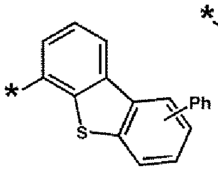
10-125

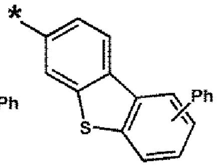
10-126

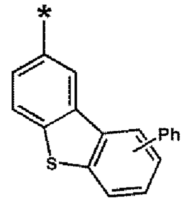
10-127

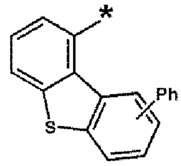
10-128

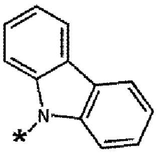
10-129

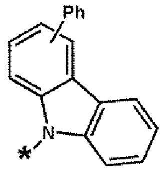
10-130

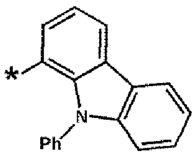
10-131

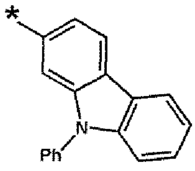
10-132

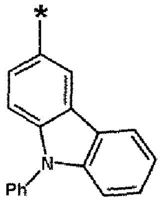
10-133

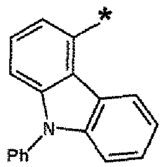
10-134

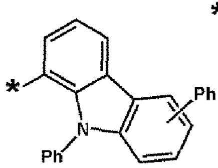
10-135

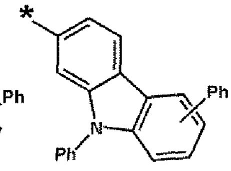
10-136

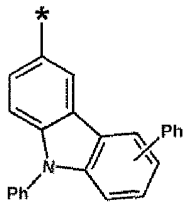
10-137

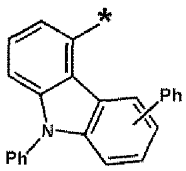
10-138

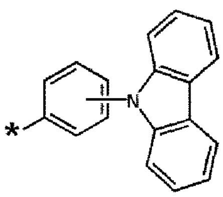
10-139

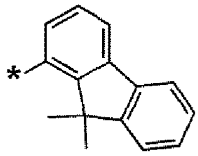
10-140

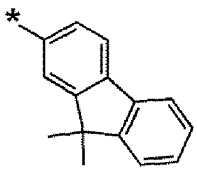
10-141

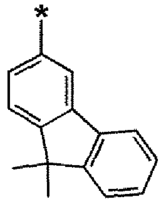
10-142

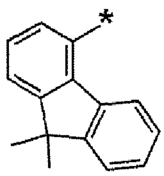
10-143

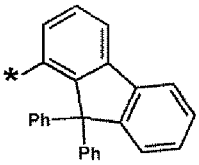
10-144

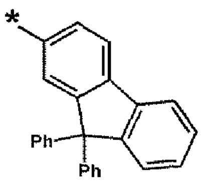
10-145

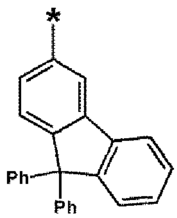
10-146

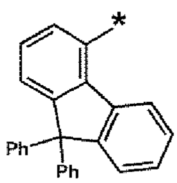
10-147

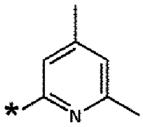
10-148

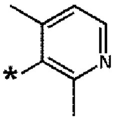
10-149

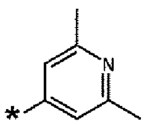
10-150

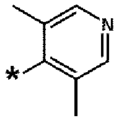
10-151

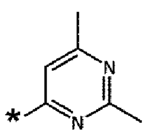
10-152

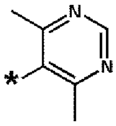
10-153

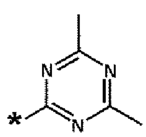
10-154

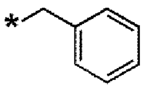
10-155
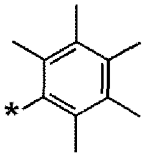
10-156
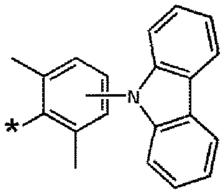
10-157
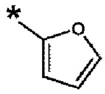
10-158
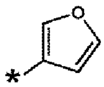
10-159
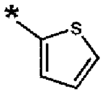
10-160
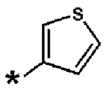
10-161

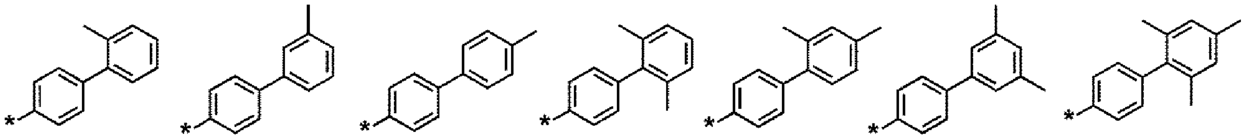
10-162 10-163 10-164 10-165 10-166 10-167 10-168

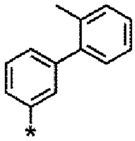
10-169
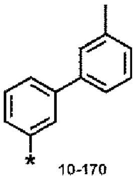
10-170
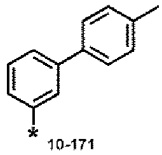
10-171
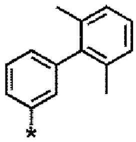
10-172
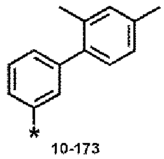
10-173
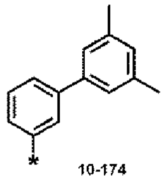
10-174
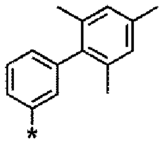
10-175

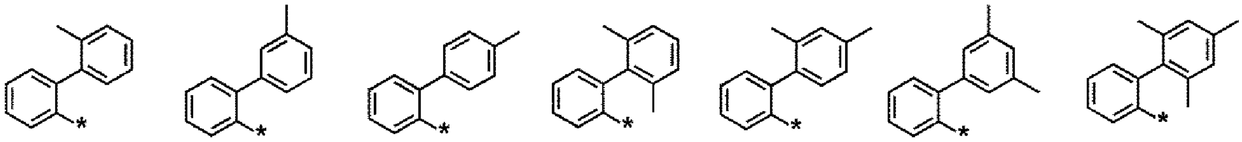
10-176 10-177 10-178 10-179 10-180 10-181 10-182

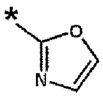
10-183
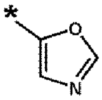
10-184
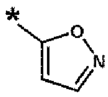
10-185
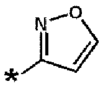
10-186
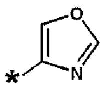
10-187
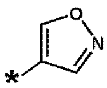
10-188
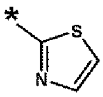
10-189
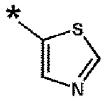
10-190
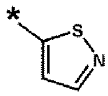
10-191

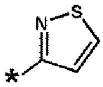
10-192
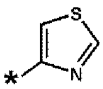
10-193
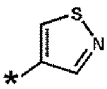
10-194
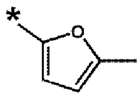
10-195
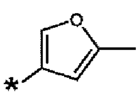
10-196
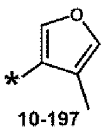
10-197
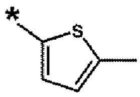
10-198
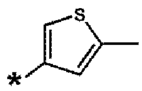
10-199
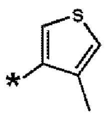
10-200

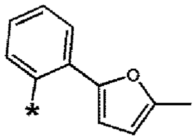
10-201
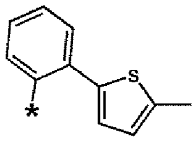
10-202
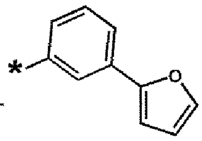
10-203
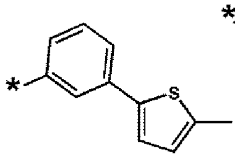
10-204
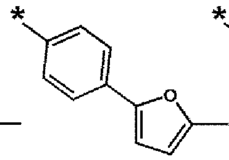
10-205
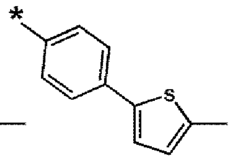
10-206

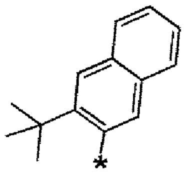
10-207
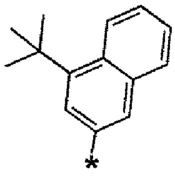
10-208
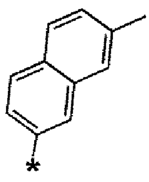
10-209
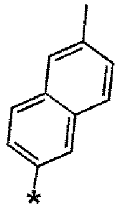
10-210
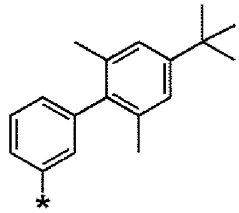
10-211
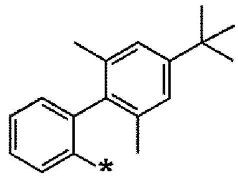
10-212

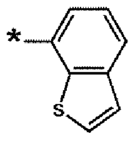
10-213
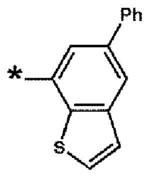
10-214
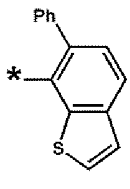
10-215
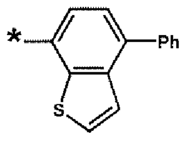
10-216
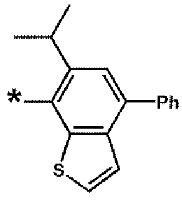
10-217
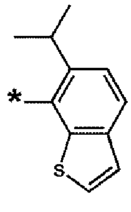
10-218
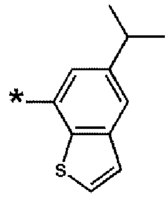
10-219

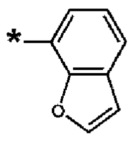
10-220
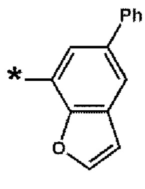
10-221
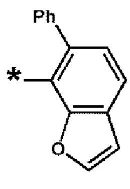
10-222
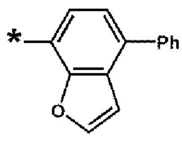
10-223
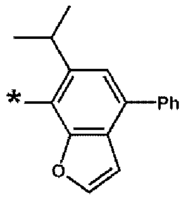
10-224
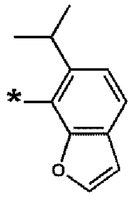
10-225
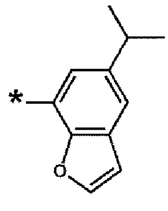
10-226

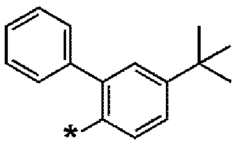
10-227
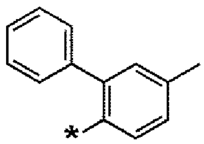
10-228
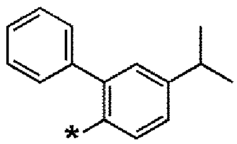
10-229
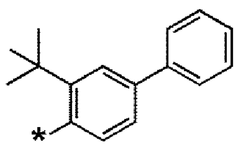
10-230
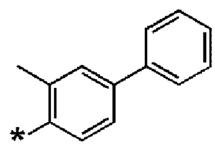
10-231

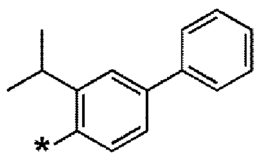
10-232

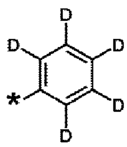
11-1
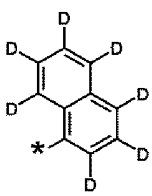
11-2
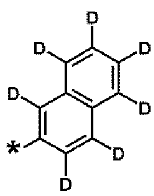
11-3
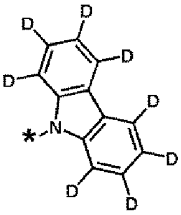
11-4
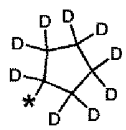
11-5
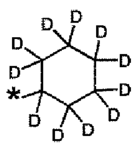
11-6
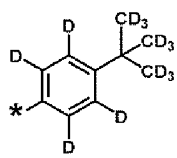
11-7

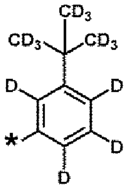 11-8
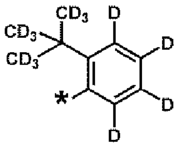 11-9
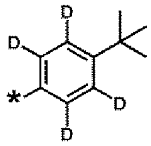 11-10
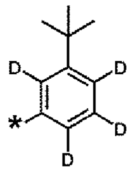 11-11
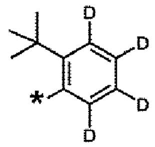 11-12
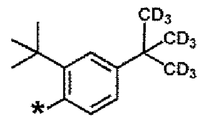 11-13
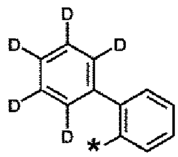 11-14

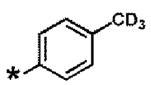 11-15
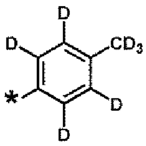 11-16
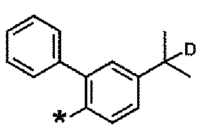 11-17
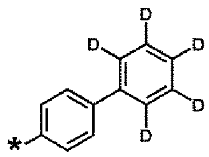 11-18
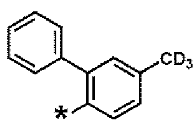 11-19
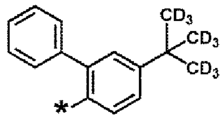 11-20

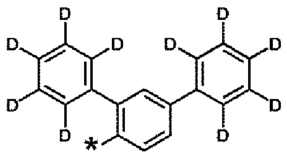 11-21
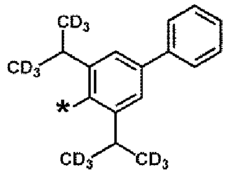 11-22
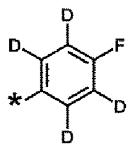 11-23
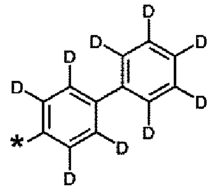 11-24
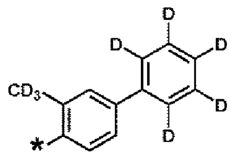 11-25

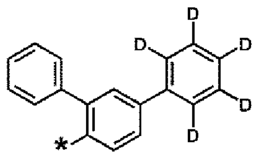 11-26
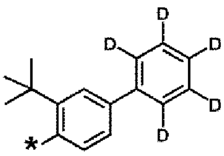 11-27
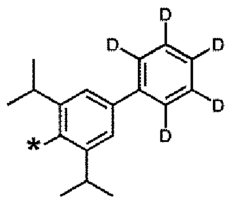 11-28
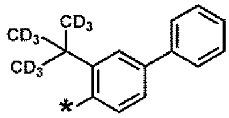 11-29
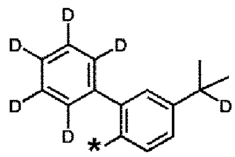 11-30

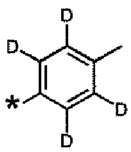 11-31
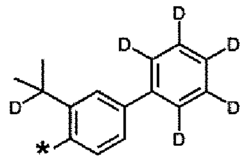 11-32
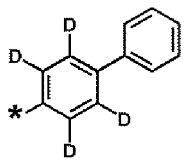 11-33
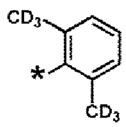 11-34
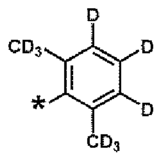 11-35
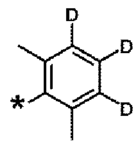 11-36

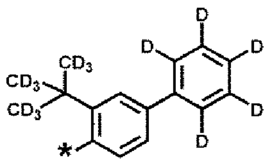 11-37
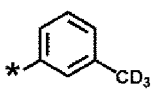 11-38
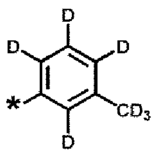 11-39
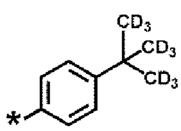 11-40
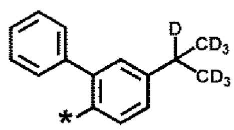 11-41

wherein, in Formulae 9-1 to 9-19, 10-1 to 10-232, and 11-1 to 11-41, * indicates a binding site to a neighboring atom, Ph is a phenyl group, and TMS is a trimethylsilyl group; and/or

wherein

the deuterium-containing group is selected from $-CD_3$, $-CD_2(CD_3)$, $-CD(CD_3)_2$,$-C(CD_3)_3$, $-CD_2-C(CD_3)_3$, $-CD_2-CD(CD_3)_2$, $-CD_2-CD_2(CD_3)$, $-CD(CD_3)-C(CD_3)_3$, $-CD(CD_3)-CD(CD_3)_2$, $-CD(CD_3)-CD_2(CD_3)$, $-C(CD_3)_2-C(CD_3)_3$, $-C(CD_3)_2-CD(CD_3)_2$, $-C(CD_3)_2-CD_2(CD_3)$, and a group represented by one of Formulae 11-1 to 11-41:

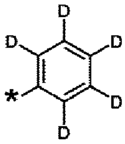
11-1
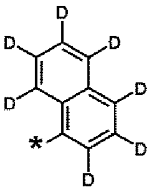
11-2
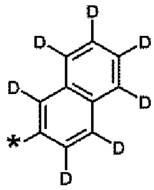
11-3
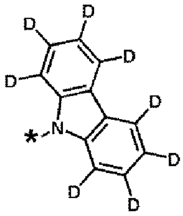
11-4
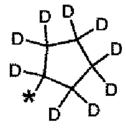
11-5
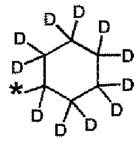
11-6
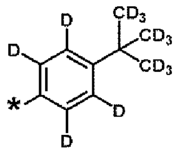
11-7

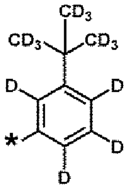
11-8
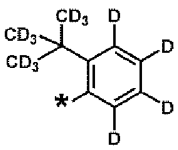
11-9
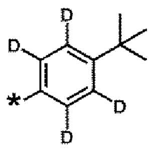
11-10
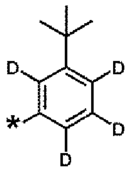
11-11
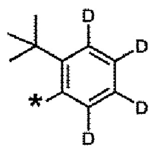
11-12
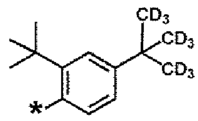
11-13
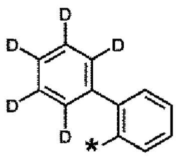
11-14

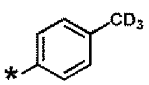
11-15
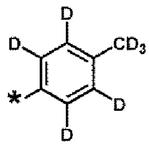
11-16
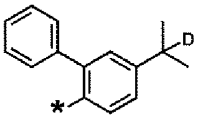
11-17
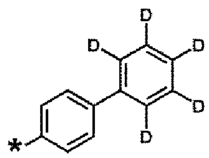
11-18
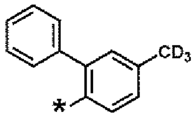
11-19
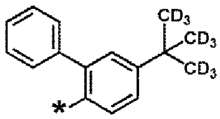
11-20

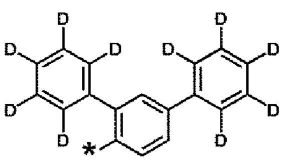
11-21
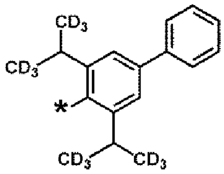
11-22
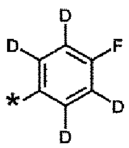
11-23
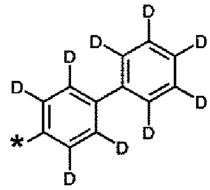
11-24
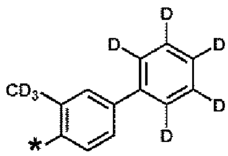
11-25

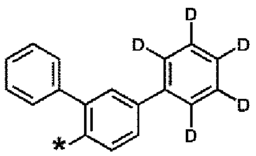
11-26
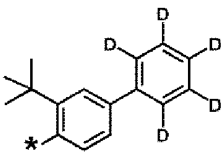
11-27
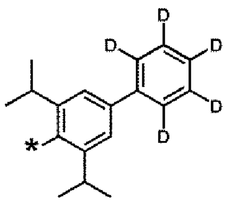
11-28
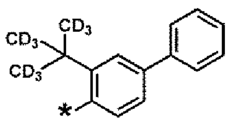
11-29
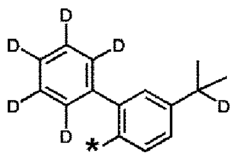
11-30

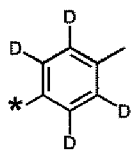
11-31
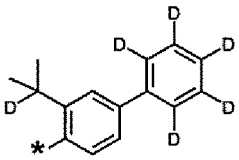
11-32
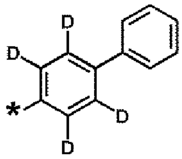
11-33
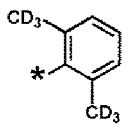
11-34
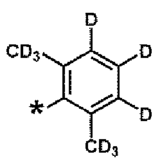
11-35
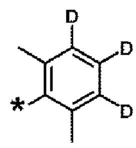
11-36

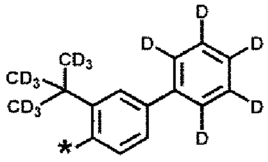
11-37
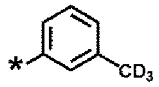
11-38
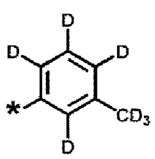
11-39
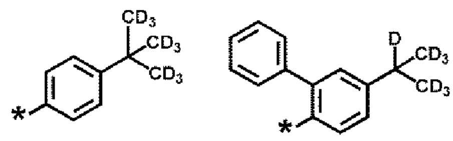
11-40
11-41

wherein * in Formulae 11-1 to 11-41 indicates a binding site to a neighboring atom.

**9.** The organometallic compound of any of claims 1-8, wherein satisfying at least one of <Condition A> to <Condition D>:

<Condition A>
n1 may be 1, 2, 3 or 4.
<Condition B>
X51 may be $N[(L_7)_{b7}\text{-}(R_7)_{c7}]$ and $R_7$ may be deuterium or a deuterium-containing group.
<Condition C>
n3 may be 1, 2 or 3.
<Condition D>
n4 may be 1, 2, 3 or 4.

**10.** The organometallic compound of any of claims 1-9, wherein a moiety represented by

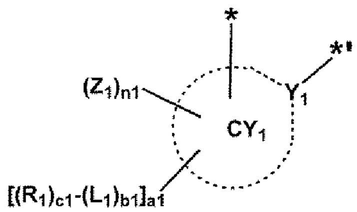

in Formula 1 is a group represented by one of Formulae CY1-1 to CY1-40:

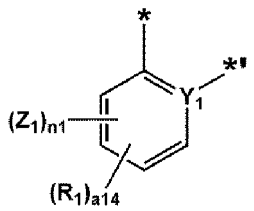
CY1-1

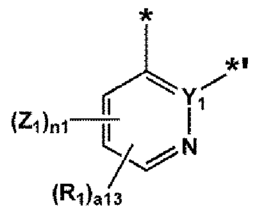
CY1-2

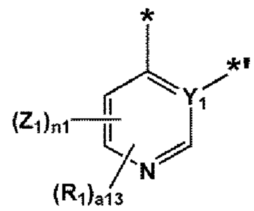
CY1-3

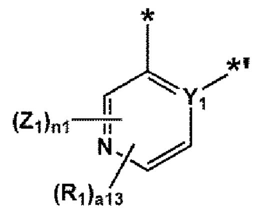
CY1-4

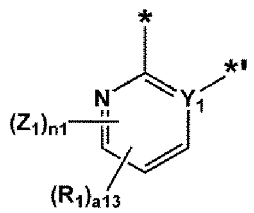
CY1-5

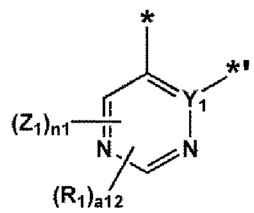
CY1-6

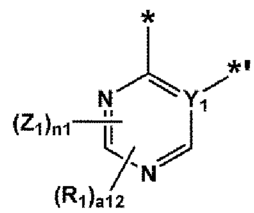
CY1-7

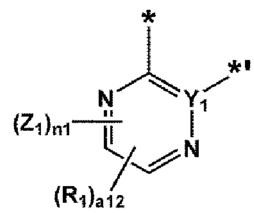
CY1-8

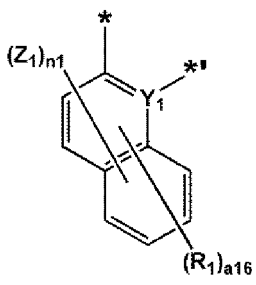
CY1-9

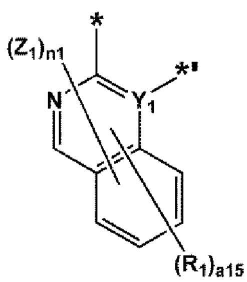
CY1-10

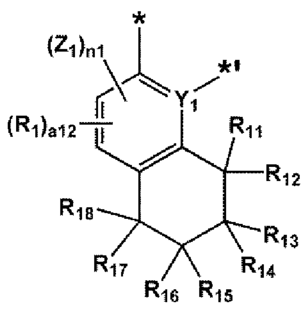
CY1-11

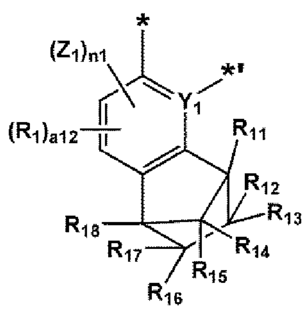
CY1-12

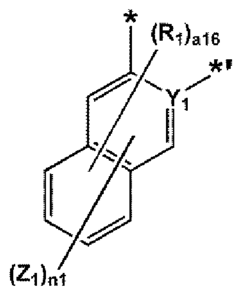
CY1-13

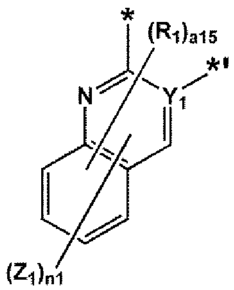
CY1-14

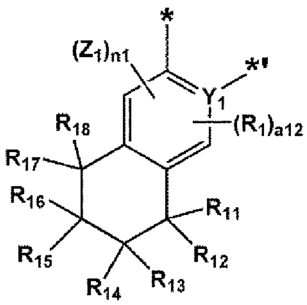
CY1-15

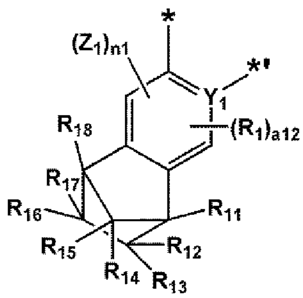
CY1-16

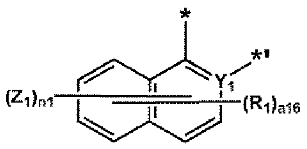
CY1-17

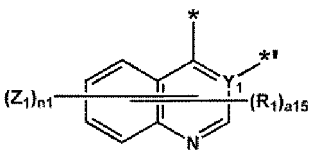
CY1-18

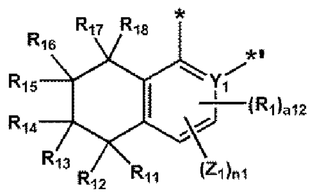
CY1-19

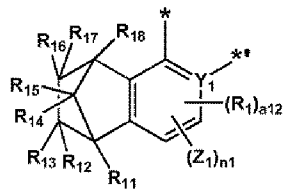
CY1-20

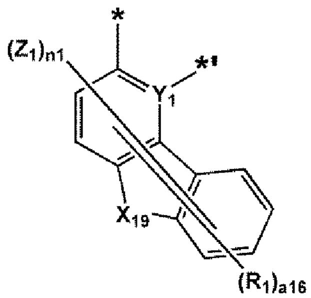
CY1-21

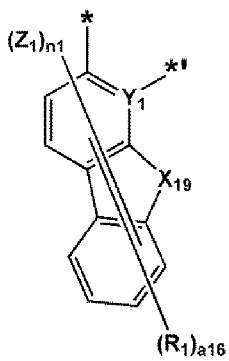
CY1-22

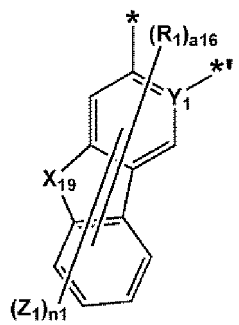
CY1-23

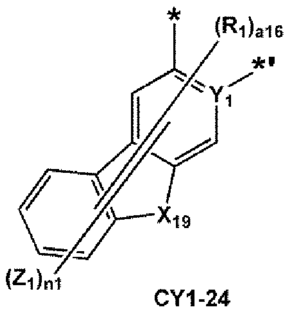
CY1-24

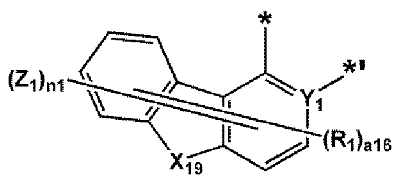
CY1-25

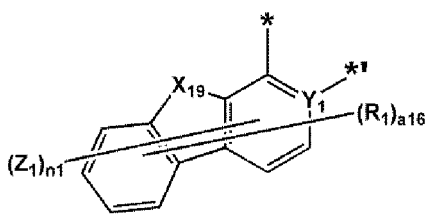
CY1-26

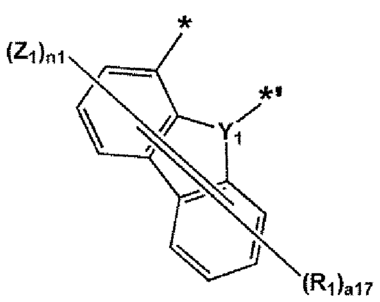
CY1-27

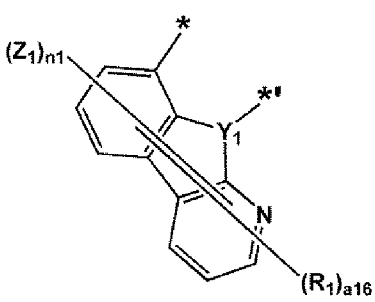
CY1-28

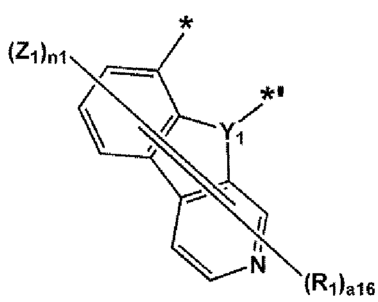
CY1-29

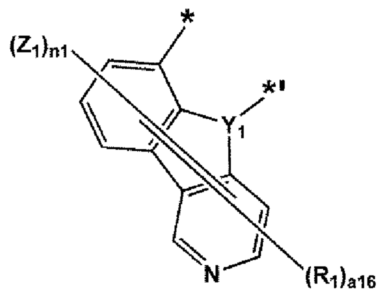

CY1-30

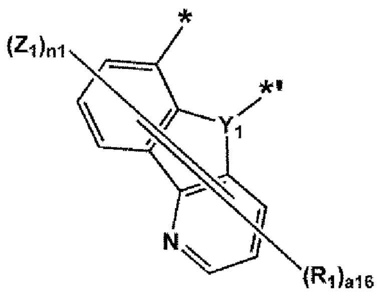

CY1-31

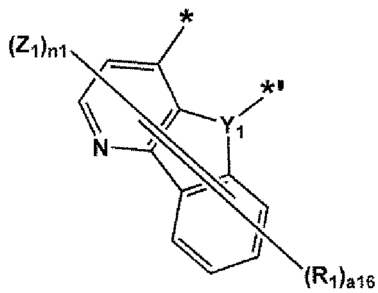

CY1-32

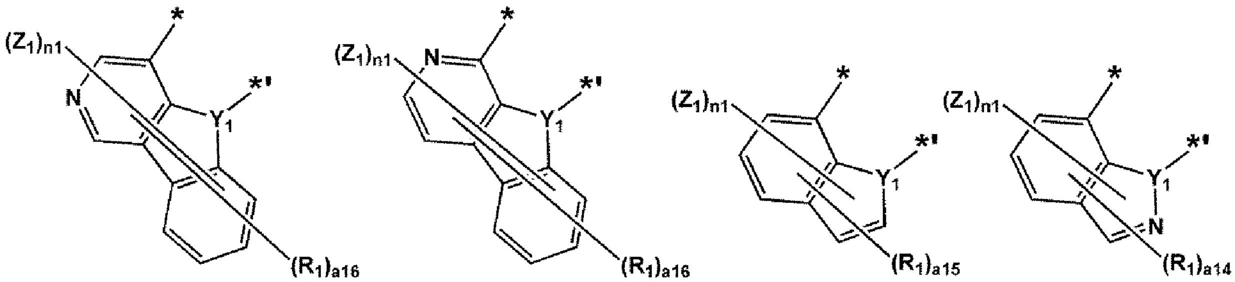

CY1-33 CY1-34 CY1-35 CY1-36

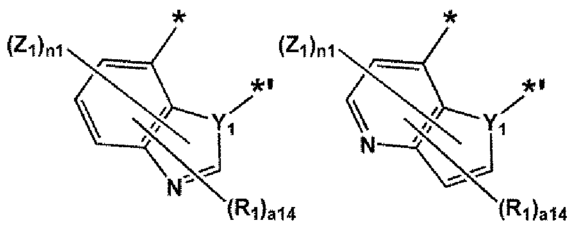

CY1-37 CY1-38

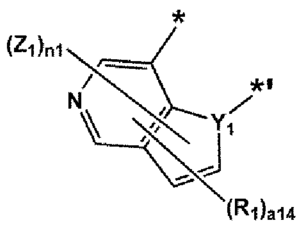

CY1-39

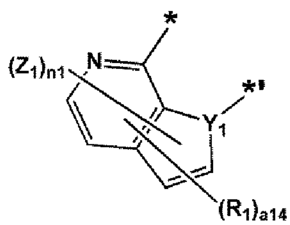

CY1-40

wherein, in Formula CY1-1 to CY1-40,

$Y_1$, $R_1$, $Z_1$, and n1 are the same as described in claim 1, and n1 is an integer from from 0 to 7,
$X_{19}$ is $C(R_{19a})(R_{19b})$, $N[(L_{19})_{b19}-(R_{19})_{c19}]$, O, S, or $Si(R_{19a})(R_{19b})$,
$L_{19}$ is the same as described in connection with $L_1$ in claim 1,
b19 and c19 are the same as described in connection with b1 and c1 in claim 1,
$R_{11}$ to $R_{19}$, $R_{19a}$, and $R_{19b}$ are the same as described in connection with $R_1$ in claim 1,
a12 is an integer from 0 to 2,
a13 is an integer from 0 to 3,
a14 is an integer from 0 to 4,
a15 is an integer from 0 to 5,
a16 is an integer from 0 to 6,
a17 is an integer from 0 to 7,
*' indicates a binding site to $X_1$ or M in Formula 1, and
* indicates a binding site to $T_1$ in Formula 1; and/or
wherein
a moiety represented by

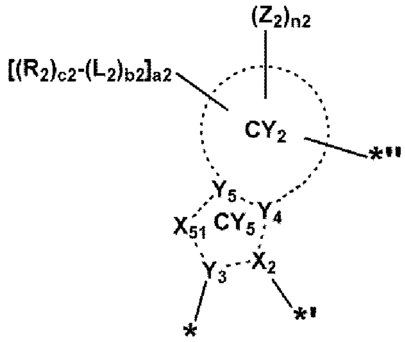

in Formula 1 is a group represented by one of Formulae CY2-1 to CY2-20:

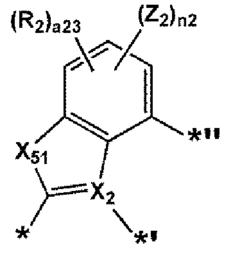

CY2-1

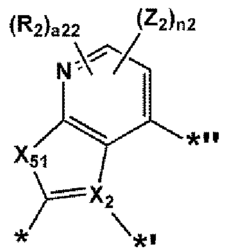

CY2-2

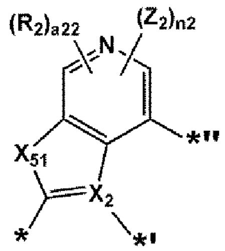

CY2-3

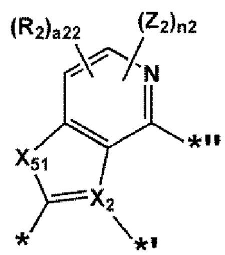

CY2-4

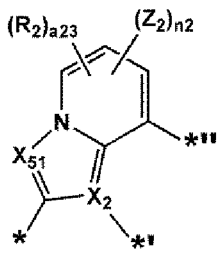

CY2-5

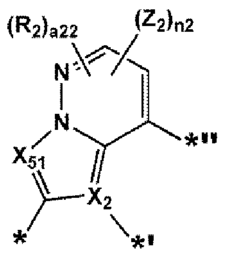

CY2-6

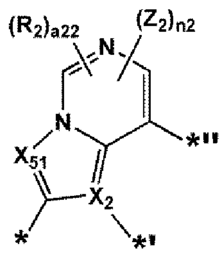

CY2-7

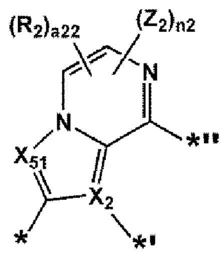

CY2-8

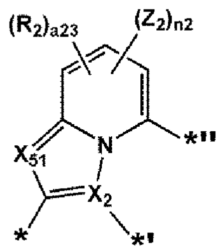

CY2-9

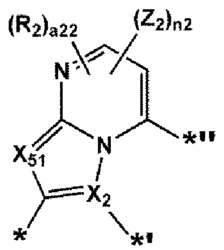

CY2-10

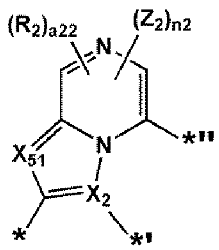

CY2-11

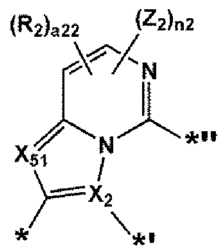

CY2-12

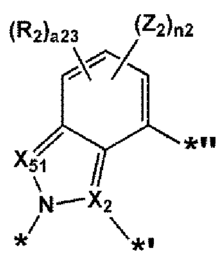

CY2-13

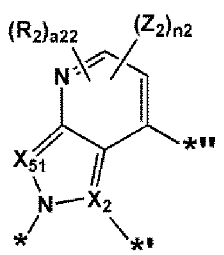

CY2-14

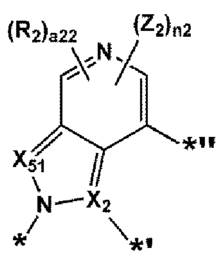

CY2-15

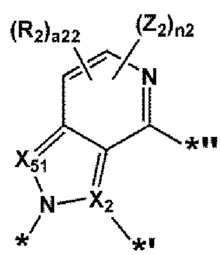

CY2-16

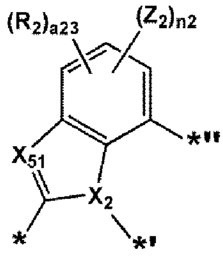
CY2-17

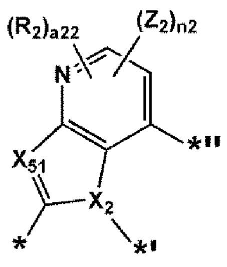
CY2-18

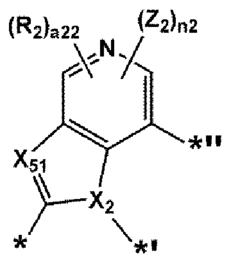
CY2-19

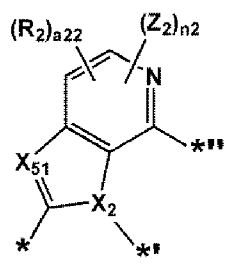
CY2-20

wherein, in Formulae CY2-1 to CY2-20,
$X_2$, $R_2$, $Z_2$, and n2 are the same as described in claim 1, and n2 is an integer from 0 to 3,
$X_{51}$ in Formulae CY2-1 to CY2-4 is O, S, $N-[(L_7)_{b7}-(R_7)_{c7}]$, $C(R_7)(R_8)$, $Si(R_7)(R_8)$, $Ge(R_7)(R_8)$, or C(=O),
$X_{51}$ in Formulae CY2-5 to CY2-20 is N, $C(R_7)$, $Si(R_7)$, or $Ge(R_7)$, $L_7$, b7, $R_7$, and c7 are the same as described in connection with claim 1,
a22 is an integer from 0 to 2,
a23 is an integer from 0 to 3,
* indicates a binding site to $T_1$ in Formula 1,
*' indicates a binding site to M in Formula 1, and
*" indicates a binding site to ring $CY_3$ in Formula 1.

**11.** The organometallic compound of any of claims 1-10, wherein a moiety represented by

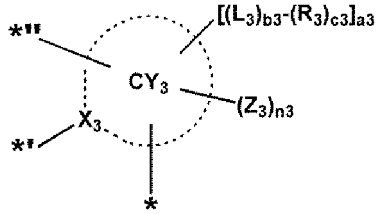

in Formula 1 is a group represented by one of Formulae CY3-1 to CY3-12:

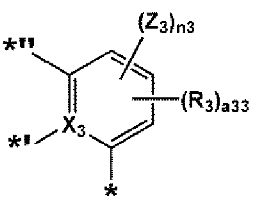
CY3-1

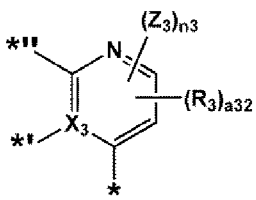
CY3-2

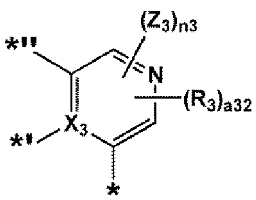
CY3-3

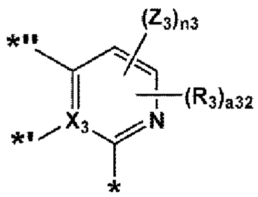
CY3-4

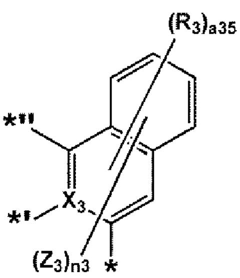
CY3-5

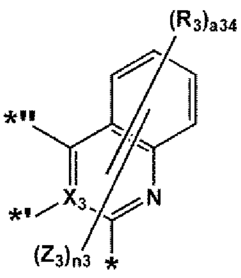
CY3-6

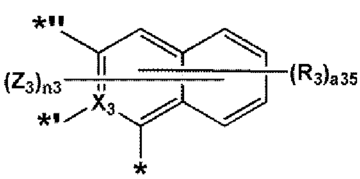
CY3-7

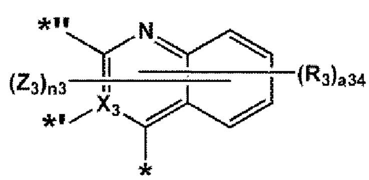
CY3-8

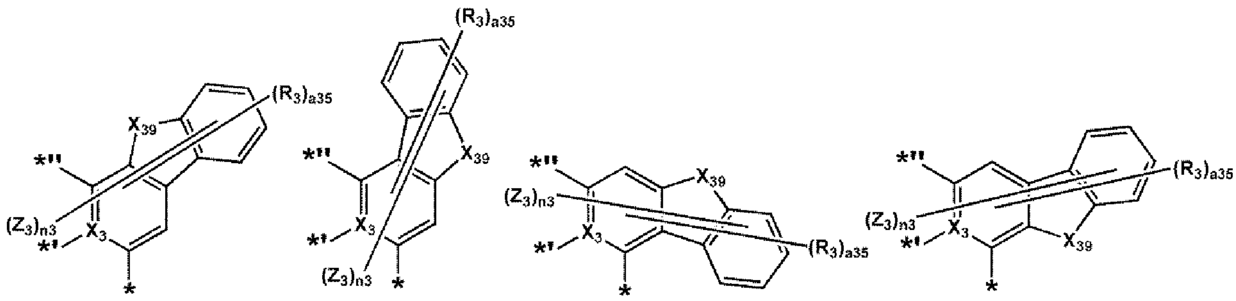

CY3-9 CY3-10 CY3-11 CY3-12

wherein, in Formulae CY3-1 to CY3-12,

$X_3$, $R_3$, $Z_3$, and n3 are the same as described in connection with claim 1, and n3 is an integer from 0 to 5,
$X_{39}$ is $C(R_{39a})(R_{39b})$, $N[(L_{39})_{b39}-(R_{39})_{c39}]$, O, S, or $Si(R_{39a})(R_{39b})$,
$L_{39}$ is the same as explained in connection with $L_3$ in claim 1,
b39 and c39 are the same as described in connection with b3 and c3 in claim 1, respectively,
$R_{39a}$ and $R_{39b}$ are the same as described in connection with $R_3$ in claim 1,
a32 is an integer from 0 to 2,
a33 is an integer from 0 to 3,
a34 is an integer from 0 to 4,
a35 is an integer from 0 to 5,
* indicates a binding site to $T_2$ in Formula 1,
*' indicates a binding site to M in Formula 1, and
*" indicates a binding site to ring $CY_2$ in Formula 1; and/or
wherein
a moiety represented by

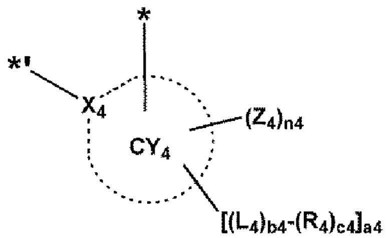

in Formula 1 is a group represented by one of Formulae CY4-1 to CY4-26:

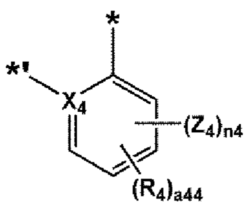

CY4-1

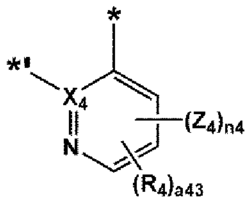

CY4-2

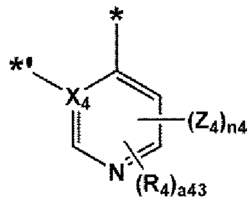

CY4-3

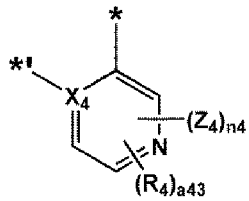

CY4-4

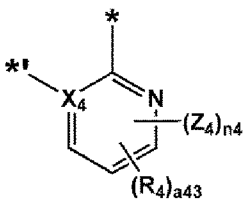

CY4-5

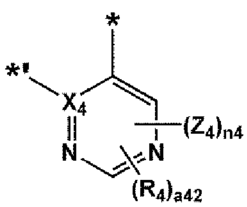

CY4-6

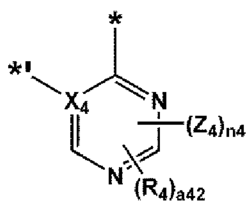

CY4-7

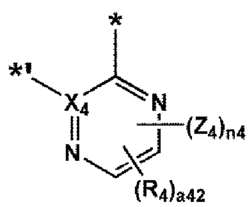

CY4-8

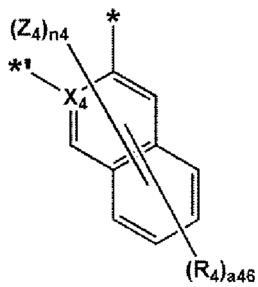

CY4-9

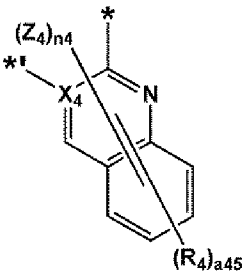

CY4-10

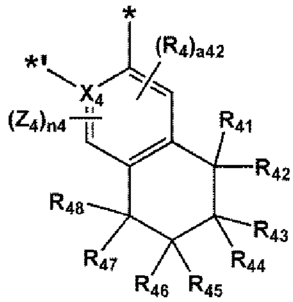

CY4-11

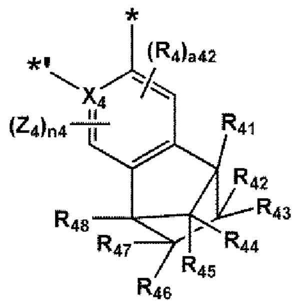

CY4-12

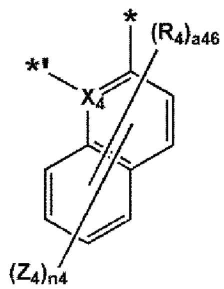

CY4-13

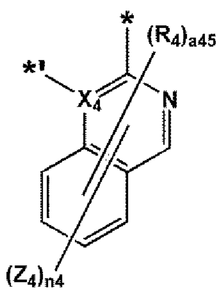

CY4-14

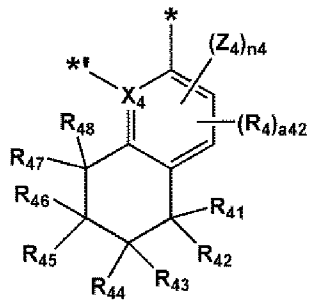

CY4-15

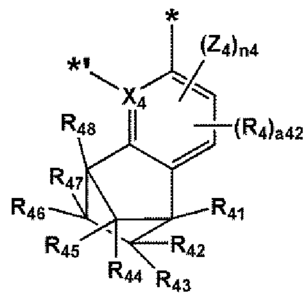

CY4-16

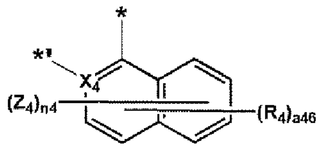

CY4-17

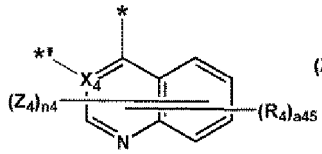

CY4-18

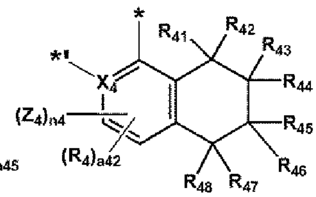

CY4-19

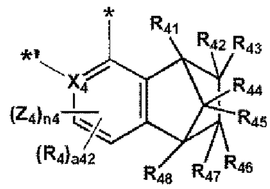

CY4-20

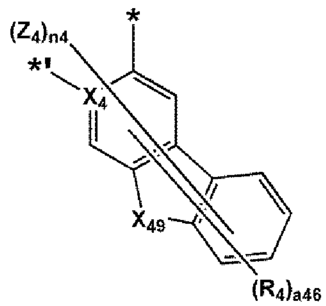

CY4-21

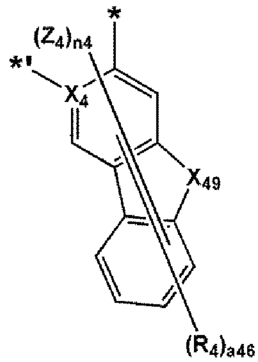

CY4-22

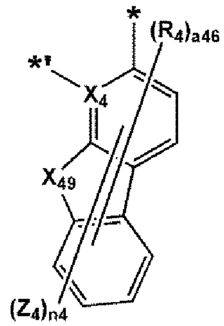

CY4-23

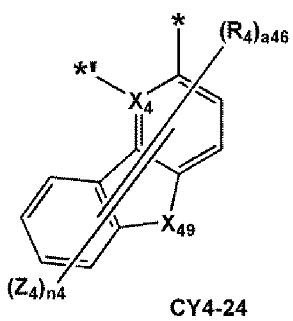

CY4-24

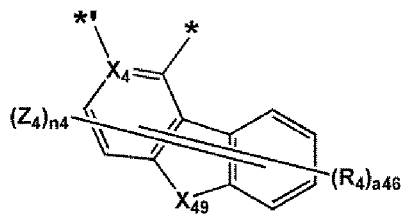

CY4-25

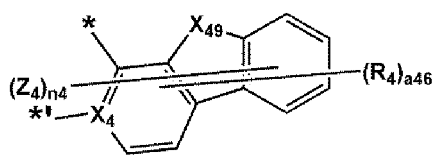

CY4-26

wherein, in Formulae CY4-1 to CY4-26,
$X_4$, $R_4$, $Z_4$, and n4 are the same as described in connection with claim 1, and n4 is an integer from 0 to 6,
$X_{49}$ is $C(R_{49a})(R_{49b})$, $N[(L_{49})_{b49}\text{-}(R_{49})_{c49}]$, O, S, or $Si(R_{49a})(R_{49b})$,
$L_{49}$ is the same as described in connection with $L_4$ in claim 1,
b49 and c49 are the same as described in connection with b4 and c4 in claim 1, respectively,
$R_{41}$ to $R_{49}$, $R_{49a}$, and $R_{49b}$ are the same as described in connection with $R_4$ in claim 1, respectively,
a42 is an integer from 0 to 2,
a43 is an integer from 0 to 3,
a44 is an integer from 0 to 4,
a45 is an integer from 0 to 5,
a46 is an integer from 0 to 6,
* indicates a binding site to $T_2$ in Formula 1, and
*' indicates a binding site to M in Formula 1.

**12.** The organometallic compound of claim 1, wherein the organometallic compound is one of Compounds 1 to 666 below:

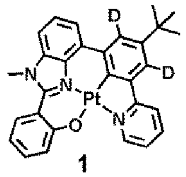
1
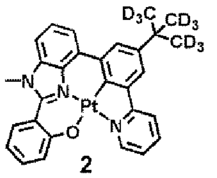
2
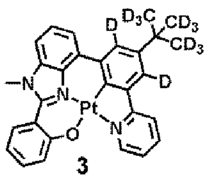
3
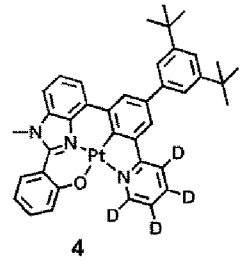
4
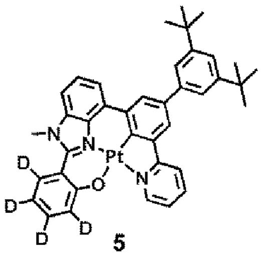
5
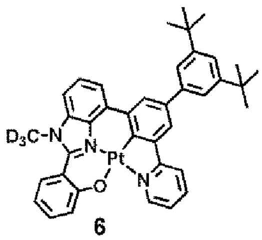
6
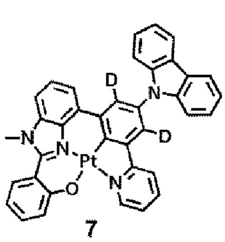
7
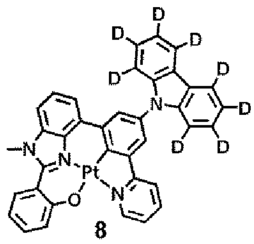
8
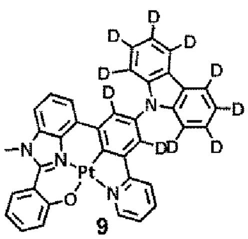
9
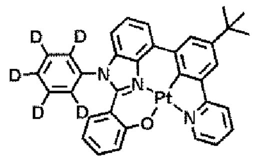
10
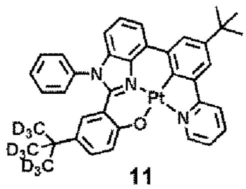
11
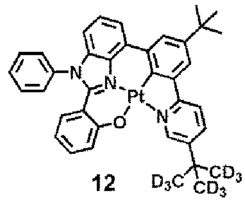
12
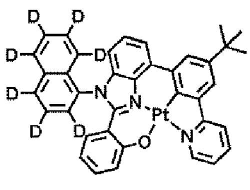
13
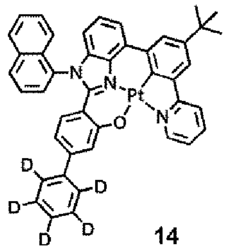
14
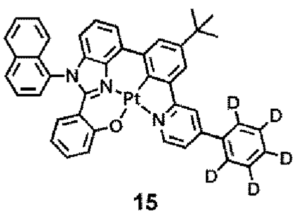
15
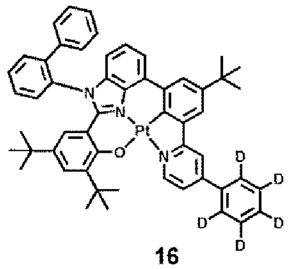
16

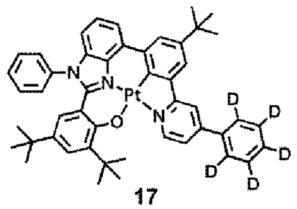
17

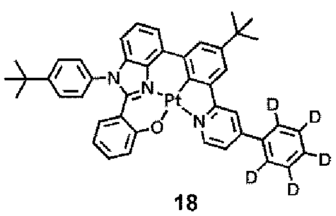
18

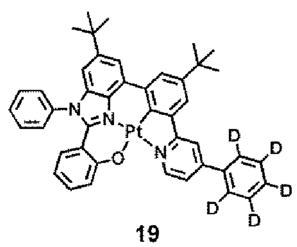
19

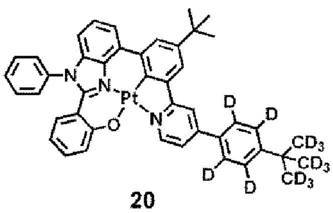
20

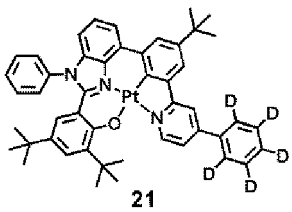
21

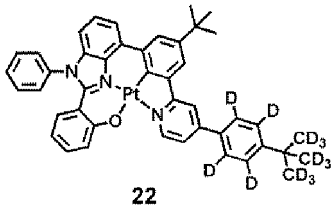
22

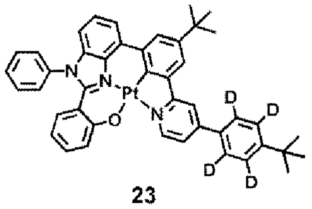
23

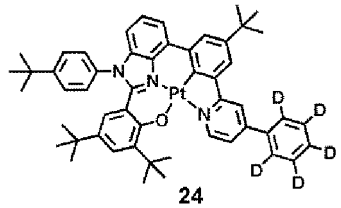
24

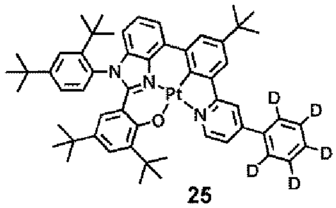
25

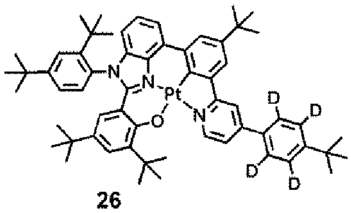
26

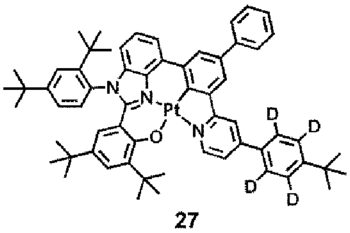
27

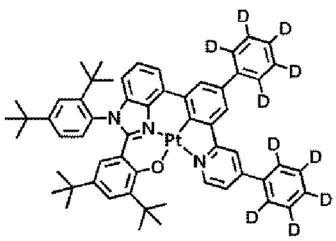
28

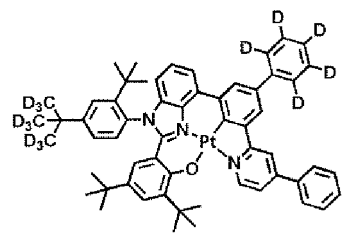
29

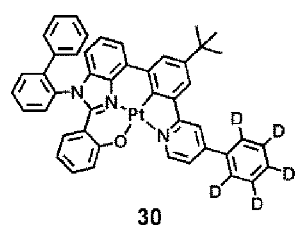
30

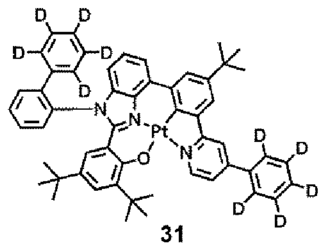
31

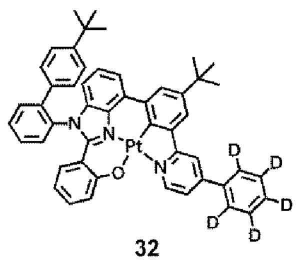
32

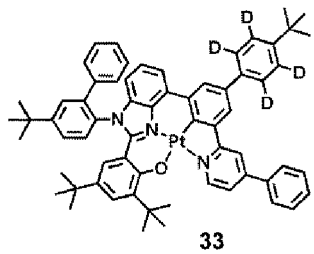
33

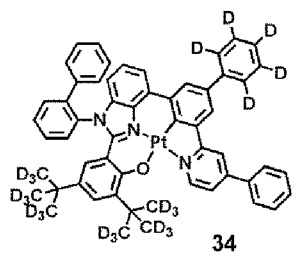
34

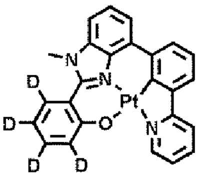
35
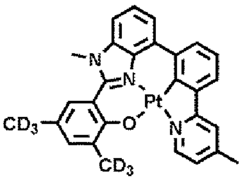
36
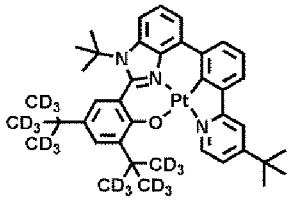
37
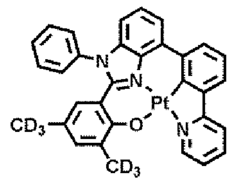
38

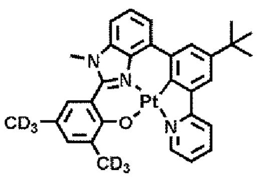
39
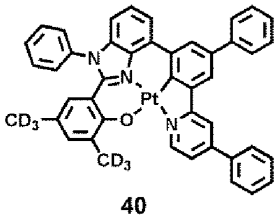
40
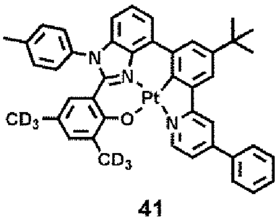
41
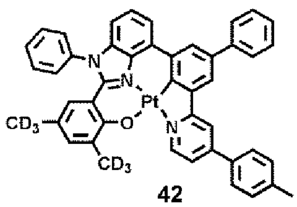
42

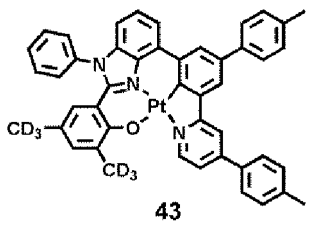
43
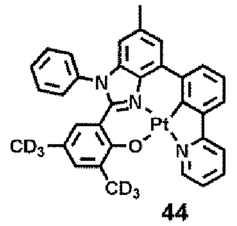
44
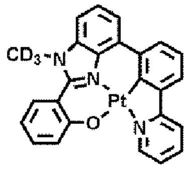
45
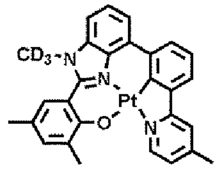
46

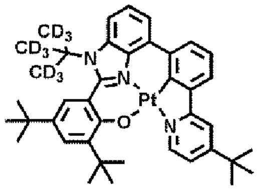
47
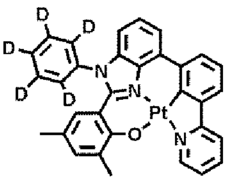
48
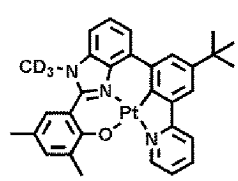
49
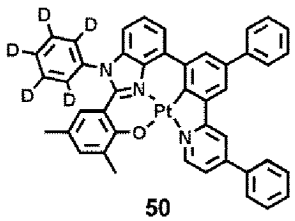
50

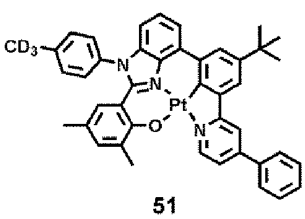
51
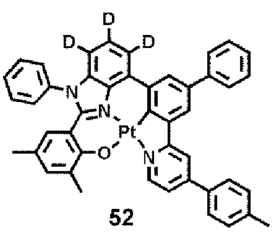
52
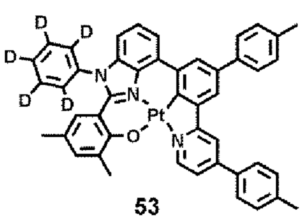
53
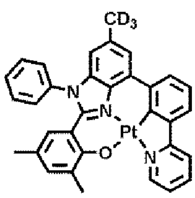
54

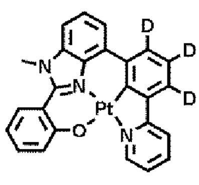
55
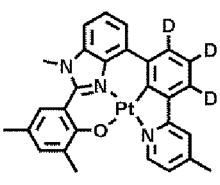
56
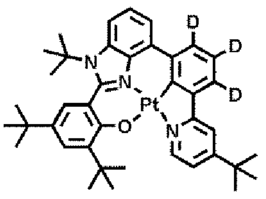
57
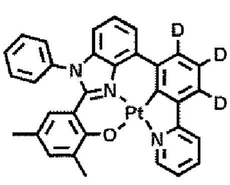
58

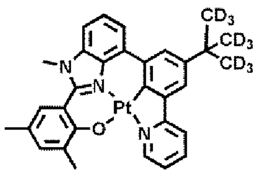
59

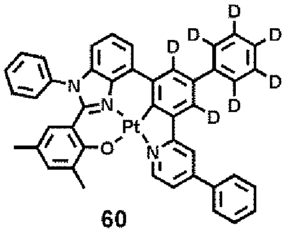
60

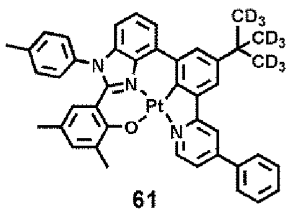
61

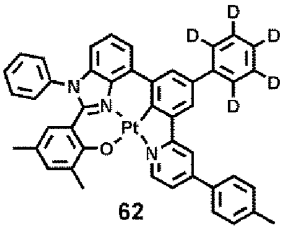
62

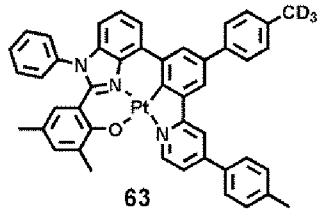
63

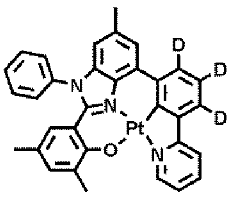
64

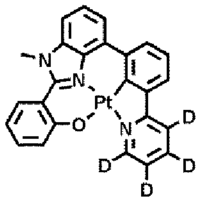
65

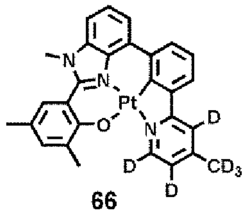
66

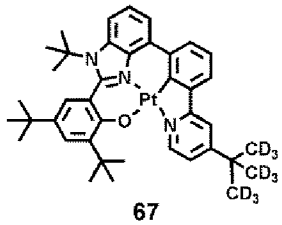
67

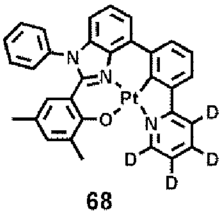
68

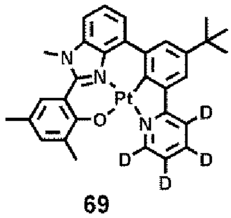
69

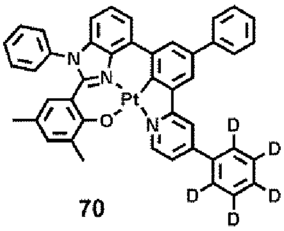
70

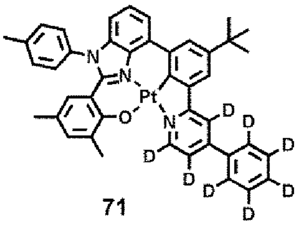
71

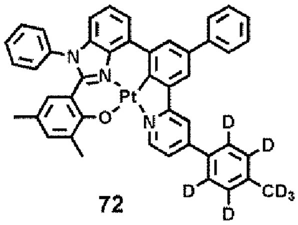
72

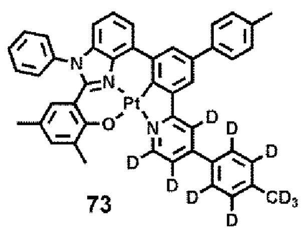
73

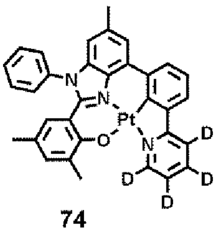
74

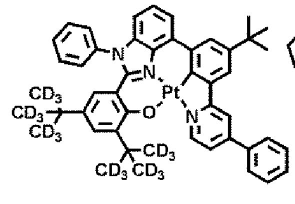
75

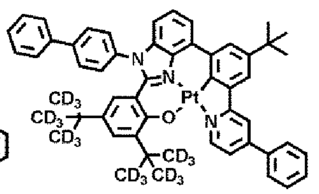
76

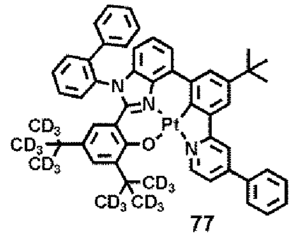
77

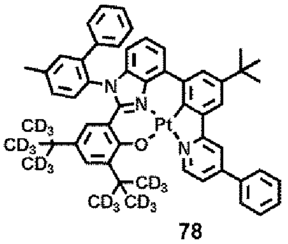
78

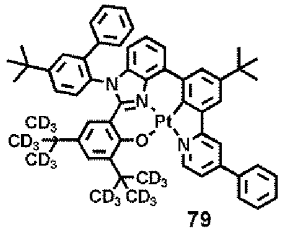
79

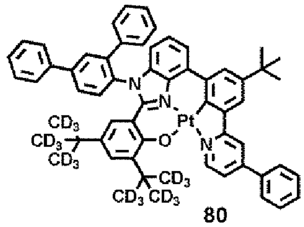
80

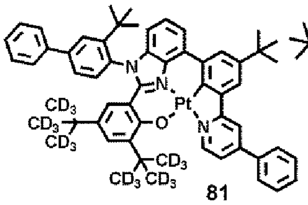
81

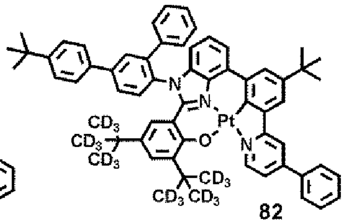
82

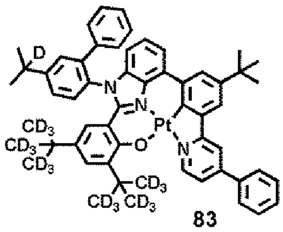
83
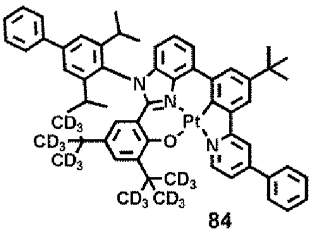
84
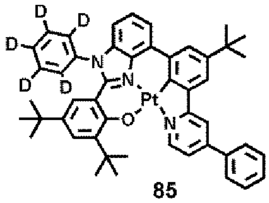
85
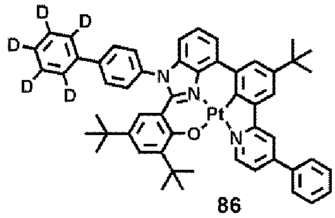
86

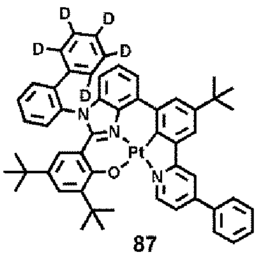
87
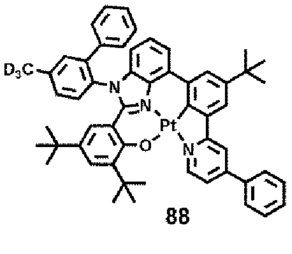
88
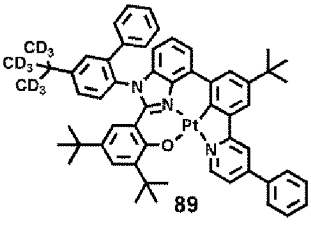
89
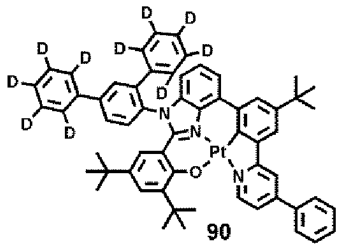
90

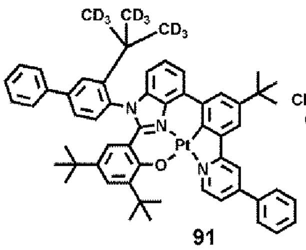
91
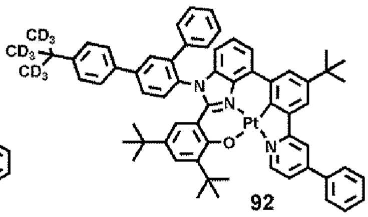
92
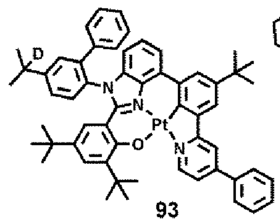
93
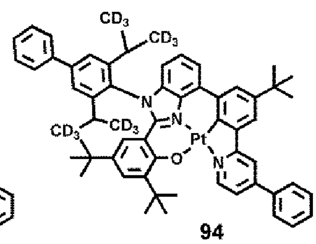
94

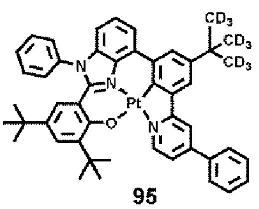
95
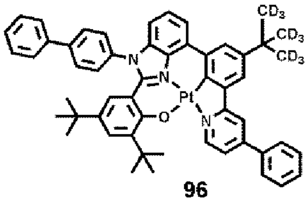
96
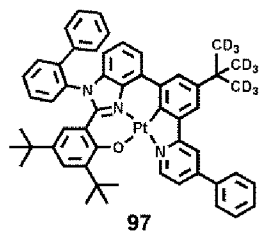
97
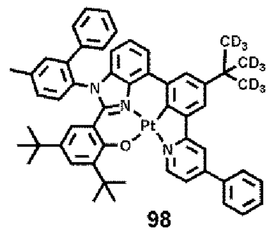
98

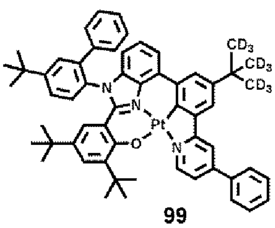
99
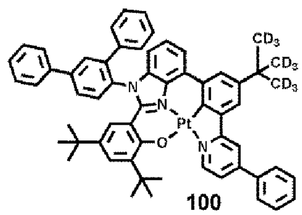
100
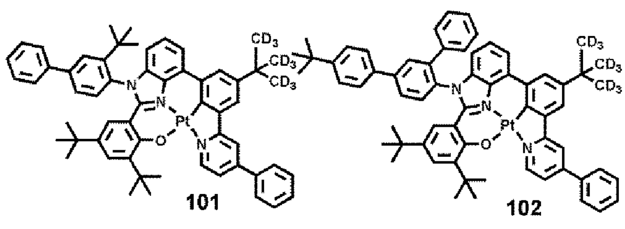
101
102

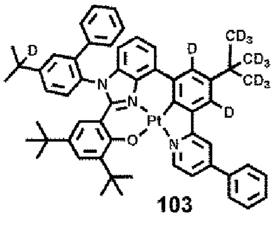
103
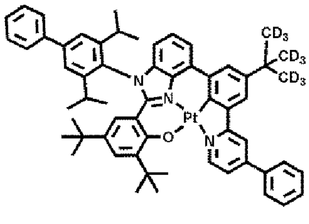
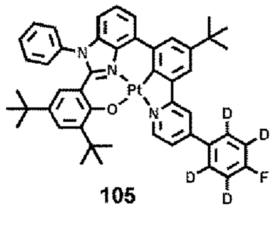
105
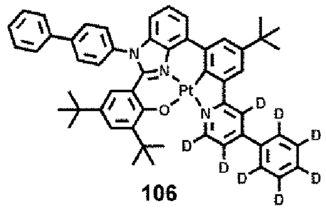
106

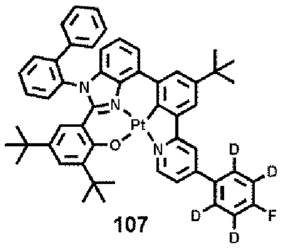
107

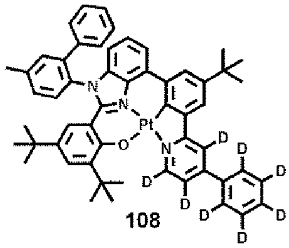
108

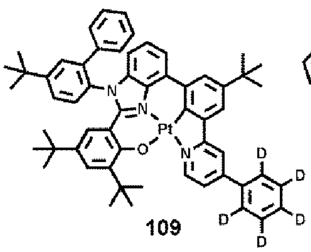
109

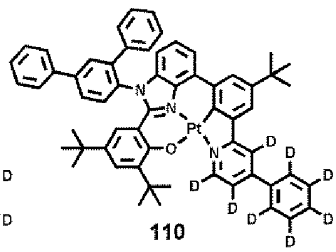
110

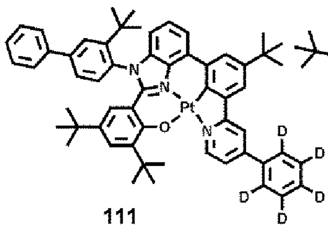
111

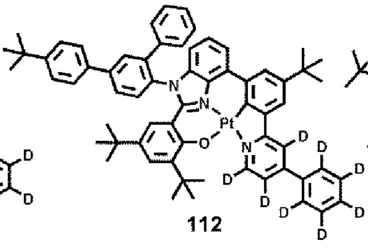
112

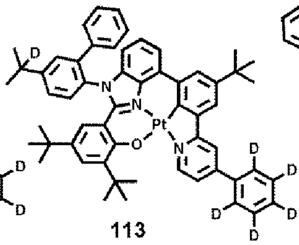
113

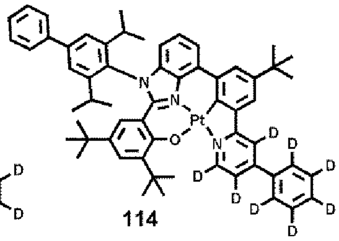
114

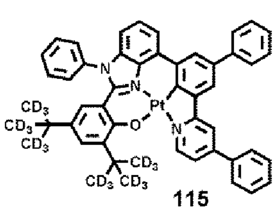
115

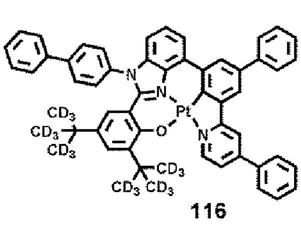
116

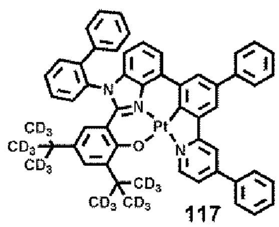
117

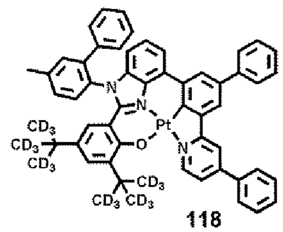
118

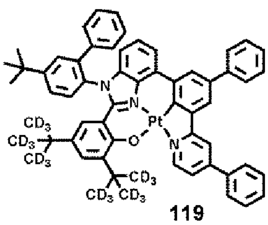
119

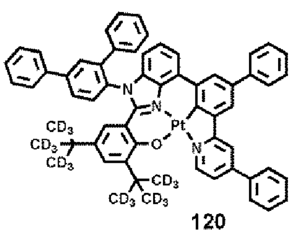
120

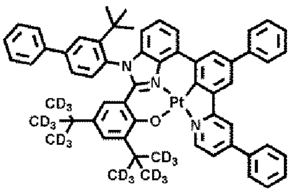
121

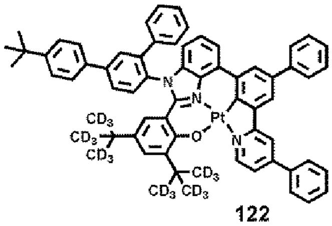
122

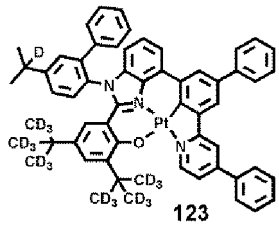
123

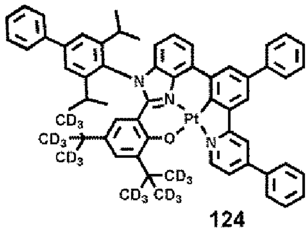
124

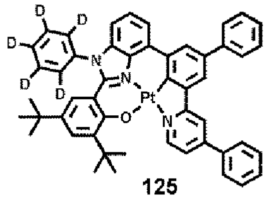
125

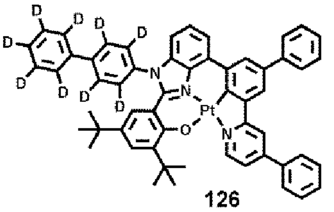
126

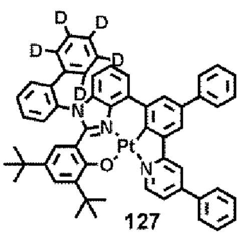
127

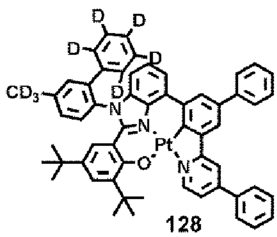
128

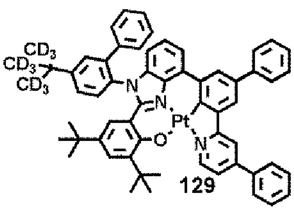
129

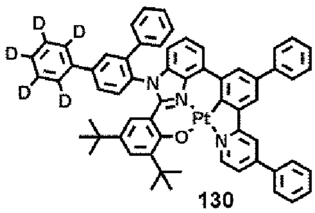
130

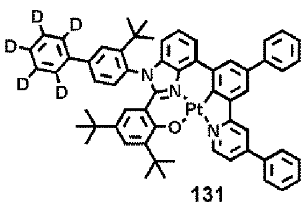
131

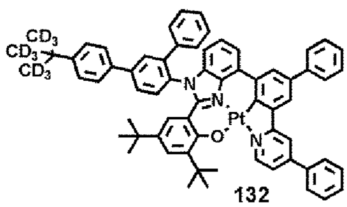
132

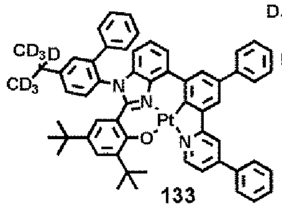
133

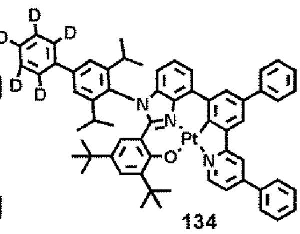
134

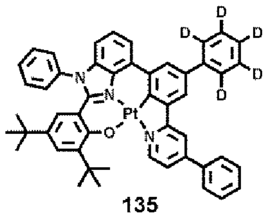
135

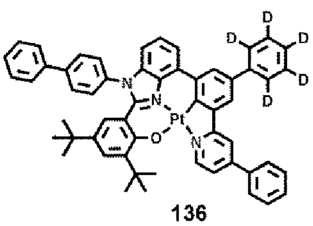
136

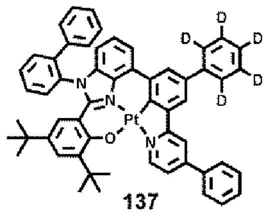
137

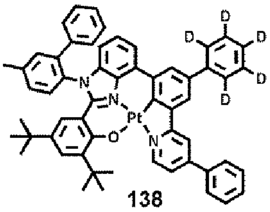
138

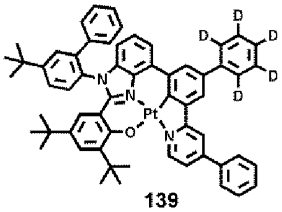
139

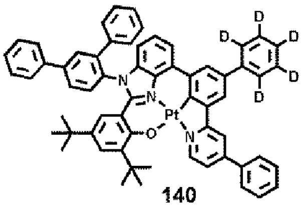
140

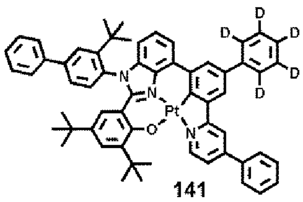
141

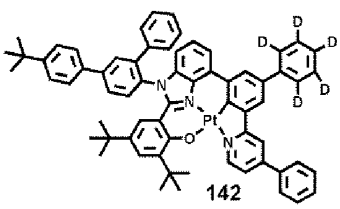
142

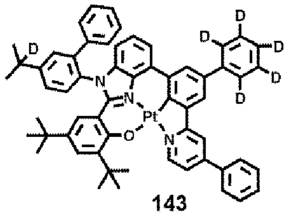
143

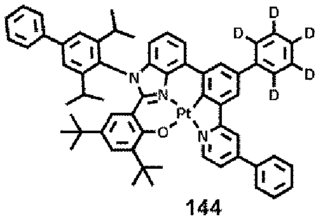
144

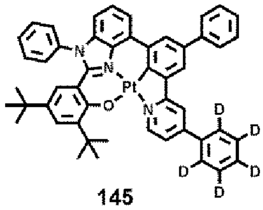
145

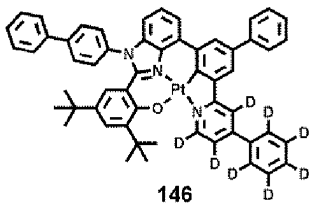
146

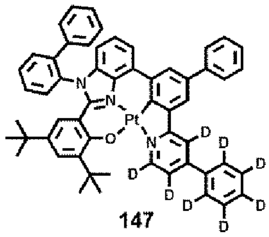
147

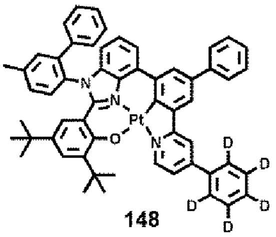
148

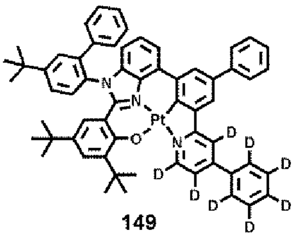
149

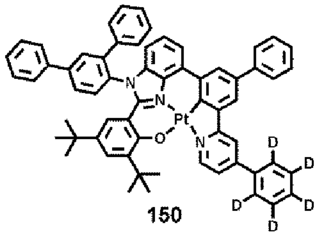
150

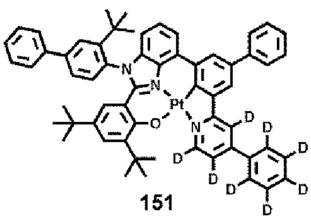
151

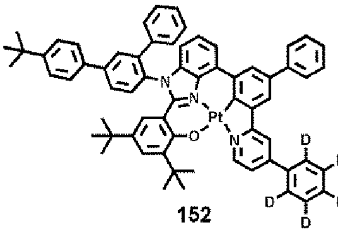
152

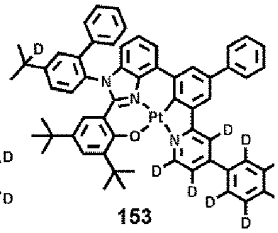
153

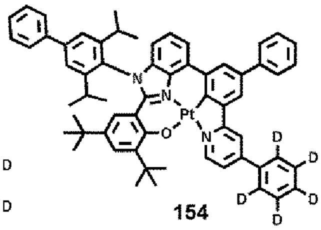
154

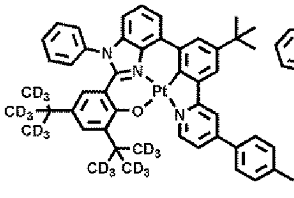
155
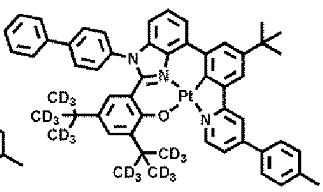
156
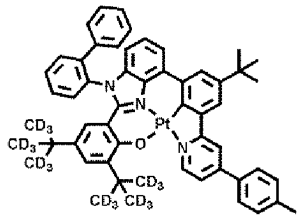
157
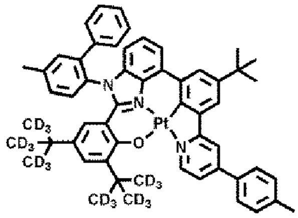
158

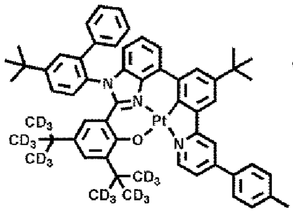
159
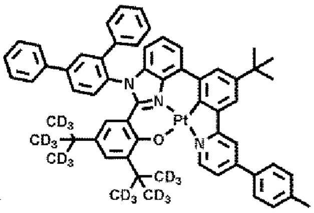
160
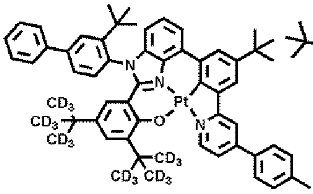
161
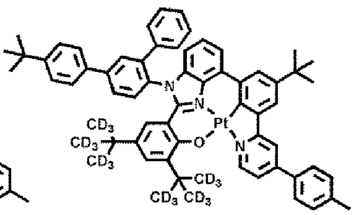
162

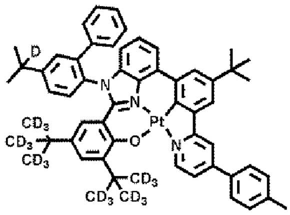
163
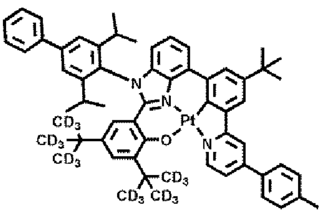
164
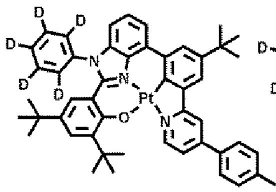
165
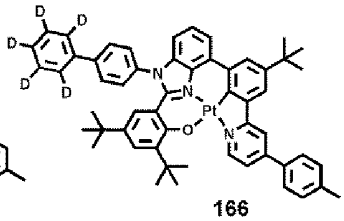
166

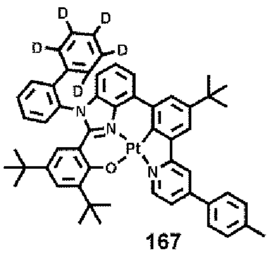
167
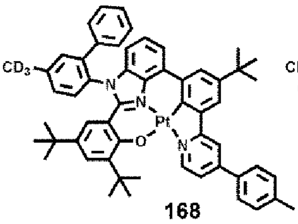
168
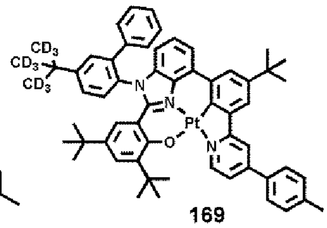
169
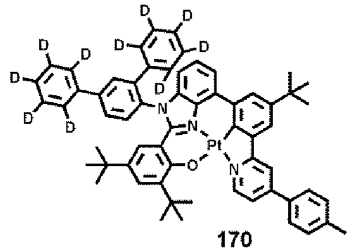
170

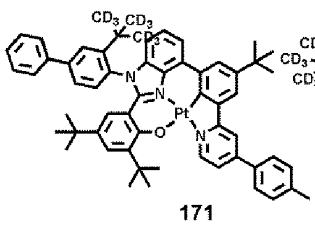
171
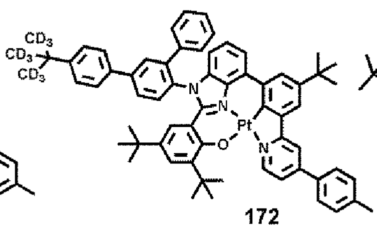
172
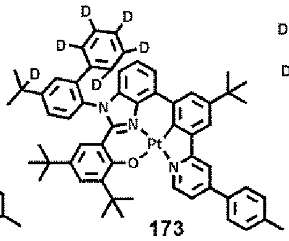
173
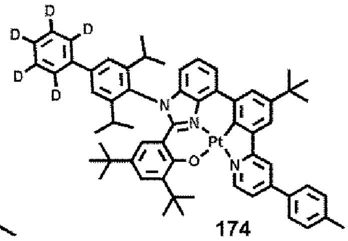
174

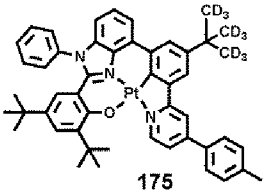
175
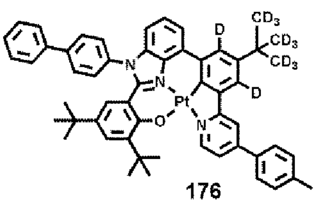
176
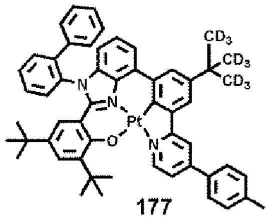
177
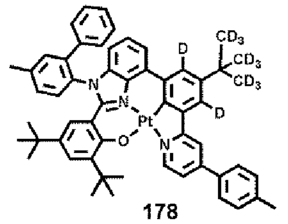
178

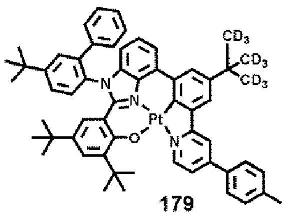

179

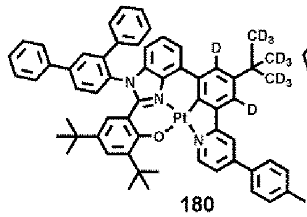

180

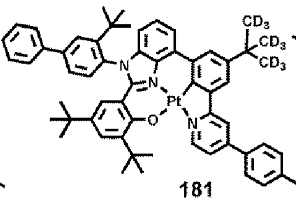

181

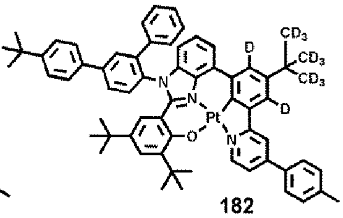

182

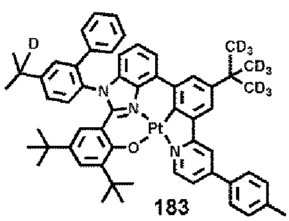

183

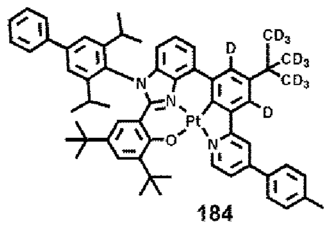

184

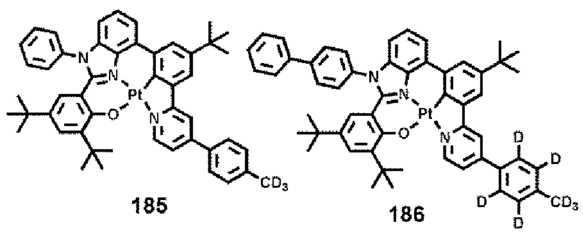

185

186

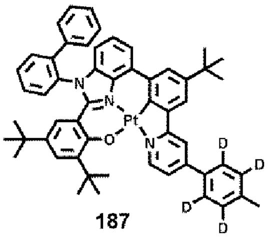

187

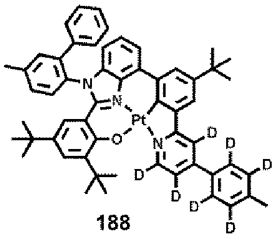

188

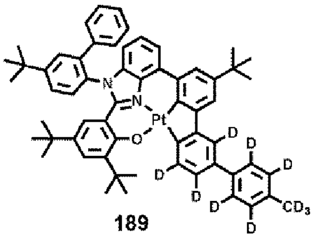

189

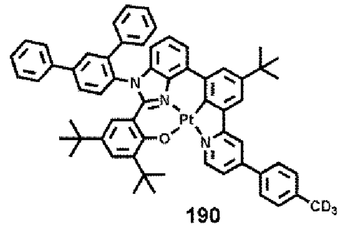

190

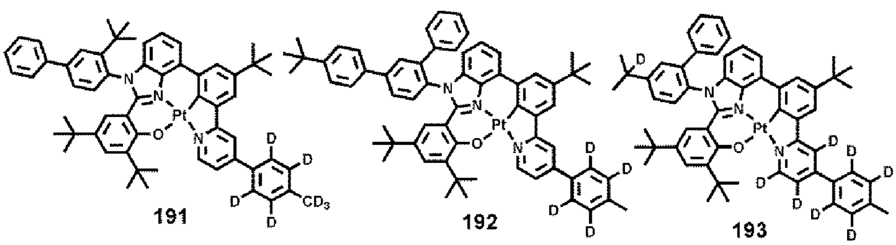

191

192

193

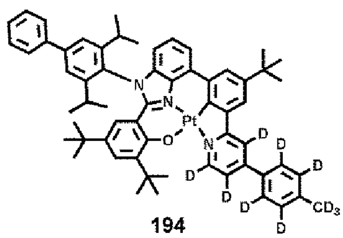

194

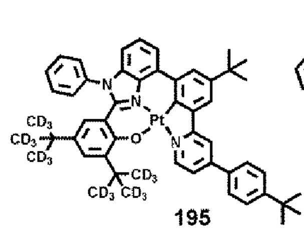

195

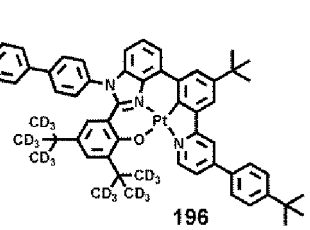

196

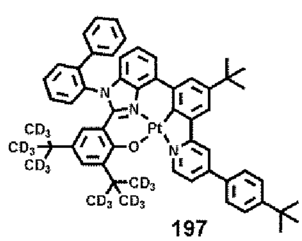

197

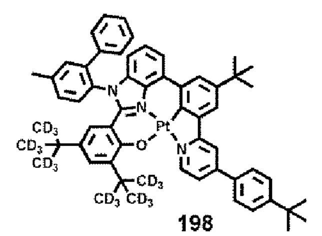

198

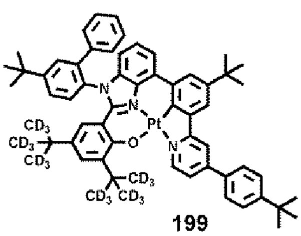

199

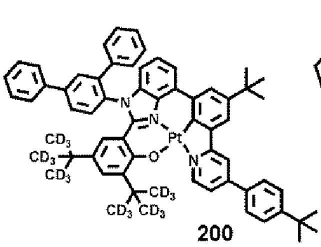

200

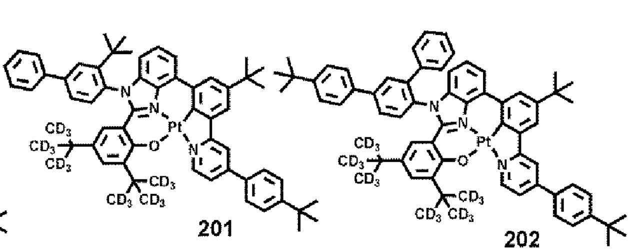

201

202

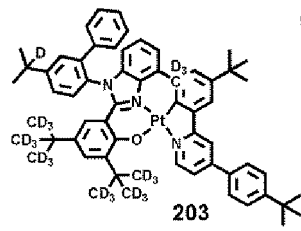

203

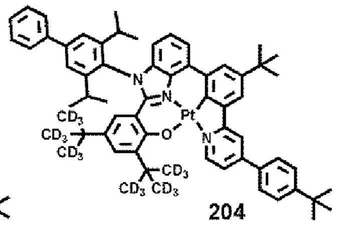

204

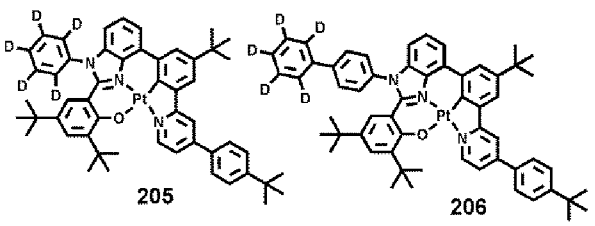

205

206

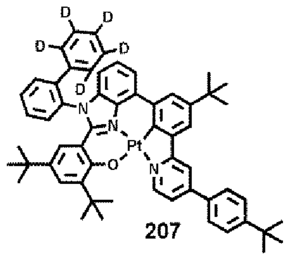

207

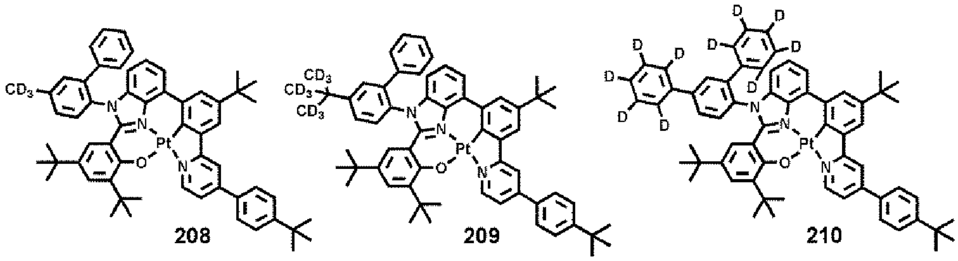

208

209

210

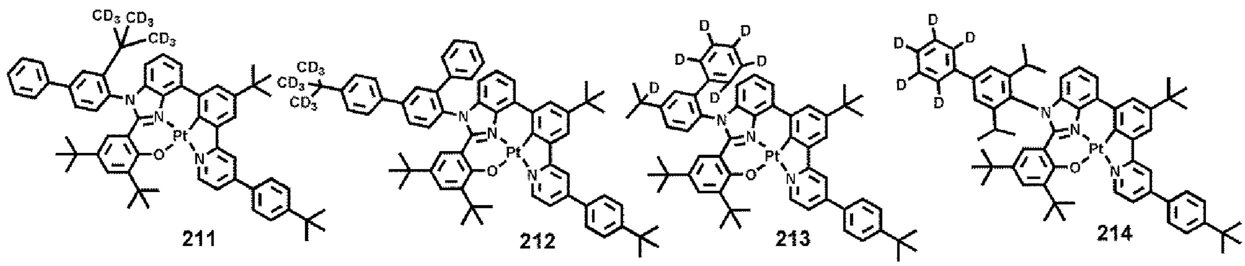

211

212

213

214

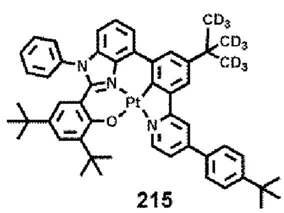

215

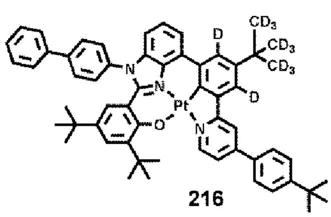

216

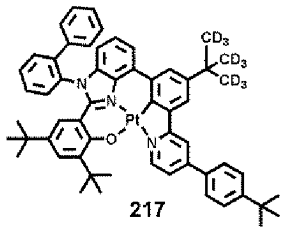

217

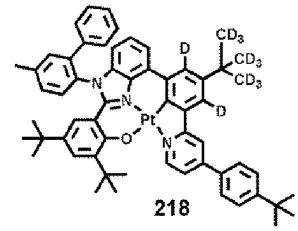

218

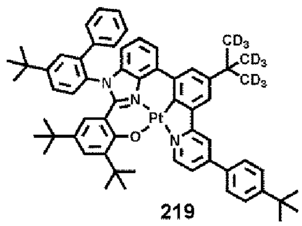

219

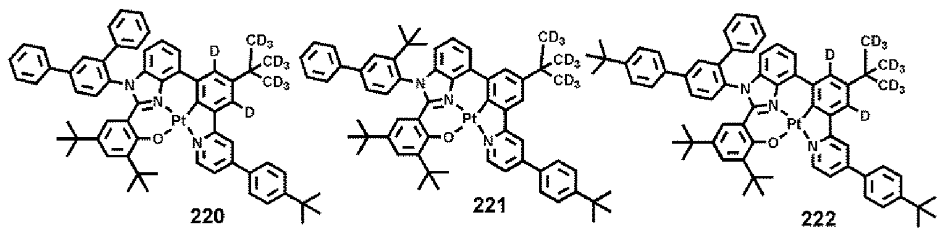

220

221

222

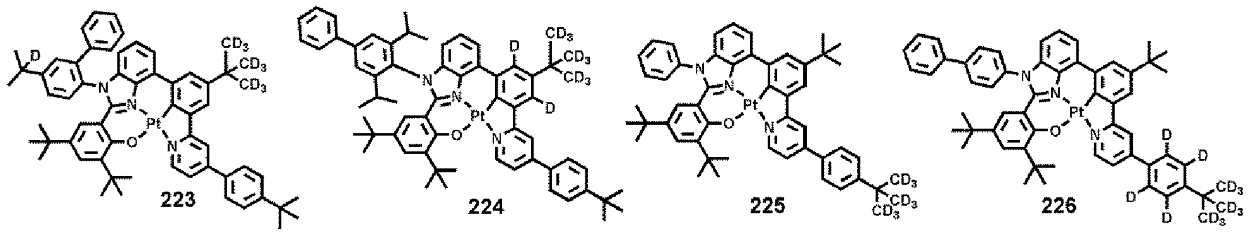

223

224

225

226

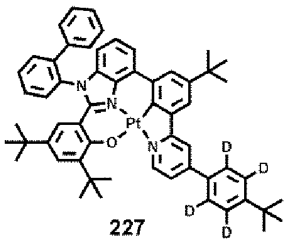

227

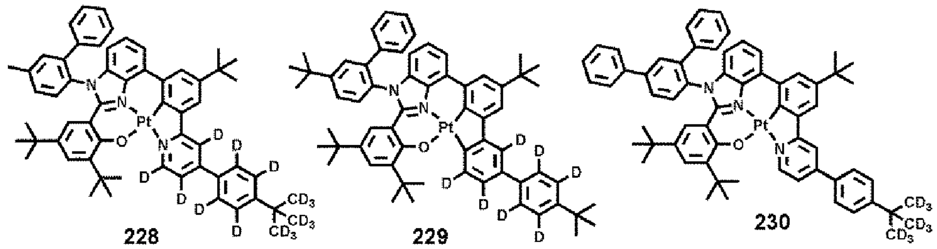

228 229 230

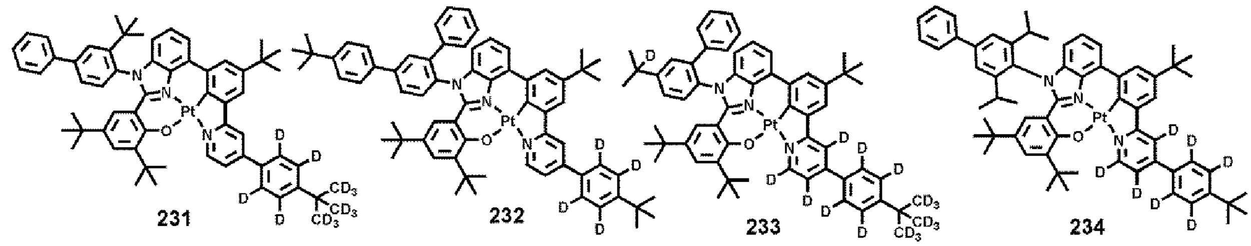

231 232 233 234

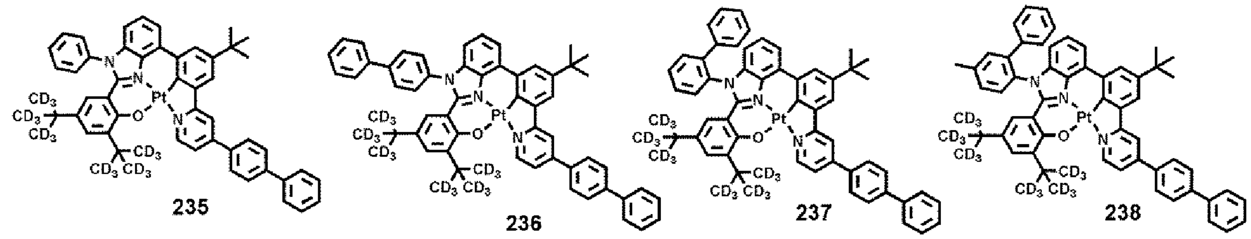

235 236 237 238

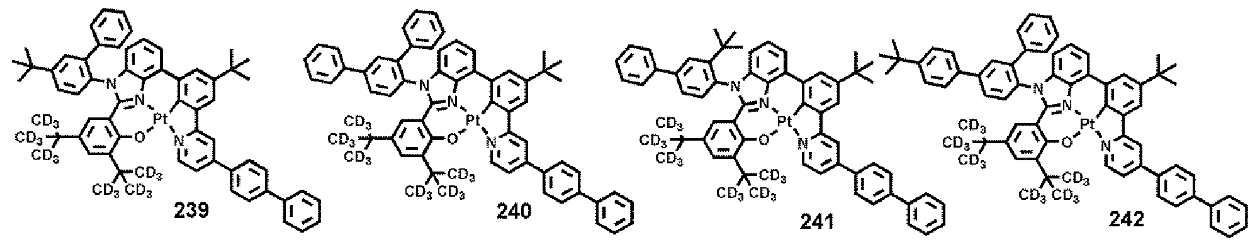

239 240 241 242

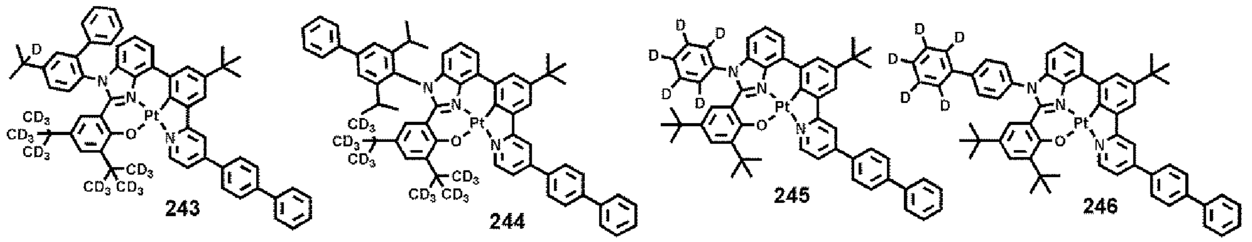

243 244 245 246

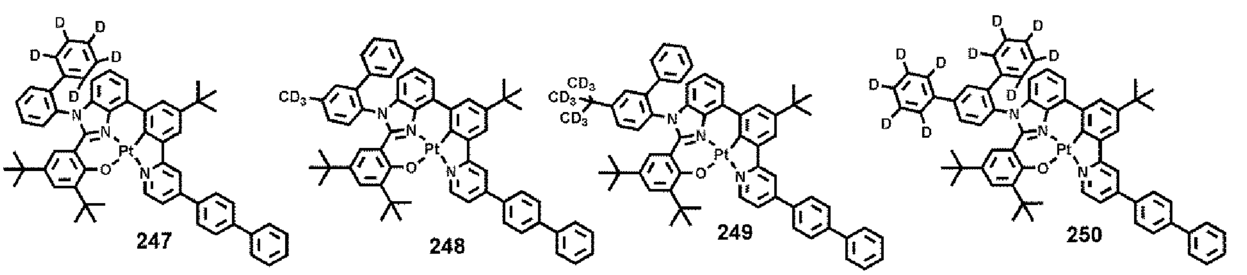

247 248 249 250

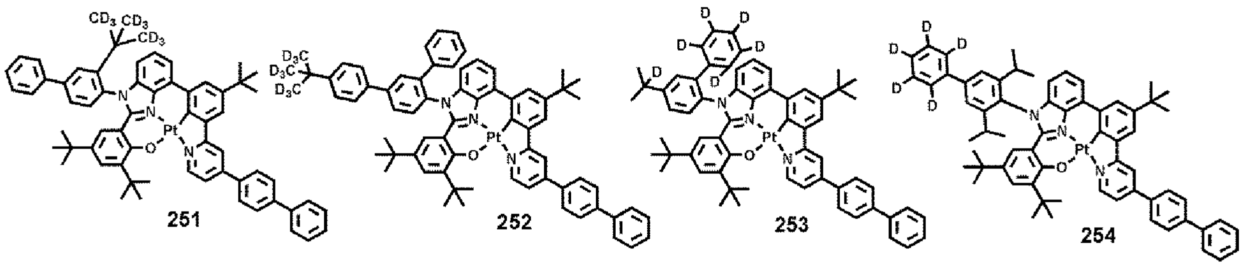

251 252 253 254

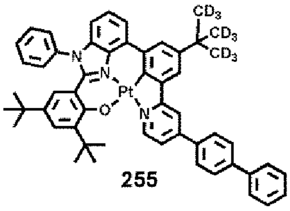

255

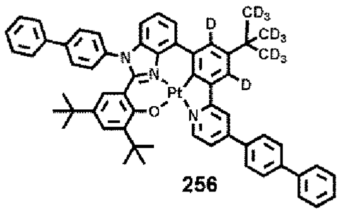

256

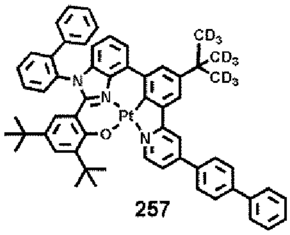

257

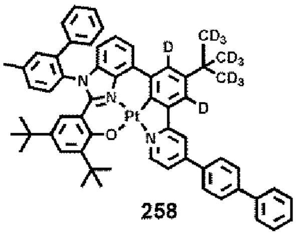

258

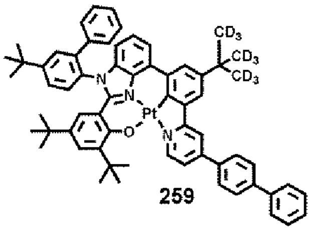

259

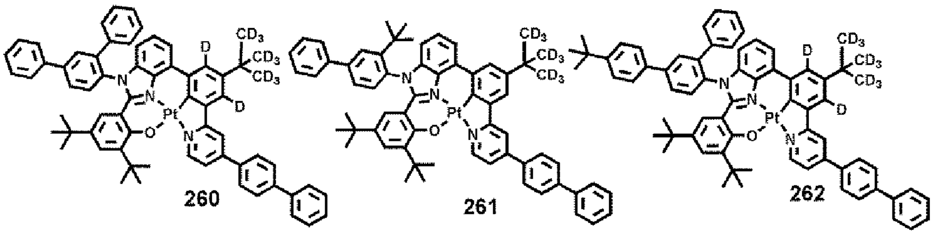

260 261 262

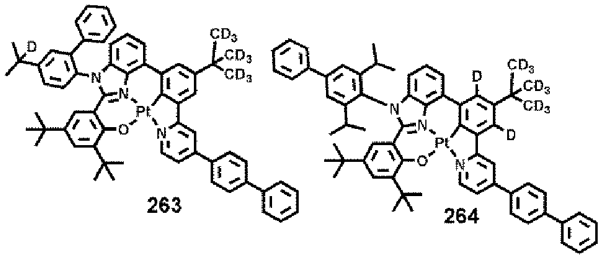

263 264

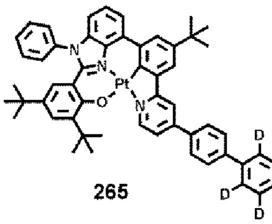

265

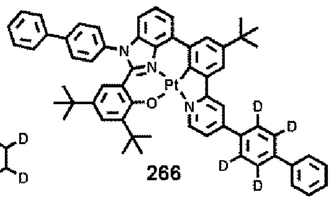

266

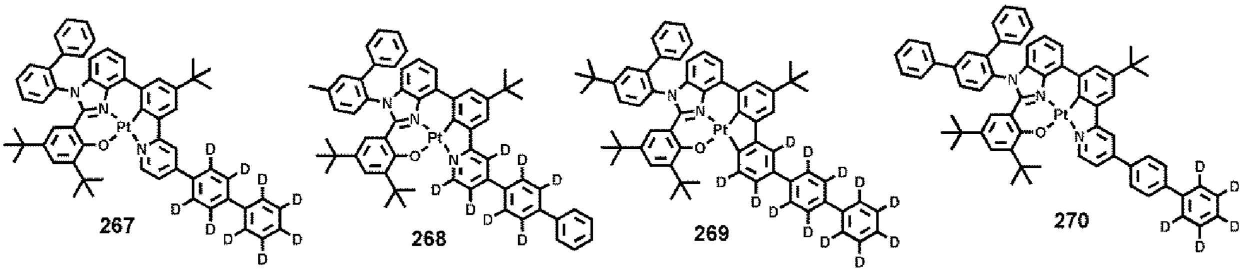

267 268 269 270

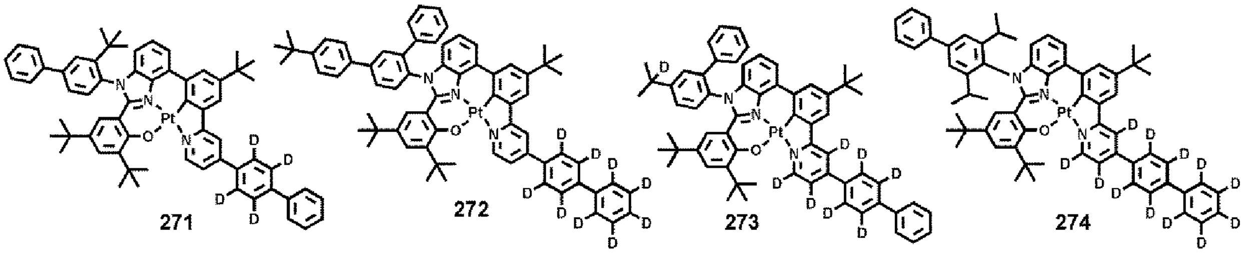

271 272 273 274

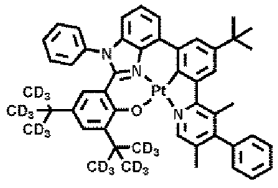

275

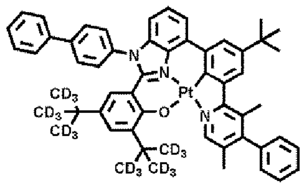

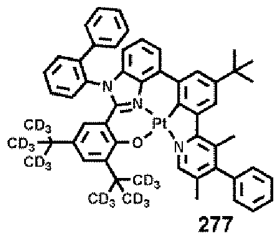

277

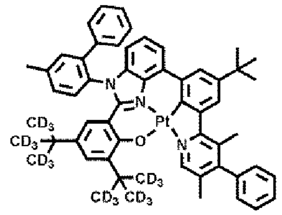

278

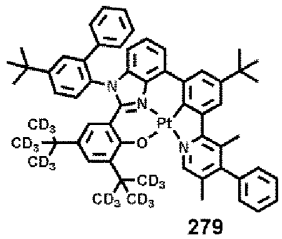

279

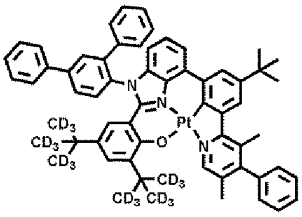

280

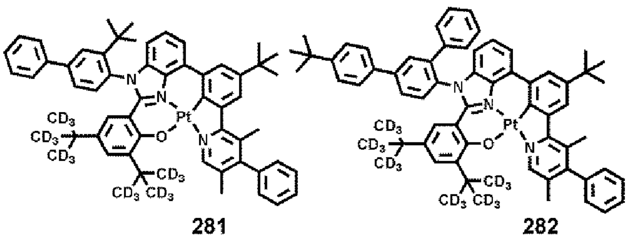

281

282

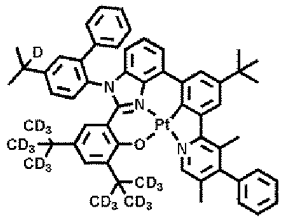

283

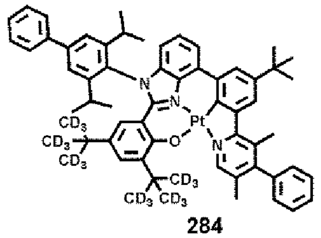

284

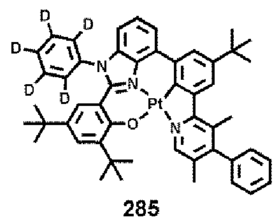

285

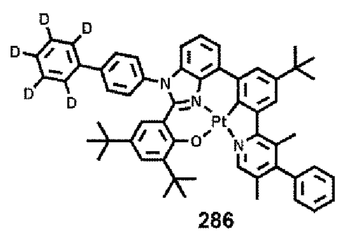

286

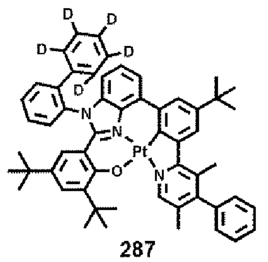

287

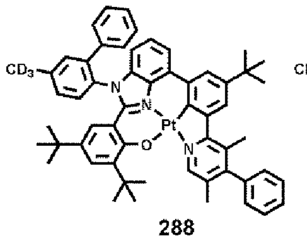

288

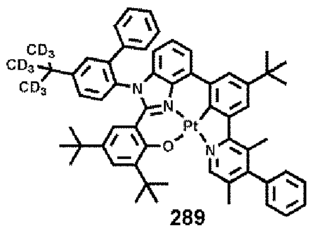

289

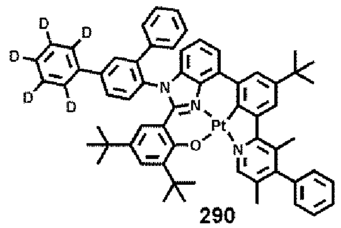

290

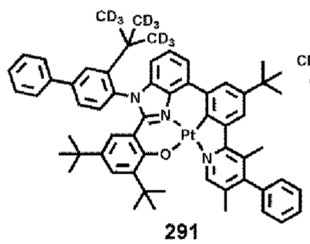

291

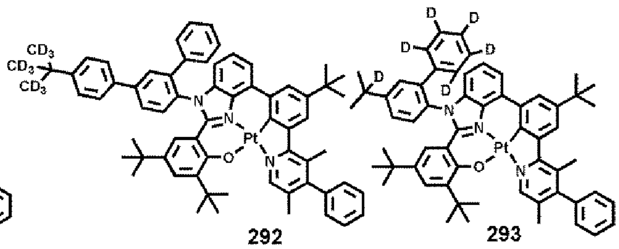

292

293

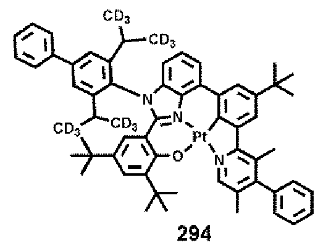

294

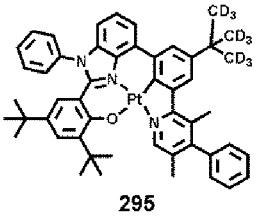

295

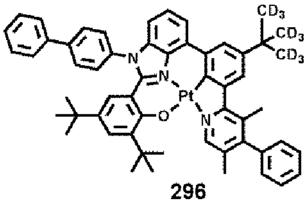

296

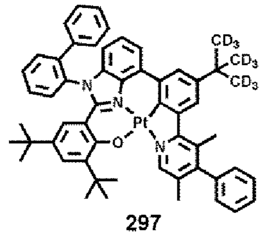

297

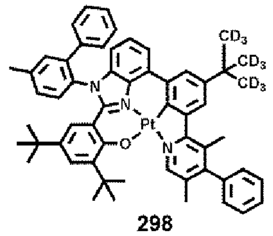

298

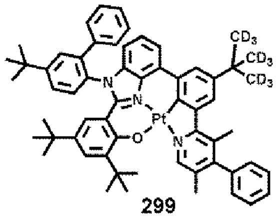
299
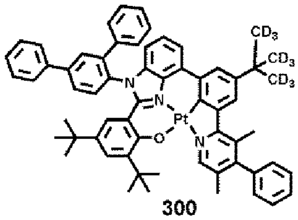
300
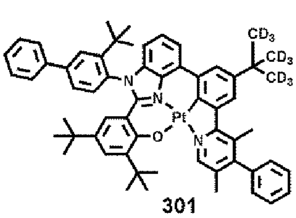
301
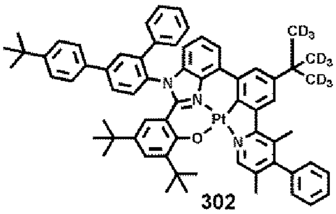
302

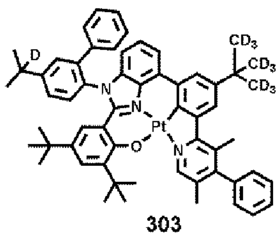
303
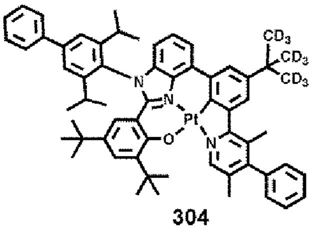
304
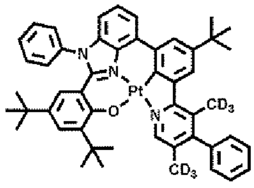
305
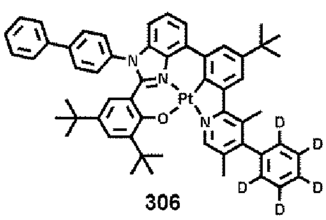
306

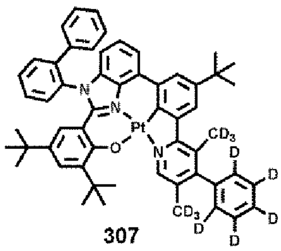
307
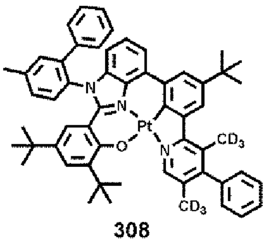
308
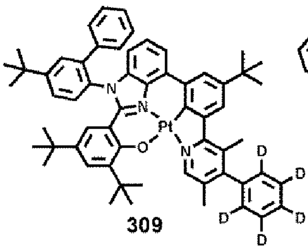
309
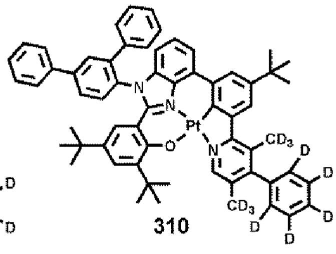
310

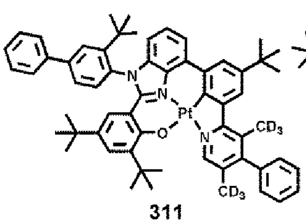
311
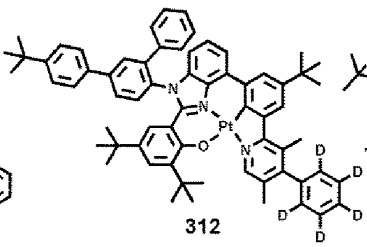
312
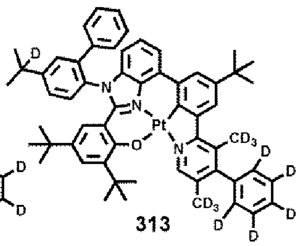
313
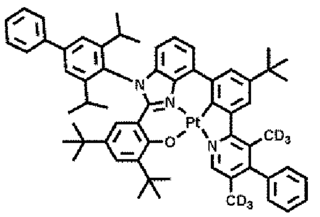
314

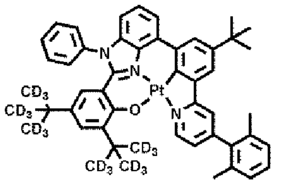
315
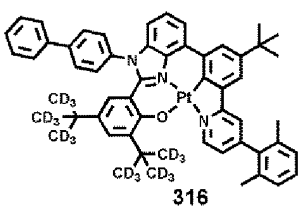
316
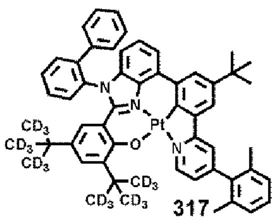
317
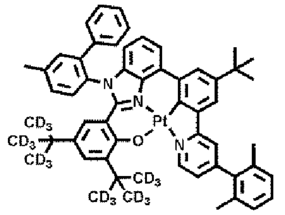
318

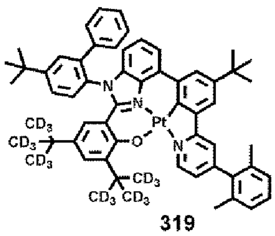
319
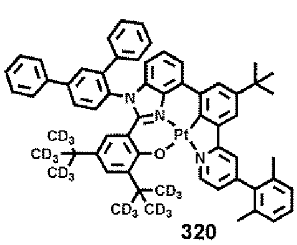
320
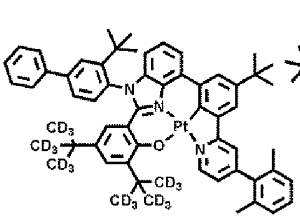
321
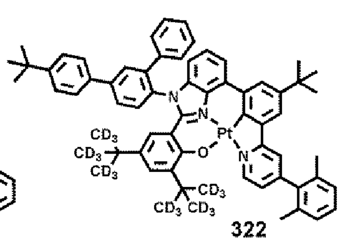
322

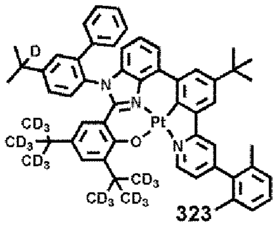
323

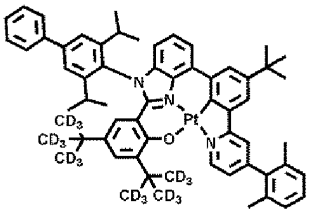
324

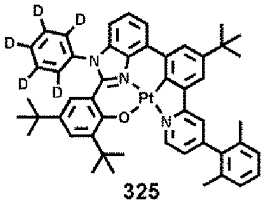
325

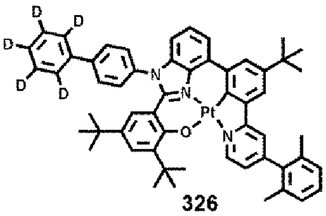
326

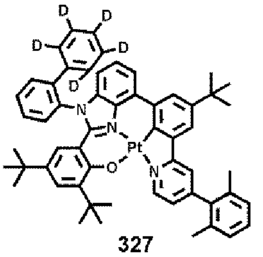
327

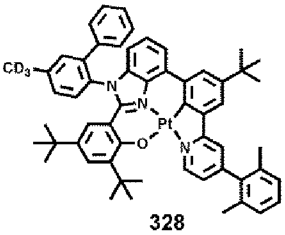
328

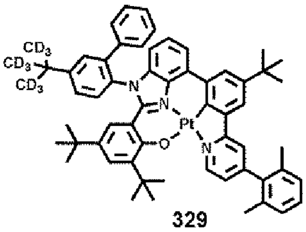
329

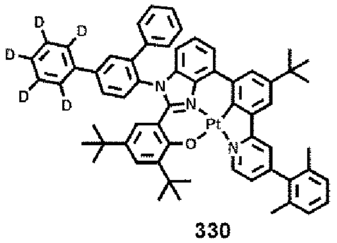
330

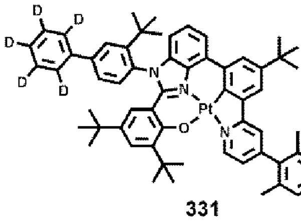
331

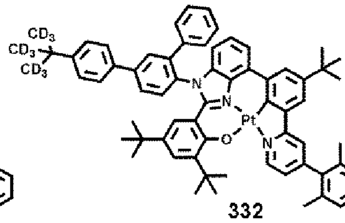
332

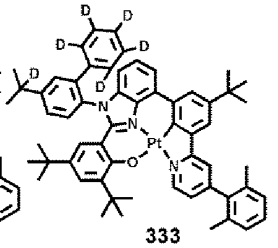
333

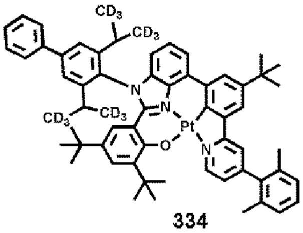
334

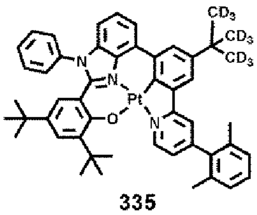
335

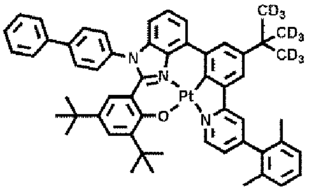
336

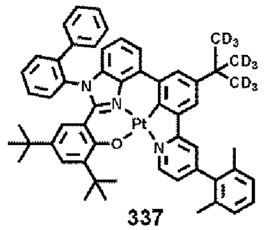
337

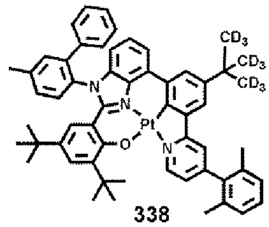
338

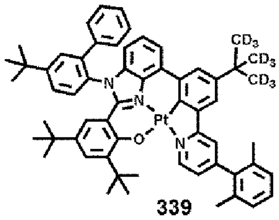
339

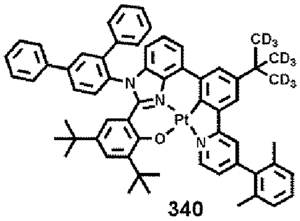
340

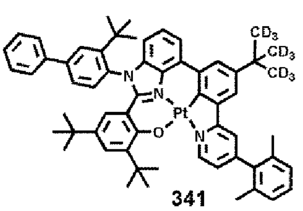
341

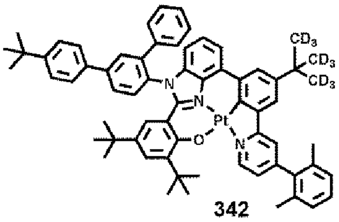
342

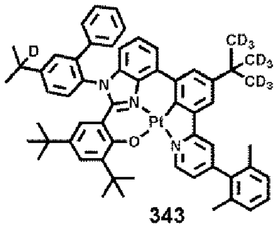
343

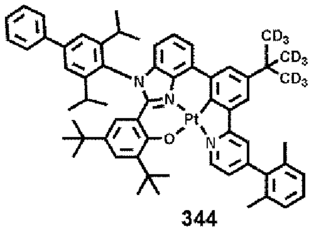
344

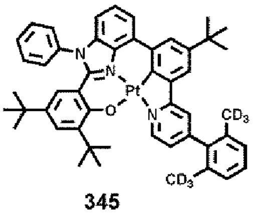
345

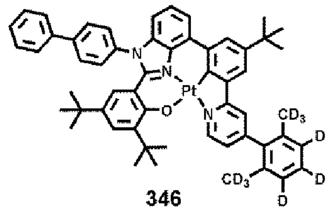
346

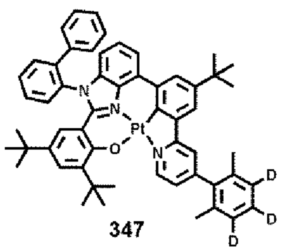
347

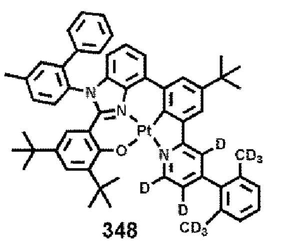
348

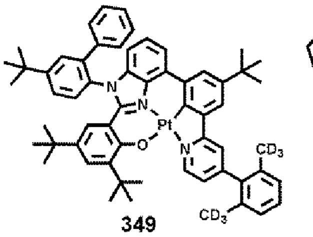
349

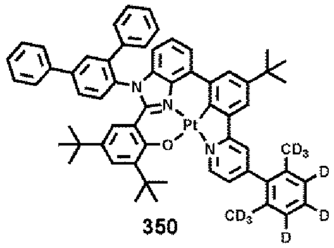
350

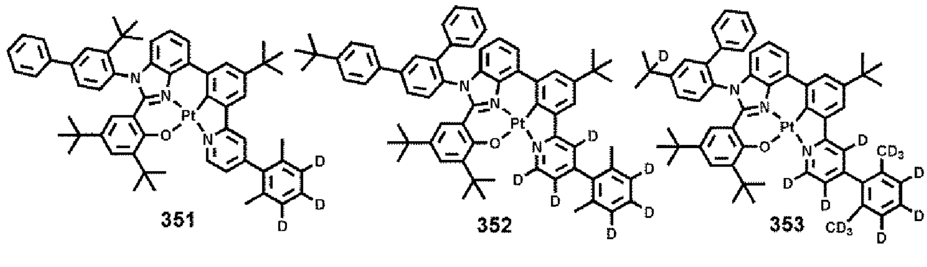
351

352

353

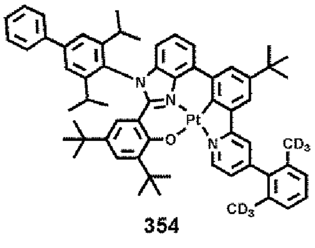
354

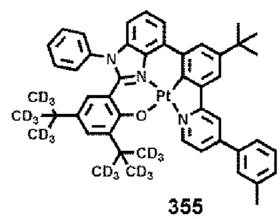
355

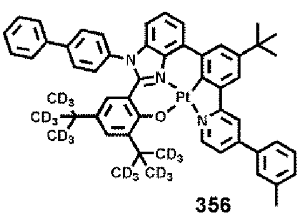
356

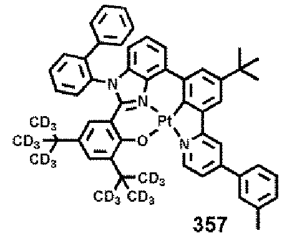
357

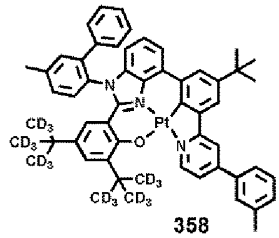
358

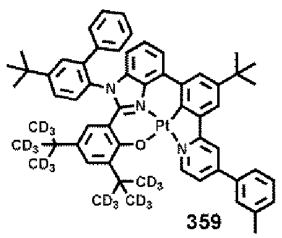
359

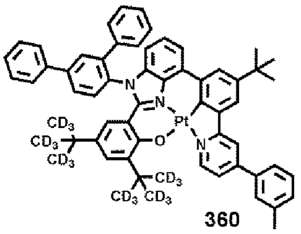
360

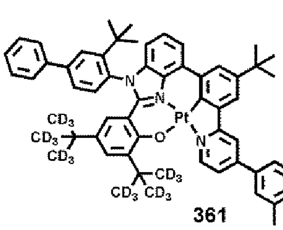
361

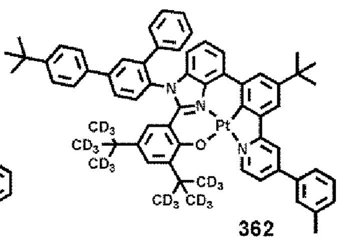
362

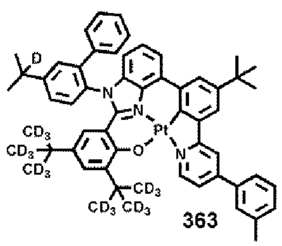
363

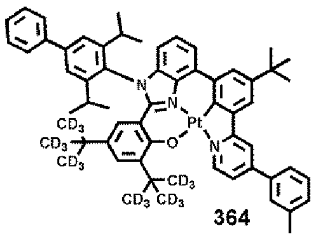
364

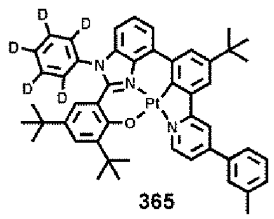
365

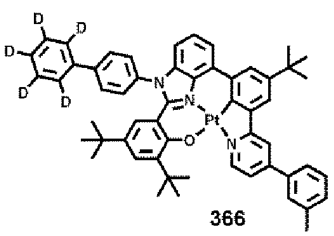
366

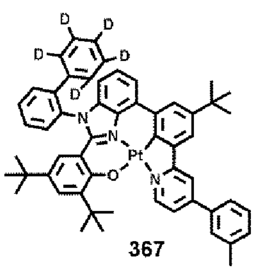
367

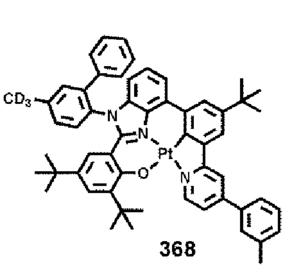
368

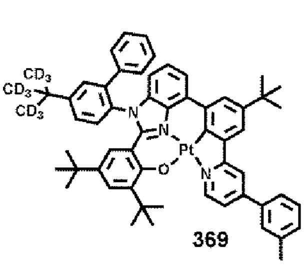
369

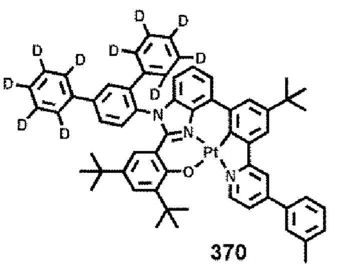
370

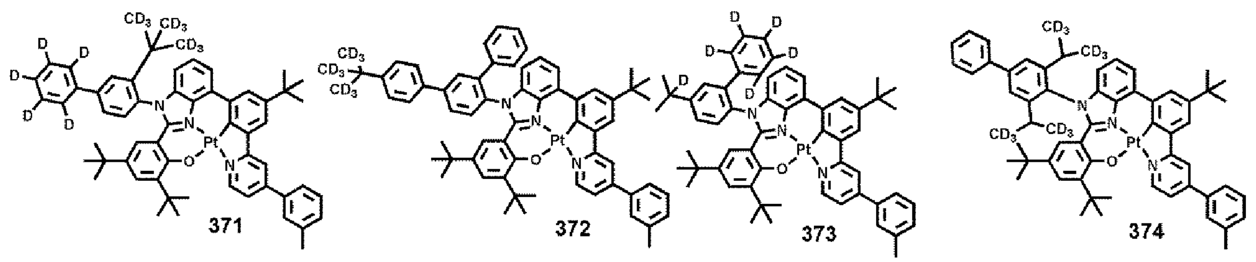

371 372 373 374

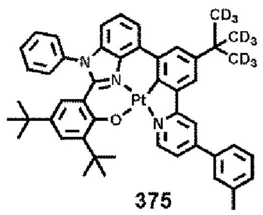

375

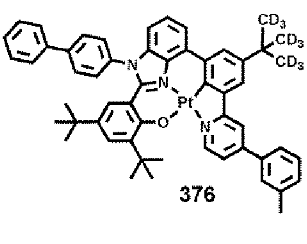

376

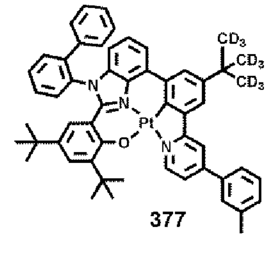

377

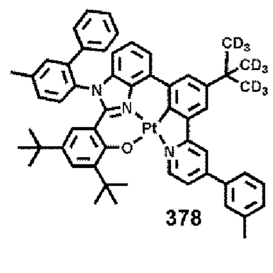

378

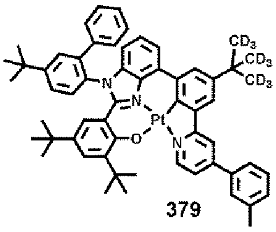

379

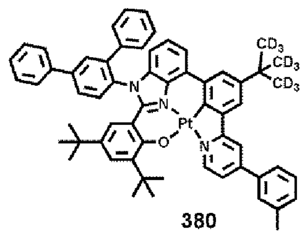

380

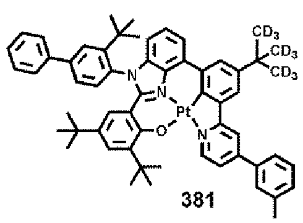

381

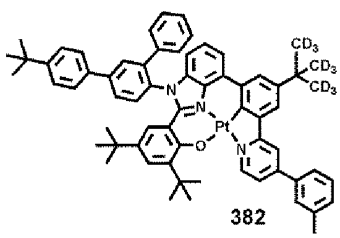

382

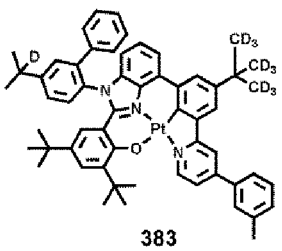

383

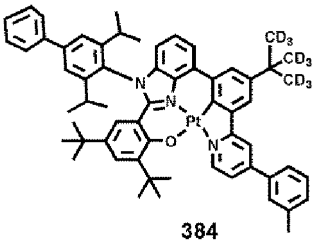

384

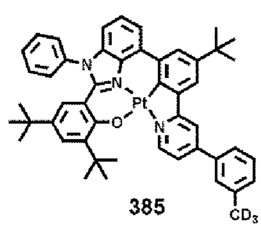

385

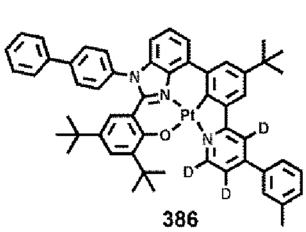

386

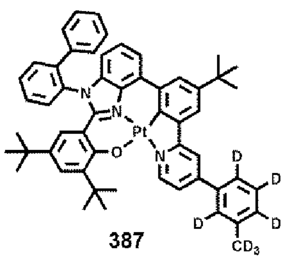

387

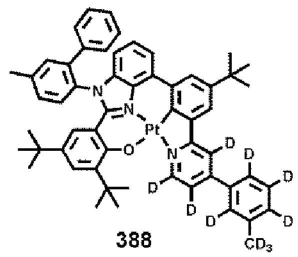

388

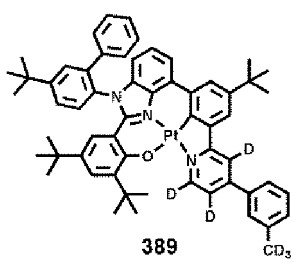

389

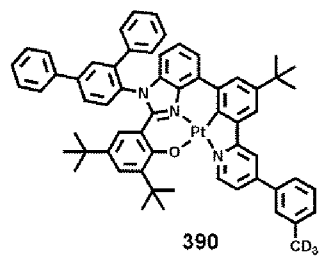

390

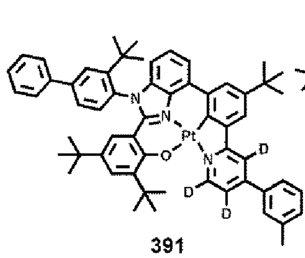

391

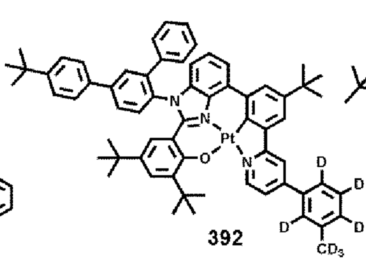

392

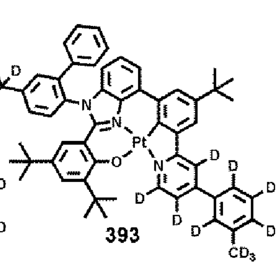

393

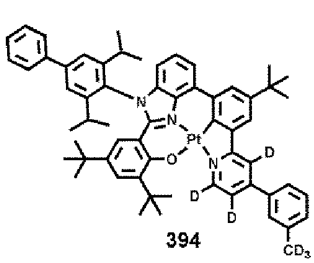

394

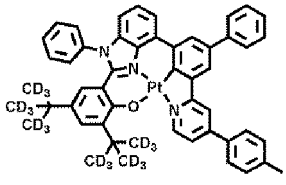
395
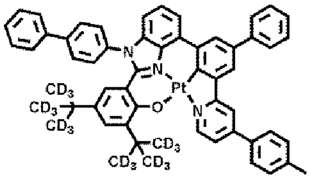
396
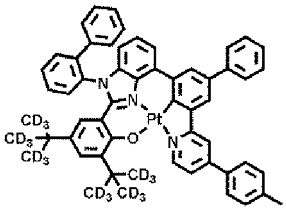
397
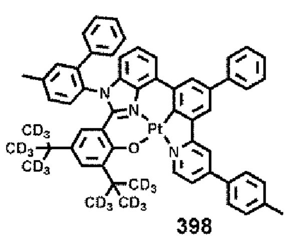
398

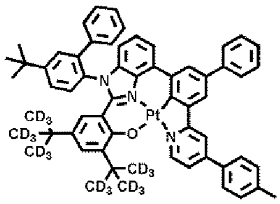
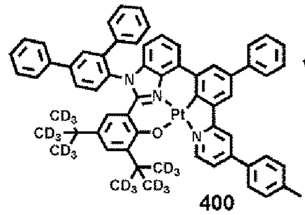
400
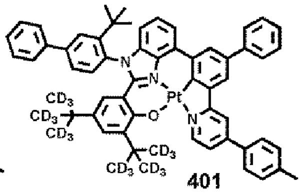
401
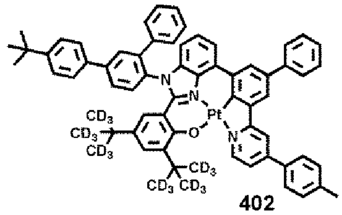
402

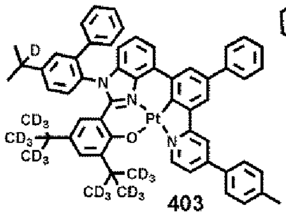
403
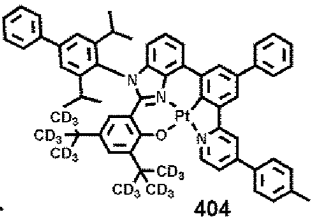
404
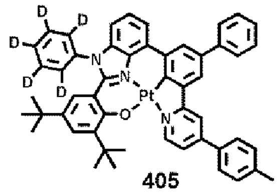
405
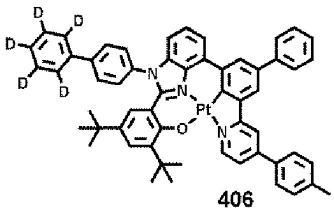
406

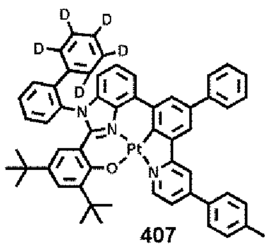
407
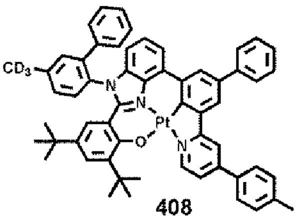
408
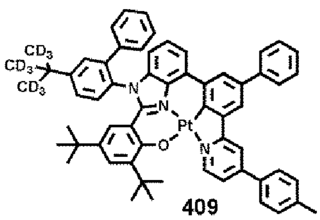
409
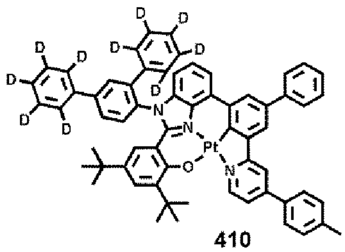
410

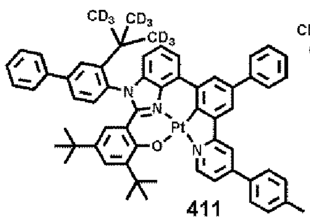
411
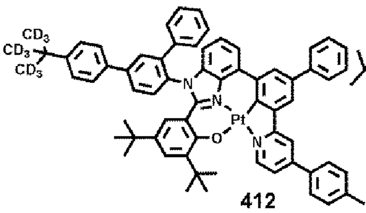
412
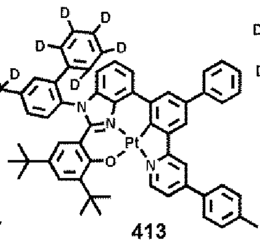
413
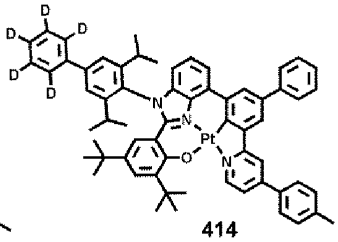
414

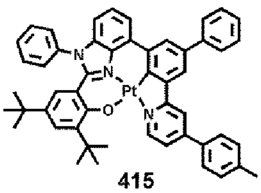
415
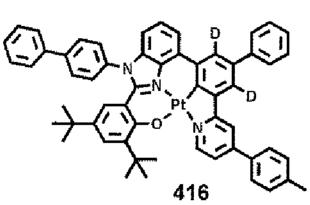
416
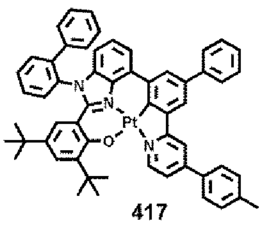
417
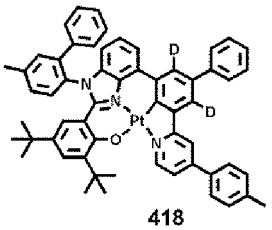
418

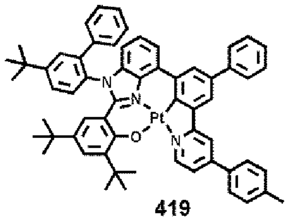
419
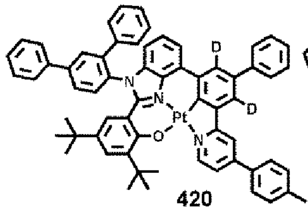
420
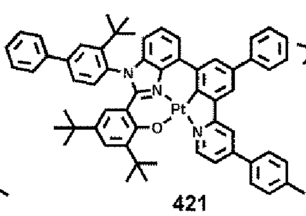
421
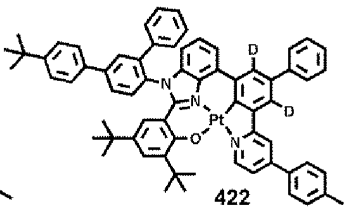
422

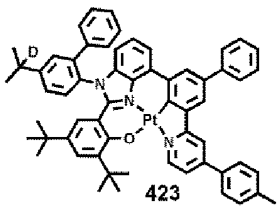
423
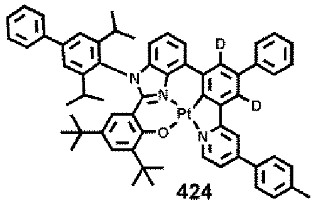
424
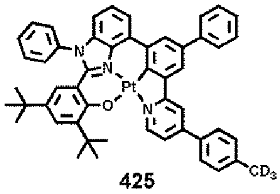
425
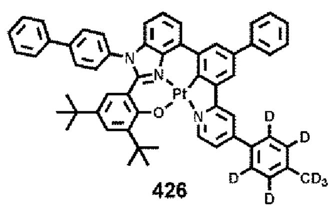
426

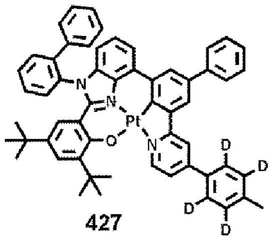
427
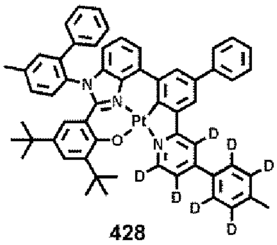
428
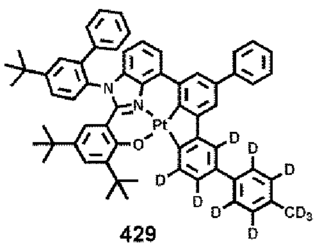
429
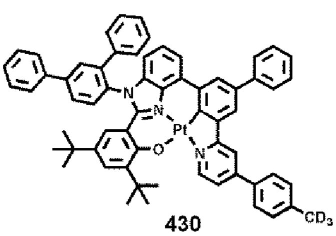
430

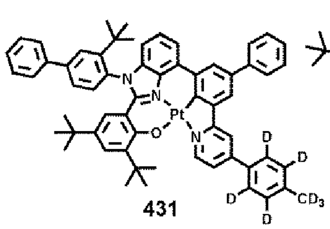
431
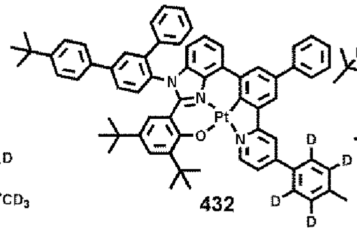
432
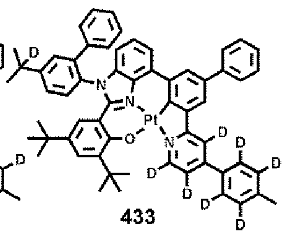
433
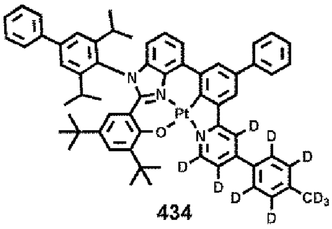
434

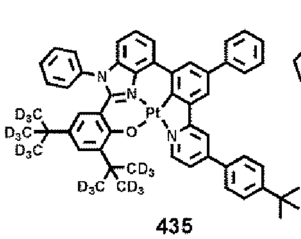
435
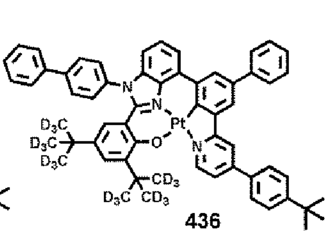
436
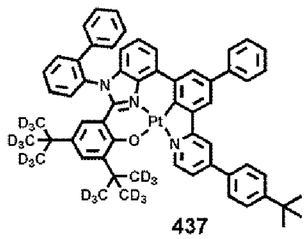
437
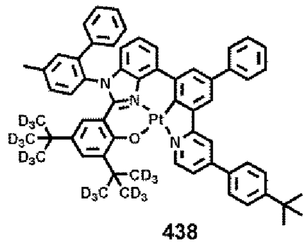
438

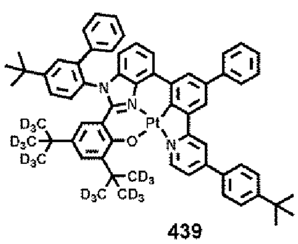
439
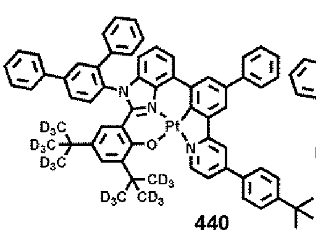
440
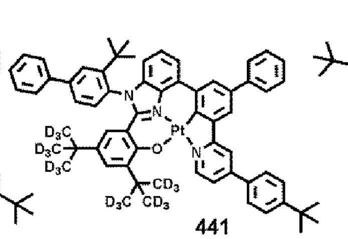
441
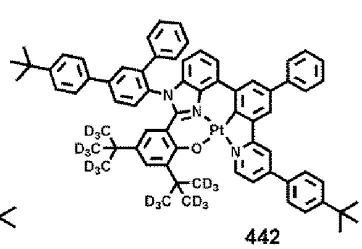
442

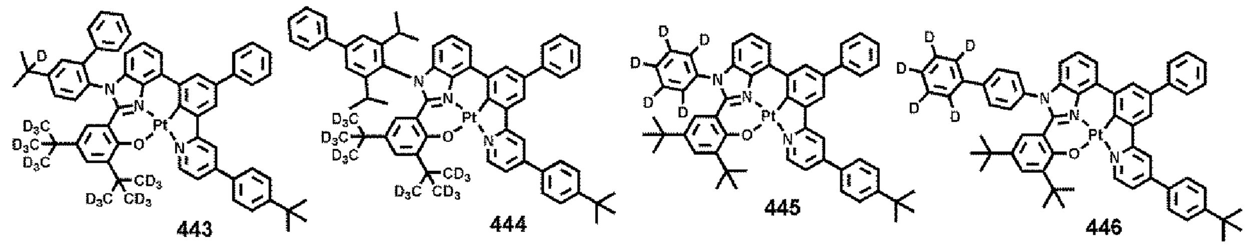

443 444 445 446

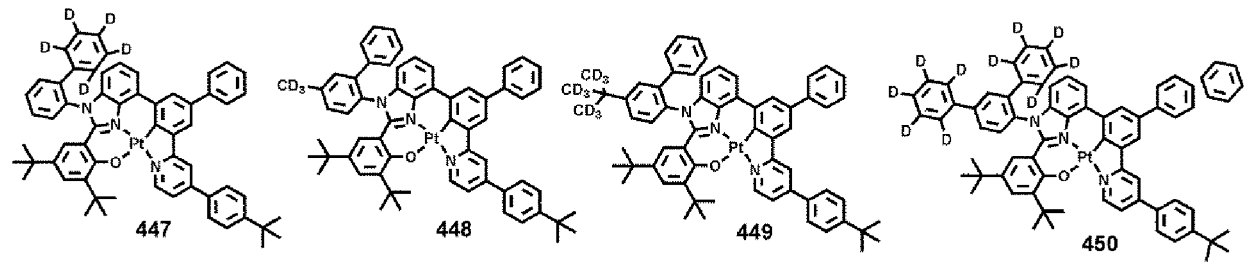

447 448 449 450

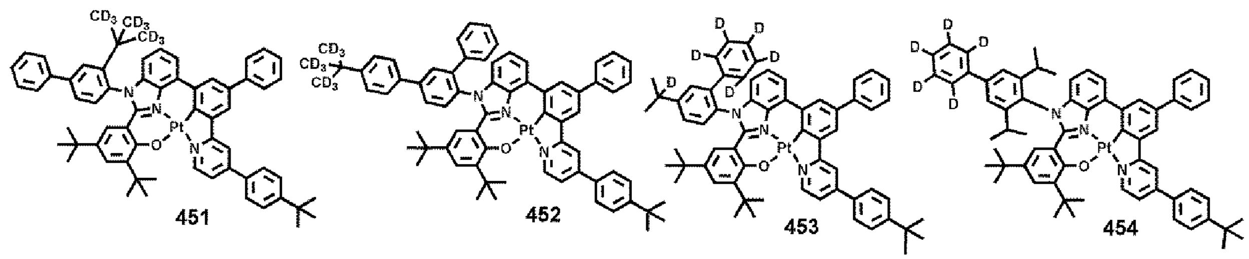

451 452 453 454

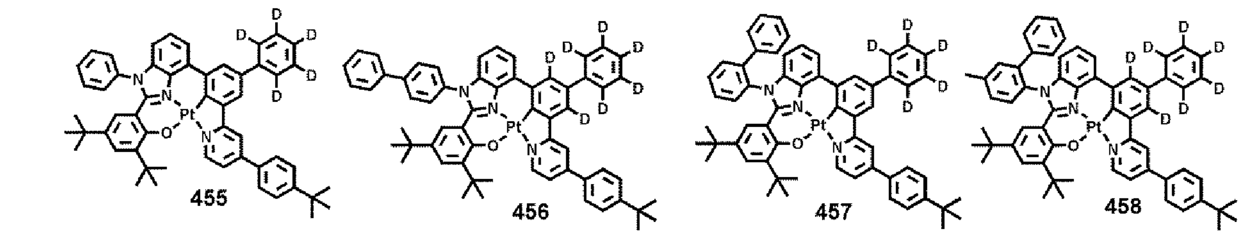

455 456 457 458

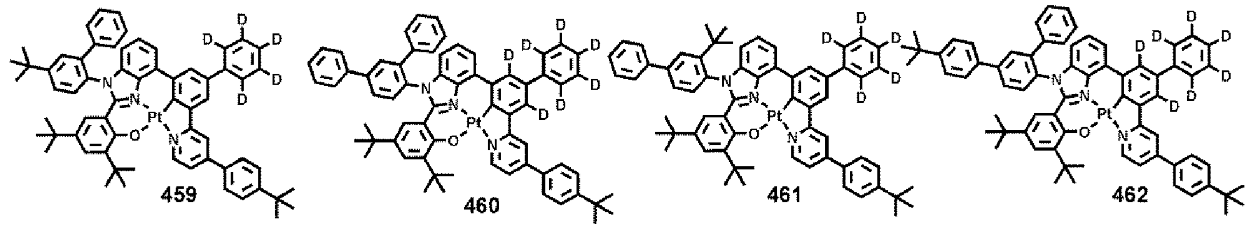

459 460 461 462

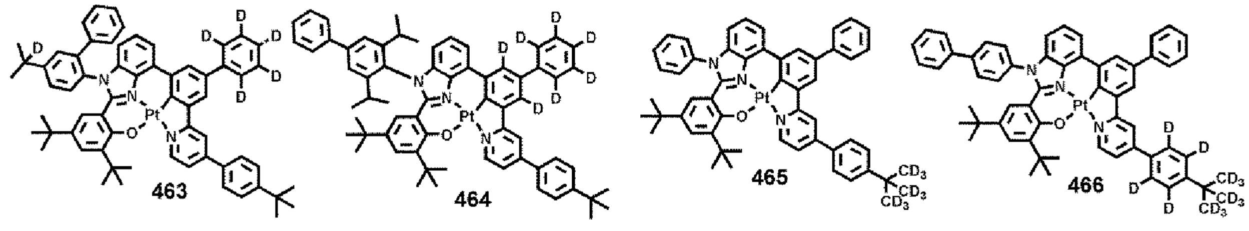

463 464 465 466

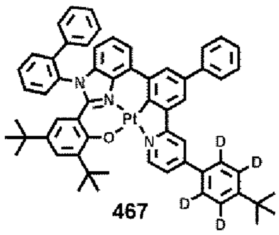
467
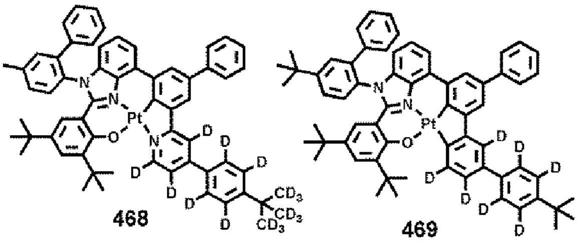
468 469
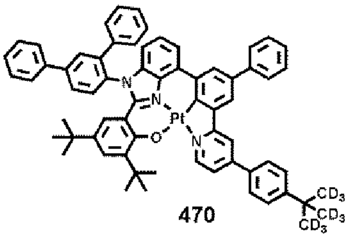
470

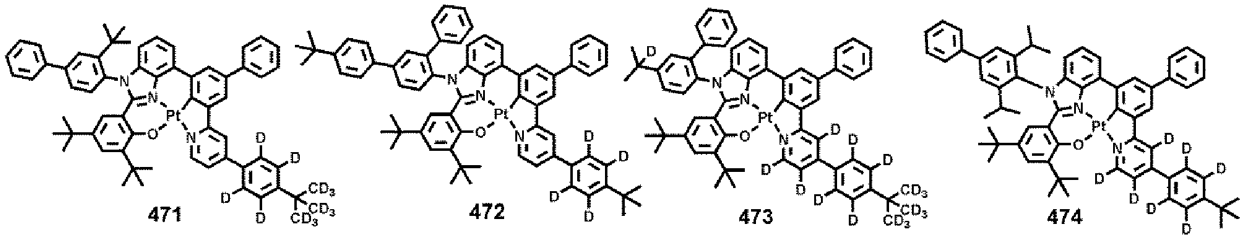
471 472 473 474

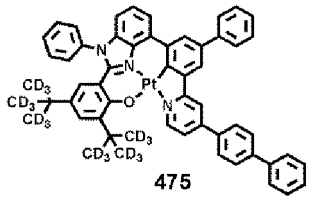
475
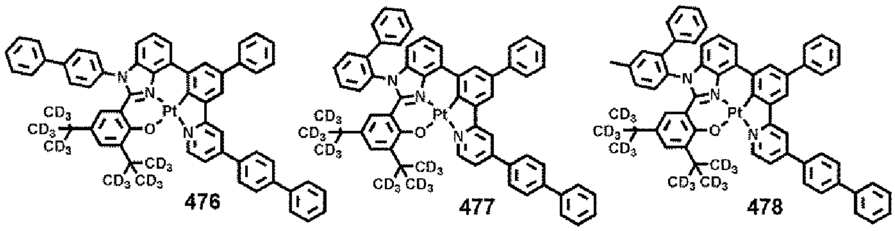
476 477 478

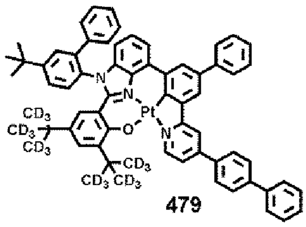
479
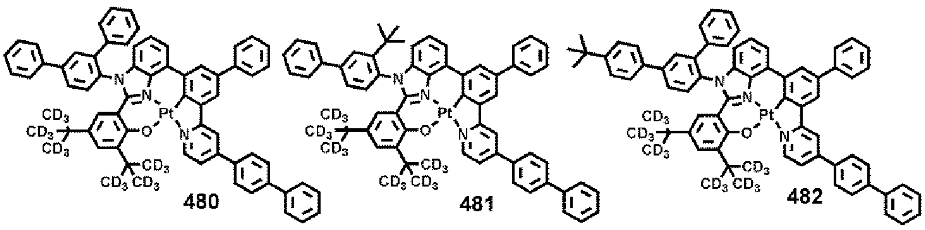
480 481 482

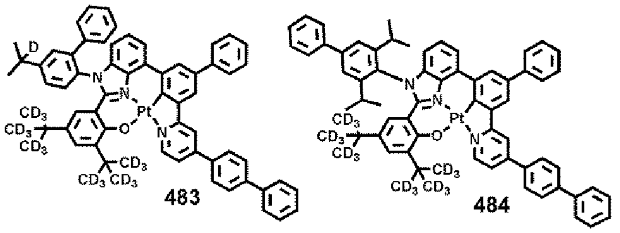
483 484
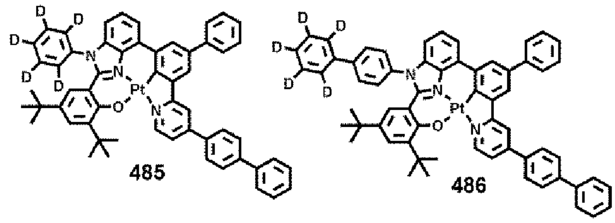
485 486

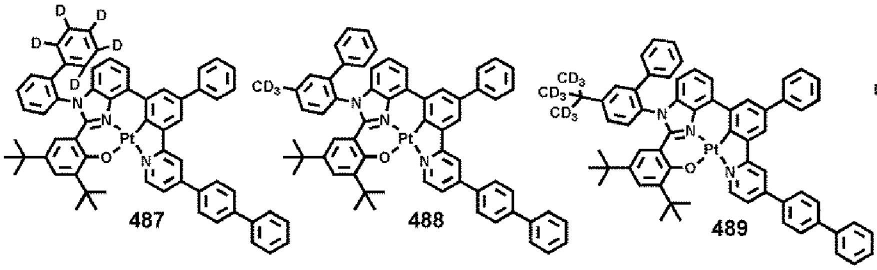
487 488 489
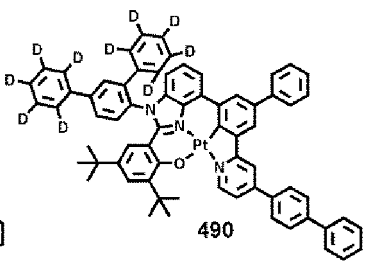
490

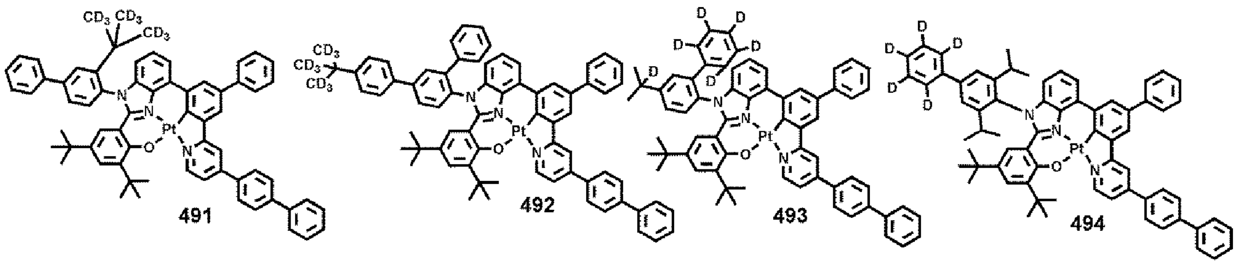

491 492 493 494

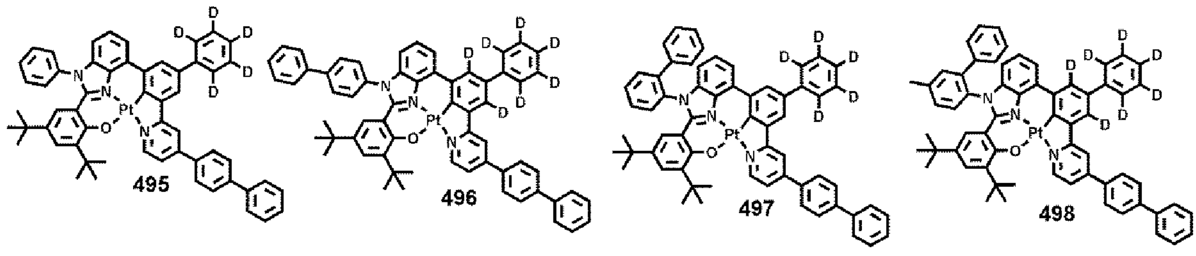

495 496 497 498

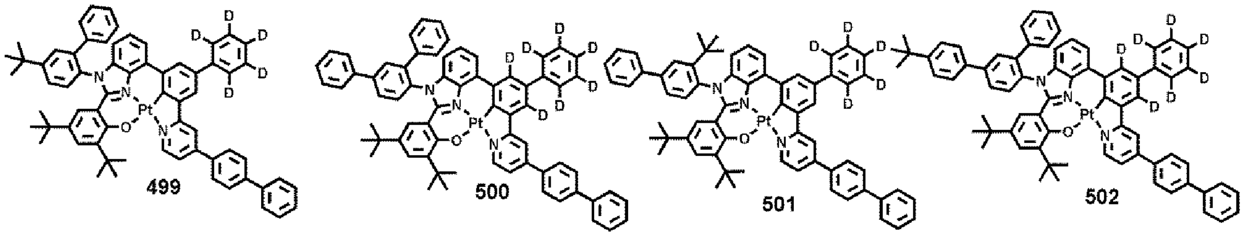

499 500 501 502

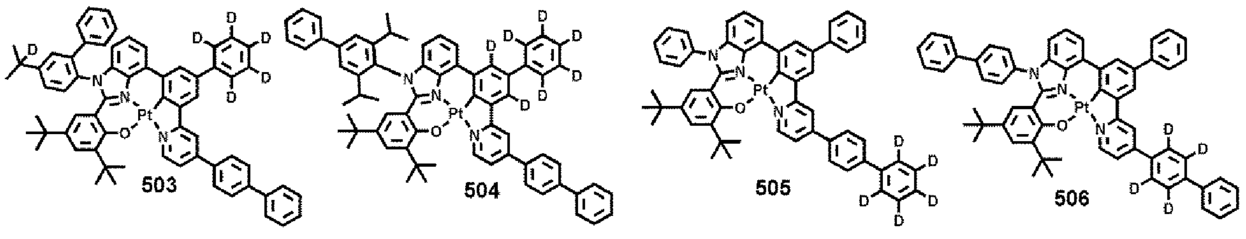

503 504 505 506

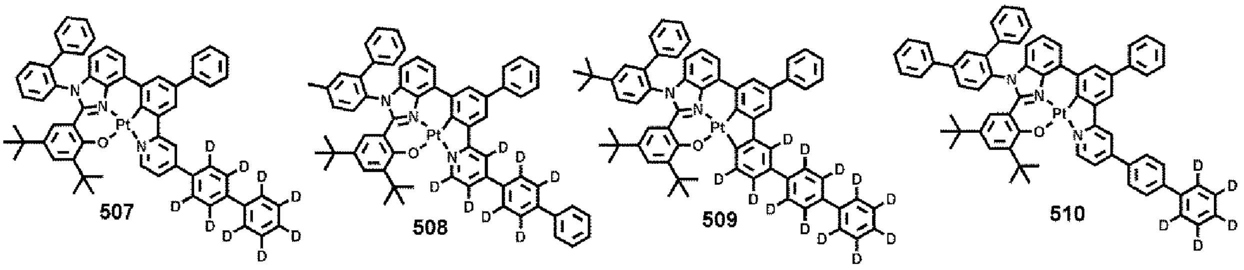

507 508 509 510

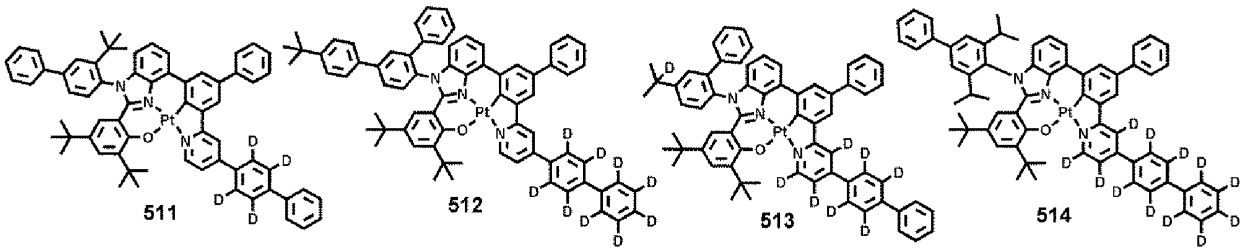

511 512 513 514

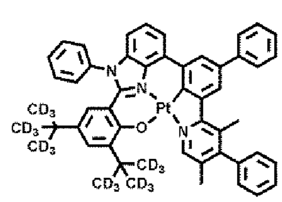

515

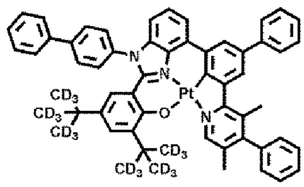

516

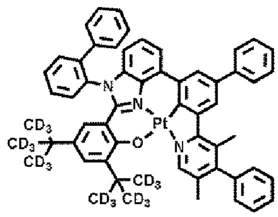

517

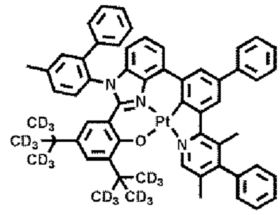

527

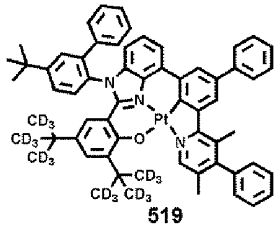

519

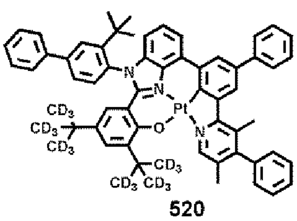

520

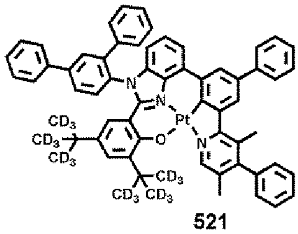

521

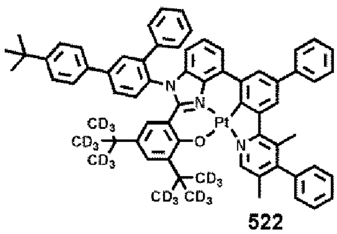

522

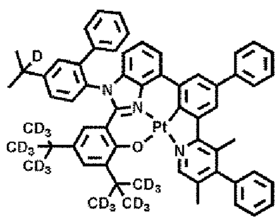

523

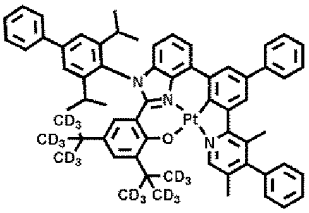

524

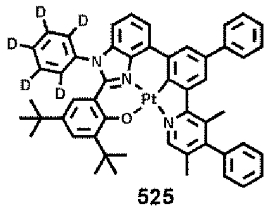

525

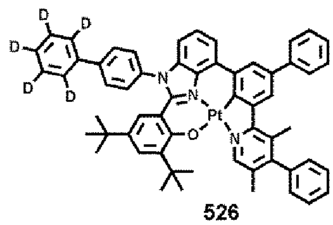

526

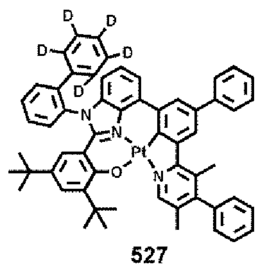

527

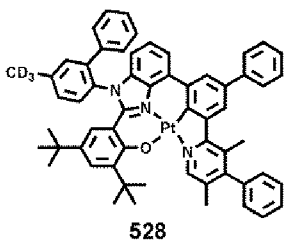

528

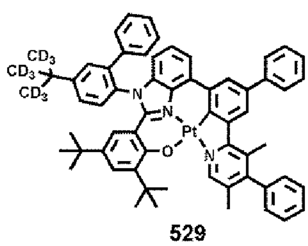

529

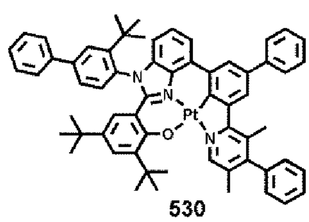

530

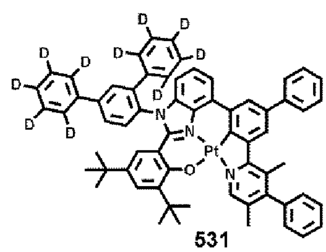

531

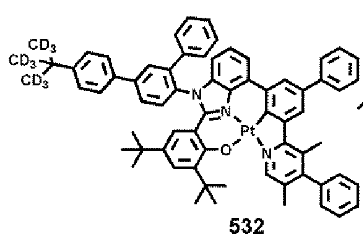

532

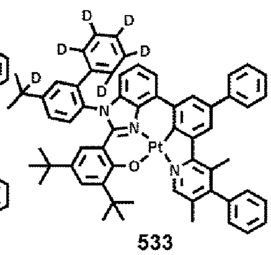

533

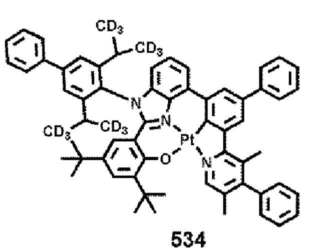

534

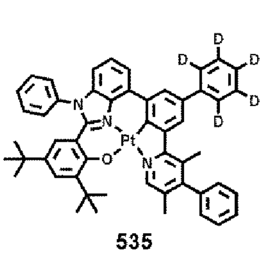

535

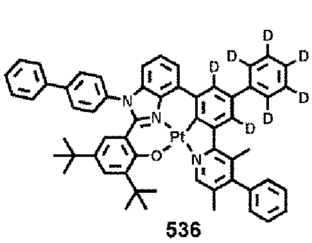

536

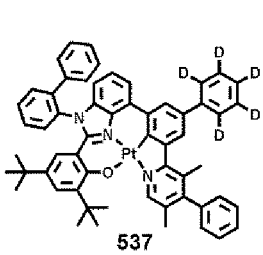

537

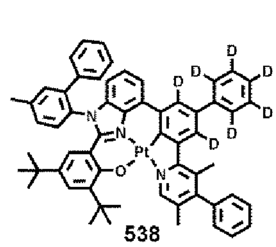

538

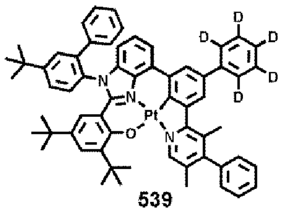

539

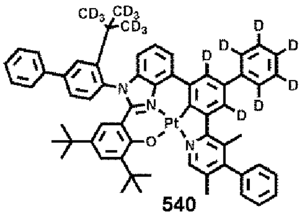

540

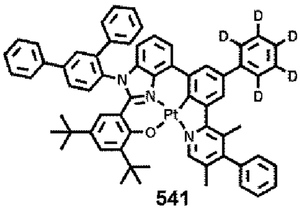

541

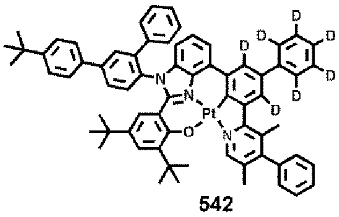

542

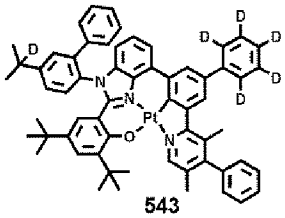

543

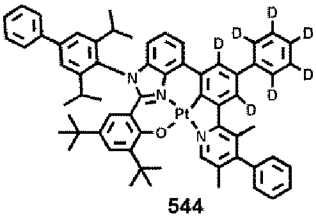

544

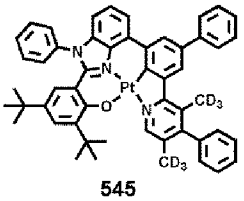

545

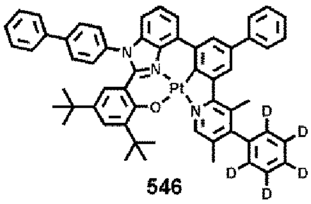

546

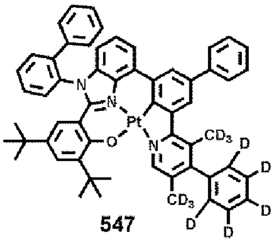

547

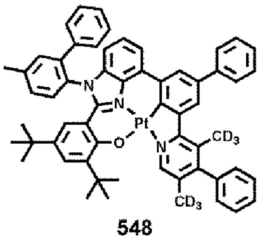

548

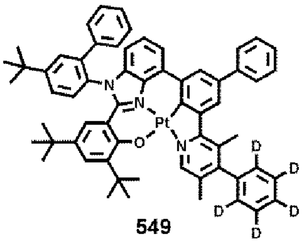

549

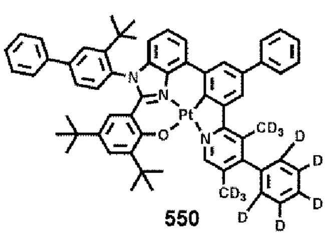

550

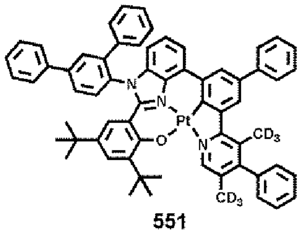

551

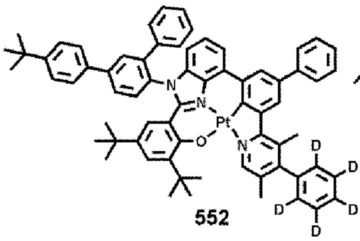

552

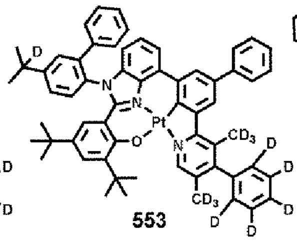

553

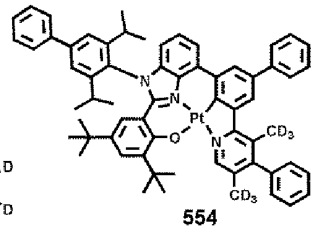

554

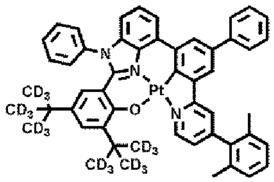

555

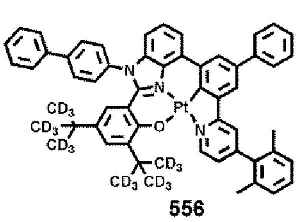

556

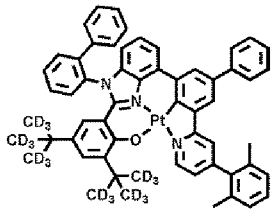

557

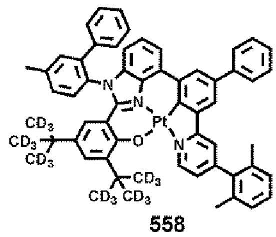

558

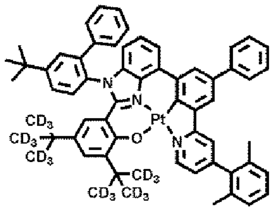

559

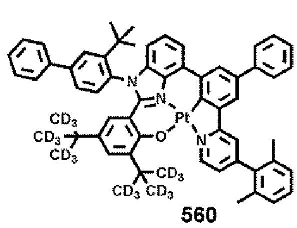

560

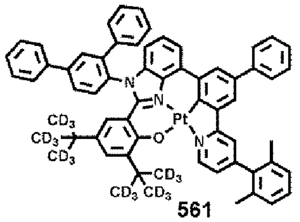

561

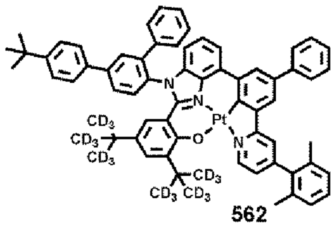

562

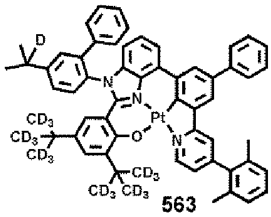
563

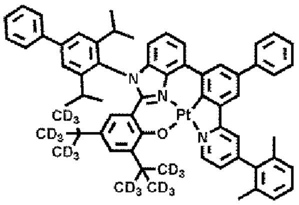
564

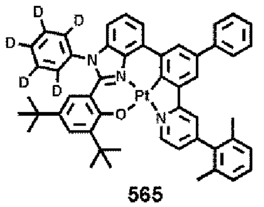
565

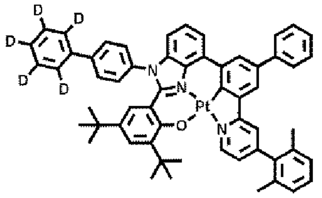
566

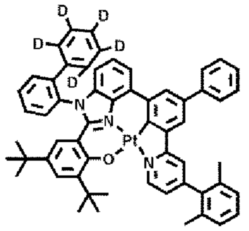
567

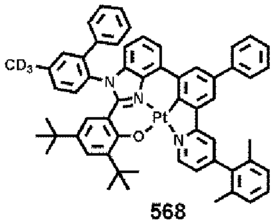
568

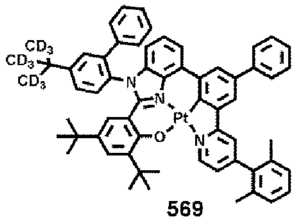
569

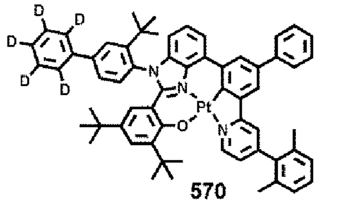
570

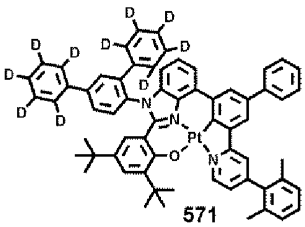
571

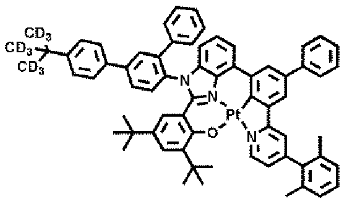
572

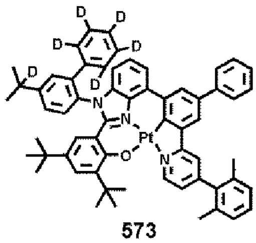
573

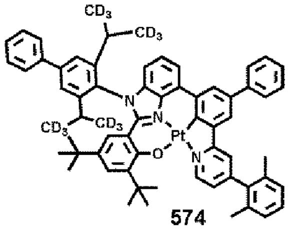
574

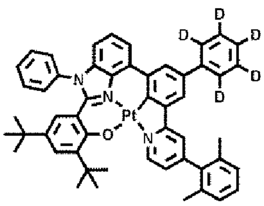
575

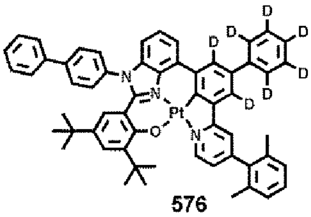
576

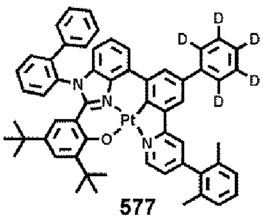
577

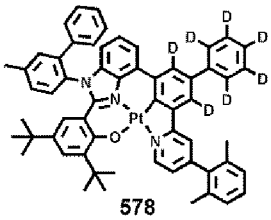
578

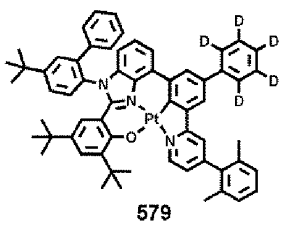
579

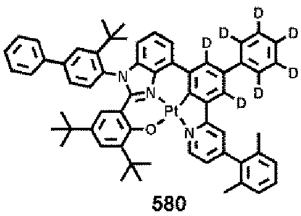
580

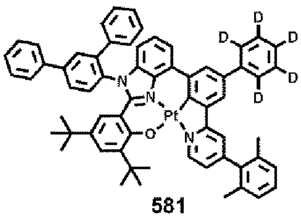
581

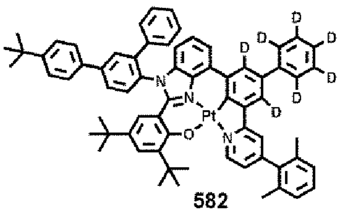
582

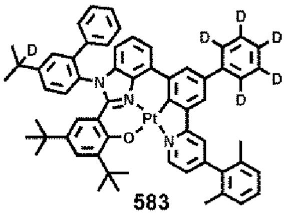
583

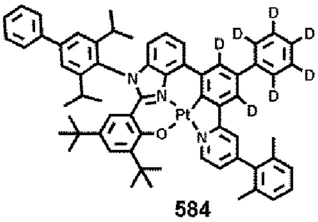
584

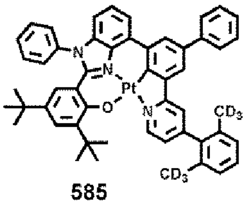
585

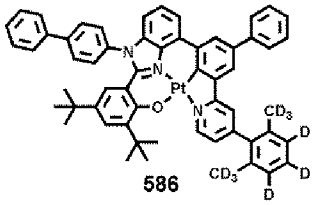
586

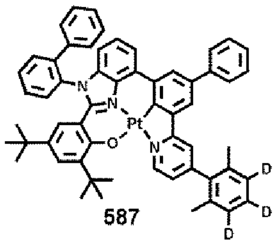

587

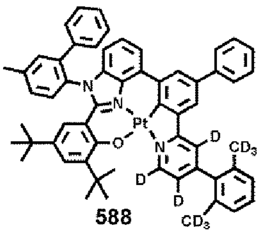

588

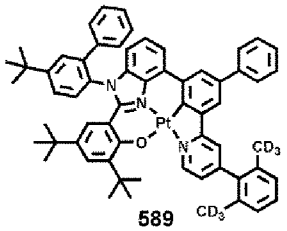

589

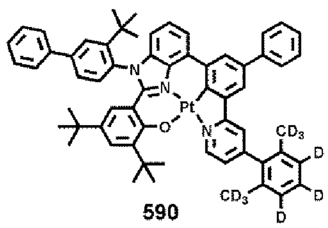

590

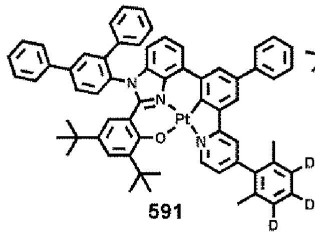

591

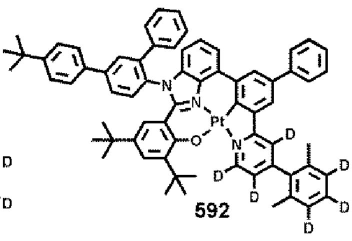

592

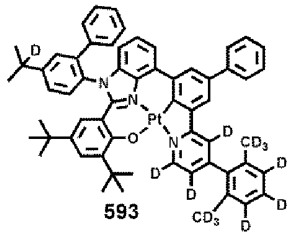

593

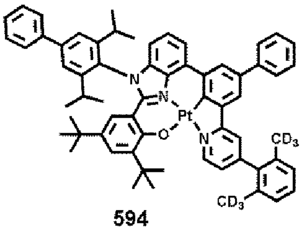

594

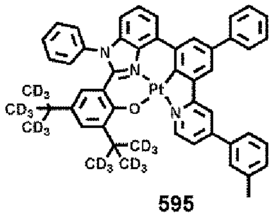

595

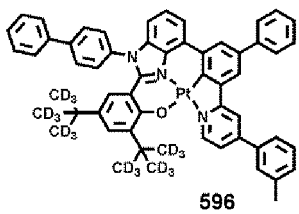

596

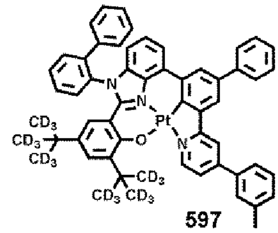

597

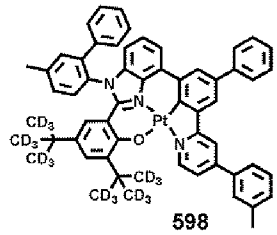

598

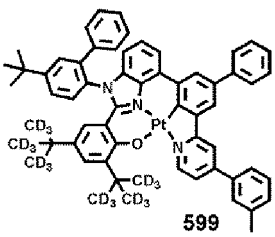

599

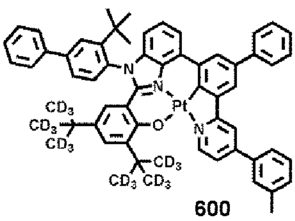

600

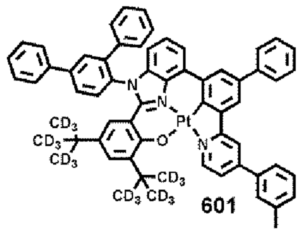

601

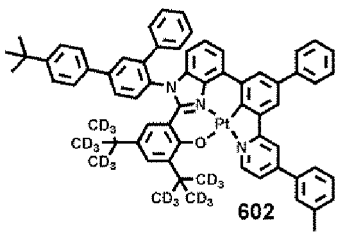

602

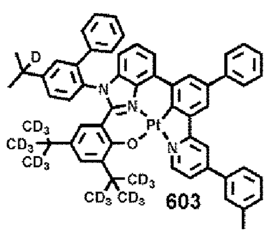

603

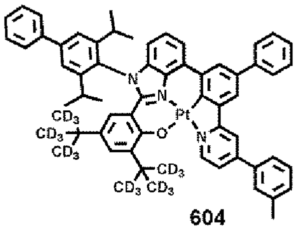

604

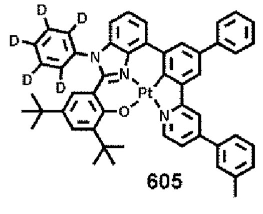

605

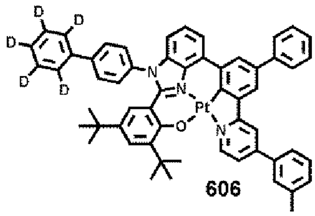

606

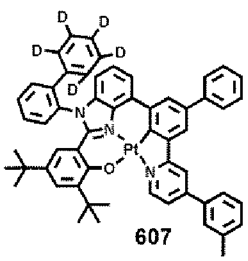

607

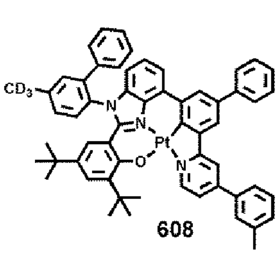

608

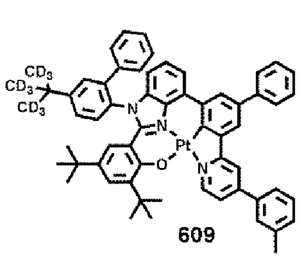

609

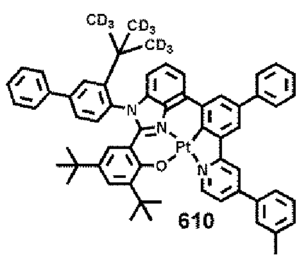

610

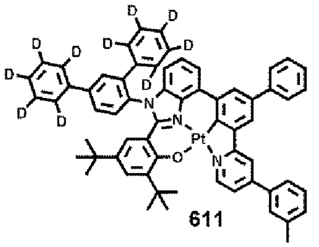
611

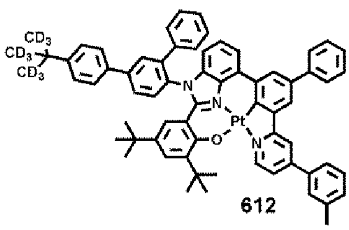
612

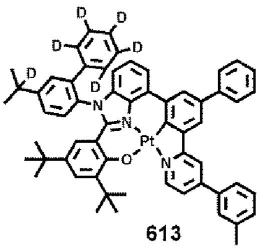
613

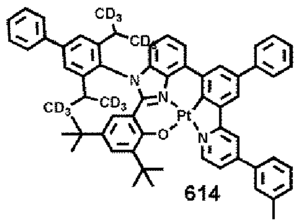
614

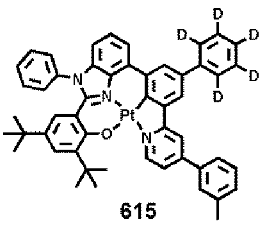
615

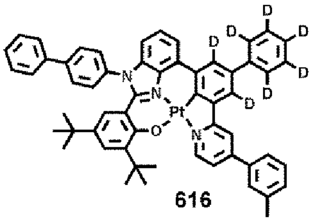
616

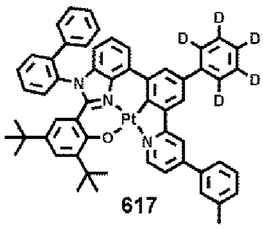
617

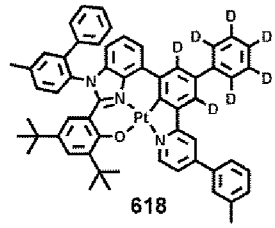
618

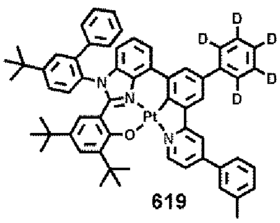
619

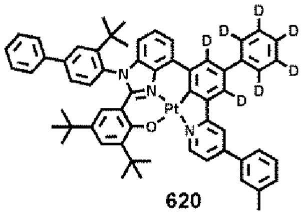
620

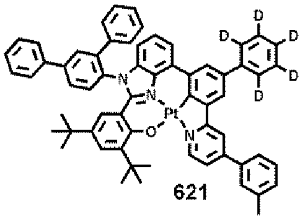
621

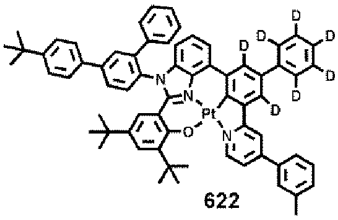
622

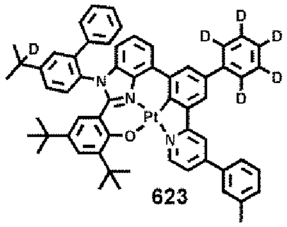
623

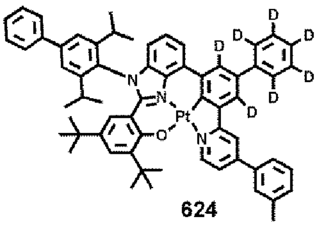
624

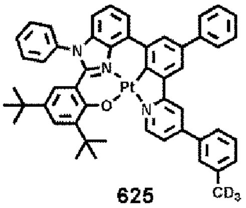
625

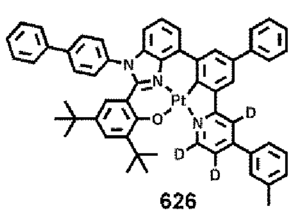
626

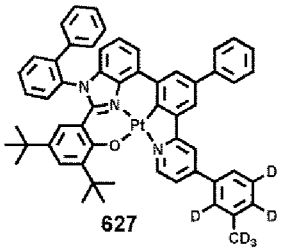
627

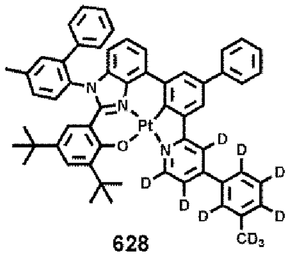
628

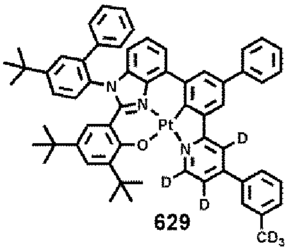
629

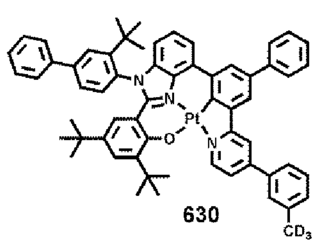
630

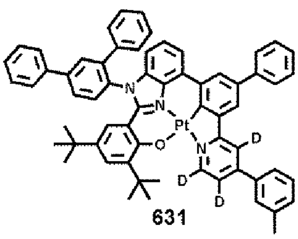
631

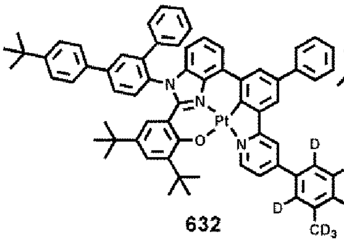
632

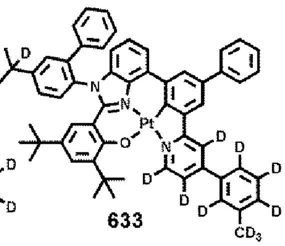
633

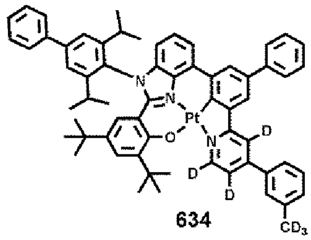
634

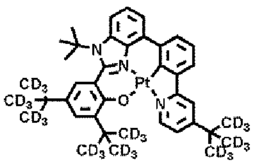

635

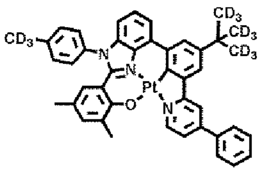

636

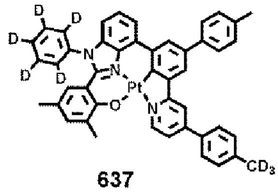

637

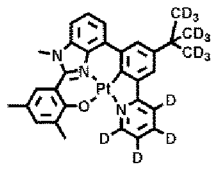

638

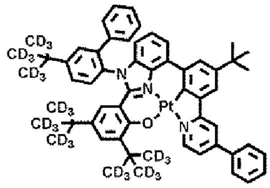

639

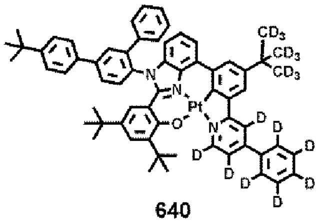

640

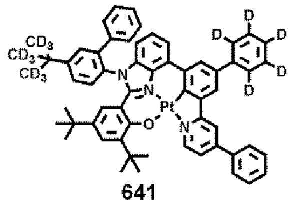

641

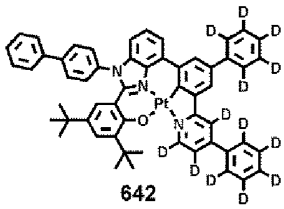

642

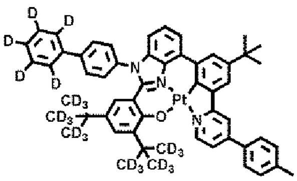

643

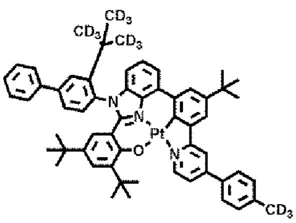

644

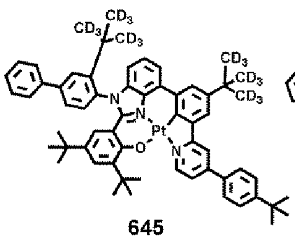

645

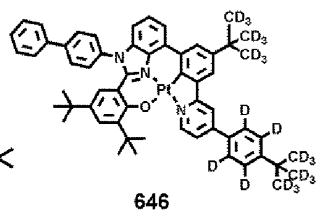

646

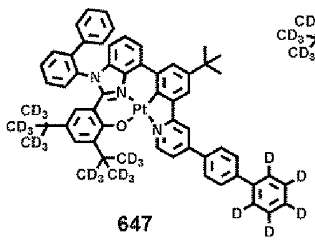

647

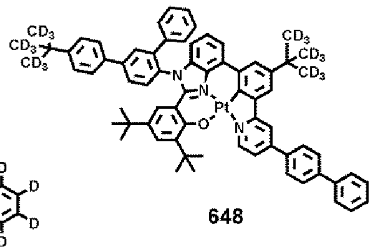

648

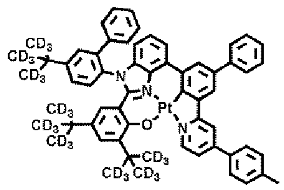

649

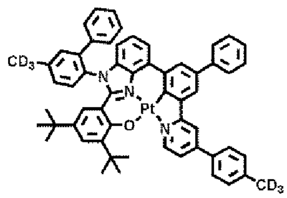

650

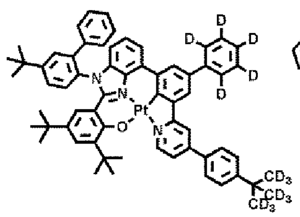

651

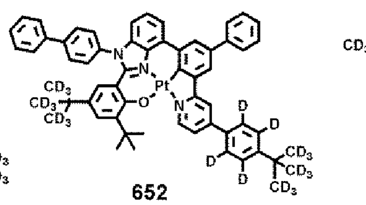

652

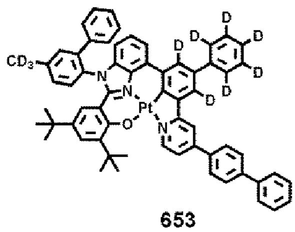

653

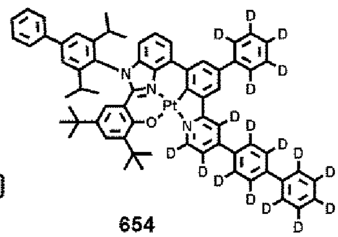

654

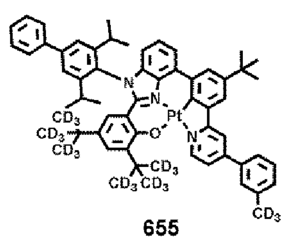

655

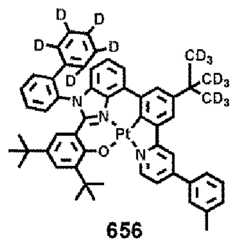

656

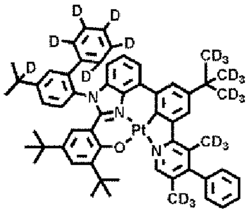

657

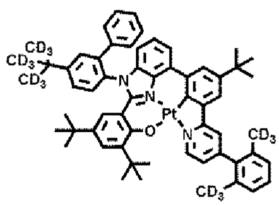

658

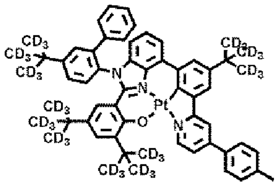

659

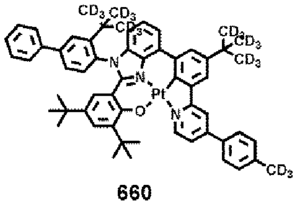

660

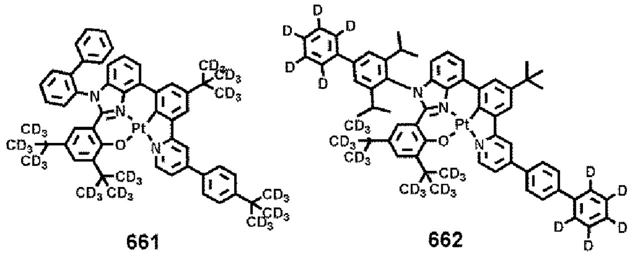

661

662

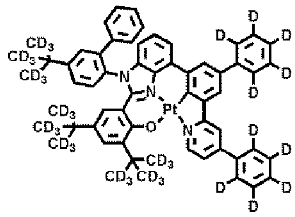

663

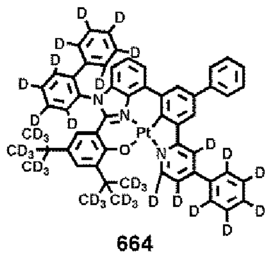

664

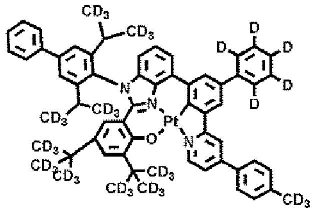

665

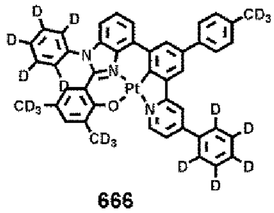

666

**13.** An organic light-emitting device comprising:

a first electrode;
a second electrode; and
an organic layer disposed between the first electrode and the second electrode,
wherein the organic layer comprises an emission layer and at least one organometallic compound of any of claims 1-12;
preferably wherein
the first electrode is an anode,
the second electrode is a cathode,
the organic layer further includes a hole transport region disposed between the first electrode and the emission layer and an electron transport region disposed between the emission layer and the second electrode,
the hole transport region includes a hole injection layer, a hole transport layer, an electron blocking layer, a buffer layer or any combination thereof, and
the electron transport region includes a hole blocking layer, an electron transport layer, an electron injection layer, or any combination thereof.

**14.** The organic light-emitting device of claim 13, wherein
the organometallic compound is included in the emission layer, preferably wherein the emission layer further includes a host and the amount of the host is greater than the amount of the organometallic compound.

**15.** A diagnostic composition comprising at least one organometallic compound of any of claims 1-12.

## Patentansprüche

**1.** Organometallverbindung, dargestellt durch Formel 1:

Formel 1

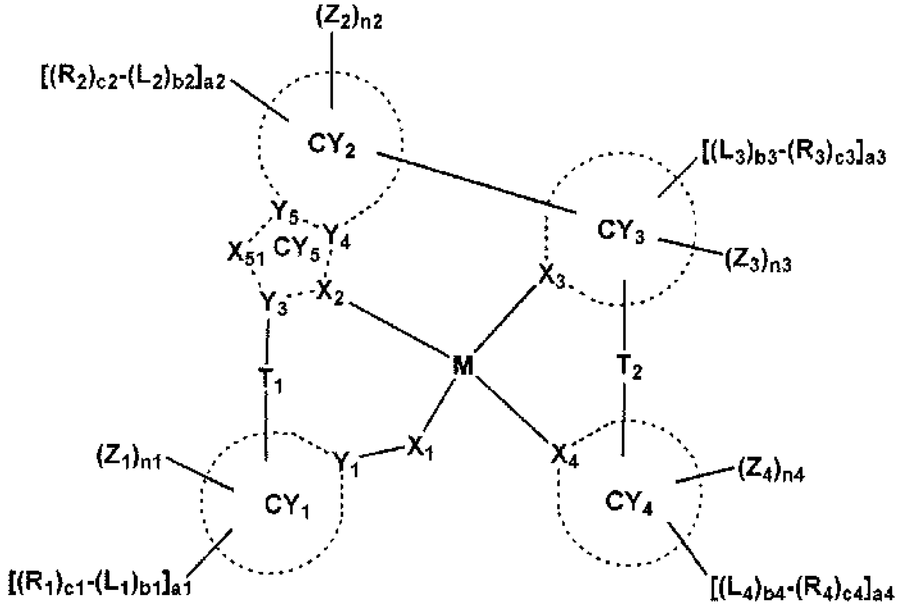

wobei in Formel 1

M Beryllium (Be), Magnesium (Mg), Aluminium (Al), Calcium (Ca), Titan (Ti), Mangan (Mn), Kobalt (Co), Kupfer (Cu), Zink (Zn), Gallium (Ga), Germanium (Ge), Zirkonium (Zr), Ruthenium (Ru), Rhodium (Rh), Palladium (Pd), Silber (Ag), Rhenium (Re), Platin (Pt) oder Gold (Au) ist

$X_1$ eine chemische Bindung, O, S, N(R'), P(R'), B(R'), C(R')(R") oder Si(R')(R") ist und wenn $X_1$ eine chemische Bindung ist, $Y_1$ direkt an M gebunden ist,

$X_2$ bis $X_4$ jeweils unabhängig N oder C sind, wobei zwei aus $X_2$ bis $X_4$ ausgewählte jeweils N sind und das andere C ist,

eine Bindung zwischen $X_1$ oder $Y_1$ und M eine kovalente Bindung ist, eine Bindung, ausgewählt aus einer Bindung zwischen $X_2$ und M, einer Bindung zwischen $X_3$ und M und einer Bindung zwischen $X_4$ und M eine kovalente Bindung ist, und die verbleibenden zwei Bindungen koordinative Bindungen sind,

$Y_1$ und $Y_3$ bis $Y_5$ jeweils unabhängig C oder N sind,

unter Paaren von $X_2$ und $Y_3$, $X_2$ und $Y_4$, $Y_4$ und $Y_5$, $X_{51}$ und $Y_3$, und $X_{51}$ und $Y_5$ die Komponenten in jedem Paar über eine chemische Bindung verknüpft sind,

Ring $CY_1$ bis Ring $CY_5$ jeweils unabhängig aus einer carbocyclischen $C_5$-$C_{30}$-Gruppe und einer heterocyclischen $C_1$-$C_{30}$-Gruppe ausgewählt sind, und jeder von Ring $CY_1$, Ring $CY_3$ und Ring $CY_4$ keine Benzimidazolgruppe ist, ein cyclometallierter Ring, der durch den Ring $CY_5$, Ring $CY_2$, Ring $CY_3$ und M gebildet wird, ein 6-gliedriger Ring ist,

$X_{51}$ ausgewählt ist aus O, S, N-[$(L_7)_{b7}$-$(R_7)_{c7}$], $C(R_7)(R_8)$, $Si(R_7)(R_8)$, $Ge(R_7)(R_8)$, C(=O), N, $C(R_7)$, $Si(R_7)$ und $Ge(R_7)$,

$R_7$ und $R_8$ gegebenenfalls über eine Einfachbindung, eine Doppelbindung oder eine erste Verknüpfungsgruppe verknüpft sind, um eine carbocyclische $C_5$-$C_{30}$-Gruppe zu bilden, die unsubstituiert oder mit mindestens einem $R_{10a}$ substituiert ist, oder eine heterocyclische $C_1$-$C_{30}$-Gruppe, die unsubstituiert oder mit mindestens einem $R_{10a}$ substituiert ist,

$T_1$ und $T_2$ jeweils unabhängig aus einer Einfachbindung, einer Doppelbindung, *-N($R_9$)-*', *-B($R_9$)-*', *-P($R_9$)-*', *-C($R_9$)($R_{10}$)-*', *-Si($R_9$)($R_{10}$)-*', *-Ge($R_9$)($R_{10}$)-*', *-S-*', *-Se-*', *-O-*', *-C(=O)-*', *-S(=O)-*', *-S(=O)$_2$-*', *-C($R_9$)=*', *=C($R_9$)-*', *-C($R_9$)=C($R_{10}$)-*', *-C(=S)- oder *-C≡C-*' ausgewählt sind,

$L_1$ bis $L_4$ und $L_7$ jeweils unabhängig aus einer Einfachbindung, einer substituierten oder unsubstituierten carbocyclischen $C_5$-$C_{30}$-Gruppe und einer substituierten oder unsubstituierten heterocyclischen $C_1$-$C_{30}$-Gruppe ausgewählt sind,

b1 bis b4 und b7 jeweils unabhängig eine ganze Zahl von 1 bis 5 sind,

$R_1$ bis $R_4$, $R_7$ bis $R_{10}$, R' und R" jeweils unabhängig aus Folgendem ausgewählt sind: Wasserstoff, Deuterium, einer Deuterium enthaltenden Gruppe, -F, -Cl, -Br, -I, $-SF_5$, einer Hydroxygruppe, einer Cyanogruppe, einer Nitrogruppe, einer Amidinogruppe, einer Hydrazingruppe, einer Hydrazongruppe, einer Carbonsäuregruppe

oder einem Salz davon, einer Sulfonsäuregruppe oder einem Salz davon, einer Phosphorsäuregruppe oder einem Salz davon, einer substituierten oder unsubstituierten $C_1$-$C_{60}$-Alkylgruppe, einer substituierten oder unsubstituierten $C_2$-$C_{60}$-Alkenylgruppe, einer substituierten oder unsubstituierten $C_2$-$C_{60}$-Alkynylgruppe, einer substituierten oder unsubstituierten $C_1$-$C_{60}$-Alkoxygruppe, einer substituierten oder unsubstituierten $C_3$-$C_{10}$-Cycloalkylgruppe, einer substituierten oder unsubstituierten $C_1$-$C_{10}$-Heterocycloalkylgruppe, einer substituierten oder unsubstituierten $C_3$-$C_{10}$-Cycloalkenylgruppe, einer substituierten oder unsubstituierten $C_1$-$C_{10}$-Heterocycloalkenylgruppe, einer substituierten oder unsubstituierten $C_6$-$C_{60}$-Arylgruppe, einer substituierten oder unsubstituierten $C_7$-$C_{60}$-Alkylarylgruppe, einer substituierten oder unsubstituierten $C_6$-$C_{60}$-Aryloxygruppe, einer substituierten oder unsubstituierten $C_6$-$C_{60}$-Arylthiogruppe, einer substituierten oder unsubstituierten $C_7$-$C_{60}$-Arylalkylgruppe, einer substituierten oder unsubstituierten $C_1$-$C_{60}$-Heteroarylgruppe, einer substituierten oder unsubstituierten $C_1$-$C_{60}$-Heteroaryloxygruppe, einer substituierten oder unsubstituierten $C_1$-$C_{60}$-Heteroarylthiogruppe, einer substituierten oder unsubstituierten $C_2$-$C_{60}$-Heteroarylalkylgruppe, einer substituierten oder unsubstituierten $C_2$-$C_{60}$-Alkylheteroarylgruppe, einer substituierten oder unsubstituierten einwertigen nicht aromatischen kondensierten polycyclischen Gruppe, einer substituierten oder unsubstituierten einwertigen nicht aromatischen kondensierten heteropolycyclischen Gruppe, $-N(Q_1)(Q_2)$, $-Si(Q_3)(Q_4)(Q_5)$, $-B(Q_6)(Q_7)$ und $-P(=O)(Q_8)(Q_9)$,

c1 bis c4 und c7 jeweils unabhängig eine ganze Zahl von 1 bis 5 sind,

$Z_1$ bis $Z_4$ jeweils unabhängig Deuterium oder eine Deuterium enthaltende Gruppe sind,

a1 bis a4 und n1 bis n4 jeweils unabhängig eine ganze Zahl von 0 bis 20 sind,

i) wenn $X_{51}$ O, S, C(=O) oder N ist, die Summe von n1 bis n4 1 oder mehr ist, ii) wenn $X_{51}$ $N[(L_7)b_7\text{-}(R_7)c_7]$, $C(R_7)$, $Si(R_7)$ oder $Ge(R_7)$ ist, a) $R_7$ Deuterium oder eine Deuterium enthaltende Gruppe ist; b) die Summe von n1 bis n4 1 oder mehr ist; oder c) $R_7$ Deuterium oder eine Deuterium enthaltende Gruppe ist und die Summe von n1 bis n4 1 oder mehr ist, und iii) wenn $X_{51}$ $C(R_7)(R_8)$, $Si(R_7)(R_8)$ oder $Ge(R_7)(R_8)$ ist a) mindestens eines, ausgewählt aus $R_7$ und $R_8$, Deuterium oder eine Deuterium enthaltende Gruppe ist; b) die Summe von n1 bis n4 1 oder mehr ist; oder c) mindestens eines, ausgewählt aus $R_7$ und $R_8$, Deuterium oder eine Deuterium enthaltende Gruppe ist und die Summe von n1 bis n4 1 oder mehr ist,

zwei einer Vielzahl von benachbarten Gruppen $R_1$ gegebenenfalls miteinander verknüpft sind, um eine carbocyclische $C_5$-$C_{30}$-Gruppe zu bilden, die unsubstituiert oder mit mindestens einem $R_{10a}$ substituiert ist, oder eine heterocyclische $C_1$-$C_{30}$-Gruppe, die unsubstituiert oder mit mindestens einem $R_{10a}$ substituiert ist,

zwei einer Vielzahl von benachbarten Gruppen $R_2$ gegebenenfalls miteinander verknüpft sind, um eine carbocyclische $C_5$-$C_{30}$-Gruppe zu bilden, die unsubstituiert oder mit mindestens einem $R_{10a}$ substituiert ist, oder eine heterocyclische $C_1$-$C_{30}$-Gruppe, die unsubstituiert oder mit mindestens einem $R_{10}$ substituiert ist,

zwei einer Vielzahl von benachbarten Gruppen $R_3$ gegebenenfalls miteinander verknüpft sind, um eine carbocyclische $C_5$-$C_{30}$-Gruppe zu bilden, die unsubstituiert oder mit mindestens einem $R_{10a}$ substituiert ist, oder eine heterocyclische $C_1$-$C_{30}$-Gruppe, die unsubstituiert oder mit mindestens einem $R_{10a}$ substituiert ist,

zwei einer Vielzahl von benachbarten Gruppen $R_4$ gegebenenfalls miteinander verknüpft sind, um eine carbocyclische $C_5$-$C_{30}$-Gruppe zu bilden, die unsubstituiert oder mit mindestens einem $R_{10a}$ substituiert ist, oder eine heterocyclische $C_1$-$C_{30}$-Gruppe, die unsubstituiert oder mit mindestens einem $R_{10a}$ substituiert ist,

zwei oder mehr benachbarte Gruppen, ausgewählt aus $R_1$ bis $R_4$, $R_7$ bis $R_{10}$, R' und R", gegebenenfalls verknüpft sind, um eine carbocyclische $C_5$-$C_{30}$-Gruppe zu bilden, die unsubstituiert oder mit mindestens einem $R_{10a}$ substituiert ist, oder eine heterocyclische $C_1$-$C_{30}$-Gruppe, die unsubstituiert oder mit mindestens einem $R_{10a}$ substituiert ist,

$R_{10a}$ die gleiche Definition aufweist wie $R_1$,

mindestens ein Substituent der substituierten carbocyclischen $C_5$-$C_{30}$-Gruppe, der substituierten heterocyclischen $C_1$-$C_{30}$-Gruppe, der substituierten $C_1$-$C_{60}$-Alkylgruppe, der substituierten $C_2$-$C_{60}$-Alkenylgruppe, der substituierten $C_2$-$C_{60}$-Alkynylgruppe, der substituierten $C_1$-$C_{60}$-Alkoxygruppe, der substituierten $C_3$-$C_{10}$-Cycloalkylgruppe, der substituierten $C_1$-$C_{10}$-Heterocycloalkylgruppe, der substituierten $C_3$-$C_{10}$-Cycloalkenylgruppe, der substituierten $C_1$-$C_{10}$-Heterocycloalkenylgruppe, der substituierten $C_6$-$C_{60}$-Arylgruppe, der substituierten $C_7$-$C_{60}$-Alkylarylgruppe, der substituierten $C_6$-$C_{60}$-Aryloxygruppe, der substituierten $C_6$-$C_{60}$-Arylthiogruppe, der substituierten $C_7$-$C_{60}$-Arylalkylgruppe, der substituierten $C_1$-$C_{60}$-Heteroarylgruppe, der substituierten $C_1$-$C_{60}$-Heteroaryloxygruppe, der substituierten $C_1$-$C_{60}$-Heteroarylthiogruppe, der substituierten $C_2$-$C_{60}$-Heteroarylalkylgruppe, der substituierten $C_2$-$C_{60}$-Alkylheteroarylgruppe, der substituierten einwertigen nicht aromatischen kondensierten polycyclischen Gruppe, und der substituierten einwertigen nicht aromatischen kondensierten heteropolycyclischen Gruppe aus Folgendem ausgewählt ist:

Deuterium, -F, -Cl, -Br, -I, $-CD_3$, $-CD_2H$, $-CDH_2$, $-CF_3$, $-CF_2H$, $-CFH_2$, einer Hydroxygruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe und einer $C_1$-$C_{60}$-Alkoxygruppe;

einer $C_1$-$C_{60}$-Alkylgruppe, einer $C_2$-$C_{60}$-Alkenylgruppe, einer $C_2$-$C_{60}$-Alkynylgruppe und einer $C_1$-$C_{60}$-Alkoxygruppe, jeweils substituiert mit mindestens einem, ausgewählt aus Deuterium, -F, -Cl, -Br, -I, $-CD_3$, $-CD_2H$, $-CDH_2$, $-CF_3$, $-CF_2H$, $-CFH_2$, einer Hydroxygruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_3$-$C_{10}$-Cycloalkylgruppe, einer $C_1$-$C_{10}$-Heterocycloalkylgruppe, einer $C_3$-$C_{10}$-Cycloalkenylgurppe, einer $C_1$-$C_{10}$-Heterocycloalkenylgruppe, einer $C_6$-$C_{60}$-Arylgruppe, einer $C_7$-$C_{60}$-Alkylarylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer $C_2$-$C_{60}$-Alkylheteroarylgruppe, einer einwertigen nicht aromatischen kondensierten polycyclischen Gruppe, einer einwertigen nicht aromatischen kondensierten heteropolycyclischen Gruppe, $-N(Q_{11})(Q_{12})$, $Si(Q_{13})(Q_{14})(Q_{15})$, $-B(Q_{16})(Q_{17})$ und $-P(=O)(Q_{18})(Q_{19})$;

einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_7$-$C_{60}$-Alkylarylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer $C_2$-$C_{60}$-Alkylheteroarylgruppe, einer einwertigen nicht aromatischen kondensierten polycyclischen Gruppe und einer einwertigen nicht aromatischen kondensierten heteropolycyclischen Gruppe;

einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_7$-$C_{60}$-Alkylarylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer $C_2$-$C_{60}$-Alkylheteroarylgruppe, einer einwertigen nicht aromatischen kondensierten polycyclischen Gruppe, und einer einwertigen nicht aromatischen kondensierten heteropolycyclischen Gruppe, jeweils substituiert mit mindestens einem, ausgewählt aus Deuterium, -F, -Cl, -Br, -I,$-CD_3$, $-CD_2H$, $-CDH_2$, $-CF_3$, $-CF_2H$, $-CFH_2$, einer Hydroxygruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_7$-$C_{60}$-Alkylarylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer $C_2$-$C_{60}$-Alkylheteroarylgruppe, einer einwertigen nicht aromatischen kondensierten polycyclischen Gruppe, einer einwertigen nicht aromatischen kondensierten heteropolycyclischen Gruppe, $-N(Q_{21})(Q_{22})$, $Si(Q_{23})(Q_{24})(Q_{25})$, $-B(Q_{26})(Q_{27})$ und-$P(=O)(Q_{28})(Q_{29})$; und

$-N(Q_{31})(Q_{32})$, $-Si(Q_{33})(Q_{34})(Q_{35})$, $-B(Q_{36})(Q_{37})$ und $-P(=O)(Q_{38})(Q_{39})$;

wobei $Q_1$ bis $Q_9$, $Q_{11}$ bis $Q_{19}$, $Q_{21}$ bis $Q_{29}$ und $Q_{31}$ bis $Q_{39}$ jeweils unabhängig ausgewählt sind aus Wasserstoff, Deuterium, -F, -Cl, -Br, -I, einer Hydroxygruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_1$-$C_{60}$-Alkylgruppe, substituiert mit mindestens einem, ausgewählt aus Deuterium, einer $C_1$-$C_{60}$-Alkylgruppe, und einer $C_6$-$C_{60}$-Arylgruppe, einer $C_5$-$C_{60}$-Alkenylgruppe, einer $C_2$-$C_{60}$-Alkynylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Arylgruppe, substituiert mit mindestens einem, ausgewählt aus Deuterium, einer $C_1$-$C_{60}$-Alkylgruppe, und einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer $C_2$-$C_{60}$-Alkylheteroarylgruppe, einer einwertigen nicht aromatischen kondensierten polycyclischen Gruppe, und einer einwertigen nicht aromatischen kondensierten heteropolycyclischen Gruppe.

**2.** Organometallverbindung nach Anspruch 1, wobei

i) $X_2$ und $X_4$ jeweils N sind, $X_3$ C ist, eine Bindung zwischen $X_2$ und M und eine Bindung zwischen $X_4$ und M

jeweils eine koordinative Bindung sind, und eine Bindung zwischen $X_3$ und M eine kovalente Bindung ist,
i) $X_2$ und $X_3$ jeweils N sind, $X_4$ C ist, eine Bindung zwischen $X_2$ und M und eine Bindung zwischen $X_3$ und M jeweils eine koordinative Bindung sind, und eine Bindung zwischen $X_4$ und M eine kovalente Bindung ist, oder
iii) $X_3$ und $X_4$ jeweils N sind, $X_2$ C ist, eine Bindung zwischen $X_3$ und M und eine Bindung zwischen $X_4$ und M jeweils eine koordinative Bindung sind, und eine Bindung zwischen $X_2$ und M eine kovalente Bindung ist.

**3.** Organometallverbindung nach Anspruch 1 oder 2, wobei
Ring $CY_1$ bis Ring $CY_4$ jeweils unabhängig ausgewählt sind aus i) einem ersten Ring, ii) einem zweiten Ring, iii) einem kondensierten Ring, in dem zwei oder mehr erste Ringe miteinander kondensiert sind, iv) einem kondensierten Ring, in dem zwei oder mehr zweite Ringe miteinander kondensiert sind, und v) einem kondensierten Ring, in dem ein oder mehrere erste Ringe und ein oder mehrere zweite Ringe miteinander kondensiert sind,
der erste Ring aus Folgendem ausgewählt ist: einer Cyclopentangruppe, einer Cyclopentadiengruppe, einer Furangruppe, einer Thiophengruppe, einer Pyrrolgruppe, einer Silolgruppe, einer Indengruppe, einer Benzofurangruppe, einer Benzothiophengruppe, einer Indolgruppe, einer Benzosilolgruppe, einer Oxazolgruppe, einer Isoxazolgruppe, einer Oxadiazolgruppe, einer Isozadiazolgruppe, einer Oxatriazolgruppe, einer Isoxatriazolgruppe, einer Thiazolgruppe, einer Isothiazolgruppe, einer Thiadiazolgruppe, einer Isothiadiazolgruppe, einer Thiatriazolgruppe, einer Isothiatriazolgruppe, einer Pyrazolgruppe Gruppe, einer Imidazolgruppe, einer Triazolgruppe, einer Tetrazolgruppe, einer Azasilolgruppe, einer Diazasilolgruppe und einer Triazasilolgruppe,
der zweite Ring aus Folgendem ausgewählt ist: einer Adamantangruppe, einer Norbornangruppe, einer Norbornengruppe, einer Cyclohexangruppe, einer Cyclohexengruppe, einer Benzolgruppe, einer Pyridingruppe, einer Pyrimidingruppe, einer Pyrazingruppe, einer Pyridazingruppe und einer Triazingruppe und
jeder von Ring $CY_1$ bis Ring $CY_4$ keine Benzimidazolgruppe ist.

**4.** Organometallverbindung nach Anspruch 1 oder 2, wobei
Ring $CY_1$ bis Ring $CY_4$ jeweils unabhängig ausgewählt sind aus einer Benzolgruppe, einer Naphthalingruppe, einer Anthracengruppe, einer Phenanthrengruppe, einer Triphenylengruppe, einer Pyrengruppe, einer Chrysengruppe, einer Cyclopentadiengruppe, einer 1,2,3,4-Tetrahydronaphthalingruppe, einer Furangruppe, einer Thiophengruppe, einer Silolgruppe, einer Indengruppe, einer Fluorengruppe, einer Indolgruppe, einer Carbazolgruppe, einer Benzofurangruppe, einer Dibenzofurangruppe, einer Benzothiophengruppe, einer Dibenzothiophengruppe, einer Benzosilolgruppe, einer Dibenzosilolgruppe, einer Azafluorengruppe, einer Azacarbazolgruppe, einer Azadibenzofurangruppe, einer Azadibenzothiophengruppe, einer Azadibenzosilolgruppe, einer Pyridingruppe, einer Pyrimidingruppe, einer Pyrazingruppe, einer Pyridazingruppe, einer Triazingruppe, einer Chinolingruppe, einer Isochinolingruppe, einer Chinoxalingruppe, einer Chinazolingruppe, einer Phenanthrolingruppe, einer Pyrrolgruppe, einer Pyrazolgruppe, einer Imidazolgruppe, einer Triazolgruppe, einer Oxazolgruppe, einer Isoxazolgruppe, einer Thiazolgruppe, einer Isothiazolgruppe, einer Oxadiazolgruppe, einer Thiadiazolgruppe, einer 5,6,7,8-Tetrahydroisochinolingruppe und einer 5,6,7,8-Tetrahydrochinolingruppe.

**5.** Organometallverbindung nach einem der Ansprüche 1-4, wobei

i) $Y_3$ bis $Y_5$ jeweils C sind, eine Bindung zwischen $X_{51}$ und $Y_3$ und eine Bindung zwischen $X_{51}$ und $Y_5$ jeweils eine Einfachbindung sind, und $X_{51}$ O, S, N-[$(L_7)_{b7}$-$(R_7)_{c7}$], $C(R_7)(R_8)$, $Si(R_7)(R_8)$, $Ge(R_7)(R_8)$ oder C(=O) ist,
ii) $Y_3$ und $Y_4$ jeweils C sind, $Y_5$ N ist, eine Bindung zwischen $X_{51}$ und $Y_3$ eine Doppelbindung ist, eine Bindung zwischen $X_{51}$ und $Y_5$ eine Einfachbindung ist, und $X_{51}$ N, $C(R_7)$, $Si(R_7)$ oder $Ge(R_7)$ ist,
iii) $Y_3$ und $Y_5$ jeweils C sind, $Y_4$ N ist, eine Bindung zwischen $X_{51}$ und $Y_3$ eine Einfachbindung ist, eine Bindung zwischen $X_{51}$ und $Y_5$ eine Doppelbindung ist, und $X_{51}$ N, $C(R_7)$, $Si(R_7)$ oder $Ge(R_7)$ ist,
iv) $Y_3$ N ist, $Y_4$ und $Y_5$ jeweils C sind, eine Bindung zwischen $X_{51}$ und $Y_3$ eine Einfachbindung ist, eine Bindung zwischen $X_{51}$ und $Y_5$ eine Doppelbindung ist, und $X_{51}$ N, $C(R_7)$, $Si(R_7)$ oder $Ge(R_7)$ ist, oder
v) $Y_3$ bis $Y_5$ jeweils C sind, eine Bindung zwischen $X_{51}$ und $Y_3$ eine Doppelbindung ist, eine Bindung zwischen $X_{51}$ und $Y_5$ eine Einfachbindung ist, und $X_{51}$ N, $C(R_7)$, $Si(R_7)$ oder $Ge(R_7)$ ist.

**6.** Organometallverbindung nach einem der Ansprüche 1-5, wobei die Deuterium enthaltende Gruppe eine erste Gruppe ist, die mit mindestens einem Deuteriumatom substituiert ist,
und die erste Gruppe ausgewählt ist aus:

einer $C_1$-$C_{20}$-Alkylgruppe und einer $C_1$-$C_{20}$-Alkoxygruppe;
einer $C_1$-$C_{20}$-Alkylgruppe und einer $C_1$-$C_{20}$-Alkoxygruppe, jeweils substituiert mit mindestens einem, ausgewählt aus -F, -Cl, -Br, -I, $-CD_3$, $-CD_2H$, $-CDH_2$, $-CF_3$, $-CF_2H$, $-CFH_2$, einer Hydroxygruppe, einer Cyangruppe, einer Nitrogruppe, einer Aminogruppe, einer Amidinogruppe, einer Hydrazingruppe, einer Hydrazongruppe, einer

Carbonsäuregruppe oder einem Salz davon, einer Sulfonsäuregruppe oder einem Salz davon, einer Phosphorsäuregruppe oder einem Salz davon, einer $C_1$-$C_{10}$-Alkylgruppe, einer Cyclopentylgruppe, einer Cyclohexylgruppe, einer Cycloheptylgruppe, einer Cycloctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Bicyclo[1.1.1]pentylgruppe, einer Bicyclo[2.1.1]hexylgruppe, einer Bicyclo[2.2.1]heptylgruppe, einer Bicyclo[2.2.2]octylgruppe, einer Phenylgruppe, einer ($C_1$-$C_{20}$-Alkyl)phenylgruppe, einer Biphenylgruppe, einer Terphenylgruppe, einer Naphthylgruppe, einer Pyridinylgruppe und einer Pyrimidinylgruppe;

einer Cyclopentylgruppe, einer Cyclohexylgruppe, einer Cycloheptylgruppe, einer Cycloctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Bicyclo[1.1.1]pentylgruppe, einer Bicyclo[2.1.1]hexylgruppe, einer Bicyclo[2.2.1]heptylgruppe, einer Bicyclo[2.2.2]octylgruppe, einer Phenylgruppe, einer ($C_1$-$C_{20}$-Alkyl)phenylgruppe, einer Biphenylgruppe, einer Terphenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe, einer Imidazopyridinylgruppe und einer Imidazopyrimidinylgruppe;

einer Cyclopentylgruppe, einer Cyclohexylgruppe, einer Cycloheptylgruppe, einer Cycloctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Bicyclo[1.1.1]pentylgruppe, einer Bicyclo[2.1.1]hexylgruppe, einer Bicyclo[2.2.1]heptylgruppe, einer Bicyclo[2.2.2]octylgruppe, einer Phenylgruppe, einer ($C_1$-$C_{20}$-Alkyl)phenylgruppe, einer Biphenylgruppe, einer Terphenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe, einer Imidazopyridinylgruppe und einer Imidazopyrimidinylgruppe, jeweils substituiert mit mindestens einem, ausgewählt aus -F, -Cl, -Br, -I, $-CD_3$, $-CD_2H$, $-CDH_2$, $-CF_3$, $-CF_2H$, $-CFH_2$, einer Hydroxygruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{20}$-Alkylgruppe, einer $C_1$-$C_{20}$-Alkoxygruppe, einer Cyclopentylgruppe, einer Cyclohexylgruppe, einer Cycloheptylgruppe, einer Cycloctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Bicyclo[1.1.1]pentylgruppe, einer Bicyclo[2.1.1]hexylgruppe, einer Bicyclo[2.2.1]heptylgruppe, einer Bicyclo[2.2.2]octylgruppe, einer Phenylgruppe, einer ($C_1$-$C_{20}$-Alkyl)phenylgruppe, einer Biphenylgruppe, einer Terphenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer

Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe, einer Imidazopyridinylgruppe, einer Imidazopyrimidinylgruppe, und $-Si(Q_{33})(Q_{34})(Q_{35})$; und
$-N(Q_1)(Q_2)$, $-Si(Q_3)(Q_4)(Q_5)$, $-B(Q_6)(Q_7)$ und $-P(=O)(Q_8)(Q_9)$;
wobei $Q_1$ bis $Q_9$ und $Q_{33}$ bis $Q_{35}$ jeweils unabhängig ausgewählt sind aus:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $CHDCD_2H$, $-CHDCDH_2$, $-CHDCD_3$, $-CD_2CH_3$, $-CD_2CD_3$, $-CD_2CD_2H$ und $-CD_2CDH_2$;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe; und
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, jeweils substituiert mit mindestens einem, ausgewählt aus einer $C_1$- bis $C_{10}$-Alkylgruppe, und einer Phenylgruppe.

**7.** Organometallverbindung nach einem der Ansprüche 1-6, wobei die Deuterium enthaltende Gruppe eine erste Gruppe ist, die mit mindestens einem Deuteriumatom substituiert ist, und die erste Gruppe ausgewählt ist aus einer $C_1$-$C_{20}$-Alkylgruppe, einer Cyclopentylgruppe, einer Cyclohexylgruppe, einer Cycloheptylgruppe, einer Cycloctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Bicyclo[1.1.1]pentylgruppe, einer Bicyclo[2.1.1]hexylgruppe, einer Bicyclo[2.2.1]heptylgruppe, einer Bicyclo[2.2.2]octylgruppe, einer Phenylgruppe, einer ($C_1$-$C_{20}$-Alkyl)phenylgruppe, einer Biphenylgruppe und einer Terphenylgruppe, jeweils unsubstituiert oder substituiert mit mindestens einem, ausgewählt aus -F, $-CD_3$, $-CD_2H$, $-CDH_2$, $-CF_3$, $-CF_2H$, $-CFH_2$, einer Cyanogruppe, einer $C_1$-$C_{10}$-Alkylgruppe, einer Cyclopentylgruppe, einer Cyclohexylgruppe, einer Cycloheptylgruppe, einer Cycloctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Bicyclo[1.1.1]pentylgruppe, einer Bicyclo[2.1.1]hexylgruppe, einer Bicyclo[2.2.1]heptylgruppe, einer Bicyclo[2.2.2]octylgruppe, einer Phenylgruppe, einer ($C_1$-$C_{20}$-Alkyl)phenylgruppe, einer Biphenylgruppe und einer Terphenylgruppe.

**8.** Organometallverbindung nach einem der Ansprüche 1-7, wobei
$R_1$ bis $R_4$, $R_7$ bis $R_{10}$, R' und R" jeweils unabhängig ausgewählt sind aus Wasserstoff, Deuterium, -F, einer Cyanogruppe, einer Nitrogruppe, $-SF_5$, -CH3, $-CD_3$, $-CD_2H$, $-CDH_2$, $-CF_3$,$-CF_2H$, $-CFH_2$, $-CD_2(CD_3)$, $-CD(CD_3)_2$, $-C(CD_3)_3$, $-CD_2-C(CD_3)_3$, $-CD_2-CD(CD_3)_2$, $-CD_2-CD_2(CD_3)$, $-CD(CD_3)-C(CD_3)_3$, $-CD(CD_3)-CD(CD_3)_2$, $-CD(CD_3)-CD_2(CD_3)$, $-C(CD_3)_2-C(CD_3)_3$, $-C(CD_3)_2-CD(CD_3)_2$, $-C(CD_3)_2-CD_2(CD_3)$, einer Gruppe, dargestellt durch die Formeln 9-1 bis 9-19, einer Gruppe, dargestellt durch die Formeln 10-1 bis 10-232, einer Gruppe, dargestellt durch die Formeln 11-1 bis 11-41, und $-Si(Q_1)(Q_2)(Q_3)$,
$Z_1$ bis $Z_4$ jeweils unabhängig ausgewählt sind aus Deuterium, $-CD_3$, $-CD_2H$, $-CDH_2$,$-CD_2(CD_3)$, $-CD(CD_3)_2$, $-C(CD_3)_3$, $-CD_2-C(CD_3)_3$, $-CD_2-CD(CD_3)_2$, $-CD_2-CD_2(CD_3)$, $-CD(CD_3)-C(CD_3)_3$, $-CD(CD_3)-CD(CD_3)_2$, $-CD(CD_3)-CD_2(CD_3)$, $-C(CD_3)_2-C(CD_3)_3$, $-C(CD_3)_2-CD(CD_3)_2$,$-C(CD_3)_2-CD_2(CD_3)$, und einer Gruppe, dargestellt durch eine der Formeln 9-14 bis 9-19, 10-11, 10-12, und 11-1 bis 11-41:

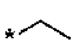
9-1
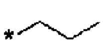
9-2
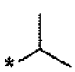
9-3
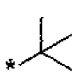
9-4
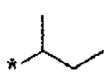
9-5
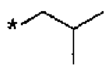
9-6
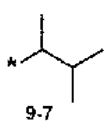
9-7
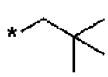
9-8
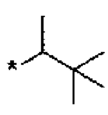
9-9

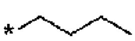
9-10
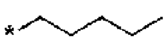
9-11
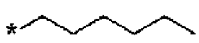
9-12
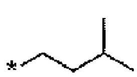
9-13
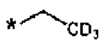
9-14
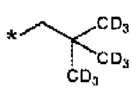
9-15
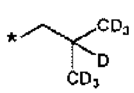
9-16

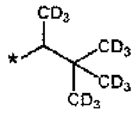
9-17
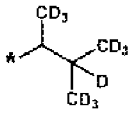
9-18
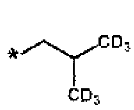
9-19

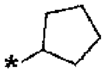
10-1
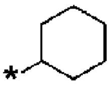
10-2
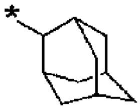
10-3
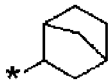
10-4
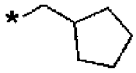
10-5
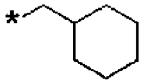
10-6
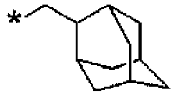
10-7

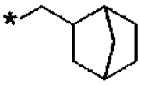
10-8
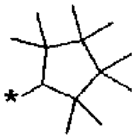
10-9
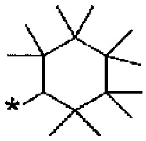
10-10
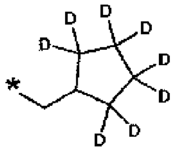
10-11
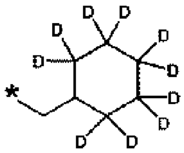
10-12
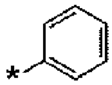
10-13

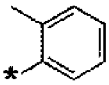
10-14
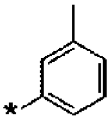
10-15
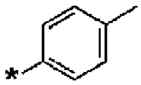
10-16
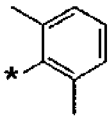
10-17
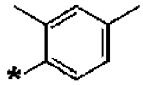
10-18
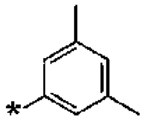
10-19
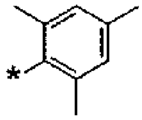
10-20

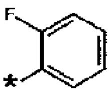
10-21
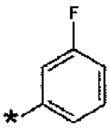
10-22
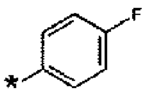
10-23
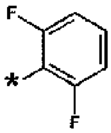
10-24
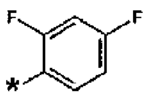
10-25
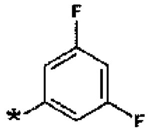
10-26
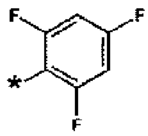
10-27

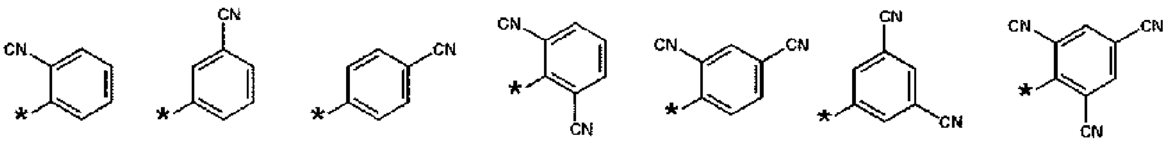
10-28 10-29 10-30 10-31 10-32 10-33 10-34

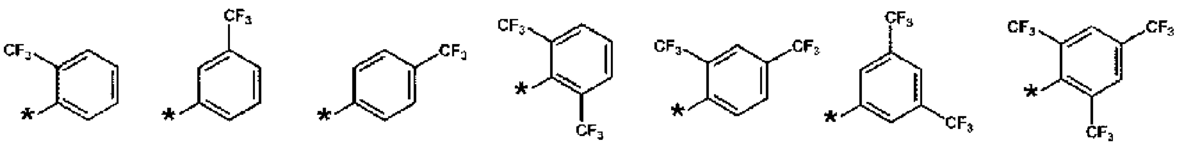
10-35 10-36 10-37 10-38 10-39 10-40 10-41

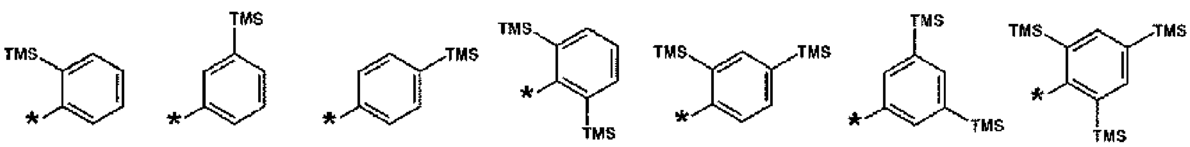
10-42 10-43 10-44 10-45 10-46 10-47 10-48

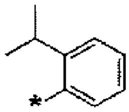

10-49

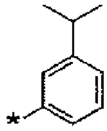

10-50

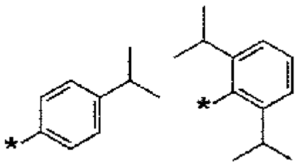

10-51 10-52

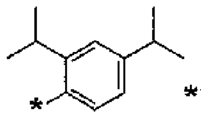

10-53

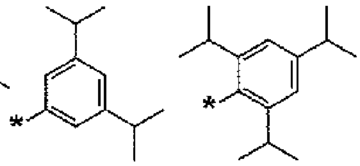

10-54 10-55

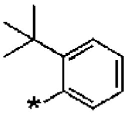

10-56

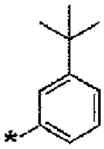

10-57

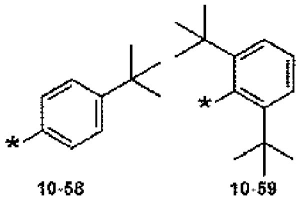

10-58 10-59

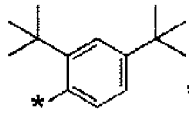

10-60

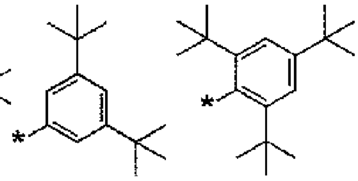

10-61 10-62

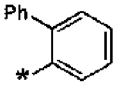

10-63

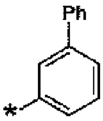

10-64

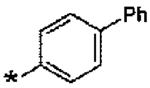

10-65

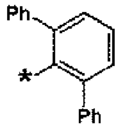

10-66

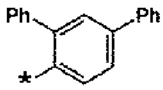

10-67

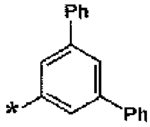

10-68

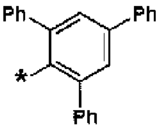

10-69

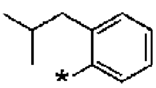

10-70

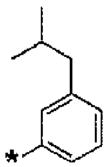

10-71

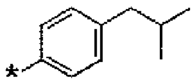

10-72

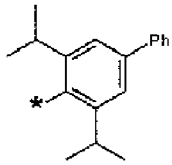

10-73

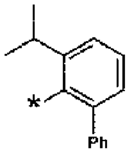

10-74

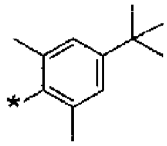

10-75

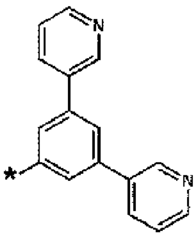

10-76

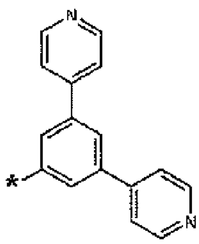

10-77

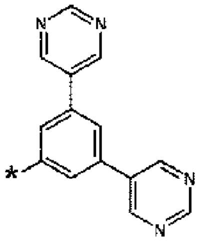

10-78

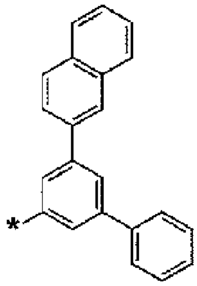

10-79

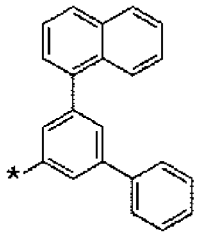

10-80

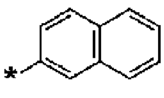

10-81

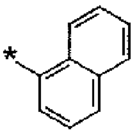

10-82

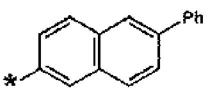

10-83

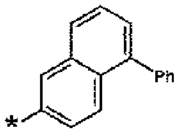

10-84

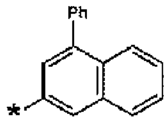

10-85

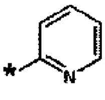

10-86

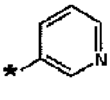

10-87

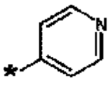

10-88

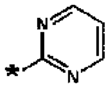

10-89

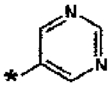

10-90

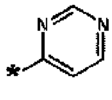

10-91

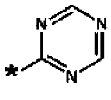

10-92

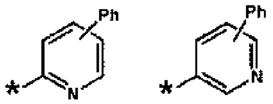
10-93
10-94
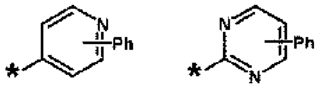
10-95
10-96
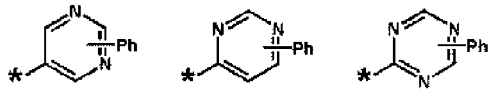
10-97
10-98
10-99

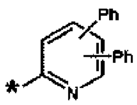
10-100
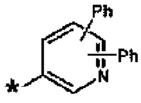
10-101
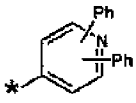
10-102
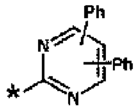
10-103
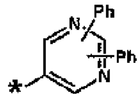
10-104
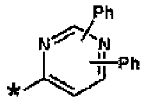
10-105
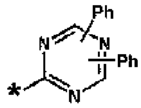
10-106

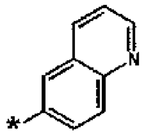
10-107
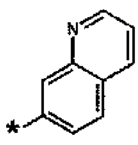
10-108
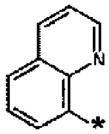
10-109
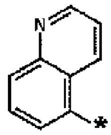
10-110
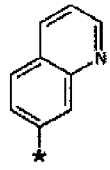
10-111
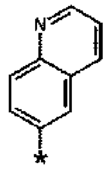
10-112

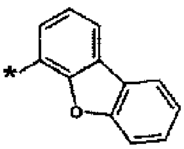
10-113
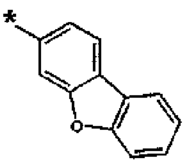
10-114
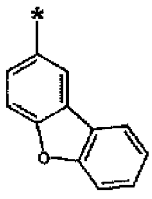
10-115
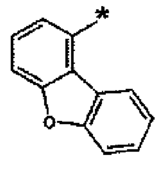
10-116
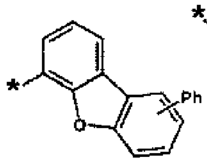
10-117
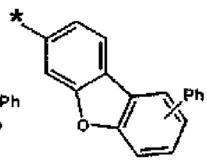
10-118

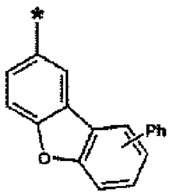
10-119
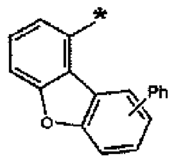
10-120
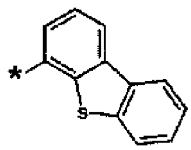
10-121
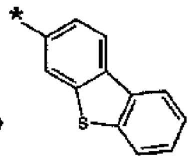
10-122
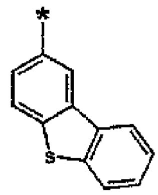
10-123
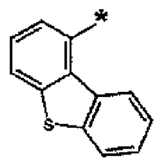
10-124

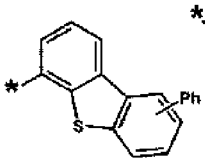
10-125
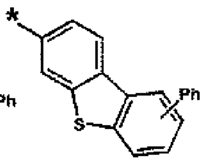
10-126
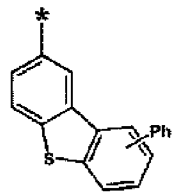
10-127
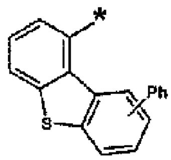
10-128
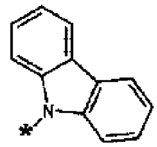
10-129
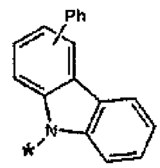
10-130

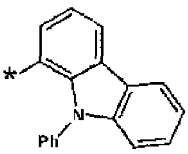
10-131
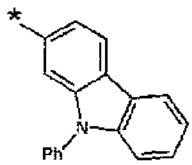
10-132
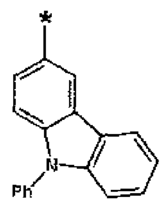
10-133
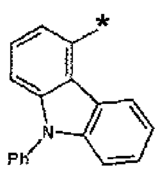
10-134
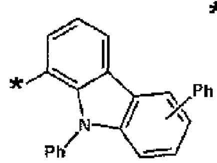
10-135
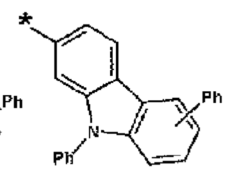
10-136

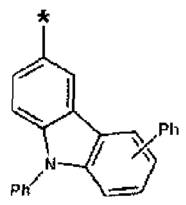 10-137
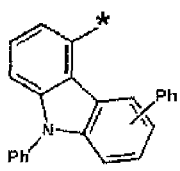 10-138
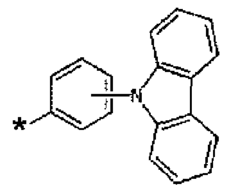 10-139
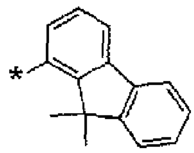 10-140
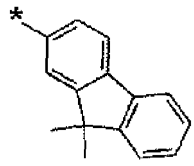 10-141
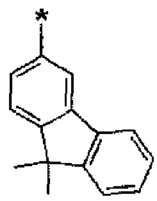 10-142

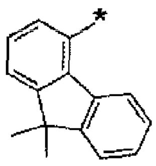 10-143
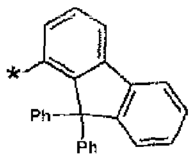 10-144
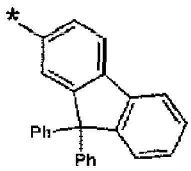 10-145
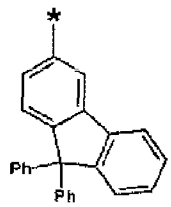 10-146
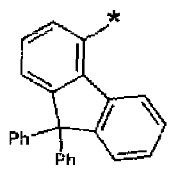 10-147

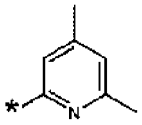 10-148
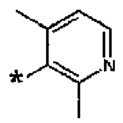 10-149
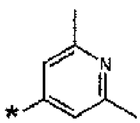 10-150
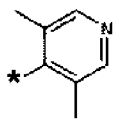 10-151
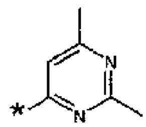 10-152
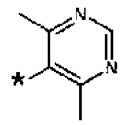 10-153
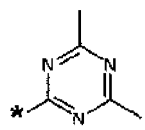 10-154

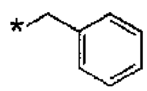 10-155
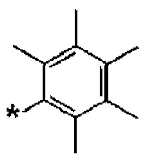 10-156
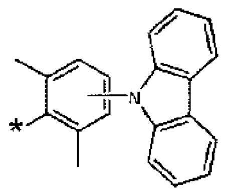 10-157
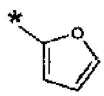 10-158
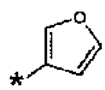 10-159
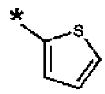 10-160
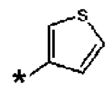 10-161

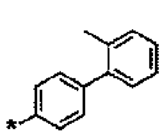 10-162
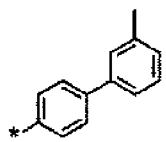 10-163
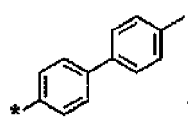 10-164
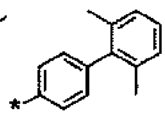 10-165
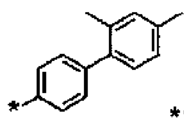 10-166
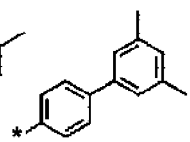 10-167
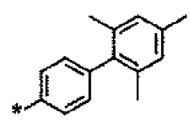 10-168

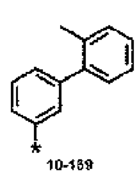 10-169
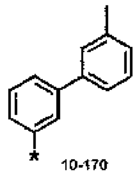 10-170
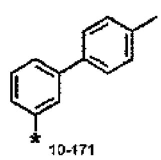 10-171
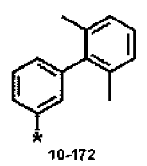 10-172
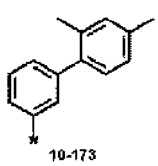 10-173
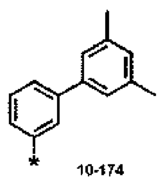 10-174
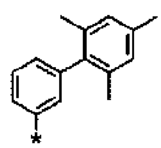 10-175

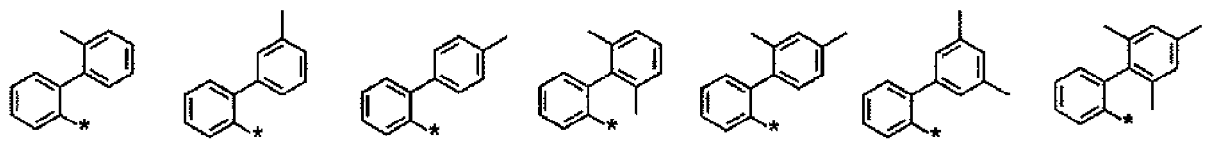

10-176 10-177 10-178 10-179 10-180 10-181 10-182

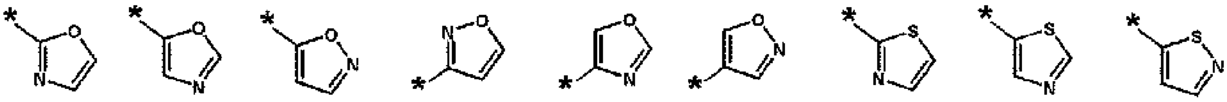
10-183 10-184 10-185 10-186 10-187 10-188 10-189 10-190 10-191

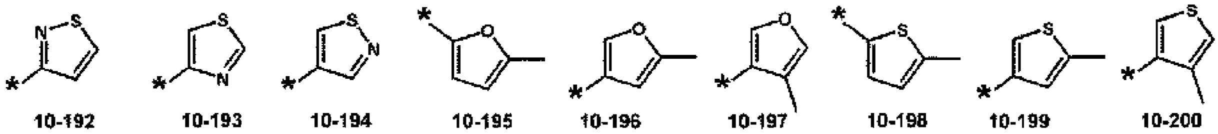
10-192 10-193 10-194 10-195 10-196 10-197 10-198 10-199 10-200

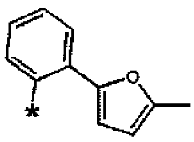
10-201

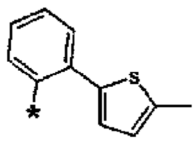
10-202

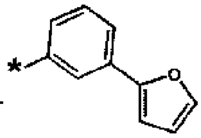
10-203

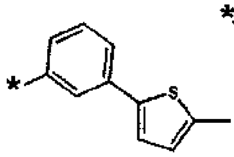
10-204

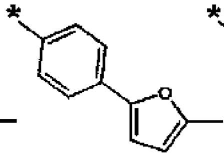
10-205

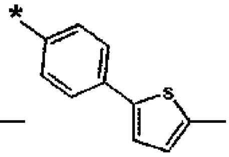
10-206

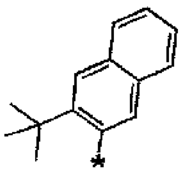
10-207

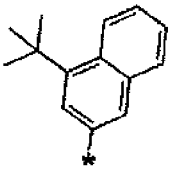
10-208

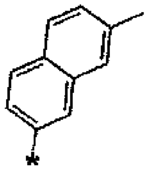
10-209

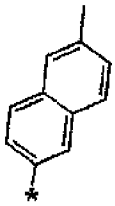
10-210

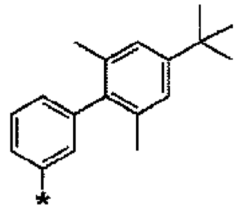
10-211

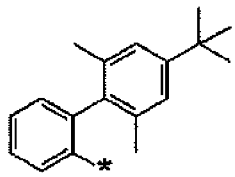
10-212

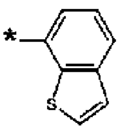
10-213

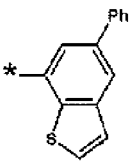
10-214

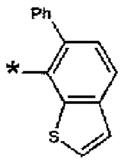
10-215

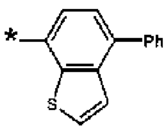
10-216

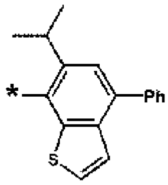
10-217

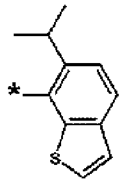
10-218

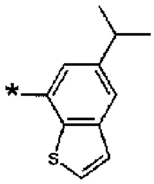
10-219

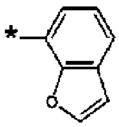
10-220

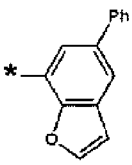
10-221

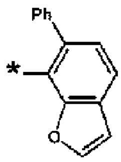
10-222

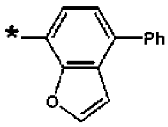
10-223

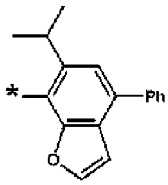
10-224

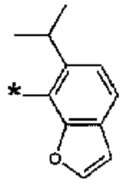
10-225

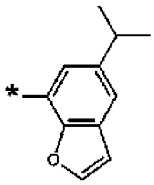
10-226

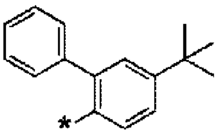
10-227

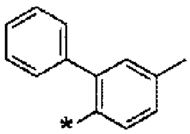
10-228

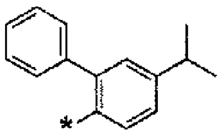
10-229

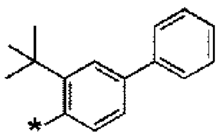
10-230

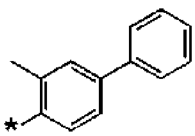
10-231

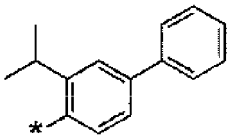

10-232

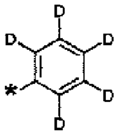

11-1

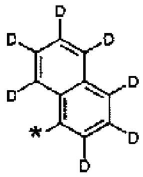

11-2

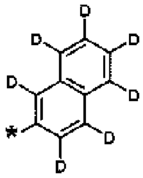

11-3

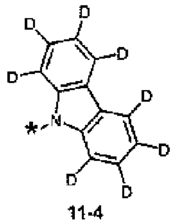

11-4

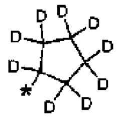

11-5

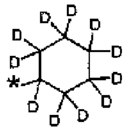

11-6

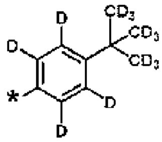

11-7

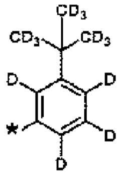

11-8

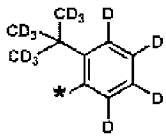

11-9

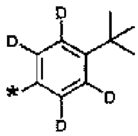

11-10

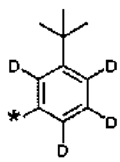

11-11

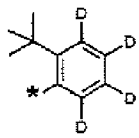

11-12

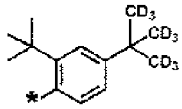

11-13

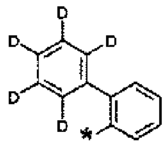

11-14

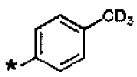

11-15

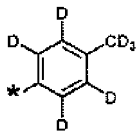

11-16

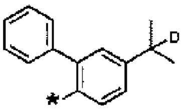

11-17

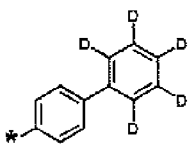

11-18

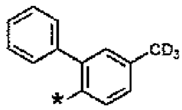

11-19

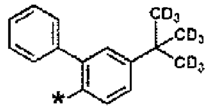

11-20

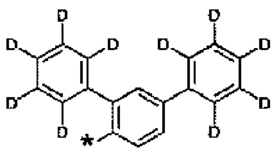

11-21

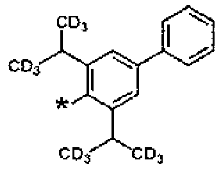

11-22

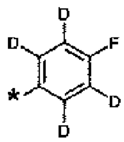

11-23

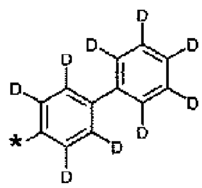

11-24

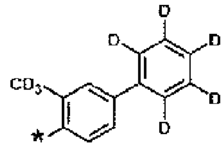

11-25

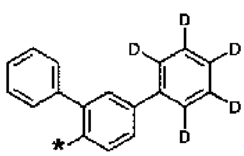

11-26

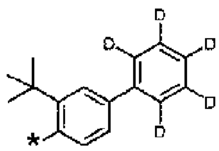

11-27

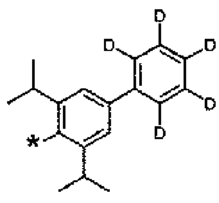

11-28

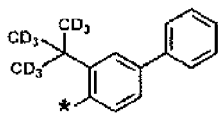

11-29

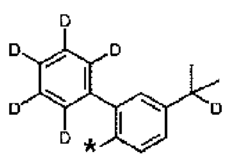

11-30

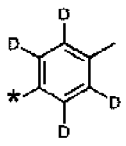

11-31

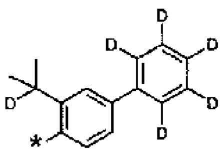

11-32

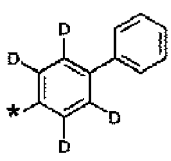

11-33

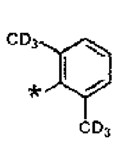

11-34

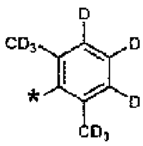

11-35

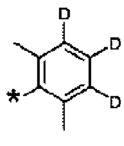

11-36

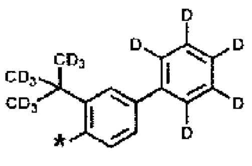

11-37

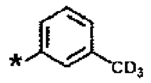

11-38

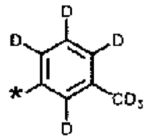

11-39

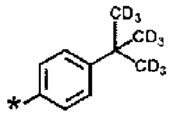

11-40

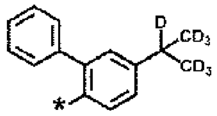

11-41

wobei in den Formeln 9-1 bis 9-19, 10-1 bis 10-232 und 11-1 bis 11-41 * eine Bindungsstelle zu einem benachbarten Atom anzeigt, Ph eine Phenylgruppe ist und TMS eine Trimethylsilylgruppe ist; und/oder

wobei

die Deuterium enthaltende Gruppe ausgewählt ist aus $-CD_3$, $-CD_2(CD_3)$, $-CD(CD_3)_2$,$-C(CD_3)_3$, $-CD_2-C(CD_3)_3$, $-CD_2-CD(CD_3)_2$, $-CD_2-CD_2(CD_3)$, $-CD(CD_3)-C(CD_3)_3$, $-CD(CD_3)-CD(CD_3)_2$, $-CD(CD_3)-CD_2(CD_3)$, $-C(CD_3)_2-C(CD_3)_3$, $-C(CD_3)_2-CD(CD_3)_2$, $-C(CD_3)_2-CD_2(CD_3)$, und einer Gruppe, dargestellt durch eine der Formeln 11-1 bis 11-41:

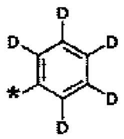

11-1

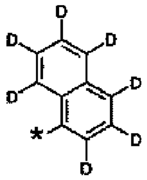

11-2

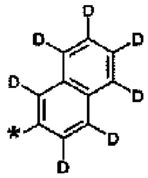

11-3

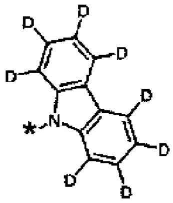

11-4

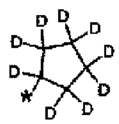

11-5

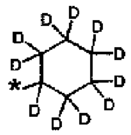

11-6

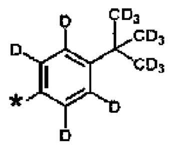

11-7

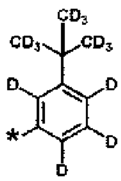

11-8

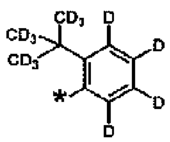

11-9

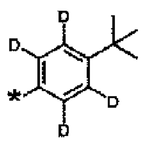

11-10

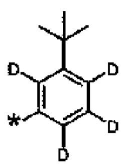

11-11

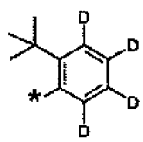

11-12

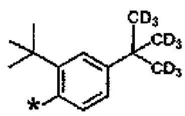

11-13

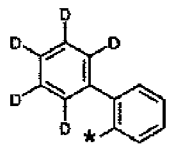

11-14

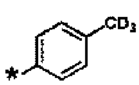

11-15

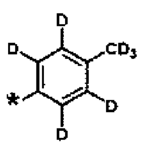

11-16

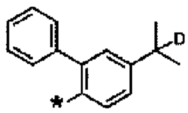

11-17

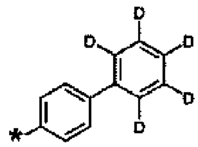

11-18

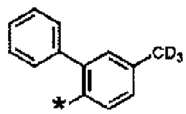

11-19

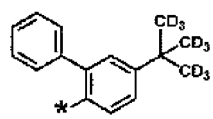

11-20

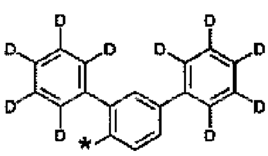

11-21

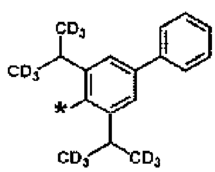

11-22

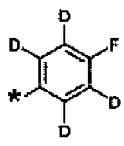

11-23

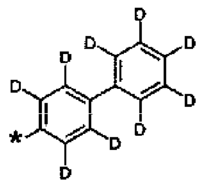

11-24

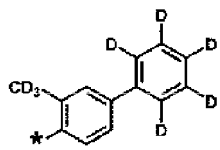

11-25

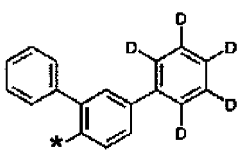

11-26

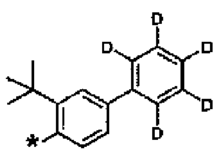

11-27

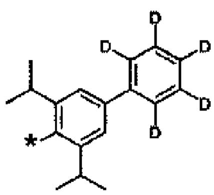

11-28

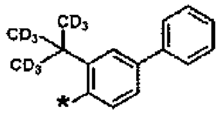

11-29

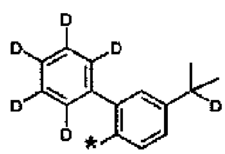

11-30

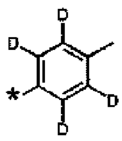
11-31
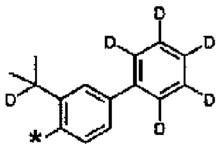
11-32
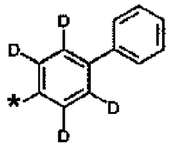
11-33
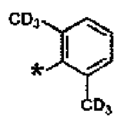
11-34
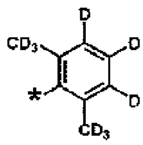
11-35
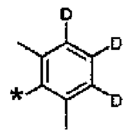
11-36

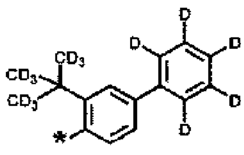
11-37
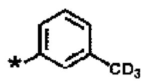
11-38
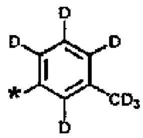
11-39
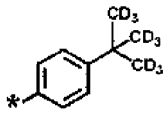
11-40
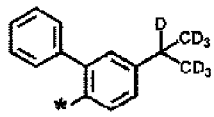
11-41

wobei * in den Formeln 11-1 bis 11-41 eine Bindungsstelle zu einem benachbarten Atom anzeigt.

**9.** Organometallverbindung nach einem der Ansprüche 1-8, wobei mindestens eine von <Bedingung A> bis <Bedingung D> erfüllt ist:

<Bedingung A>
n1 kann 1, 2, 3 oder 4 sein.
<Bedingung B>
$X_{51}$ kann $N[(L_7)b_7\text{-}(R_7)c_7]$ sein und $R_7$ kann Deuterium oder eine Deuterium enthaltende Gruppe sein.
<Bedingung C>
n3 kann 1, 2 oder 3 sein.
<Bedingung D>
n4 kann 1, 2, 3 oder 4 sein.

**10.** Organometallverbindung nach einem der Ansprüche 1-9, wobei eine durch

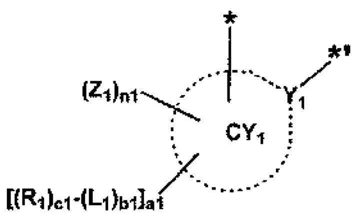

in Formel 1 dargestellte Gruppierung eine Gruppe ist, die durch eine der Formeln CY1-1 bis CY1-40 dargestellt ist:

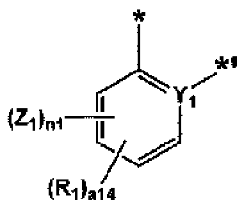
CY1-1
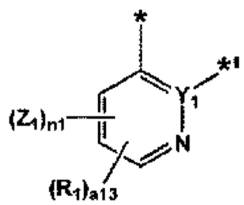
CY1-2
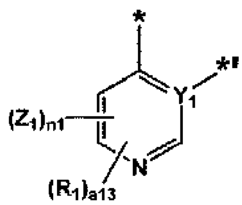
CY1-3
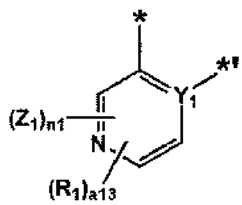
CY1-4

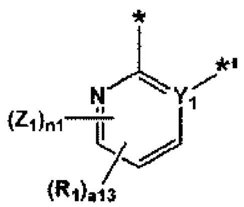
CY1-5
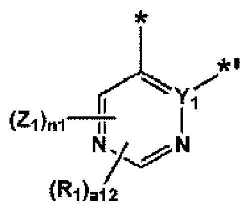
CY1-6
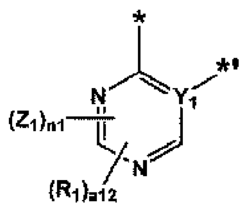
CY1-7
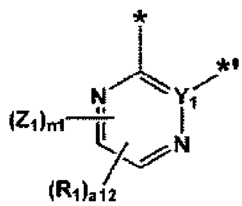
CY1-8

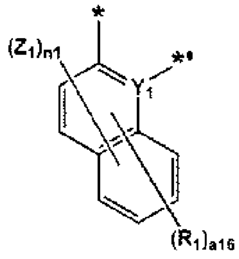
CY1-9

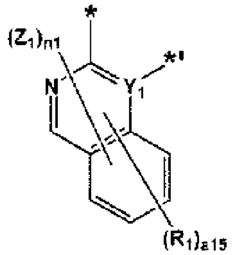
CY1-10

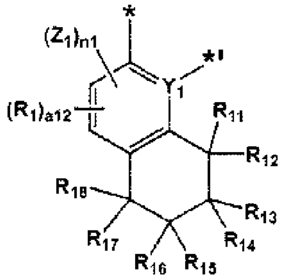
CY1-11

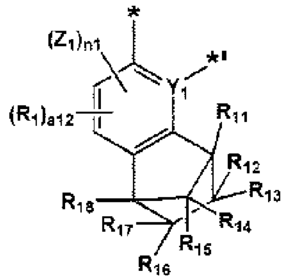
CY1-12

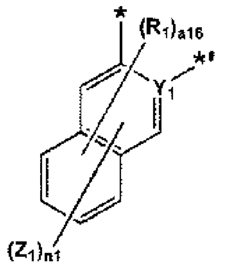
CY1-13

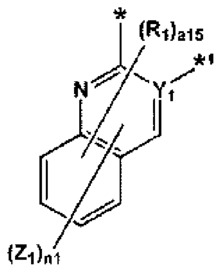
CY1-14

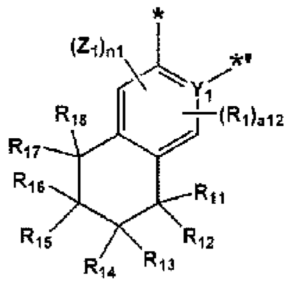
CY1-15

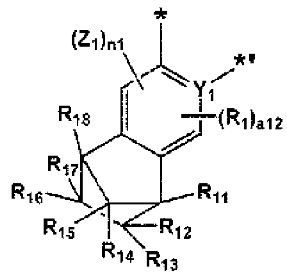
CY1-16

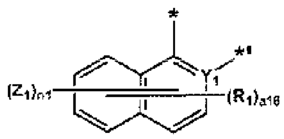
CY1-17

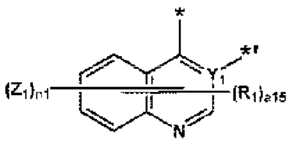
CY1-18

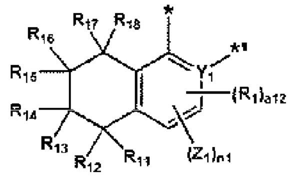
CY1-19

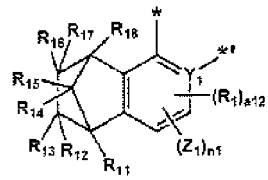
CY1-20

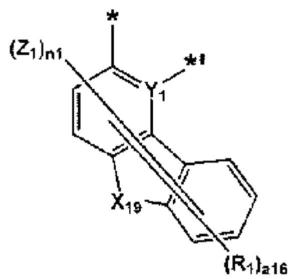
CY1-21

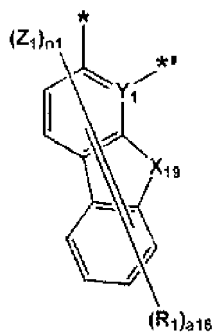
CY1-22

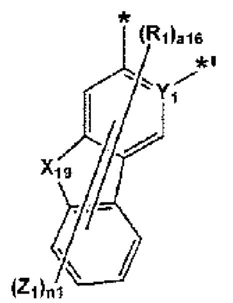
CY1-23

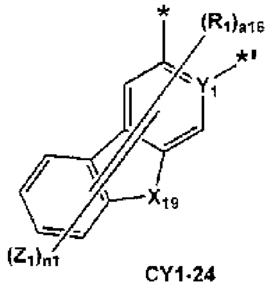
CY1-24

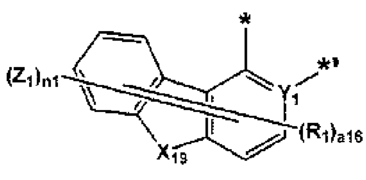
CY1-25

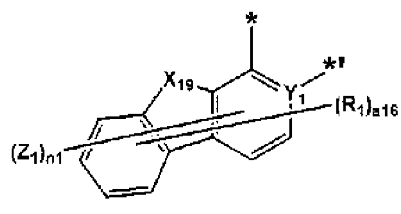
CY1-26

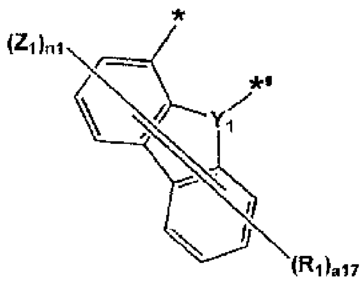
CY1-27

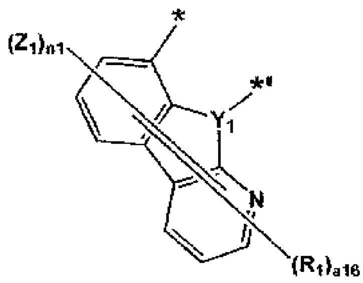
CY1-28

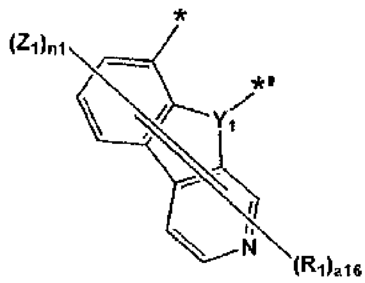
CY1-29

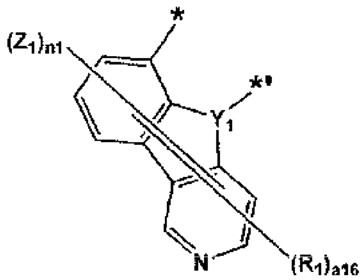
CY1-30

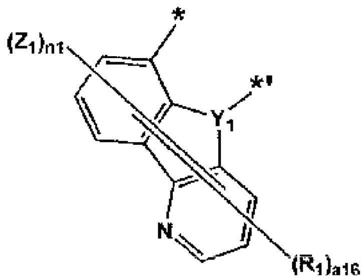
CY1-31

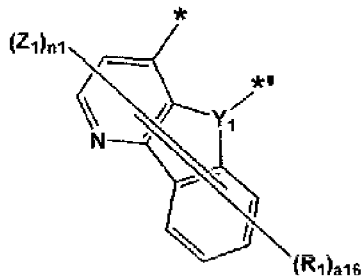
CY1-32

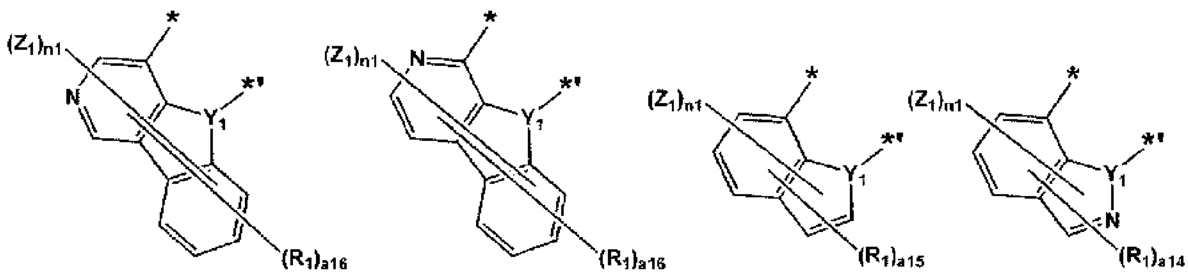
CY1-33 CY1-34 CY1-35 CY1-36

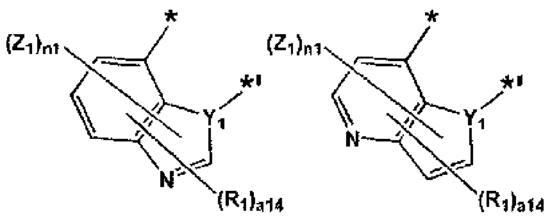
CY1-37 CY1-38

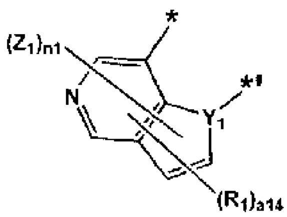
CY1-39

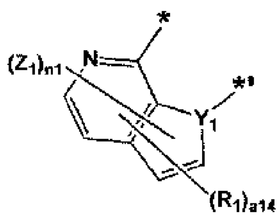
CY1-40

wobei in Formel CY1-1 bis CY1-40,

$Y_1$, $R_1$, $Z_1$ und n1 der Beschreibung in Anspruch 1 entsprechen, und n1 eine ganze Zahl von 0 bis 7 ist,
$X_{19}$ $C(R_{19a})(R_{19b})$, $N[(L_{19})_{b19}-(R_{19})c_{19}]$, O, S, oder $Si(R_{19a})(R_{19b})$ ist,
$L_{19}$ der Beschreibung in Verbindung mit $L_1$ in Anspruch 1 entspricht,
b19 und c19 der Beschreibung in Verbindung mit b1 und c1 in Anspruch 1 entsprechen,
$R_{11}$ bis $R_{19}$, $R_{19a}$ und $R_{19b}$ der Beschreibung in Verbindung mit $R_1$ in Anspruch entsprechen,
a12 eine ganze Zahl von 0 bis 2 ist,
a13 eine ganze Zahl von 0 bis 3 ist,
a14 eine ganze Zahl von 0 bis 4 ist,
a15 eine ganze Zahl von 0 bis 5 ist,
a16 eine ganze Zahl von 0 bis 6 ist,
a17 eine ganze Zahl von 0 bis 7 ist,
*' eine Bindungsstelle zu $X_1$ oder M in Formel 1 anzeigt, und
* eine Bindungsstelle zu $T_1$ in Formel 1 anzeigt; und/oder
wobei

eine durch

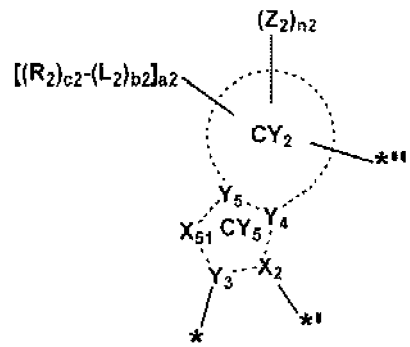

in Formel 1 dargestellte Gruppierung eine Gruppe ist, die durch eine der Formeln CY2-1 bis CY2-20 dargestellt wird:

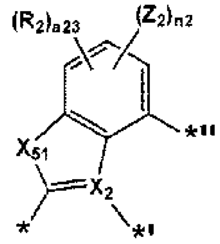

CY2-1

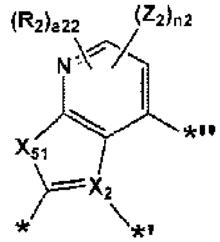

CY2-2

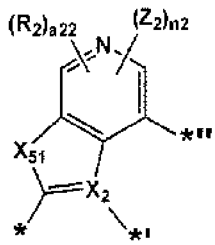

CY2-3

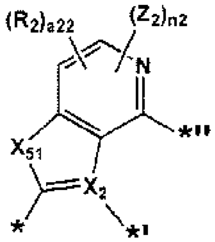

CY2-4

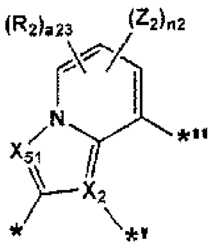

CY2-5

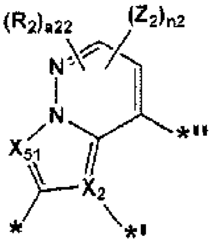

CY2-6

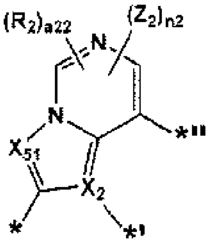

CY2-7

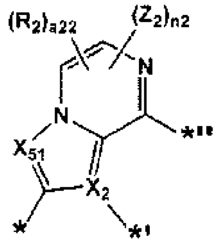

CY2-8

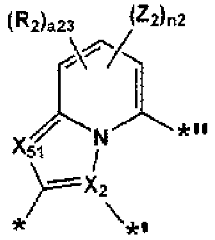

CY2-9

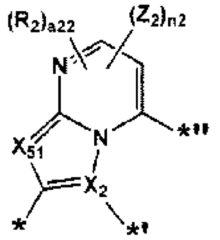

CY2-10

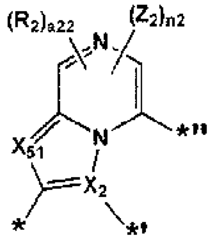

CY2-11

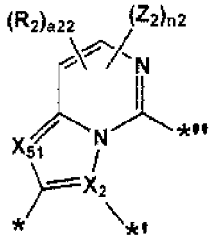

CY2-12

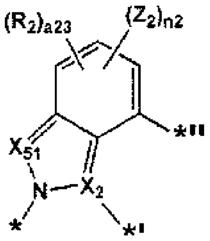
CY2-13

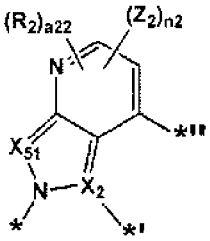
CY2-14

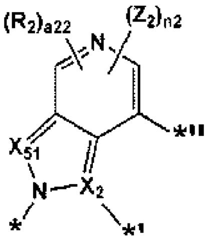
CY2-15

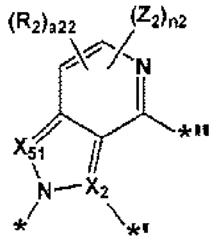
CY2-16

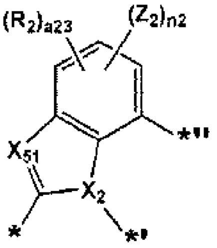
CY2-17

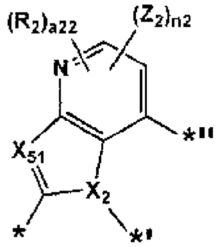
CY2-18

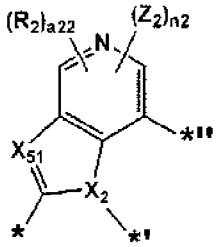
CY2-19

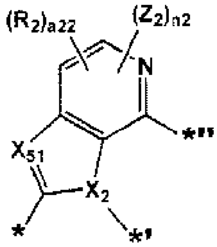
CY2-20

wobei in den Formeln CY2-1 bis CY2-20,
$X_2$, $R_2$, $Z_2$ und n2 der Beschreibung in Anspruch 1 entsprechen, und n2 eine ganze Zahl von 0 bis 3 ist,
$X_{51}$ in den Formeln CY2-1 bis CY2-4 O, S, N-$[(L_7)_{b7}$-$(R_7)_{c7}]$, $C(R_7)(R_8)$, $Si(R_7)(R_8)$, $Ge(R_7)(R_8)$ oder C(=O) ist,
$X_{51}$ in den Formeln CY2-5 bis CY2-20 N, $C(R_7)$, $Si(R_7)$ oder $Ge(R_7)$ ist,
$L_7$, b7, $R_7$ und c7 der Beschreibung in Verbindung mit Anspruch 1 entsprechen,
a22 eine ganze Zahl von 0 bis 2 ist,
a23 eine ganze Zahl von 0 bis 3 ist,
* eine Bindungsstelle zu $T_1$ in Formel 1 anzeigt,
*' eine Bindungsstelle zu M in Formel 1 an zeigt, und
*" eine Bindungsstelle zu Ring $CY_3$ in Formel 1 anzeigt.

**11.** Organometallverbindung nach einem der Ansprüche 1-10, wobei eine durch

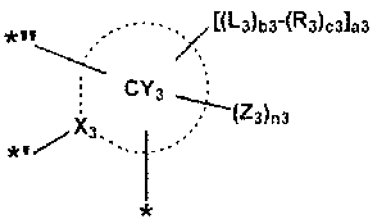

in Formel 1 dargestellte Gruppierung eine Gruppe ist, die durch eine der Formeln CY3-1 bis CY3-12 dargestellt wird:

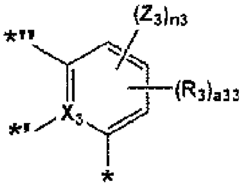
CY3-1

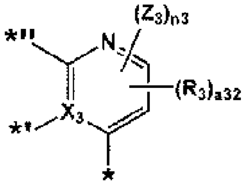
CY3-2

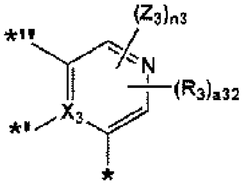
CY3-3

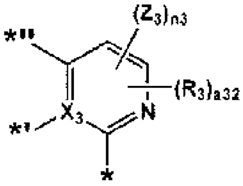
CY3-4

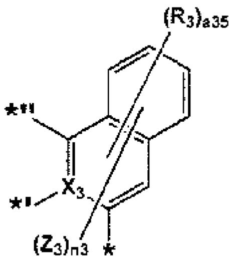
CY3-5

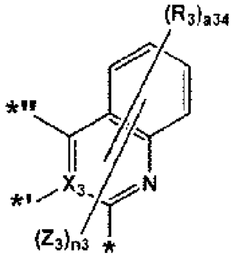
CY3-6

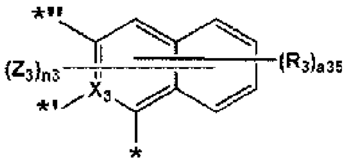
CY3-7

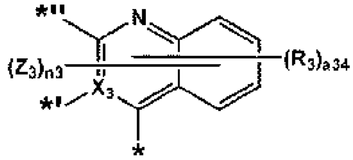
CY3-8

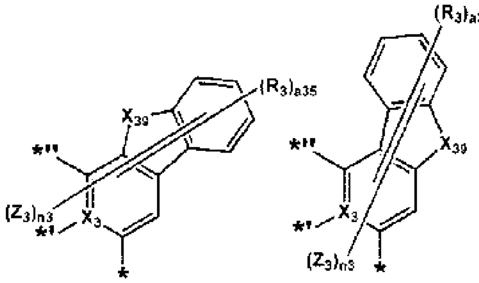
CY3-9 CY3-10

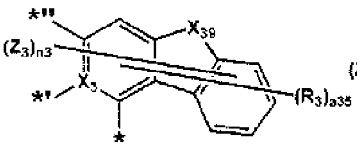
CY3-11

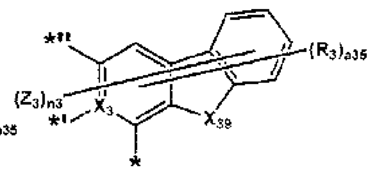
CY3-12

wobei in den Formeln CY3-1 bis CY3-12,

$X_3$, $R_3$, $Z_3$ und n3 der Beschreibung in Verbindung mit Anspruch 1 entsprechen, und n3 eine ganze Zahl von 0 bis 5 ist,
$X_{39}$ $C(R_{39a})(R_{39b})$, $N[(L_{39})_{b39}\text{-}(R_{39})c_{39}]$, O, S oder $Si(R_{39a})(R_{39b})$ ist,
$L_{39}$ der Erläuterung in Verbindung mit $L_3$ in Anspruch 1 entspricht,
b39 und c39 der Beschreibung in Verbindung mit b3 bzw. c3 in Anspruch 1 entsprechen,
$R_{39a}$ und $R_{39b}$ der Beschreibung in Verbindung mit $R_3$ in Anspruch 1 entsprechen,
a32 eine ganze Zahl von 0 bis 2 ist,
a33 eine ganze Zahl von 0 bis 3 ist,
a34 eine ganze Zahl von 0 bis 4 ist,
a35 eine ganze Zahl von 0 bis 5 ist,
* eine Bindungsstelle zu $T_2$ in Formel 1 anzeigt,
*' eine Bindungsstelle zu M in Formel 1 anzeigt, und
*" eine Bindungsstelle zu Ring $CY_2$ in Formel 1 anzeigt; und/oder
wobei
eine durch

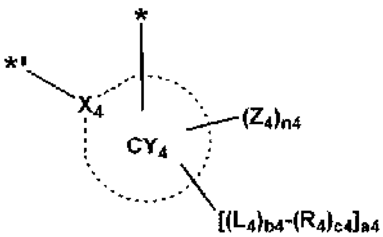

in Formel 1 dargestellte Gruppierung eine Gruppe ist, die durch eine der Formeln CY4-1 bis CY4-26 dargestellt wird:

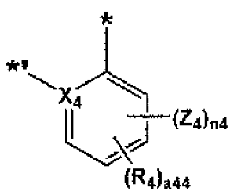
CY4-1
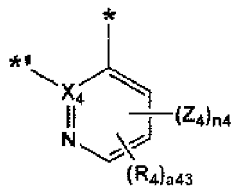
CY4-2
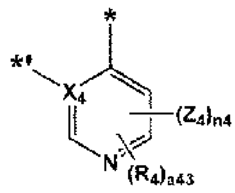
CY4-3
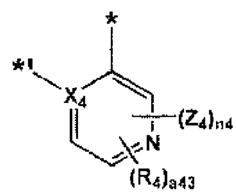
CY4-4
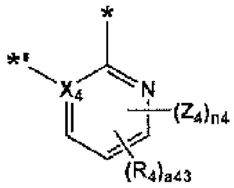
CY4-5
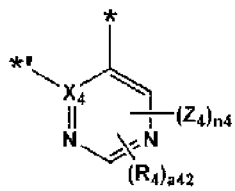
CY4-6
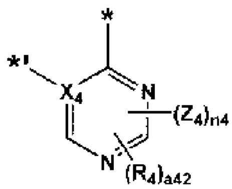
CY4-7
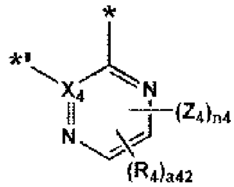
CY4-8
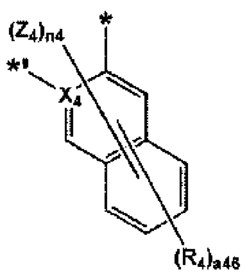
CY4-9
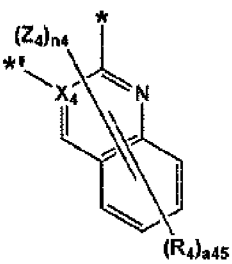
CY4-10
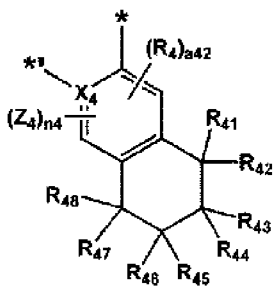
CY4-11
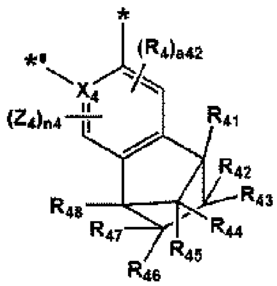
CY4-12
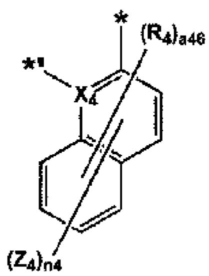
CY4-13
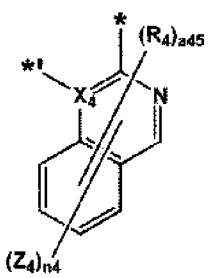
CY4-14
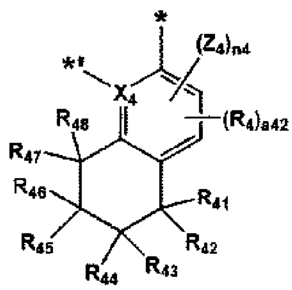
CY4-15
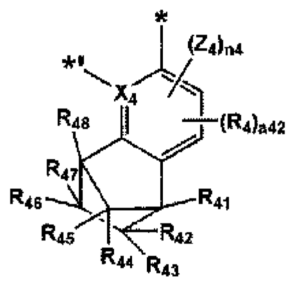
CY4-16
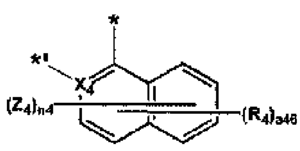
CY4-17
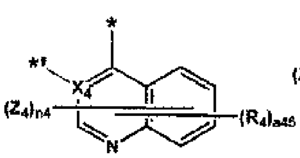
CY4-18
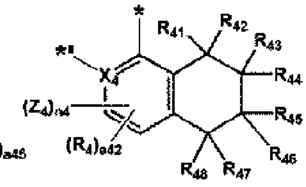
CY4-19
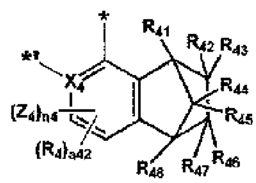
CY4-20

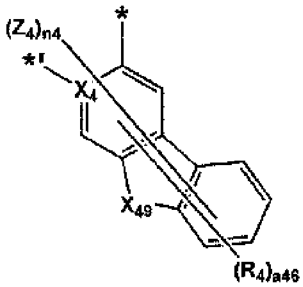

CY4-21

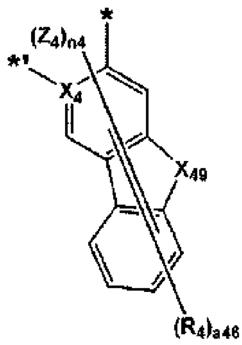

CY4-22

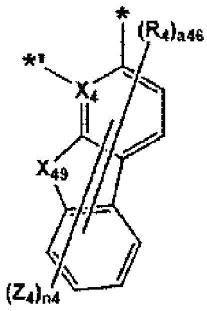

CY4-23

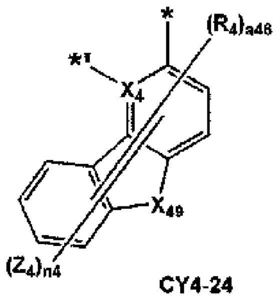

CY4-24

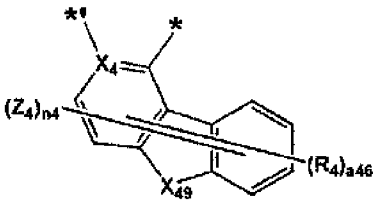

CY4-25

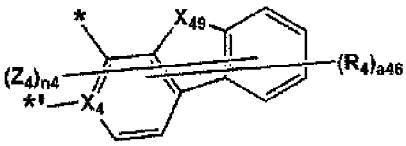

CY4-26

wobei in den Formeln CY4-1 bis CY4-26,

$X_4$, $R_4$, $Z_4$ und n4 der Beschreibung in Verbindung mit Anspruch 1 entsprechen, und n4 eine ganze Zahl von 0 bis 6 ist,

$X_{49}$ $C(R_{49a})(R_{49b})$, $N[(L_{49})_{b49}\text{-}(R_{49})c_{49}]$, O, S oder $Si(R_{49a})(R_{49b})$ ist,

$L_{49}$ der Beschreibung in Verbindung mit $L_4$ in Anspruch 1 entspricht,

b49 und c49 der Beschreibung in Verbindung mit b4 bzw. c4 in Anspruch 1 entsprechen,

$R_{41}$ bis $R_{49}$, $R_{49a}$ und $R_{49b}$ jeweils der Beschreibung in Verbindung mit $R_4$ in Anspruch 1 entsprechen,

a42 eine ganze Zahl von 0 bis 2 ist,

a43 eine ganze Zahl von 0 bis 3 ist,

a44 eine ganze Zahl von 0 bis 4 ist,

a45 eine ganze Zahl von 0 bis 5 ist,

a46 eine ganze Zahl von 0 bis 6 ist,

* eine Bindungsstelle zu $T_2$ in Formel 1 anzeigt, und

*' eine Bindungsstelle zu M in Formel 1 anzeigt.

**12.** Organometallverbindung nach Anspruch 1, wobei die Organometallverbindung eine der nachfolgenden Verbindungen 1 bis 666 ist:

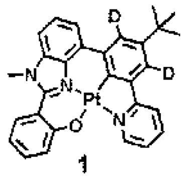

1

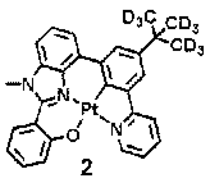

2

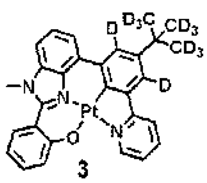

3

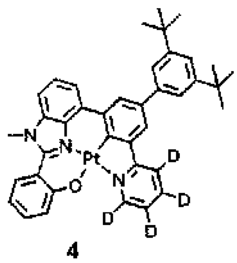

4

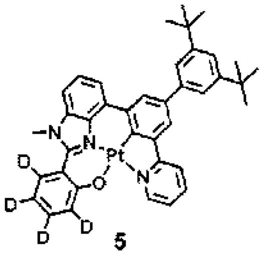

5

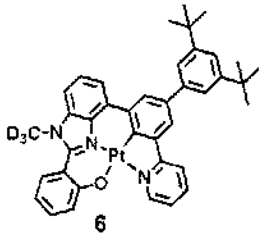

6

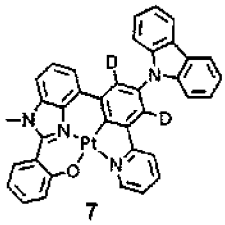

7

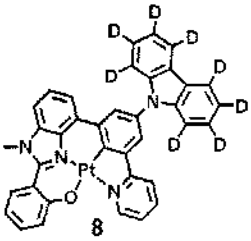

8

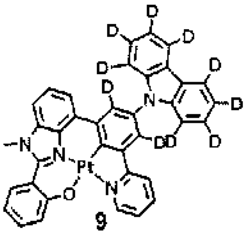

9

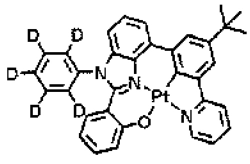

10

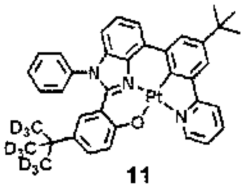

11

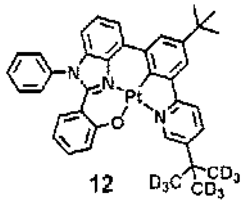

12

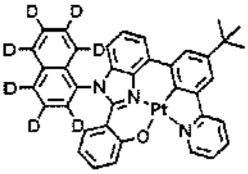

13

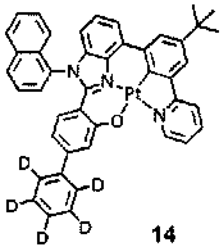

14

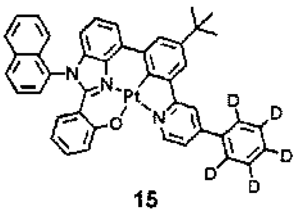

15

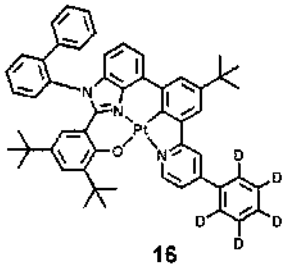

16

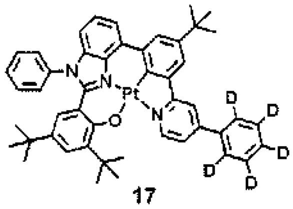

17

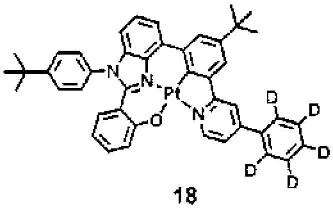

18

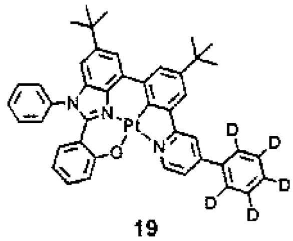

19

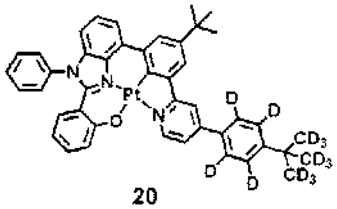

20

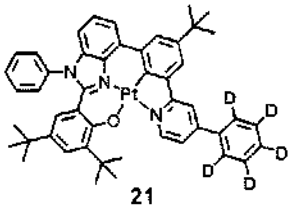

21

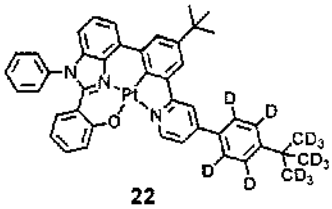

22

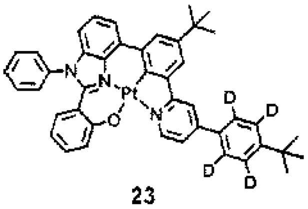

23

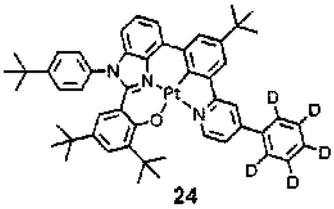

24

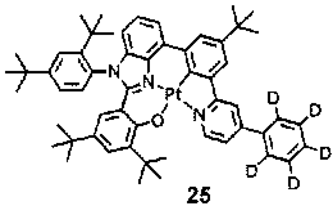

25

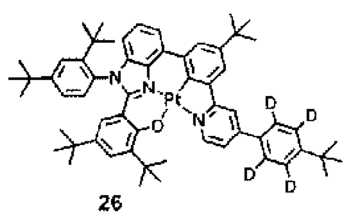
26

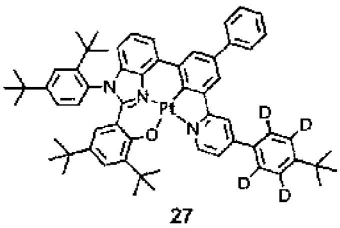
27

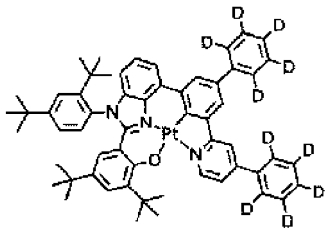
28

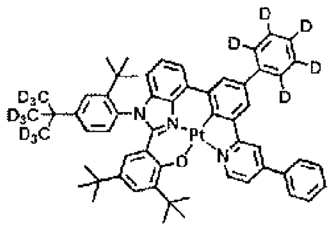
29

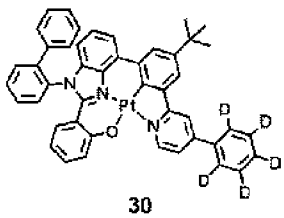
30

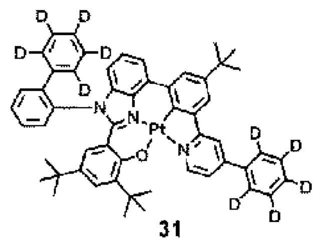
31

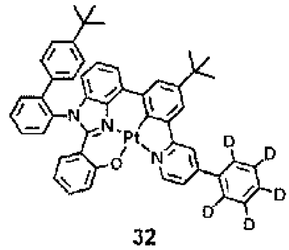
32

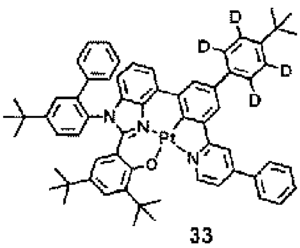
33

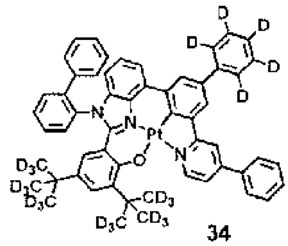
34

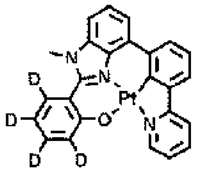
35

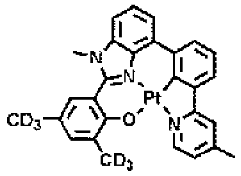
36

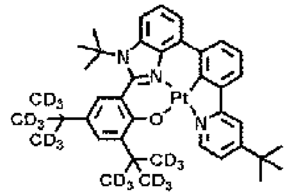
37

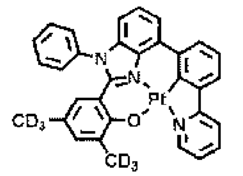
38

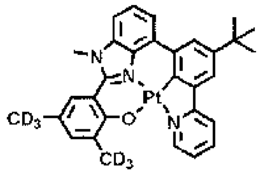
39

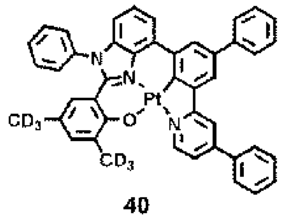
40

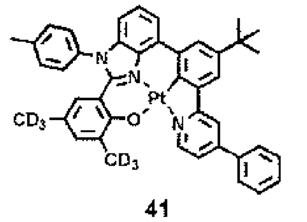
41

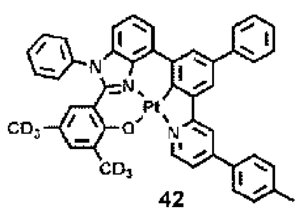
42

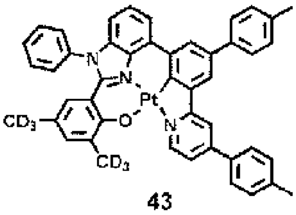
43

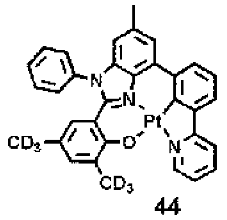
44

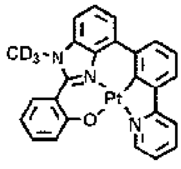
45

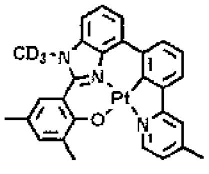
46

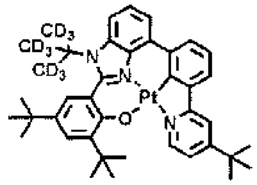
47

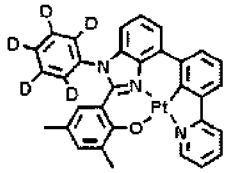
48

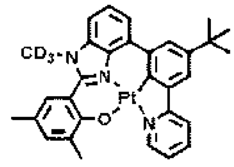
49

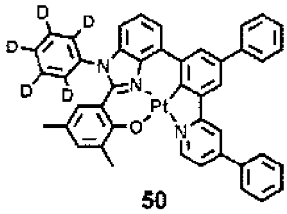
50

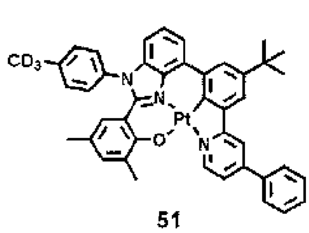
51

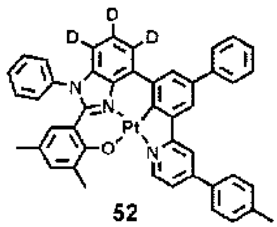
52

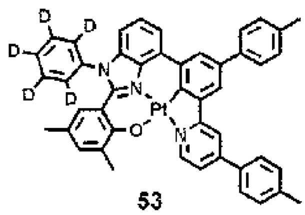
53

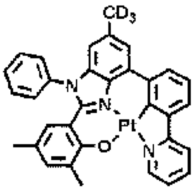
54

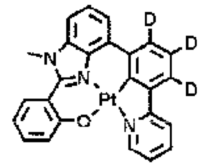
55

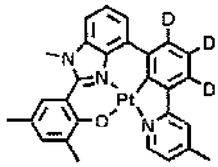
56

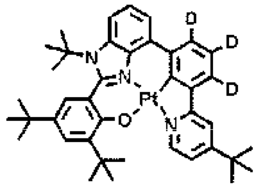
57

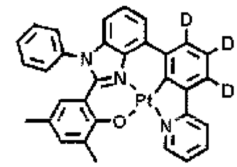
58

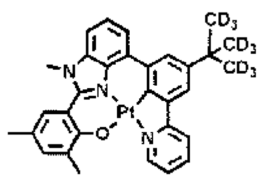
59

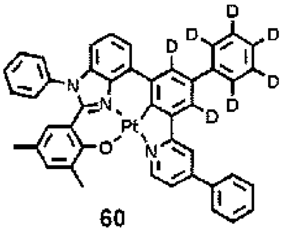
60

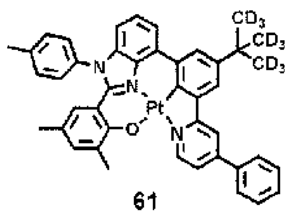
61

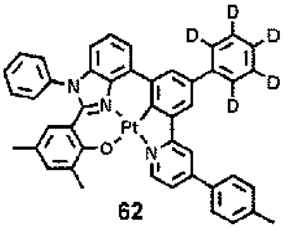
62

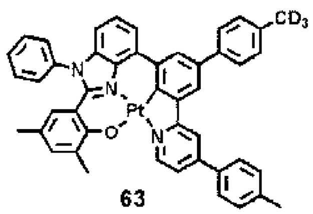
63

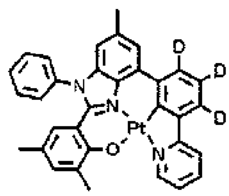
64

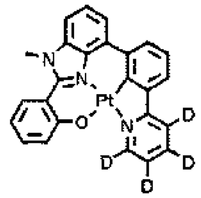
65

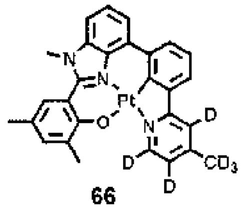
66

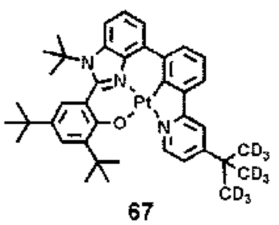
67

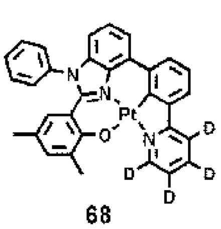
68

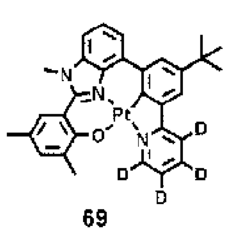
69

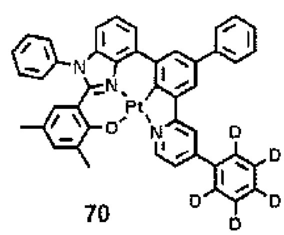
70

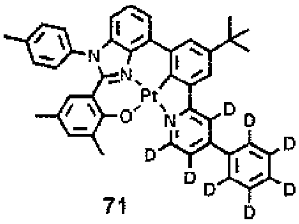
71

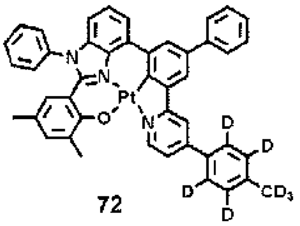
72

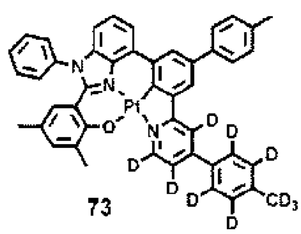
73

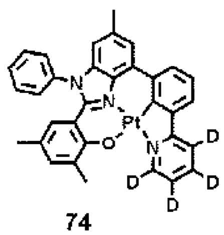
74

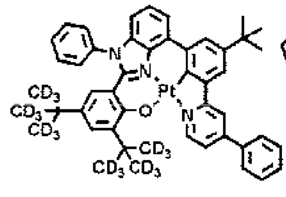
75

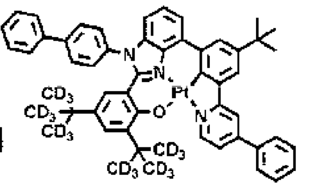
76

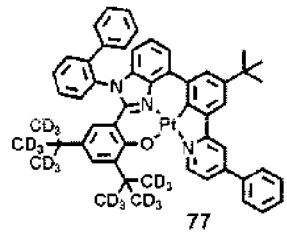
77

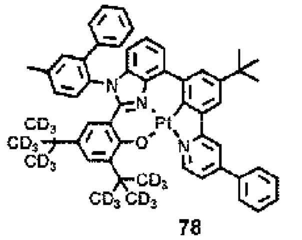
78

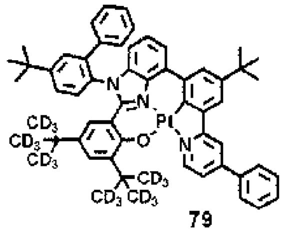
79

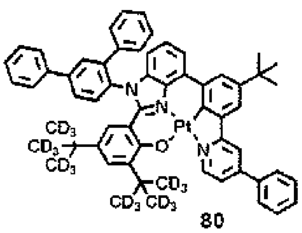
80

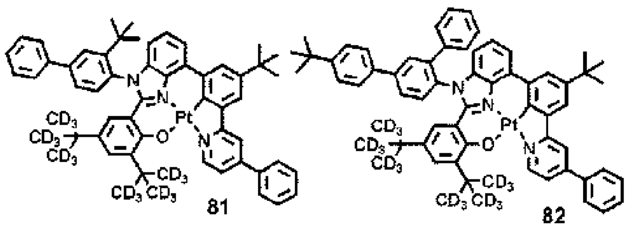
81

82

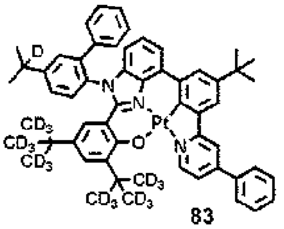
83

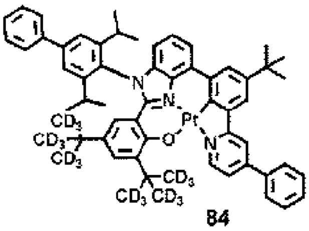
84

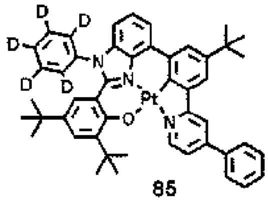
85

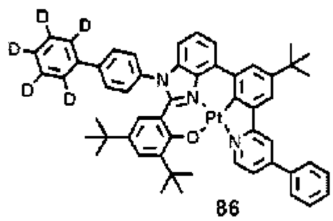
86

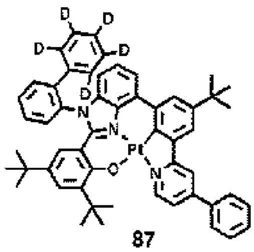
87

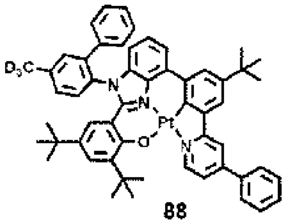
88

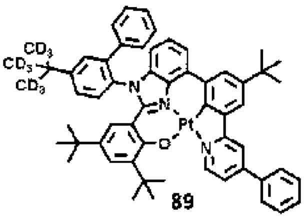
89

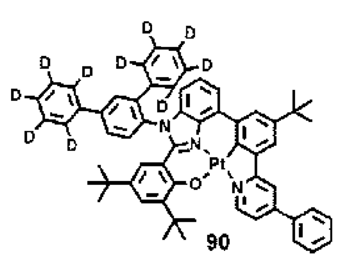
90

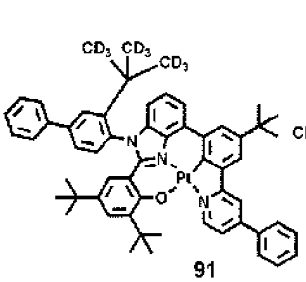
91

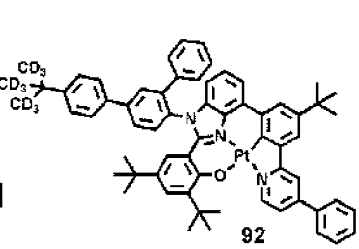
92

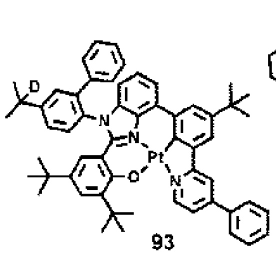
93

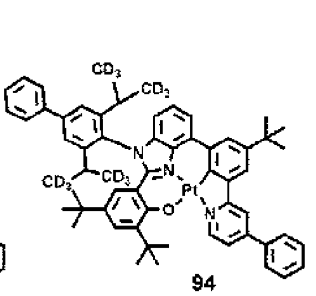
94

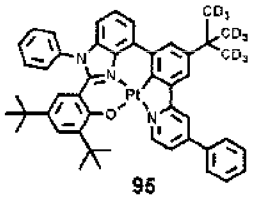
95
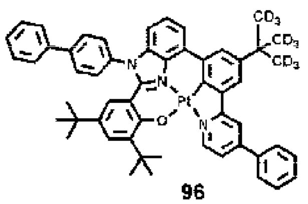
96
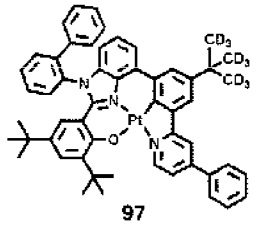
97
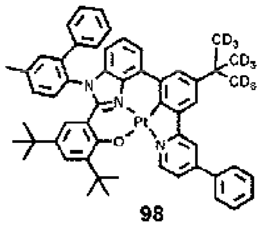
98

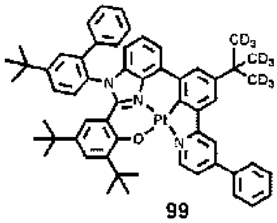
99
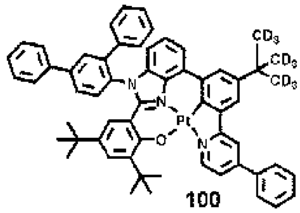
100
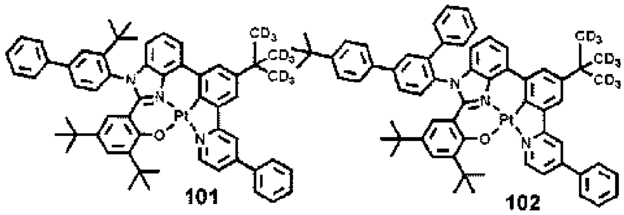
101
102

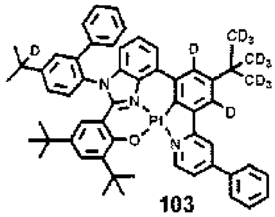
103
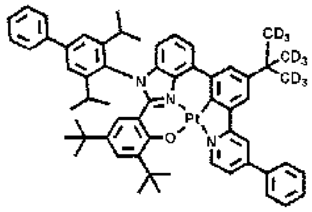
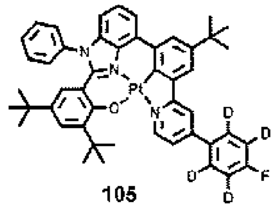
105
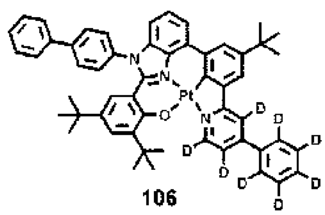
106

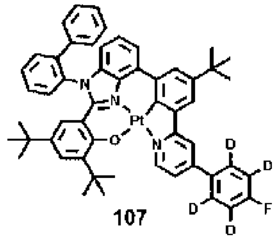
107
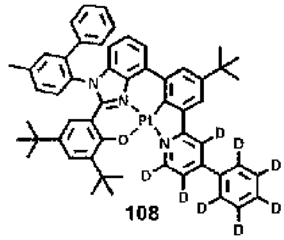
108
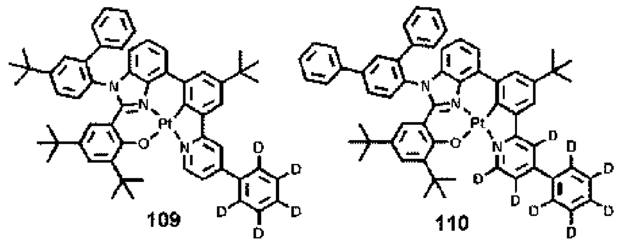
109
110

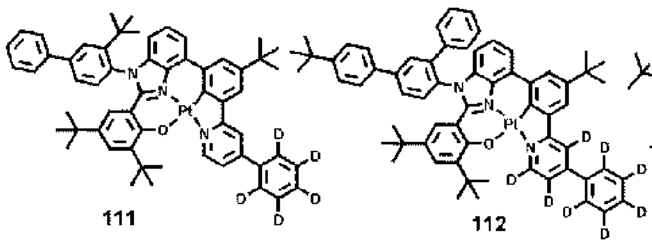
111
112
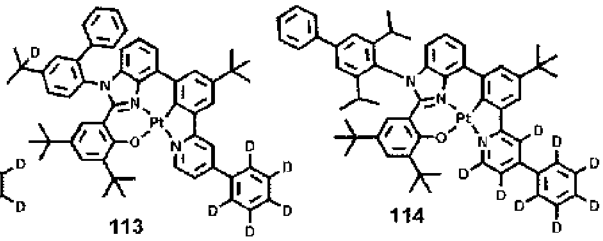
113
114

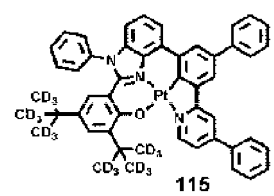
115
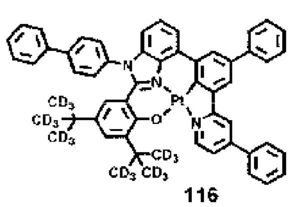
116
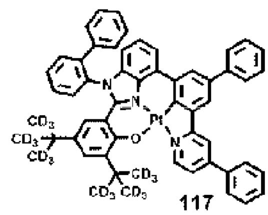
117
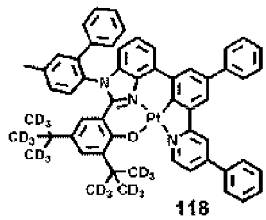
118

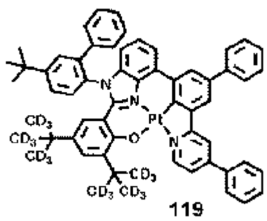
119

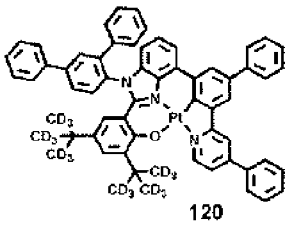
120

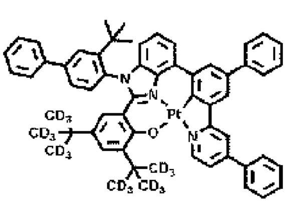
121

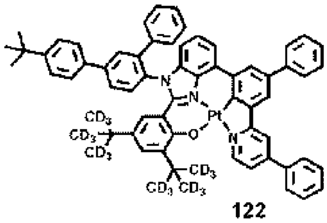
122

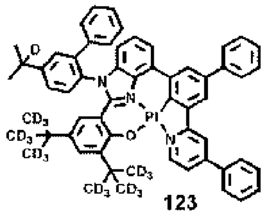
123

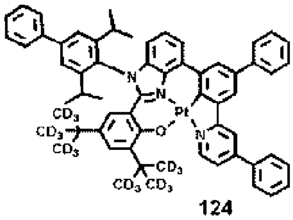
124

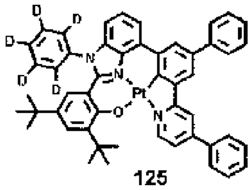
125

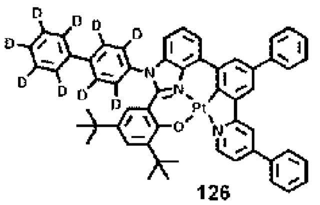
126

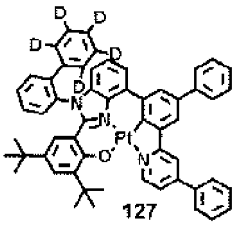
127

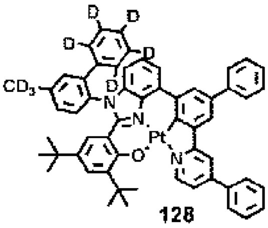
128

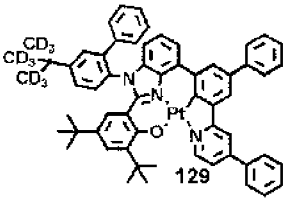
129

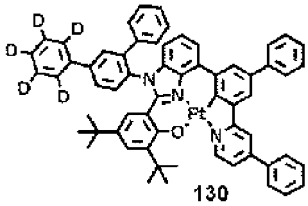
130

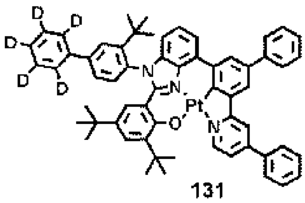
131

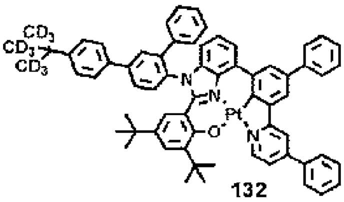
132

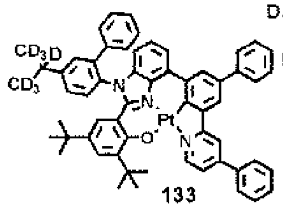
133

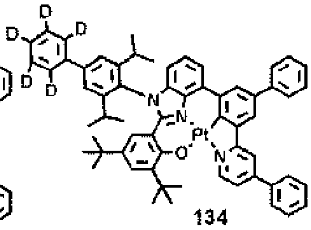
134

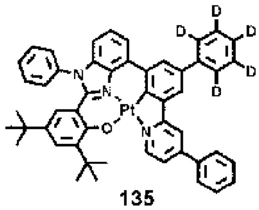
135

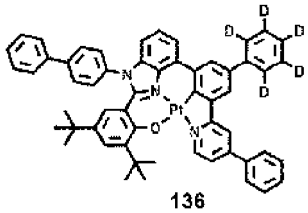
136

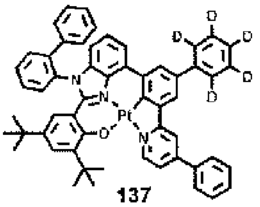
137

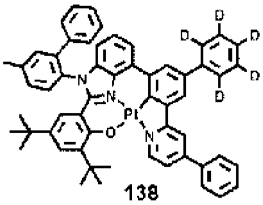
138

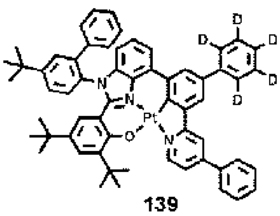
139

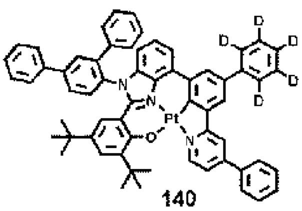
140

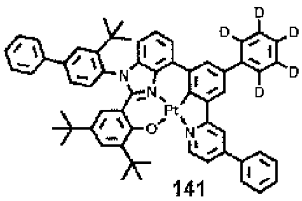
141

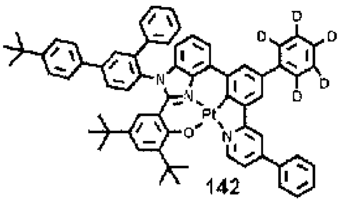
142

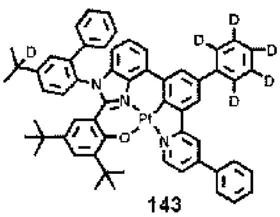
143

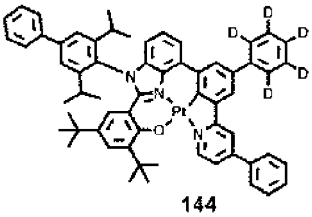
144

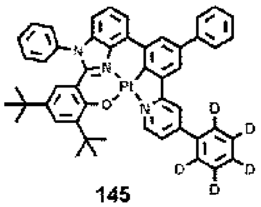
145

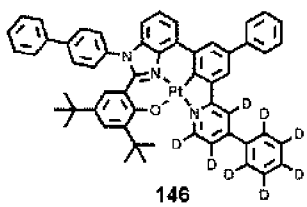
146

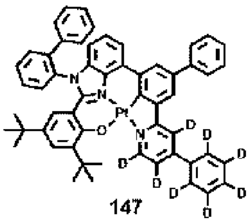
147

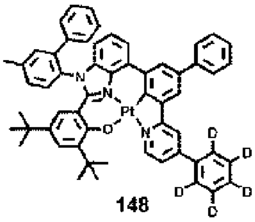
148

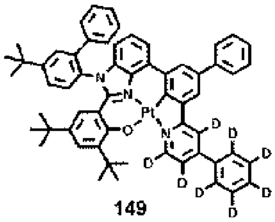
149

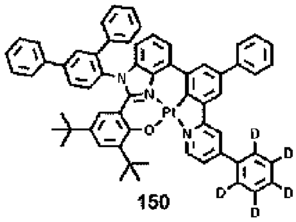
150

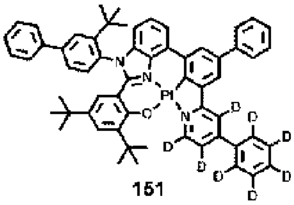
151

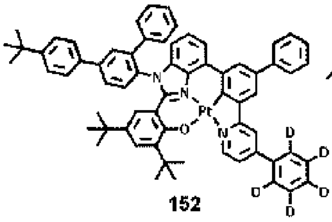
152

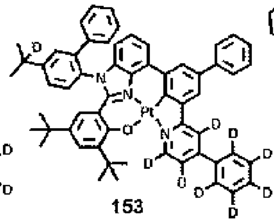
153

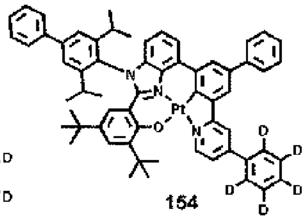
154

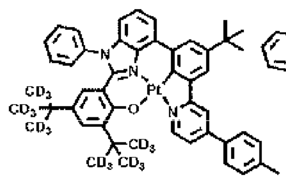
155

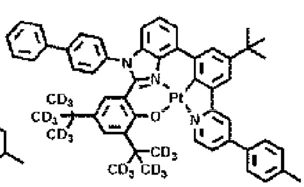
156

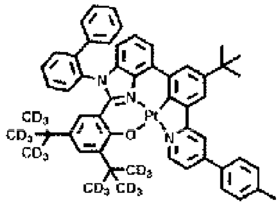
157

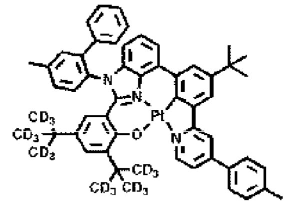
158

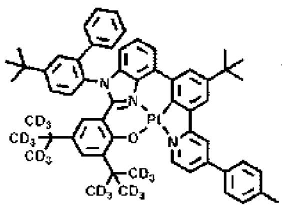
159

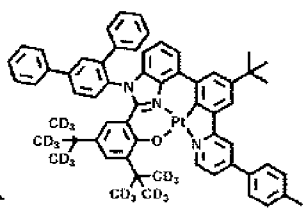
160

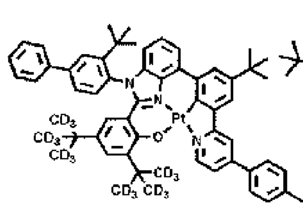
161

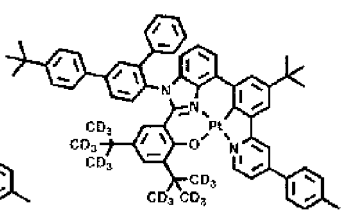
162

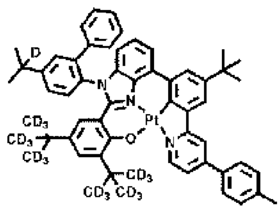
163

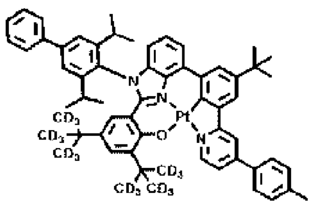
164

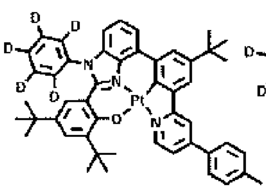
165

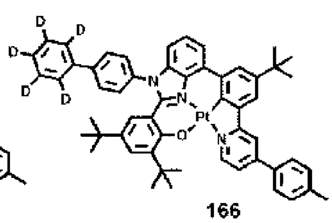
166

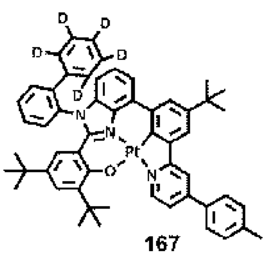

167

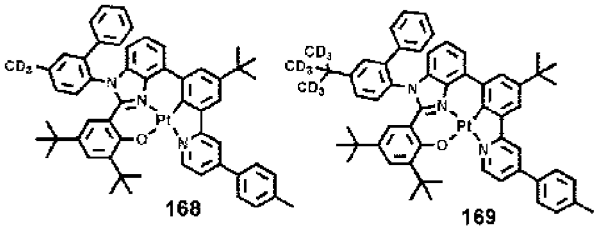

168

169

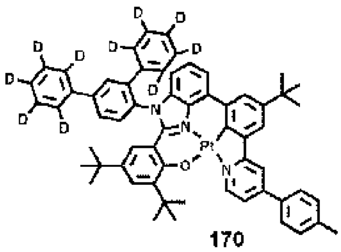

170

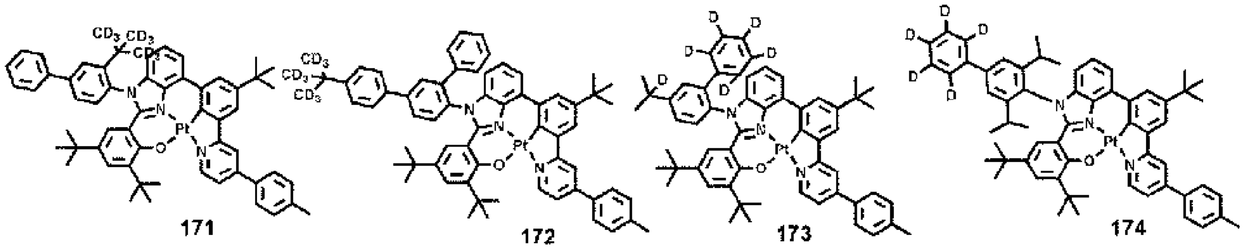

171

172

173

174

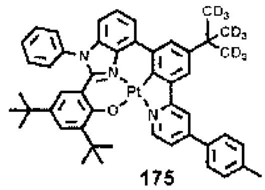

175

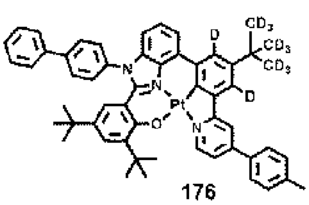

176

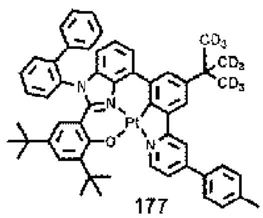

177

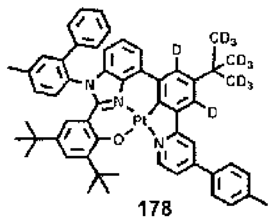

178

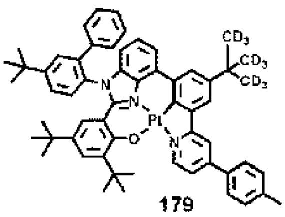

179

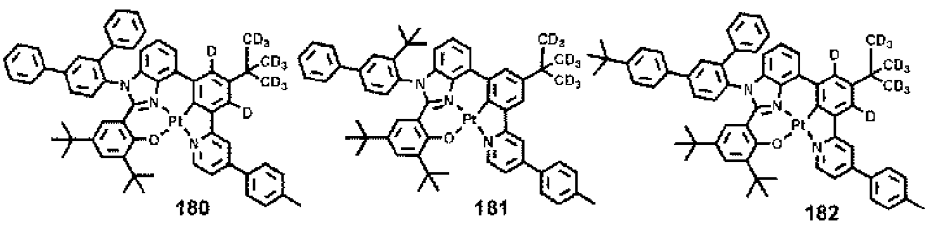

180

181

182

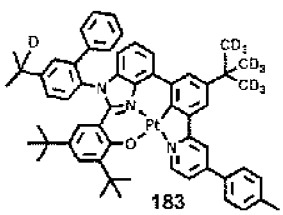

183

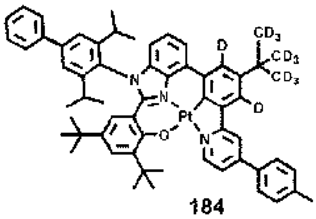

184

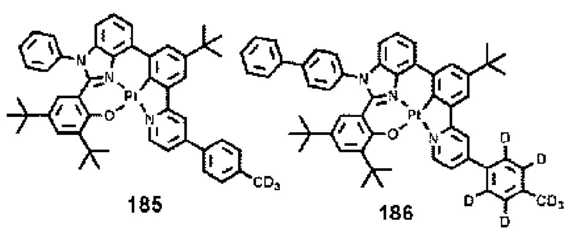

185

186

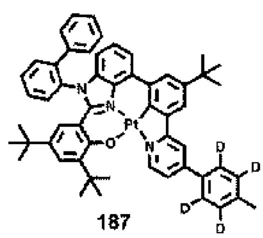

187

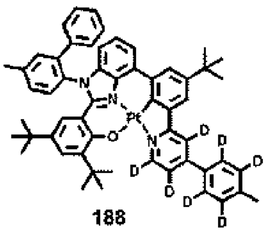

188

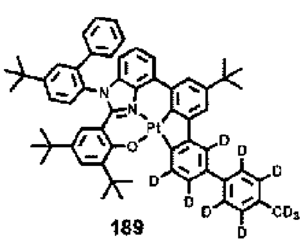

189

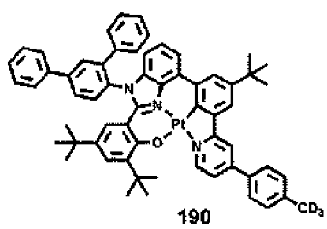

190

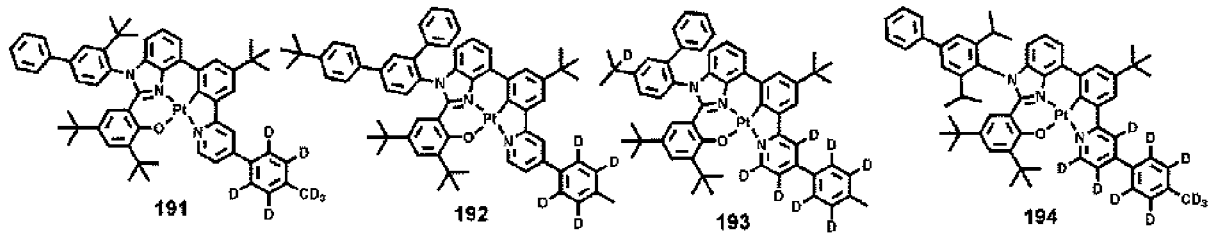

191 192 193 194

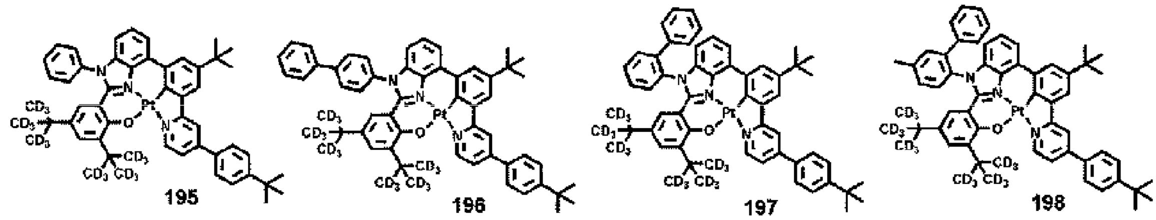

195 196 197 198

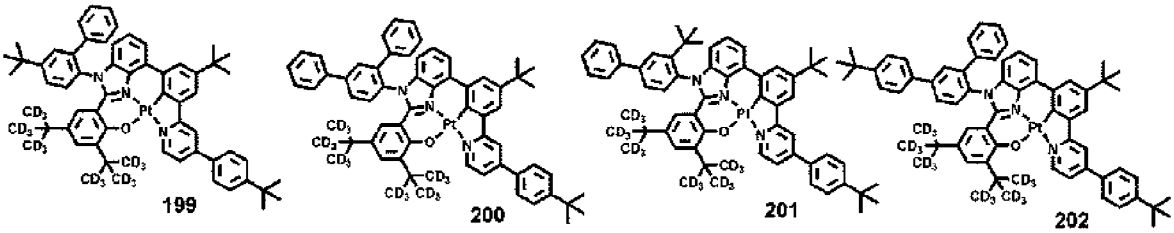

199 200 201 202

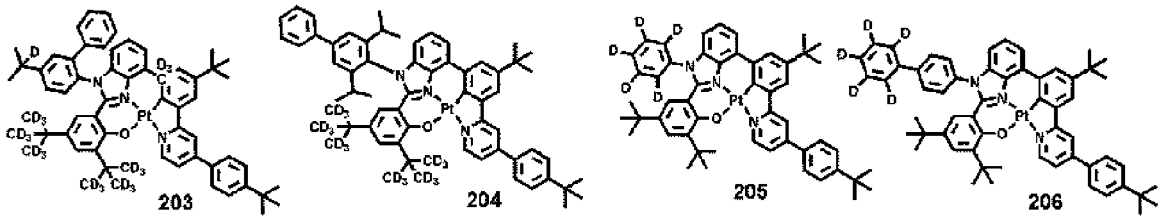

203 204 205 206

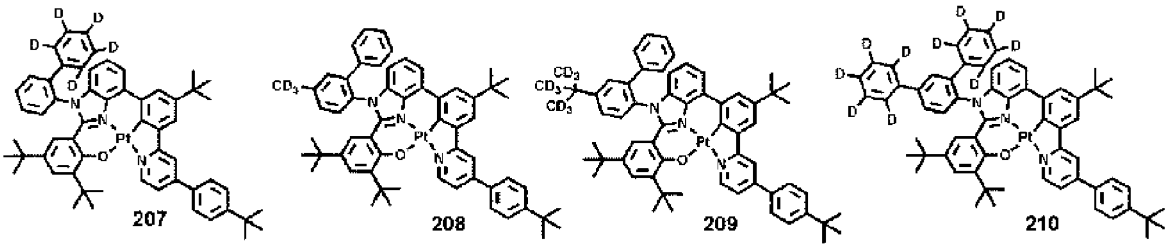

207 208 209 210

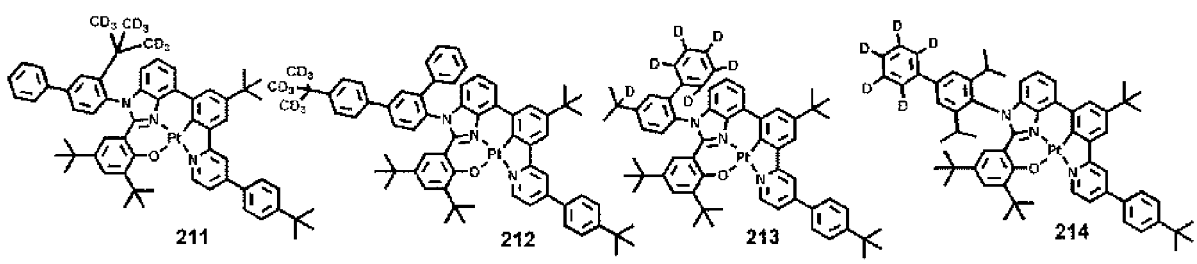

211 212 213 214

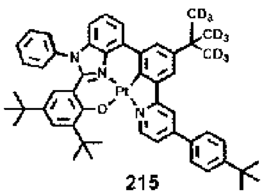
215

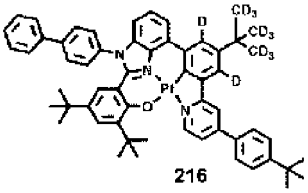
216

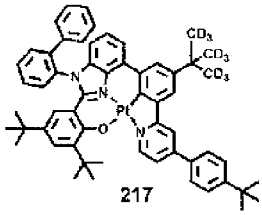
217

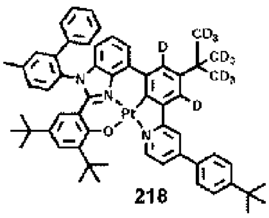
218

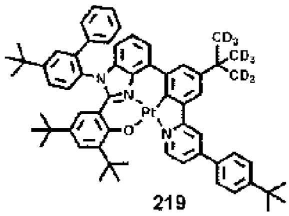
219

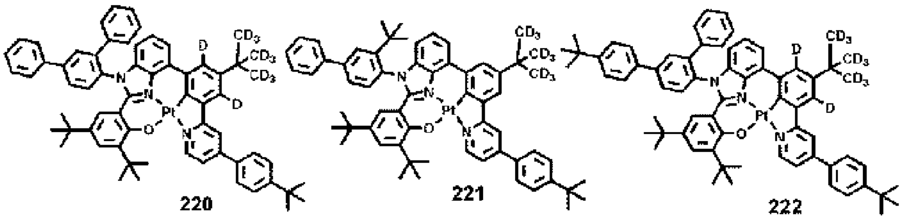
220

221

222

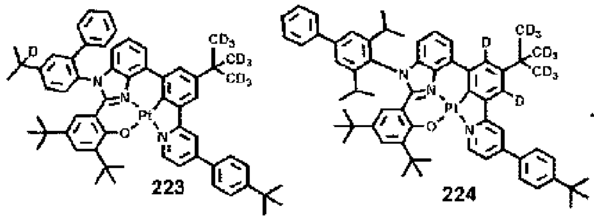
223

224

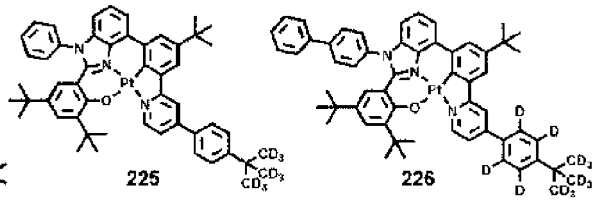
225

226

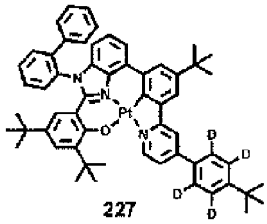
227

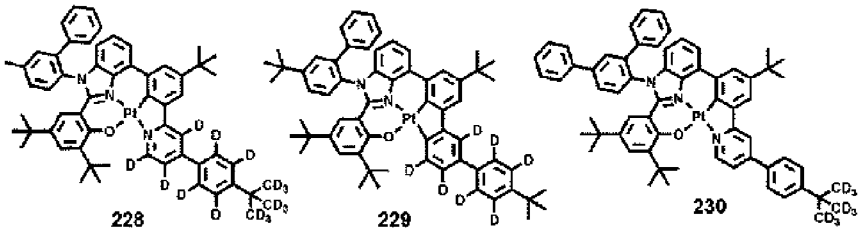
228

229

230

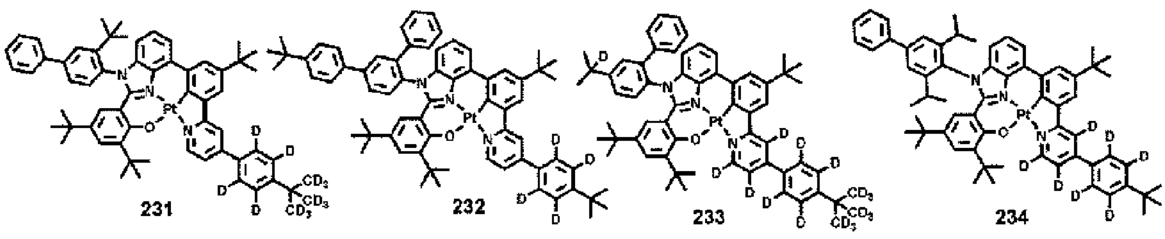
231

232

233

234

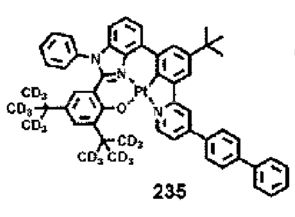
235

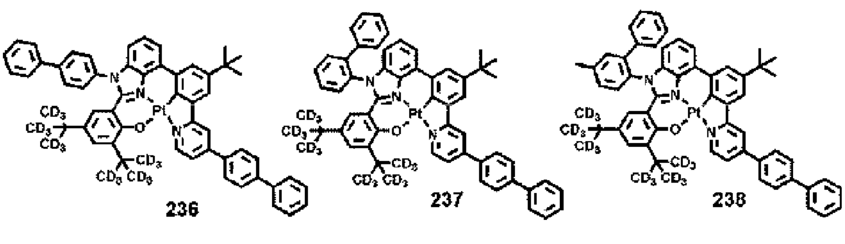
236

237

238

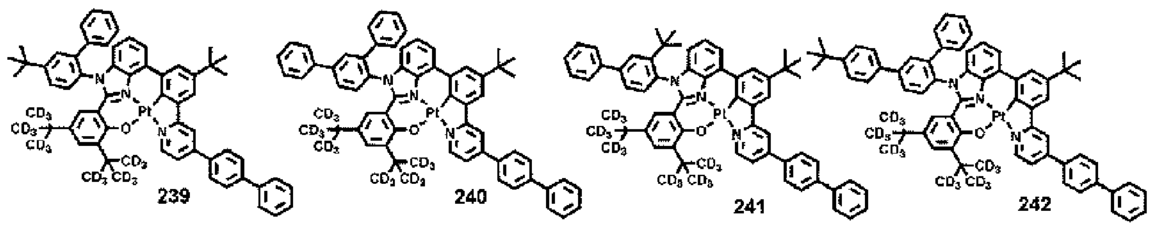

239 240 241 242

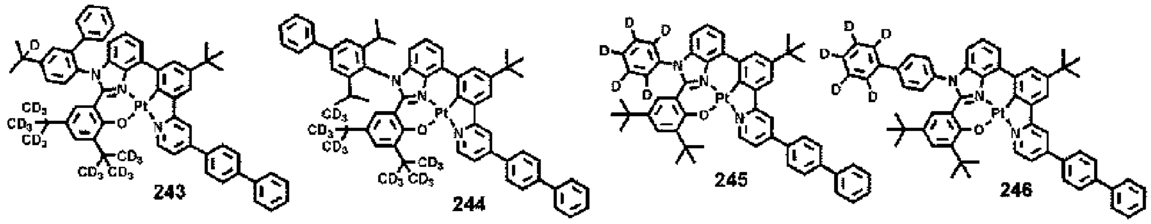

243 244 245 246

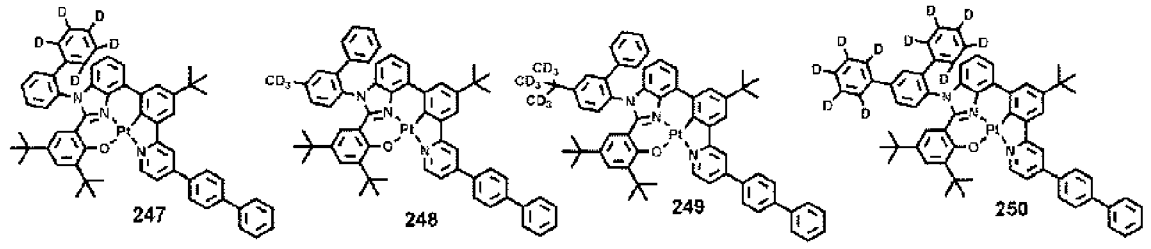

247 248 249 250

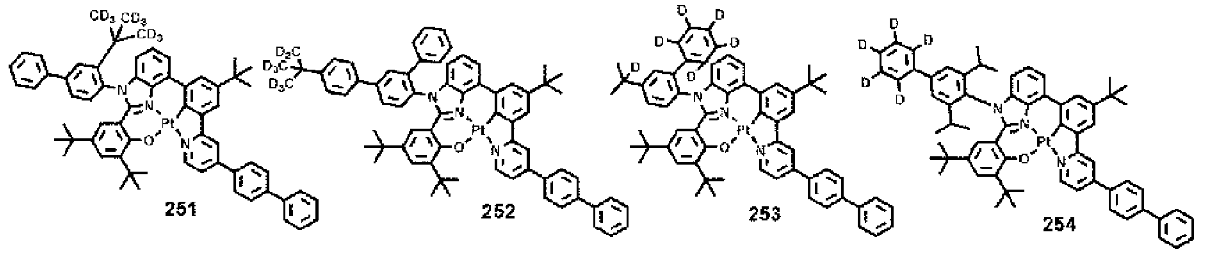

251 252 253 254

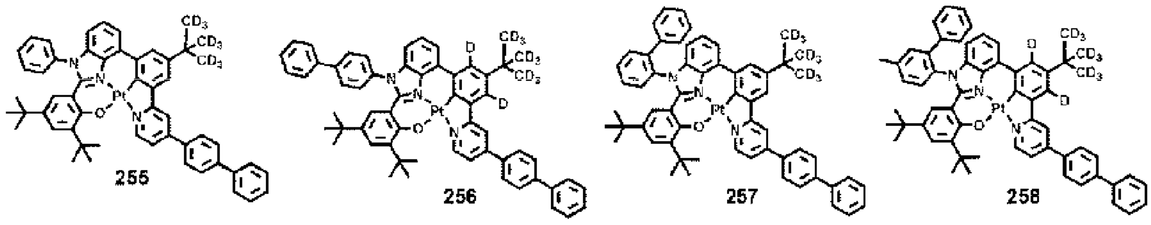

255 256 257 258

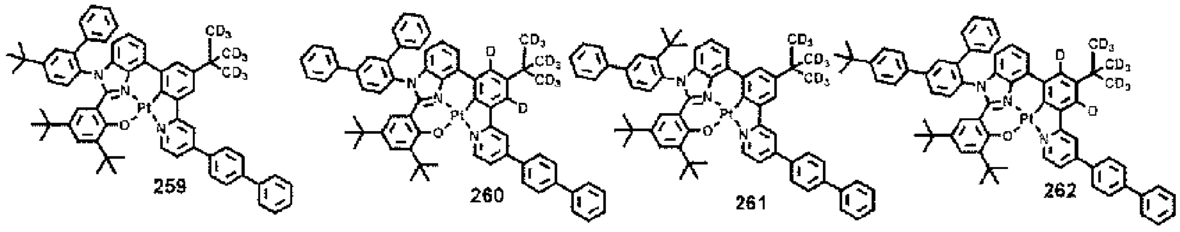

259 260 261 262

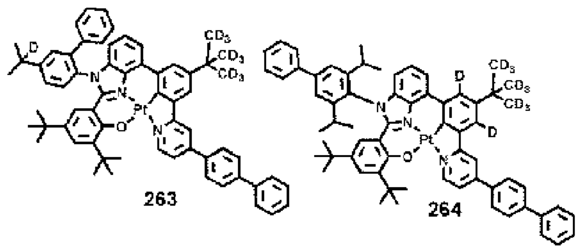

263 264

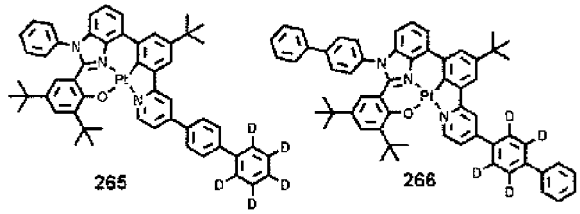

265 266

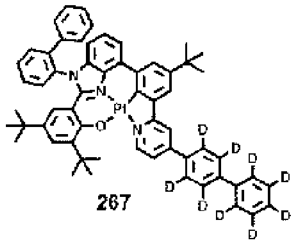

267

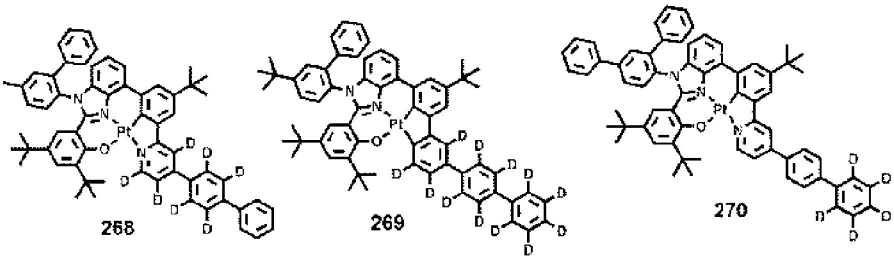

268 269 270

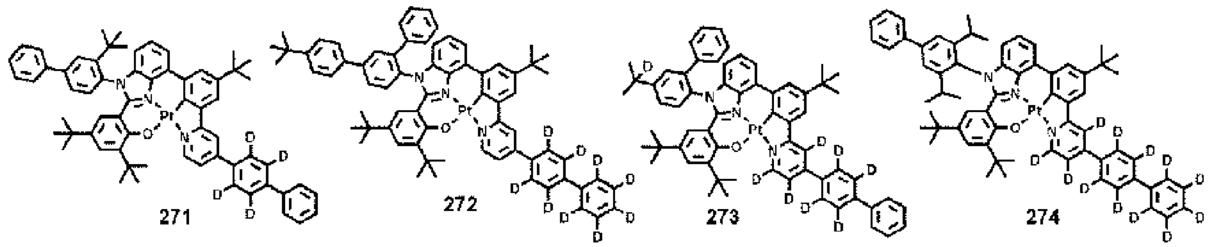

271 272 273 274

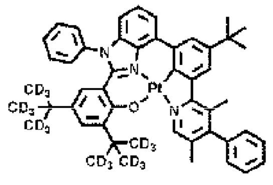

275

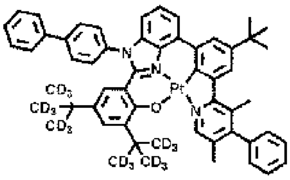

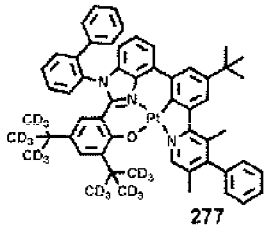

277

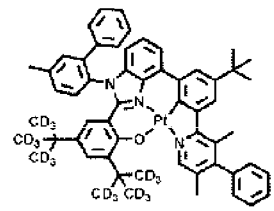

278

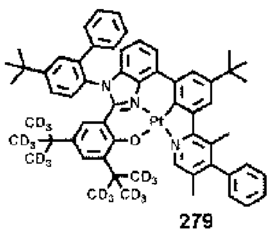

279

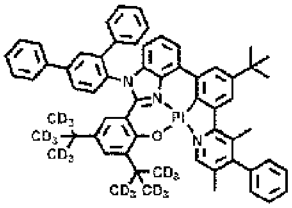

280

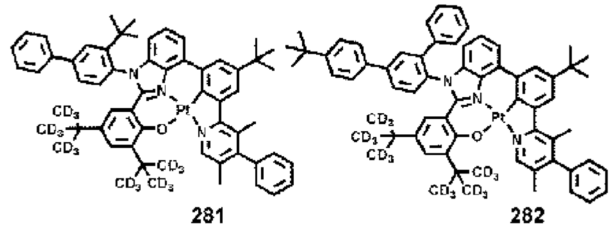

281 282

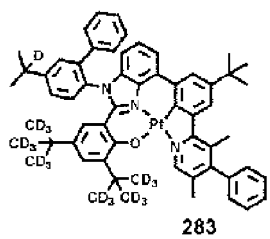

283

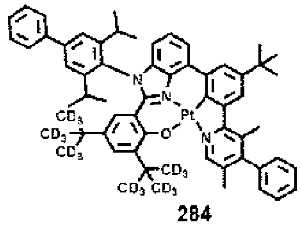

284

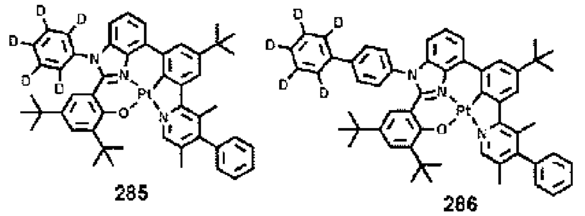

285 286

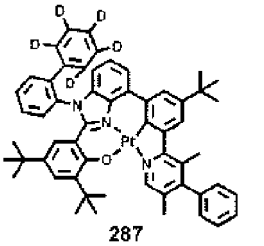
287

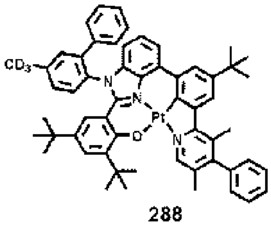
288

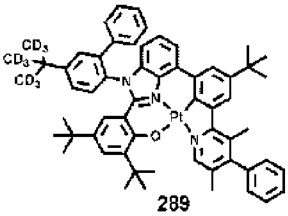
289

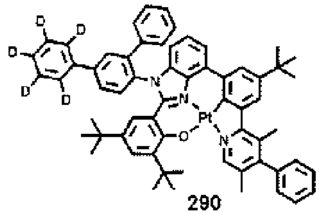
290

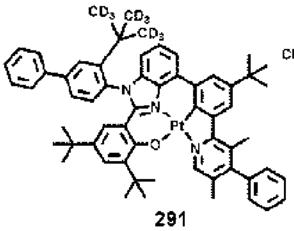
291

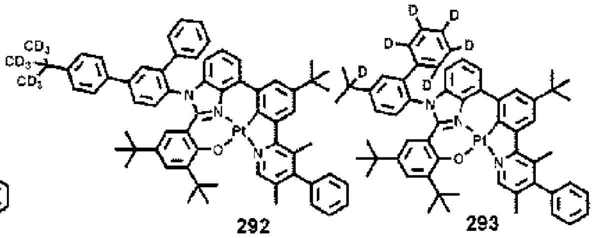
292

293

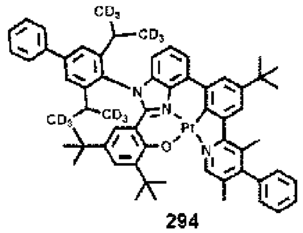
294

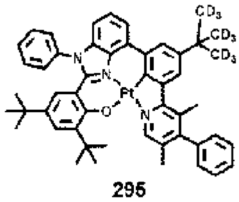
295

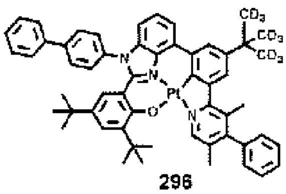
296

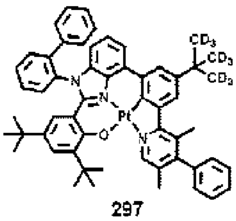
297

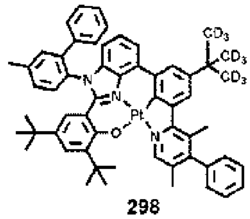
298

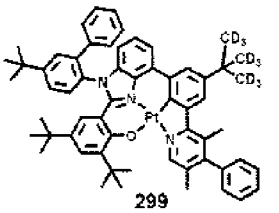
299

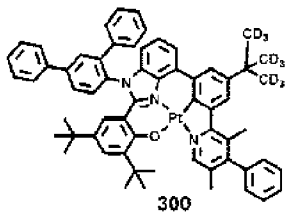
300

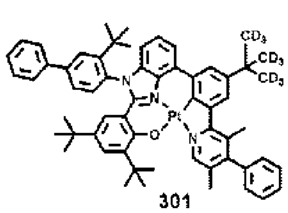
301

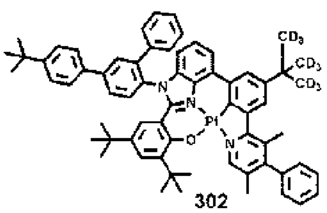
302

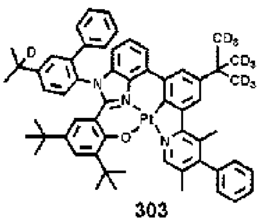
303

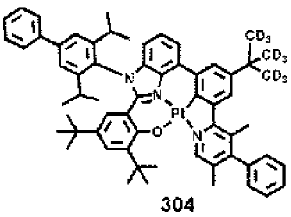
304

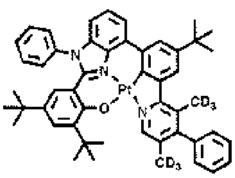
305

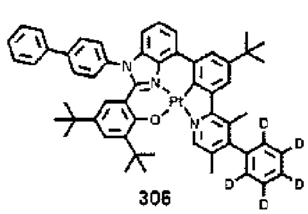
306

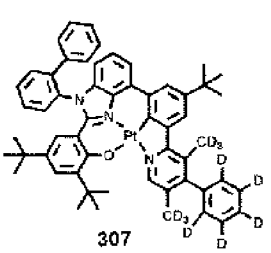
307

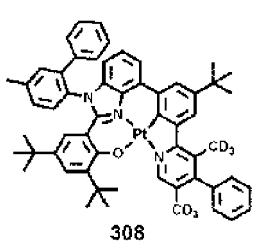
308

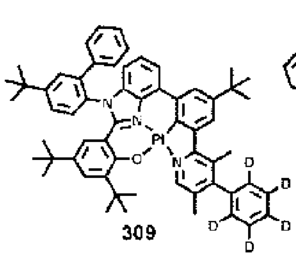
309

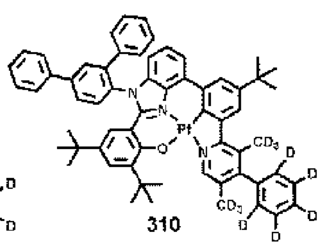
310

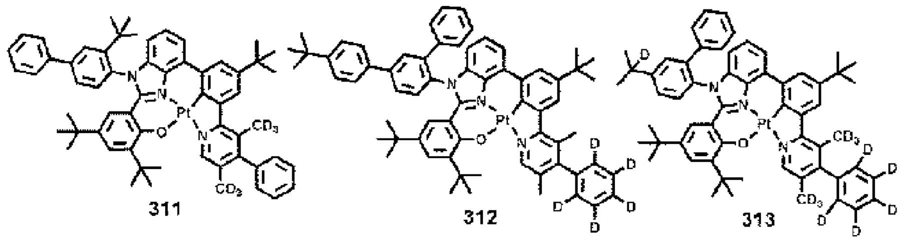

311 312 313

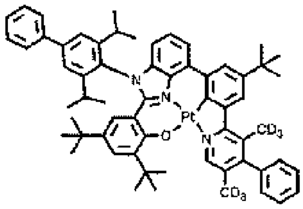

314

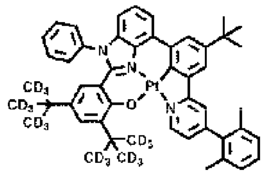

315

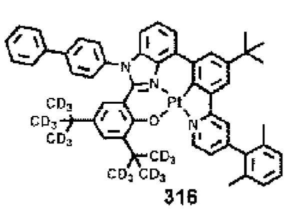

316

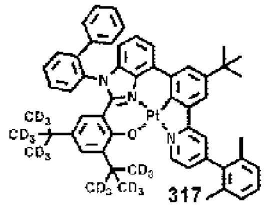

317

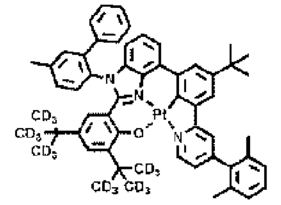

318

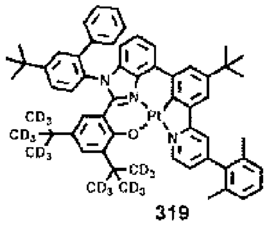

319

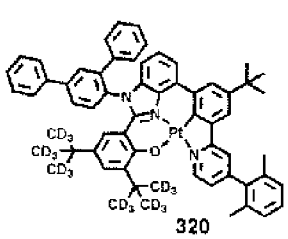

320

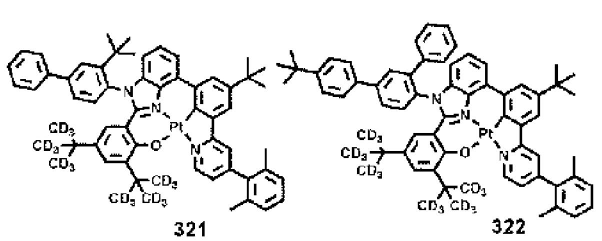

321 322

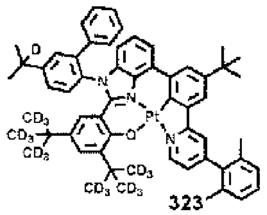

323

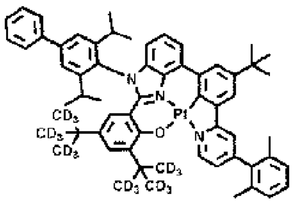

324

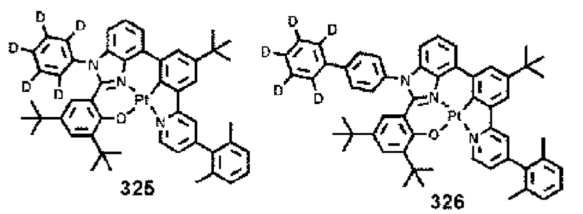

325 326

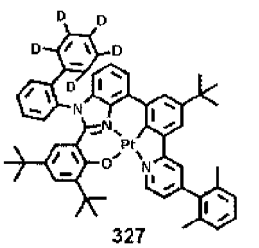

327

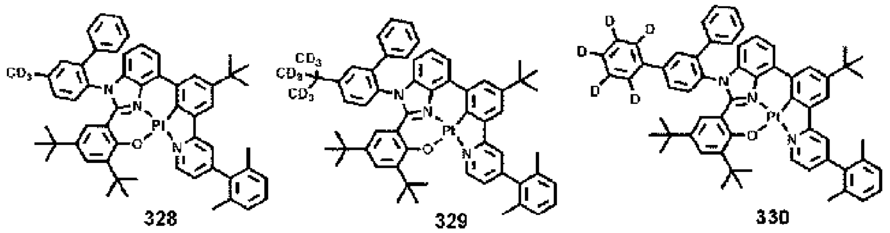

328 329 330

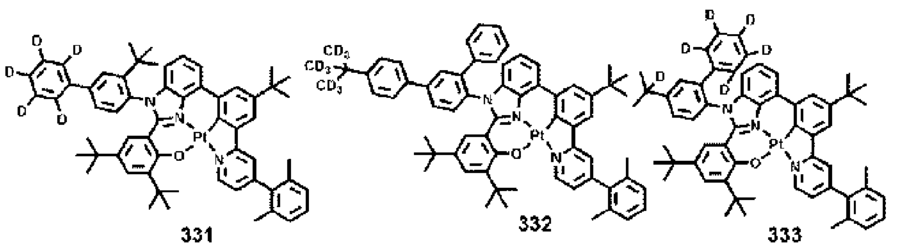

331 332 333

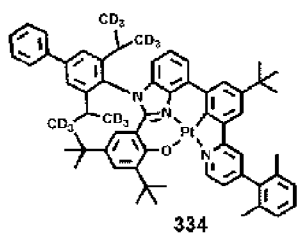

334

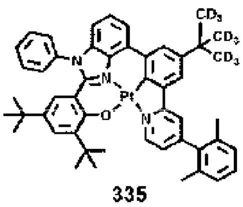
335

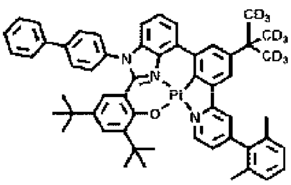
336

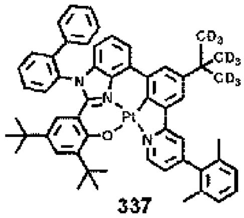
337

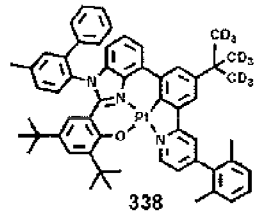
338

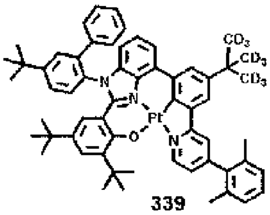
339

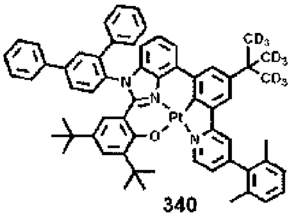
340

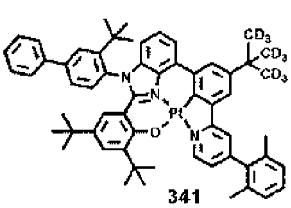
341

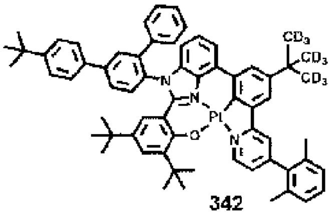
342

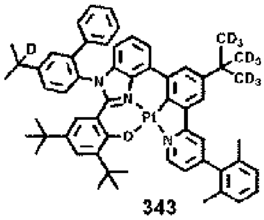
343

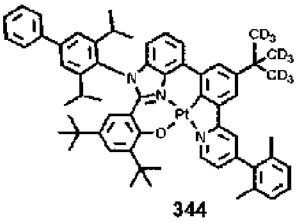
344

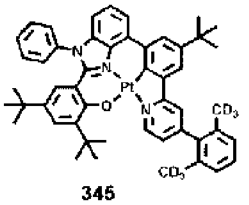
345

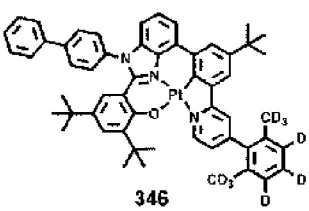
346

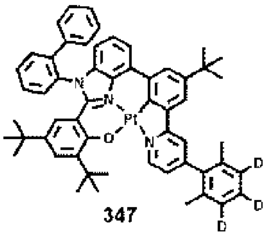
347

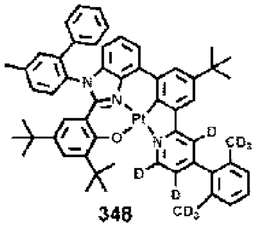
348

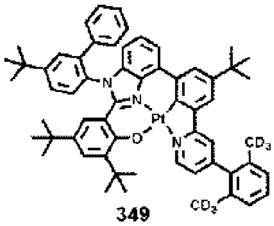
349

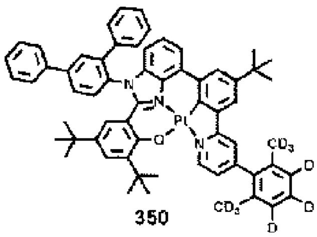
350

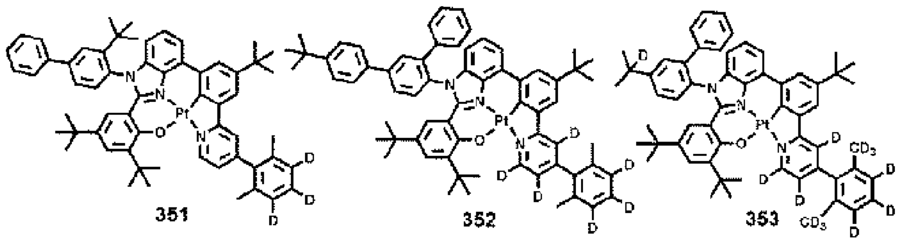
351

352

353

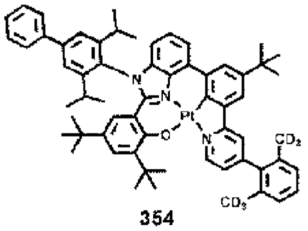
354

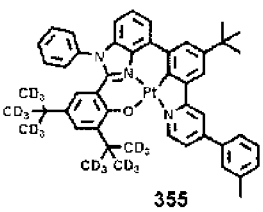
355

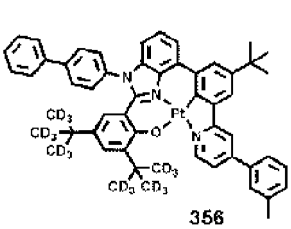
356

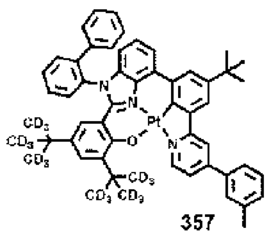
357

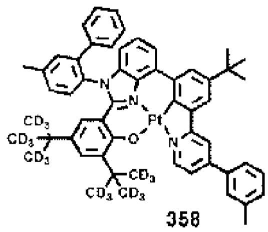
358

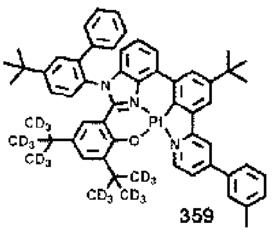
359

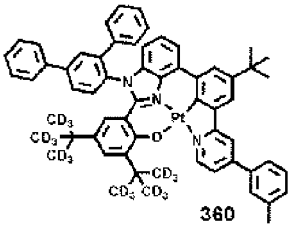
360

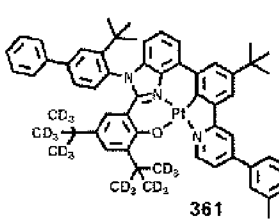
361

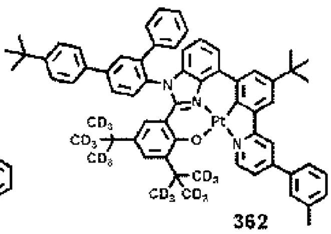
362

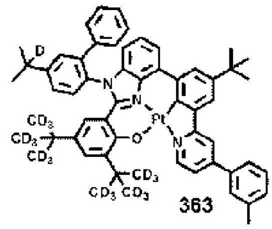
363

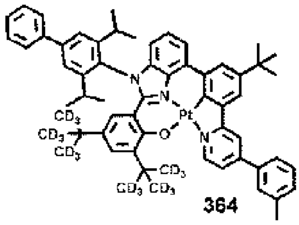
364

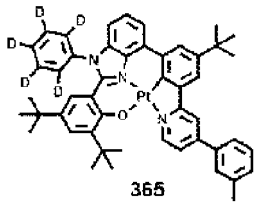
365

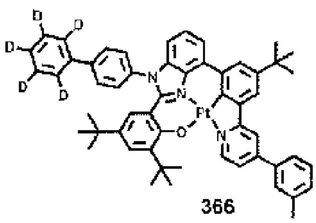
366

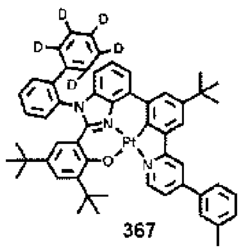
367

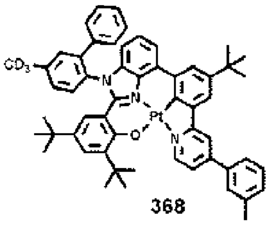
368

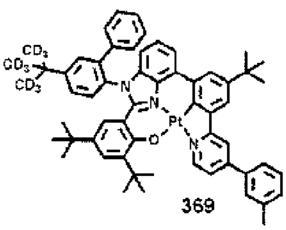
369

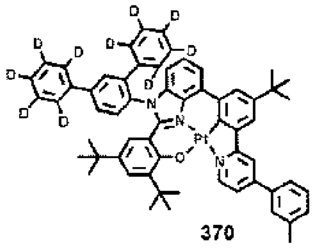
370

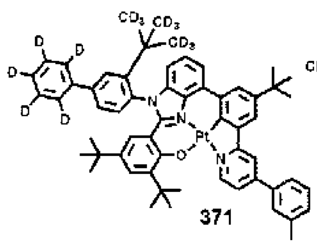
371

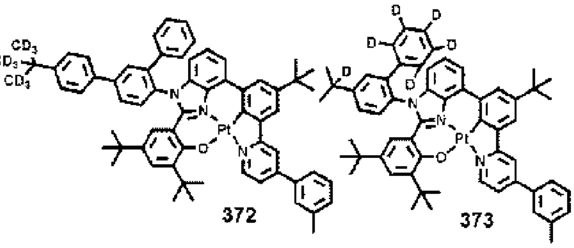
372

373

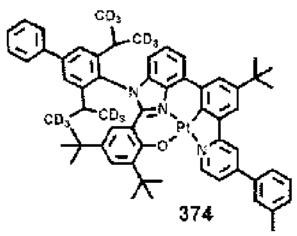
374

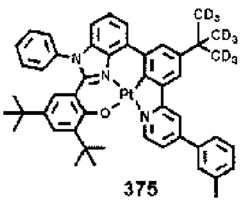
375

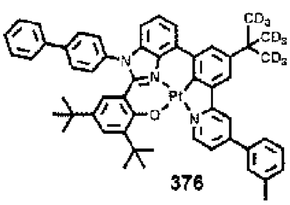
376

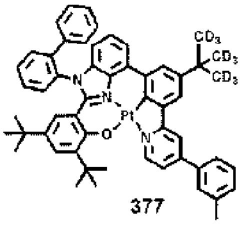
377

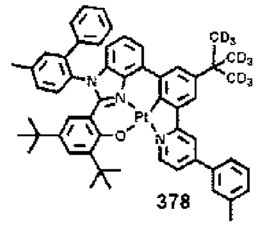
378

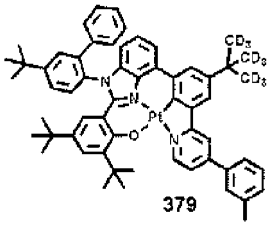
379

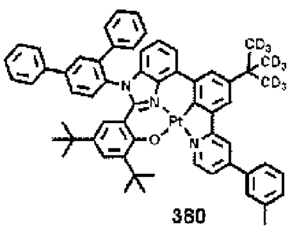
380

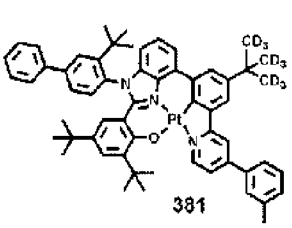
381

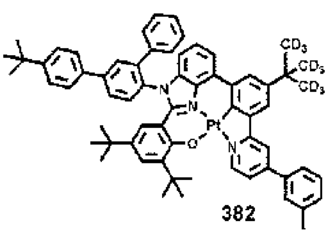
382

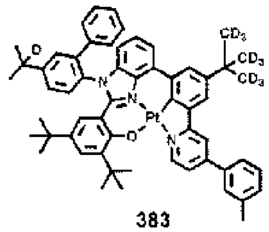
383

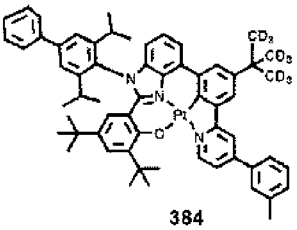
384

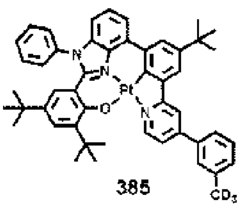
385

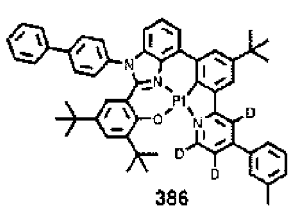
386

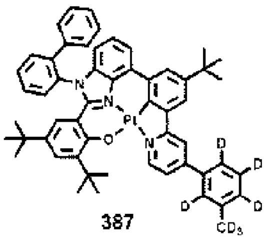
387

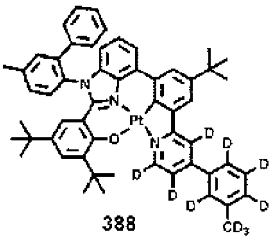
388

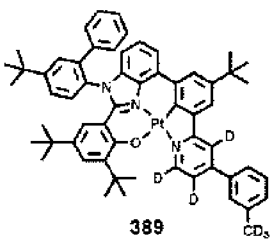
389

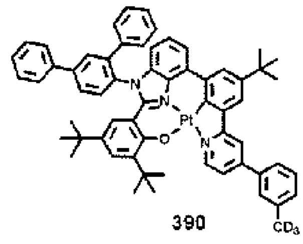
390

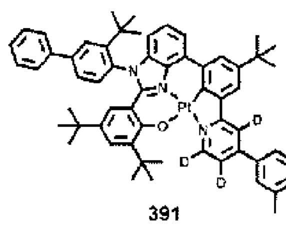
391

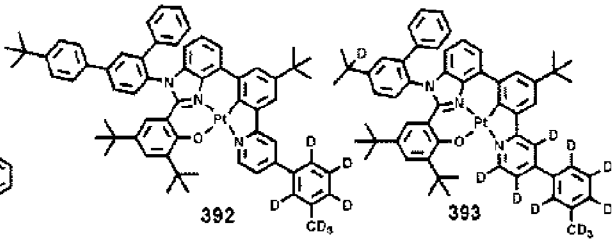
392

393

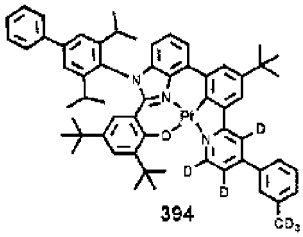
394

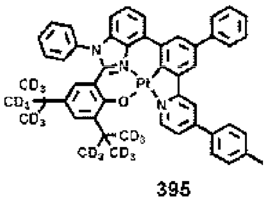
395

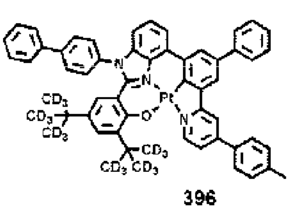
396

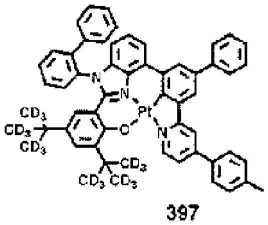
397

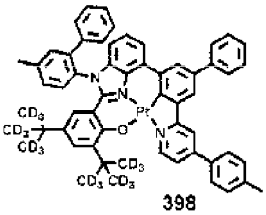
398

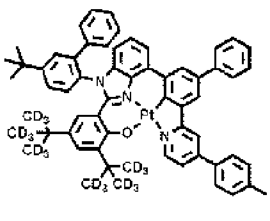

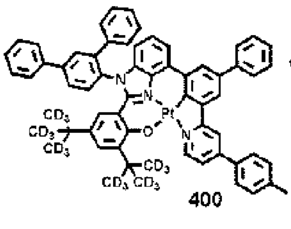
400

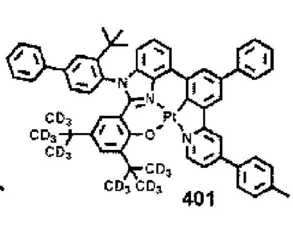
401

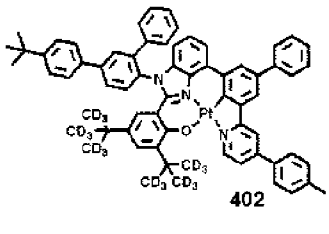
402

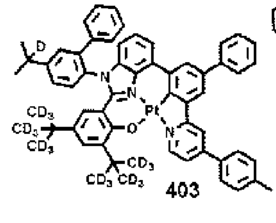
403

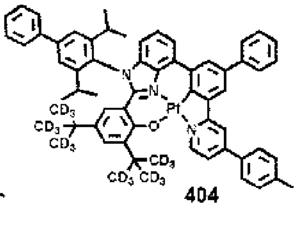
404

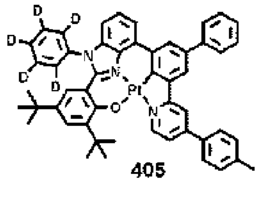
405

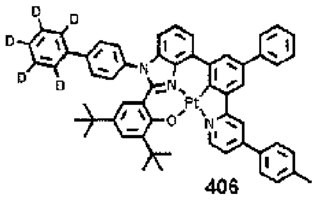
406

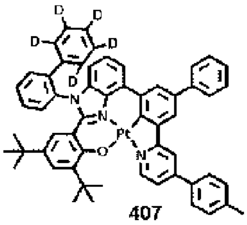
407
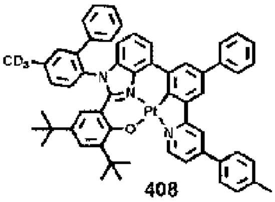
408
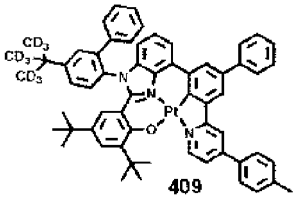
409
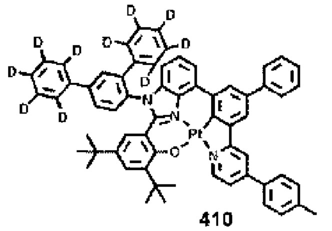
410
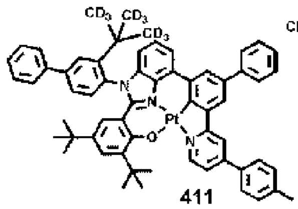
411
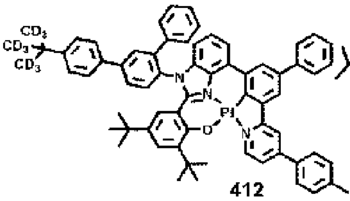
412
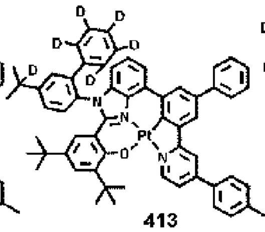
413
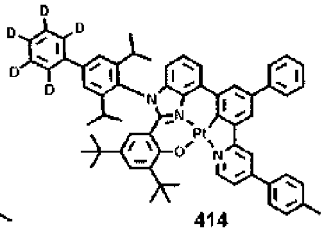
414
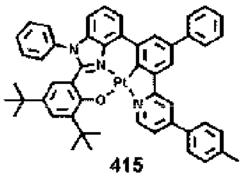
415
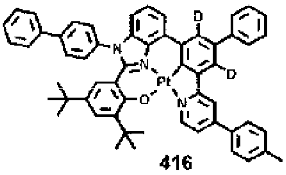
416
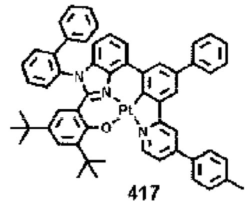
417
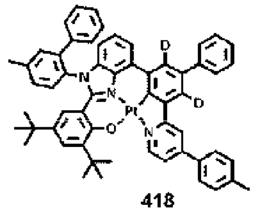
418
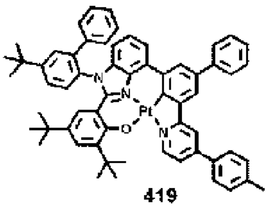
419
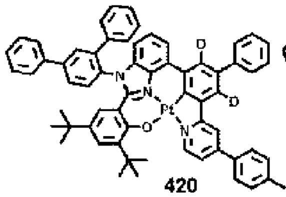
420
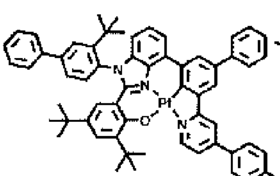
421
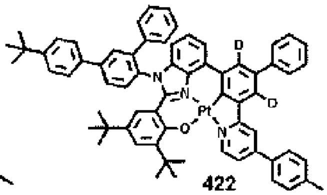
422
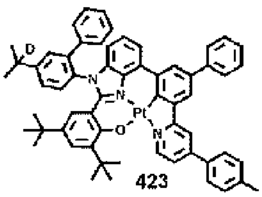
423
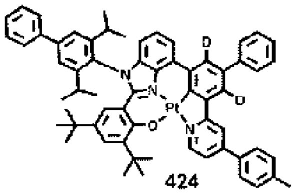
424
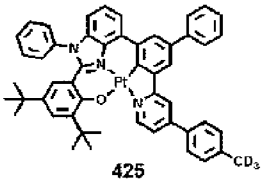
425
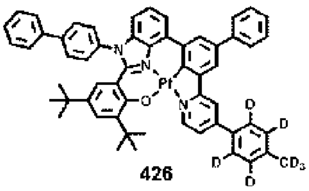
426
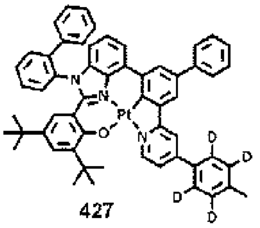
427
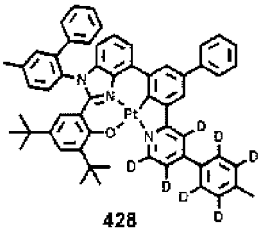
428
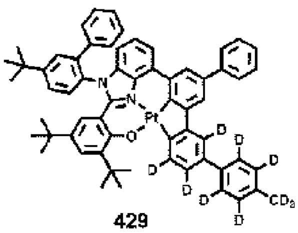
429
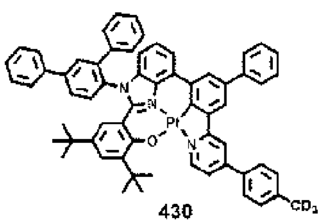
430

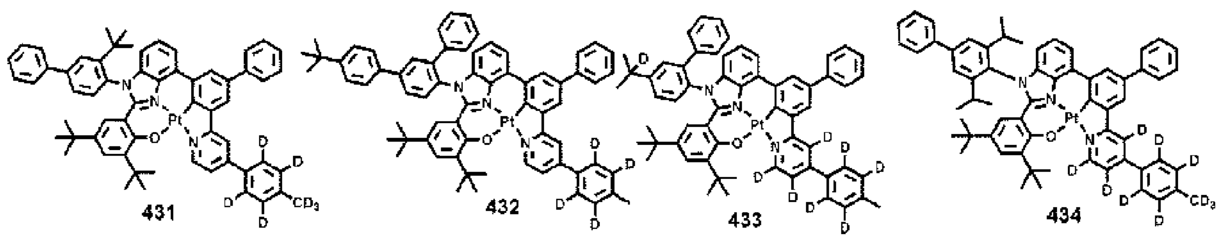

431 432 433 434

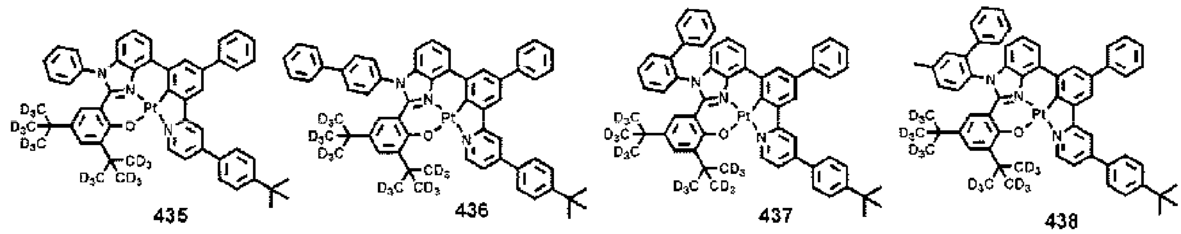

435 436 437 438

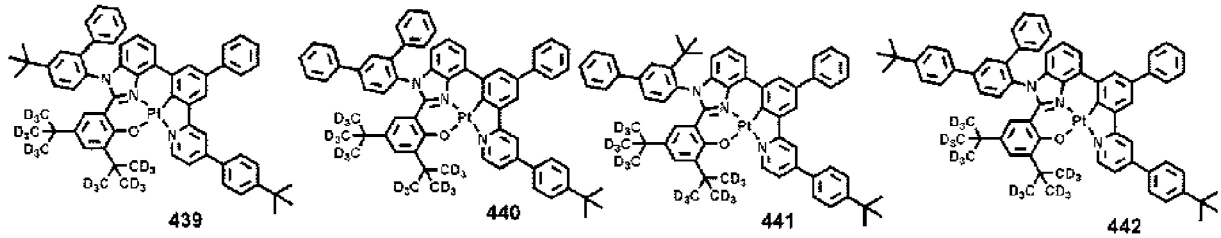

439 440 441 442

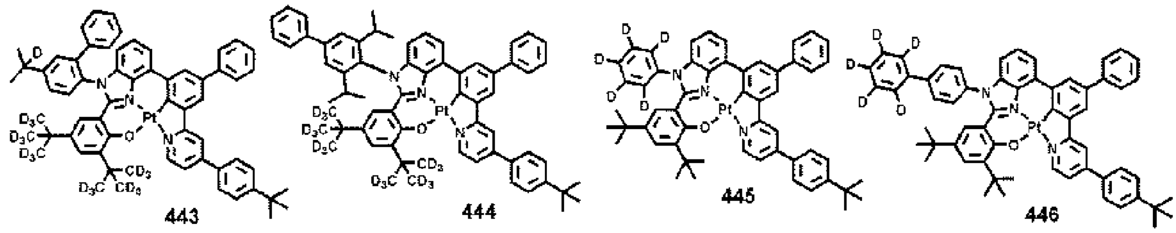

443 444 445 446

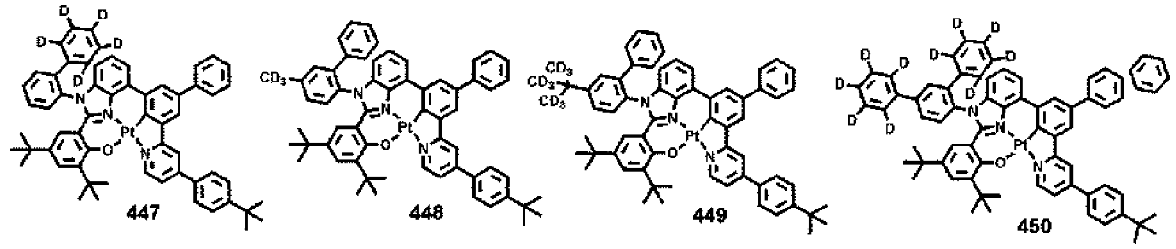

447 448 449 450

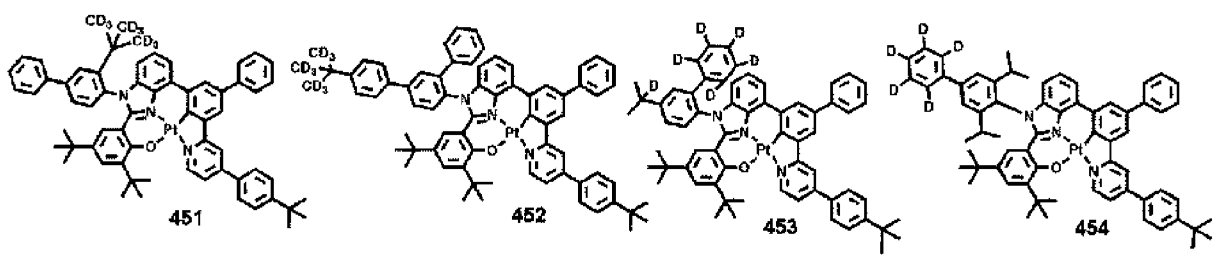

451 452 453 454

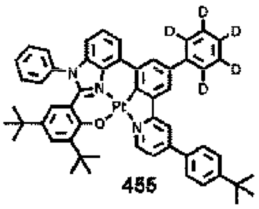
455
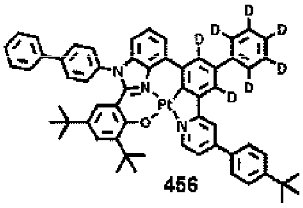
456
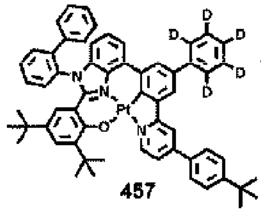
457
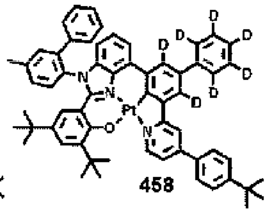
458

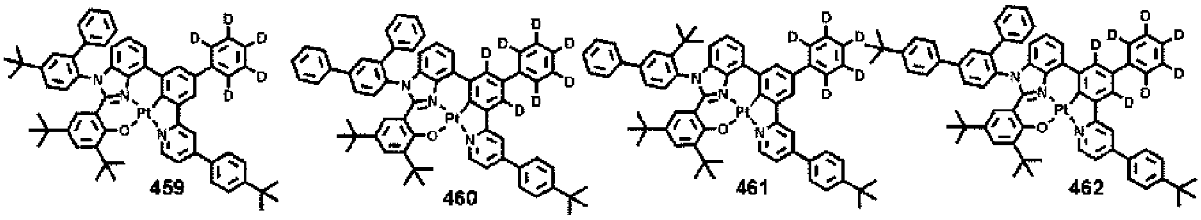
459
460
461
462

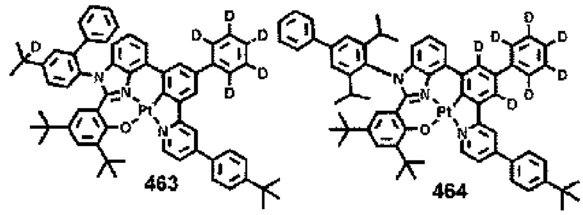
463
464
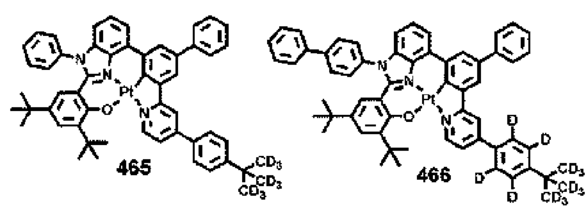
465
466

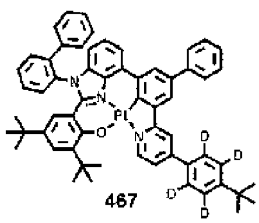
467
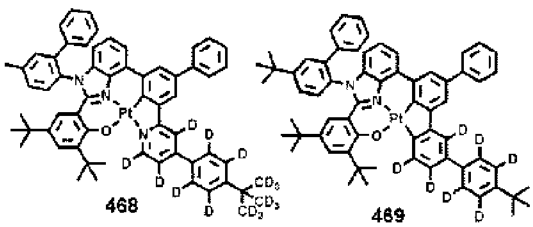
468
469
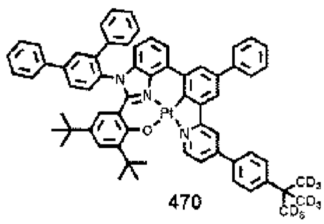
470

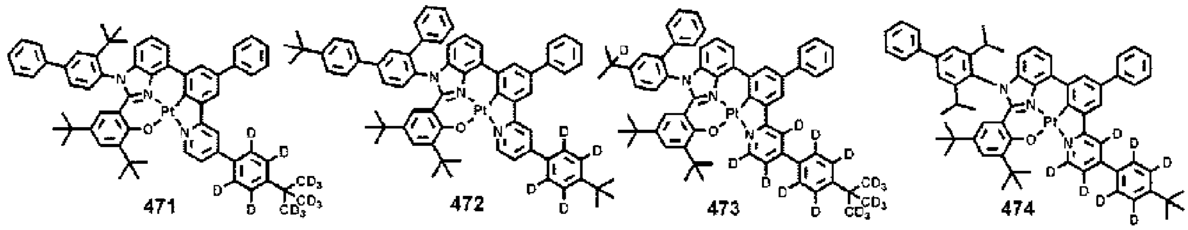
471
472
473
474

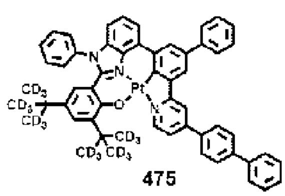
475
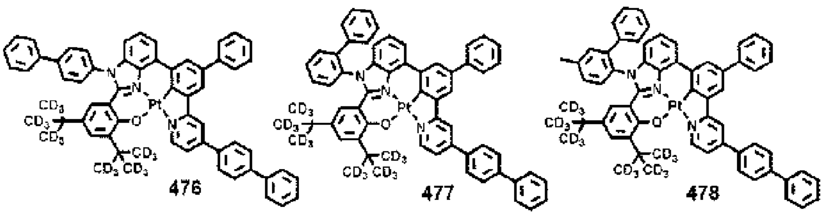
476
477
478

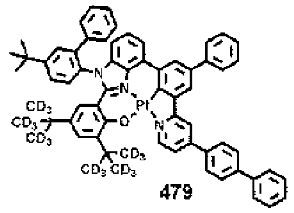

479

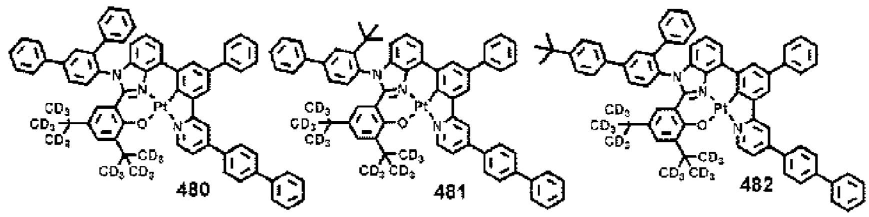

480 481 482

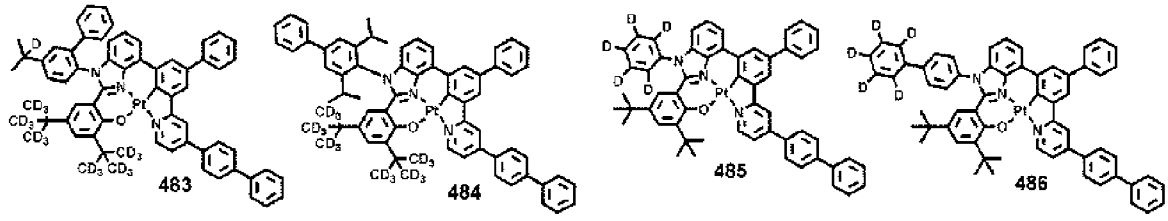

483 484 485 486

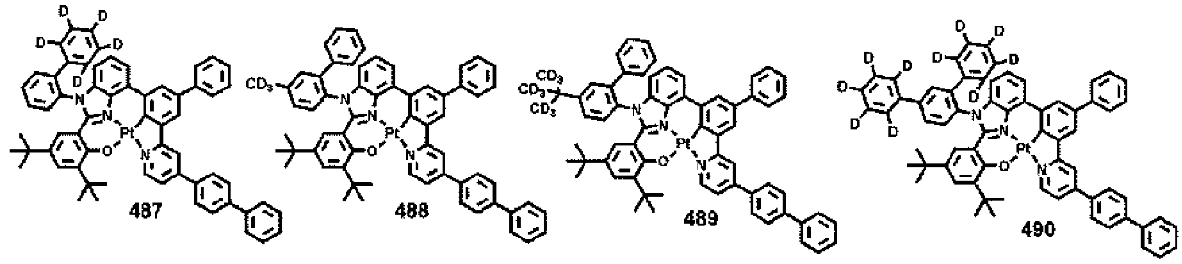

487 488 489 490

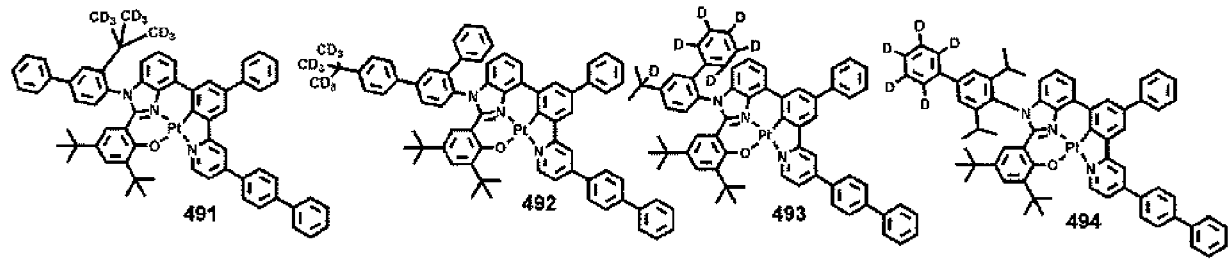

491 492 493 494

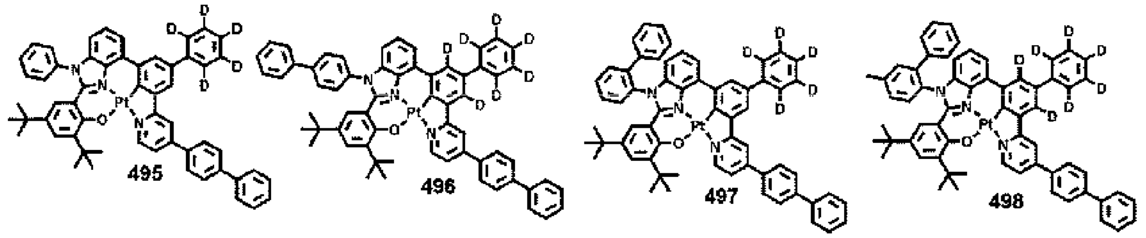

495 496 497 498

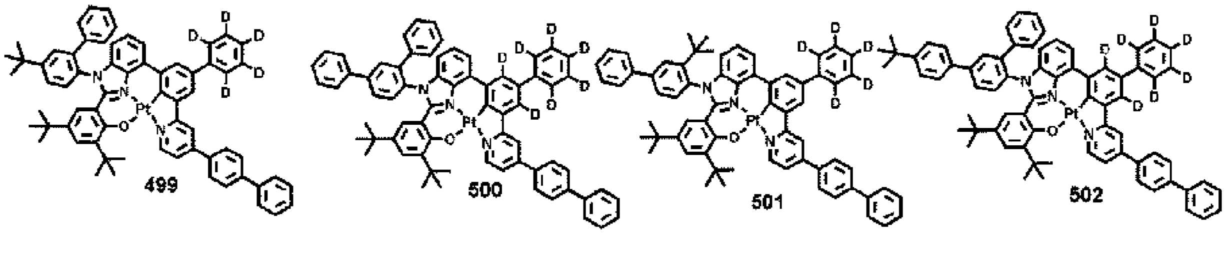

499 500 501 502

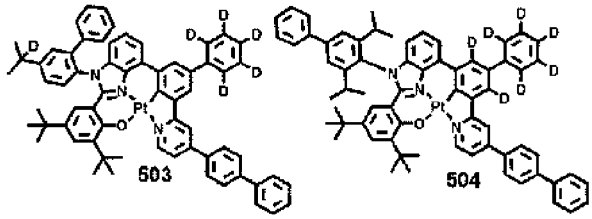

503 504

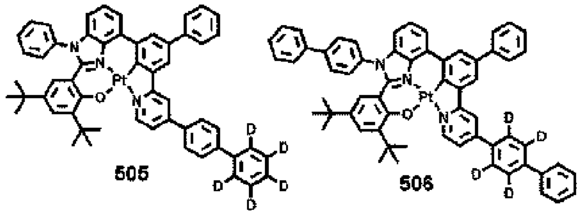

505 506

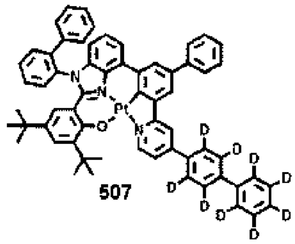

507

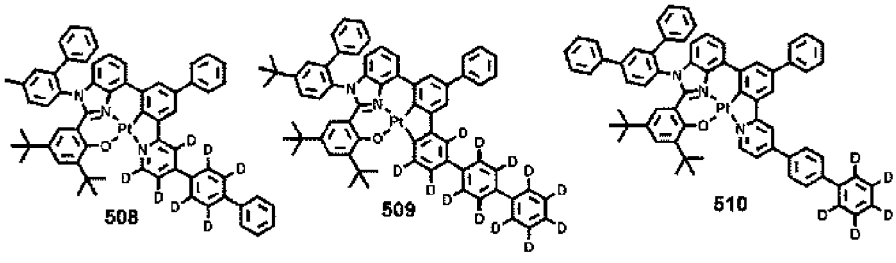

508 509 510

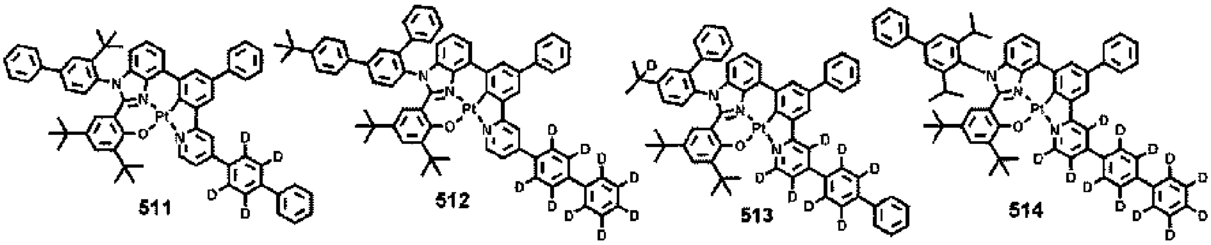

511 512 513 514

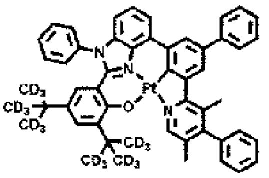

515

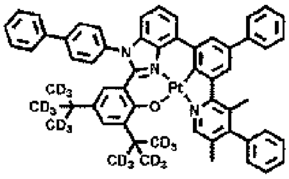

516

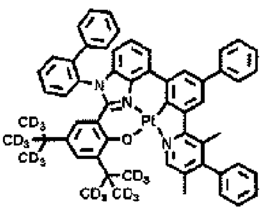

517

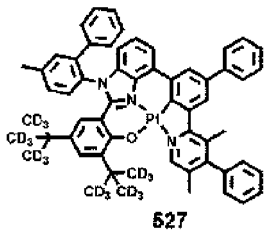

527

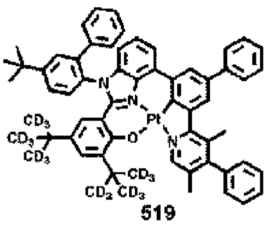

519

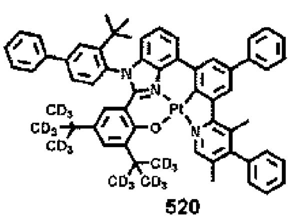

520

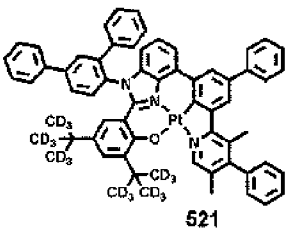

521

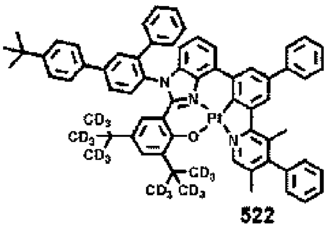

522

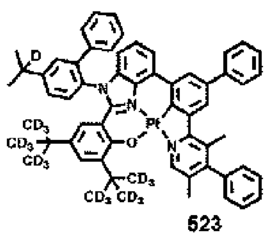

523

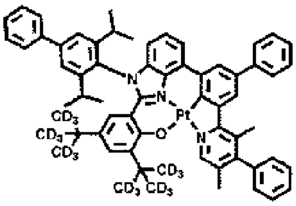

524

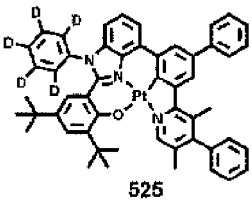

525

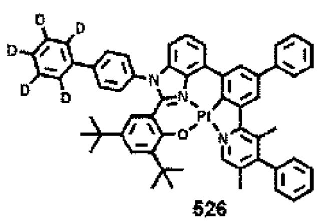

526

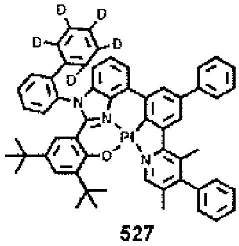
527
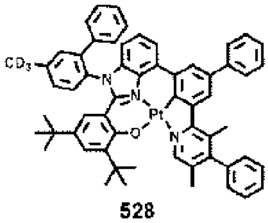
528
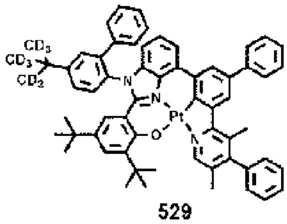
529
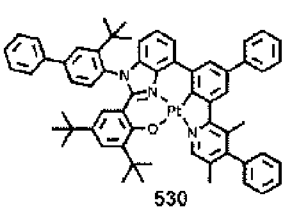
530

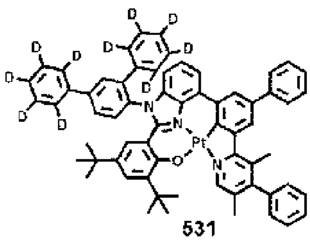
531
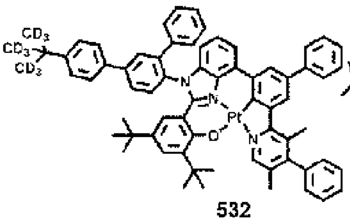
532
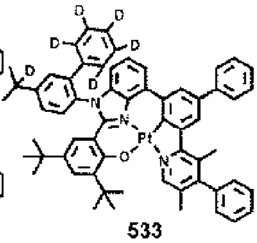
533
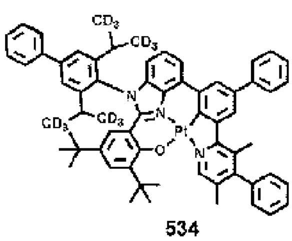
534

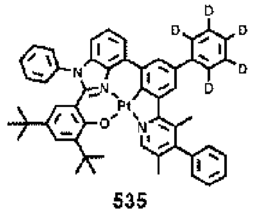
535
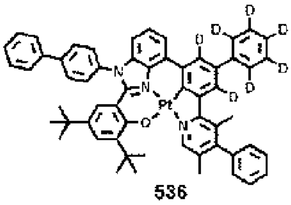
536
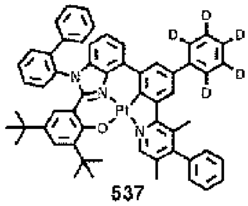
537
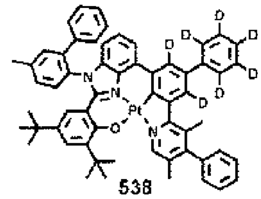
538

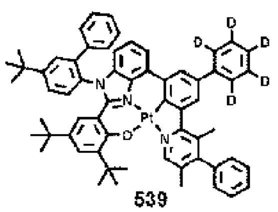
539
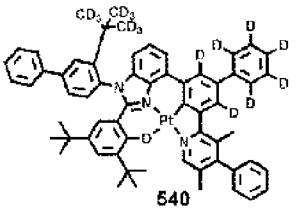
540
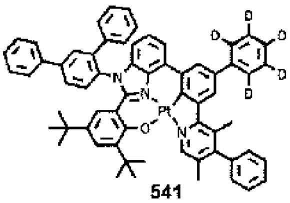
541
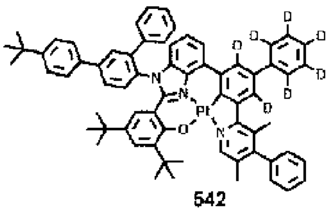
542

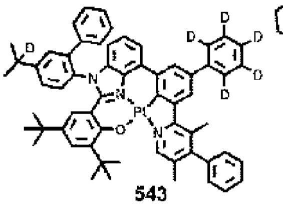
543
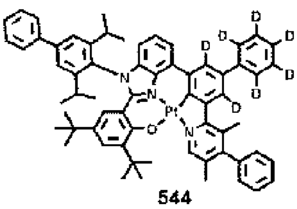
544
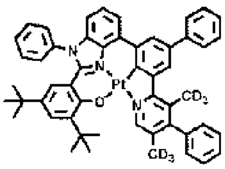
545
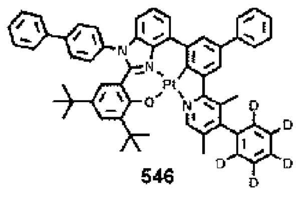
546

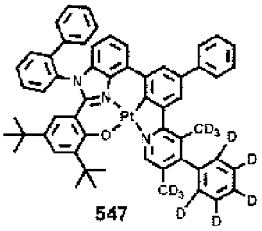
547
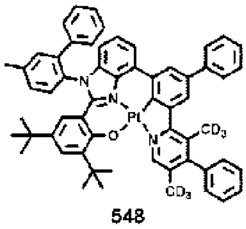
548
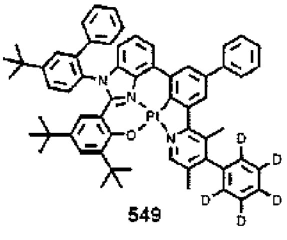
549
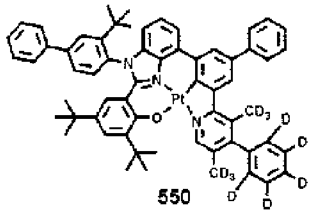
550

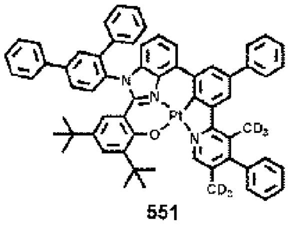
551
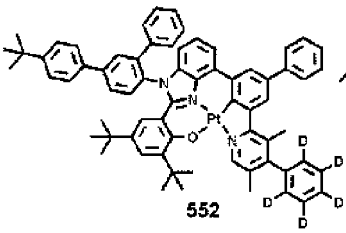
552
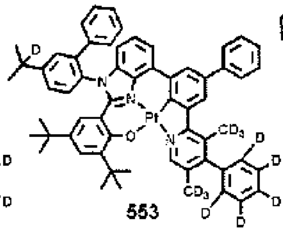
553
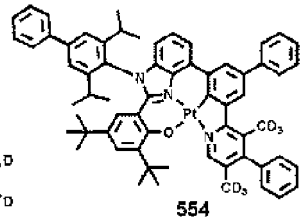
554
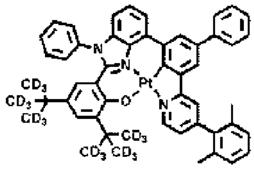
555
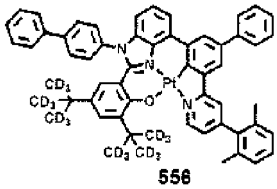
556
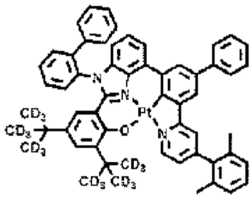
557
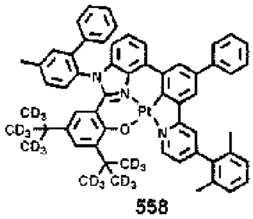
558
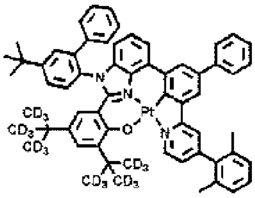
559
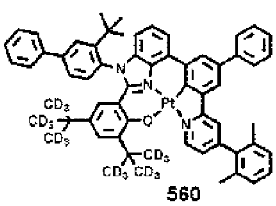
560
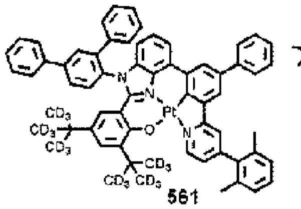
561
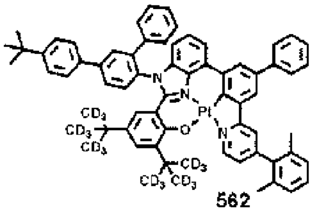
562
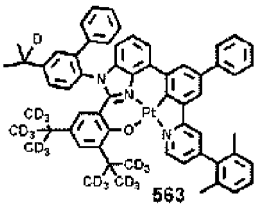
563
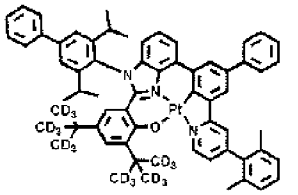
564
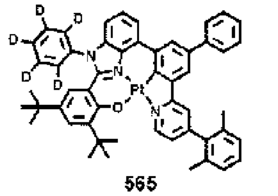
565
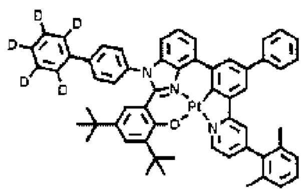
566
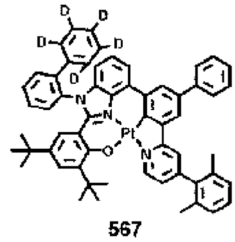
567
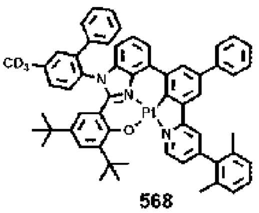
568
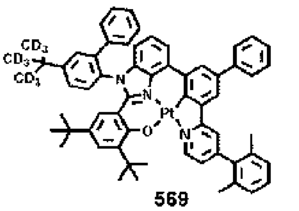
569
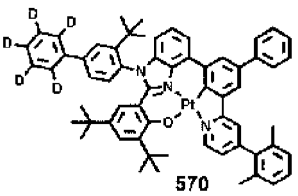
570
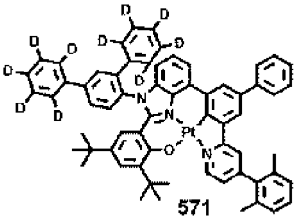
571
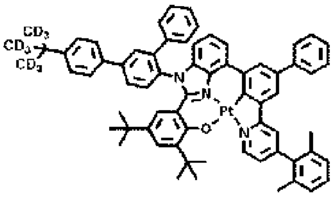
572
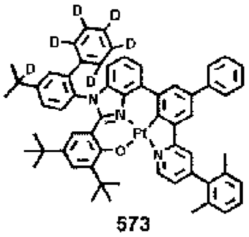
573
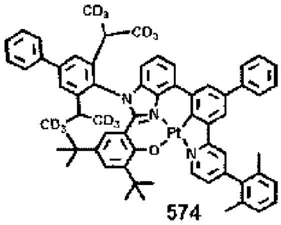
574

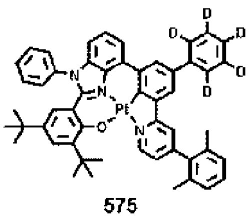
575

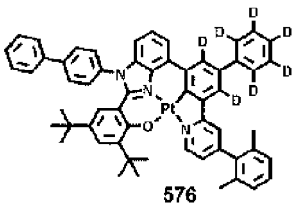
576

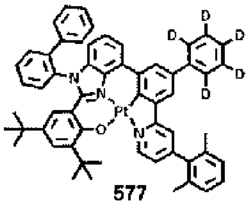
577

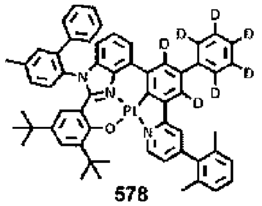
578

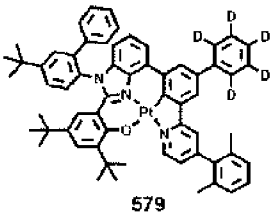
579

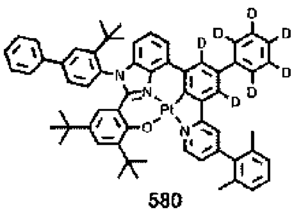
580

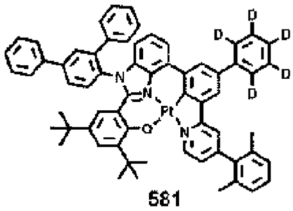
581

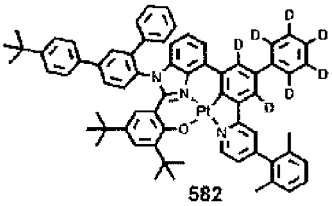
582

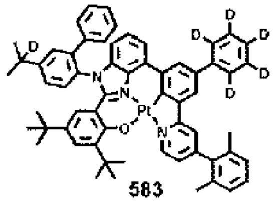
583

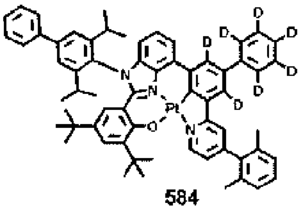
584

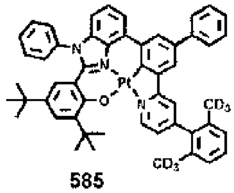
585

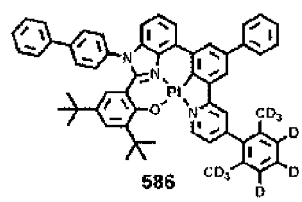
586

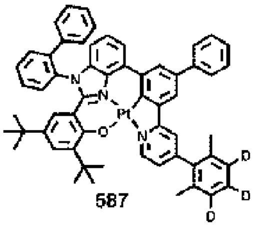
587

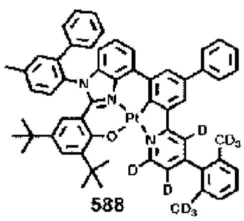
588

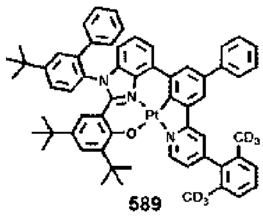
589

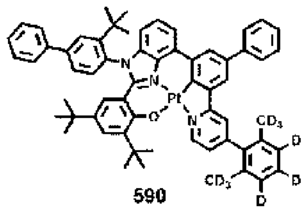
590

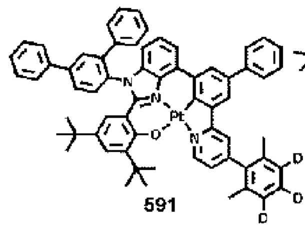
591

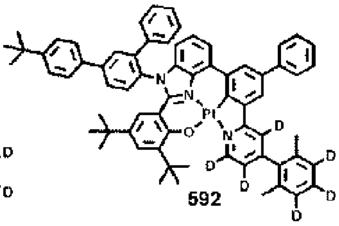
592

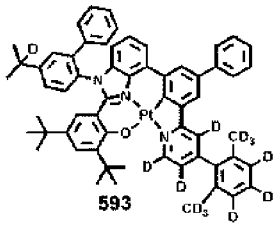
593

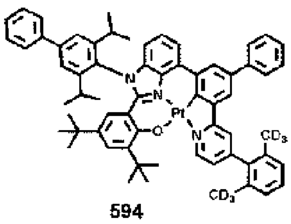
594

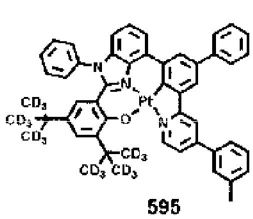
595

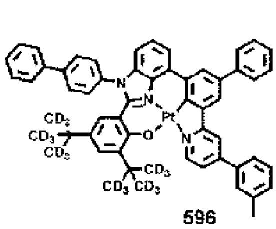
596

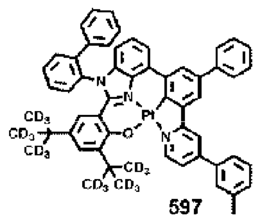
597

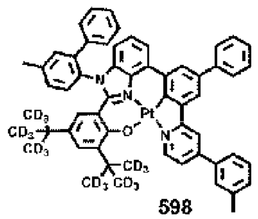
598

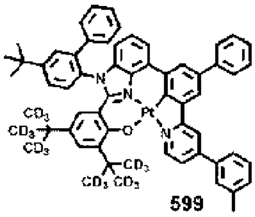
599

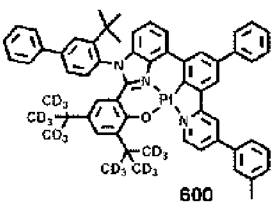
600

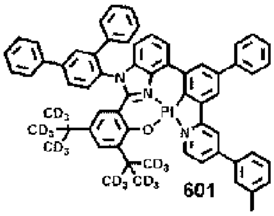
601

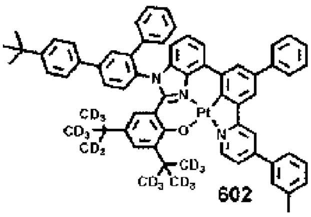
602

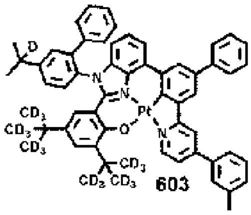
603

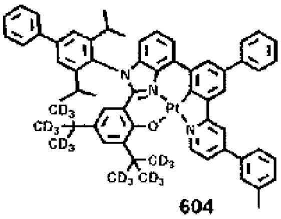
604

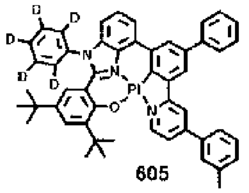
605

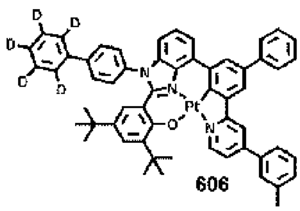
606

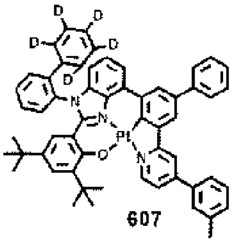
607

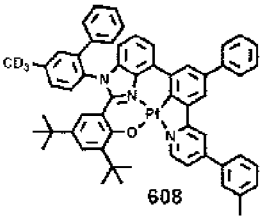
608

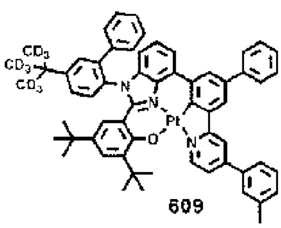
609

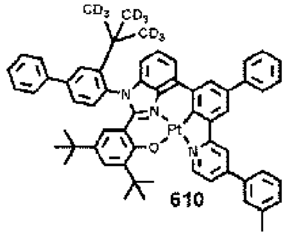
610

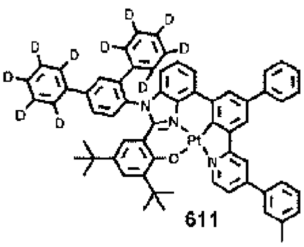
611

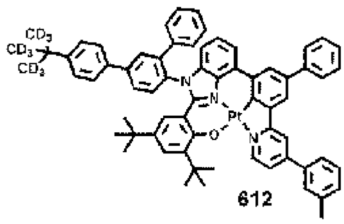
612

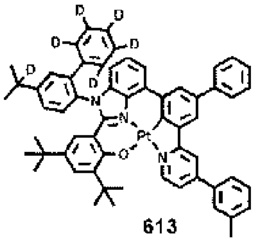
613

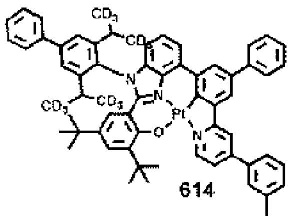
614

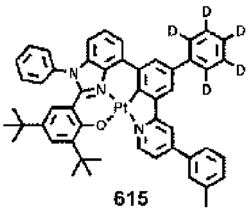
615

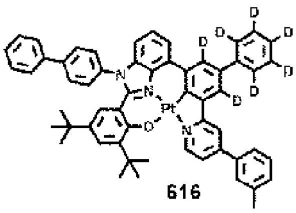
616

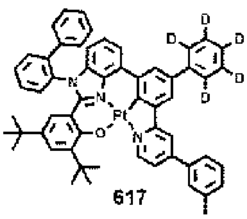
617

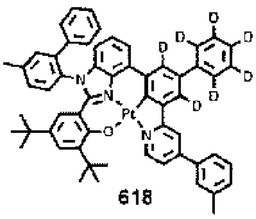
618

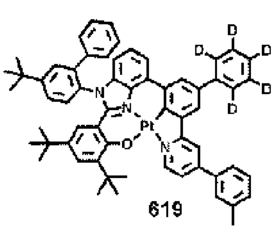
619

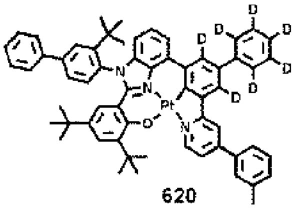
620

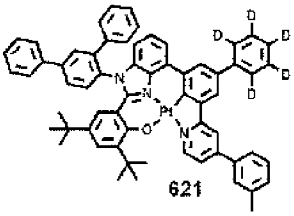
621

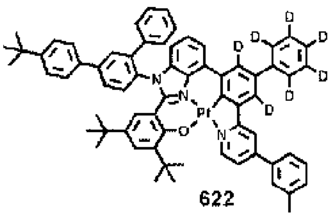
622

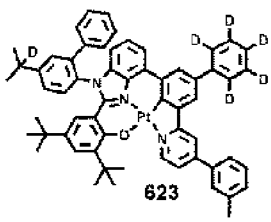
623
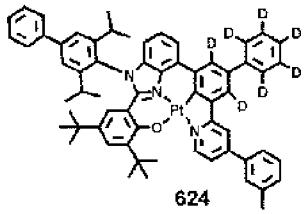
624
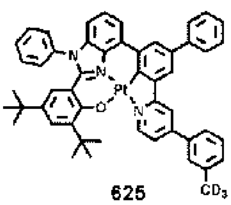
625
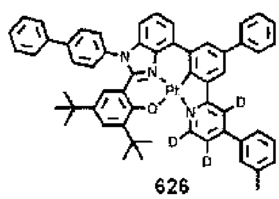
626

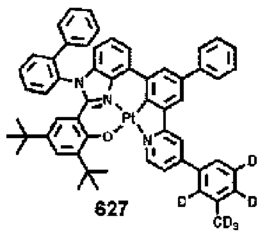
627
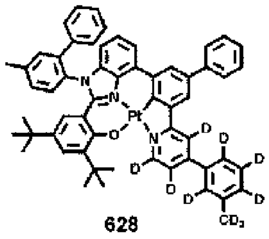
628
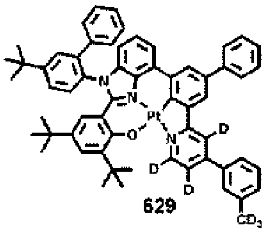
629
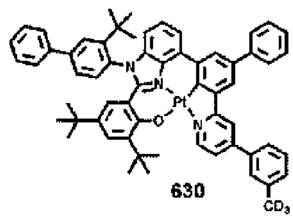
630

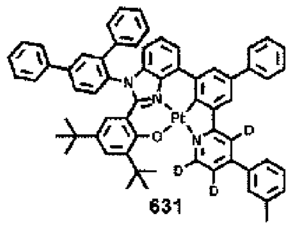
631
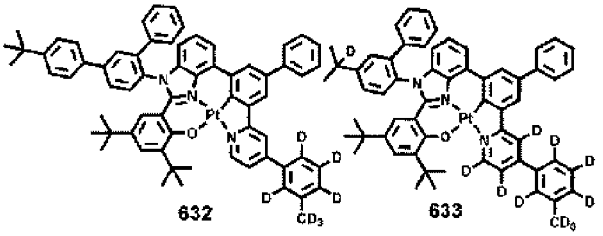
632
633
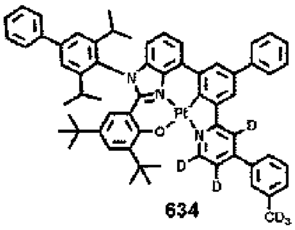
634

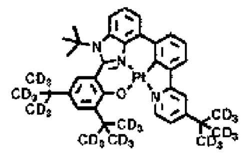
635
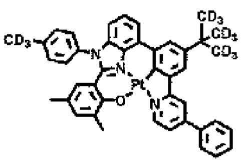
636
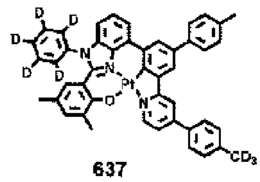
637
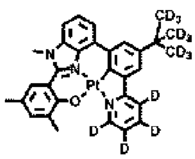
638

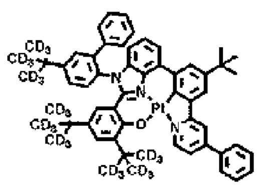
639
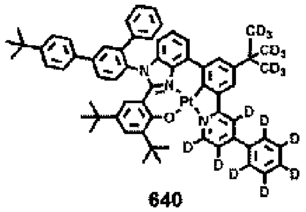
640
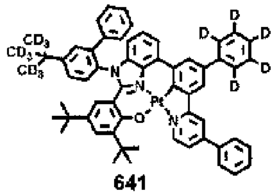
641
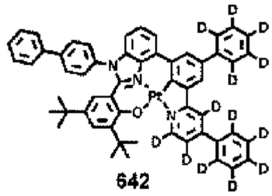
642

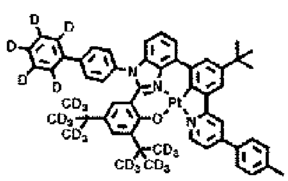
643
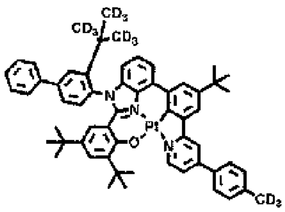
644
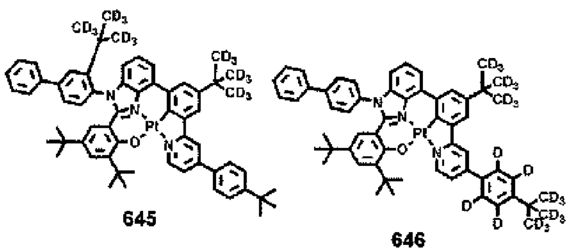
645
646

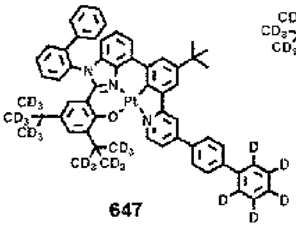
647

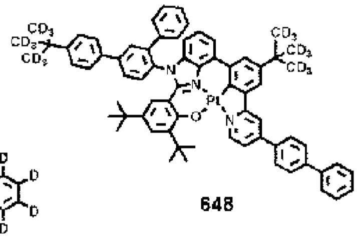
648

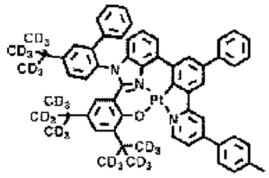
649

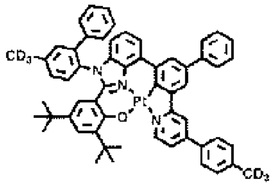
650

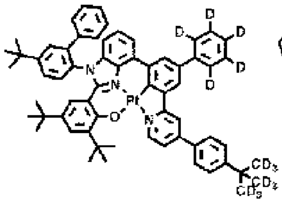
651

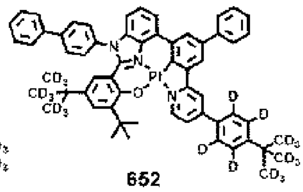
652

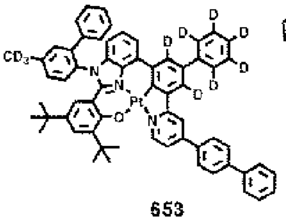
653

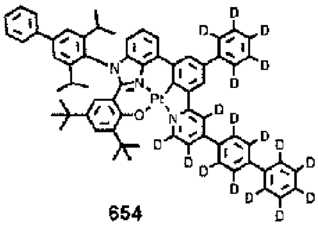
654

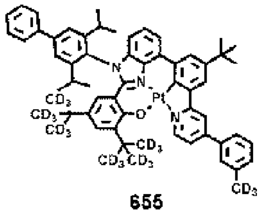
655

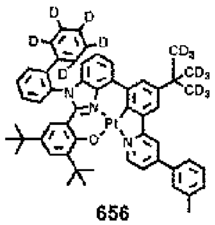
656

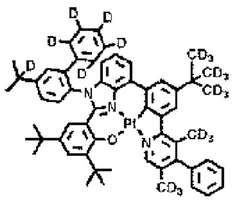
657

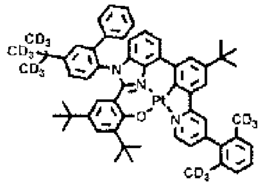
658

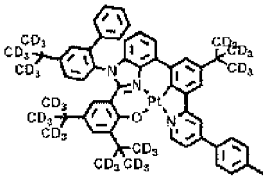
659

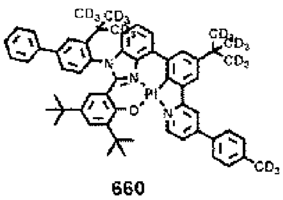
660

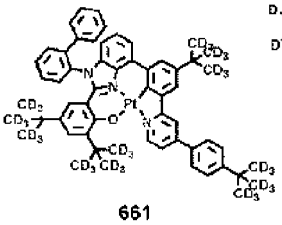
661

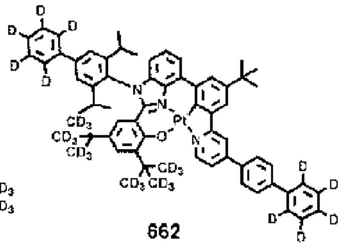
662

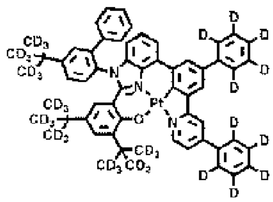
663

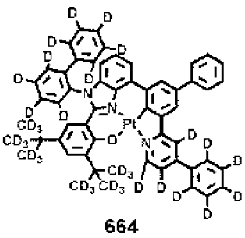
664

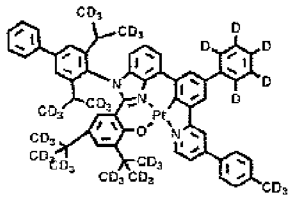
665

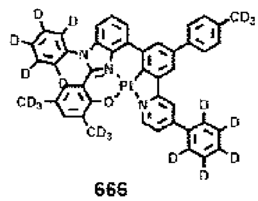
666

**13.** Organische lichtemittierende Vorrichtung, umfassend:

eine erste Elektrode;
eine zweite Elektrode; und
eine zwischen der ersten Elektrode und der zweiten Elektrode angeordnete organische Schicht, wobei die organische Schicht eine Emissionsschicht und mindestens eine Organometallverbindung nach einem der Ansprüche 1-12 umfasst;
wobei vorzugsweise
die erste Elektrode eine Anode ist,
die zweite Elektrode eine Kathode ist,
die organische Schicht ferner einen Lochtransportbereich, der zwischen der ersten Elektrode und der Emissionsschicht angeordnet ist, und einen Elektronentransportbereich einschließt, der zwischen der Emissionsschicht und der zweiten Elektrode angeordnet ist,
der Lochtransportbereich eine Lochinjektionsschicht, eine Lochtransportschicht, eine Elektronenblockierschicht, eine Pufferschicht oder eine beliebige Kombination davon einschließt, und
der Elektronentransportbereich eine Lochblockierschicht, eine Elektronentransportschicht, eine Elektroneninjektionsschicht oder eine beliebige Kombination davon einschließt.

**14.** Organische lichtemittierende Vorrichtung nach Anspruch 13, wobei die Organometallverbindung in der Emissionsschicht eingeschlossen ist, wobei die Emissionsschicht vorzugsweise ferner einen Wirt einschließt und die Menge des Wirts größer ist als die Menge der Organometallverbindung.

**15.** Diagnostische Zusammensetzung, umfassend mindestens eine Organometallverbindung nach einem der Ansprüche 1-12.

## Revendications

**1.** Composé organométallique représenté par la formule 1 :

Formule 1

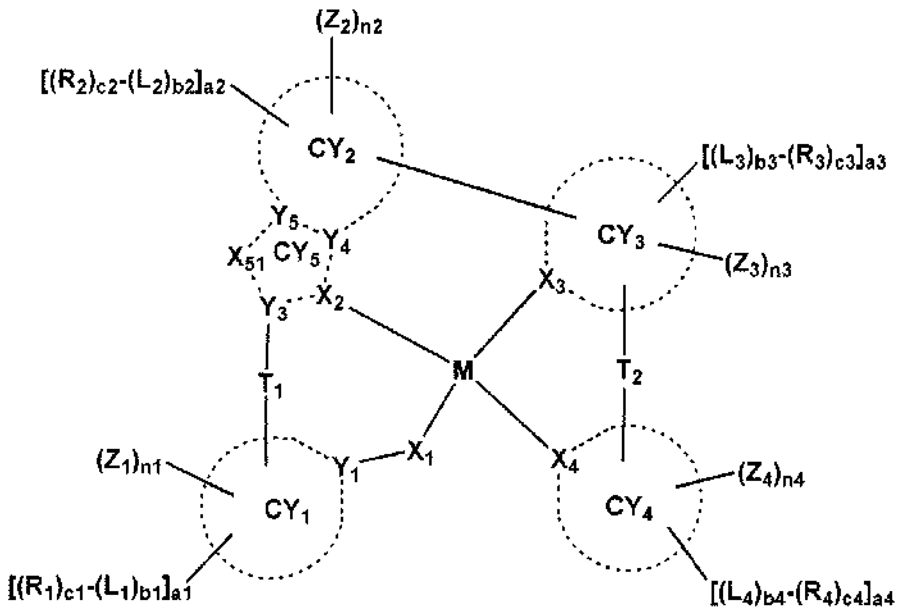

dans laquelle, dans la formule 1,

M représente un atome de béryllium (Be), magnésium (Mg), aluminium (Al), calcium (Ca), titane (Ti), manganèse (Mn), cobalt (Co), cuivre (Cu), zinc (Zn), gallium (Ga), germanium (Ge), zirconium (Zr), ruthénium (Ru), rhodium (Rh), palladium (Pd), argent (Ag), rhénium (Re), platine (Pt) ou or (Au),
$X_1$ représente une liaison chimique, un atome O, S, un groupe N(R'), P(R'), B(R'), C(R')(R") ou Si(R')(R"), et lorsque $X_1$ représente une liaison chimique, $Y_1$ est directement lié à M,
$X_2$ à $X_4$ représentent chacun indépendamment un atome N ou C, deux groupes sélectionnés parmi $X_2$ to $X_4$ représentant chacun un atome N et l'autre représentant un atome C,
une liaison entre $X_1$ ou $Y_1$ et M représente une liaison covalente, une liaison choisie parmi une liaison entre $X_2$ et M, une liaison entre $X_3$ et M et une liaison entre $X_4$ et M représente une liaison covalente et les deux liaisons restantes représentent des liaisons de coordination,
$Y_1$ et $Y_3$ à $Y_5$ représentent chacun indépendamment un atome C ou N,
parmi les paires de $X_2$ et $Y_3$, $X_2$ et $Y_4$, $Y_4$ et $Y_5$, $X_{51}$ et $Y_3$, et $X_{51}$ et $Y_5$, les composants dans chaque paire sont liés via une liaison chimique,
le noyau $CY_1$ au noyau $CY_5$ sont chacun indépendamment sélectionnés parmi un groupe carbocyclique en $C_5$ à $C_{30}$ et un groupe hétérocyclique en $C_1$ à $C_{30}$, et chacun du noyau $CY_1$, du noyau $CY_3$ et du noyau $CY_4$ ne

représente pas
un groupe benzimidazole,
un noyau cyclométalisé formé par le noyau $CY_5$, le noyau $CY_2$, le noyau $CY_3$ et M représente un cycle de 6 chaînons,
$X_{51}$ est sélectionné parmi un atome O, S, un groupe N-[$(L_7)_{b7}$-$(R_7)_{c7}$], C($R_7$)($R_8$), Si($R_7$)($R_8$), Ge($R_7$)($R_8$), C(=O), un atome N, un groupe C($R_7$), Si($R_7$) et Ge($R_7$),
$R_7$ et $R_8$ sont éventuellement liés via une simple liaison, une double liaison ou un premier groupe de liaison pour former un groupe carbocyclique en $C_5$ à $C_{30}$ non substitué ou substitué par au moins un groupe $R_{10a}$ ou un groupe hétérocyclique en $C_1$ à $C_{30}$ non substitué ou substitué par au moins un groupe $R_{10a}$,
$T_1$ et $T_2$ sont chacun indépendamment sélectionnés parmi une liaison simple, une double liaison, un groupe *-N($R_9$)-*', *-B($R_9$)-*', *-P($R_9$)-*', *-C($R_9$)($R_{10}$)-*', *-Si($R_9$)($R_{10}$)-*', *-Ge($R_9$)($R_{10}$)-*', *-S-*', *-Se-*', *-O-*',*-C(=O)-*', *-S(=O)-*', *-S(=O)$_2$-*', *-C($R_9$)=*', *=C($R_9$)-*', *-C($R_9$)=C($R_{10}$)-*', *-C(=S)- ou *-C=C-*',
$L_1$ à $L_4$ and $L_7$ sont chacun indépendamment sélectionnés parmi une liaison simple, un groupe carbocyclique en $C_5$ à $C_{30}$ substitué ou non substitué et un groupe hétérocyclique en $C_1$ à $C_{30}$ substitué ou non substitué,
b1 à b4 et b7 représentent chacun indépendamment un entier de 1 à 5,
$R_1$ à $R_4$, $R_7$ to $R_{10}$, R' and R" sont chacun indépendamment sélectionnés parmi un atome d'hydrogène, un atome de deutérium, un groupe contenant du deutérium, -F, -Cl, -Br, -I, -$SF_5$, un groupe hydroxyle, un groupe cyano , un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$ à $C_{60}$ substitué ou non substitué, un groupe alcényle en $C_2$ à $C_{60}$ substitué ou non substitué, un groupe alcynyle en $C_2$ à $C_{60}$ substitué ou non substitué, un groupe alcoxy en $C_1$ à $C_{60}$ substitué ou non substitué, un groupe cycloalkyle en $C_3$ à $C_{10}$ substitué ou non substitué, un groupe hétérocycloalkyle en $C_1$ à $C_{10}$ substitué ou non substitué, un groupe cycloalcényle en $C_3$ à $C_{10}$ substitué ou non substitué, un groupe hétérocycloalcényle en $C_1$ à $C_{10}$ substitué ou non substitué, un groupe aryle en $C_6$ à $C_{60}$ substitué ou non substitué, un groupe arylalkyle en $C_7$ à $C_{60}$ substitué ou non substitué, un groupe aryloxy en $C_6$ à $C_{60}$ substitué ou non substitué, un groupe arylthio en $C_6$ à $C_{60}$ substitué ou non substitué, un groupe arylalkyle en $C_7$ à $C_{60}$ substitué ou non substitué, un groupe hétéroaryle en $C_1$ à $C_{60}$ substitué ou non substitué, un groupe hétéroaryloxy en $C_1$ à $C_{60}$ substitué ou non substitué, un groupe hétéroarylthio en $C_1$ à $C_{60}$ substitué ou non substitué, un groupe hétéroarylalkyle en $C_2$ à $C_{60}$ substitué ou non substitué, un groupe alkylhétéroaryle en $C_2$ à $C_{60}$ substitué ou non substitué, un groupe polycyclique condensé non aromatique monovalent substitué ou non substitué, un groupe hétéropolycyclique condensé non aromatique monovalent substitué ou non substitué, -N($Q_1$)($Q_2$), -Si($Q_3$)($Q_4$)($Q_5$), -B($Q_6$)($Q_7$), et -P(=O)($Q_8$)($Q_9$),
c1 à c4 et c7 représentent chacun indépendamment un entier de 1 à 5,
$Z_1$ à $Z_4$ représentent chacun indépendamment un atome de deutérium ou un groupe contenant du deutérium,
a1 à a4 et n1 à n4 représentent chacun indépendamment un entier de 0 à 20,

i) lorsque $X_{51}$ représente un atome O, S, un groupe C(=O) ou un atome N, la somme de n1 à n4 est supérieure ou égale à 1,
ii) lorsque $X_{51}$ représente un groupe N[$(L_7)_{b7}$-$(R_7)_{c7}$], C($R_7$), Si($R_7$) ou Ge($R_7$),

a) $R_7$ représente un atome de deutérium ou un groupe contenant du deutérium ;
b) la somme de n1 à n4 est supérieure ou égale 1 ; ou
c) $R_7$ représente un atome de deutérium ou un groupe contenant du deutérium et la somme de n1 à n4 est supérieure ou égale 1 ; et

iii) lorsque $X_{51}$ représente un groupe C($R_7$)($R_8$), Si($R_7$)($R_8$) ou Ge($R_7$)($R_8$),

a) au moins un groupe choisi parmi $R_7$ et $R_8$ représente un atome de deutérium ou un groupe contenant du deutérium ;
b) la somme de n1 à n4 est supérieure ou égale 1 ; ou
c) au moins un groupe choisi parmi $R_7$ et $R_8$ représente un atome de deutérium ou un groupe contenant du deutérium et la somme de n1 à n4 est supérieure ou égale 1 ;

deux d'une pluralité de groupes $R_1$ voisins sont éventuellement liés l'un à l'autre pour former un groupe carbocyclique en $C_5$ à $C_{30}$ non substitué ou substitué par au moins un groupe $R_{10a}$ ou un groupe hétérocyclique en $C_1$ à $C_{30}$ non substitué ou substitué par au moins un groupe $R_{10a}$,
deux d'une pluralité de groupes $R_2$ voisins sont éventuellement liés l'un à l'autre pour former un groupe carbocyclique en $C_5$ à $C_{30}$ non substitué ou substitué par au moins un groupe $R_{10a}$ ou un groupe hétérocyclique en

$C_1$ à $C_{30}$ non substitué ou substitué par au moins un groupe $R_{10}$,
deux d'une pluralité de groupes $R_3$ voisins sont éventuellement liés l'un à l'autre pour former un groupe carbocyclique en $C_5$ à $C_{30}$ non substitué ou substitué par au moins un groupe $R_{10a}$ ou un groupe hétérocyclique en $C_1$ à $C_{30}$ non substitué ou substitué par au moins un groupe $R_{10a}$,
deux d'une pluralité de groupes $R_4$ voisins sont éventuellement liés l'un à l'autre pour former un groupe carbocyclique en $C_5$ à $C_{30}$ non substitué ou substitué par au moins un groupe $R_{10a}$ ou un groupe hétérocyclique en $C_1$ à $C_{30}$ non substitué ou substitué par au moins un groupe $R_{10a}$,
deux groupes voisins ou plus choisis parmi $R_1$ à $R_4$, $R_7$ à $R_{10}$, R' et R" sont éventuellement liés pour former un groupe carbocyclique en $C_5$ à $C_{30}$ non substitué ou substitué par au moins un groupe $R_{10a}$ ou un groupe hétérocyclique en $C_1$ à $C_{30}$ non substitué ou substitué par au moins un groupe $R_{10a}$,
$R_{10a}$ a la même définition que $R_1$,
au moins un substituant du groupe carbocyclique en $C_5$ à $C_{30}$ substitué, du groupe hétérocyclique en $C_1$ à $C_{30}$ substitué, du groupe alkyle en $C_1$ à $C_{60}$ substitué, du groupe alcényle en $C_2$ à $C_{60}$ substitué, du groupe alcynyle en $C_2$ à $C_{60}$ substitué, du groupe alcoxy en $C_1$ à $C_{60}$ substitué, du groupe cycloalkyle en $C_3$ à $C_{10}$ substitué, du groupe hétérocycloalkyle en $C_1$ à $C_{10}$ substitué, du groupe cycloalcényle en $C_3$ à $C_{10}$ substitué, du groupe hétérocycloalcényle en $C_1$ à $C_{10}$ substitué, du groupe aryle en $C_6$ à $C_{60}$ substitué, du groupe alkylaryle en $C_7$ à $C_{60}$ substitué, du groupe aryloxy en $C_6$ à $C_{60}$ substitué, du groupe arylthio en $C_6$ à $C_{60}$ substitué, du groupe arylalkyle en $C_7$ à $C_{60}$ substitué, du groupe hétéroaryle en $C_1$ à $C_{60}$ substitué, du groupe hétéroaryloxy en $C_1$ à $C_{60}$ substitué, du groupe hétéroarylthio en $C_1$ à $C_{60}$ substitué, du groupe hétéroarylalkyle en $C_2$ à $C_{60}$ substitué, du groupe alkylhétéroaryle en $C_2$ à $C_{60}$ substitué, du groupe polycyclique condensé non aromatique monovalent substitué et du groupe hétéropolycyclique condensé non aromatique monovalent substitué est choisi parmi :

un atome de deutérium, un groupe -F, -Cl, -Br, -I, $-CD_3$, $-CD_2H$, $-CDH_2$, $-CF_3$, $-CF_2H$,$-CFH_2$, un groupe hydroxy, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$ à $C_{60}$, un groupe alcényle en $C_2$ à $C_{60}$, un groupe alcynyle en $C_2$ à $C_{60}$, un groupe alcoxy en $C_1$ à $C_{60}$ ;
un groupe alkyle en $C_1$ à $C_{60}$, un groupe alcényle en $C_2$ à $C_{60}$, un groupe alcynyle en $C_2$ à $C_{60}$ et un groupe alcoxy en $C_1$ à $C_{60}$, chacun étant substitué par au moins un groupe choisi parmi un atome de deutérium, un groupe -F, -Cl, -Br, -I, $-CD_3$, $-CD_2H$, $-CDH_2$, $-CF_3$, $-CF_2H$, $-CFH_2$, un groupe hydroxy, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en $C_3$ à $C_{10}$, un groupe hétérocycloalkyle en $C_1$ à $C_{10}$, un groupe cycloalcényle en $C_3$ à $C_{10}$, un groupe hétérocycloalcényle en $C_1$ à $C_{10}$, un groupe aryle en $C_6$ à $C_{60}$, un groupe alkylaryle en $C_7$ à $C_{60}$, un groupe aryloxy en $C_6$ à $C_{60}$, un groupe arylthio en $C_6$ à $C_{60}$, un groupe arylalkyle en $C_7$ à $C_{60}$, un groupe hétéroaryle en $C_1$ à $C_{60}$, un groupe hétéroaryloxy en $C_1$ à $C_{60}$, un groupe hétéroarylthio en $C_1$ à $C_{60}$, un groupe hétéroarylalkyle en $C_2$ à $C_{60}$, un groupe alkylhétéroaryle en $C_2$ à $C_{60}$, un groupe polycyclique condensé non aromatique monovalent, un groupe hétéropolycyclique condensé non aromatique monovalent, $-N(Q_{11})(Q_{12})$, $Si(Q_{13})(Q_{14})(Q_{15})$,$-B(Q_{16})(Q_{17})$ et $-P(=O)(Q_{18})(Q_{19})$ ;
un groupe cycloalkyle en $C_3$ à $C_{10}$, un groupe hétérocycloalkyle en $C_1$ à $C_{10}$, un groupe cycloalcényle en $C_3$ à $C_{10}$, un groupe hétérocycloalcényle en $C_1$ à $C_{10}$, un groupe aryle en $C_6$ à $C_{60}$, un groupe alkylaryle en $C_7$ à $C_{60}$, un groupe aryloxy en $C_6$ à $C_{60}$, un groupe arylthio en $C_6$ à $C_{60}$, un groupe arylalkyle en $C_7$ à $C_{60}$, un groupe hétéroaryle en $C_1$ à $C_{60}$, un groupe hétéroaryloxy en $C_1$ à $C_{60}$, un groupe hétéroarylthio en $C_1$ à $C_{60}$, un groupe hétéroarylalkyle en $C_2$ à $C_{60}$, un groupe alkylhétéroaryle en $C_2$ à $C_{60}$, un groupe polycyclique condensé non aromatique monovalent et un groupe hétéropolycyclique condensé non aromatique monovalent ;
un groupe cycloalkyle en $C_3$ à $C_{10}$, un groupe hétérocycloalkyle en $C_1$ à $C_{10}$, un groupe cycloalcényle en $C_3$ à $C_{10}$, un groupe hétérocycloalcényle en $C_1$ à $C_{10}$, un groupe aryle en $C_6$ à $C_{60}$, un groupe alkylaryle en $C_7$ à $C_{60}$, un groupe aryloxy en $C_6$ à $C_{60}$, un groupe arylthio en $C_6$ à $C_{60}$, un groupe arylalkyle en $C_7$ à $C_{60}$, un groupe hétéroaryle en $C_1$ à $C_{60}$, un groupe hétéroaryloxy en $C_1$ à $C_{60}$, un groupe hétéroarylthio en $C_1$ à $C_{60}$, un groupe hétéroarylalkyle en $C_2$ à $C_{60}$, un groupe alkylhétéroaryle en $C_2$ à $C_{60}$, un groupe polycyclique condensé non aromatique monovalent et un groupe hétéropolycyclique condensé non aromatique monovalent, chacun étant substitué par au moins un groupe choisi parmi un atome de deutérium, un groupe -F, -Cl, -Br, -I, $-CD_3$, $-CD_2H$, - $CDH_2$, $-CF_3$, $-CF_2H$, $-CFH_2$, un groupe hydroxy, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$ à $C_{60}$, un groupe alcényle en $C_2$ à $C_{60}$, un groupe alcynyle en $C_2$ à $C_{60}$, un groupe alcoxy en $C_1$ à $C_{60}$, un groupe cycloalkyle en $C_3$ à $C_{10}$, un groupe hétérocycloalkyle

en $C_1$ à $C_{10}$, un groupe cycloalcényle en $C_3$ à $C_{10}$, un groupe hétérocycloalcényle en $C_1$ à $C_{10}$, un groupe aryle en $C_6$ à $C_{60}$, un groupe alkylaryle en $C_7$ à $C_{60}$, un groupe aryloxy en $C_6$ à $C_{60}$, un groupe arylthio en $C_6$ à $C_{60}$, un groupe arylalkyle en $C_7$ à $C_{60}$, un groupe hétéroaryle en $C_1$ à $C_{60}$, un groupe hétéroaryloxy en $C_1$ à $C_{60}$, un groupe hétéroarylthio en $C_1$ à $C_{60}$, un groupe hétéroarylalkyle en $C_2$ à $C_{60}$, un groupe alkylhétéroaryle en $C_2$ à $C_{60}$, un groupe polycyclique condensé non aromatique monovalent, un groupe hétéropolycyclique condensé non aromatique monovalent, $-N(Q_{21})(Q_{22})$, $Si(Q_{23})(Q_{24})(Q_{25})$, $-B(Q_{26})(Q_{27})$ et $-P(=O)(Q_{28})(Q_{29})$ ; et

$-N(Q_{31})(Q_{32})$, $-Si(Q_{33})(Q_{34})(Q_{35})$, $-B(Q_{36})(Q_{37})$ et $-P(=O)(Q_{38})(Q_{39})$ ;

dans lesquels $Q_1$ à $Q_9$, $Q_{11}$ à $Q_{19}$, $Q_{21}$ à $Q_{29}$, et $Q_{31}$ à $Q_{39}$ sont chacun indépendamment choisis parmi un atome d'hydrogène, de deutérium, un groupe -F, -Cl, -Br, -I, un groupe hydroxy, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$ à $C_{60}$, un groupe alkyle en $C_1$ à $C_{60}$ substitué par au moins un groupe choisi parmi un atome de deutérium, un groupe alkyle en $C_1$ à $C_{60}$ et un groupe aryle en $C_6$ à $C_{60}$, un groupe alcényle en $C_2$ à $C_{60}$, un groupe alcynyle en $C_2$ à $C_{60}$, un groupe alcoxy en $C_1$ à $C_{60}$, un groupe cycloalkyle en $C_3$ à $C_{10}$, un groupe hétérocycloalkyle en $C_1$ à $C_{10}$, un groupe cycloalcényle en $C_3$ à $C_{10}$, un groupe hétérocycloalcényle en $C_1$ à $C_{10}$, un groupe aryle en $C_6$ à $C_{60}$, un groupe aryle en $C_6$ à $C_{60}$ substitué par au moins un groupe choisi parmi un atome de deutérium, un groupe alkyle en $C_1$ à $C_{60}$ et un groupe aryle en $C_6$ à $C_{60}$, un groupe aryloxy en $C_6$ à $C_{60}$, un groupe arylthio en $C_6$ à $C_{60}$, un groupe arylalkyle en $C_7$ à $C_{60}$, un groupe hétéroaryle en $C_1$ à $C_{60}$, un groupe hétéroaryloxy en $C_1$ à $C_{60}$, un groupe hétéroarylthio en $C_1$ à $C_{60}$, un groupe hétéroarylalkyle en $C_2$ à $C_{60}$, un groupe alkylhétéroaryle en $C_2$ à $C_{60}$, un groupe polycyclique condensé non aromatique monovalent et un groupe hétéropolycyclique condensé non aromatique monovalent.

**2.** Composé organométallique selon la revendication 1,

i) $X_2$ et $X_4$ représentant chacun un atome N, $X_3$ représentant un atome C, une liaison entre $X_2$ et M et une liaison entre $X_4$ et M représentant chacune une liaison de coordination, et une liaison entre $X_3$ et M représentant une liaison covalente,
i) $X_2$ et $X_3$ représentant chacun un atome N, $X_4$ représentant un atome C, une liaison entre $X_2$ et M et une liaison entre $X_3$ et M représentant chacune une liaison de coordination, et une liaison entre $X_4$ et M représentant une liaison covalente, ou
iii) $X_3$ et $X_4$ représentant chacun un atome N, $X_2$ représentant un atome C, une liaison entre $X_3$ et M et une liaison entre $X_4$ et M représentant chacune une liaison de coordination, et une liaison entre $X_2$ et M représentant une liaison covalente.

**3.** Composé organométallique selon la revendication 1 ou 2, ledit noyau $CY_1$ audit noyau $CY_4$ étant chacun indépendamment choisi parmi i) un premier noyau, ii) un second noyau, iii) un noyau condensé dans lequel deux premiers noyaux ou plus sont condensés l'un avec l'autre, iv) un noyau condensé dans lequel deux seconds noyaux ou plus sont condensés l'un avec l'autre, et v) un noyau condensé dans lequel un ou plusieurs premiers noyaux et un ou plusieurs second noyaux sont condensés l'un avec l'autre,
le premier noyau étant choisi parmi un groupe cyclopentane, un groupe cyclopentadiène, un groupe furane, un groupe thiophène, un groupe pyrrole, un groupe silole, un groupe indène, un groupe benzofurane, un groupe benzothiophène, un groupe indole, un groupe benzosilole, un groupe oxazole, un groupe isoxazole, un groupe oxadiazole, un groupe isozadiazole, un groupe oxatriazole, un groupe isoxatriazole, un groupe thiazole, un groupe isothiazole, un groupe thiadiazole, un groupe isothiadiazole, un groupe thiatriazole, un groupe isothiatriazole, un groupe pyrazole, un groupe imidazole, un groupe triazole, un groupe tétrazole, un groupe azasilole, un groupe diazasilole et un groupe triazasilole,
le second noyau étant choisi parmi un groupe adamantane, un groupe norbornane, un groupe norbornène, un groupe cyclohexane, un groupe cyclohexène, un groupe benzène, un groupe pyridine, un groupe pyrimidine, un groupe pyrazine, un groupe pyridazine et un groupe triazine, et chacun du noyau $CY_1$ au noyau $CY_4$ ne représentant pas un groupe benzimidazole.

**4.** Composé organométallique selon la revendication 1 ou 2, ledit noyau $CY_1$ audit noyau $CY_4$ étant chacun indépendamment choisi parmi un groupe benzène, un groupe naphtalène, un groupe anthracène, un groupe phénanthrène, un groupe triphénylène, un groupe pyrène, un groupe chrysène, un groupe cyclopentadiène, un groupe 1,2,3,4-tétrahydronaphtalène, un groupe furane, un groupe thiophène, un groupe silole, un groupe indène, un groupe fluorène, un groupe indole, un groupe carbazole, un groupe benzofurane, un groupe dibenzofurane, un groupe

benzothiophène, un groupe dibenzothiophène, un groupe benzosilole, un groupe dibenzosilole, un groupe azafluorène, un groupe azacarbazole, un groupe azadibenzofurane, un groupe azadibenzothiophène, un groupe azadibenzosilole, un groupe pyridine, un groupe pyrimidine, un groupe pyrazine, un groupe pyridazine, un groupe triazine, un groupe quinoline, un groupe isoquinoline, un groupe quinoxaline, un groupe quinazoline, un groupe phénanthroline, un groupe pyrrole, un groupe pyrazole, un groupe imidazole, un groupe triazole, un groupe oxazole, un groupe isooxazole, un groupe thiazole, un groupe isothiazole, un groupe oxadiazole, un groupe thiadiazole, un groupe 5,6,7,8-tétrahydroisoquinoline et un groupe 5,6,7,8-tétrahydroquinoline.

**5.** Composé organométallique selon l'une quelconque des revendications 1 à 4,

i) $Y_3$ à $Y_5$ représentant chacun un atome C, une liaison entre $X_{51}$ et $Y_3$ et une liaison entre $X_{51}$ and $Y_5$ représentant chacune une liaison simple, et $X_{51}$ représentant un atome O, S, un groupe N-[$(L_7)_{b7}$-$(R_7)c_7$], C($R_7$)($R_8$), Si($R_7$)($R_8$), Ge($R_7$)($R_8$) ou C(=O),
ii) $Y_3$ et $Y_4$ représentant chacun un atome C, $Y_5$ représentant un atome N, une liaison entre $X_{51}$ et $Y_3$ représentant une double liaison, une liaison entre $X_{51}$ and $Y_5$ représentant une liaison simple, et $X_{51}$ représentant un atome N, un groupe C($R_7$), Si($R_7$) ou Ge($R_7$),
iii) $Y_3$ et $Y_5$ représentant chacun un atome C, $Y_4$ représentant un atome N, une liaison entre $X_{51}$ et $Y_3$ représentant une liaison simple, une liaison entre $X_{51}$ and $Y_5$ représentant une double liaison, et $X_{51}$ représentant un atome N, un groupe C($R_7$), Si($R_7$) ou Ge($R_7$),
iv) $Y_3$ représentant un atome N, $Y_4$ et $Y_5$ représentant chacun un atome C, une liaison entre $X_{51}$ et $Y_3$ représentant une liaison simple, une liaison entre $X_{51}$ and $Y_5$ représentant une double liaison, et $X_{51}$ représentant un atome N, un groupe C($R_7$), Si($R_7$) ou Ge($R_7$), ou
v) $Y_3$ à $Y_5$ représentant chacun un atome C, une liaison entre $X_{51}$ et $Y_3$ représentant une double liaison, une liaison entre $X_{51}$ and $Y_5$ représentant une liaison simple, et $X_{51}$ représentant un atome N, un groupe C($R_7$), Si($R_7$) ou Ge($R_7$).

**6.** Composé organométallique selon l'une quelconque des revendications 1 à 5, ledit groupe contenant du deutérium étant un premier groupe substitué par au moins un atome de deutérium, et le premier groupe étant choisi parmi :
un groupe alkyle en $C_1$ à $C_{20}$ et un groupe alcoxy en $C_1$ à $C_{20}$ ;
un groupe alkyle en $C_1$ à $C_{20}$ et un groupe alcoxy en $C_1$ à $C_{20}$, chacun substitué par au moins un groupe choisi parmi un groupe -F, -Cl, -Br, -I, $-CD_3$, $-CD_2H$, $-CDH_2$, $-CF_3$, $-CF_2H$, $-CFH_2$, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$ à $C_{10}$, un groupe cyclopentyle, un groupe cyclohexyle, un groupe cycloheptyle, un groupe cycloctyle, un groupe adamantanyle, un groupe norbornanyle, un groupe norbornényle, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.1]heptyle, un groupe bicyclo[2.2.2]octyle, un groupe phényle, un groupe ($C_1$ à $C_{20}$)alkyl)phényle, un groupe biphényle, un groupe terphényle, un groupe naphtyle, un groupe pyridinyle et un groupe pyrimidinyle ;
un groupe cyclopentyle, un groupe cyclohexyle, un groupe cycloheptyle, un groupe cycloctyle, un groupe adamantanyle, un groupe norbornanyle, un groupe norbornényle, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.1]heptyle, un groupe bicyclo[2.2.2]octyle, un groupe phényle, un groupe ($C_1$ à $C_{20}$ alkyl)phényle, un groupe biphényle, un groupe terphényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle et un groupe imidazopyrimidinyle ;
un groupe cyclopentyle, un groupe cyclohexyle, un groupe cycloheptyle, un groupe cycloctyle, un groupe adamantanyle, un groupe norbornanyle, un groupe norbornényle, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.1]heptyle, un groupe bicyclo[2.2.2]octyle, un groupe phényle, un groupe ($C_1$ à $C_{20}$ alkyl)phényle, un groupe biphényle, un groupe terphényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle et un groupe imidazopyrimidinyle, chacun substitué par au moins un groupe choisi parmi un groupe -F, -Cl, -Br, -I, - $CD_3$, $-CD_2H$, $-CDH_2$,$-CF_3$, $-CF_2H$, $-CFH_2$, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$ à $C_{20}$, un groupe alcoxy en $C_1$ à $C_{20}$, un groupe cyclopentyle, un groupe cyclohexyle, un groupe cycloheptyle, un groupe cycloctyle, un groupe adamantanyle, un groupe norbornanyle, un groupe norbornényle, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.1]heptyle, un groupe bicyclo[2.2.2]octyle, un groupe phényle, un groupe ($C_1$ à $C_{20}$ alkyl)phényle, un groupe biphényle, un groupe terphényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle, un groupe imidazopyrimidinyle et $-Si(Q_{33})(Q_{34})(Q_{35})$ ; et
un groupe $-N(Q_1)(Q_2)$, $-Si(Q_3)(Q_4)(Q_5)$, $-B(Q_6)(Q_7)$ et $-P(=O)(Q_8)(Q_9)$ ; dans lesquels $Q_1$ à $Q_9$ et $Q_{33}$ à $Q_{35}$ sont chacun indépendamment choisis parmi :

un groupe -CH3, $-CD_3$, $-CD_2H$, $-CDH_2$, $-CH_2CH_3$, $-CH_2CD_3$, $-CH_2CD_2H$, $-CH_2CDH_2$,$-CHDCH_3$, $-CHDCD_2H$, $-CHDCDH_2$, $-CHDCD_3$, $-CD_2CH_3$, $-CD_2CD_3$, $-CD_2CD_2H$ et $-CD_2CDH_2$ ;
un groupe n-propyle, un groupe iso-propyle, un groupe n-butyle, un groupe iso-butyle, un groupe sec- butyle, un groupe tert-butyle, un groupe n-pentyle, un groupe isopentyle, un groupe sec-pentyle, un groupe tert-pentyle, un groupe phényle et un groupe naphtyle ; et
un groupe n-propyle, un groupe iso-propyle, un groupe n-butyle, un groupe iso-butyle, un groupe sec-butyle, un groupe tert-butyle, un groupe n-pentyle, un groupe isopentyle, un groupe sec-pentyle, un groupe tert-pentyle, un groupe phényle et un groupe naphtyle, chacun substitué par au moins un groupe choisi parmi un groupe alkyle en $C_1$ à $C_{10}$ et un groupe phényle.

**7.** Composé organométallique selon l'une quelconque des revendications 1 à 6, ledit groupe contenant du deutérium étant un premier groupe substitué par au moins un atome de deutérium, et le premier groupe étant choisi parmi un groupe alkyle en $C_1$ à $C_{20}$, un groupe cyclopentyle, un groupe cyclohexyle, un groupe cycloheptyle, un groupe cycloctyle, un groupe adamantanyle, un groupe norbornanyle, un groupe norbornényle, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.1]heptyle, un groupe bicyclo[2.2.2]octyle, un groupe phényle, un groupe ($C_1$ à $C_{20}$ alkyl)phényle, un groupe biphényle et un groupe terphényle, chacun non substitué ou substitué par au moins un groupe choisi parmi un groupe -F, $-CD_3$, $-CD_2H$,$-CDH_2$, $-CF_3$, $-CF_2H$, $-CFH_2$, un groupe cyano, un groupe alkyle en $C_1$ à $C_{10}$, un groupe cyclopentyle, un groupe cyclohexyle, un groupe cycloheptyle, un groupe cycloctyle, un groupe adamantanyle, un groupe norbornanyle, un groupe norbornényle, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.1]heptyle, un groupe bicyclo[2.2.2]octyle, un groupe phényle, un groupe ($C_1$ à $C_{20}$ alkyl)phényle, un groupe biphényle et un groupe terphényle.

**8.** Composé organométallique selon l'une quelconque des revendications 1 à 7,

$R_1$ à $R_4$, $R_7$ à $R_{10}$, R' et R" étant chacun indépendamment choisis parmi un atome d'hydrogène, de deutérium, un groupe -F, un groupe cyano, un groupe nitro, $-SF_5$, $-CH_3$, $-CD_3$,$-CD_2H$, $-CDH_2$, $-CF_3$, $-CF_2H$, $-CFH_2$, $-CD_2(CD_3)$, $-CD(CD_3)_2$, $-C(CD_3)_3$, $-CD_2-C(CD_3)_3$, $-CD_2-CD(CD_3)_2$, $-CD_2-CD_2(CD_3)$, $-$ $CD(CD_3)-C(CD_3)_3$, $-CD(CD_3)-CD(CD_3)_2$, $-CD(CD_3)-CD_2(CD_3)$,$-C(CD_3)_2-C(CD_3)_3$, $-C(CD_3)_2-CD(CD_3)_2$, $-C(CD_3)_2-CD_2(CD_3)$, un groupe représenté par les formules 9-1 à 9-19, un groupe représenté par les formules 10-1 à 10-232, un groupe représenté par les formules 11-1 à 11-41 et $-Si(Q_1)(Q_2)(Q_3)$,

$Z_1$ à $Z_4$ étant chacun indépendamment choisis parmi un atome de deutérium, un groupe-$CD_3$, $-CD_2H$, $-CDH_2$, $-CD_2(CD_3)$, $-CD(CD_3)_2$, $-C(CD_3)_3$, $-CD_2-C(CD_3)_3$, $-CD_2-CD(CD_3)_2$, $-CD_2-CD_2(CD_3)$, $-$ $CD(CD_3)-C(CD_3)_3$, $-CD(CD_3)-CD(CD_3)_2$, $-CD(CD_3)-CD_2(CD_3)$, $-C(CD_3)_2-C(CD_3)_3$, $-C(CD_3)_2-$ $CD(CD_3)_2$, $-C(CD_3)_2-CD_2(CD_3)$, et un groupe représenté par l'une des formules 9-14 à 9-19, 10-11, 10-12 et 11-1 à 11-41 :

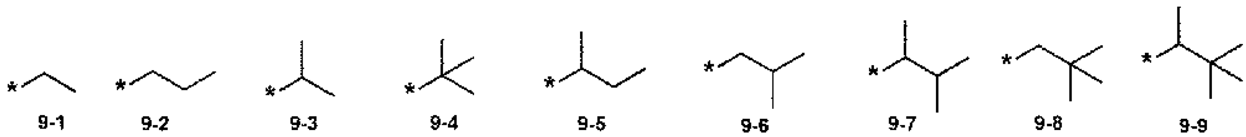
9-1 9-2 9-3 9-4 9-5 9-6 9-7 9-8 9-9

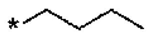
9-10
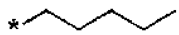
9-11
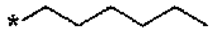
9-12
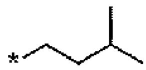
9-13
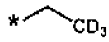
9-14
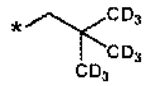
9-15
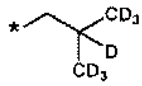
9-16

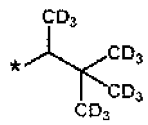
9-17
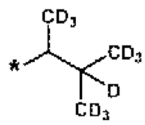
9-18
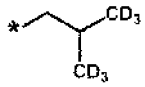
9-19

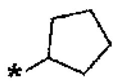
10-1
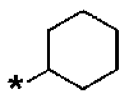
10-2
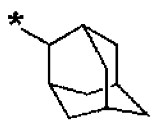
10-3
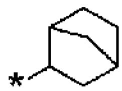
10-4
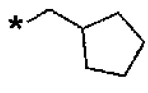
10-5
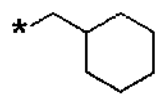
10-6
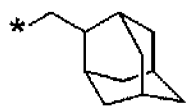
10-7

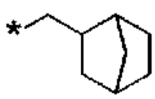
10-8
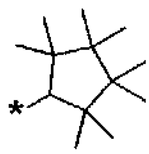
10-9
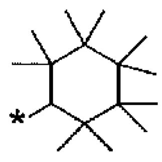
10-10
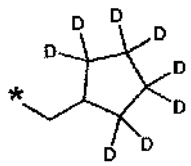
10-11
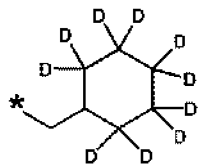
10-12
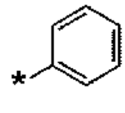
10-13

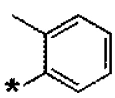
10-14
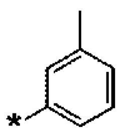
10-15
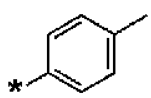
10-16
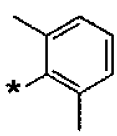
10-17
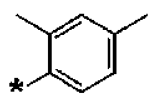
10-18
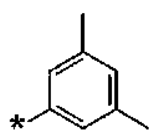
10-19
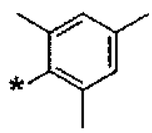
10-20

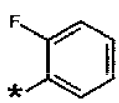
10-21
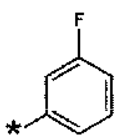
10-22
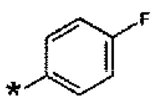
10-23
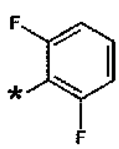
10-24
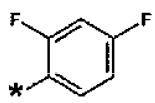
10-25
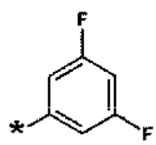
10-26
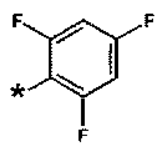
10-27

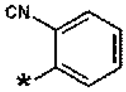 10-28
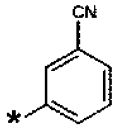 10-29
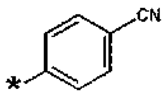 10-30
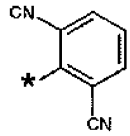 10-31
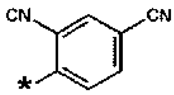 10-32
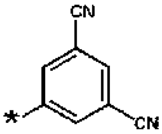 10-33
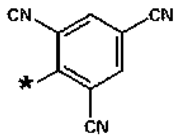 10-34

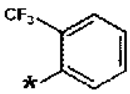 10-35
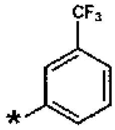 10-36
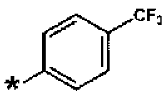 10-37
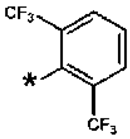 10-38
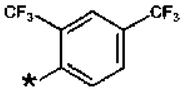 10-39
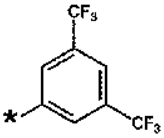 10-40
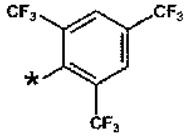 10-41

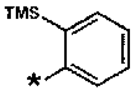 10-42
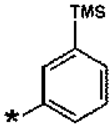 10-43
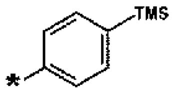 10-44
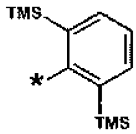 10-45
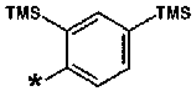 10-46
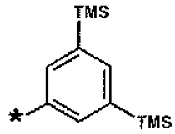 10-47
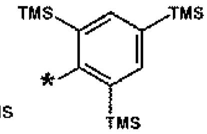 10-48

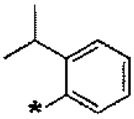 10-49
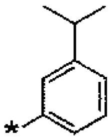 10-50
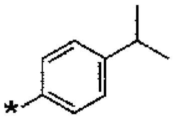 10-51
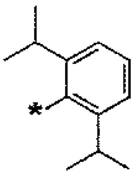 10-52
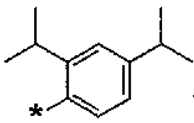 10-53
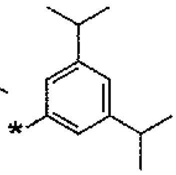 10-54
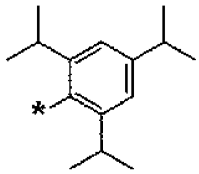 10-55

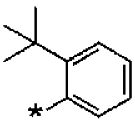 10-56
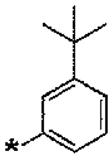 10-57
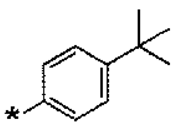 10-58
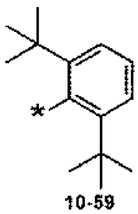 10-59
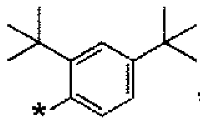 10-60
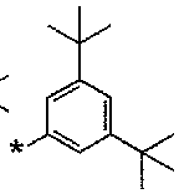 10-61
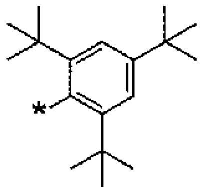 10-62

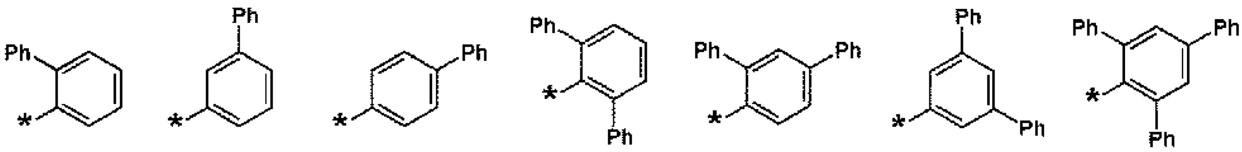

10-63 10-64 10-65 10-66 10-67 10-68 10-69

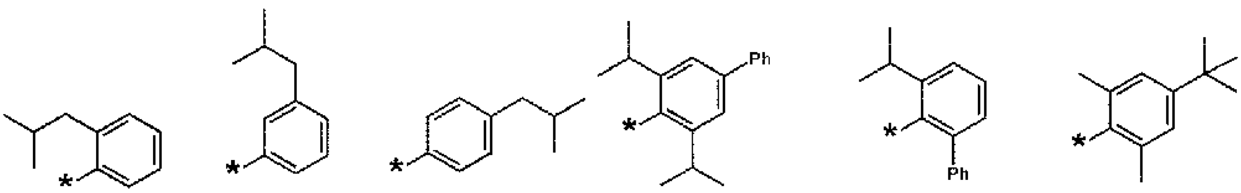

10-70 10-71 10-72 10-73 10-74 10-75

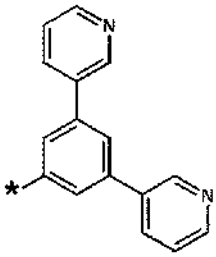
10-76

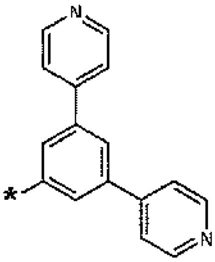
10-77

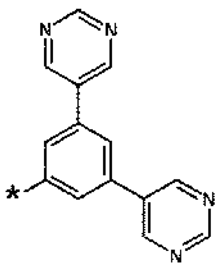
10-78

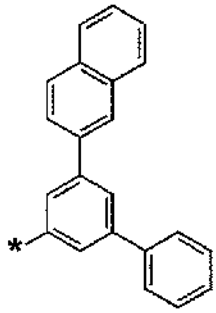
10-79

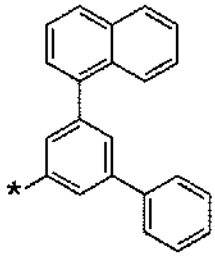
10-80

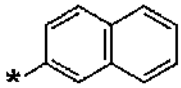
10-81

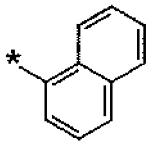
10-82

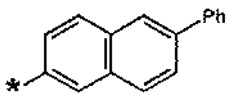
10-83

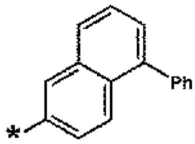
10-84

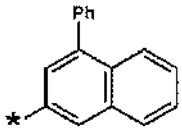
10-85

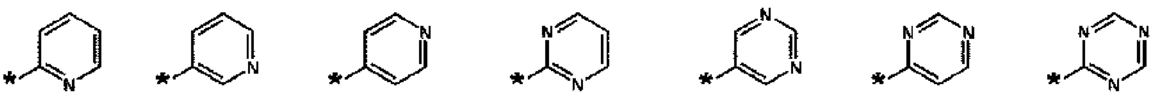
10-86 10-87 10-88 10-89 10-90 10-91 10-92

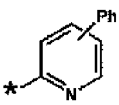
10-93

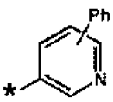
10-94

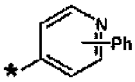
10-95

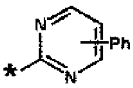
10-96

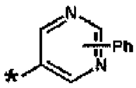
10-97

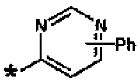
10-98

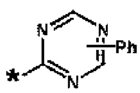
10-99

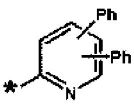
10-100

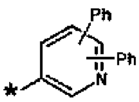
10-101

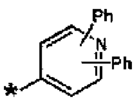
10-102

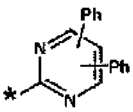
10-103

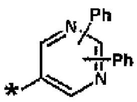
10-104

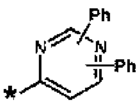
10-105

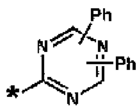
10-106

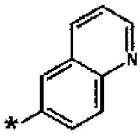
10-107

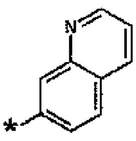
10-108

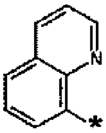
10-109

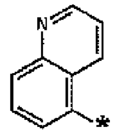
10-110

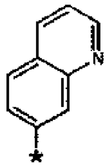
10-111

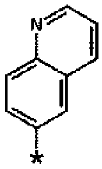
10-112

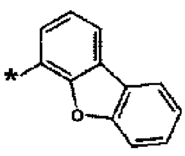
10-113

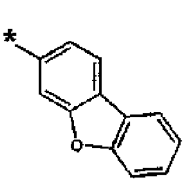
10-114

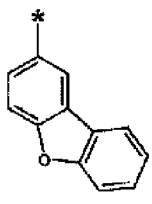
10-115

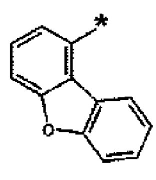
10-116

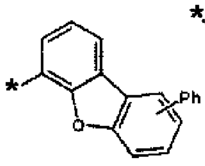
10-117

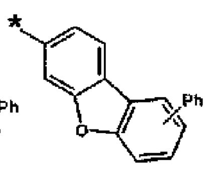
10-118

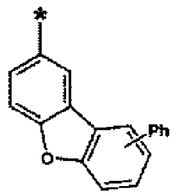 10-119 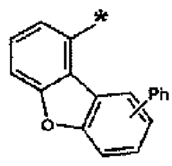 10-120 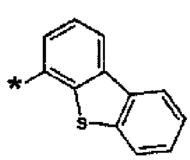 10-121 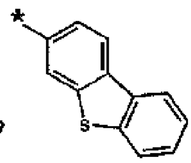 10-122 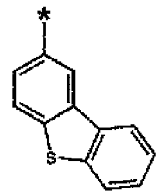 10-123 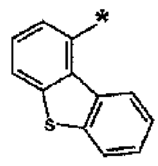 10-124

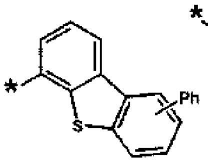 10-125 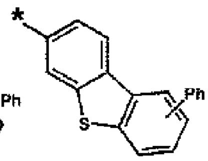 10-126 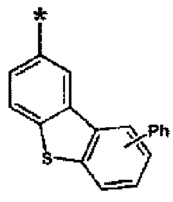 10-127 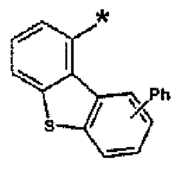 10-128 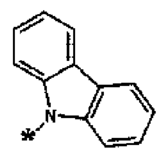 10-129 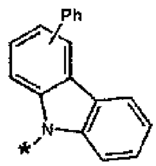 10-130

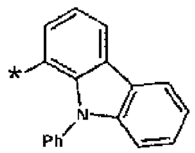 10-131 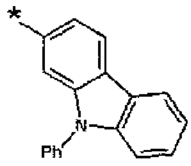 10-132 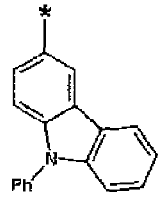 10-133 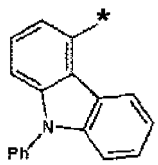 10-134 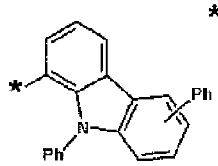 10-135 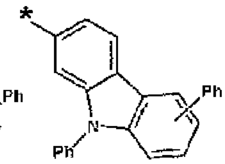 10-136

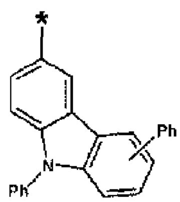 10-137 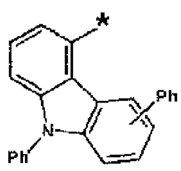 10-138 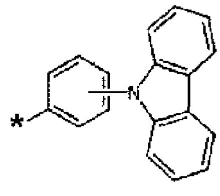 10-139 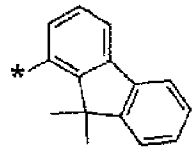 10-140 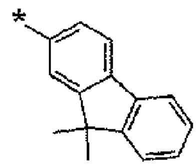 10-141 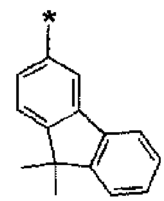 10-142

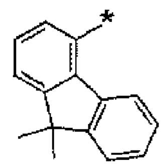 10-143 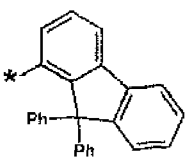 10-144 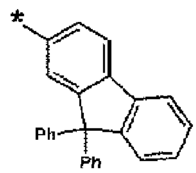 10-145 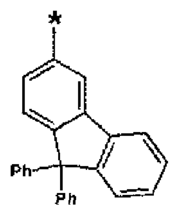 10-146 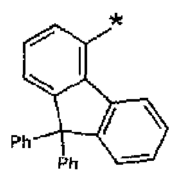 10-147

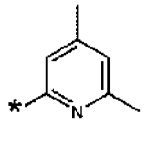 10-148 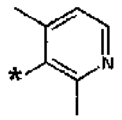 10-149 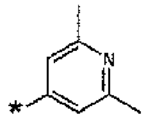 10-150 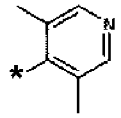 10-151 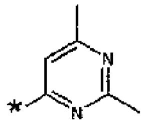 10-152 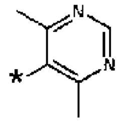 10-153 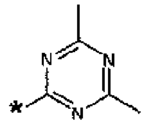 10-154

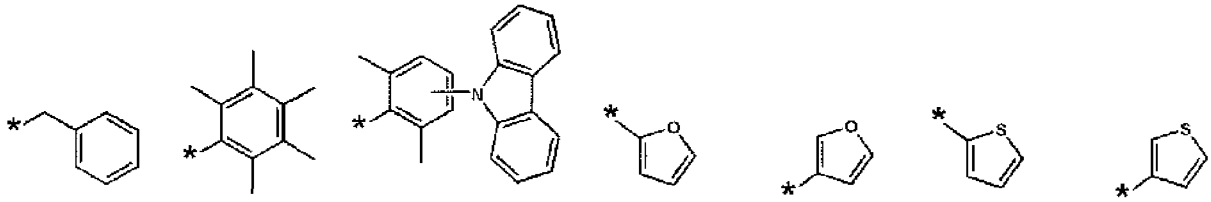
10-155 10-156 10-157 10-158 10-159 10-160 10-161

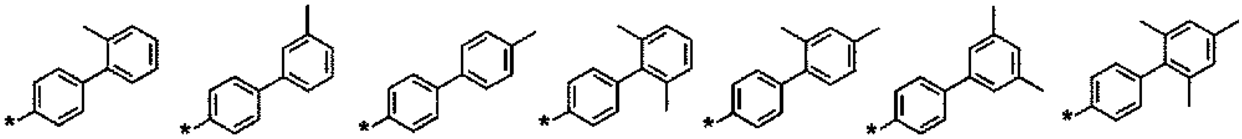
10-162 10-163 10-164 10-165 10-166 10-167 10-168

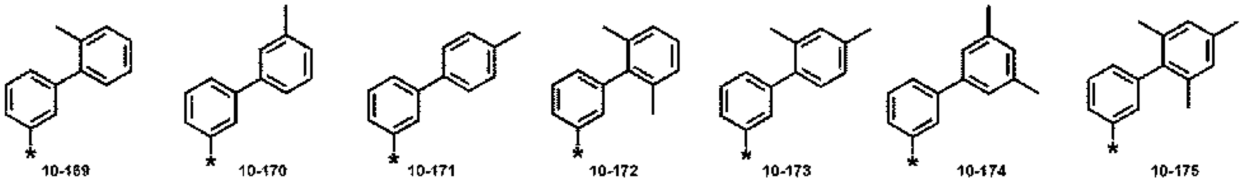
10-169 10-170 10-171 10-172 10-173 10-174 10-175

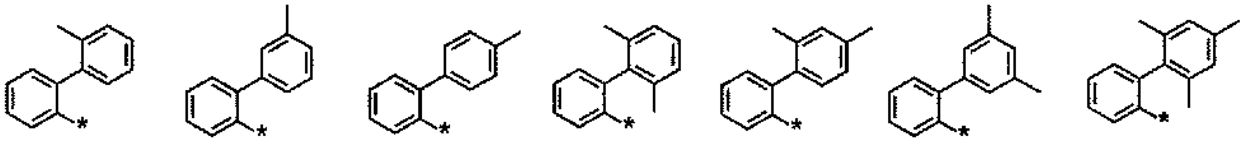
10-176 10-177 10-178 10-179 10-180 10-181 10-182

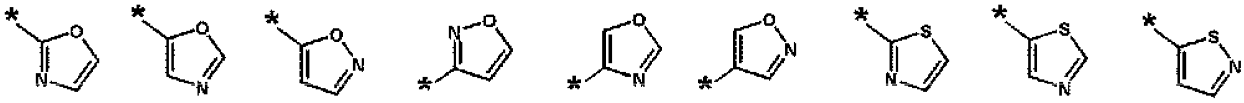
10-183 10-184 10-185 10-186 10-187 10-188 10-189 10-190 10-191

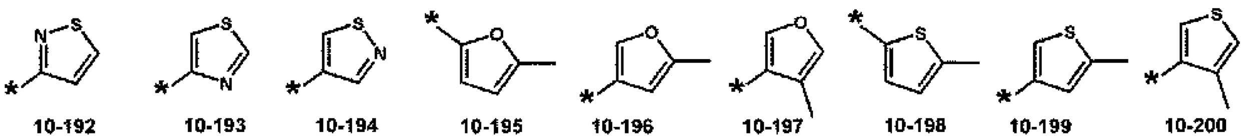
10-192 10-193 10-194 10-195 10-196 10-197 10-198 10-199 10-200

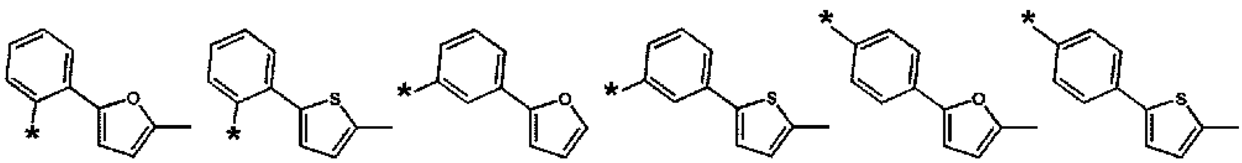
10-201 10-202 10-203 10-204 10-205 10-206

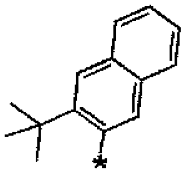
10-207

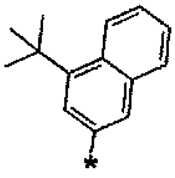
10-208

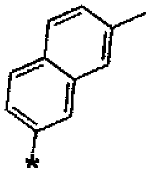
10-209

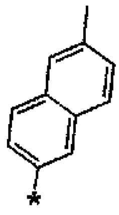
10-210

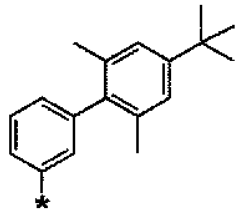
10-211

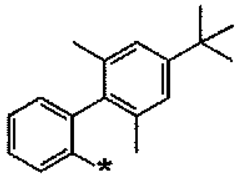
10-212

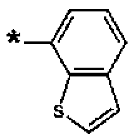
10-213

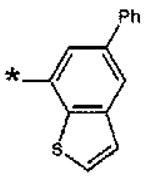
10-214

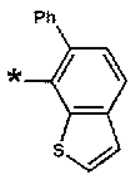
10-215

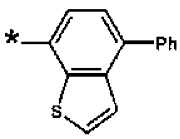
10-216

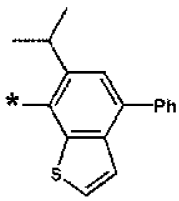
10-217

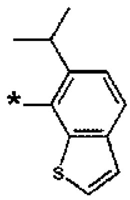
10-218

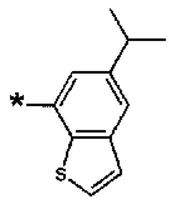
10-219

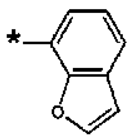
10-220

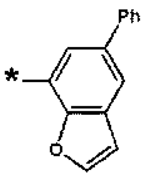
10-221

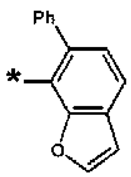
10-222

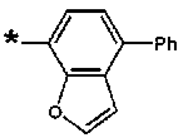
10-223

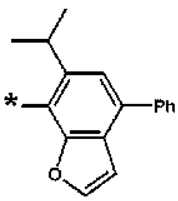
10-224

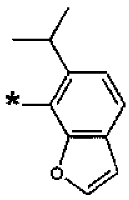
10-225

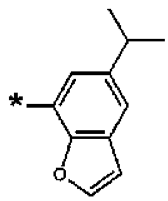
10-226

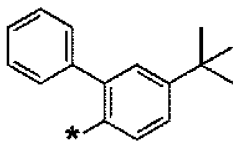
10-227

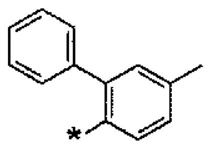
10-228

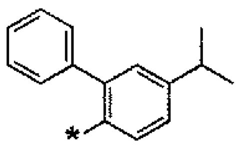
10-229

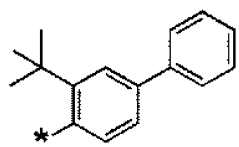
10-230

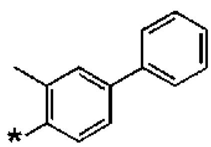
10-231

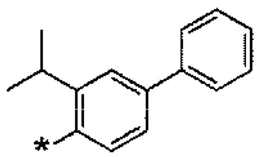
10-232

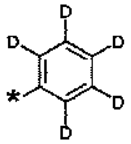
11-1

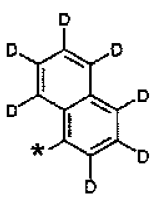
11-2

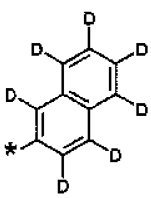
11-3

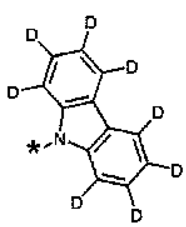
11-4

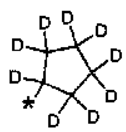
11-5

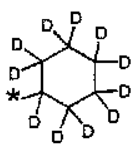
11-6

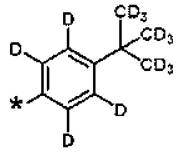
11-7

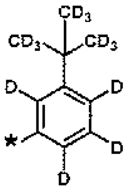 11-8 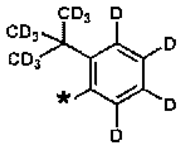 11-9 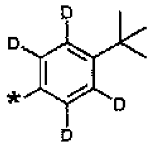 11-10 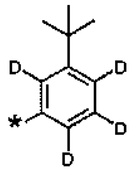 11-11 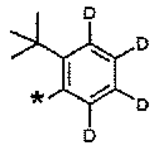 11-12 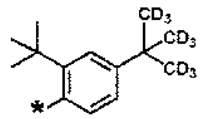 11-13 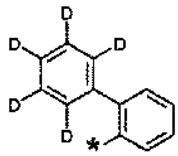 11-14

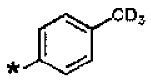 11-15 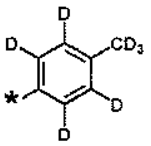 11-16 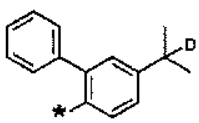 11-17 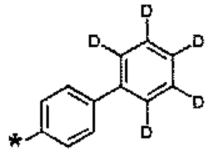 11-18 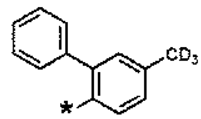 11-19 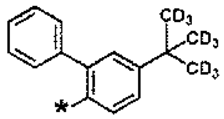 11-20

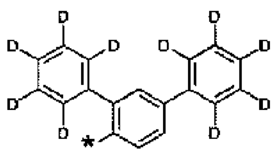 11-21 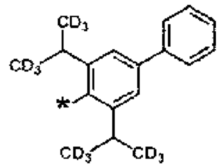 11-22 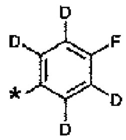 11-23 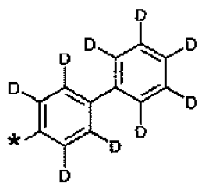 11-24 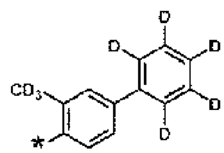 11-25

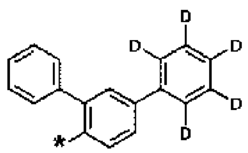 11-26 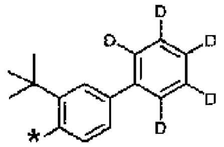 11-27 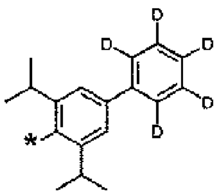 11-28 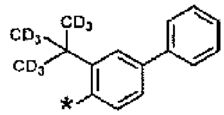 11-29 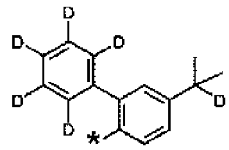 11-30

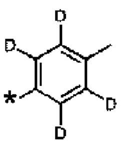 11-31 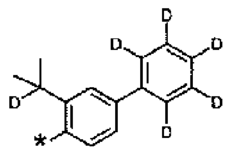 11-32 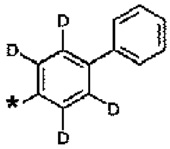 11-33 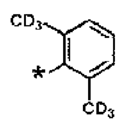 11-34 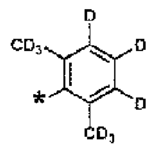 11-35 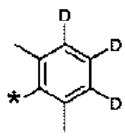 11-36

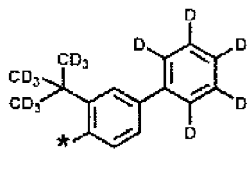 11-37 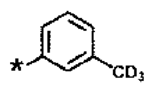 11-38 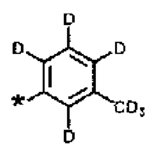 11-39 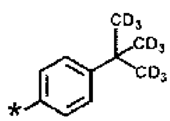 11-40 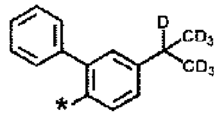 11-41

dans lesquelles, dans les formules 9-1 à 9-19, 10-1 à 10-232 et 11-1 à 11-41, * indique un site de liaison à un atome voisin, Ph représente un groupe phényle et TMS représente un groupe triméthylsilyle ;
et/ou dans lesquelles le groupe contenant du deutérium est choisi parmi un groupe $-CD_3$,$-CD_2(CD_3)$, $-CD(CD_3)_2$, $-C(CD_3)_3$, $-CD_2-C(CD_3)_3$, $-CD_2-CD(CD_3)_2$, $-CD_2-CD_2(CD_3)$, $-CD(CD_3)-C(CD_3)_3$, $-CD(CD_3)-CD(CD_3)_2$, $-CD(CD_3)-CD_2(CD_3)$, $-C(CD_3)_2-C(CD_3)_3$, $-C(CD_3)_2-CD(CD_3)_2$, $-C(CD_3)_2-CD_2(CD_3)$, et un groupe représenté par l'une des formules 11-1 à 11-41 :

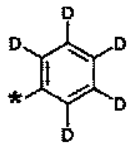

11-1

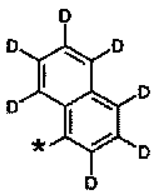

11-2

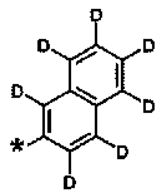

11-3

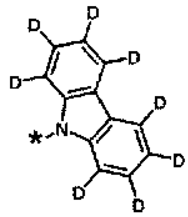

11-4

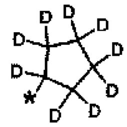

11-5

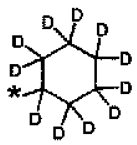

11-6

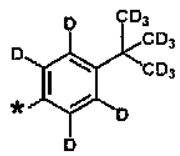

11-7

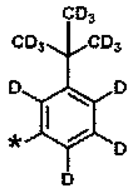

11-8

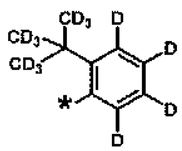

11-9

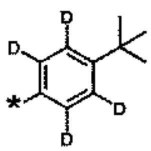

11-10

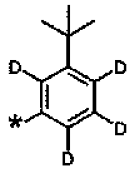

11-11

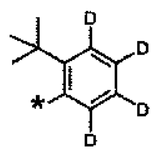

11-12

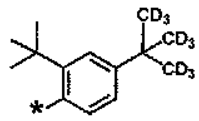

11-13

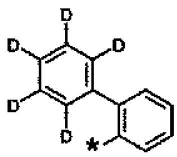

11-14

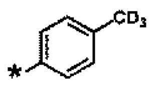

11-15

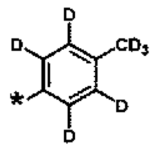

11-16

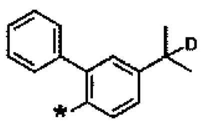

11-17

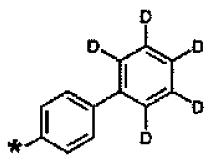

11-18

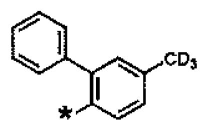

11-19

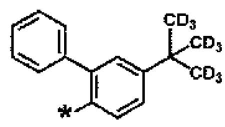

11-20

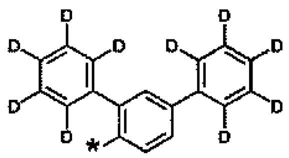

11-21

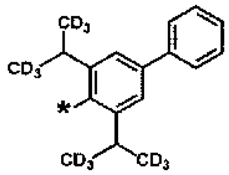

11-22

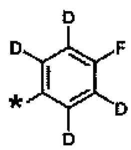

11-23

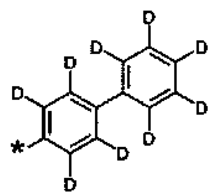

11-24

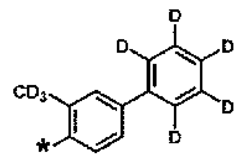

11-25

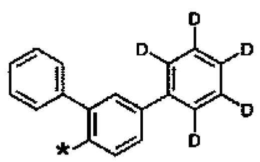

11-26

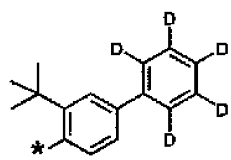

11-27

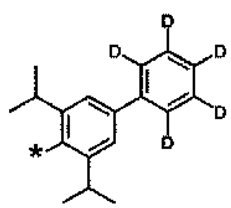

11-28

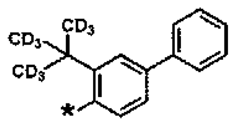

11-29

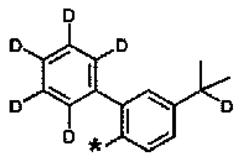

11-30

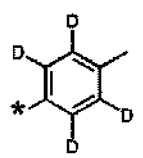

11-31

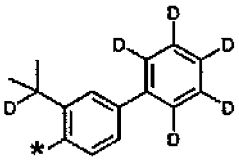

11-32

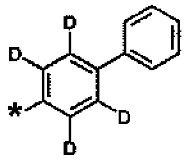

11-33

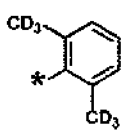

11-34

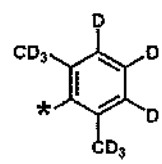

11-35

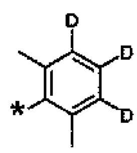

11-36

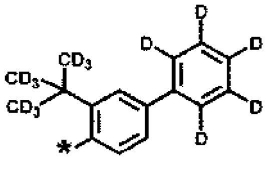

11-37

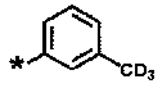

11-38

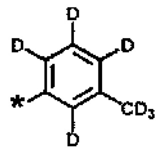

11-39

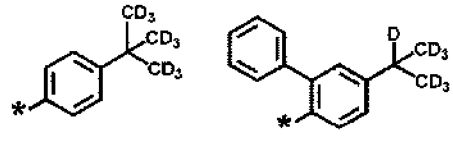

11-40

11-41

dans lesquelles * dans les formules 11-1 à 11-41 indique un site de liaison à un atome voisin.

**9.** Composé organométallique selon l'une quelconque des revendications 1 à 8, satisfaisant au moins l'une de la <Condition A> à la <Condition D> :

<Condition A>
n1 peut valoir 1, 2, 3 ou 4.
<Condition B>
$X_{51}$ peut représenter un groupe $N[(L_7)b_7\text{-}(R_7)c_7]$ et $R_7$ peut représenter un atome de deutérium ou un groupe contenant du deutérium.
<Condition C>
n3 peut valoir 1, 2 ou 3.
<Condition D>
n4 peut valoir 1, 2, 3 ou 4.

**10.** Composé organométallique selon l'une quelconque des revendications 1 à 9, un groupement représenté par

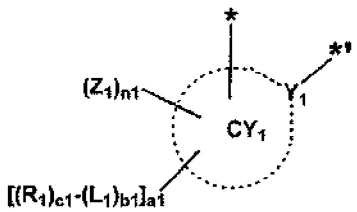

dans la formule 1 étant un groupe représenté par l'une des formules CY1-1 à CY1-40 :

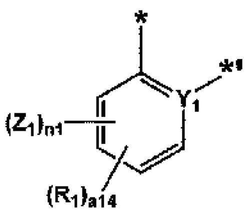
CY1-1

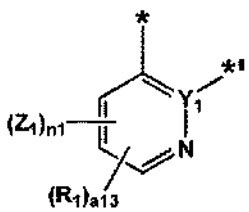
CY1-2

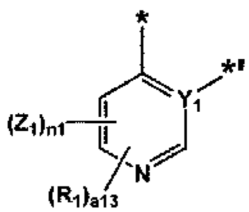
CY1-3

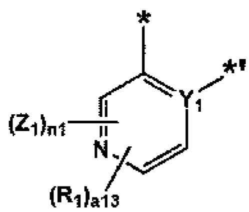
CY1-4

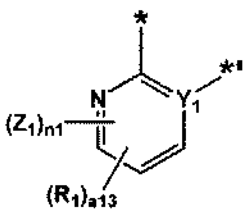
CY1-5

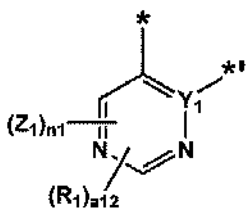
CY1-6

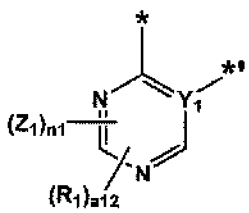
CY1-7

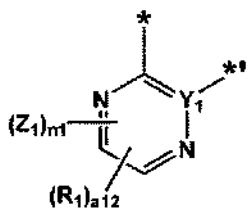
CY1-8

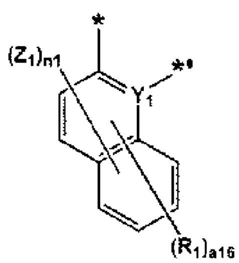
CY1-9

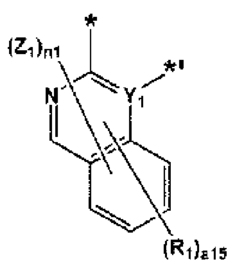
CY1-10

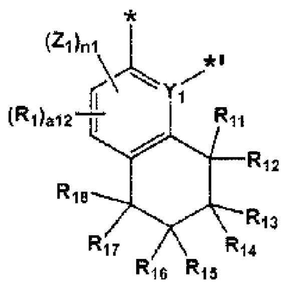
CY1-11

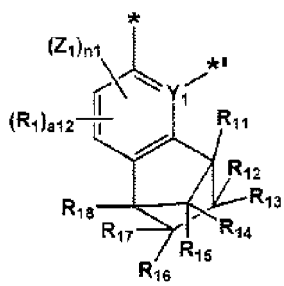
CY1-12

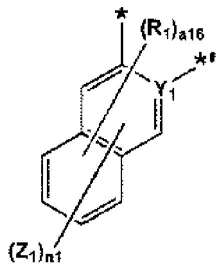
CY1-13

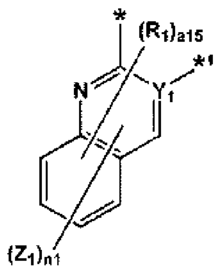
CY1-14

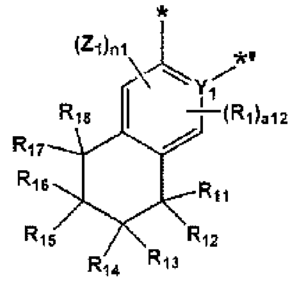
CY1-15

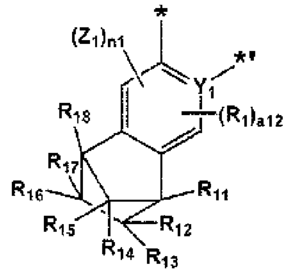
CY1-16

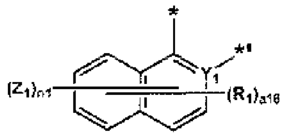
CY1-17

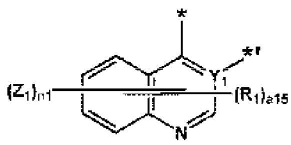
CY1-18

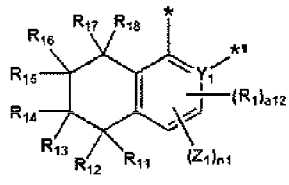
CY1-19

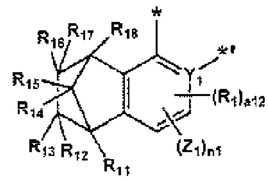
CY1-20

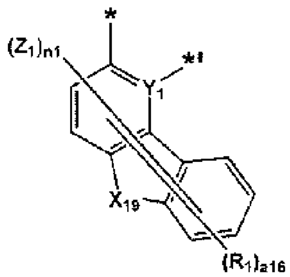
CY1-21

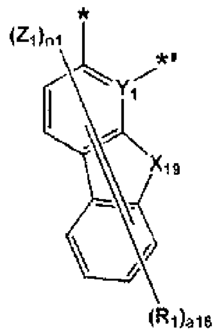
CY1-22

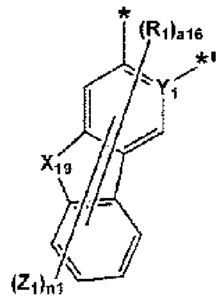
CY1-23

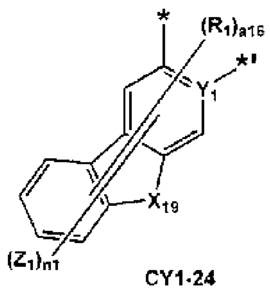
CY1-24

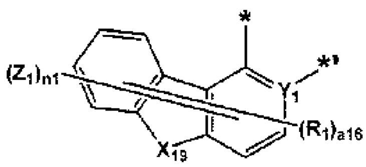
CY1-25

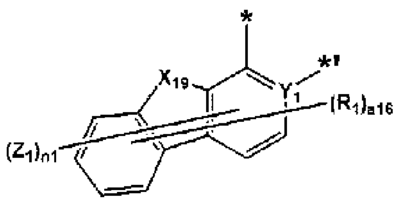
CY1-26

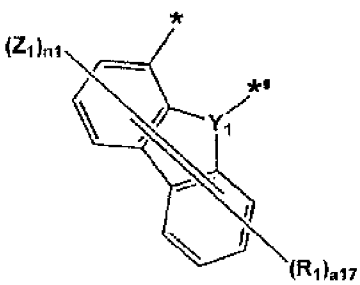
CY1-27

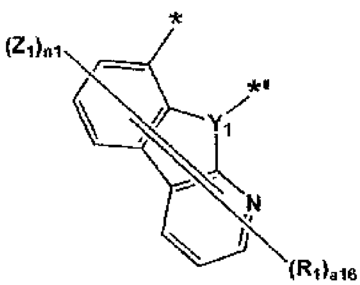
CY1-28

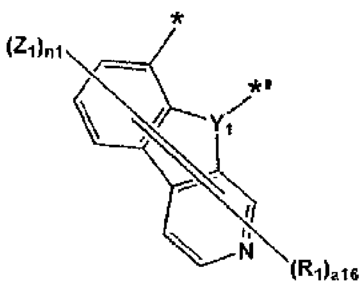
CY1-29

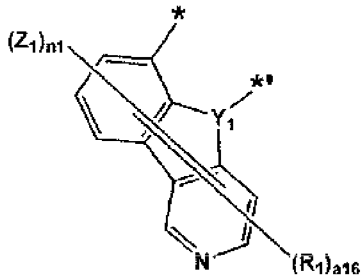
CY1-30

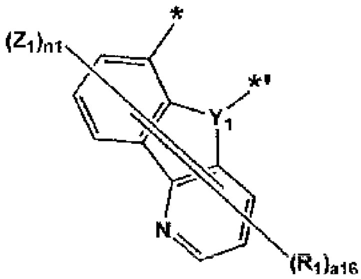
CY1-31

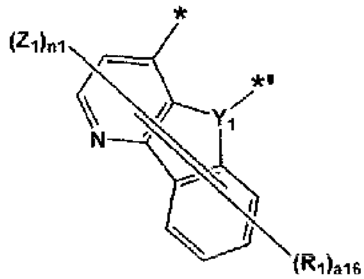
CY1-32

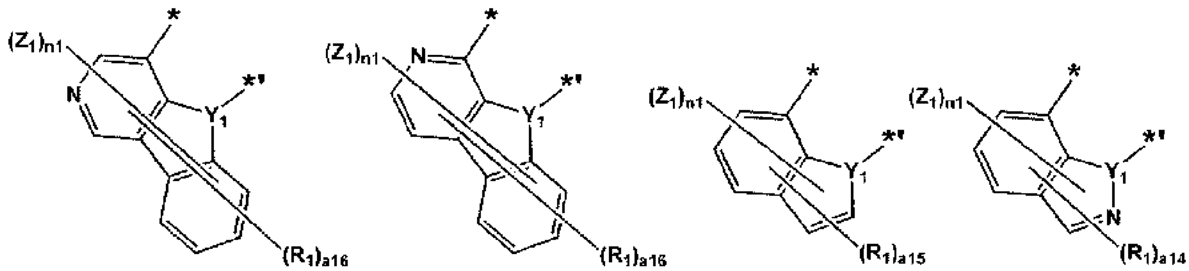
CY1-33 CY1-34 CY1-35 CY1-36

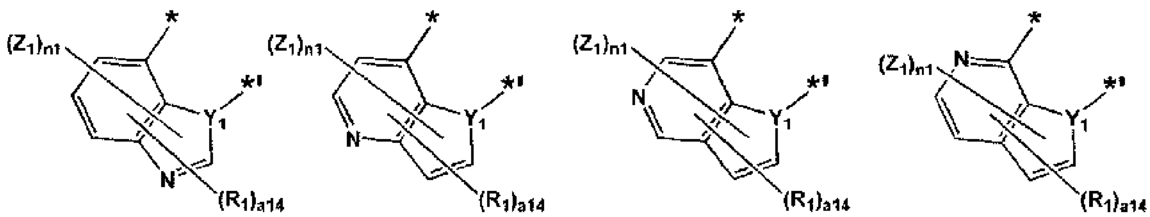
CY1-37 CY1-38 CY1-39 CY1-40

dans lesquelles, dans les formules CY1-1 à CY1-40,

$Y_1$, $R_1$, $Z_1$ et n1 sont les mêmes que décrits dans la revendication 1, et n1 représente un entier de 0 à 7,
$X_{19}$ représente un groupe $C(R_{19a})(R_{19b})$, $N[(L_{19})b_{19}$-$(R_{19})c_{19}]$, un atome O, S, ou un groupe $Si(R_{19a})(R_{19b})$,
$L_{19}$ est le même que décrit en relation avec $L_1$ dans la revendication 1,
b19 et c19 sont les mêmes que décrits en relation avec b1 et c1 dans la revendication 1,
$R_{11}$ à $R_{19}$, $R_{19a}$ et $R_{19b}$ sont les mêmes que décrits en relation avec $R_1$ dans la revendication,
a12 représente un entier de 0 à 2,
a13 représente un entier de 0 à 3,
a14 représente un entier de 0 à 4,
a15 représente un entier de 0 à 5,
a16 représente un entier de 0 à 6,
a17 représente un entier de 0 à 7,
*' indique un site de liaison à $X_1$ ou M dans la formule 1, et * indique un site de liaison à $T_1$ dans la formule 1 ; et/ou un groupement représenté par

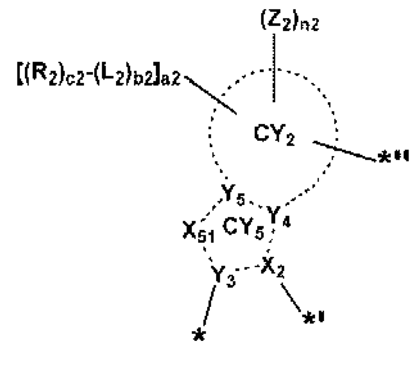

dans la formule 1 étant un groupe représenté par l'une des formules CY2-1 à CY2-20 :

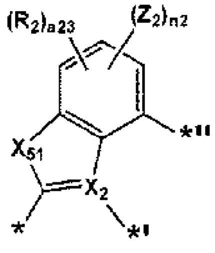
CY2-1

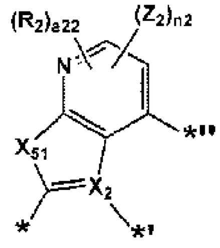
CY2-2

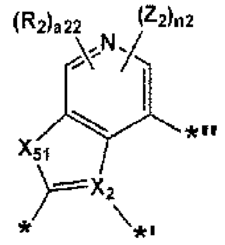
CY2-3

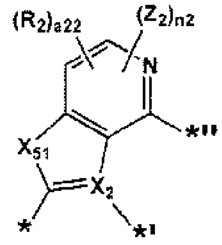
CY2-4

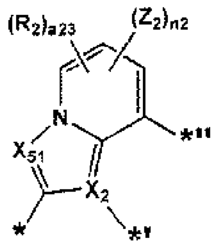
CY2-5

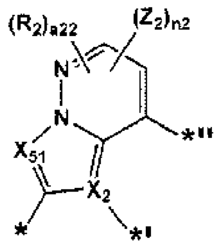
CY2-6

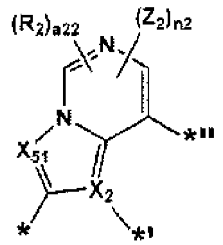
CY2-7

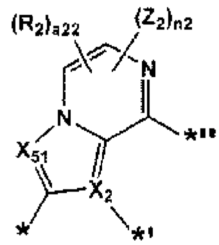
CY2-8

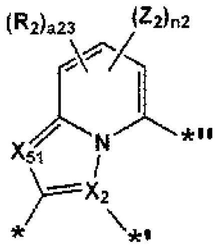
CY2-9

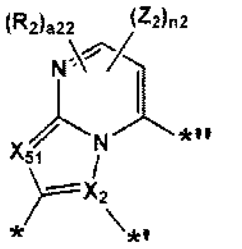
CY2-10

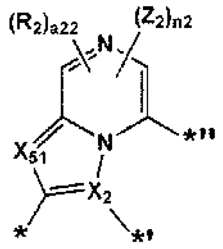
CY2-11

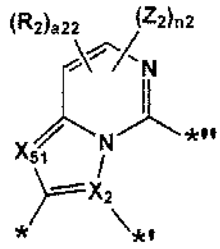
CY2-12

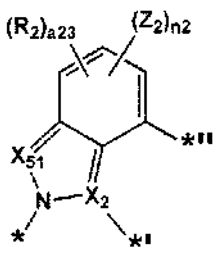
CY2-13

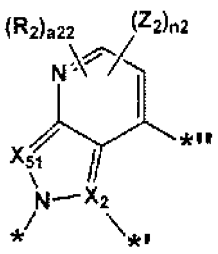
CY2-14

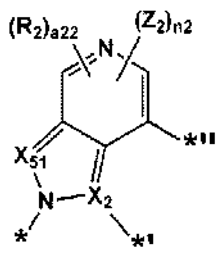
CY2-15

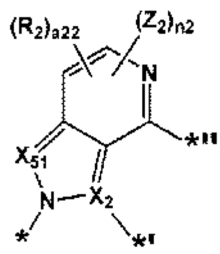
CY2-16

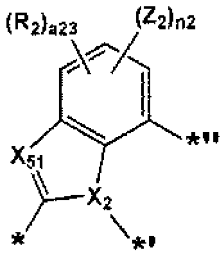
CY2-17

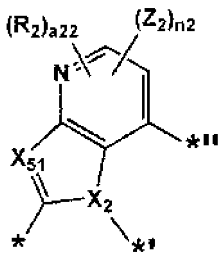
CY2-18

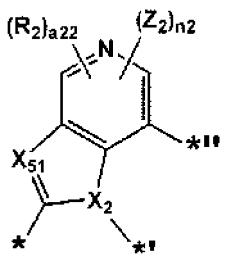
CY2-19

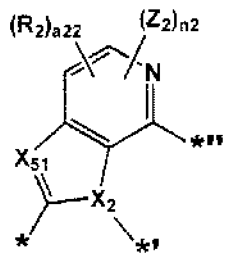
CY2-20

dans lesquelles, dans les formules CY2-1 à CY2-20,

$X_2$, $R_2$, $Z_2$ et n2 sont les mêmes que décrits dans la revendication 1, et n2 représente un entier de 0 à 3,
$X_{51}$ dans les formules CY2-1 à CY2-4 représente un atome O, S, un groupe N-[$(L_7)b_7$-$(R_7)c_7$], $C(R_7)(R_8)$, $Si(R_7)(R_8)$, $Ge(R_7)(R_8)$ ou C(=O),
$X_{51}$ dans les formules CY2-5 à CY2-20 représente un atome N, un groupe $C(R_7)$, $Si(R_7)$, ou $Ge(R_7)$,
$L_7$, b7, $R_7$ et c7 sont les mêmes que décrits en relation avec la revendication 1,
a22 représente un entier de 0 à 2,
a23 représente un entier de 0 à 3,
* indique un site de liaison à $T_1$ dans la formule 1,
*' indique un site de liaison à M dans la formule 1, et
*" indique un site de liaison à un noyau $CY_3$ dans la formule 1.

**11.** Composé organométallique selon l'une quelconque des revendications 1 à 10, un groupement représenté par

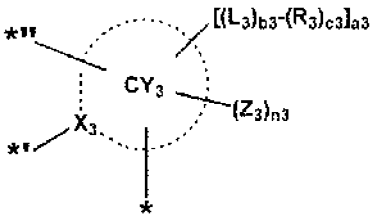

dans la formule 1 étant un groupe représenté par l'une des formules CY3-1 à CY3-12 :

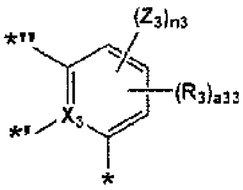
CY3-1

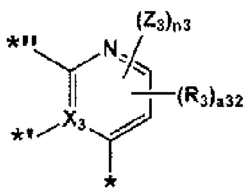
CY3-2

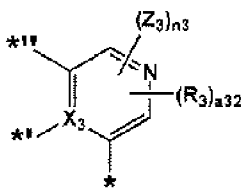
CY3-3

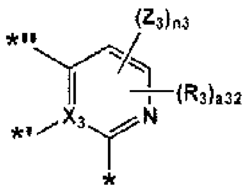
CY3-4

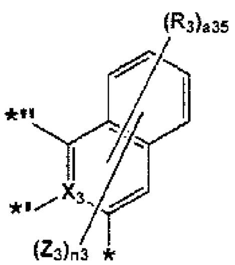
CY3-5

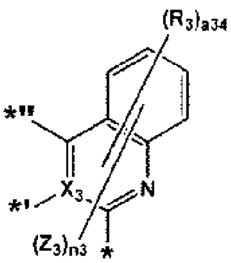
CY3-6

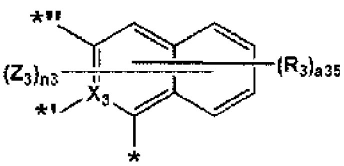
CY3-7

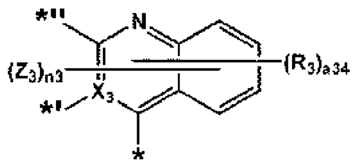
CY3-8

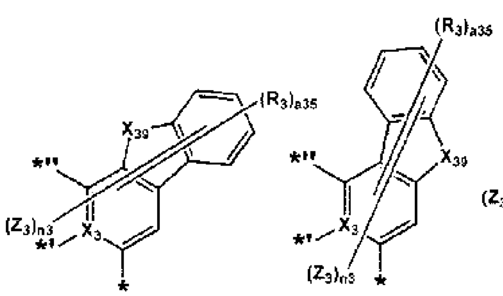
CY3-9 CY3-10

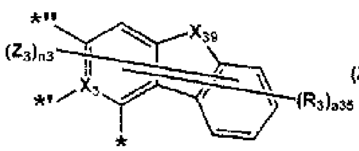
CY3-11

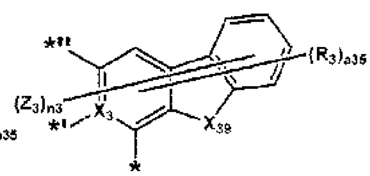
CY3-12

dans lesquelles, dans les formules CY3-1 à CY3-12,

$X_3$, $R_3$, $Z_3$ et n3 sont les mêmes que décrits en relation avec la revendication 1 et n3 représente un entier de 0 à 5,
X39 représente un groupe $C(R_{39a})(R_{39b})$, N[$(L_{39})_{b39}$-$(R_{39})c_{39}$], un atome O, S ou un groupe $Si(R_{39a})(R_{39b})$,

$L_{39}$ est le même qu'expliqué en relation avec $L_3$ dans la revendication 1, b39 et c39 sont les mêmes que décrits en relation avec b3 et c3 dans la revendication 1, respectivement,
$R_{39a}$ et $R_{39b}$ sont les mêmes que décrits en relation avec $R_3$ dans la revendication 1,
a32 représente un entier de 0 à 2,
a33 représente un entier de 0 à 3,
a34 représente un entier de 0 à 4,
a35 représente un entier de 0 à 5,
* indique un site de liaison à $T_2$ dans la formule 1,
*' indique un site de liaison à M dans la formule 1, et
*" indique un site de liaison au noyau $CY_2$ dans la formule 1 ; et/ou
un groupement représenté par

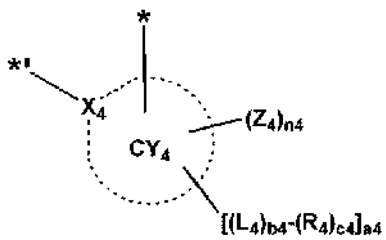

dans la formule 1 est un groupe représenté par l'une des formules CY4-1 à CY4-26 :

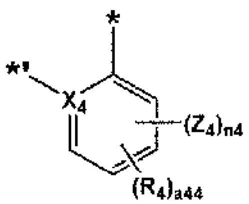
CY4-1

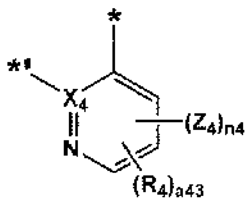
CY4-2

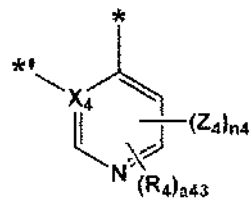
CY4-3

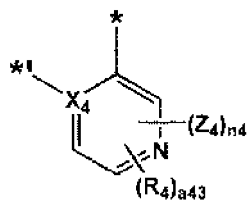
CY4-4

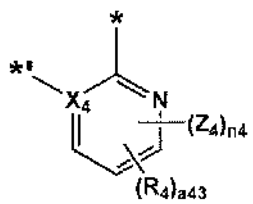
CY4-5

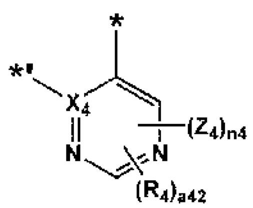
CY4-6

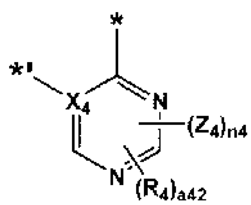
CY4-7

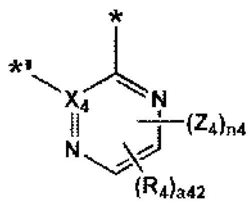
CY4-8

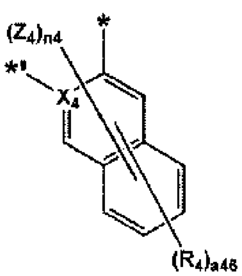
CY4-9

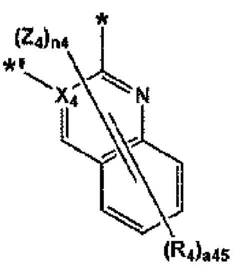
CY4-10

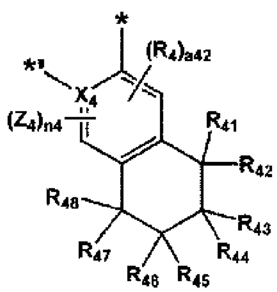
CY4-11

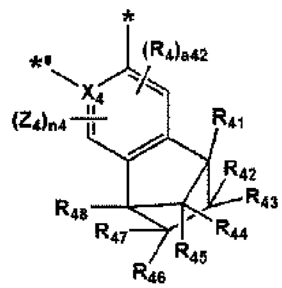
CY4-12

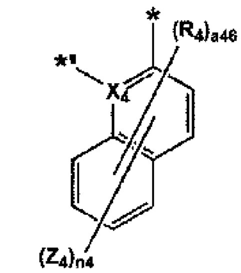

CY4-13

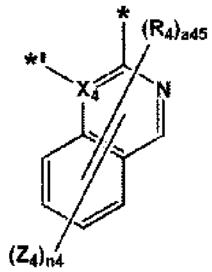

CY4-14

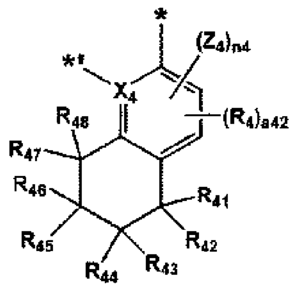

CY4-15

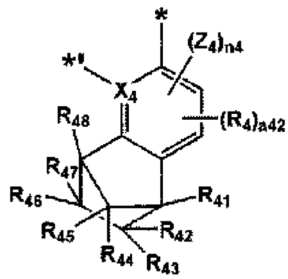

CY4-16

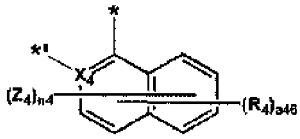

CY4-17

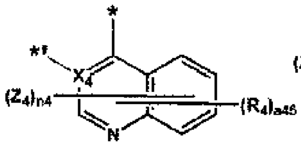

CY4-18

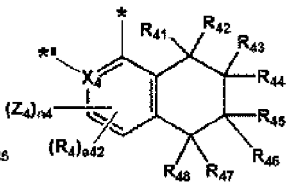

CY4-19

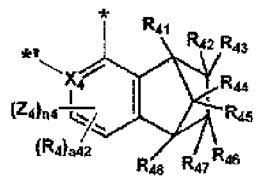

CY4-20

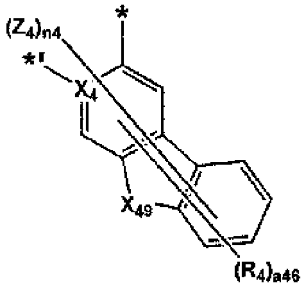

CY4-21

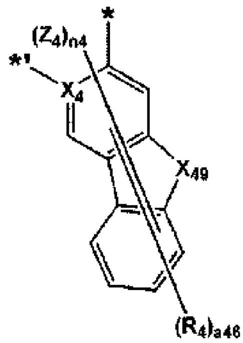

CY4-22

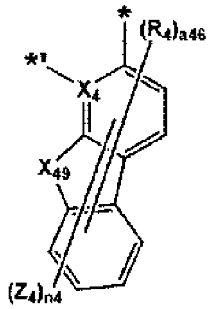

CY4-23

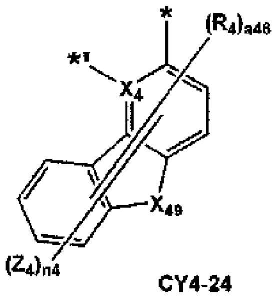

CY4-24

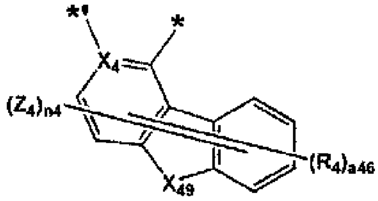

CY4-25

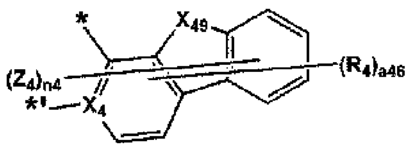

CY4-26

dans lesquelles, dans les formules CY4-1 à CY4-26,

$X_4$, $R_4$, $Z_4$ et n4 sont les mêmes que décrits en relation avec la revendication 1 et n4 représente un entier de 0 à 6,

X49 représente un groupe $C(R_{49a})(R_{49b})$, $N[(L_{49})_{b49}\text{-}(R_{49})c_{49}]$, un atome O, S, ou un groupe $Si(R_{49a})(R_{49b})$,

$L_{49}$ est le même que décrit en relation avec $L_4$ dans la revendication 1, b49 e c49 sont les mêmes que décrits en relation avec b4 et c4 dans la revendication 1, respectivement,

$R_{41}$ à $R_{49}$, $R_{49a}$ et $R_{49b}$ sont les mêmes que décrits en relation avec $R_4$ dans la revendication 1, respectivement,

a42 représente un entier de 0 à 2,

a43 représente un entier de 0 à 3,

a44 représente un entier de 0 à 4,

a45 représente un entier de 0 à 5,

a46 représente un entier de 0 à 6,

* indique un site de liaison à $T_2$ dans la formule 1, et

*' indique un site de liaison à M dans la formule 1.

12. Composé organométallique selon la revendication 1, ledit composé organométallique étant l'un des composés 1 à 666 ci-dessous :

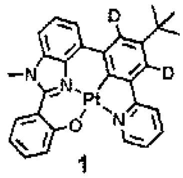
1

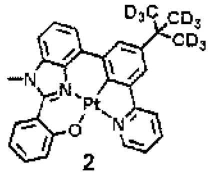
2

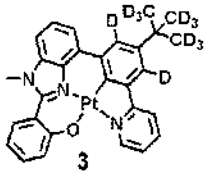
3

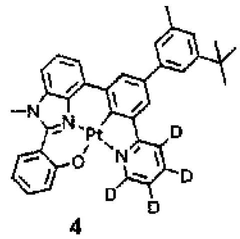
4

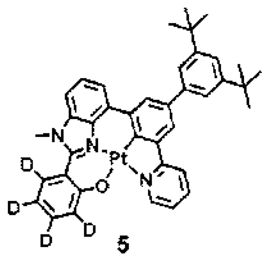
5

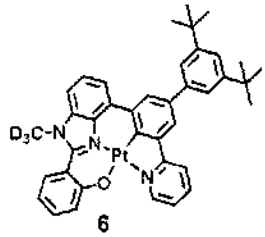
6

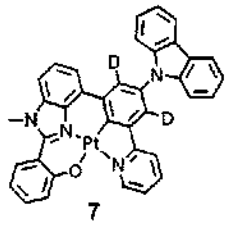
7

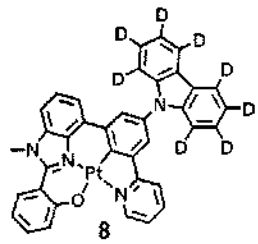
8

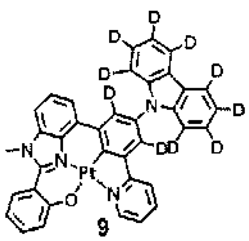
9

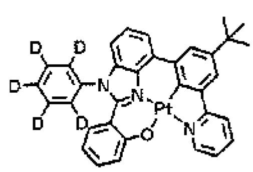
10

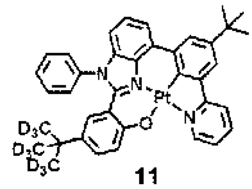
11

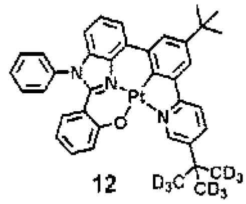
12

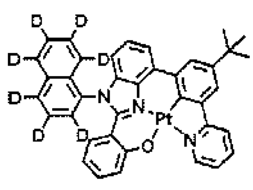
13

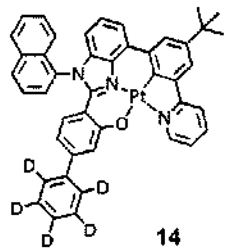
14

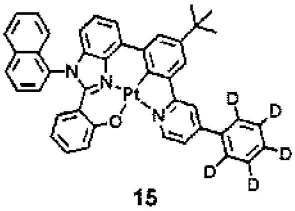
15

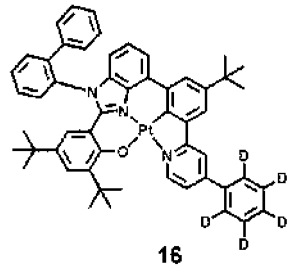
16

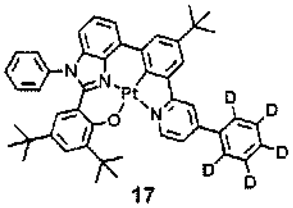
17

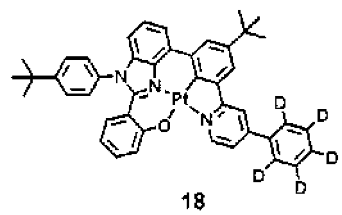
18

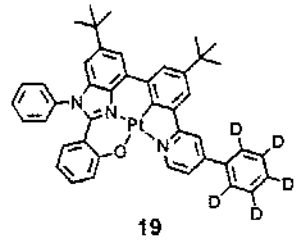
19

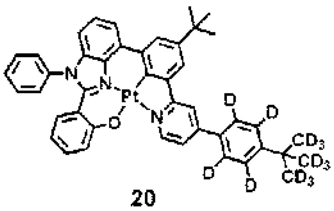
20

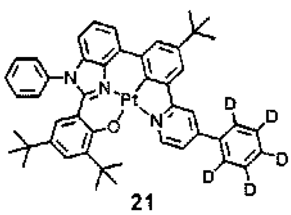
21

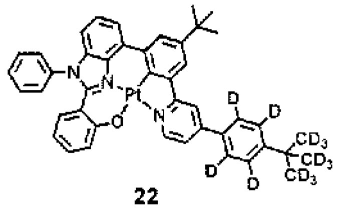
22

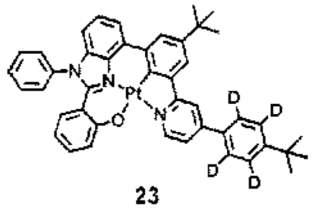
23

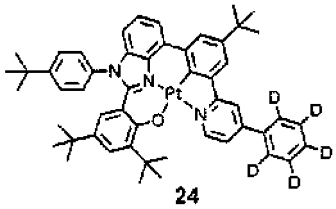
24

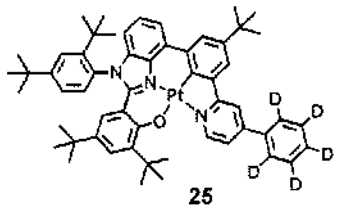
25

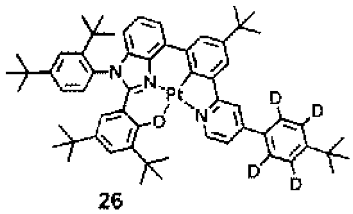
26

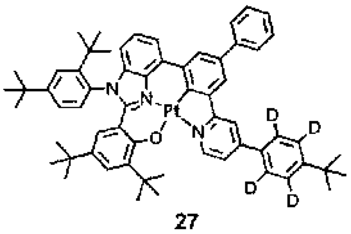
27

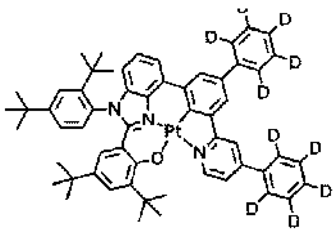
28

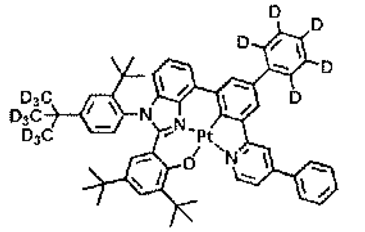
29

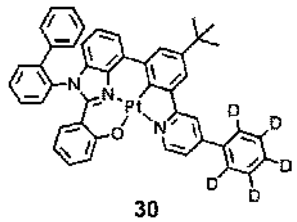
30

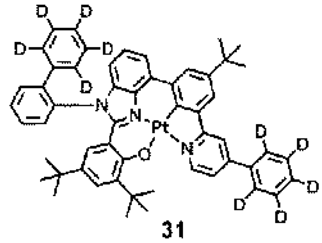
31

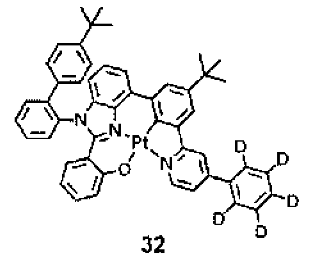
32

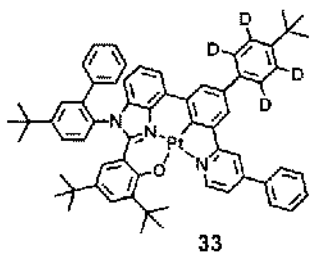
33

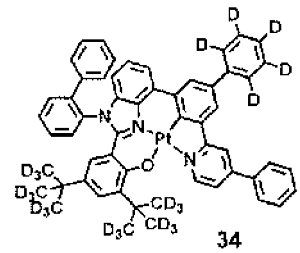
34

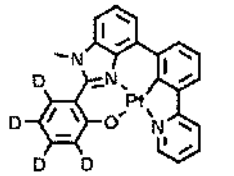
35

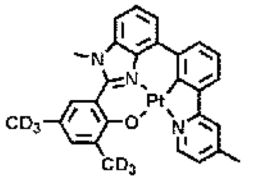
36

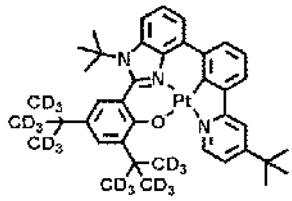
37

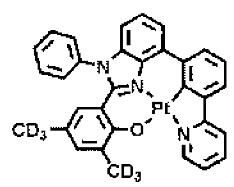
38

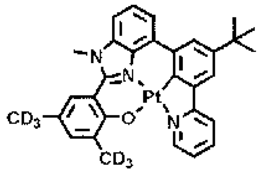
39

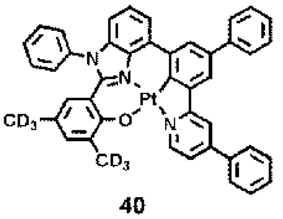
40

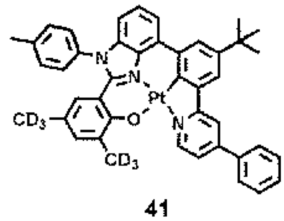
41

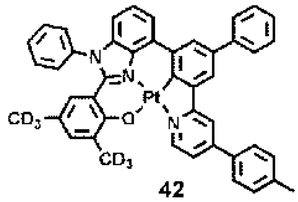
42

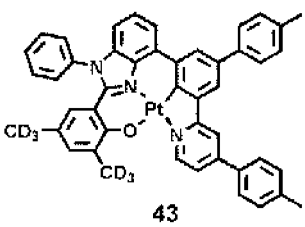
43

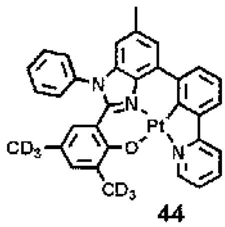
44

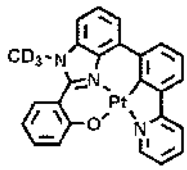
45

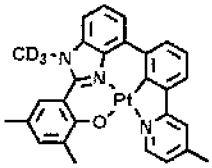
46

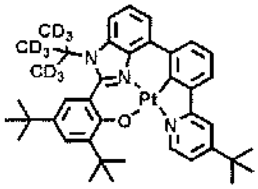
47

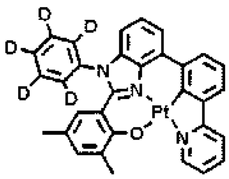
48

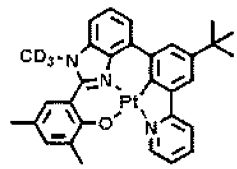
49

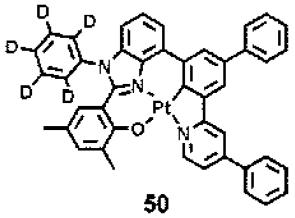
50

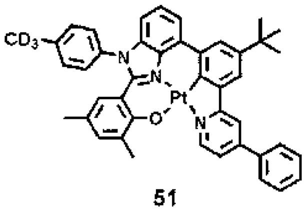
51

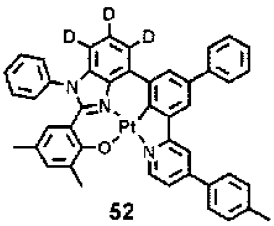
52

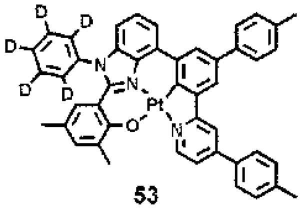
53

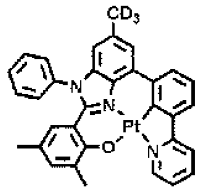
54

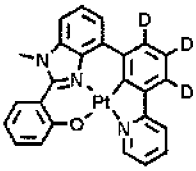
55

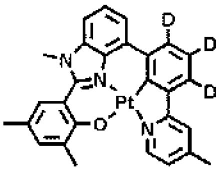
56

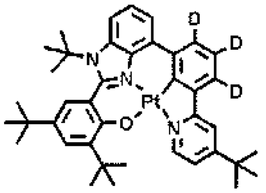
57

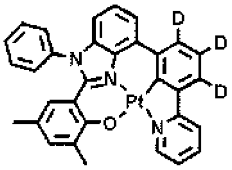
58

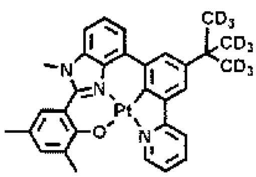
59

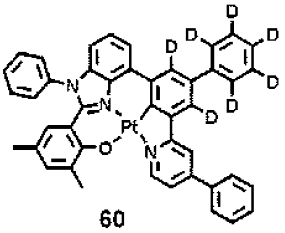
60

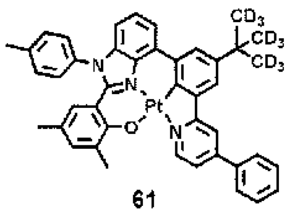
61

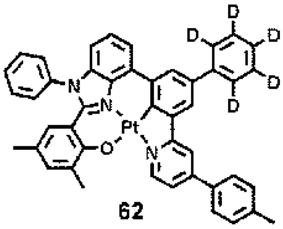
62

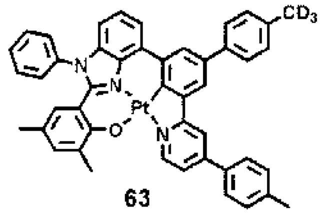
63

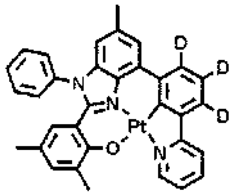
64

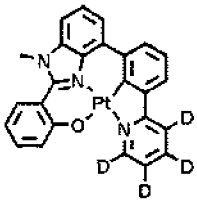
65

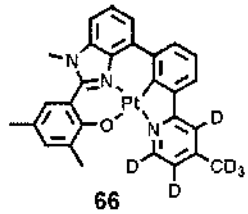
66

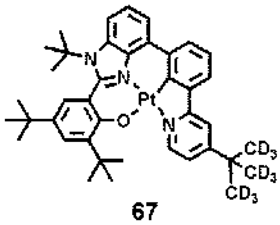
67

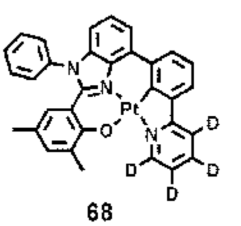
68

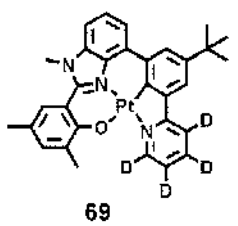
69

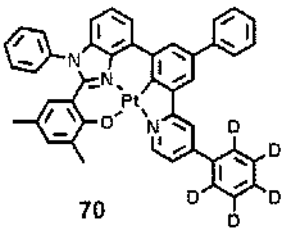
70

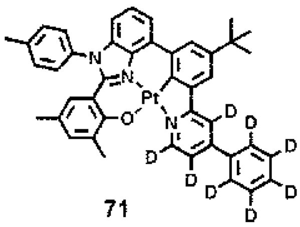
71

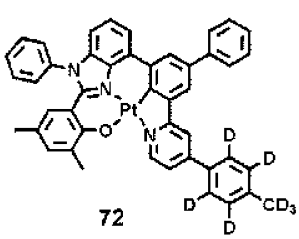
72

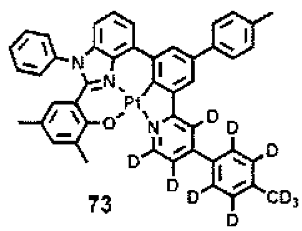
73

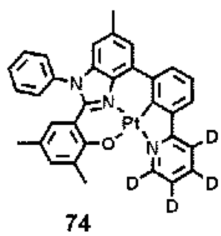
74

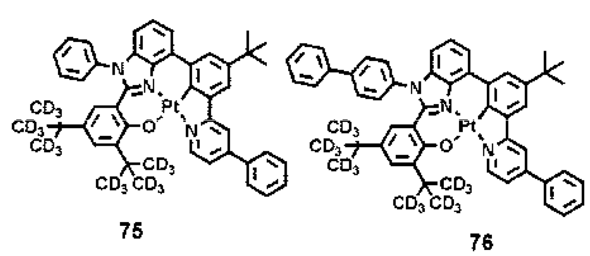
75

76

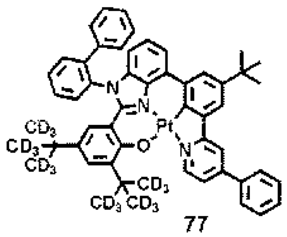
77

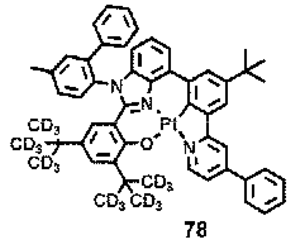
78

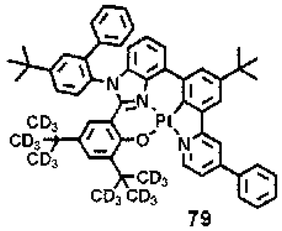
79

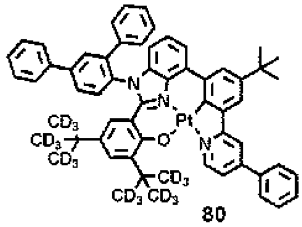
80

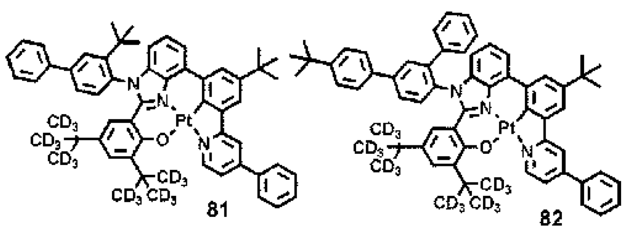
81

82

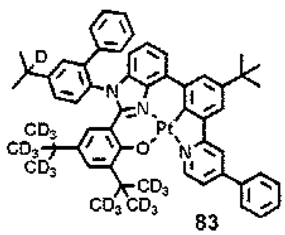
83

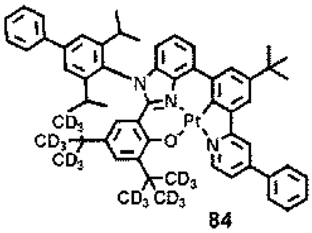
84

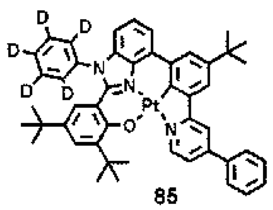
85

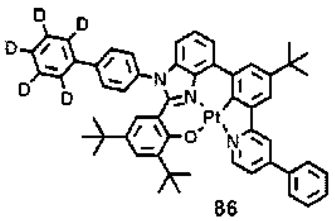
86

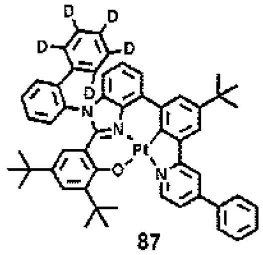
87

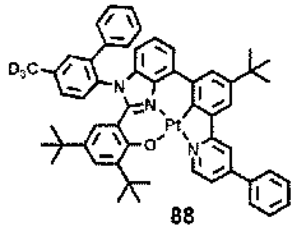
88

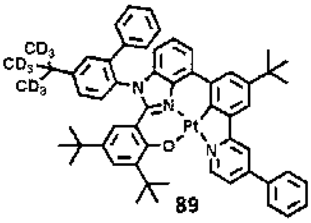
89

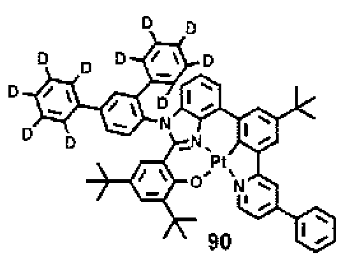
90

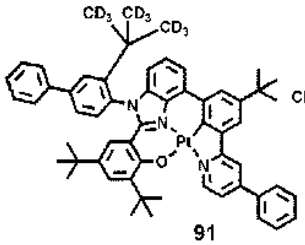
91

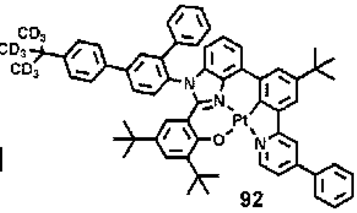
92

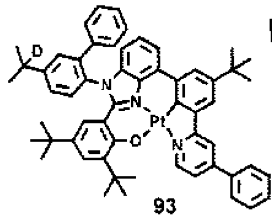
93

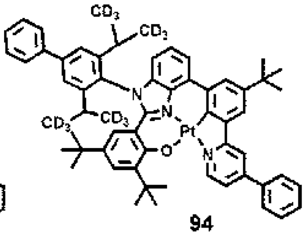
94

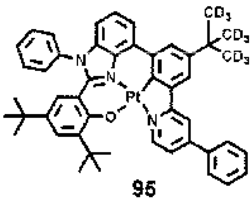
95

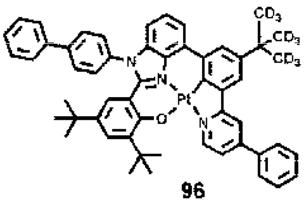
96

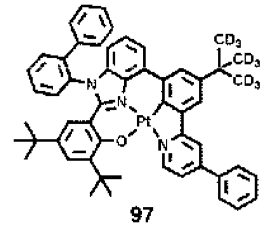
97

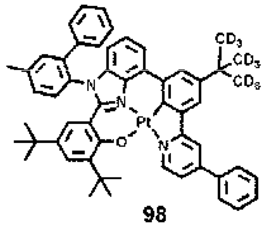
98

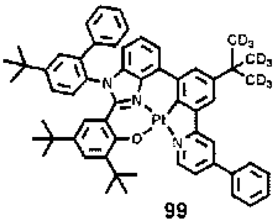
99

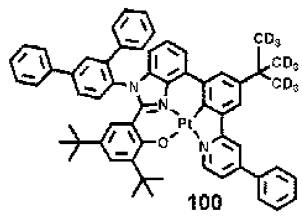
100

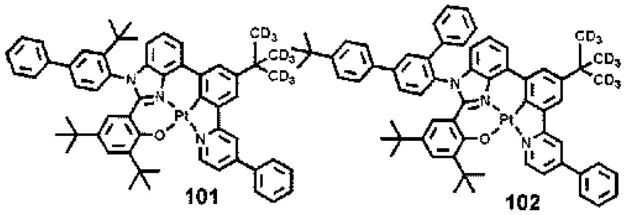
101

102

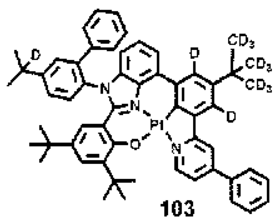
103

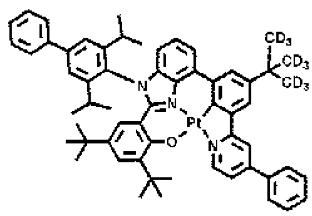

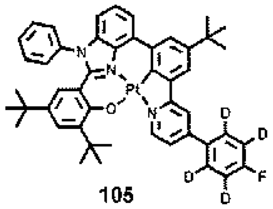
105

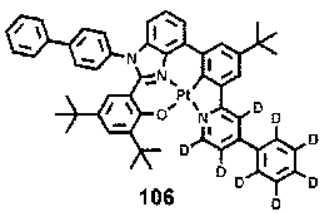
106

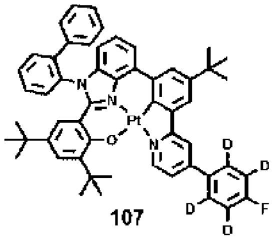
107

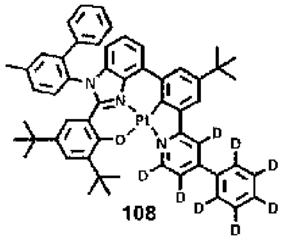
108

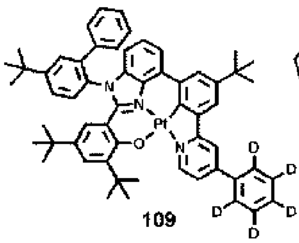
109

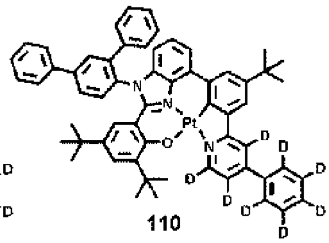
110

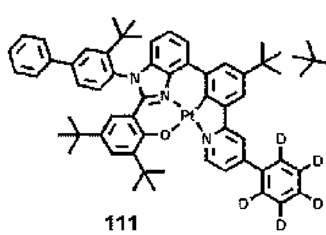
111

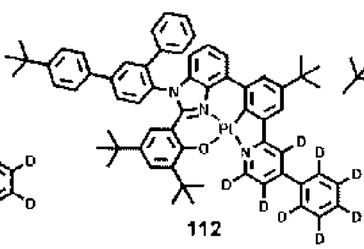
112

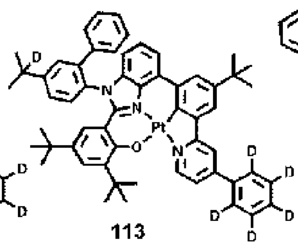
113

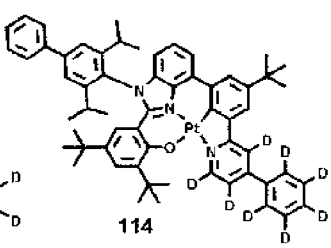
114

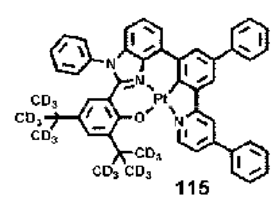
115

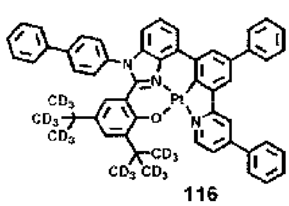
116

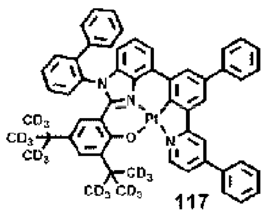
117

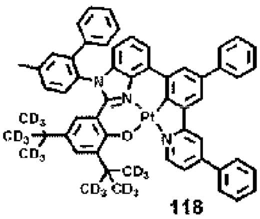
118

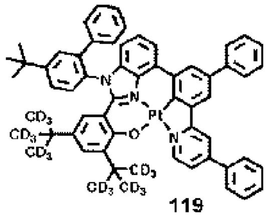
119

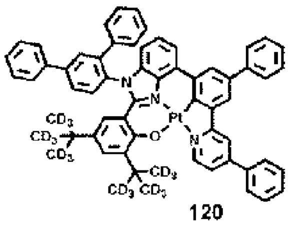
120

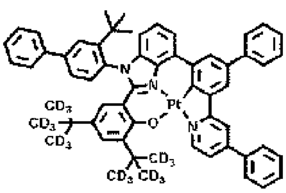
121

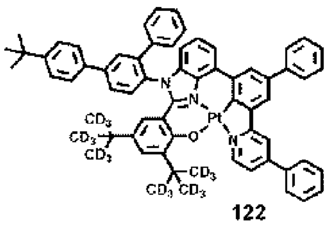
122

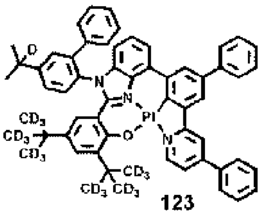
123

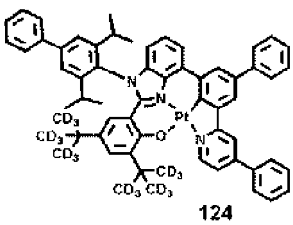
124

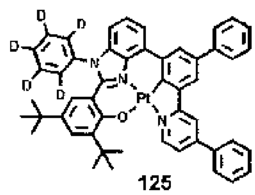
125

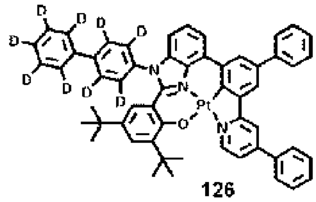
126

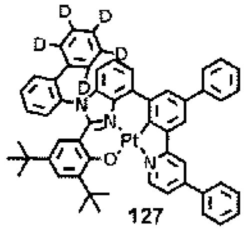
127

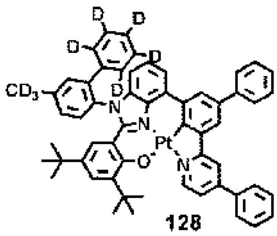
128

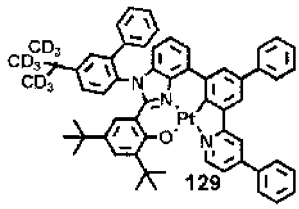
129

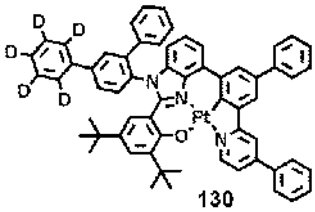
130

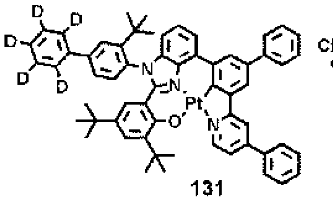
131

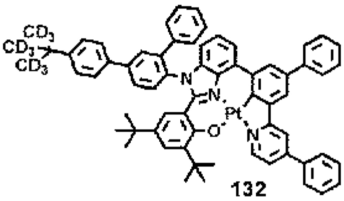
132

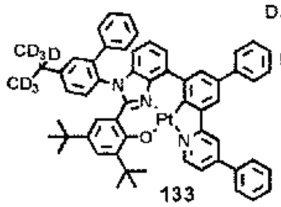
133

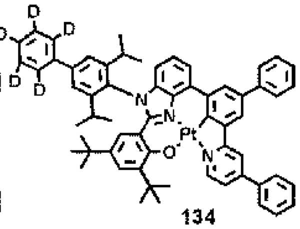
134

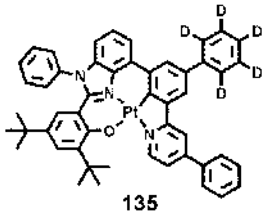
135

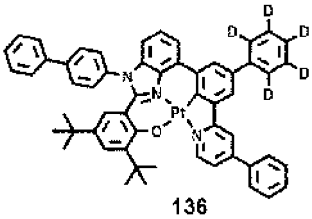
136

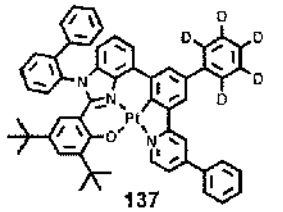
137

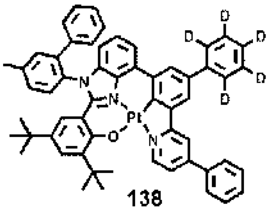
138

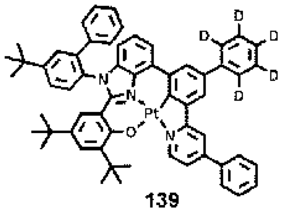
139
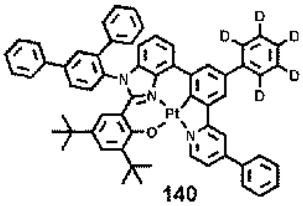
140
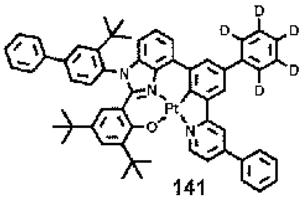
141
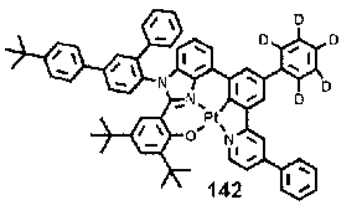
142
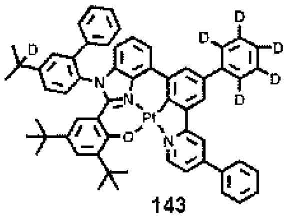
143
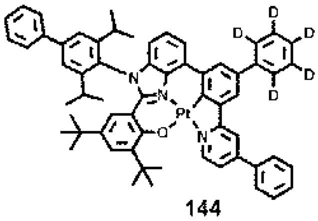
144
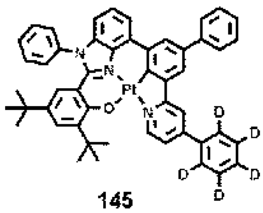
145
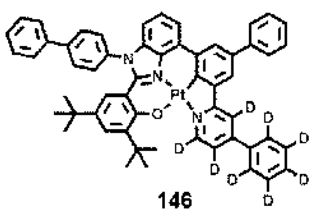
146
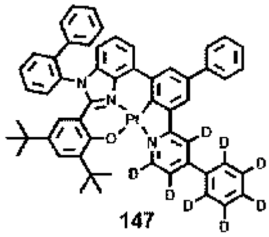
147
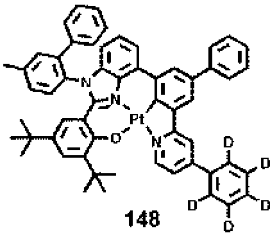
148
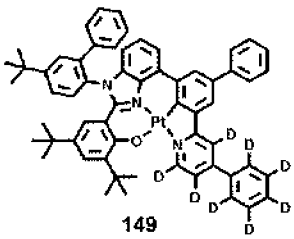
149
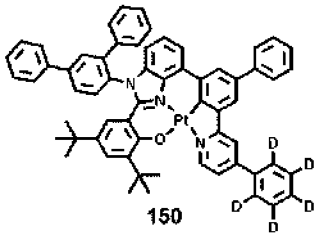
150
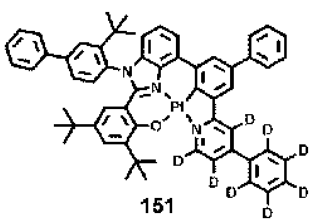
151
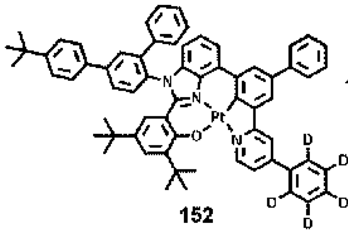
152
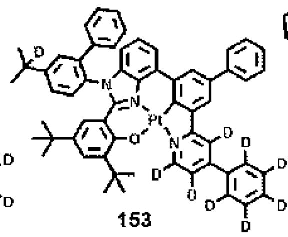
153
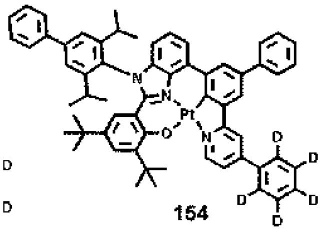
154
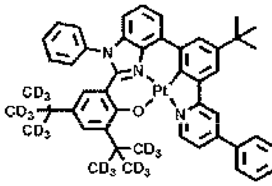
155
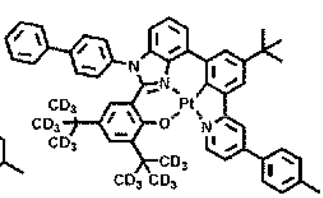
156
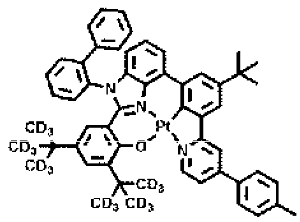
157
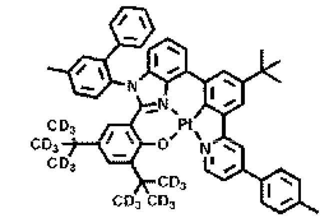
158
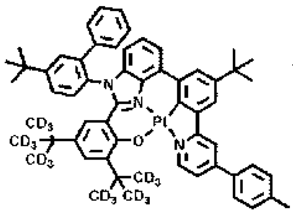
159
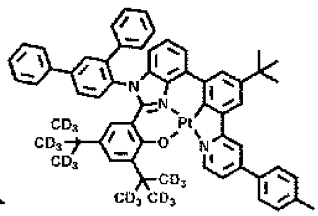
160
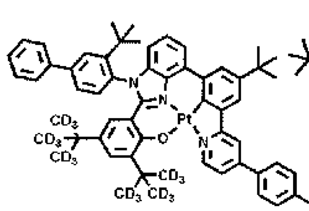
161
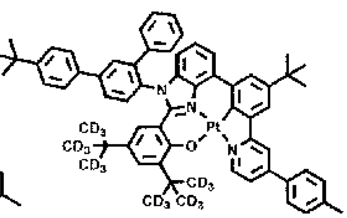
162

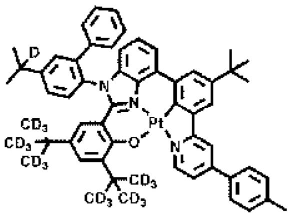
163
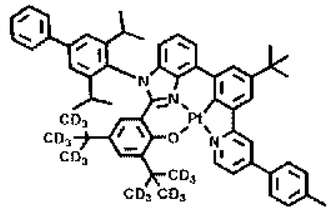
164
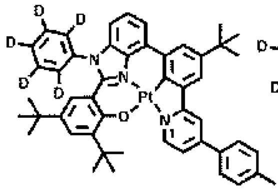
165
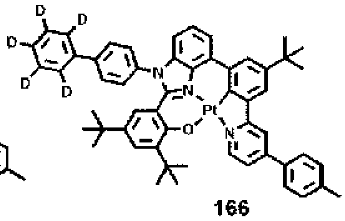
166

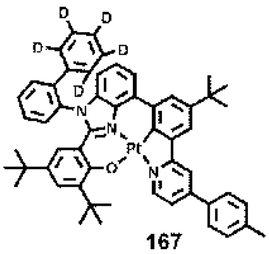
167
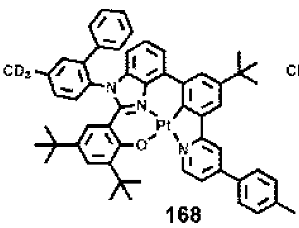
168
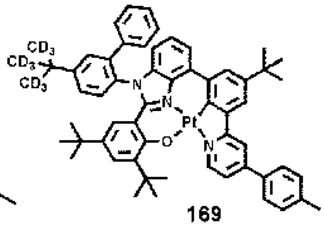
169
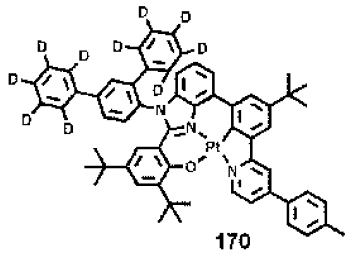
170

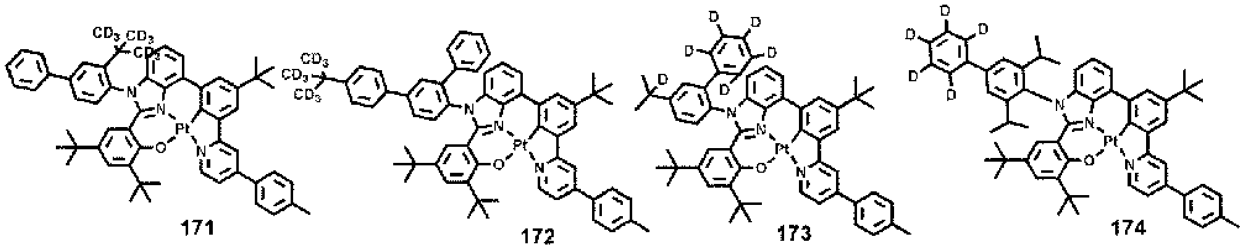
171

172

173

174

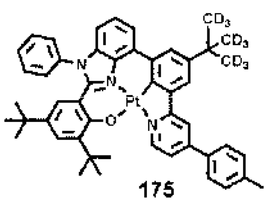
175
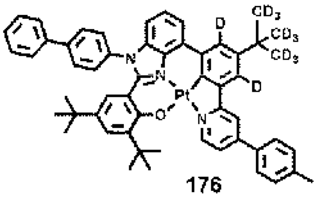
176
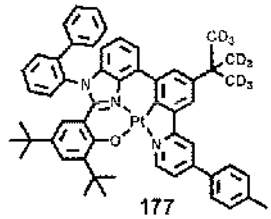
177
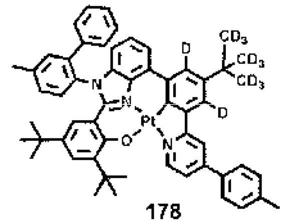
178

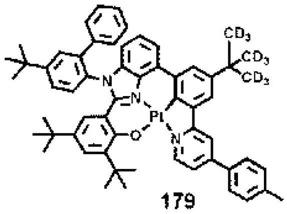
179
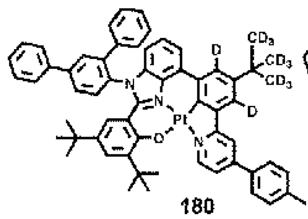
180
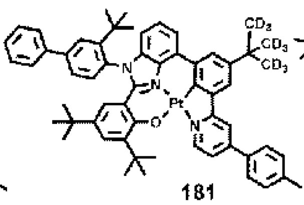
181
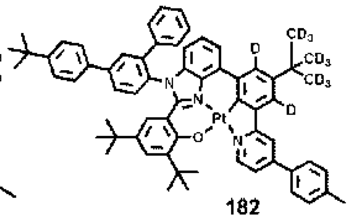
182

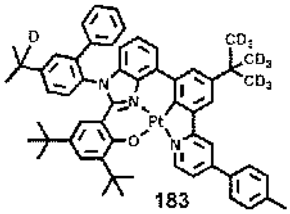
183
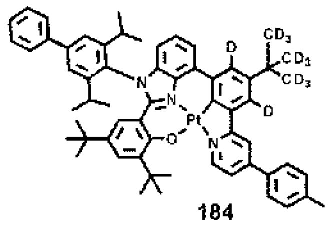
184
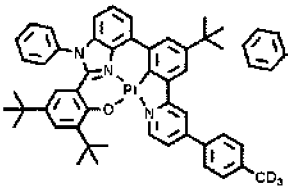
185
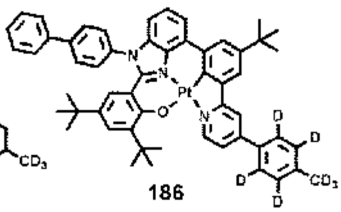
186

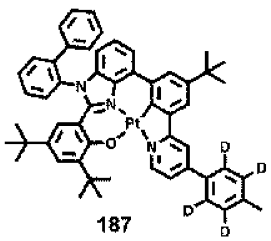

187

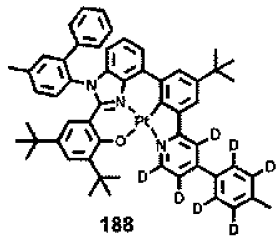

188

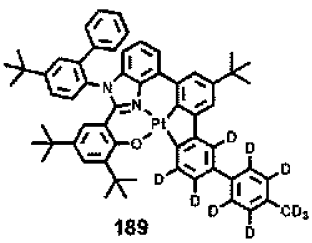

189

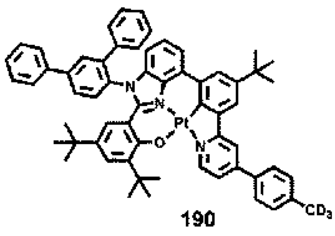

190

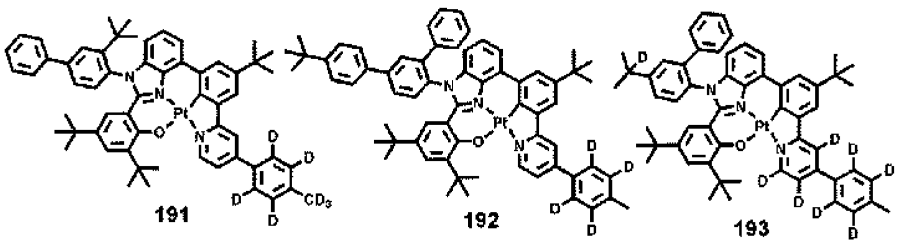

191

192

193

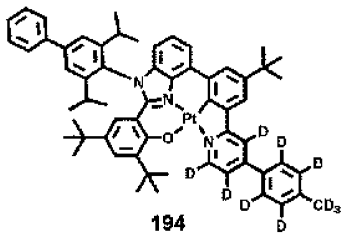

194

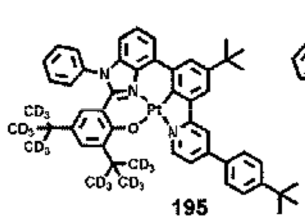

195

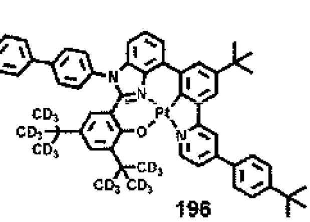

196

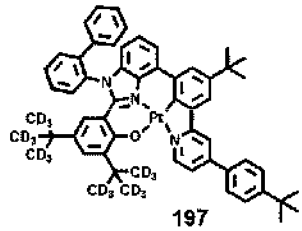

197

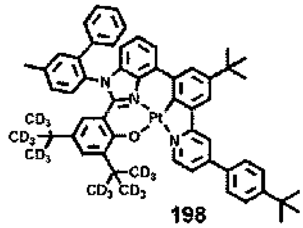

198

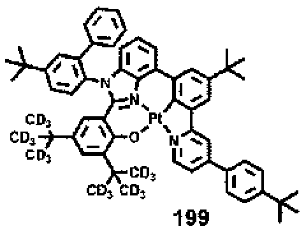

199

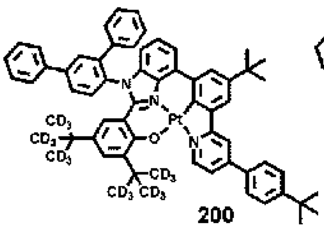

200

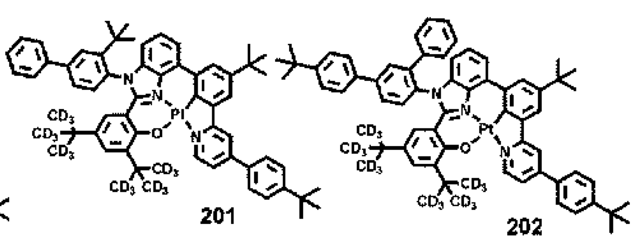

201

202

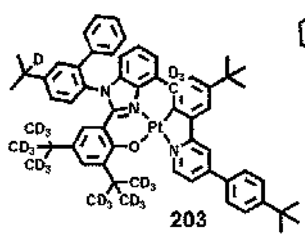

203

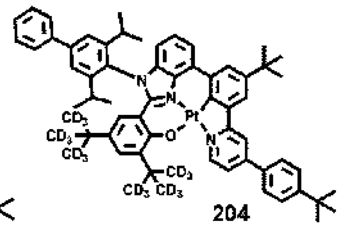

204

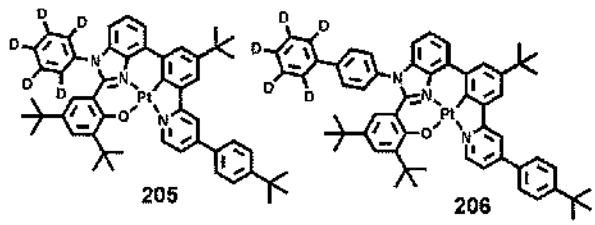

205

206

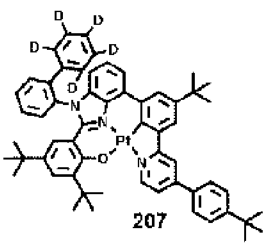

207

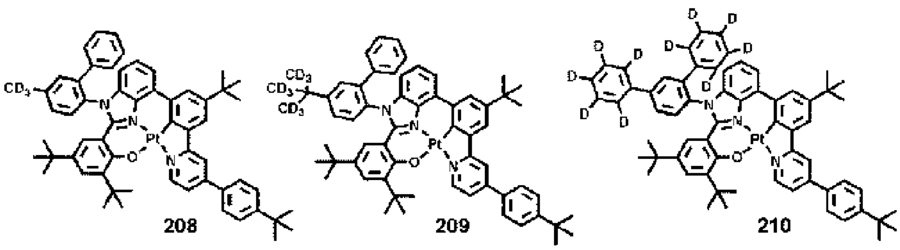

208

209

210

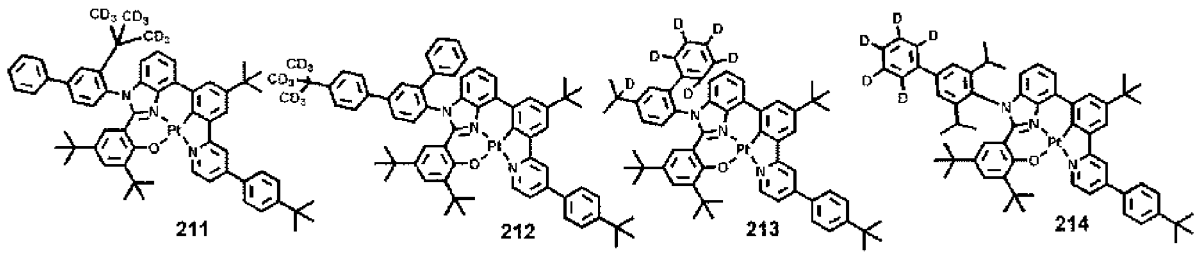

211 212 213 214

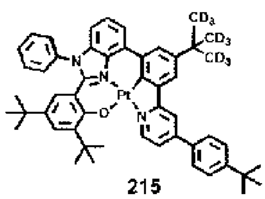

215

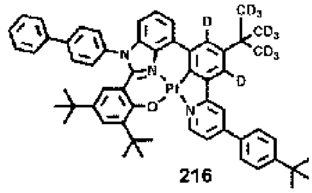

216

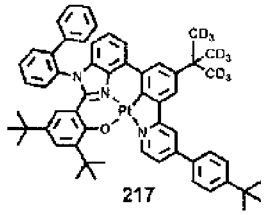

217

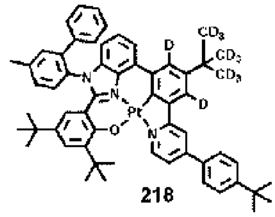

218

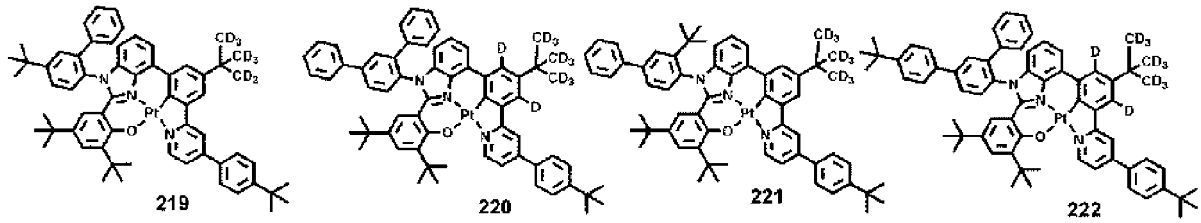

219 220 221 222

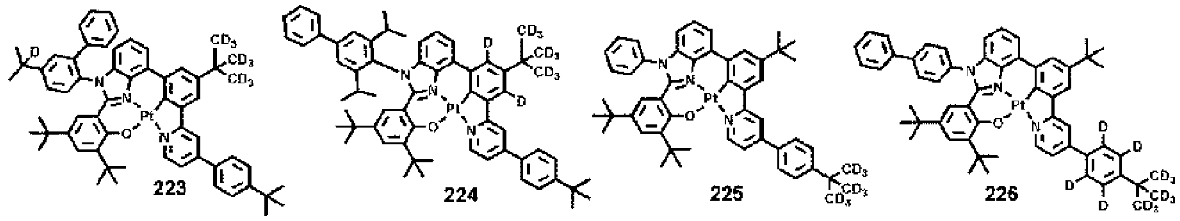

223 224 225 226

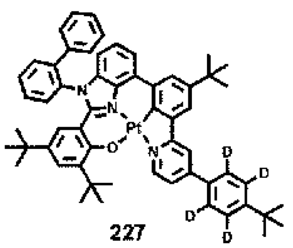

227

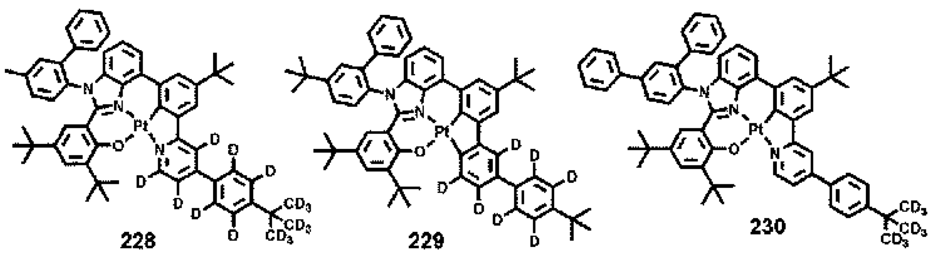

228 229 230

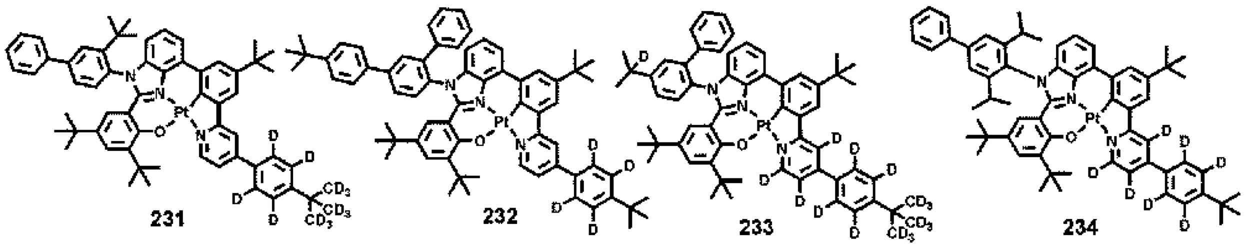

231 232 233 234

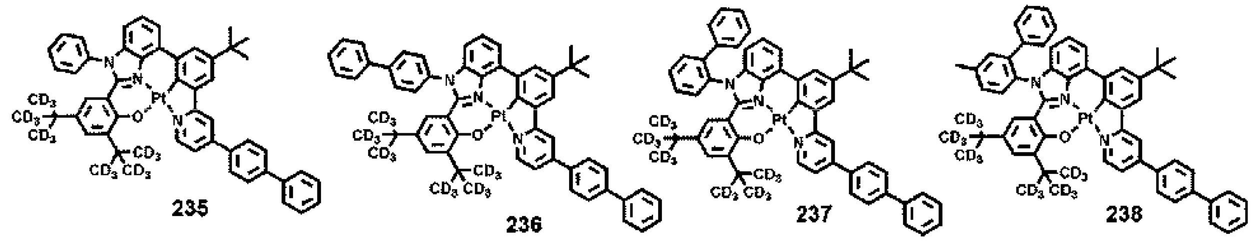

235 236 237 238

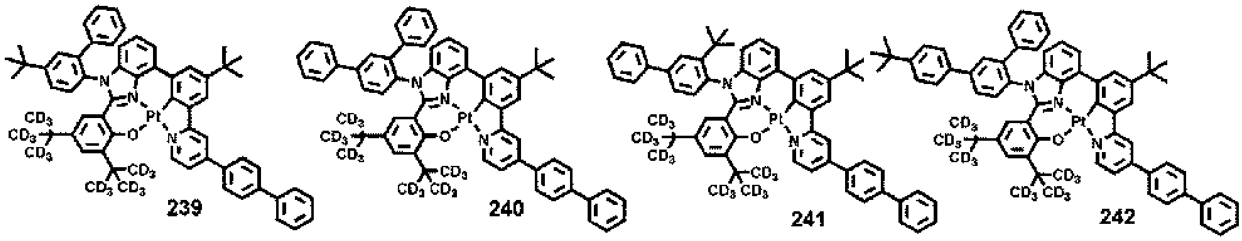

239 240 241 242

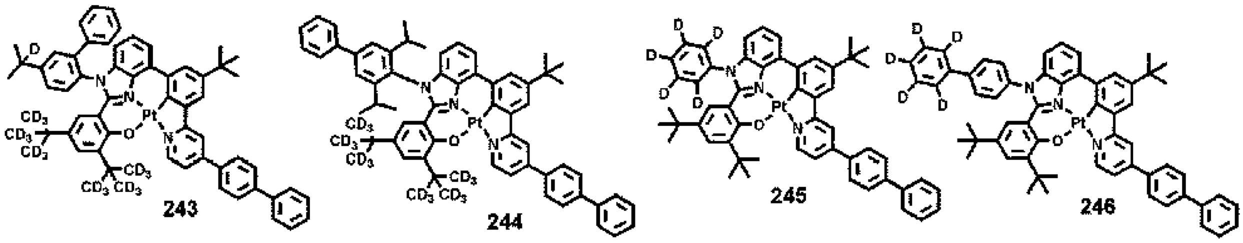

243 244 245 246

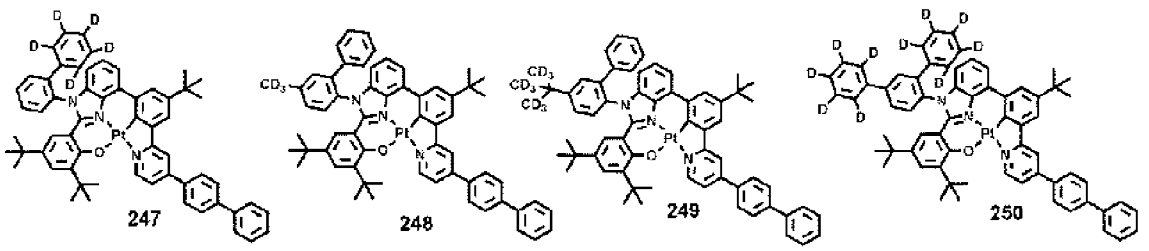

247 248 249 250

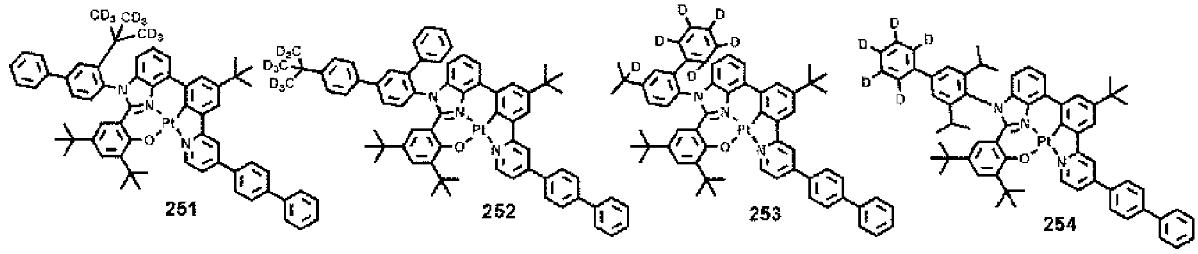

251 252 253 254

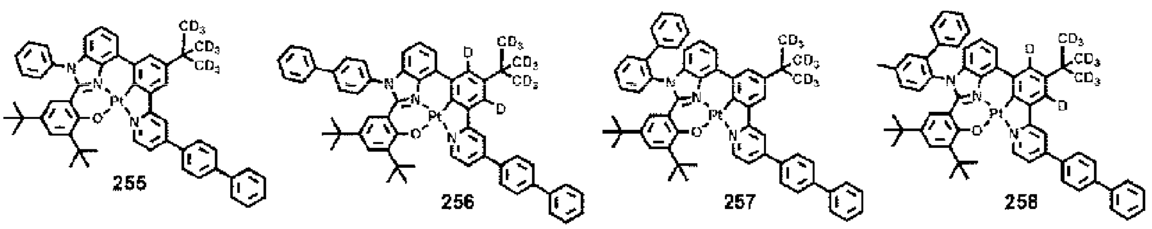

255 256 257 258

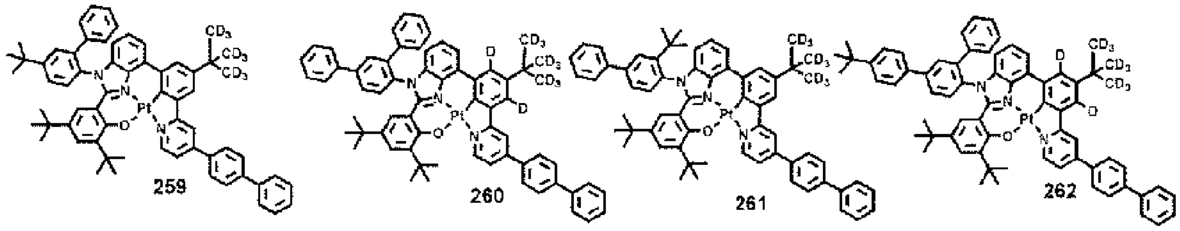

259 260 261 262

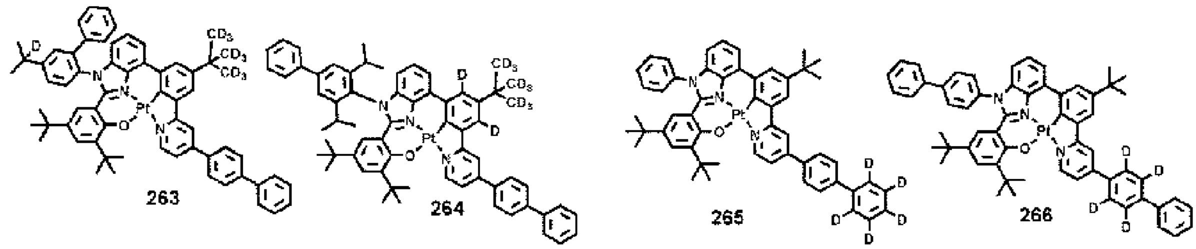

263 264 265 266

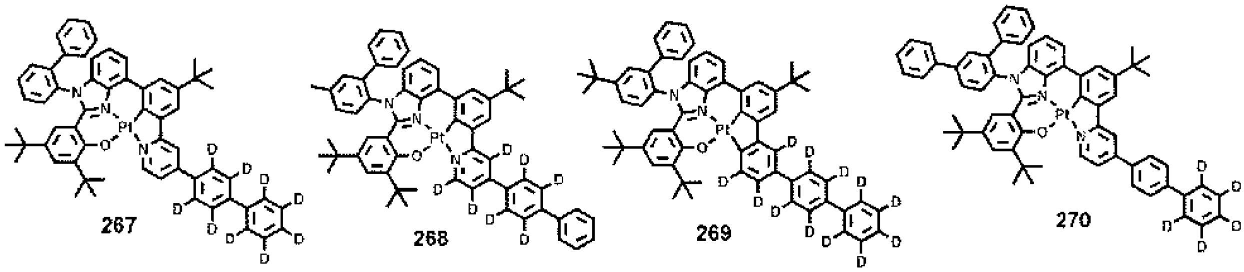

267 268 269 270

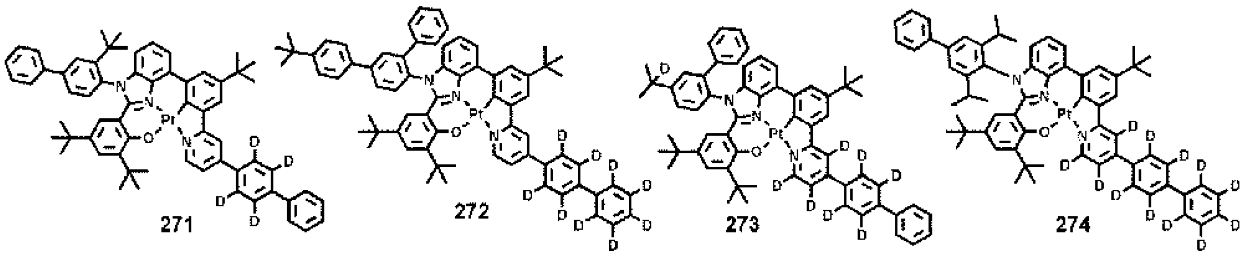

271 272 273 274

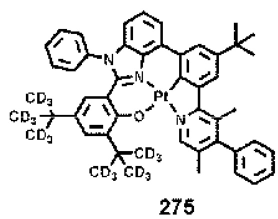

275

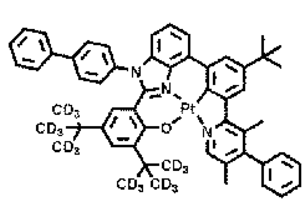

276

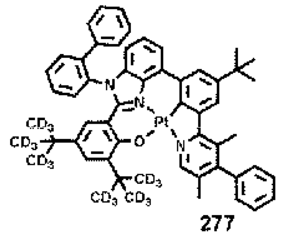

277

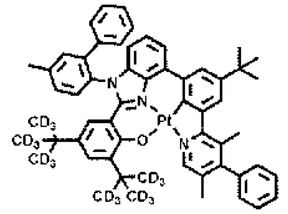

278

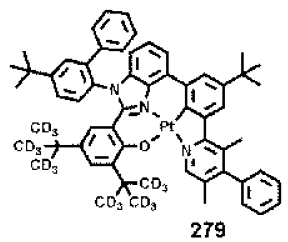

279

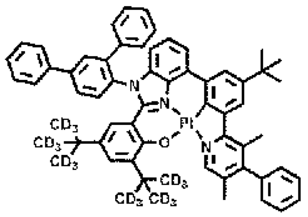

280

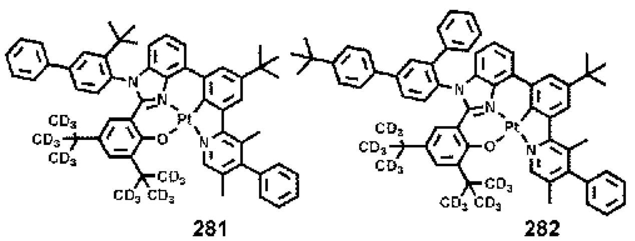

281 282

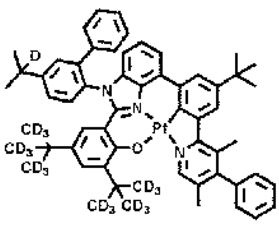
283

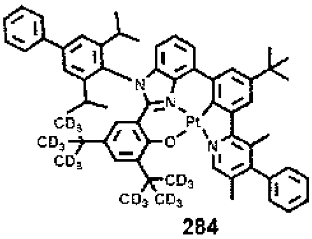
284

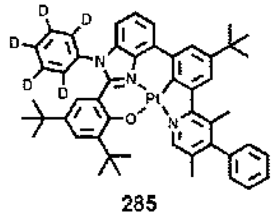
285

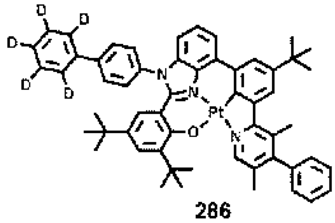
286

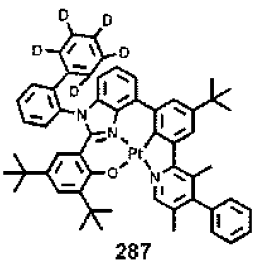
287

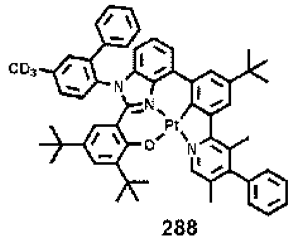
288

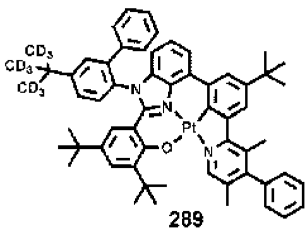
289

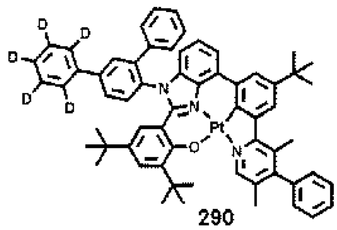
290

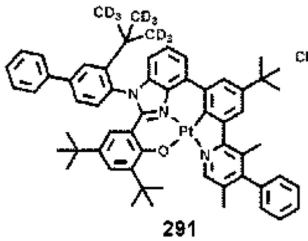
291

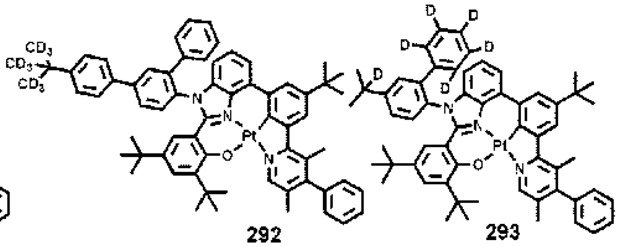
292

293

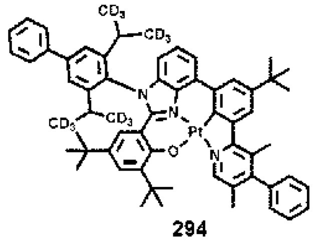
294

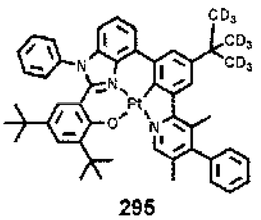
295

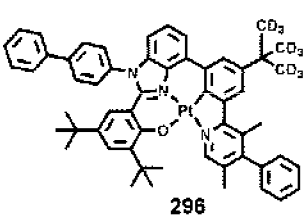
296

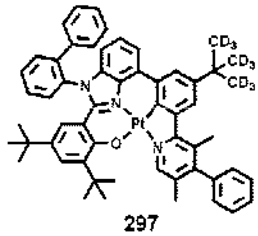
297

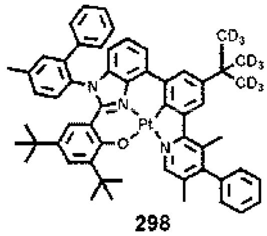
298

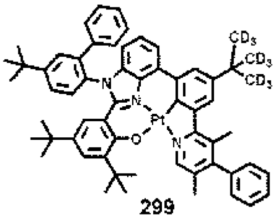
299

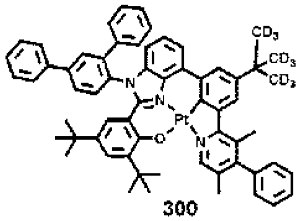
300

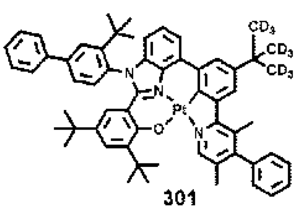
301

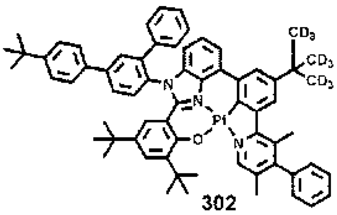
302

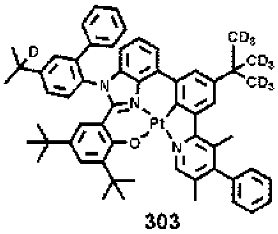
303

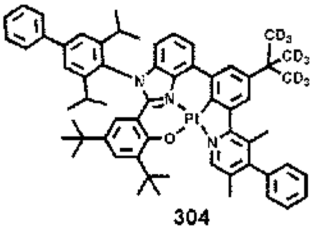
304

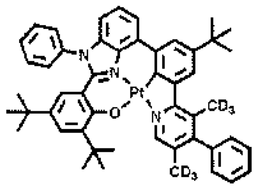
305

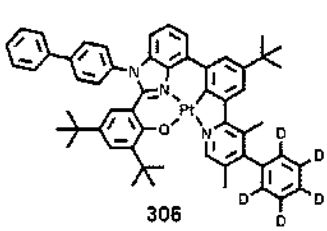
306

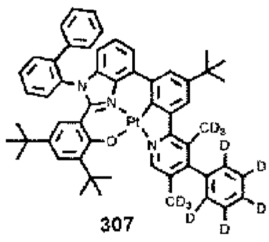
307

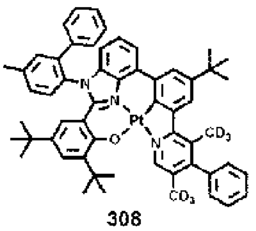
308

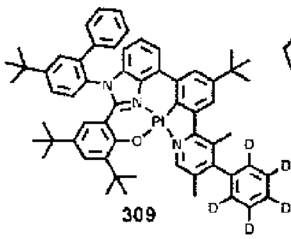
309

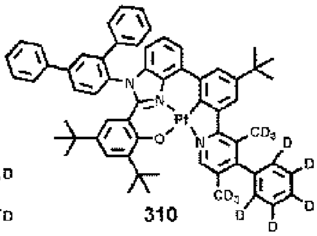
310

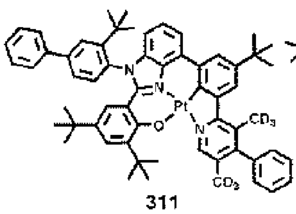
311

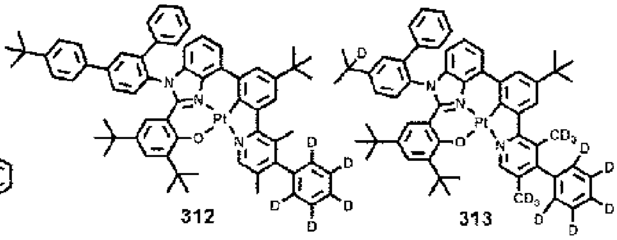
312

313

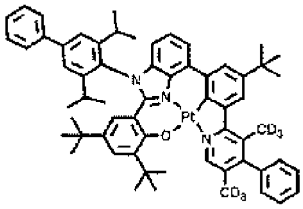
314

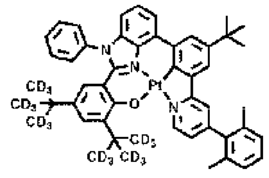
315

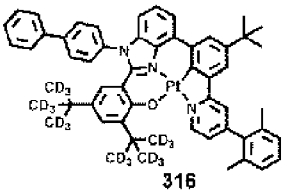
316

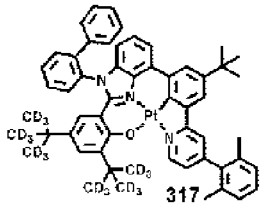
317

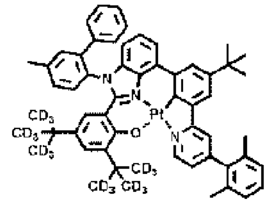
318

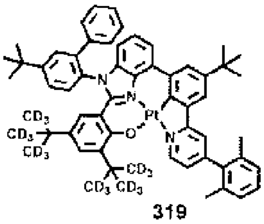
319

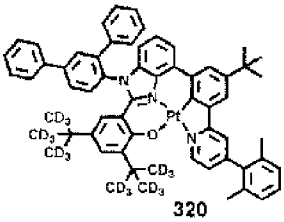
320

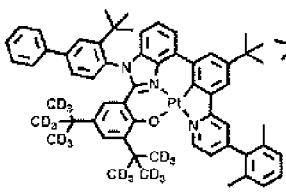
321

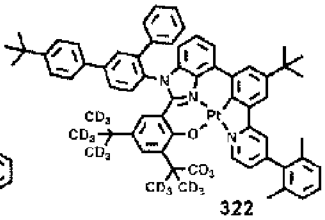
322

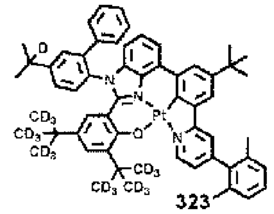
323

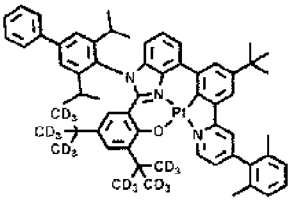
324

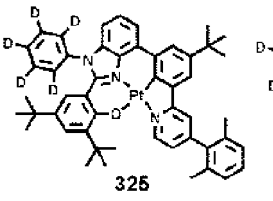
325

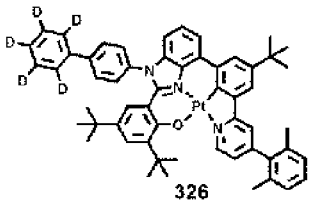
326

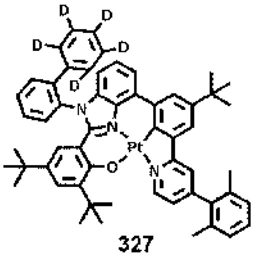
327

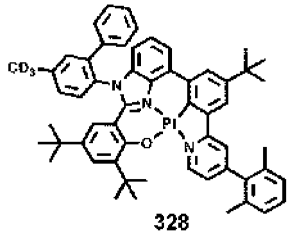
328

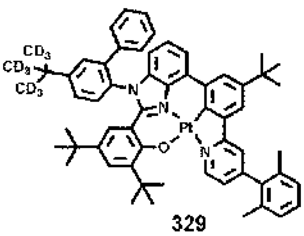
329

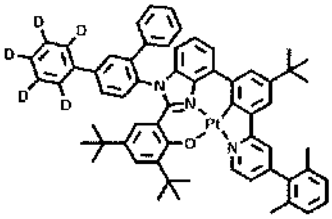
330

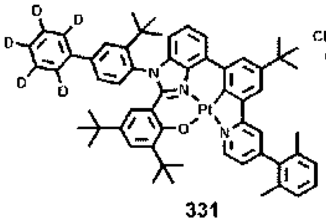

331

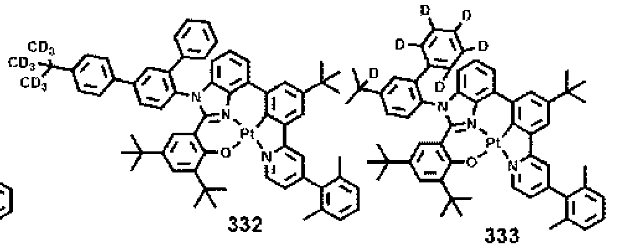

332

333

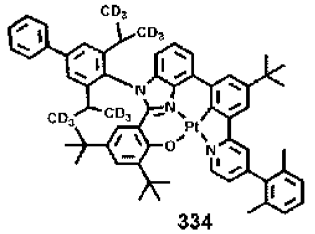

334

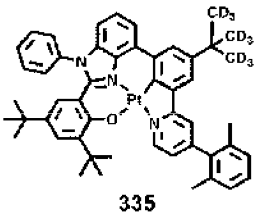

335

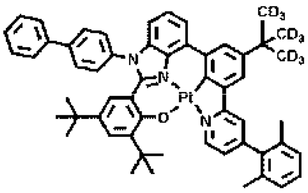

336

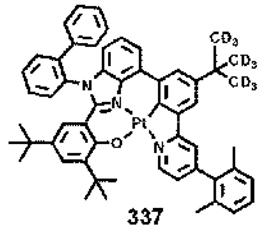

337

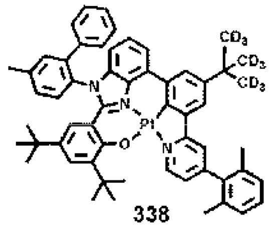

338

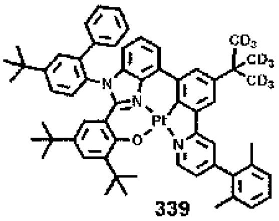

339

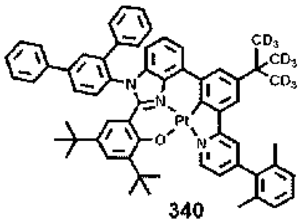

340

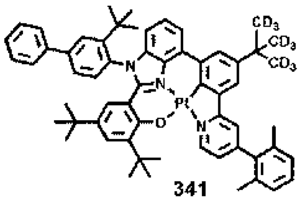

341

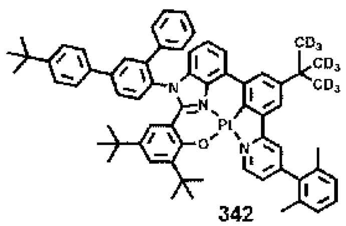

342

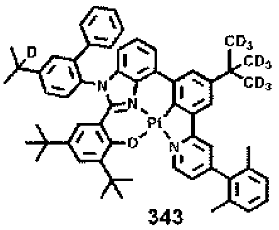

343

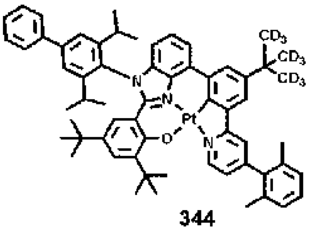

344

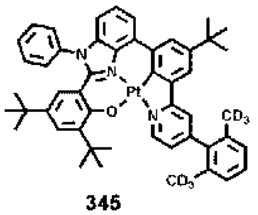

345

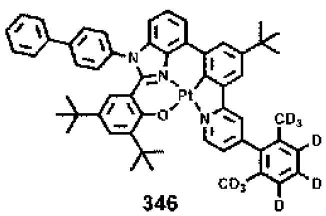

346

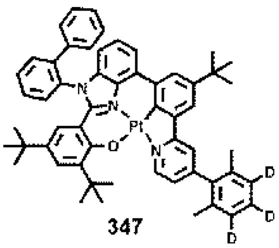

347

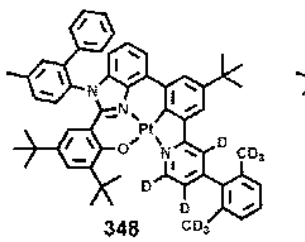

348

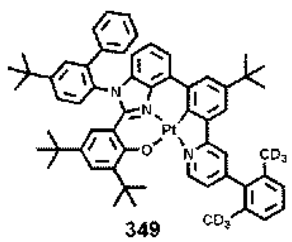

349

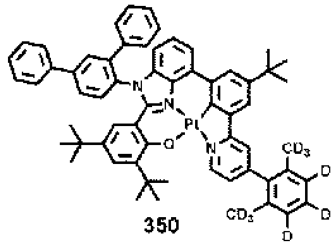

350

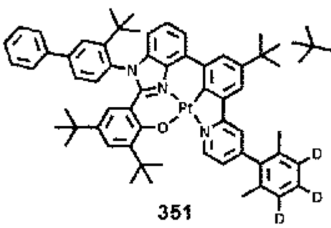

351

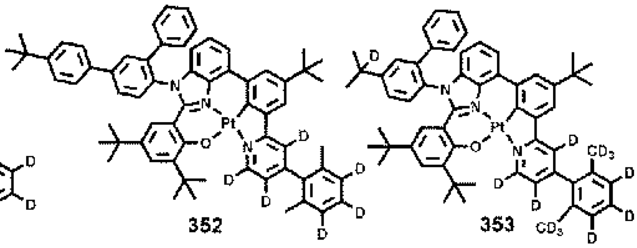

352

353

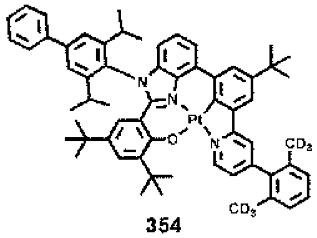

354

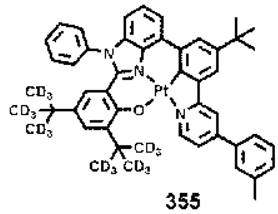
355
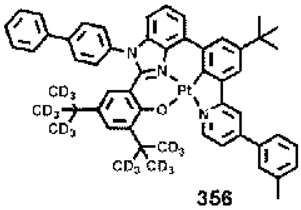
356
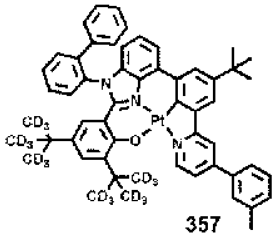
357
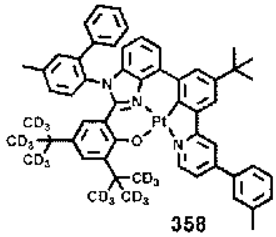
358

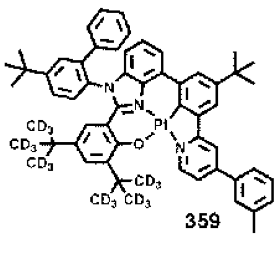
359
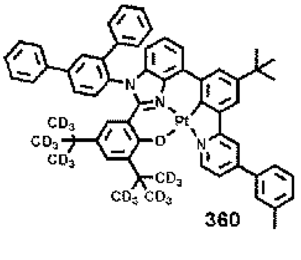
360
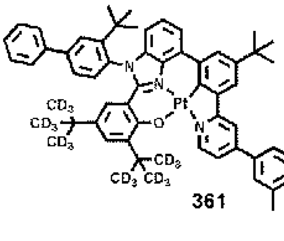
361
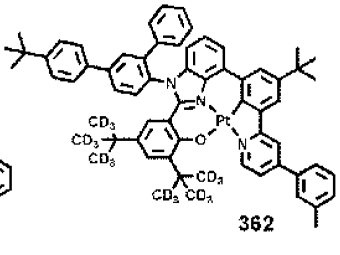
362

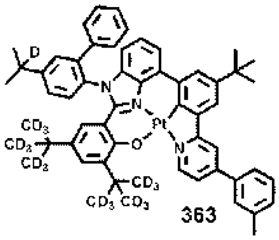
363
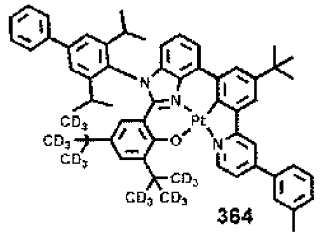
364
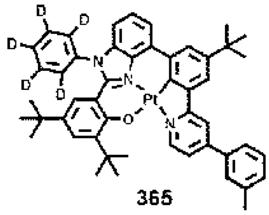
365
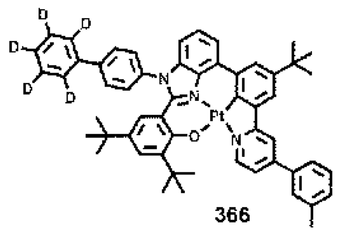
366

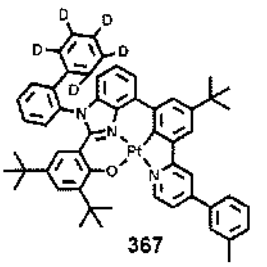
367
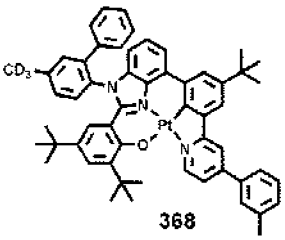
368
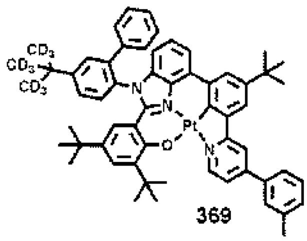
369
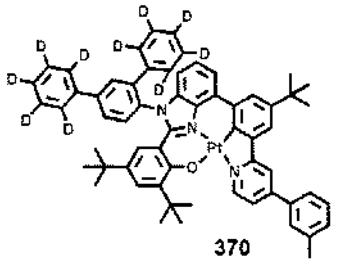
370

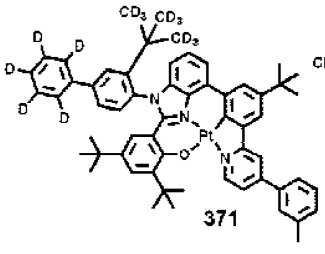
371
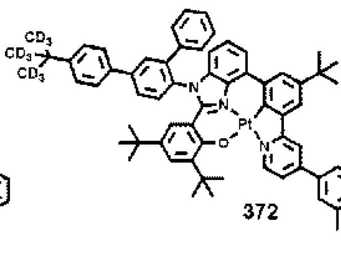
372
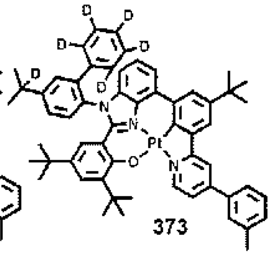
373
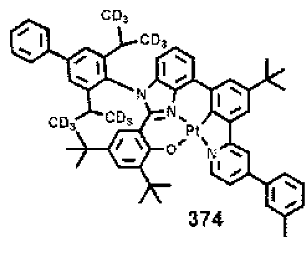
374

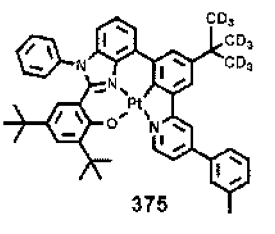
375
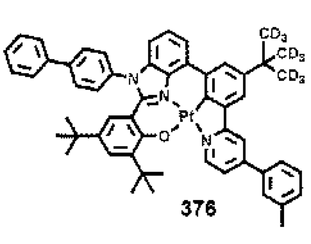
376
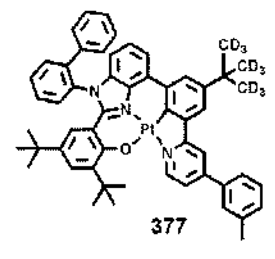
377
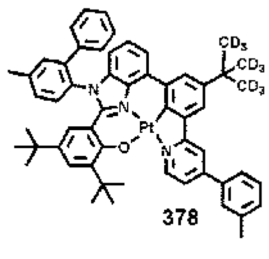
378

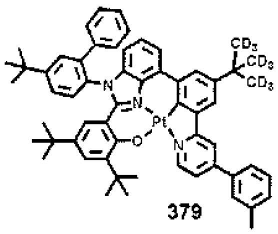
379

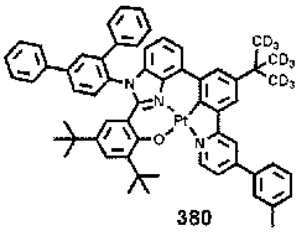
380

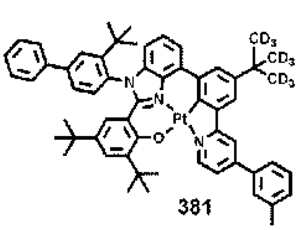
381

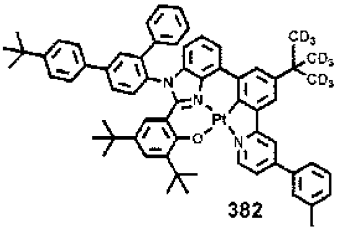
382

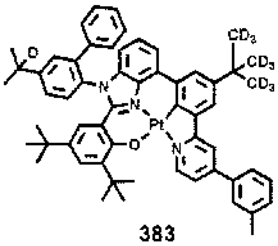
383

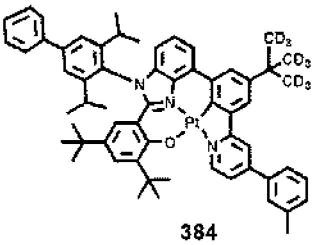
384

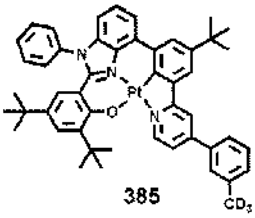
385

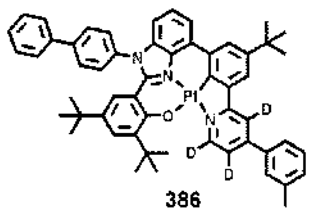
386

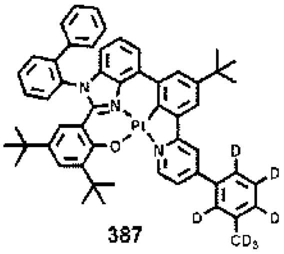
387

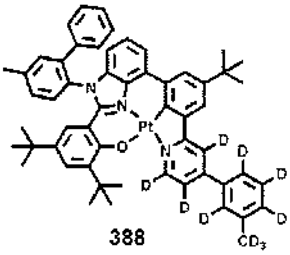
388

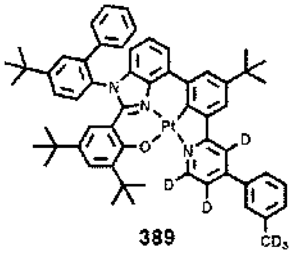
389

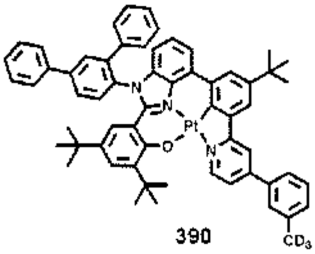
390

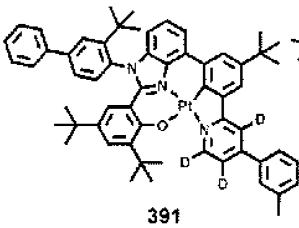
391

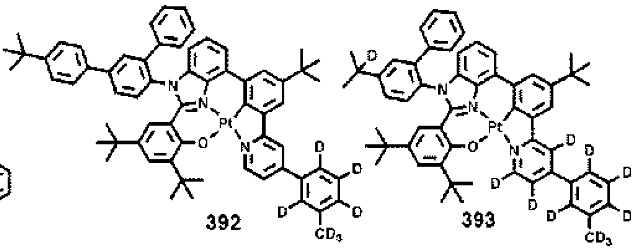
392

393

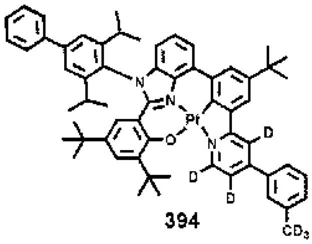
394

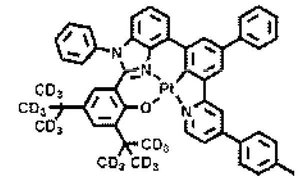
395

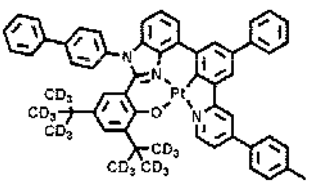
396

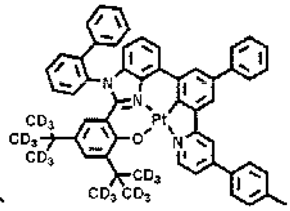
397

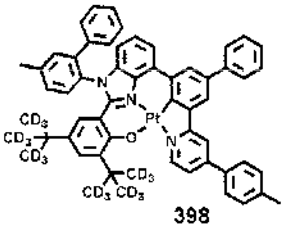
398

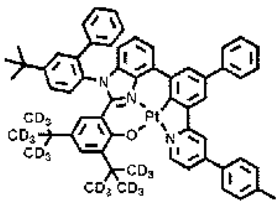

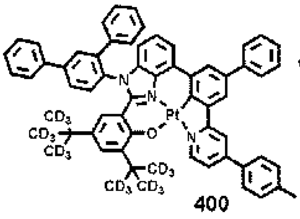
400

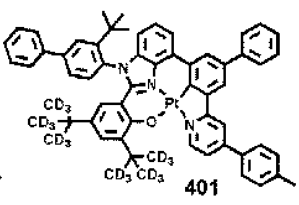
401

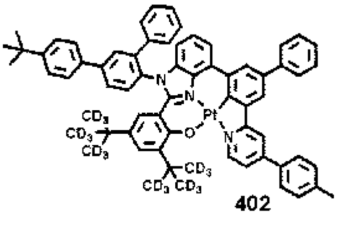
402

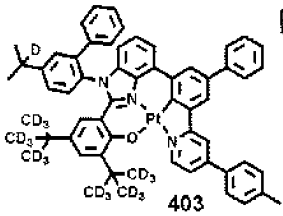
403

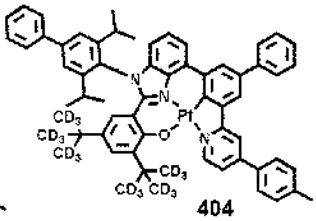
404

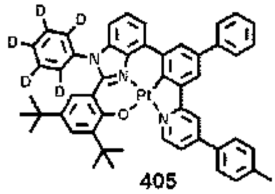
405

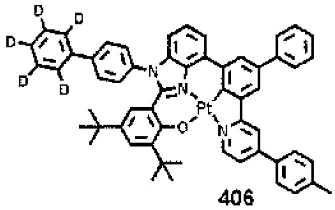
406

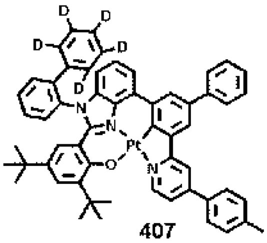
407

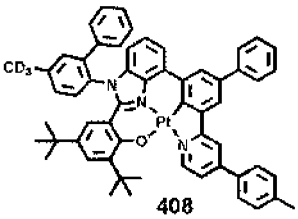
408

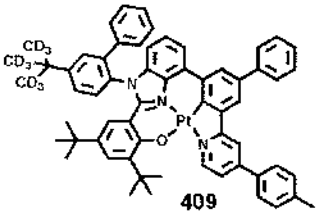
409

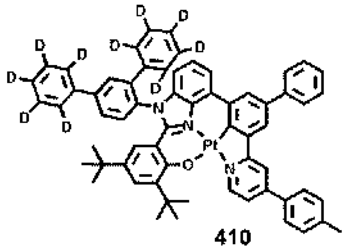
410

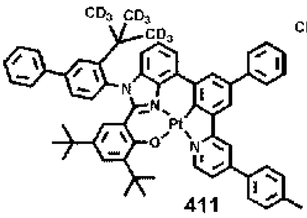
411

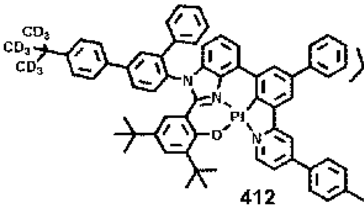
412

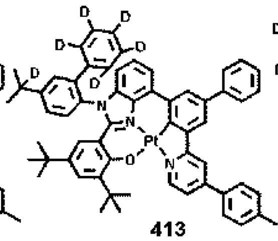
413

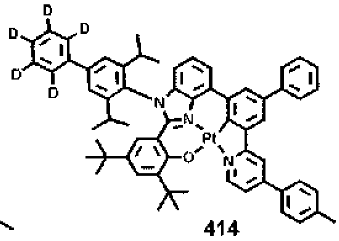
414

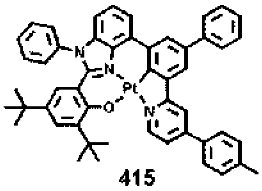
415

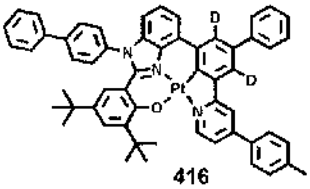
416

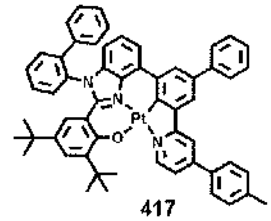
417

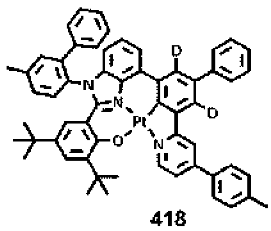
418

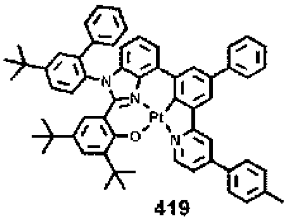
419

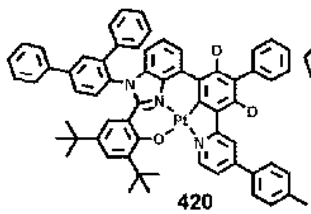
420

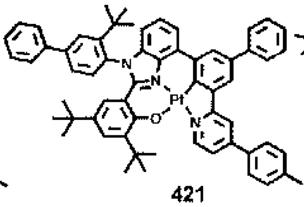
421

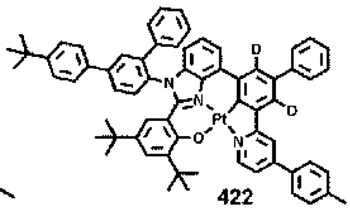
422

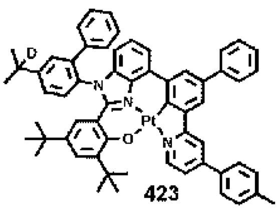
423

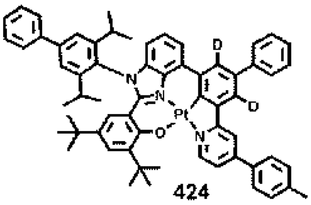
424

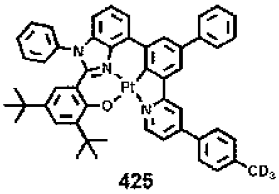
425

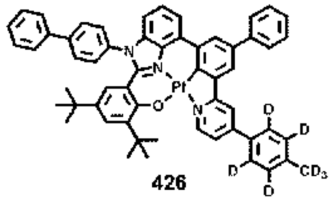
426

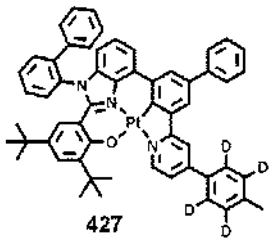
427

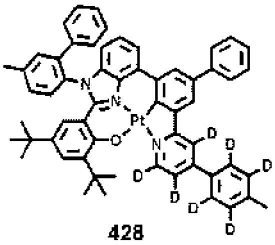
428

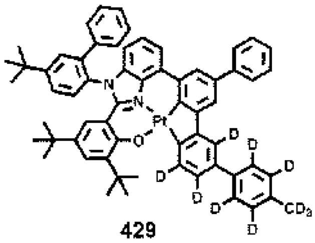
429

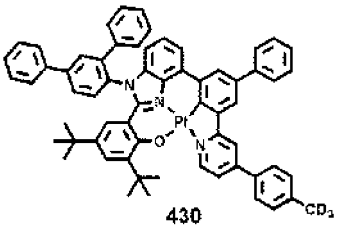
430

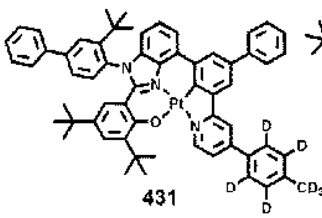
431

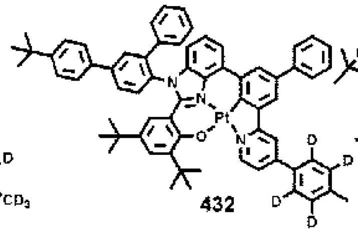
432

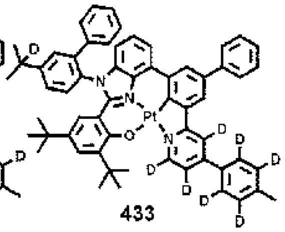
433

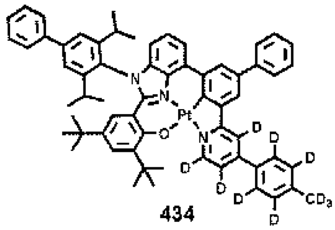
434

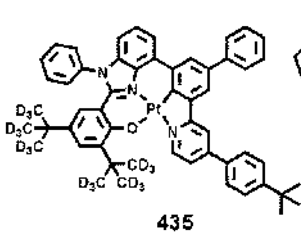
435

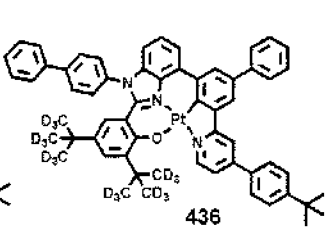
436

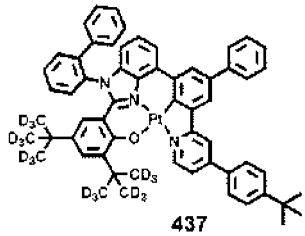
437

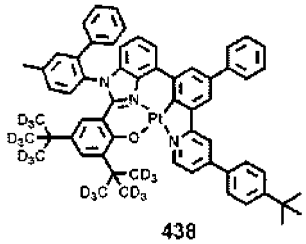
438

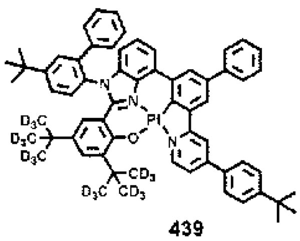
439

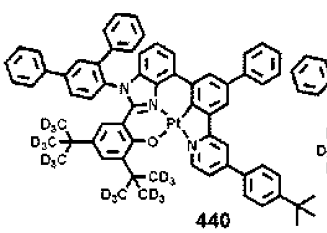
440

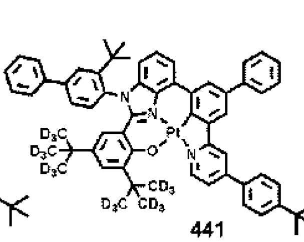
441

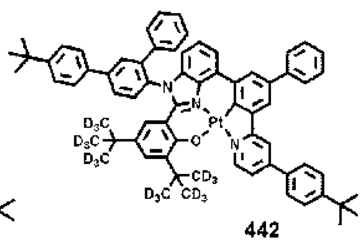
442

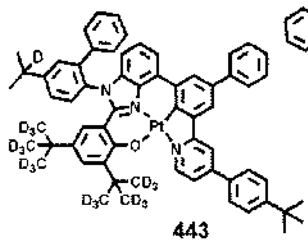
443

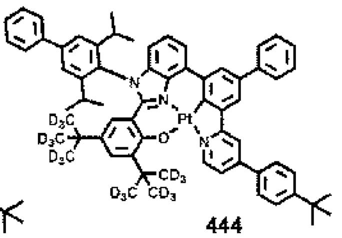
444

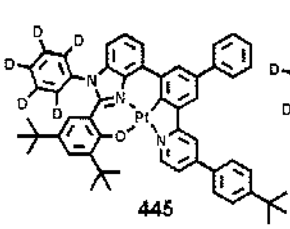
445

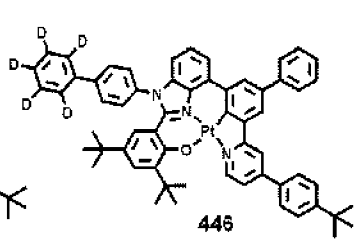
446

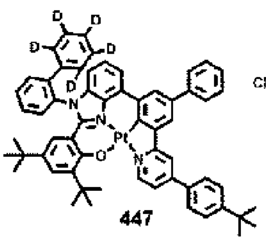
447

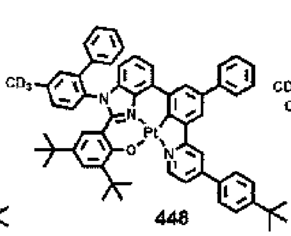
448

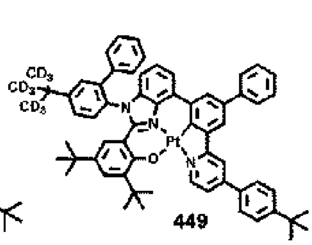
449

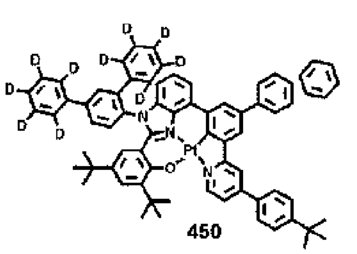
450

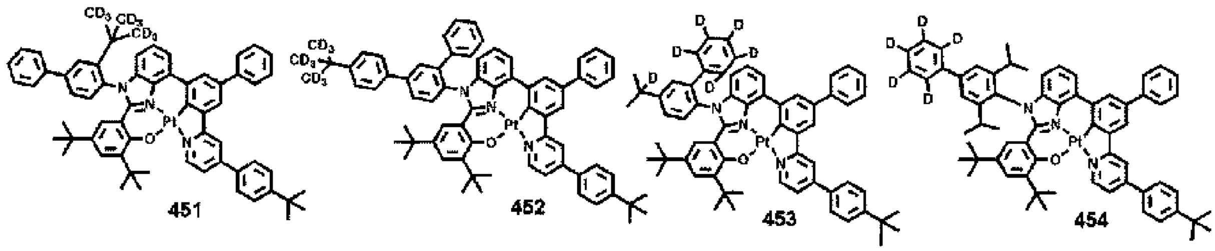

451 452 453 454

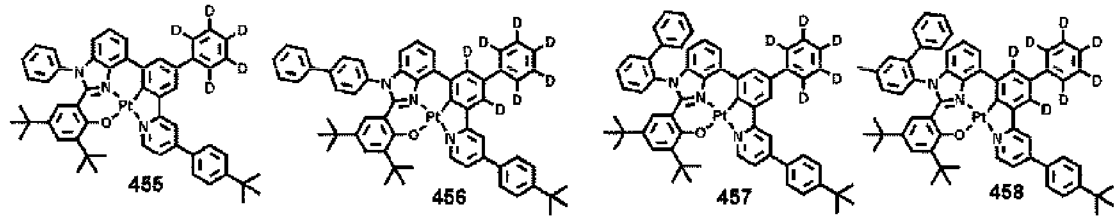

455 456 457 458

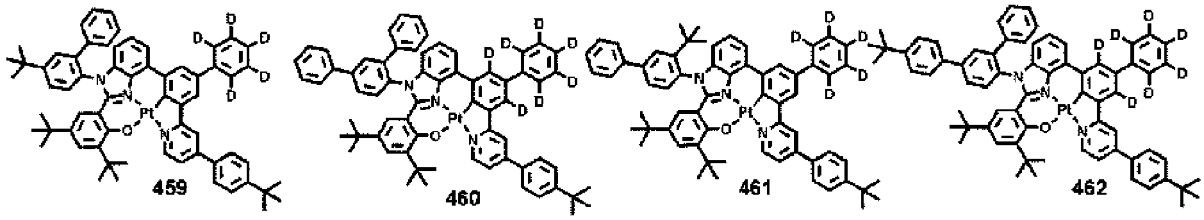

459 460 461 462

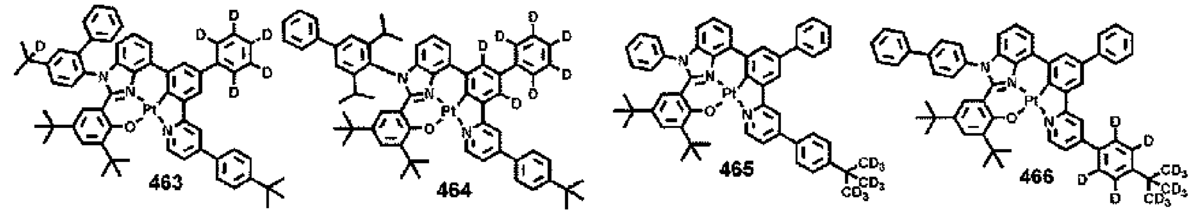

463 464 465 466

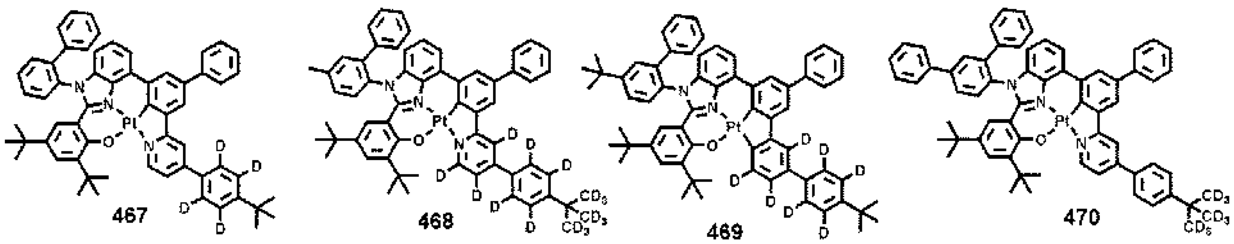

467 468 469 470

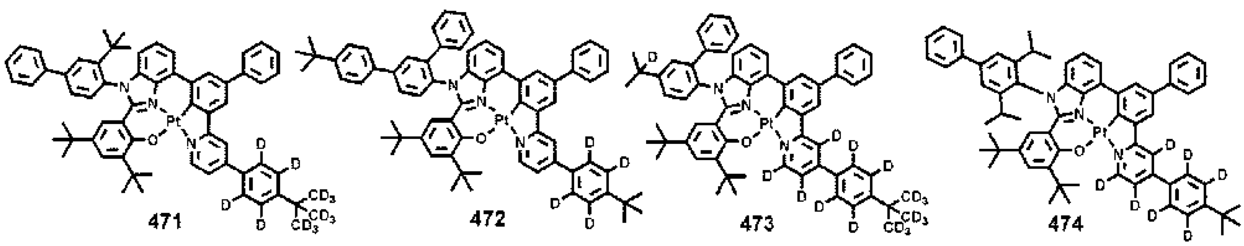

471 472 473 474

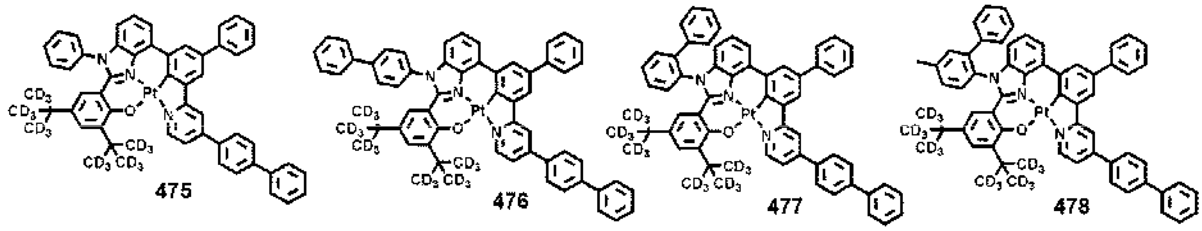

475 476 477 478

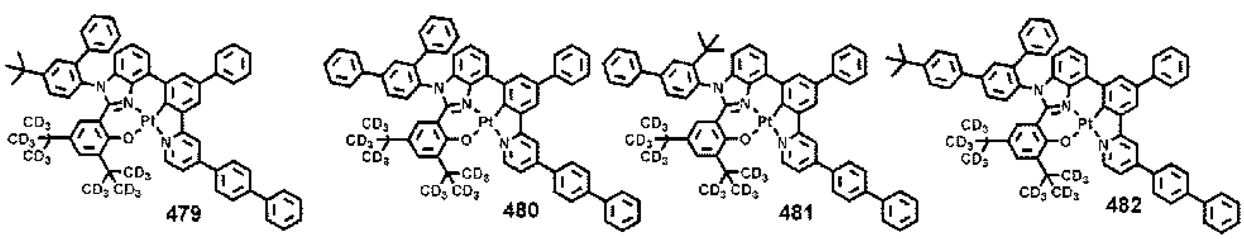

479 480 481 482

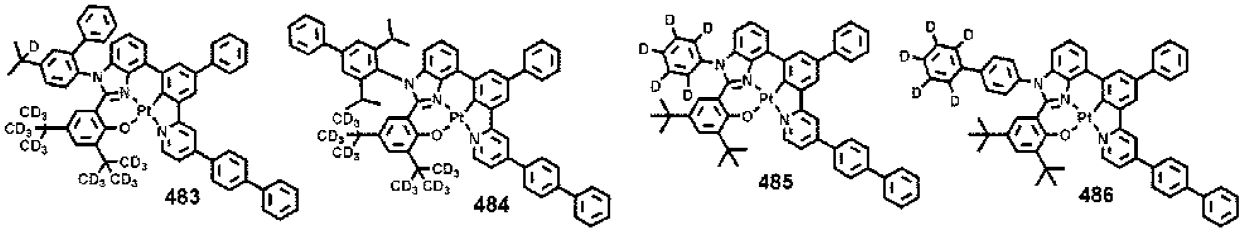

483 484 485 486

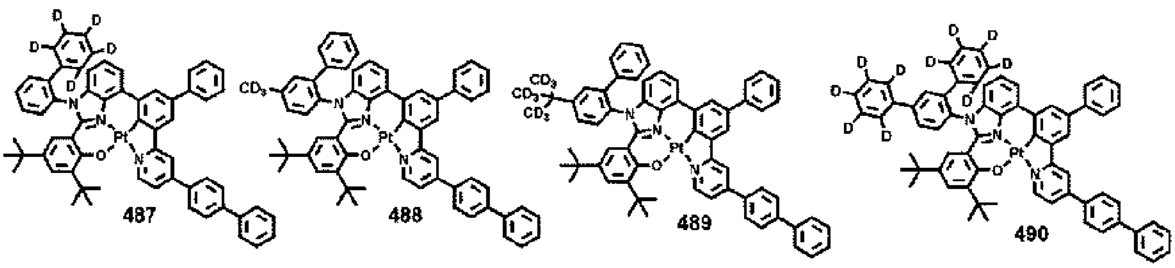

487 488 489 490

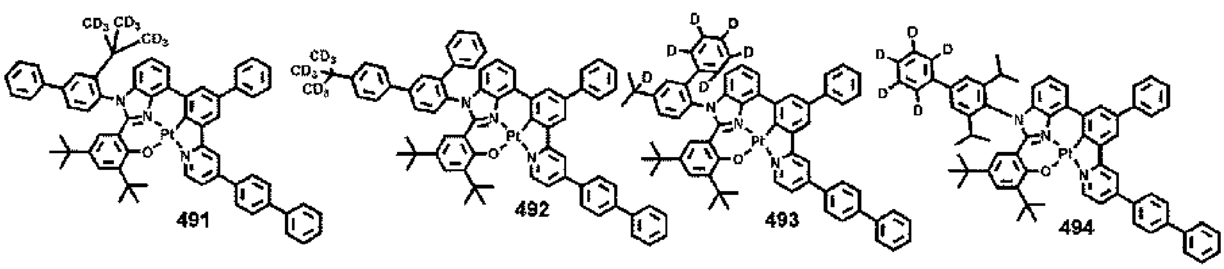

491 492 493 494

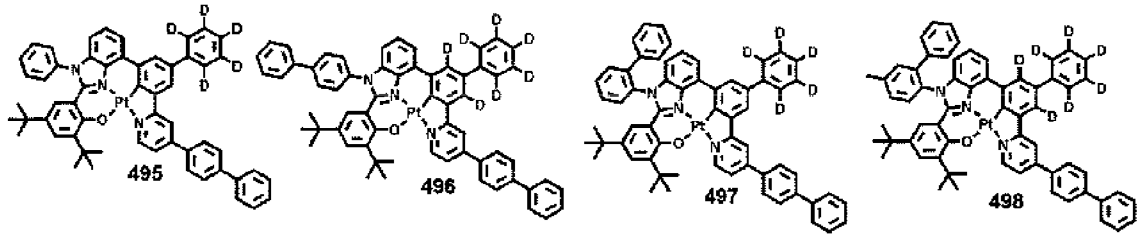

495 496 497 498

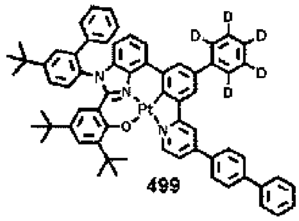

499

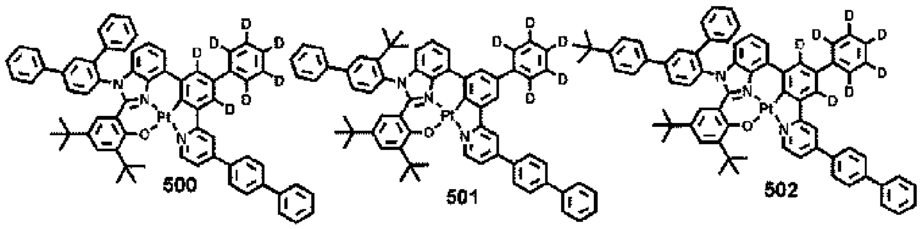

500

501

502

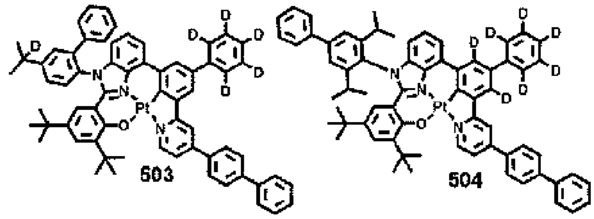

503

504

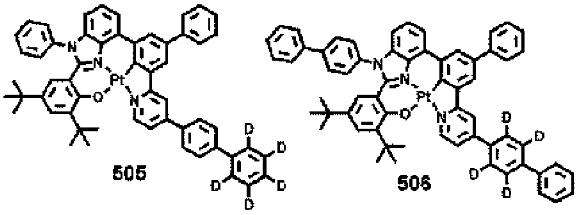

505

506

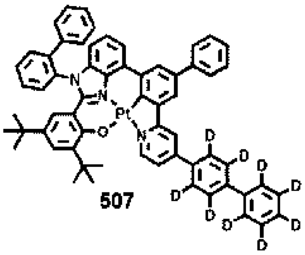

507

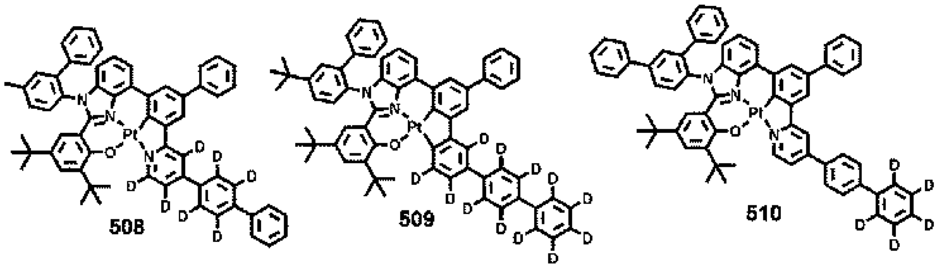

508

509

510

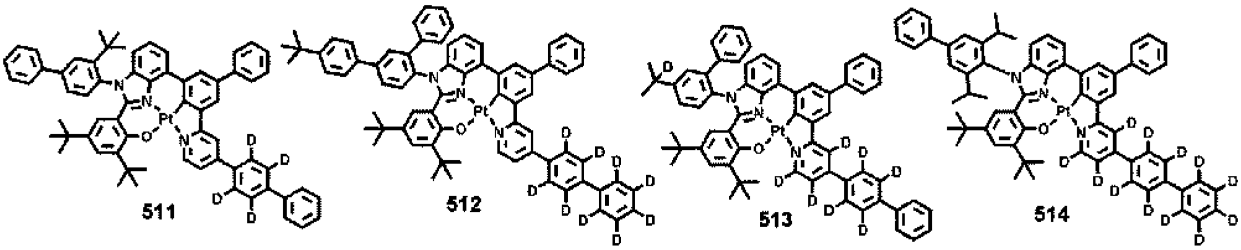

511

512

513

514

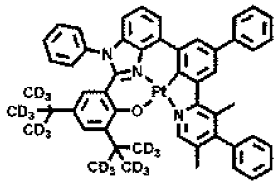

515

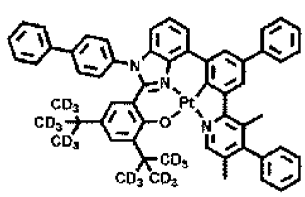

516

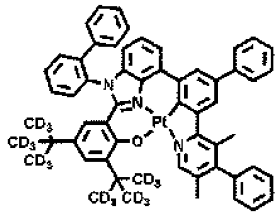

517

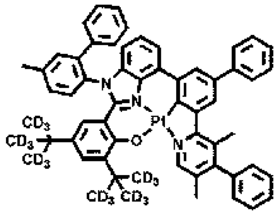

527

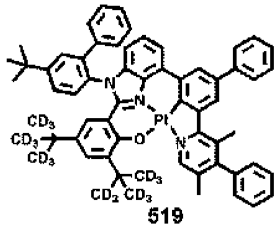

519

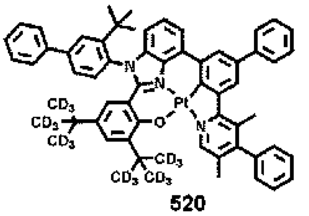

520

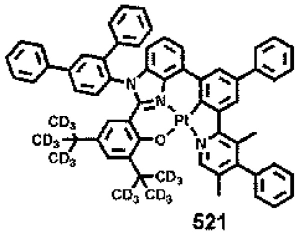

521

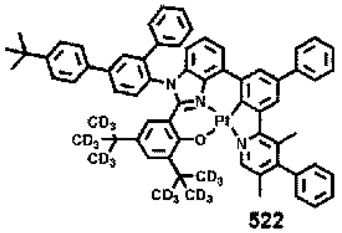

522

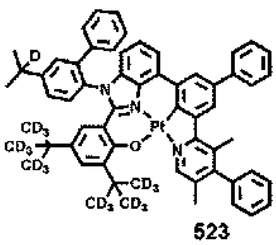
523

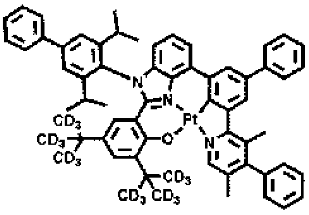
524

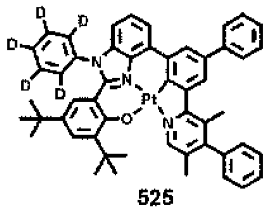
525

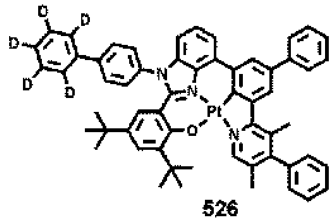
526

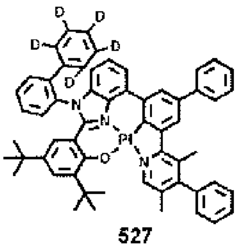
527

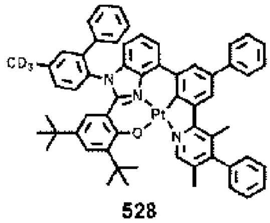
528

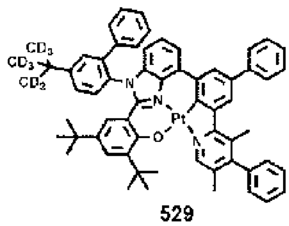
529

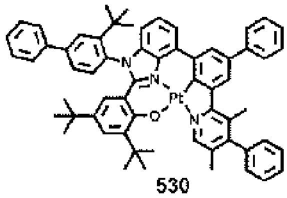
530

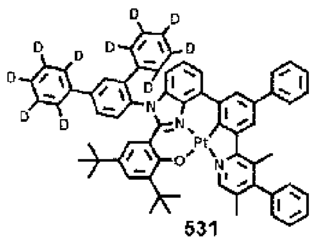
531

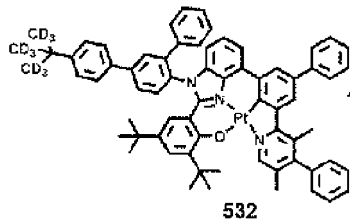
532

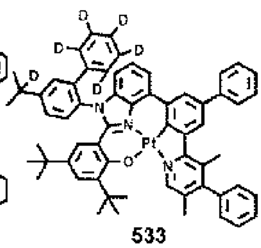
533

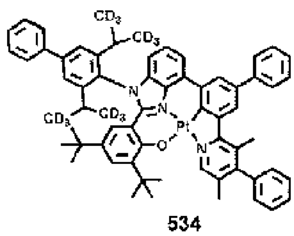
534

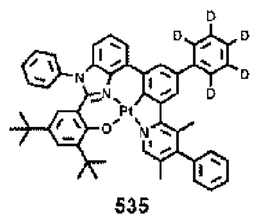
535

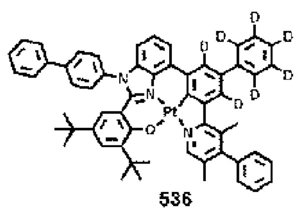
536

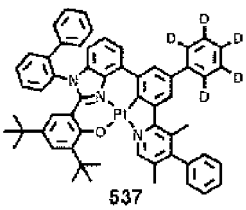
537

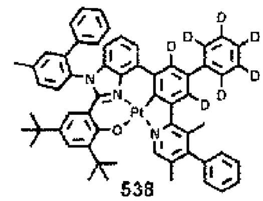
538

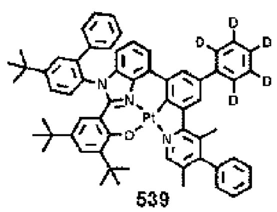
539

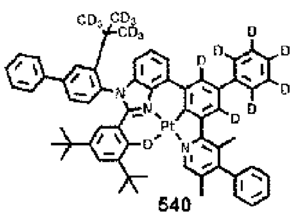
540

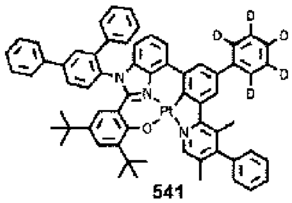
541

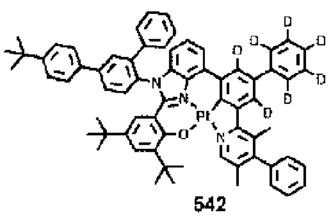
542

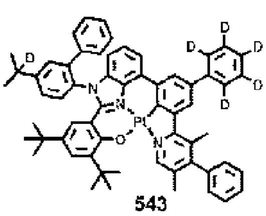
543

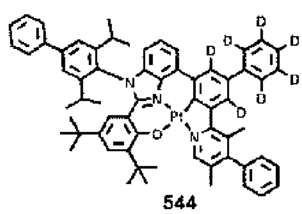
544

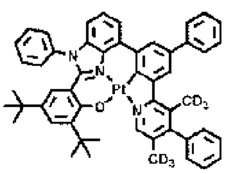
545

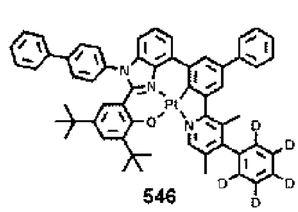
546

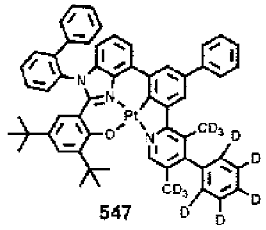
547

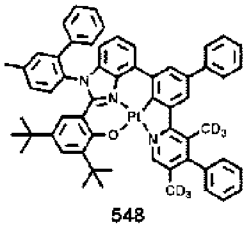
548

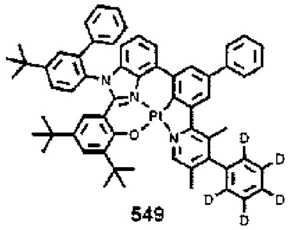
549

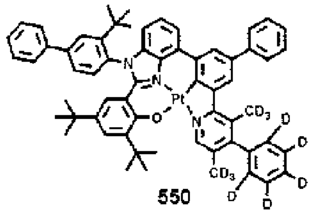
550

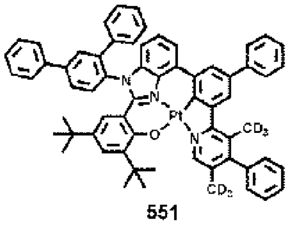
551

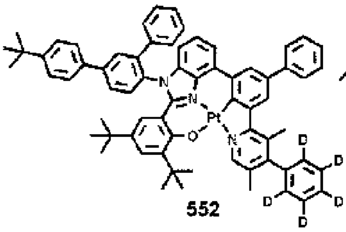
552

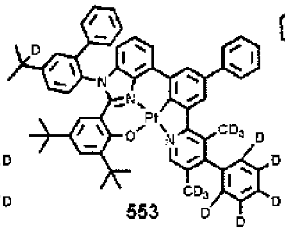
553

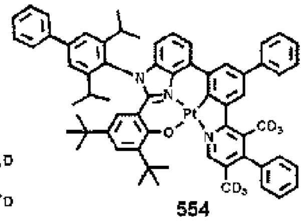
554

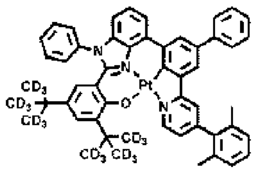
555

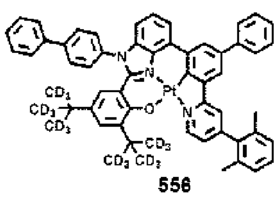
556

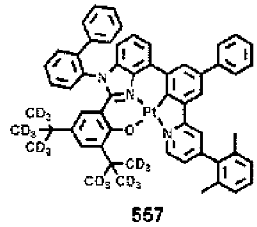
557

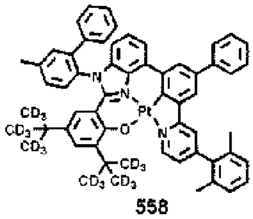
558

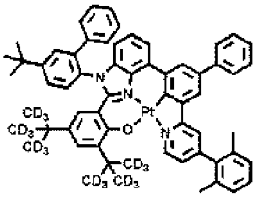
559

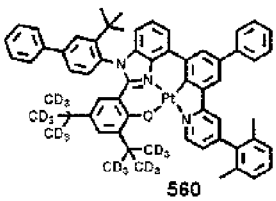
560

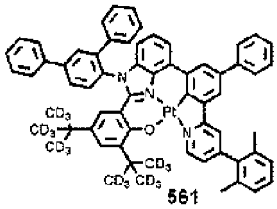
561

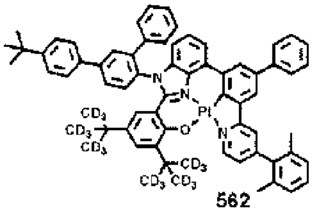
562

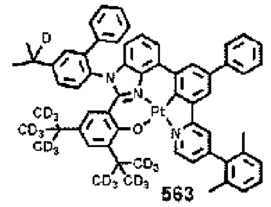
563

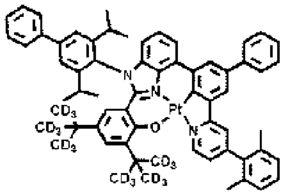
564

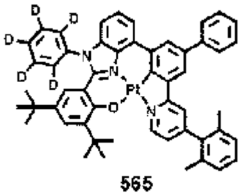
565

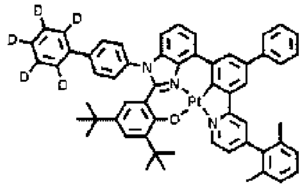
566

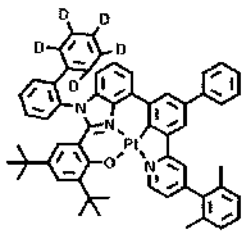
567

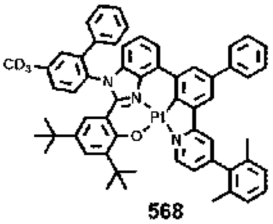
568

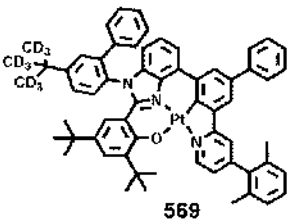
569

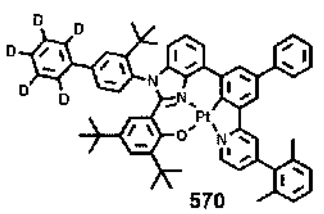
570

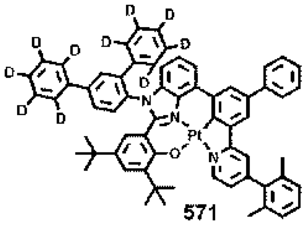
571

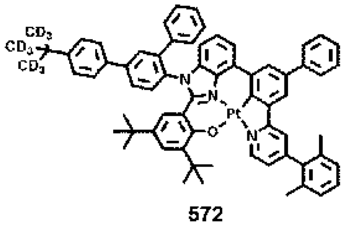
572

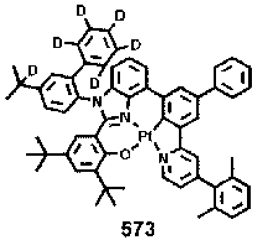
573

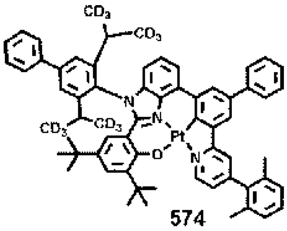
574

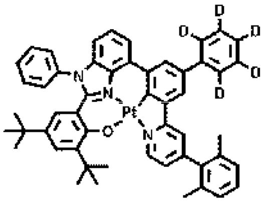
575

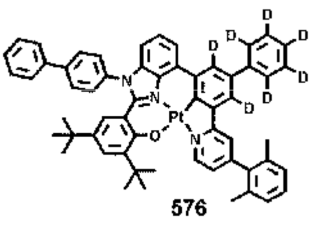
576

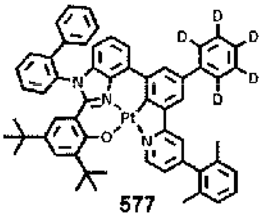
577

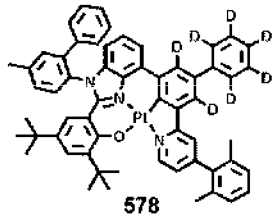
578

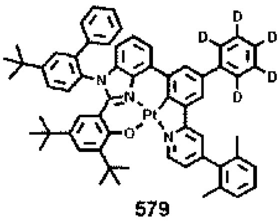
579

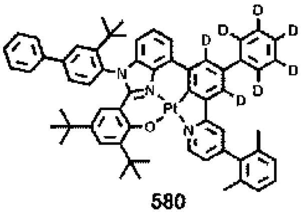
580

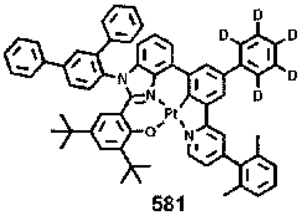
581

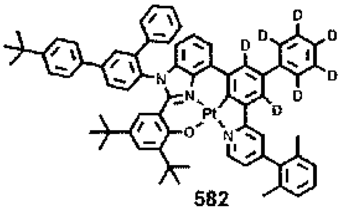
582

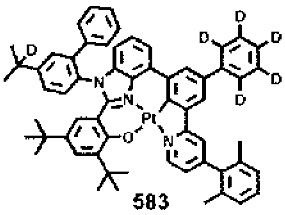
583

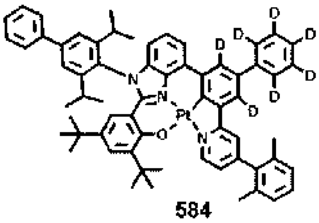
584

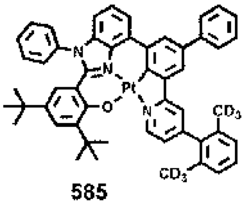
585

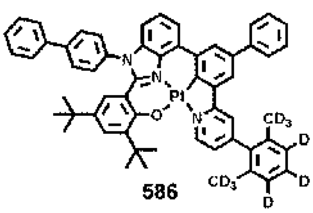
586

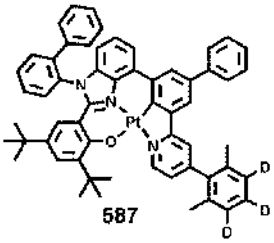
587

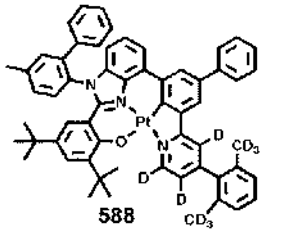
588

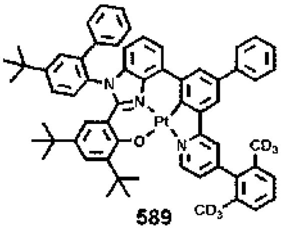
589

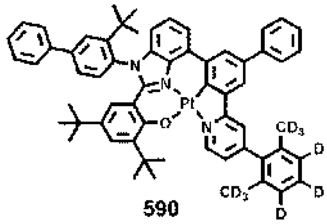
590

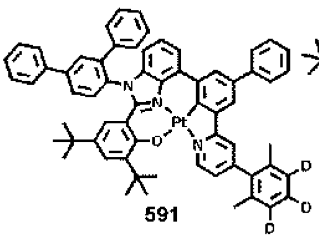
591

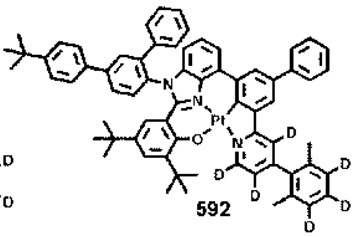
592

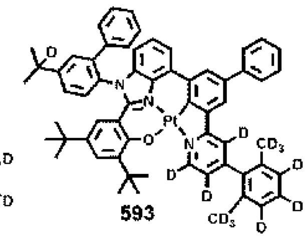
593

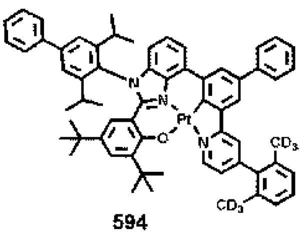
594

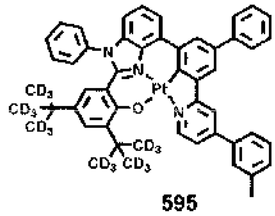

595

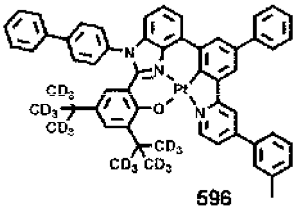

596

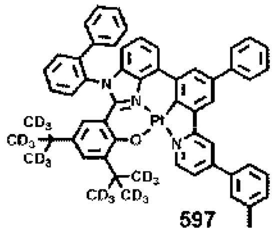

597

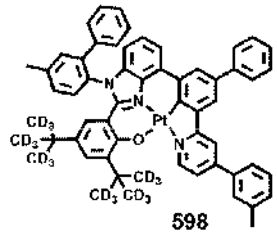

598

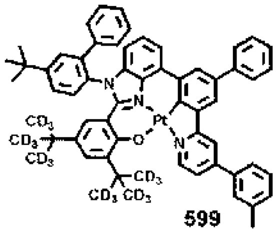

599

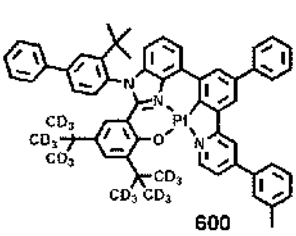

600

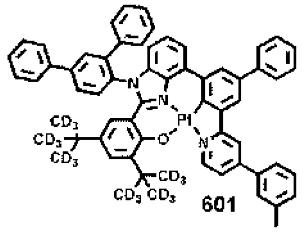

601

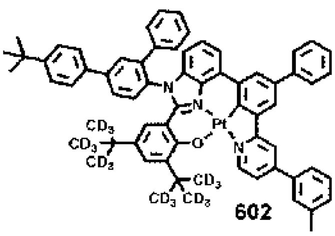

602

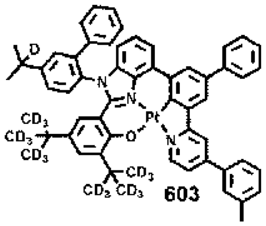

603

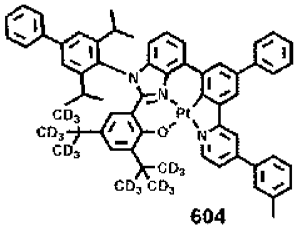

604

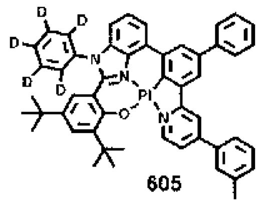

605

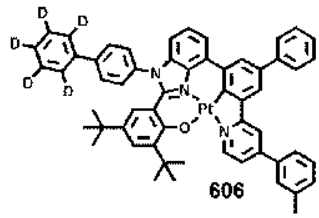

606

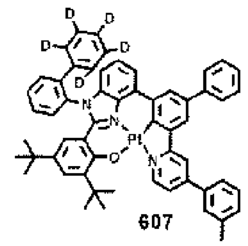

607

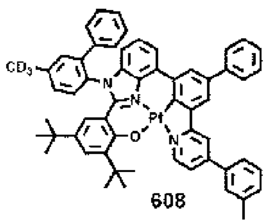

608

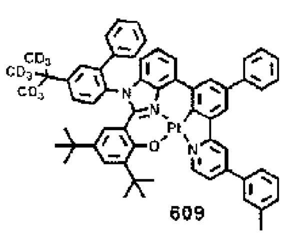

609

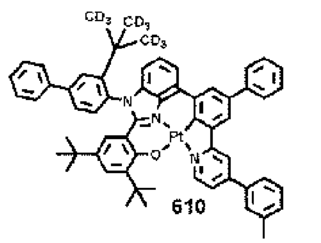

610

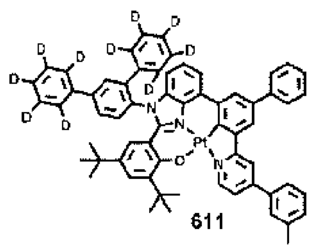

611

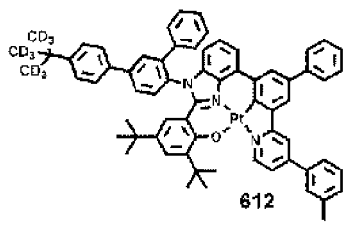

612

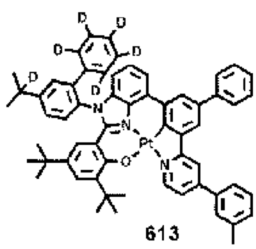

613

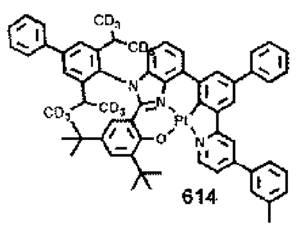

614

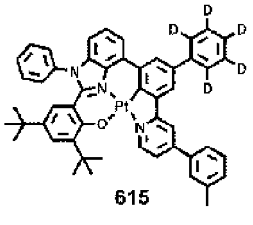

615

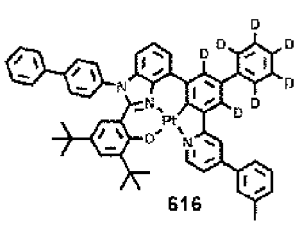

616

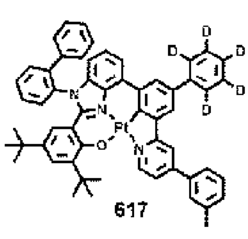

617

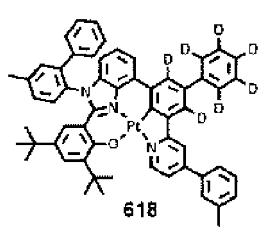

618

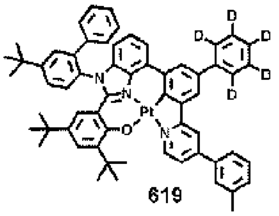
619

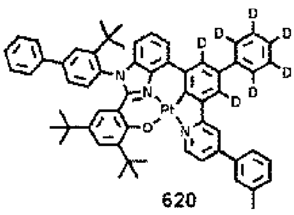
620

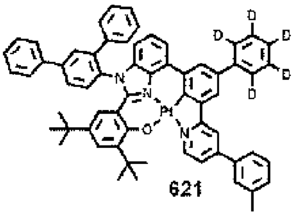
621

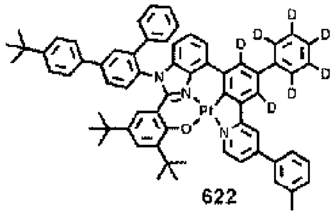
622

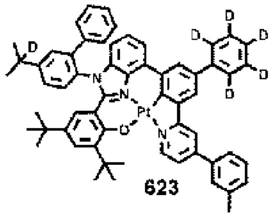
623

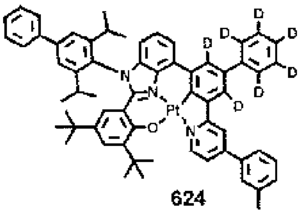
624

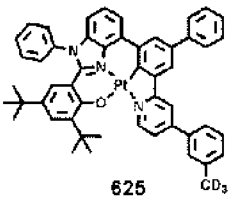
625

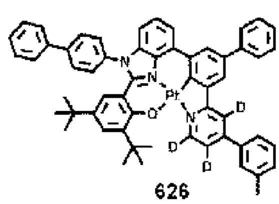
626

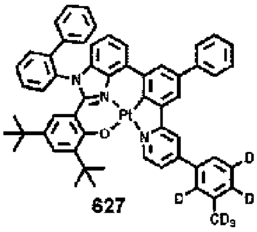
627

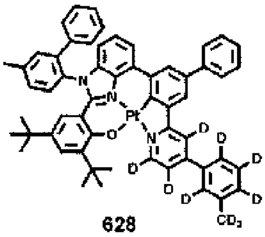
628

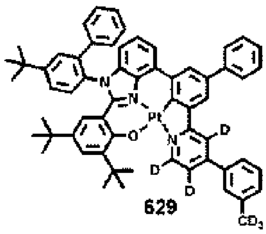
629

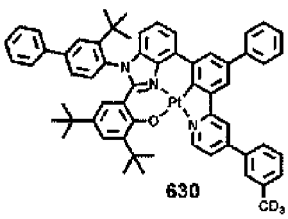
630

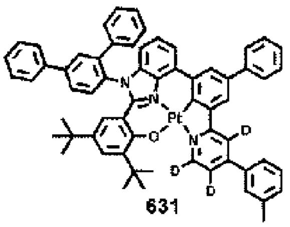
631

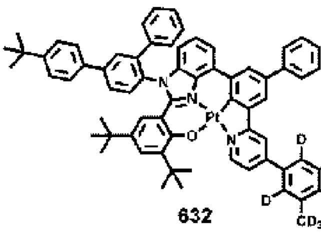
632

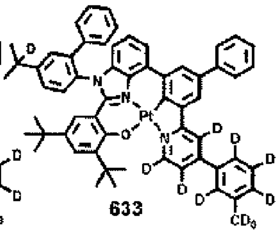
633

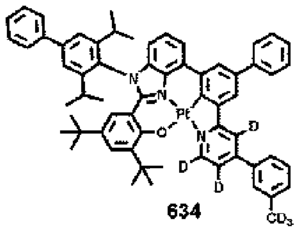
634

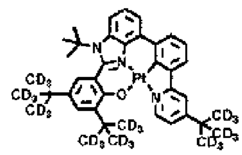
635

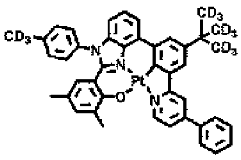
636

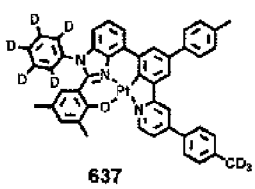
637

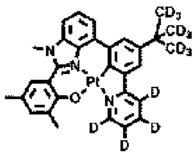
638

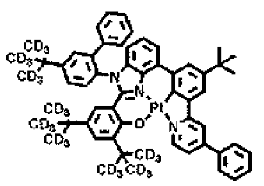
639

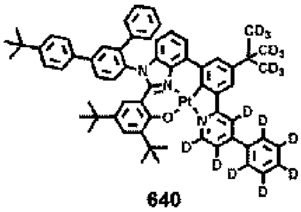
640

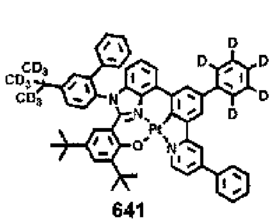
641

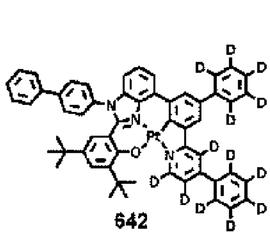
642

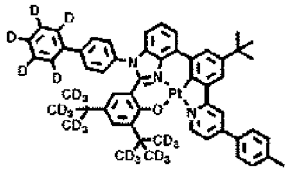

643

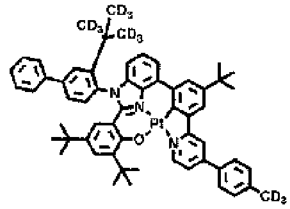

644

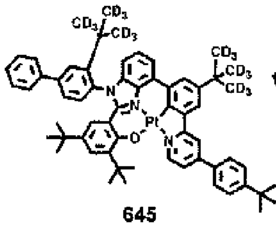

645

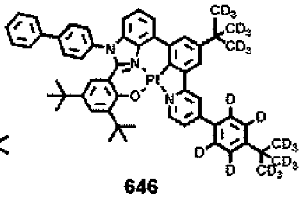

646

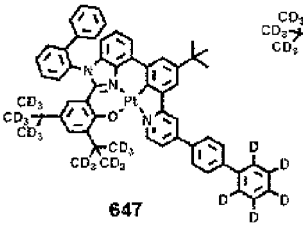

647

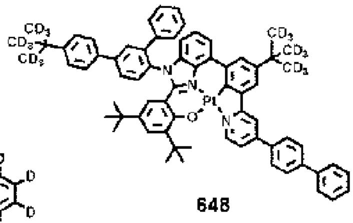

648

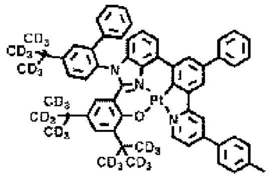

649

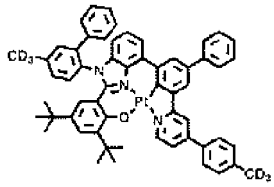

650

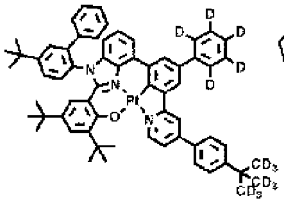

651

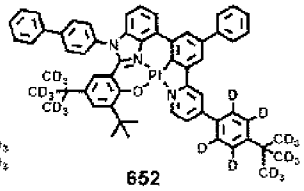

652

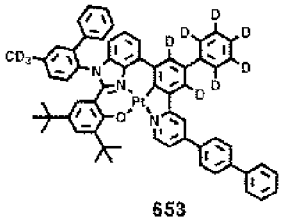

653

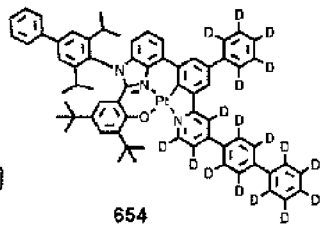

654

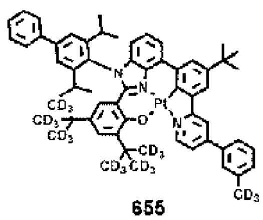

655

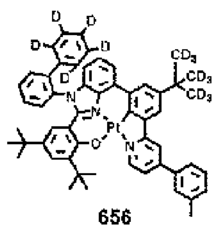

656

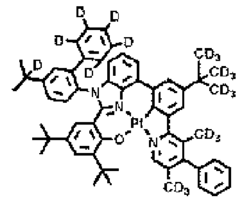

657

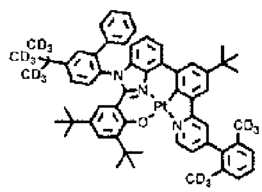

658

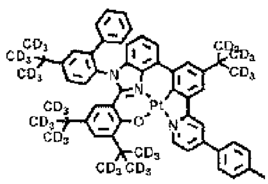

659

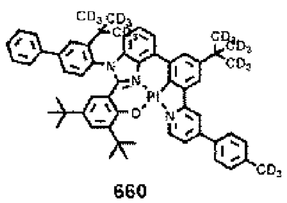

660

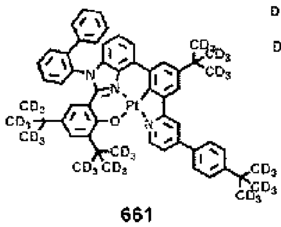

661

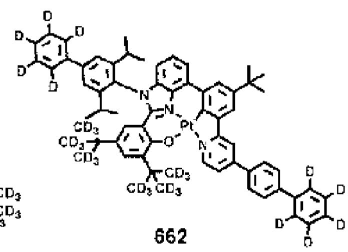

662

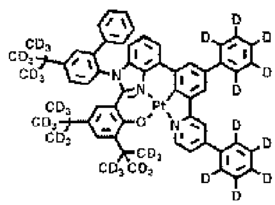

663

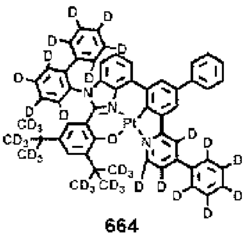

664

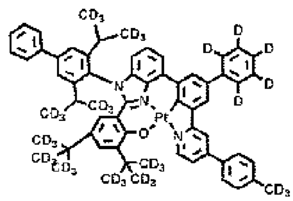

665

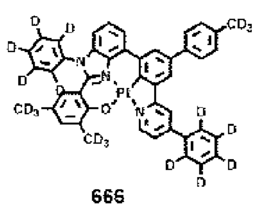

666

**13.** Dispositif électroluminescent organique comprenant :

une première électrode ;

une seconde électrode ; et
une couche organique disposée entre la première électrode et la seconde électrode,
ladite couche organique comprenant une couche d'émission et au moins un composé organométallique selon l'une quelconque des revendications 1 à 12 ;
de préférence,
ladite première électrode étant une anode,
ladite seconde électrode étant une cathode,
ladite couche organique comprenant en outre une région de transport de trous disposée entre la première électrode et la couche d'émission et une région de transport d'électrons disposée entre la couche d'émission et la seconde électrode,
ladite région de transport de trous comprenant une couche d'injection de trous, une couche de transport de trous, une couche de blocage d'électrons, une couche tampon ou toute combinaison de celles-ci, et
ladite région de transport d'électrons comprenant une couche de blocage de trous, une couche de transport d'électrons, une couche d'injection d'électrons ou toute combinaison de celles-ci.

**14.** Dispositif électroluminescent organique selon la revendication 13, ledit composé organométallique étant inclus dans la couche d'émission, de préférence ladite couche d'émission comprenant en outre un hôte et la quantité de l'hôte étant supérieure à la quantité du composé organométallique.

**15.** Composition de diagnostic comprenant au moins un composé organométallique selon l'une quelconque des revendications 1 à 12.

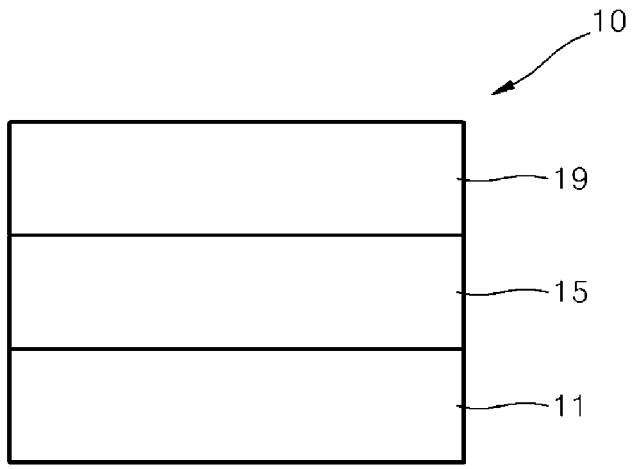
10
19
15
11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2016240800 A